# EUROPEAN PATENT APPLICATION

(11) **EP 4 099 413 A1**
(43) Date of publication of application: **07.12.2022**
(21) Application number: 22176440.0
(22) Date of filing: 31.05.2022
(51) Int. Cl.: H01L 51/00, H01L 51/50

(54) **COMPOSITION, LAYER INCLUDING THE COMPOSITION, LIGHT-EMITTING DEVICE INCLUDING THE COMPOSITION, AND ELECTRONIC APPARATUS INCLUDING THE LIGHT-EMITTING DEVICE**

(30) Priority: 03.06.2021 KR 20210072365
(71) Applicant: Samsung Electronics Co., Ltd., Gyeonggi-do, 16677 (KR)
(72) Inventor: YI, Jeoungin, Suwon-si 16678 (KR); KIM, Mikyung, Suwon-si 16678 (KR); KIM, Hyungjun, Suwon-si 16678 (KR); LEE, Kum Hee, Suwon-si 16678 (KR); LEE, Sunghun, Suwon-si 16678 (KR); LEE, Yong Joo, Suwon-si 16678 (KR); CHOI, Byoungki, Suwon-si 16678 (KR); HWANG, Kyuyoung, Suwon-si 16678 (KR)
(74) Representative: Elkington and Fife LLP

(57) **Abstract**

A composition including a first compound represented by Formula 1 and a second compound represented by Formula 2:

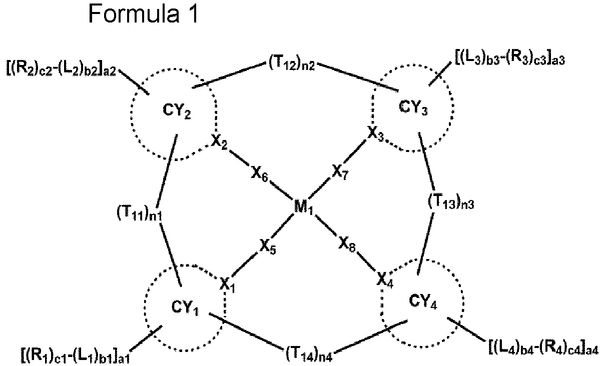

Formula 2 M₂(L₁₁)ₙ₁₁(L₁₂)n₁₂(L₁₃)ₙ₁₃

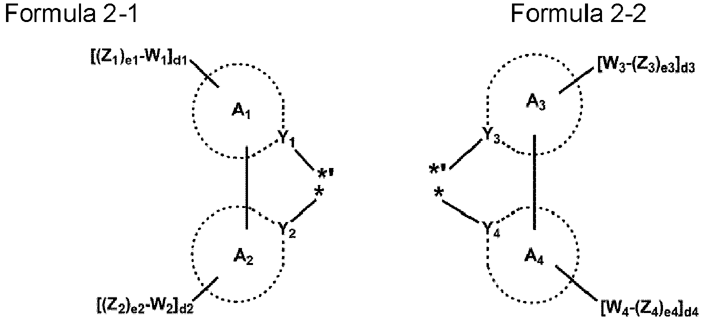

wherein in Formula 1, M₁ is Pt, Pd, or Au, in Formula 2, M₂ is Ir, L₁₁ is a ligand represented by Formula 2-1, L₁₂ is a ligand represented by Formula 2-2, L₁₃ is a ligand represented by Formula 2-1 or 2-2, L₁₁ and L₁₂ are different from each other, n11, n12, and n13 are each independently 0, 1, 2, or 3, and a sum of n11 + n12 + n13 is equal to 3, and wherein the remaining substituent groups are each understood by referring to the detailed description provided herein.

## Description

### FIELD OF THE INVENTION

The present disclosure relates to compositions, layers including the compositions, light-emitting devices including the compositions, and electronic apparatuses including the light-emitting devices.

### BACKGROUND OF THE INVENTION

From among light-emitting devices, organic light-emitting devices (OLEDs) are self-emissive devices, which have improved characteristics in terms of viewing angles, response time, luminance, driving voltage, and response speed, and produce full-color images.

In an example, an organic light-emitting device includes an anode, a cathode, and an organic layer between the anode and the cathode, wherein the organic layer includes an emission layer. A hole transport region may be located between the anode and the emission layer, and an electron transport region may be located or arranged between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. These excitons transition from an excited state to a ground state, thereby generating light.

### SUMMARY OF THE INVENTION

Provided are compositions capable of providing excellent luminescence efficiency and the like, layers including the compositions, light-emitting devices including the compositions, and electronic apparatuses including the light-emitting devices.

Additional aspects will be set forth in part in the description, which follows and, in part, will be apparent from the description, or may be learned by practice of the presented embodiments of the disclosure.

According to an aspect, provided is a composition including
a first compound represented by Formula 1 and a second compound represented by Formula 2:

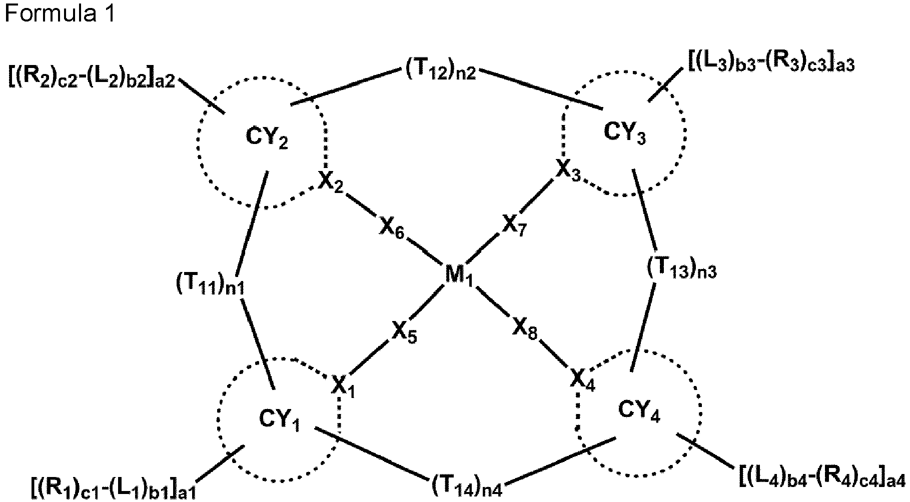

Formula 2 M₂(L₁₁)ₙ₁₁(L₁₂)ₙ₁₂(L₁₃)ₙ₁₃

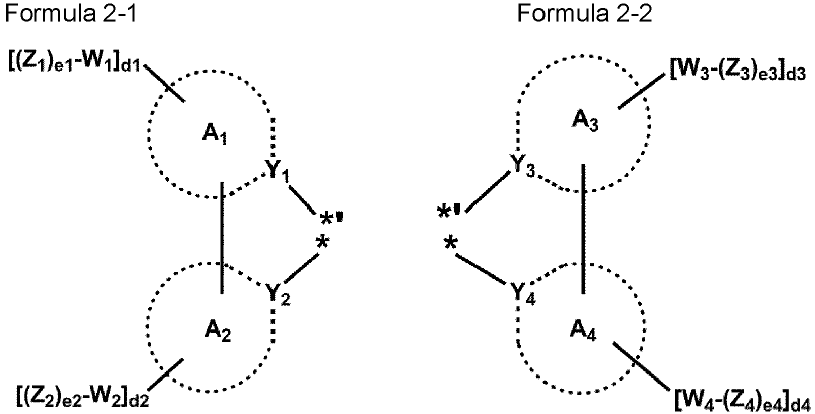

wherein, in Formula 1, M₁ is platinum (Pt), palladium (Pd), or gold (Au),
in Formula 2, M₂ is iridium (Ir),
in Formula 2, L₁₁ is a ligand represented by Formula 2-1,
in Formula 2, L₁₂ is a ligand represented by Formula 2-2,
in Formula 2, L₁₃ is a ligand represented by Formula 2-1 or 2-2,
in Formula 2, L₁₁ and L₁₂ are different from each other,
in Formula 2, n11, n12, and n13 are each independently 0, 1, 2, or 3, and n11 + n12 + n13 is 3,
in Formulae 1, 2-1, and 2-2, X₁ to X₄ and Y₁ to Y₄ are each independently C or N,
in Formula 1, X₅ to X₈ are each independently a chemical bond, O, S, N(R'), C(R')(R"), or C(=O), and at least one of X₅ to X₈ is not a chemical bond,
in Formula 1, two bonds of a bond between X₅ or X₁ and M₁, a bond between X₆ or X₂ and M₁, a bond between X₇ or X₃ and M₁, and a bond between X₈ or X₄ and M₁ are each a coordinate bond, and the other two bonds are each a covalent bond,
in Formulae 1, 2-1, and 2-2, ring CY₁ to ring CY₄ and ring A₁ to ring A₄ are each independently a C₅-C₃₀ carbocyclic group or a C₁-C₃₀ heterocyclic group,
in Formula 1, T₁₁ to T₁₄ are each independently a single bond, a double bond, *-N(R₅ₐ)-*', *-B(R₅ₐ)-*', *-P(R₅ₐ)-*', *-C(R₅ₐ)(R_{5b})-*', *-Si(R₅ₐ)(R_{5b})-*', *-Ge(R₅ₐ)(R_{5b})-*', *-S-*', *-Se-*', *-O-*', *-C(=O)-*', *-S(=O)-*', *-S(=O)2-*', *-C(R₅ₐ)=*', *=C(R₅ₐ)-*', *-C(R₅ₐ)=C(R_{5b})-*', *-C(=S)-*', *-C=C-*', a C₅-C₃₀ carbocyclic group that is unsubstituted or substituted with at least one R₁₀ₐ, or a C₁-C₃₀ heterocyclic group that is unsubstituted or substituted with at least one R₁₀ₐ, wherein * and *' each indicate a binding site to a neighboring atom,
in Formula 1, n1 to n4 are each independently 0 or 1, and three or more of n1 to n4 are each 1,
in Formula 1, T₁₁ is not present when n1 is 0, T₁₂ is not present when n2 is 0, T₁₃ is not present when n3 is 0, and T₁₄ is not present when n4 is 0,
in Formulae 1,2-1, and 2-2, L₁ to L₄ and W₁ to W₄ are each independently a single bond, a C₁-C₂₀ alkylene group that is unsubstituted or substituted with at least one R₁₀ₐ, a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
in Formula 1, b1 to b4 are each independently an integer from 1 to 10,
in Formulae 1, 2-1, and 2-2, R₁ to R₄, Rsa, R_{5b}, R', R", and Z₁ to Z₄ are each independently hydrogen, deuterium, -F, -CI, -Br, -I, -SFs, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₂-C₆₀ heteroarylthio group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -Ge(Q₃)(Q₄)(Q₅), -B(Q₆)(Q₇), -P(=O)(Q₆)(Q₉), or -P(Q₈)(Q₉),
in Formulae 1, 2-1, and 2-2, c1 to c4, a1 to a4, e1 to e4, and d1 to d4 are each independently an integer from 0 to 20, the second compound is not tris[2-phenylpyridine]iridium,
in Formulae 1, 2-1, and 2-2, at least two substituents from: i) two or more of a plurality of R₁(s); ii) two or more of a plurality of R₂(s) ; iii) two or more of a plurality of R₃(s) ; iv) two or more of a plurality of R₄(s) ; v) R₅ₐ and R_{5b}; vi) two or more of a plurality of Z₁(s) ; vii) two or more of a plurality of Z₂(s); viii) two or more of a plurality of Z₃(s), ix) two or more of a plurality of Z₄(s); x) two or more of R₁ to R₄, Rsa, and R_{5b}; and xi) two or more of Z₁ to Z₄ are each independently optionally linked to each other to form a C₅-C₃₀ carbocyclic group that is unsubstituted or substituted with at least one R₁₀ₐ or a C₁-C₃₀ heterocyclic group that is unsubstituted or substituted with at least one R₁₀ₐ,
R₁₀ₐ is as defined in connection with R₁,
in Formulae 2-1 and 2-2, * and *' each indicate a binding site to M₂, and at least one substituent of the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₂-C₆₀ heteroarylthio group, the substituted monovalent non-aromatic condensed polycyclic group, and the substituted monovalent non-aromatic condensed heteropolycyclic group is:
   deuterium, -F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
   a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with deuterium, -F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅), - Ge(Q₁₃)(Q₁₄)(Q₁₅), -B(Q₁₆)(Q₁₇), -P(=O)(Q₁₈)(Q₁₉), -P(Q₁₈)(Q₁₉), or a combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each unsubstituted or substituted with at least one of deuterium, -F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₂₁)(Q₂₂), - Si(Q23)(Q24)(Q25), -Ge(Q23)(Q24)(Q25), -B(Q26)(Q27), -P(=O)(Q₂₆)(Q₂₉), -P(Q28)(Q29), or a combination thereof;
-N(Q31)(Q32), -Si(Q33)(Q34)(Q35), -Ge(Q33)(Q34)(Q35), -B(Q36)(Q37), - P(=O)(Q₃₆)(Q₃₉), or -P(Q₃₆)(Q₃₉); or
a combination thereof,
wherein Q₁ to Q₉, Q₁₁ to Q₁₉, Q₂₁ to Q₂₉, and Q₃₁ to Q₃₉ are each independently: hydrogen, deuterium, -F, -CI, -Br; -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each unsubstituted or substituted with at least one of deuterium, a C₁-C₆₀ alkyl group, a C₆-C₆₀ aryl group, or a combination thereof.

According to another aspect, provided is a layer including the composition.

According to still another aspect, provided is a light-emitting device including: a first electrode; a second electrode; and an organic layer arranged between the first electrode and the second electrode, wherein the organic layer includes an emission layer, and wherein the organic layer includes the composition.

For example, the emission layer of the organic layer in the light-emitting device may include the composition.

According to another aspect, also provided is an electronic apparatus including the light-emitting device.

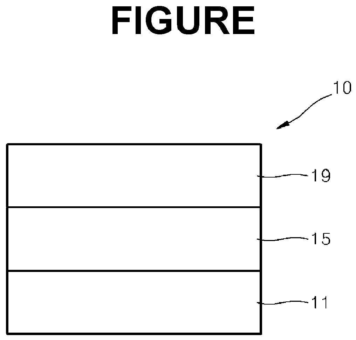

### BRIEF DESCRIPTION OF THE DRAWING

The above and other aspects, features, and advantages of one or more exemplary embodiments will be more apparent from the following detailed description taken in conjunction with the FIGURE, which shows a schematic cross-sectional view of a light-emitting device according to one or more embodiments.

### DETAILED DESCRIPTION OF THE EMBODIMENTS

Reference will now be made in detail to embodiments, examples of which are illustrated in the accompanying drawings, wherein like reference numerals refer to like elements throughout the specification. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

The terminology used herein is for the purpose of describing one or more exemplary embodiments only and is not intended to be limiting. As used herein, the singular forms "a," "an," and "the" are intended to include the plural forms as well, unless the context clearly indicates otherwise. The term "or" means "and/or." It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

It will be understood that when an element is referred to as being "on" another element, it can be directly in contact with the other element or intervening elements may be present therebetween. In contrast, when an element is referred to as being "directly on" another element, there are no intervening elements present.

Unless otherwise defined, all terms (including technical and scientific terms) used herein have the same meaning as commonly understood by one of ordinary skill in the art to which this general inventive concept belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10%, 5% of the stated value.

An aspect provides a composition including a first compound represented by Formula 1 and a second compound represented by Formula 2:

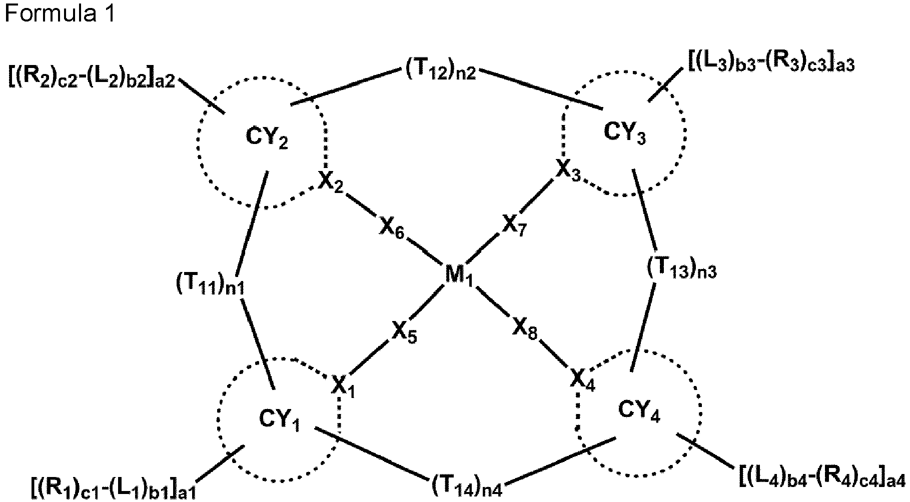

Formula 2 M₂(L₁₁)ₙ₁₁(L₁₂)ₙ₁₂(L₁₃)ₙ₁₃.

In Formula 1, M₁ is platinum (Pt), palladium (Pd), or gold (Au).

For example, in Formula 1, M₁ may be Pt.

In Formula 2, M₂ is Ir.

In Formula 2, L₁₁ is a ligand represented by Formula 2-1, L₁₂ is a ligand represented by Formula 2-2, and L₁₃ is a ligand represented by Formula 2-1 or 2-2: 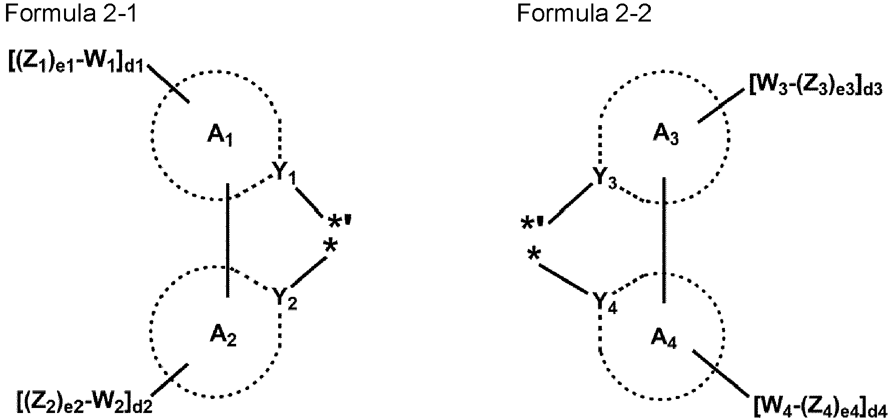 wherein Formulae 2-1 and 2-2 are described herein.

In Formula 2, L₁₁ and L₁₂ are different from each other.

In Formula 2, n11 to n13 indicate the number of L₁₁(s) to the number of L₁₃(s), respectively, and are each independently be 0, 1, 2, or 3, wherein n11 + n12 + n13 is 3. In other words, in Formula 2, the sum of n11, n12, and n13 is equal to 3.

In one or more embodiments, in Formula 2, n11 may be 1, 2, or 3, and n12 and n13 may each independently be 0, 1, or 2.

In one or more embodiments, in Formula 2, n12 may be 1, 2, or 3, and n11 and n13 may each independently be 0, 1, or 2.

In one or more embodiments, n11 may be 1, n12 may be 2, and n13 may be 0.

In one or more embodiments, n11 may be 2, n12 may be 1, and n13 may be 0.

In one or more embodiments, n11 may be 3, and n12 and n13 may each be 0.

In one or more embodiments, n12 may be 3, and n11 and n13 may each be 0.

The second compound represented by Formula 2 may be a heteroleptic complex or a homoleptic complex.

In one or more embodiments, the second compound may be a heteroleptic complex.

In Formulae 1, 2-1, and 2-2, X₁ to X₄ and Y₁ to Y₄ are each independently C or N. In one or more embodiments, at least one of X₁ to X₄ in Formula 1 may be C.

In one or more embodiments, X₁ in Formula 1 may be C.

In one or more embodiments, in Formula 1, i) X₁ and X₃ may each be C, and X₂ and X₄ may each be N, or ii) X₁ and X₄ may each be C, and X₂ and X₃ may each be N.

In one or more embodiments, in Formulae 2-1 and 2-2, Y₁ and Y₃ may each be N, and Y₂ and Y₄ may each be C.

In Formula 1, X₅ to Xs are each independently a chemical bond, O, S, N(R'), C(R')(R"), or C(=O), wherein at least one of X₅ to X₈ may not be a chemical bond. R' and R" may each be as defined herein. As used herein, a "chemical bond" refers to a covalent bond (e.g., a single bond) or a coordinate bond.

In one or more embodiments, X₅ in Formula 1 may not be a chemical bond.

In one or more embodiments, X₅ in Formula 1 may be O or S.

In one or more embodiments, in Formula 1, X₅ may be O or S, and X₆ to X₈ may each be a chemical bond.

In Formula 1, two bonds of a bond between X₅ or X₁ and M₁, a bond between X₆ or X₂ and M₁, a bond between X₇ or X₃ and M₁, and a bond between X₈ or X₄ and M₁ are each a coordinate bond, and the other two bonds of the bond between X₅ or X₁ and M₁, the bond between X₆ or X₂ and M₁, the bond between X₇ or X₃ and M₁, and the bond between X₈ or X₄ and M₁ are each a covalent bond.

For example, in Formula 1, a bond between X₂ and M₁ may be a coordinate bond.

In one or more embodiments, in Formula 1, a bond between X₅ or X₁ and M₁ and a bond between X₃ and M₁ may each be a covalent bond, and a bond between X₂ and M₁ and a bond between X₄ and M₁ may each be a coordinate bond.

In one or more embodiments, the first compound and the second compound may each be electrically neutral.

In Formulae 1, 2-1, and 2-2, ring CY₁ to ring CY₄ and ring A₁ to ring A₄ are each independently a C₅-C₃₀ carbocyclic group or a C₁-C₃₀ heterocyclic group.

For example, in one or more embodiments, each of ring CY₁, ring CY₃, and ring CY₄ may not be a benzimidazole group.

For example, in one or more embodiments, in Formulae 1, 2-1, and 2-2, ring CY₁ to ring CY₄ and ring A₁ to A₄ may each independently be i) a first ring, ii) a second ring, iii) a condensed ring in which two or more first rings are condensed with each other, iv) a condensed ring in which two or more second rings are condensed with each other, or v) a condensed ring in which one or more first rings are condensed with one or more second rings,
wherein the first ring may be a cyclopentane group, a cyclopentene group, a furan group, a thiophene group, a pyrrole group, a silole group, a borole group, a phosphole group, a germole group, a selenophene group, an oxazole group, an oxadiazole group, an oxatriazole group, a thiazole group, a thiadiazole group, a thiatriazole group, a pyrazole group, an imidazole group, a triazole group, a tetrazole group, or an azasilole group, and
the second ring may be an adamantane group, a norbornane group, a norbornene group, a piperidine group, a cyclohexane group, a cyclohexene group, a benzene group, a pyridine group, a pyrimidine group, a pyrazine group, a pyridazine group, or a triazine group.

In one or more embodiments, in Formulae 1, 2-1, and 2-2, ring CY₁ to ring CY₄ and ring A₁ to ring A₄ may each independently be a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, a pyrrole group, a furan group, a thiophene group, a silole group, a borole group, a phosphole group, a germole group, a selenophene group, an indene group, an indole group, a benzofuran group, a benzothiophene group, a benzosilole group, a benzoborole group, a benzophosphole group, a benzogermole group, a benzoselenophene group, a fluorene group, a carbazole group, a dibenzofuran group, a dibenzothiophene group, a dibenzosilole group, a dibenzoborole group, a dibenzophosphole group, a dibenzogermole group, a dibenzoselenophene group, a benzofluorene group, a benzocarbazole group, a naphthobenzofuran group, a naphthobenzothiophene group, a naphthobenzosilole group, a naphthobenzoborole group, a naphthobenzophosphole group, a naphthobenzogermole group, a naphthobenzoselenophene group, a dibenzofluorene group, a dibenzocarbazole group, a dinaphthofuran group, a dinaphthothiophene group, a dinaphthosilole group, a dinaphthoborole group, a dinaphthophosphole group, a dinaphthogermole group, a dinaphthoselenophene group, an indenophenanthrene group, an indolophenanthrene group, a phenanthrobenzofuran group, a phenanthrobenzothiophene group, a phenanthrobenzosilole group, a phenanthrobenzoborole group, a phenanthrobenzophosphole group, a phenanthrobenzogermole group, a phenanthrobenzoselenophene group, a dibenzothiophene 5-oxide group, a 9H-fluorene-9-one group, a dibenzothiophene 5,5-dioxide group, an azaindene group, an azaindole group, an azabenzofuran group, an azabenzothiophene group, an azabenzosilole group, an azabenzoborole group, an azabenzophosphole group, an azabenzogermole group, an azabenzoselenophene group, an azafluorene group, an azacarbazole group, an azadibenzofuran group, an azadibenzothiophene group, an azadibenzosilole group, an azadibenzoborole group, an azadibenzophosphole group, an azadibenzogermole group, an azadibenzoselenophene group, an azabenzofluorene group, an azabenzocarbazole group, an azanaphthobenzofuran group, an azanaphthobenzothiophene group, an azanaphthobenzosilole group, an azanaphthobenzoborole group, an azanaphthobenzophosphole group, an azanaphthobenzogermole group, an azanaphthobenzoselenophene group, an azadibenzofluorene group, an azadibenzocarbazole group, an azadinaphthofuran group, an azadinaphthothiophene group, an azadinaphthosilole group, an azadinaphthoborole group, an azadinaphthophosphole group, an azadinaphthogermole group, an azadinaphthoselenophene group, an azaindenophenanthrene group, an azaindolophenanthrene group, an azaphenanthrobenzofuran group, an azaphenanthrobenzothiophene group, an azaphenanthrobenzosilole group, an azaphenanthrobenzoborole group, an azaphenanthrobenzophosphole group, an azaphenanthrobenzogermole group, an azaphenanthrobenzoselenophene group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a benzoquinoline group, a benzoisoquinoline group, a benzoquinoxaline group, a benzoquinazoline group, a phenanthroline group, a phenanthridine group, a pyrrole group, a pyrazole group, imidazole group, a triazole group, an oxazole group, an isoxazole group, a thiazole group, an isothiazole group, an oxadiazole group, a thiadiazole group, an azasilole group, an azaborole group, an azaphosphole group, an azagermole group, an azaselenophene group, a benzopyrrole group, a benzopyrazole group, a benzimidazole group, a benzoxazole group, a benzisoxazole group, a benzothiazole group, a benzisothiazole group, a benzoxadiazole group, a benzothiadiazole group, a pyridinopyrrole group, a pyridinopyrazole group, a pyridinoimidazole group, a pyridinooxazole group, a pyridinoisoxazole group, a pyridinothiazole group, a pyridinoisothiazole group, a pyridinooxadiazole group, a pyridinothiadiazole group, a pyrimidinopyrrole group, a pyrimidinopyrazole group, a pyrimidinoimidazole group, a pyrimidinooxazole group, a pyrimidinoisoxazole group, a pyrimidinothiazole group, a pyrimidinoisothiazole group, a pyrimidinooxadiazole group, a pyrimidinothiadiazole group, a naphthopyrrole group, a naphthopyrazole group, a naphthoimidazole group, a naphthoxazole group, a naphthoisoxazole group, a naphthothiazole group, a naphthoisothiazole group, a naphthoxadiazole group, a naphthothiadiazole group, a phenanthrenopyrrole group, a phenanthrenopyrazole group, a phenanthrenoimidazole group, a phenanthrenoxazole group, a phenanthrenoisoxazole group, a phenanthrenothiazole group, a phenanthrenoisothiazole group, a phenanthrenoxadiazole group, a phenanthrenothiadiazole group, a 5,6,7,8-tetrahydroisoquinoline group, a 5,6,7,8-tetrahydroquinoline group, an adamantane group, a norbornane group, a norbornene group, a benzene group condensed with a cyclohexane group, a benzene group condensed with a norbornane group, a pyridine group condensed with a cyclohexane group, or a pyridine group condensed with a norbornane group.

In one or more embodiments, ring CY₁ and ring CY₃ in Formula 1 may each independently be:
a benzene group, a naphthalene group, a phenanthrene group, a dibenzofuran group, a dibenzothiophene group, a dibenzoselenophene group, a carbazole group, a fluorene group, or a dibenzosilole group; or
a benzene group, a naphthalene group, a phenanthrene group, a dibenzofuran group, a dibenzothiophene group, a dibenzoselenophene group, a carbazole group, a fluorene group, or a dibenzosilole group, each condensed with
at least one of a cyclohexane group, a cyclohexene group, a norbornane group, a piperidine group, or a combination thereof.

In one or more embodiments, ring CY₂ in Formula 1 may be:
an imidazole group, a benzimidazole group, a pyridine group, a pyrimidine group, a pyridazine group, a pyrazine group, a triazine group, a quinoline group, an isoquinoline group, a quinoxaline group, or a quinazoline group; or
an imidazole group, a benzimidazole group, a pyridine group, a pyrimidine group, a pyridazine group, a pyrazine group, a triazine group, a quinoline group, an isoquinoline group, a quinoxaline group, or a quinazoline group, each condensed with at least one of a cyclohexane group, a cyclohexene group, a norbornane group, a benzene group, a pyridine group, a pyrimidine group, or a combination thereof.

In one or more embodiments, ring CY₄ in Formula 1 may be:
a pyridine group, a pyrimidine group, a pyridazine group, a pyrazine group, a triazine group, a quinoline group, an isoquinoline group, a quinoxaline group, a quinazoline group, an azadibenzofuran group, an azadibenzothiophene group, an azadibenzoselenophene group, an azacarbazole group, an azafluorene group, or an azadibenzosilole group; or
a pyridine group, a pyrimidine group, a pyridazine group, a pyrazine group, a triazine group, a quinoline group, an isoquinoline group, a quinoxaline group, a quinazoline group, an azadibenzofuran group, an azadibenzothiophene group, an azadibenzoselenophene group, an azacarbazole group, an azafluorene group, or an azadibenzosilole group, each condensed with at least one of a cyclohexane group, a cyclohexene group, a norbornane group, a benzene group, a pyridine group, a pyrimidine group, or a combination thereof.

In Formulae 2-1 and 2-2, ring A₁ and ring A₃ may be different from each other.

In one or more embodiments, a Y₁-containing monocyclic group in ring A₁, a Y₂containing monocyclic group in ring A₂, and Y₄-containing monocyclic group in ring A₄ may each be a 6-membered ring.

In one or more embodiments, a Y₃-containing monocyclic group in ring A₃ may be a 6-membered ring.

In one or more embodiments, a Y₃-containing monocyclic group in ring A₃ may be a 5-membered ring.

In one or more embodiments, a Y₁-containing monocyclic group in ring A₁ may be a 6-membered ring, and a Y₃-containing monocyclic group in ring A₃ may be a 5-membered ring.

In one or more embodiments, in Formulae 2-1 and 2-2, ring A₁ and ring A₃ may each independently be i) one of Group A, ii) a polycyclic group in which two or more of Group A are condensed with each other, or iii) a polycyclic group in which at least one of Group A and at least one of Group B are condensed with each other,
wherein Group A may include a pyridine group, a pyrimidine group, a pyridazine group, a pyrazine group, or a triazine group, and

Group B may include a cyclohexane group, a cyclohexene group, a norbornane group, a benzene group, a furan group, a thiophene group, a selenophene group, a pyrrole group, a cyclopentadiene group, or silole group. In one or more embodiments, in Formula 2-2, ring A₃ may be i) one of Group C, ii) a polycyclic group in which two or more of Group C are condensed with each other, or iii) a polycyclic group in which at least one of Group C and at least one of Group D are condensed with each other,
wherein Group C may include a pyrrole group, a pyrazole group, an imidazole group, a triazole group, an oxazole group, an isoxazole group, a thiazole group, or an isothiazole group, and

Group D may include a cyclohexane group, a cyclohexene group, a norbornane group, a benzene group, a furan group, a thiophene group, a selenophene group, a cyclopentadiene group, a silole group, a pyridine group, a pyrimidine group, a pyridazine group, a pyrazine group, or a triazine group.

In one or more embodiments, ring A₁ in Formula 2-1 may be:
a pyridine group, a pyrimidine group, a pyridazine group, or a pyrazine group; or
a pyridine group, a pyrimidine group, a pyridazine group, or a pyrazine group, each condensed with at least one of a cyclohexane group, a norbornane group, a benzene group, or a combination thereof.

In one or more embodiments, ring A₃ in Formula 2-2 may be:
a pyridine group, a pyrimidine group, a pyridazine group, or a pyrazine group;
a pyridine group, a pyrimidine group, a pyridazine group, or a pyrazine group, each condensed with at least one of a cyclohexane group, a norbornane group, a benzene group, or a combination thereof; or
an imidazole group, a benzimidazole group, a naphthoimidazole group, a phenanthrenoimidazole group, a pyridoimidazole group, an oxazole group, a benzoxazole group, a naphthooxazole group, a phenanthrenoxazole group, a pyridooxazole group, a thiazole group, a benzothiazole group, a naphthothiazole group, a phenanthrenothiazole group, or a pyridothiazole group.

In one or more embodiments, in Formulae 2-1 and 2-2, ring A₂ and ring A₄ may be different from each other.

In one or more embodiments, in Formulae 2-1 and 2-2, ring A₂ and ring A₄ may each independently be i) one of Group E, ii) a polycyclic group in which two or more of Group E are condensed with each other, or iii) a polycyclic group in which at least one of Group E and at least one of Group F are condensed with each other,
wherein Group E may include a benzene group, a pyridine group, a pyrimidine group, a pyridazine group, a pyrazine group, or a triazine group, and

Group F may include a furan group, a thiophene group, a selenophene group, a pyrrole group, a cyclopentadiene group, a silole group, a pyrazole group, an imidazole group, an oxazole group, a thiazole group, an isoxazole group, or an isothiazole group.

In one or more embodiments, in Formula 2-1, ring A₂ may be a polycyclic group in which two or more of Group E and at least one of Group F are condensed with each other.

In one or more embodiments, in Formula 2-2, ring A₄ may be a polycyclic group in which two or more of Group E and at least one of Group F are condensed with each other.

In one or more embodiments, ring A₂ in Formula 2-1 may be:
a benzene group, a naphthalene group, a phenanthrene group, a dibenzofuran group, a dibenzothiophene group, a dibenzoselenophene group, a carbazole group, a fluorene group, or a dibenzosilole group; or
a benzene group, a naphthalene group, a phenanthrene group, a dibenzofuran group, a dibenzothiophene group, a dibenzoselenophene group, a carbazole group, a fluorene group, or a dibenzosilole group, each condensed with a cyclohexane group, a norbornane group, a benzene group, or a combination thereof.

In one or more embodiments, ring A₄ in Formula 2-2 may be:
a benzene group, a naphthalene group, a phenanthrene group, a phenanthrobenzofuran group, a dibenzofuran group, a dibenzothiophene group, a dibenzoselenophene group, a carbazole group, a fluorene group, a dibenzosilole group, an azadibenzofuran group, an azadibenzothiophene group, an azadibenzoselenophene group, an azacarbazole group, an azafluorene group, or a dibenzosilole group; or
a benzene group, a naphthalene group, a phenanthrene group, a dibenzofuran group, a dibenzothiophene group, a dibenzoselenophene group, a carbazole group, a fluorene group, a dibenzosilole group, an azadibenzofuran group, an azadibenzothiophene group, an azadibenzoselenophene group, an azacarbazole group, an azafluorene group, or a dibenzosilole group, each condensed with at least one of a benzene group, a pyridine group, a pyrimidine group, a pyridazine group, a pyrazine group, a cyclohexane group, a norbornane group, a furan group, a thiophene group, a selenophene group, a pyrrole group, a cyclopentadiene group, a silole group, a pyrazole group, an imidazole group, an oxazole group, a thiazole group, an isoxazole group, an isothiazole group, or a combination thereof.

In Formula 1, T₁₁ to T₁₄ may each independently be a single bond, a double bond, *-N(R₅ₐ)-*', *-B(R₅ₐ)-*', *-P(R₅ₐ)-*', *-C(R₅ₐ)(R_{5b})-*', *-Si(R₅ₐ)(R_{5b})-*', *-Ge(R₅ₐ)(R_{5b})-*', *-S-*', *-Se-*', *-O-*', *-C(=O)-*', *-S(=O)-*', *-S(=O)2-*', *-C(R5a)=*', *=C(R5a)-*', *-C(R₅ₐ)=C(R_{5b})-*', *-C(=S)-*', *-C=C-*', a C₅-C₃₀ carbocyclic group that is unsubstituted or substituted with at least one R₁₀ₐ, or a C₁-C₃₀ heterocyclic group that is unsubstituted or substituted with at least one R₁₀ₐ, wherein * and *' each indicates a binding site to a neighboring atom.

For example, in Formula 1, each of T₁₁ and T₁₂ may be a single bond, and T₁₃ may be a single bond, *-N(R₅ₐ)-*', *-B(R₅ₐ)-*', *-P(R₅ₐ)-*', *-C(R₅ₐ)(R_{5b})-*', *-Si(R₅ₐ)(R_{5b})-*', *-Ge(R₅ₐ)(R_{5b})-*', *-S-*', or *-O-*'.

In Formula 1, n1 to n4 each indicate the number of T₁₁ to the number of T₁₄, and are each independently 0 or 1, wherein three or more of n1 to n4 are 1. That is, the first compound represented by Formula 1 may have a tetradentate ligand.

In Formula 1, when n1 is 0, T₁₁ is not present (that is, ring CY₁ and ring CY₂ are not linked to each other), when n2 is 0, T₁₂ is not present (that is, ring CY₂ and ring CY₃ are not linked to each other), when n3 is 0, T₁₃ is not present (that is, ring CY₃ and ring CY₄ are not linked to each other), and when n4 is 0, T₁₄ is not present (that is, ring CY₄ and ring CY₁ are not linked to each other).

In one or more embodiments, in Formula 1, n1 to n3 may each be 1, and n4 may be 0.

In one or more embodiments, in Formulae 1, 2-1, and 2-2, L₁ to L₄ and W₁ to W₄ are each independently a single bond, a C₁-C₂₀ alkylene group that is unsubstituted or substituted with at least one R₁₀ₐ, a C₅-C₃₀ carbocyclic group that is unsubstituted or substituted with at least one R₁₀ₐ, or a C₁-C₃₀ heterocyclic group that is unsubstituted or substituted with at least one R₁₀ₐ.

In one or more embodiments, in Formulae 1, 2-1, and 2-2, L₁ to L₄ and W₁ to W₄ may each independently be:
a single bond; or
a C₁-C₂₀ alkylene group, a cyclopentene group, a cyclohexane group, a cyclohexene group, a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an iso-oxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, a 5,6,7,8-tetrahydroquinoline group, an adamantane group, a norbornane group, or a norbornene group, each unsubstituted or substituted with at least one R₁₀ₐ.

In one or more embodiments, in Formulae 1, 2-1, and 2-2, L₁ to L₄ and W₁ to W₄ may each independently be:
a single bond; or
a C₁-C₂₀ alkylene group, a benzene group, a naphthalene group, a pyridine group, a fluorene group, a carbazole group, a dibenzofuran group, or a dibenzothiophene group, each unsubstituted or substituted with at least one R₁₀ₐ.

In one or more embodiments, in Formulae 1, 2-1, and 2-2, L₁ to L₄ and W₁ to W₄ may each independently be:
a single bond; or
a C₁-C₂₀ alkylene group, a benzene group, a naphthalene group, a dibenzofuran group, or a dibenzothiophene group, each unsubstituted or substituted with at least one of deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a phenyl group, a deuterated phenyl group, a fluorinated phenyl group, a (C₁-C₂₀ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, or a combination thereof.

In Formula 1, b1 to b4 indicate the number of L₁(s) to the number of L₄(s), respectively, and are each independently an integer from 1 to 10. When b1 is 2 or more, two or more of L₁(s) may be identical to or different from each other, when b2 is 2 or more, two or more of L₂(s) may be identical to or different from each other, when b3 is 2 or more, two or more of L₃(s) may be identical to or different from each other, and when b4 is 2 or more, two or more of L₄(s) may be identical to or different from each other. For example, b1 to b4 may each independently be 1, 2, or 3.

In Formulae 1, 2-1, and 2-2, R₁ to R₄, R₅ₐ, R_{5b}, R', R", and Z₁ to Z₄ are each independently hydrogen, deuterium, -F, -CI, -Br, -I, -SFs, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -Ge(Q₃)(Q₄)(Q₅), -B(Q₆)(Q₇), -P(=O)(Q₆)(Q₉), or -P(Q₈)(Q₉). Q₁ to Q₉ are as defined herein.

In Formulae 1, 2-1, and 2-2, R₁ to R₄, R₅ₐ, R_{5b}, R, R", and Z₁ to Z₄ may each independently be:
hydrogen, deuterium, -F, -CI, -Br, -I, -SFs, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, C₁-C₂₀ alkyl group, a C₁-C₂₀ alkenyl group, a C₁-C₂₀ alkoxy group, or a C₁-C₂₀ alkylthio group;
a C₁-C₂₀ alkyl group, a C₁-C₂₀ alkenyl group, a C₁-C₂₀ alkoxy group, or a C₁-C₂₀ alkylthio group, each substituted with at least one of deuterium, -F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.1]heptyl group, a (C₁-C₂₀ alkyl)bicyclo[2.2.2]octyl group, a phenyl group, a (C₁-C₂₀ alkyl)phenyl group, a biphenyl group, a terphenyl group, a naphthyl group, a pyridinyl group, a pyrimidinyl group, or a combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1,1]pentyl group, a bicyclo[2.1.1]hexyl group, a bicyclo[2.2.1]heptyl group, a bicyclo[2.2.2]octyl group, a phenyl group, a (C₁-C₂₀ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each unsubstituted or substituted with at least one of deuterium, -F, -CI, - Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a deuterated C₁-C₂₀ alkyl group, a fluorinated C₁-C₂₀ alkyl group, a C₁-C₂₀ alkoxy group, a C₁-C₂₀ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1,1]pentyl group, a bicyclo[2.1.1]hexyl group, a bicyclo[2.2.1]heptyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.1]heptyl group, a (C₁-C₂₀ alkyl)bicyclo[2.2.2]octyl group, a phenyl group, a (C₁-C₂₀ alkyl)phenyl group, a deuterated phenyl group, a fluorinated phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, or a combination thereof; or
-N(Q₁)(Q₂), -Si(Q₃)(Q₄)(Q₅), -Ge(Q₃)(Q₄)(Q₅), -B(Q₆)(Q₇), -P(=O)(Q₆)(Q₉), or -P(Q₈)(Q₉),
wherein Q₁ to Q₉ may each independently be:
   deuterium, -F, -CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃, -CD₂CD₂H, -CD₂CDH₂, -CF₃, -CF₂H, -CFH₂, -CH₂CF₃, -CH₂CF₂H, -CH₂CFH₂, -CHFCH₃, - CHFCF₂H, -CHFCFH₂, -CHFCF₃, -CF₂CF₃, -CF₂CF₂H, or -CF₂CFH₂; or
   an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a secisopentyl group, a phenyl group, a biphenyl group, or a naphthyl group, each unsubstituted or substituted with at least one of deuterium, -F, C₁-C₁₀ alkyl group, a phenyl group, or a combination thereof.

In one or more embodiments, in Formulae 1, 2-1, and 2-2, R₁ to R₄, R₅ₐ, R_{5b}, R, R", and Z₁ to Z₄ may each independently be:
hydrogen, deuterium, -F, or a cyano group;
a C₁-C₂₀ alkyl group unsubstituted or substituted with at least one of deuterium, -F, a cyano group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, a dibenzofuranyl group, a deuterated dibenzofuranyl group, a fluorinated dibenzofuranyl group, a (C₁-C₂₀ alkyl)dibenzofuranyl group, a dibenzothiophenyl group, a deuterated dibenzothiophenyl group, a fluorinated dibenzothiophenyl group, a (C₁-C₂₀ alkyl)dibenzothiophenyl group, or a combination thereof;
a C₃-C₁₀ cycloalkyl group, a C₁-C₁₀ heterocycloalkyl group, a phenyl group, a biphenyl group, a naphthyl group, a pyridinyl group, a fluorenyl group, a carbazolyl group, a dibenzofuranyl, or a dibenzothiophenyl group, each unsubstituted or substituted with at least one of deuterium, -F, a cyano group, a C₁-C₂₀ alkyl group, a deuterated C₁-C₂₀ alkyl group, fluorinated C₁-C₂₀ alkyl group, a C₁-C₂₀ alkoxy group, a deuterated C₁-C₂₀ alkoxy group, a fluorinated C₁-C₂₀ alkoxy group, a C₁-C₂₀ alkylthio group, a deuterated C₁-C₂₀ alkylthio group, a fluorinated C₁-C₂₀ alkylthio group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, a dibenzofuranyl group, a deuterated dibenzofuranyl group, a fluorinated dibenzofuranyl group, a (C₁-C₂₀ alkyl)dibenzofuranyl group, a dibenzothiophenyl group, a deuterated dibenzothiophenyl group, a fluorinated dibenzothiophenyl group, a (C₁-C₂₀ alkyl)dibenzothiophenyl group, or a combination thereof; or -Si(Q3)(Q4)(Q5) or -Ge(Q3)(Q4)(Q5).

In one or more embodiments, in Formula 2-1, each of e1 and d1 may not be 0, and at least one of a plurality of Z₁(s) may be a deuterated C₁-C₂₀ alkyl group, - Si(Q₃)(Q₄)(Q₅), or -Ge(Q₃)(Q₄)(Q₅). Q₃ to Q₅ may each be as defined herein.

In one or more embodiments, Q₃ to Q₅ may each independently be:
a C₁-C₆₀ alkyl group unsubstituted or substituted with at least one of deuterium, a C₁-C₆₀ alkyl group, a C₆-C₆₀ aryl group, or a combination thereof; or
a C₆-C₆₀ aryl group unsubstituted or substituted with at least one of deuterium, a C₁-C₆₀ alkyl group, a C₆-C₆₀ aryl group, or a combination thereof.

In one or more embodiments, Q₃ to Q₅ may each independently be:
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, or -CD₂CDH₂; or
an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a secisopentyl group, a phenyl group, a biphenyl group, or a naphthyl group, each unsubstituted or substituted with deuterium, a C₁-C₁₀ alkyl group, a phenyl group, or a combination thereof. In one or more embodiments, Q₃ to Q₅ may be identical to each other.

In one or more embodiments, two or more of Q₃ to Q₅ may be different from each other.

In one or more embodiments, the second compound may satisfy at least one of Condition (1) to Condition (8):
Condition (1) each of e1 and d1 in Formula 2-1 is not 0, and at least one Z₁ includes deuterium;
Condition (2) each of e2 and d2 in Formula 2-1 is not 0, and at least one Z₂ includes deuterium;
Condition (3) each of e3 and d3 in Formula 2-2 is not 0, and at least one Z₃ includes deuterium;
Condition (4) each of e4 and d4 in Formula 2-2 is not 0, and at least one Z₄ includes deuterium;
Condition (5) each of e1 and d1 in Formula 2-1 is not 0, and at least one Z₁ includes a fluoro group;
Condition (6) each of e2 and d2 in Formula 2-1 is not 0, and at least one Z₂ includes a fluoro group;
Condition (7) each of e3 and d3 in Formula 2-2 is not 0, and at least one Z₃ includes a fluoro group; or
Condition (8) each of e4 and d4 in Formula 2-2 is not 0, and at least one Z₄ includes a fluoro group.

In one or more embodiments, in Formulae 1, 2-1, and 2-2, R₁ to R₄, R₅ₐ, R_{5b}, R, R", and Z₁ to Z₄ may each independently be hydrogen, deuterium, -F, -CH₃, -CD₃, -CD₂H, -CDH₂, -CF₃, -CF₂H, -CFH₂, a C₁-C₁₀ alkenyl group, a C₁-C₁₀ alkoxy group, a C₁-C₁₀ alkylthio group, a group represented by one of Formulae 9-1 to 9-39, a group represented by one of Formulae 9-1 to 9-39 in which at least one hydrogen is substituted with deuterium, a group represented by one of Formulae 9-1 to 9-39 in which at least one hydrogen is substituted with -F, a group represented by one of Formulae 9-201 to 9-227, a group represented by one of Formulae 9-201 to 9-227 in which at least one hydrogen is substituted with deuterium, a group represented by one of Formulae 9-201 to 9-227 in which at least one hydrogen is substituted with -F, a group represented by one of Formulae 10-1 to 10-129, a group represented by one of Formulae 10-1 to 10-129 in which at least one hydrogen is substituted with deuterium, a group represented by one of Formulae 10-1 to 10-129 in which at least one hydrogen is substituted with -F, a group represented by one of Formulae 10-201 to 10-350, a group represented by one of Formulae 10-201 to 10-350 in which at least one hydrogen is substituted with deuterium, a group represented by one of Formulae 10-201 to 10-350 in which at least one hydrogen

is substituted with -F, -Si(Q₃)(Q₄)(Q₅), or -Ge(Q₃)(Q₄)(Q₅) (wherein Q₃ to Q₅ may each be as defined herein):

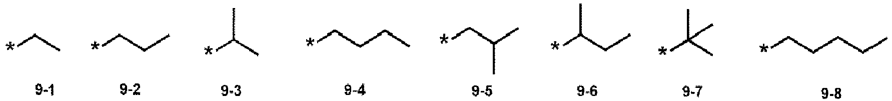

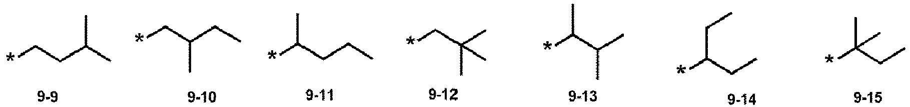

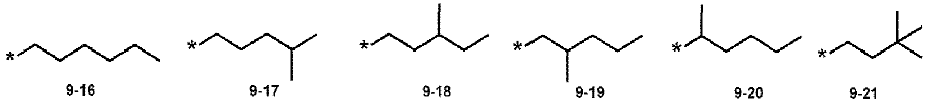

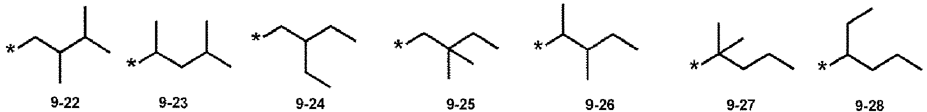

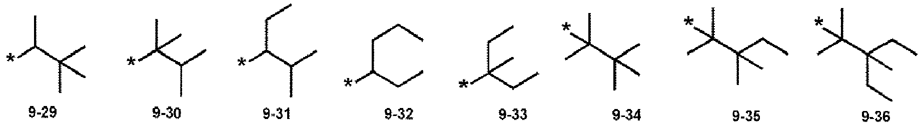

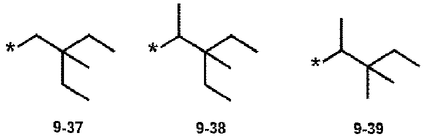

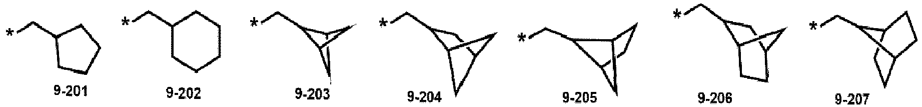

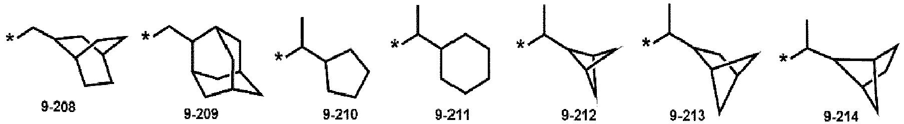

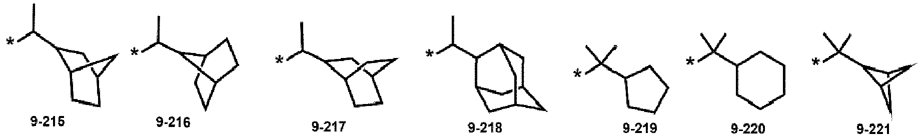

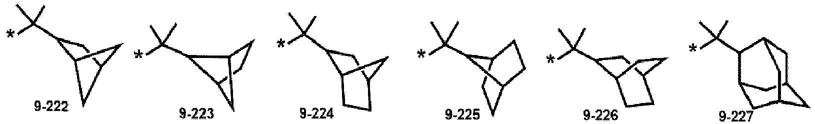

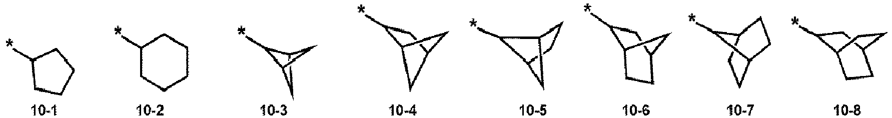

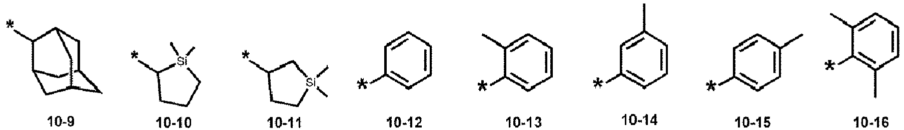

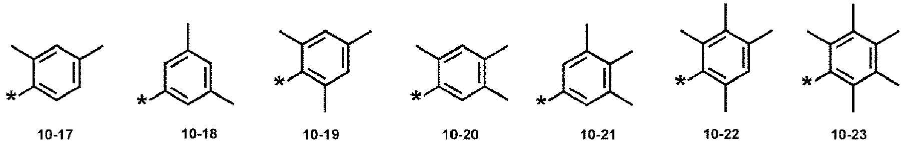

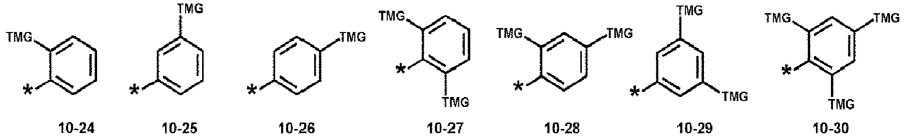

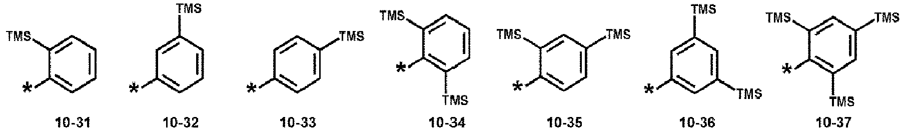

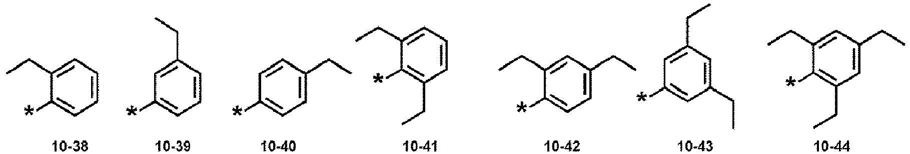

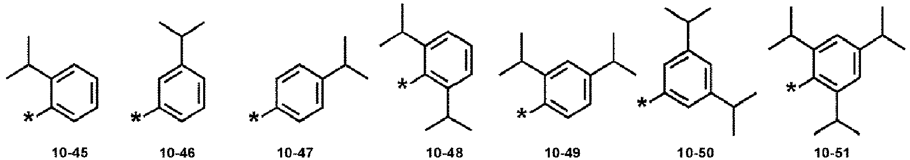

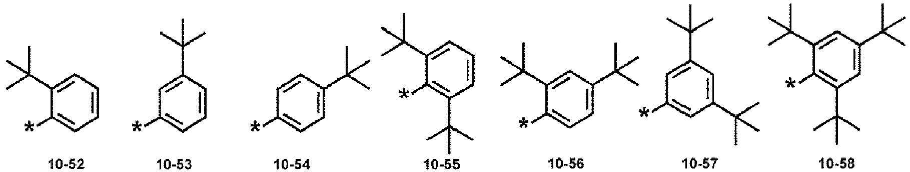

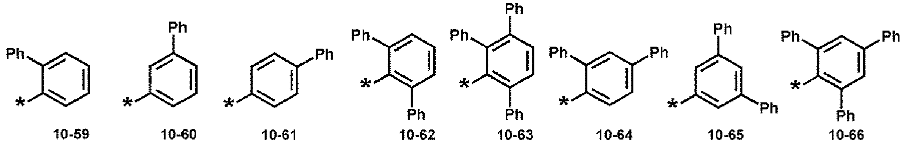

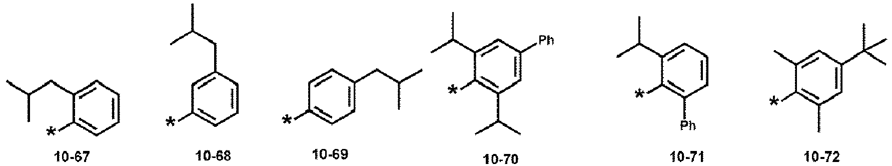

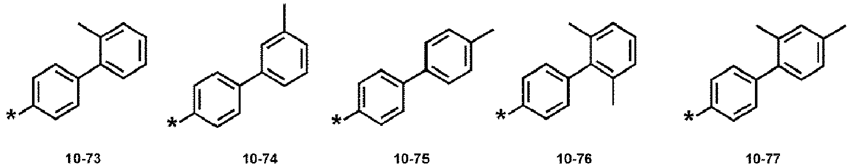

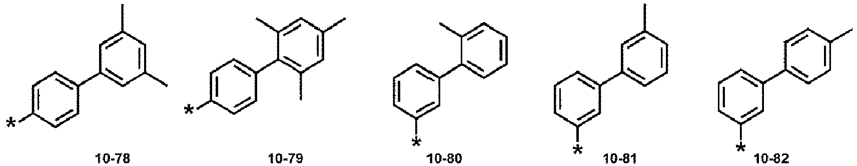

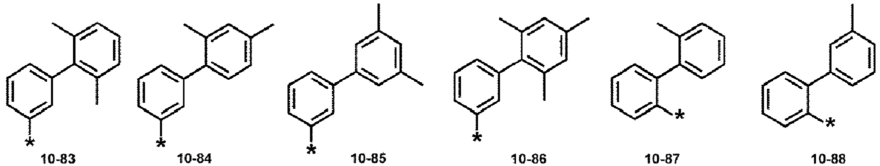

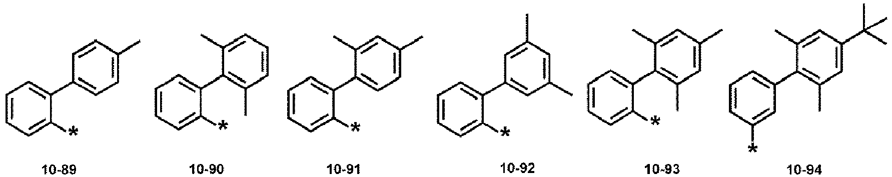

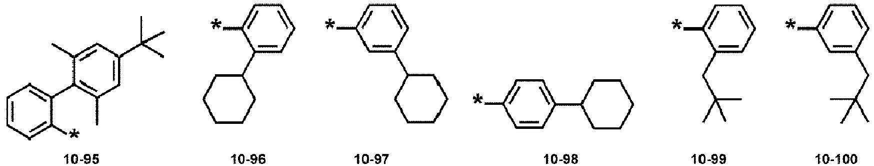

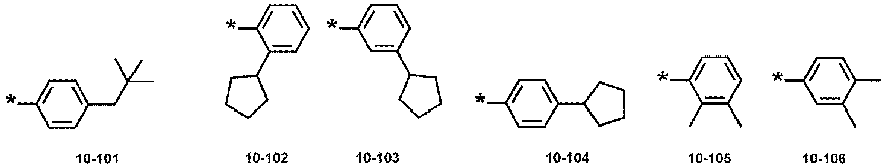

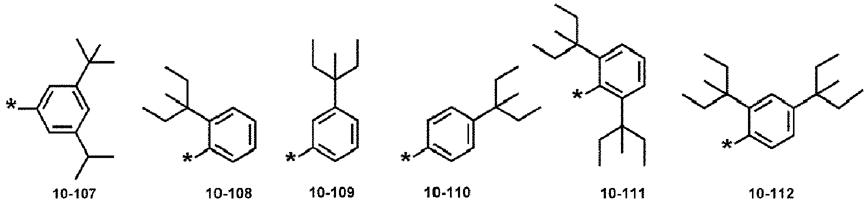

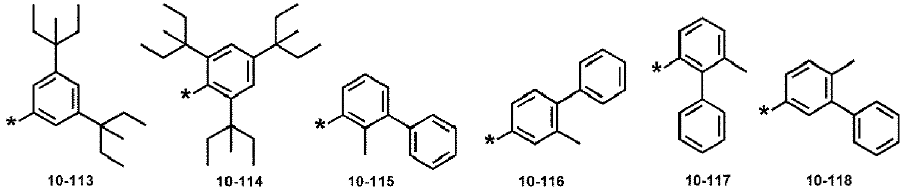

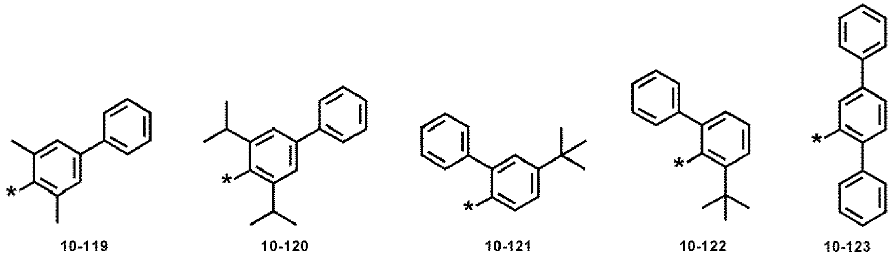

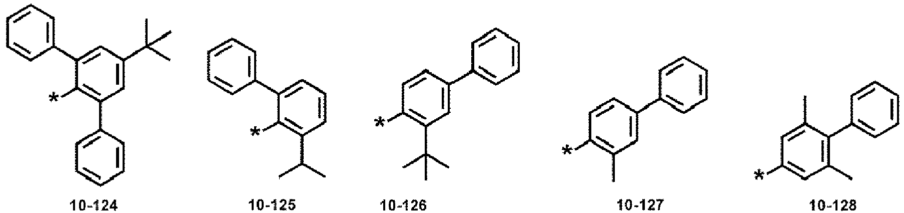

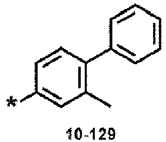

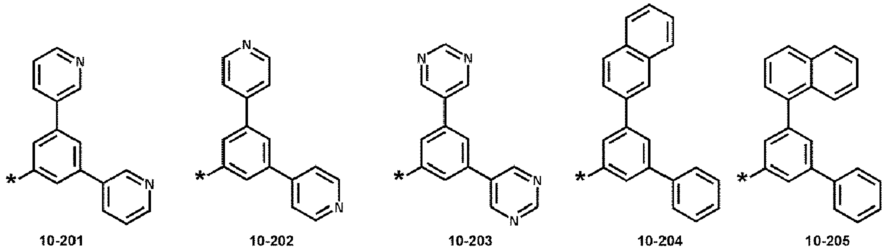

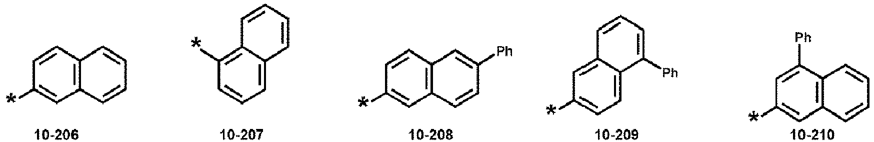

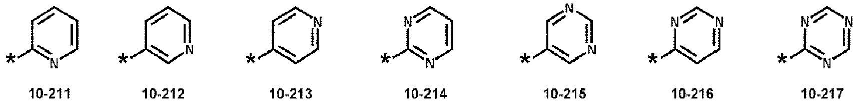

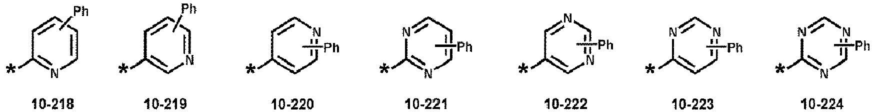

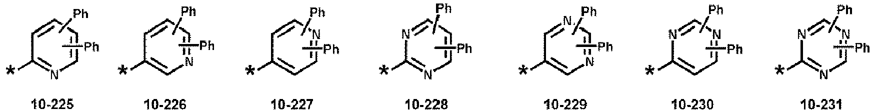

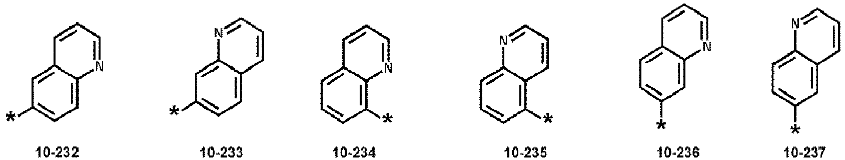

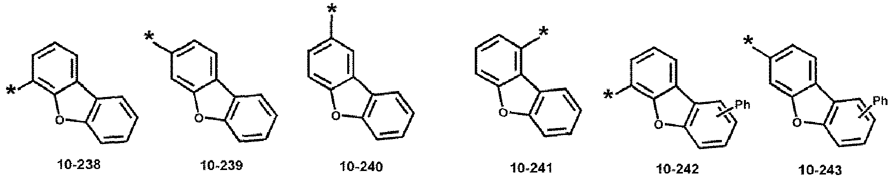

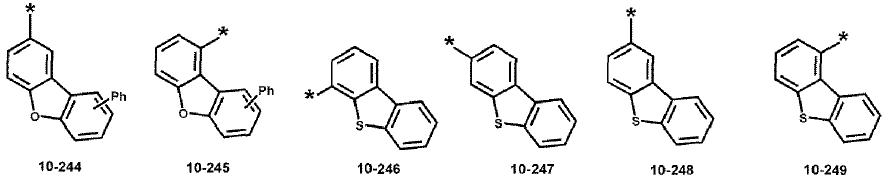

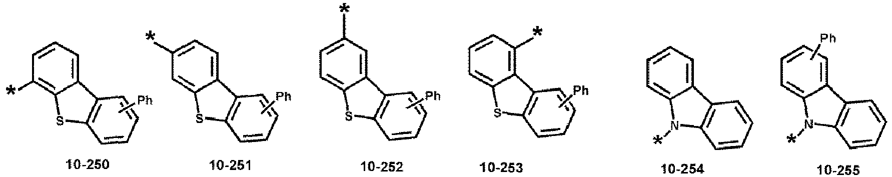

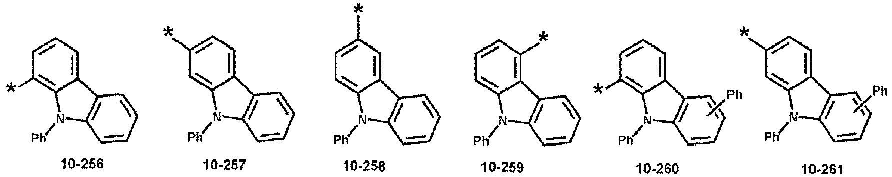

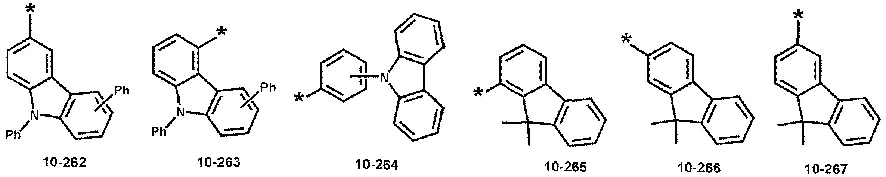

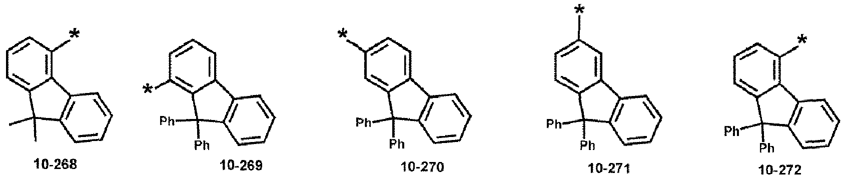

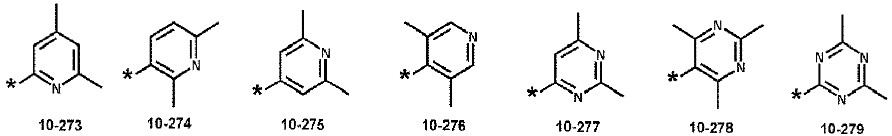

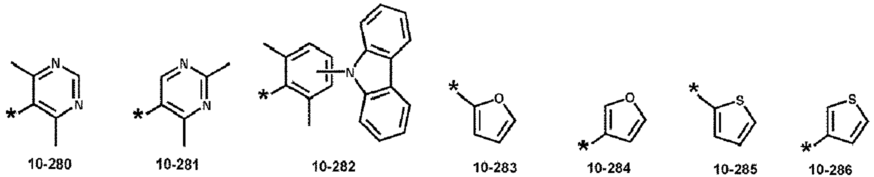

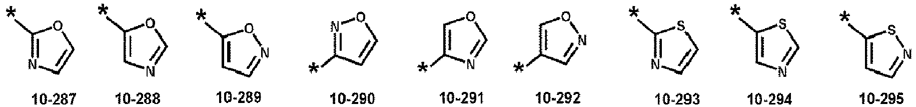

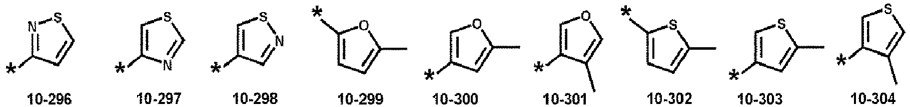

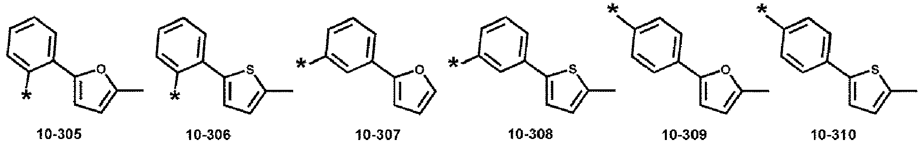

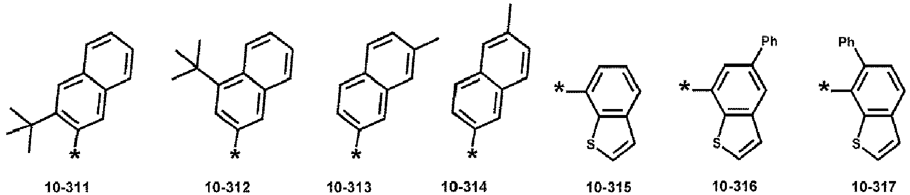

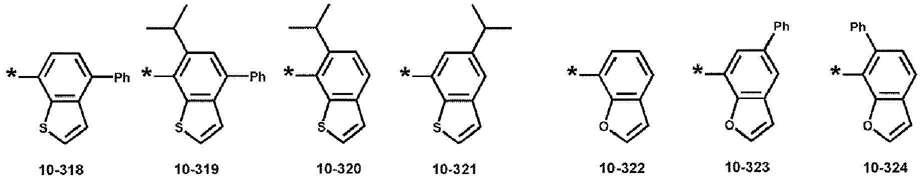

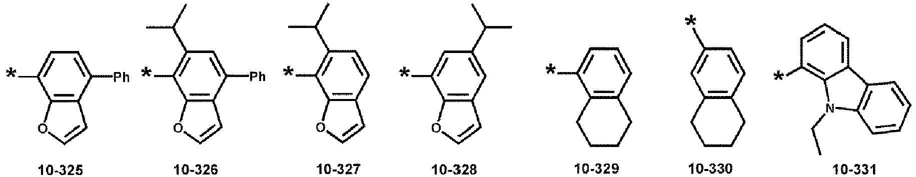

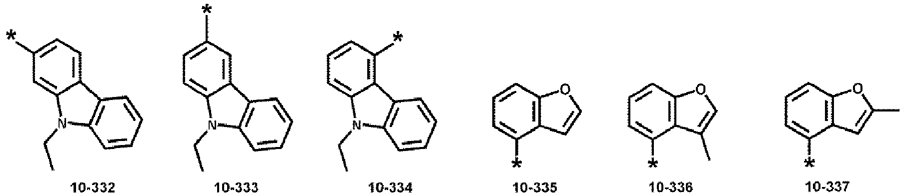

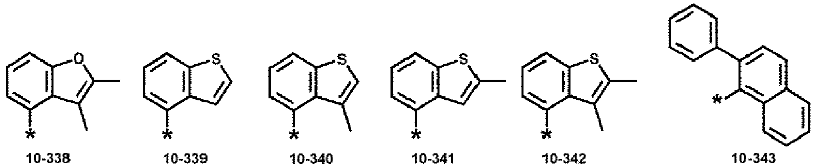

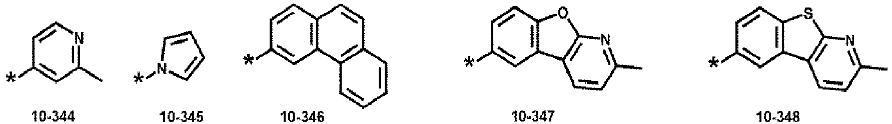

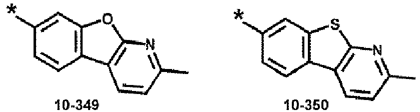

In Formulae 9-1 to 9-39, 9-201 to 9-237, 10-1 to 10-129, and 10-201 to 10-350, * indicates a binding site to a neighboring atom, Ph is a phenyl group, TMS is a trimethylsilyl group, and TMG is a trimethylgermyl group.

The "group represented by one of Formulae 9-1 to 9-39 in which at least one hydrogen is substituted with deuterium" and the "group represented by one of Formulae 9-201 to 9-227 in which at least one hydrogen is substituted with deuterium" may each be, for example, a group represented by one of Formulae 9-501 to 9-514 and 9-601 to 9-636:

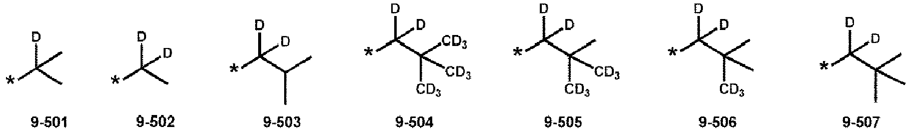

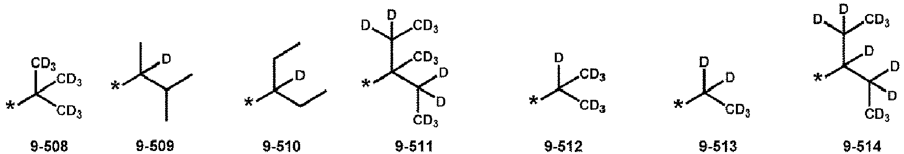

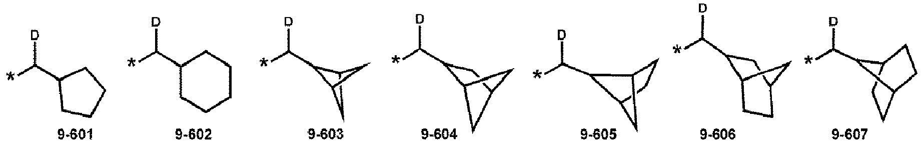

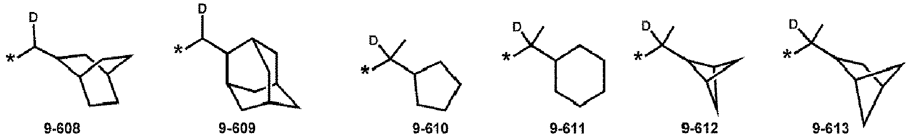

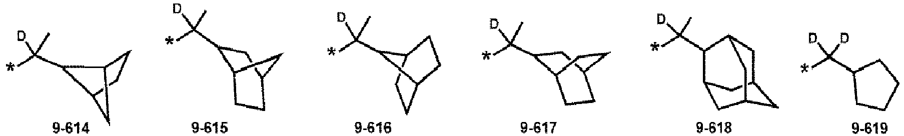

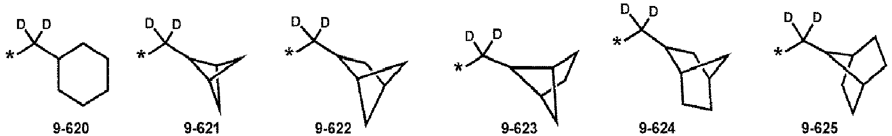

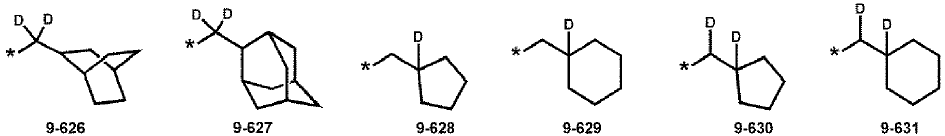

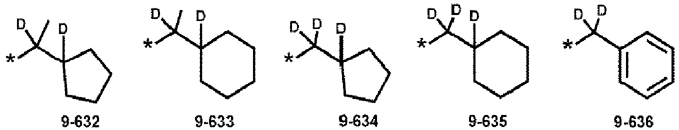

The "group represented by one of Formulae 9-1 to 9-39 in which at least one hydrogen is substituted with -F" and the "group represented by one of Formulae 9-201 to 9-227 in which at least one hydrogen is substituted with -F" may each be, for example, a group represented by one of Formulae 9-701 to 9-710:

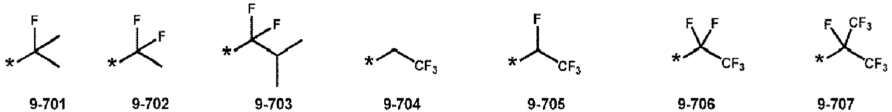

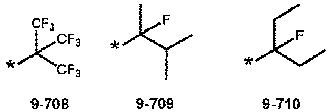

The "group represented by one of Formulae 10-1 to 10-129 in which at least one hydrogen is substituted with deuterium" and "the group represented by one of Formulae 10-201 to 10-350 in which at least one hydrogen is substituted with deuterium" may be, for example, a group represented by one of Formulae 10-501 to 10-553:

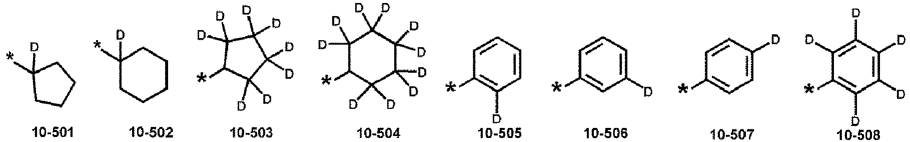

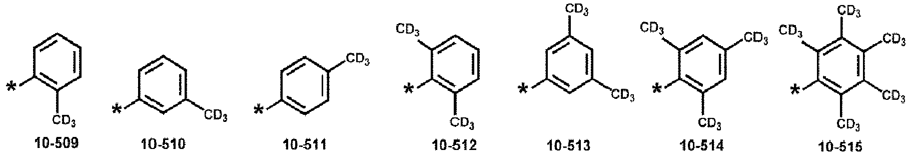

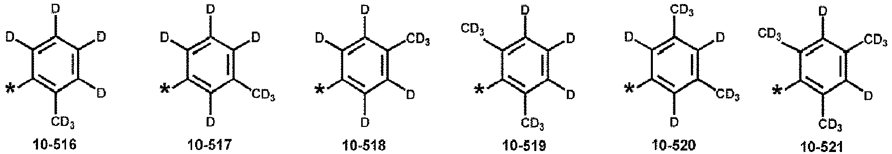

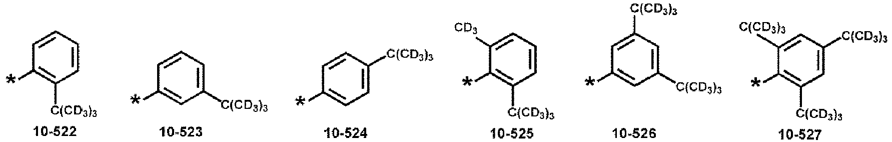

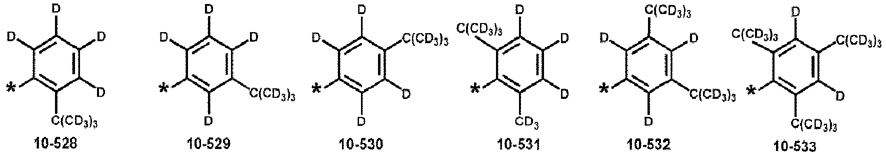

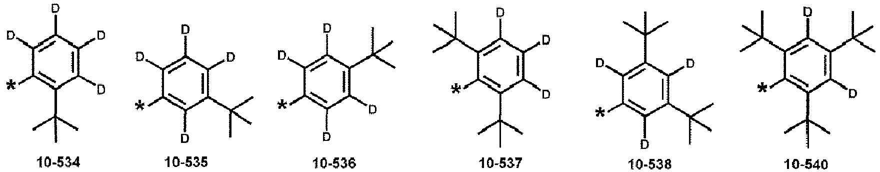

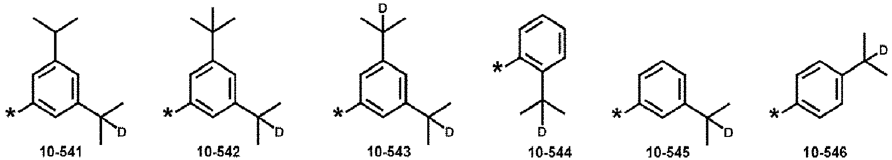

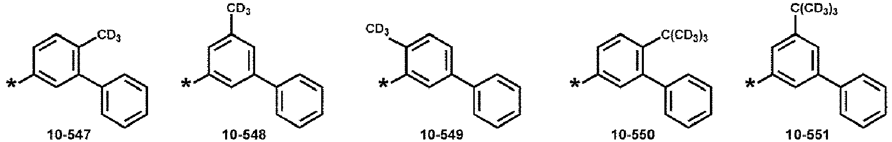

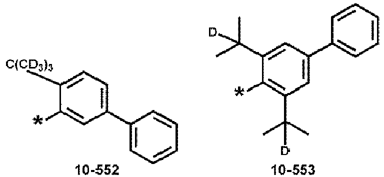

The "group represented by one of Formulae 10-1 to 10-129 in which at least one hydrogen is substituted with -F" and "the group represented by one of Formulae 10-201 to 10-350 in which at least one hydrogen is substituted with -F" may be, for example, a group represented by one of Formulae 10-601 to 10-617:

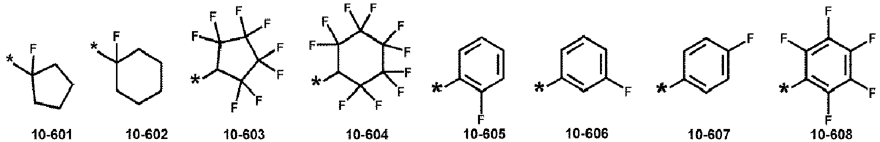

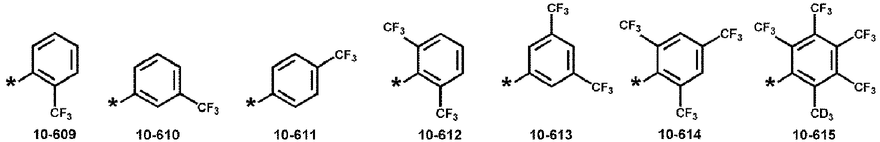

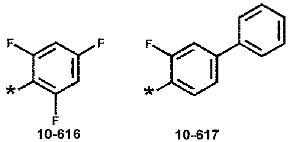

In Formulae 1, 2-1, and 2-2, c1 to c4 indicate the number of R₁(s) to the number of R₄(s), respectively; a1 to a4 indicate the number of groups represented by *-[(L₁)_{b1}-(R₁)_{c1}], the number of groups represented by *-[(L₂)_{b2}-(R₂)_{c2}], the number of groups represented by *-[(L₃)_{b3}-(R₃)_{c3}], and the number of groups represented by *-[(L₄)_{b4}-(R₄)_{c4}], respectively; e1 to e4 indicate the number of Z₁(s) to the number of Z₄(s), respectively; and d1 to d4 indicate the number of a group(s) represented by *-[W₁-(Z₁)ₑ₁], the number of groups represented by *-[W₂-(Z₂)ₑ₂], the number of groups represented by *-[W₃-(Z₃)ₑ₃], and the number of groups represented by *-[W₄-(Z₄)ₑ₄], respectively, and c1 to c4, a1 to a4, e1 to e4, and d1 to d4 may each independently be an integer from 0 to 20. When c1 is 2 or more, two or more R₁(s) may be identical to or different from each other, when c2 is 2 or more, two or more R₂(s) may be identical to or different from each other, when c3 is 2 or more, two or more R₃(s) may be identical to or different from each other, when c4 is 2 or more, two or more R₄(s) may be identical to or different from each other, when a1 is 2 or more, two or more groups represented by *-[(L₁)_{b1}-(R₁)_{c1}] may be identical to or different from each other, when a2 is 2 or more, two or more groups represented by *-[(L₂)_{b2}-(R₂)_{c2}] may be identical to or different from each other, when a3 is 2 or more, two or more groups represented by *-[(L₃)_{b3}-(R₃)_{c3}] may be identical to or different from each other, when a4 is 2 or more, two or more groups represented by *-[(L₄)_{b4}-(R₁)_{c4}] may be identical to or different from each other, when e1 is 2 or more, two or more Z₁(s) may be identical to or different from each other, when e2 is 2 or more, two or more Z₂(s) may be identical to or different from each other, when e3 is 2 or more, two or more Z₃(s) may be identical to or different from each other, when e4 is 2 or more, two or more Z₄(s) may be identical to or different from each other, when d1 is 2 or more, two or more groups represented by *-[W₁-(Z₁)ₑ₁] may be identical to or different from each other, when d2 is 2 or more, two or more groups represented by*-[W₂-(Z₂)ₑ₂] may be identical to or different from each other, when d3 is 2 or more, two or more groups represented by *-[W₃-(Z₃)ₑ₃] may be identical to or different from each other, and when d4 is 2 or more, two or more groups represented by *-[W₄-(Z₄)ₑ₁] may be identical to or different from each other. For example, in Formulae 1, 2-1, and 2-2, c1 to c4, a1 to a4, e1 to e4, and d1 to d4 may each independently be 0, 1, 2, or 3.

In the composition, the second compound is not tris[2-phenylpyridine]iridium.

In one or more embodiments, in Formula 2-1, a case where Y₁ is N, ring A₁ is a pyridine group, Y₂ is C, ring A₂ is a benzene group, and each of d1 and d2 is 0 may be excluded.

In Formulae 1, 2-1, and 2-2, at least two substituents from i) two or more of a plurality of R₁(s), ii) two or more of a plurality of R₂(s), iii) two or more of a plurality of R₃(s), iv) two or more of a plurality of R₄(s), v) R₅ₐ and R_{5b}, vi) two or more of a plurality of Z₁(s), vii) two or more of a plurality of Z₂(s), viii) two or more of a plurality of Z₃(s), ix) two or more of a plurality of Z₄(s), x) two or more of R₁ to R₄, R₅ₐ, and R_{5b}, and/or xi) two or more of Z₁ to Z₄, are each independently optionally linked to each other to form a C₅-C₃₀ carbocyclic group that is unsubstituted or substituted with at least one R₁₀ₐ or a C₁-C₃₀ heterocyclic group that is unsubstituted or substituted with at least one R₁₀ₐ.

R₁₀ₐ is as defined in connection with R₁.

The symbols * and *' as used herein each indicate a binding site to a neighboring atom, unless otherwise stated. For example, in Formulae 2-1 and 2-2, * and *' each indicate a binding site to M₂.

In one or more embodiments, in Formula 1, n1 may not be 0, n4 may be 0, and a group represented by 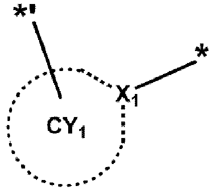 may be a group represented by one of Formulae CY₁ (1) to CY₁ (23): 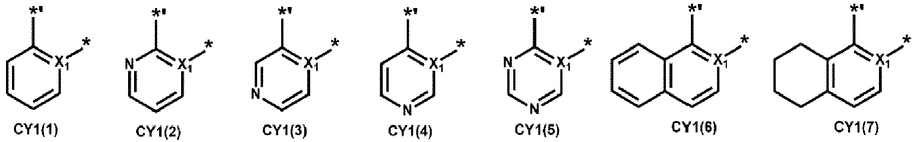 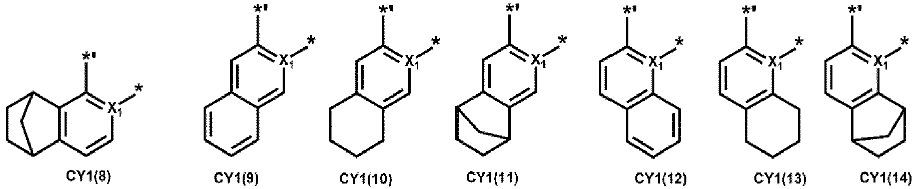 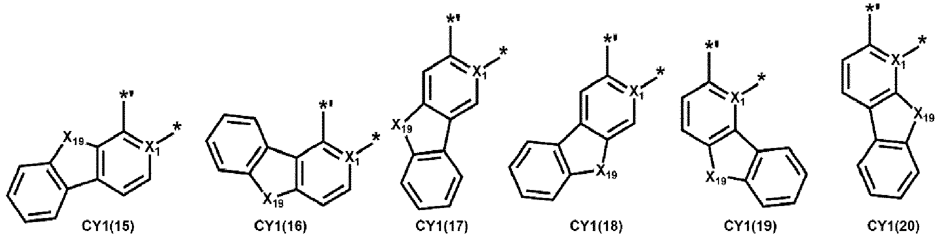 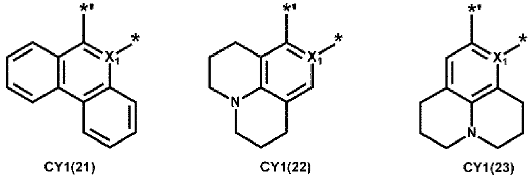 wherein, in Formulae CY1(1) to CY1(23),
X₁ may be as defined herein,
X₁₉ may be O, S, Se, N(R₁₉ₐ), C(R₁₉ₐ)(R_{19b}), or Si(R₁₉ₐ)(R_{19b}),
R₁₉ₐ and R_{19b} may each be as defined in connection with R₁,
* indicates a binding site to X₅ in Formula 1, and
*' indicates a binding site to T₁₁ in Formula 1.

In one or more embodiments, in Formula 1, n1 may be 1, n4 may be 0, and a group represented by 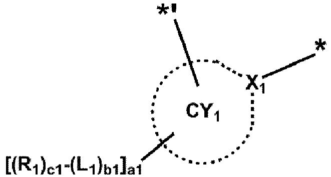 may be a group represented by one of Formulae CY1-1 to CY1-18: 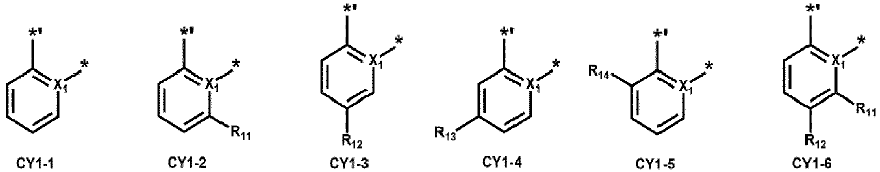 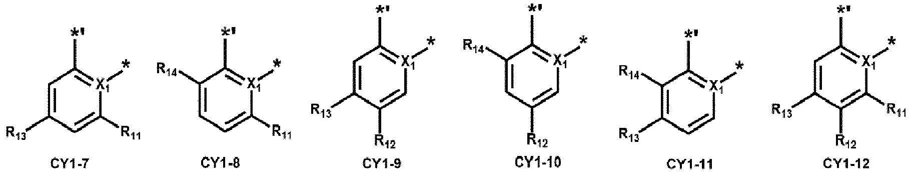 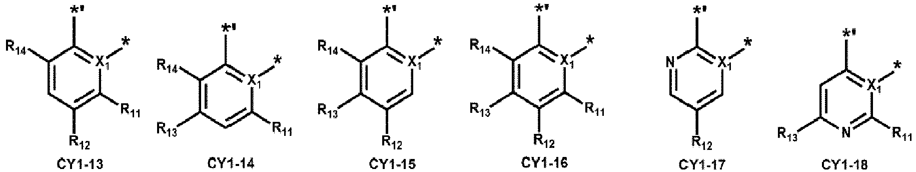 wherein, in Formulae CY1-1 to CY1-18,
X₁ may be as defined herein,
R₁₁ to R₁₄ may each be as defined in connection with R₁, and each of R₁₁ to R₁₄ may not be hydrogen,
* indicates a binding site to X₅ in Formula 1, and
*' indicates a binding site to T₁₁ in Formula 1.

In one or more embodiments, in Formula 1, n1 and n2 may each be 1, and ring CY₂ may be a group represented by Formula CY2A or CY2B: 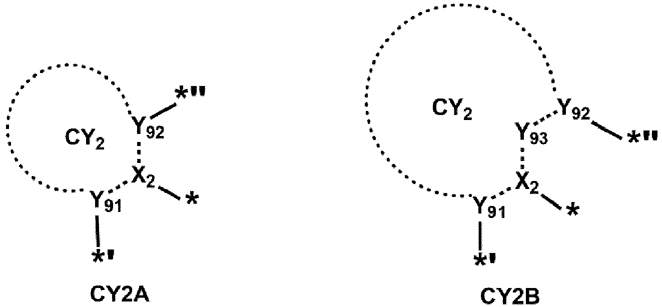 wherein, in Formulae CY2A and CY2B,
X₂ and CY₂ may each be as defined herein,
Y₉₁ to Y₉₃ may each independently be O, S, N, C, or Si,
in Formulae CY2A and CY2B, a bond between X₂ and Y₉₁, a bond between X2 and Y₉₂, a bond between X₂ and Y₉₃, and a bond between Y₂₂ and Y₉₃ may each be a chemical bond,
*' indicates a binding site to T₁₁ in Formula 1,
* indicates a binding site to M₁ in Formula 1, and
*" indicates a binding site to T₁₂ in Formula 1.

In one or more embodiments, in Formula 1, each of n1 and n2 may not be 0, and a group represented by 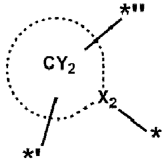 may be a group represented by one of Formulae CY2(1) to CY2(21): 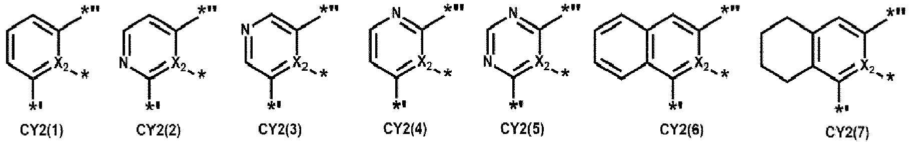 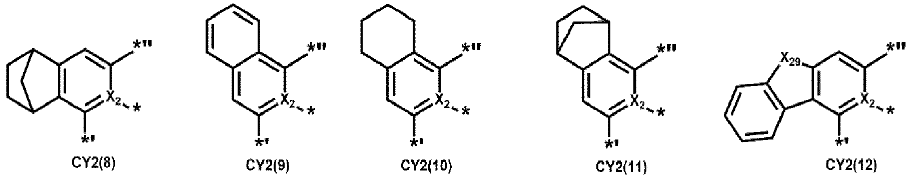 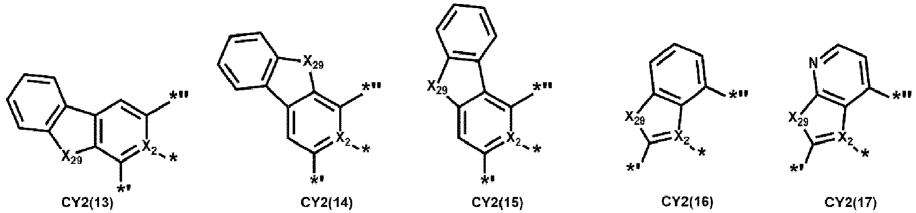 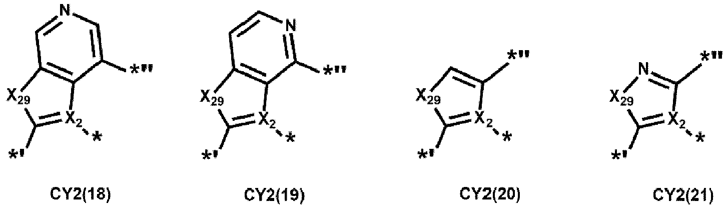 wherein, in Formulae CY2(1) to CY2(21),
X₂ may be as defined herein,
X29 may be O, S, N-[(L2)b2-(R2)c2], C(R29a)(R29b), or Si(R29a)(R29b),
L₂, b2, R₂, and c2 may each be as defined herein,
R29a and R₂₉b may each be as defined in connection with R₂,
*' indicates a binding site to T₁₁ in Formula 1,
* indicates a binding site to M₁ in Formula 1, and
*" indicates a binding site to T₁₂ in Formula 1.

In one or more embodiments, in Formula 1, each of n1 and n2 may be 1, and a group represented by 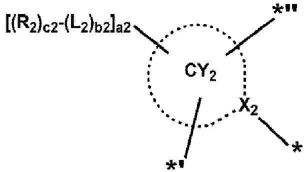 may be a group represented by one of Formulae CY2-1 to CY2-16: 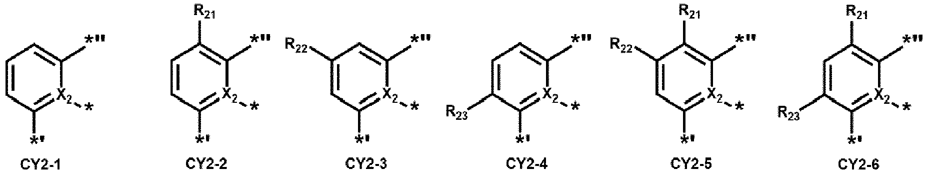 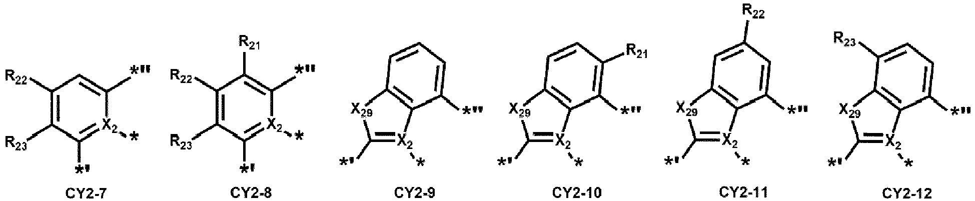 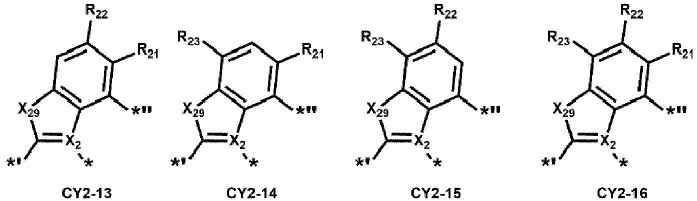 wherein, in Formulae CY2-1 to CY2-16,
X₂ may be as defined herein,
X29 may be O, S, N-[(L2)b2-(R2)c2], C(R29a)(R29b), or Si(R29a)(R29b),
L₂, b₂, R₂, and c2 may each be as defined herein,
R₂₁ to R₂₃, R₂₉ₐ, and R_{29b} may each be as defined in connection with R₂, wherein each of R₂₁ to R₂₃ may not be hydrogen,
*' indicates a binding site to T₁₁ in Formula 1,
* indicates a binding site to M₁ in Formula 1, and
*" indicates a binding site to T₁₂ in Formula 1.

In one or more embodiments, in Formula 1,
each of n1 and n2 may be 1,
a group represented by 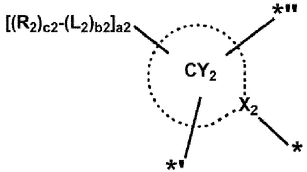 may be a group represented by one of Formulae CY2-9 to CY2-16,
X₂₉ in Formulae CY2-9 to CY2-16 may be N-[(L₂)_{b2}-(R₂)_{c2}],
L₂ may be a benzene group unsubstituted or substituted with at least one R₁₀ₐ, b2 may be 1 or 2,
c2 may be 1 or 2, and
when c2 is 1, R₂ may be a phenyl group unsubstituted or substituted with deuterium, a C₁-C₂₀ alkyl group, or a combination thereof; and when c2 is 2, a) one of two R₂(s) may be a phenyl group unsubstituted or substituted with deuterium, a C₁-C₂₀ alkyl group, a phenyl group, a deuterated phenyl group, a (C₁-C₂₀ alkyl)phenyl group, or a combination thereof, b) and the other R₂ may be a C₄-C₂₀ alkyl group unsubstituted or substituted with a C₃-C₁₀ cycloalkyl group, or a deuterated C₁-C₂₀ alkyl group.

In one or more embodiments, in Formula 1, each of n2 and n3 may not be 0, and a group represented by 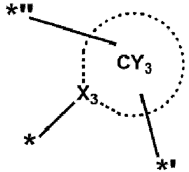 may be a group represented by one of Formulae CY3(1) to CY3(15): 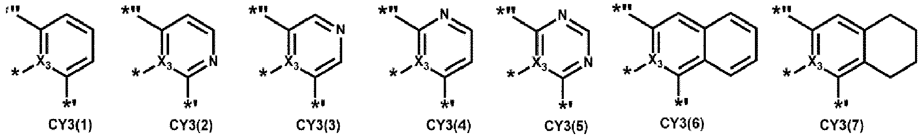 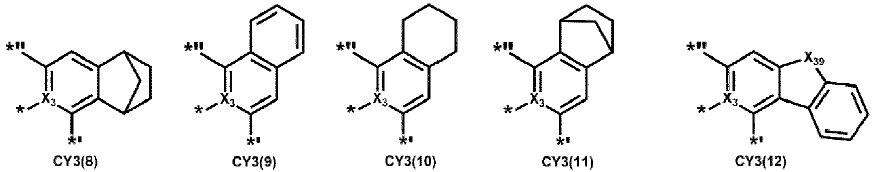 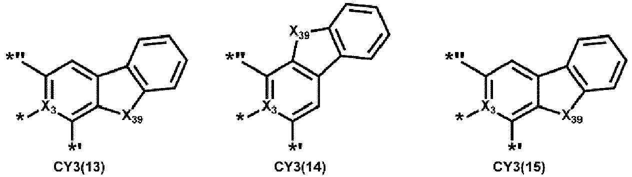 wherein, in Formulae CY3(1) to CY3(15),
X₃ may be as defined herein,
X39 may be O, S, N(Z39a), C(R39a)(R39b), or Si(R39a)(R39b),
R39a and R_{39b} may each be as defined in connection with R₃,
*" indicates a binding site to T₁₂ in Formula 1,
* indicates a binding site to M₁ in Formula 1, and
*' indicates a binding site to T₁₃ in Formula 1.

In one or more embodiments, in Formula 1, each of n2 and n3 may be 1, and a group represented by 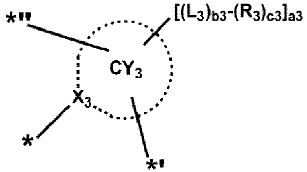 may be a group represented by one of Formulae CY3-1 to CY3-13: 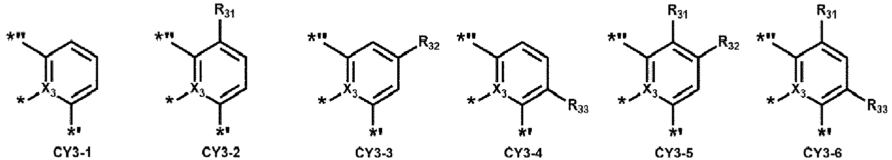 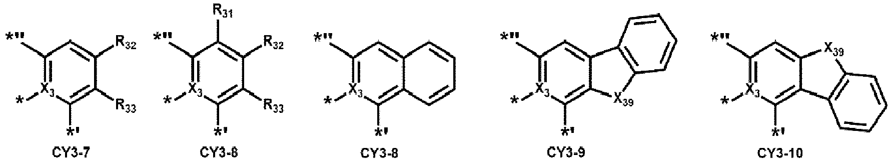 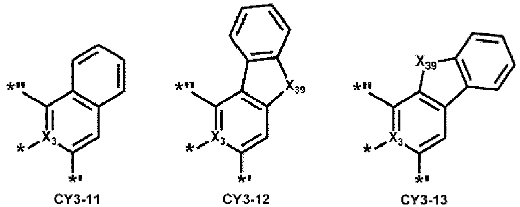 wherein, in Formulae CY3-1 to CY3-31,
X₃ may be as defined herein,
X39 may be O, S, N-[(L3)b3-(R3)c3], C(R39a)(R39b), or Si(R39a)(R39b),
L₃, b3, R₃, and c3 may each be as defined herein,
R₃₁ to R₃₃, R₃₉ₐ, and R_{39b} may each be as defined in connection with R₃, wherein each of R₃₁ to R₃₃ may not be hydrogen,
*" indicates a binding site to T₁₂ in Formula 1,
* indicates a binding site to M₁ in Formula 1, and
*' indicates a binding site to T₁₃ in Formula 1.

In one or more embodiments, in Formula 1, n3 may not be 0, n4 may be 0, and a group represented by 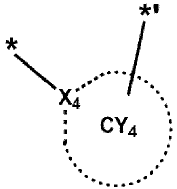 may be a group represented by one of Formulae CY4(1) to CY4(20): 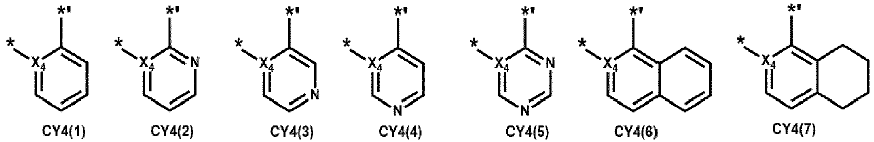 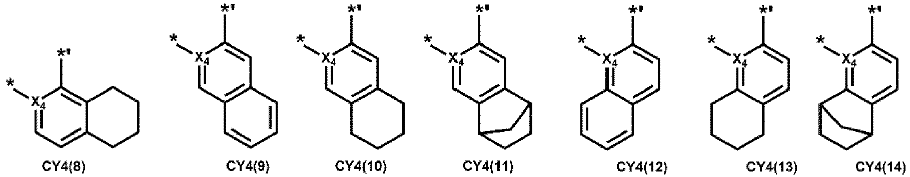 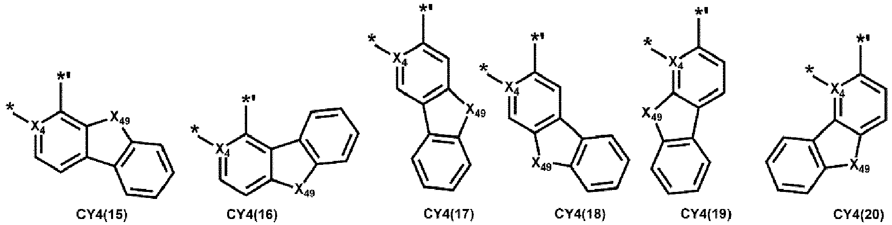 wherein, in Formulae CY4(1) to CY4(20),
X₄ may be as defined herein,
X49 may be O, S, N(R49a), C(R49a)(R49b), or Si(R49a)(R49b),
R49a and R49b may each be as defined in connection with R4,
*' indicates a binding site to T₁₃ in Formula 1, and
* indicates a binding site to M₁ in Formula 1.

In one or more embodiments, in Formula 1, n3 may be 1, n4 may be 0, and a group represented by 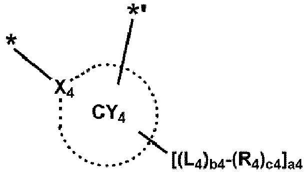 may be a group represented by one of Formulae CY4-1 to CY4-16: 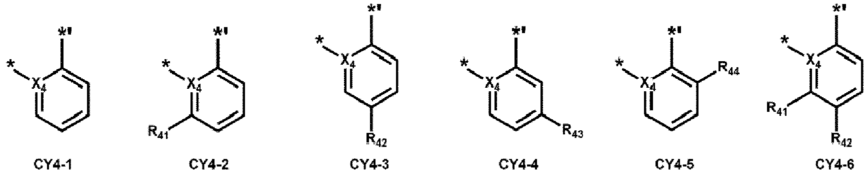 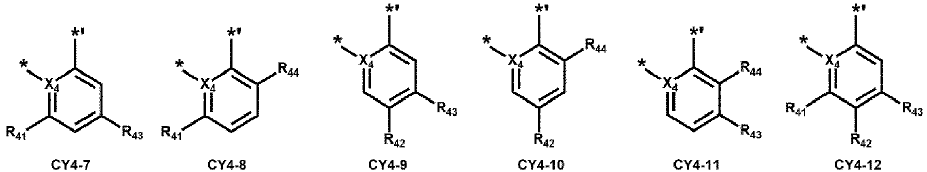 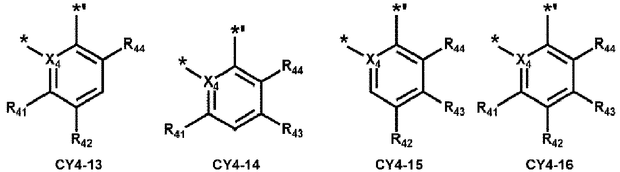 wherein, in Formulae CY4-1 to CY4-16,
X₄ may be as defined herein,
R₄₁ to R₄₄ may each be as defined in connection with R₄, and each of R₄₁ to R44 may not be hydrogen,
*' indicates a binding site to T₁₃ in Formula 1, and
* indicates a binding site to M₁ in Formula 1.

In one or more embodiments, the first compound may be a compound represented by one of Formulae 1-1 to 1-3: 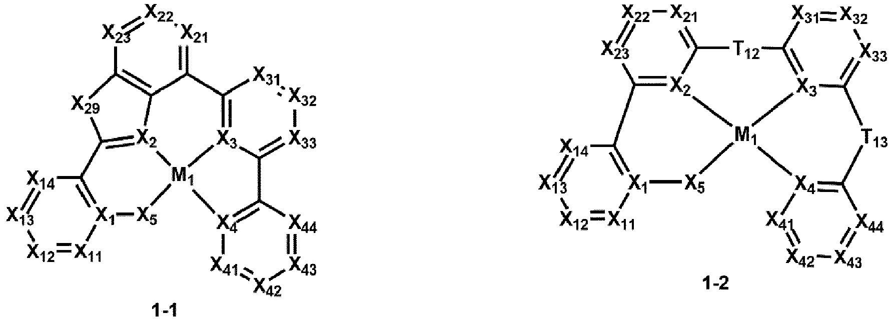 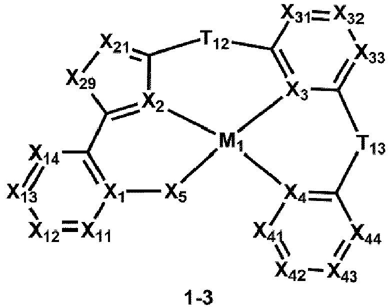 wherein, in Formulae 1-1 to 1-3,
M₁, X₁ to Xs, T₁₂, and T₁₃ may each be as defined herein,
X₁₁ may be N or C(R₁₁), X₁₂ may be N or C(R₁₂), X₁₃ may be N or C(R₁₃), and X₁₄ may be N or C(R₁₄),
R₁₁ to R₁₄ may each be as defined in connection with R₁,
two or more of R₁₁ to R₁₄ may optionally be linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
X₂₁ may be N or C(R₂₁), X₂₂ may be N or C(R₂₂), and X₂₃ may be N or C(R₂₃),
X₂₉ may be O, S, N-[(L₂)b2-(R₂)c2], C(R29a)(R29b), or Si(R₂₉ₐ)(R_{29b}),
L₂, b2, R₂, and c2 may each be as defined herein,
R₂₁ to R₂₃, R₂₉ₐ, and R_{29b} may each be as defined in connection with R₂,
two or more of R₂₁ to R₂₃ may optionally be linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
X₃₁ may be N or C(R₃₁), X₃₂ may be N or C(R32), and X₃₃ may be N or C(R33),
R₃₁ to R₃₃ may each be as defined in connection with R₃,
two or more of R₃₁ to R₃₃ may optionally be linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
X₄₁ may be N or C(R₄₁), X₄₂ may be N or C(R42), X₄₃ may be N or C(R43), and X₄₄ may be N or C(R44),
R₄₁ to R₄₄ may each be as defined in connection with R₄,
two or more of R₄₁ to R₄₄ may optionally be linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ, and
R₁₀ₐ may be as defined in connection with R₁.

In one or more embodiments,
Y₁ in Formula 2-1 may be N, and
a group represented by 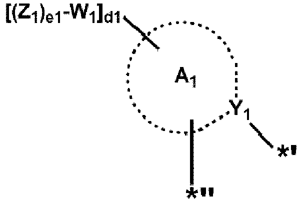 in Formula 2-1 may be a group represented by one of Formulae A1-1 to A1-3: 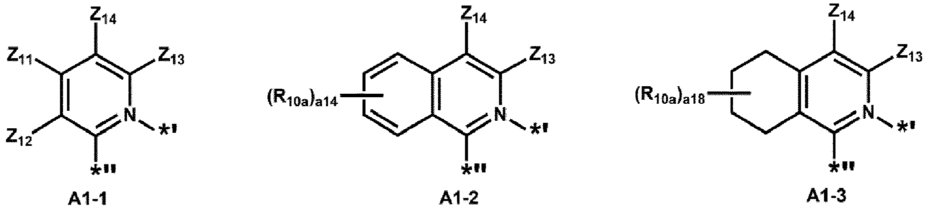 wherein, in Formulae A1-1 to A1-3,
Z₁₁ to Z₁₄ may each be as defined in connection with Z₁,
R₁₀ₐ may be as defined above in connection with R₁₀ₐ,
a14 may be an integer from 0 to 4,
a18 may be an integer from 0 to 8,
*' indicates a binding site to M₂ in Formula 2, and
*" indicates a binding site to ring A₂.

For example, in Formulae A1-1 to A1-3, Z₁₄ may be a deuterated C₁-C₂₀ alkyl group, -Si(Q₃)(Q₄)(Q₅), or -Ge(Q₃)(Q₄)(Q₅).

In one or more embodiments,
Y₃ in Formula 2-2 may be N, and
a group represented by 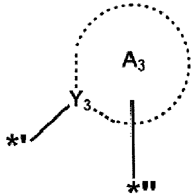 in Formula 2-2 may be a group represented by one of Formulae NR1 to NR48: 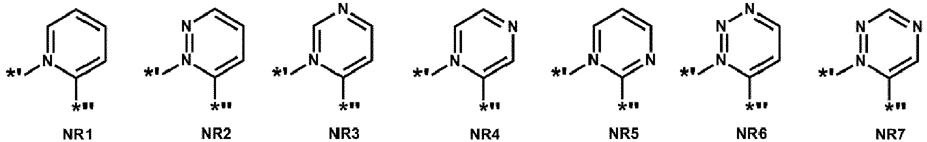 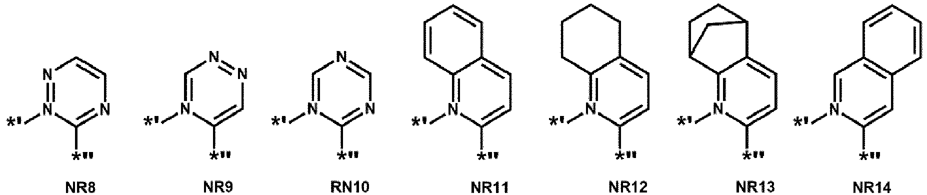 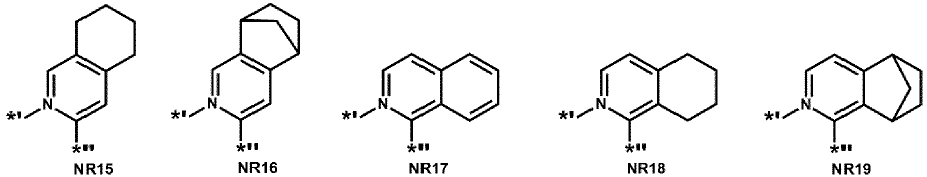 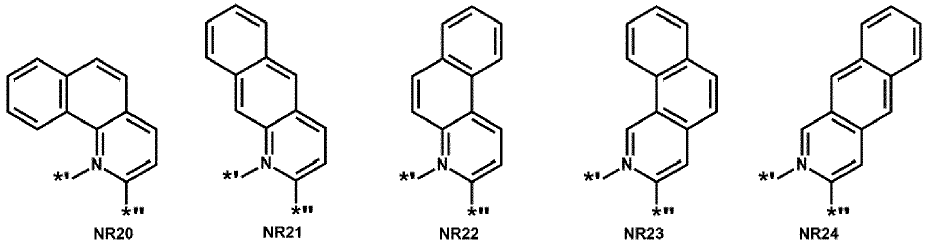 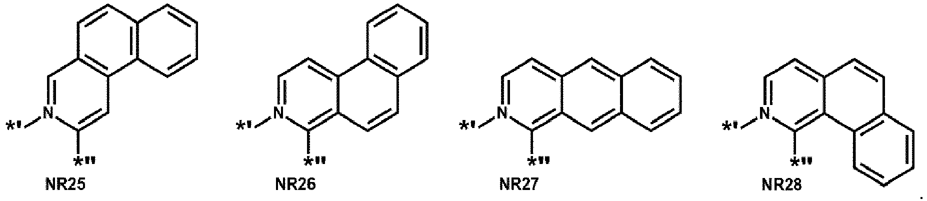 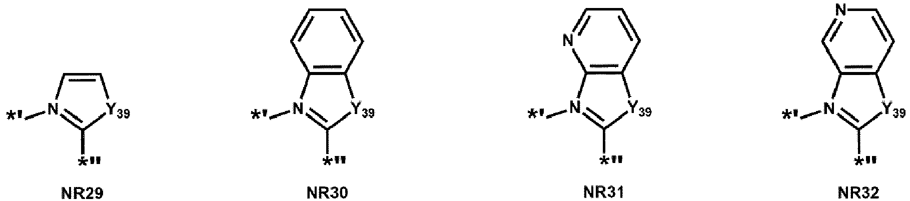 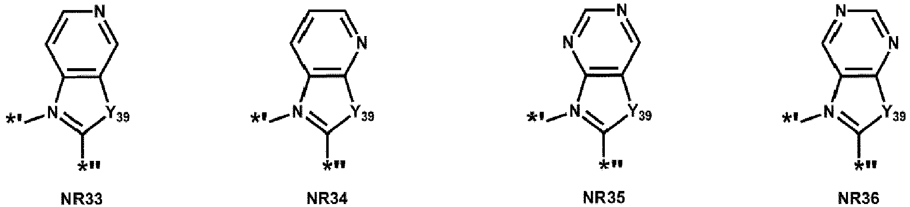 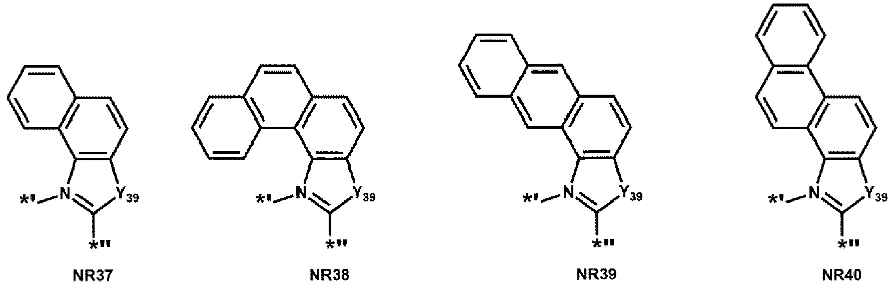 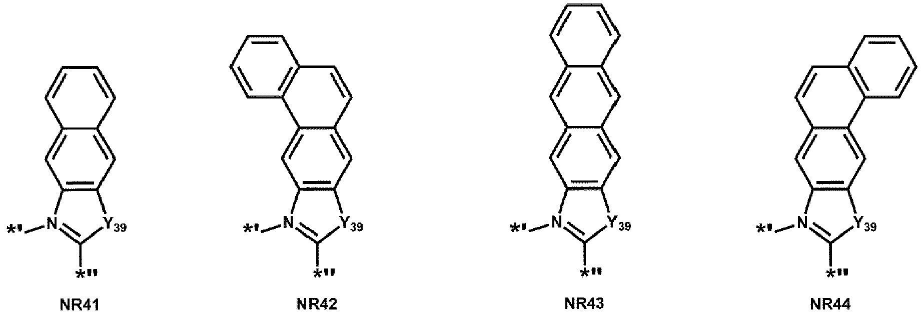 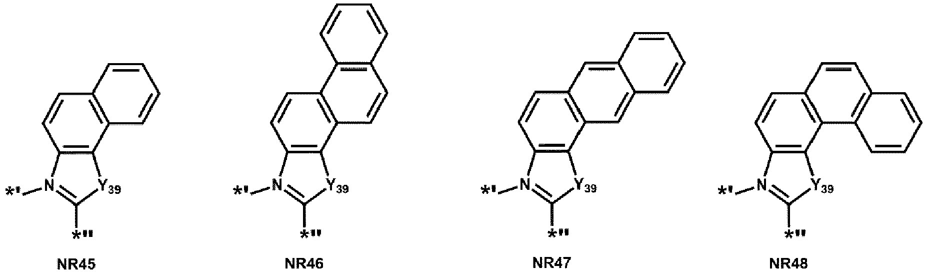 wherein, in Formulae NR1 to NR48,
   Y₃₉ may be O, S, Se, N-[W₃-(Z₃)ₑ₃], C(Z₃₉ₐ)(Z_{39b}), or Si(Z₃₉ₐ)(Z_{39b}),
   W₃, Z₃, and e3 may each be as defined herein, and Z₃₉ₐ and Z_{39b} may each be as defined in connection with Z₃,
   *' indicates a binding site to M₂ in Formula 2, and
   *" indicates a binding site to ring A₄.

In one or more embodiments,
in Formulae 2-1 and 2-2, each of Y₂ and Y₄ may be C, and
a group represented by 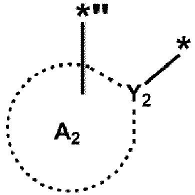 in Formula 2-1, and
a group represented by 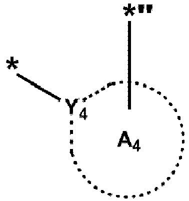 in Formula 2-2 may each independently be a group represented by one of Formulae CR1 to CR29: 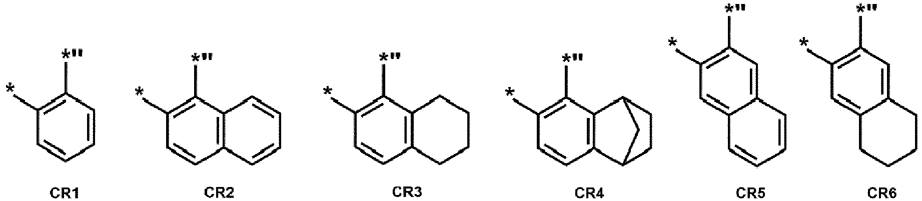 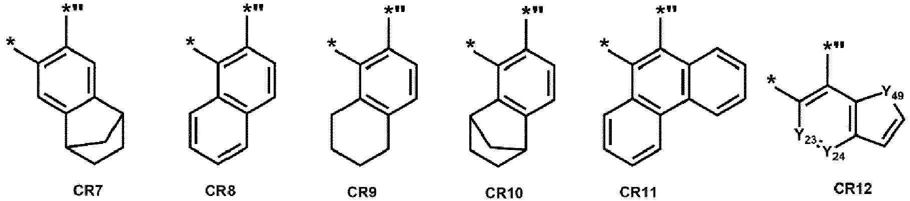 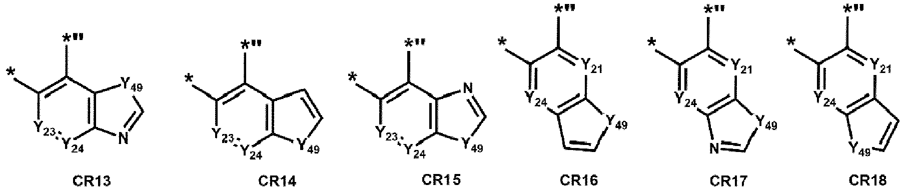 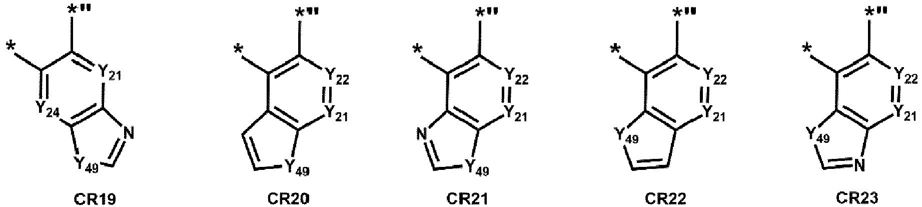 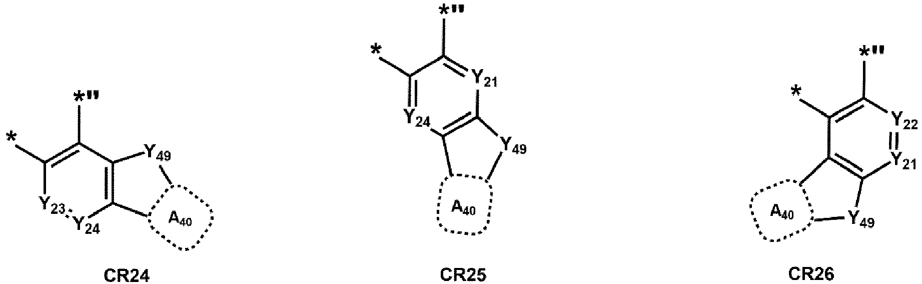 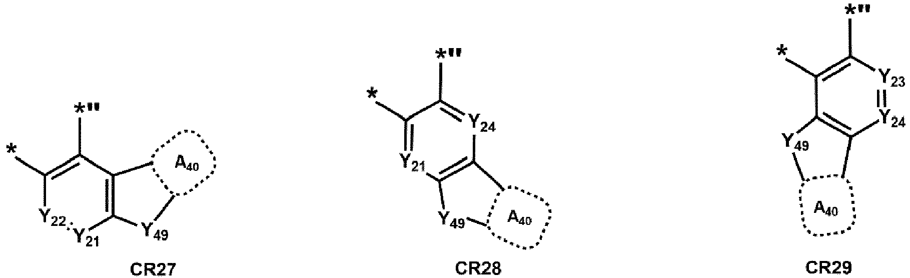 wherein, in CR1 to CR29,
   Y49 may be O, S, Se, N-[W2-(Z2)e2], N-[W4-(Z4)e4], C(Z29a)(Z29b), C(Z49a)(Z49b), Si(Z29a)(Z29b), or Si(Z49a)(Z49b),
   W₂, W₄, Z₂, Z₄, e2, and e4 may each be as defined herein, Z₂₉ₐ and Z_{29b} may each be as defined in connection with Z₂, and Z₄₉ₐ and Z_{49b} may each be as defined in connection with Z₄,
   Y₂₁ to Y₂₄ may each independently be N or C, ring A₄₀ may be a C₅-C₃₀ carbocyclic group or a C₁-C₃₀ heterocyclic group (for example, A₄₀ may be a benzene group, a naphthalene group, a phenanthrene group, a pyridine group, a pyrimidine group, a pyrazine group, a pyridazine group, a quinoline group, an isoquinoline group, a benzoquinoline group, a benzoisoquinoline group, a quinoxaline group, a benzoquinoxaline group, a quinazoline group, or a benzoquinazoline group),
   * indicates a binding site to M₂ in Formula 2, and
   *" indicates a binding site to ring A₁ in Formula 2-1 or ring A₃ in Formula 2-2.

In one or more embodiments,
a group represented by 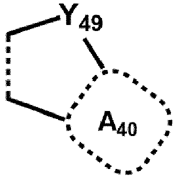
in Formulae CR24 to CR29 may be a group represented by one of Formulae CR(1) to CR(13): 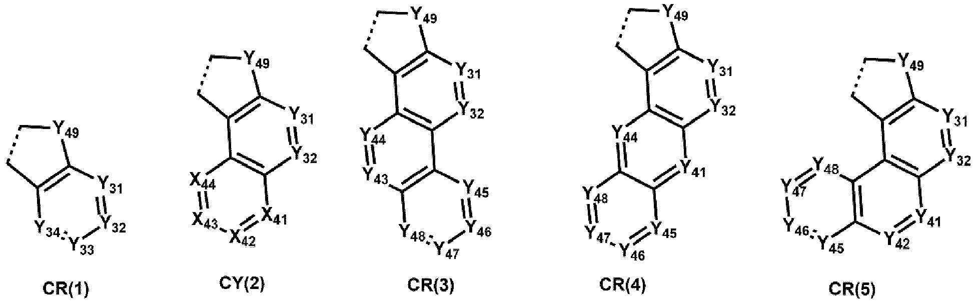 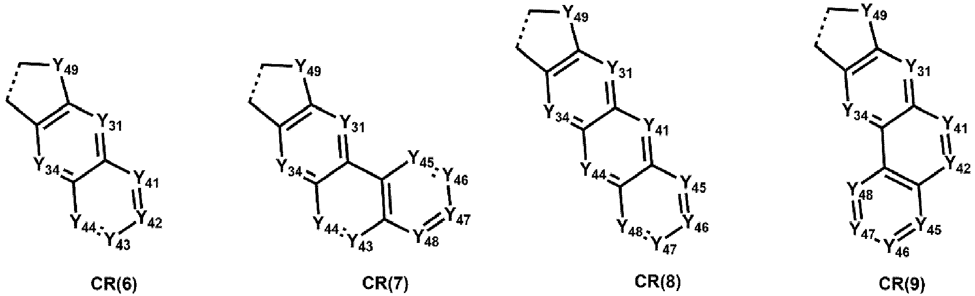 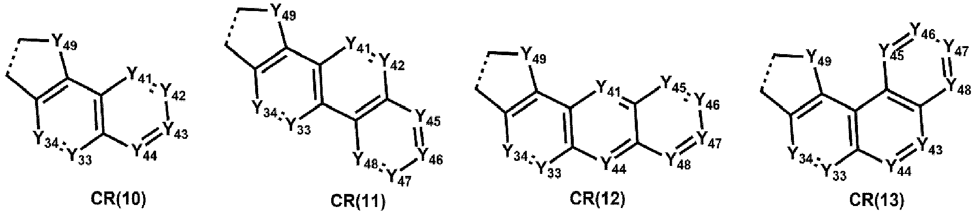 wherein, in Formulae CR(1) to CR(13),
   Y₄₉ may be as defined herein, and
   Y₃₁ to Y₃₄ and Y₄₁ to Y₄₈ may each independently be C or N.

In one or more embodiments, the first compound may include at least one deuterium.

In one or more embodiments, the second compound may include at least one deuterium.

The first compound may emit first light having a first spectrum, and λP1 (may also be referred to as λP(Pt)) indicates an emission peak wavelength (nm) in the first spectrum.

The second compound may emit second light having a second spectrum, and λP2 (may also be referred to as λP(Ir)) indicates an emission peak wavelength (nm) in the second spectrum.

Here, the λP1 and the λP2 may be evaluated from photoluminescence spectra measured for each of a first film and a second film.

The term "first film" as used herein refers to a film including the first compound, and the term "second film" as used herein refers to a film including the second compound. The first film and the second film may be manufactured using various methods randomly, such as a vacuum deposition method, a coating method, or a heating method. The first film and the second film may further include a compound, for example, a host as defined herein, other than the first compound and the second compound.

In one or more embodiments, the λP1 and the λP2 may each be in a range of about 480 nanometers (nm) to about 580 nm or about 510 nm to about 570 nm.

In one or more embodiments, an absolute value of the difference between the λP1 and the λP2 may be in a range of about 0 nm to about 30 nm, about 0 nm to about 20 nm, or about 0 nm to about 10 nm.

In one or more embodiments, each of the first light and the second light may be green light.

In one or more embodiments, the first light may be green light, and the second light may be yellowish green light.

In one or more embodiments, each of the first light and the second light may be yellowish green light.

In one or more embodiments, the first light may be yellowish green light, and the second light may be yellow light.

In one or more embodiments, each of the first light and the second light may be yellow light.

For example, the first compound may be one or more compounds of Group 1-1 to Group 1-4:

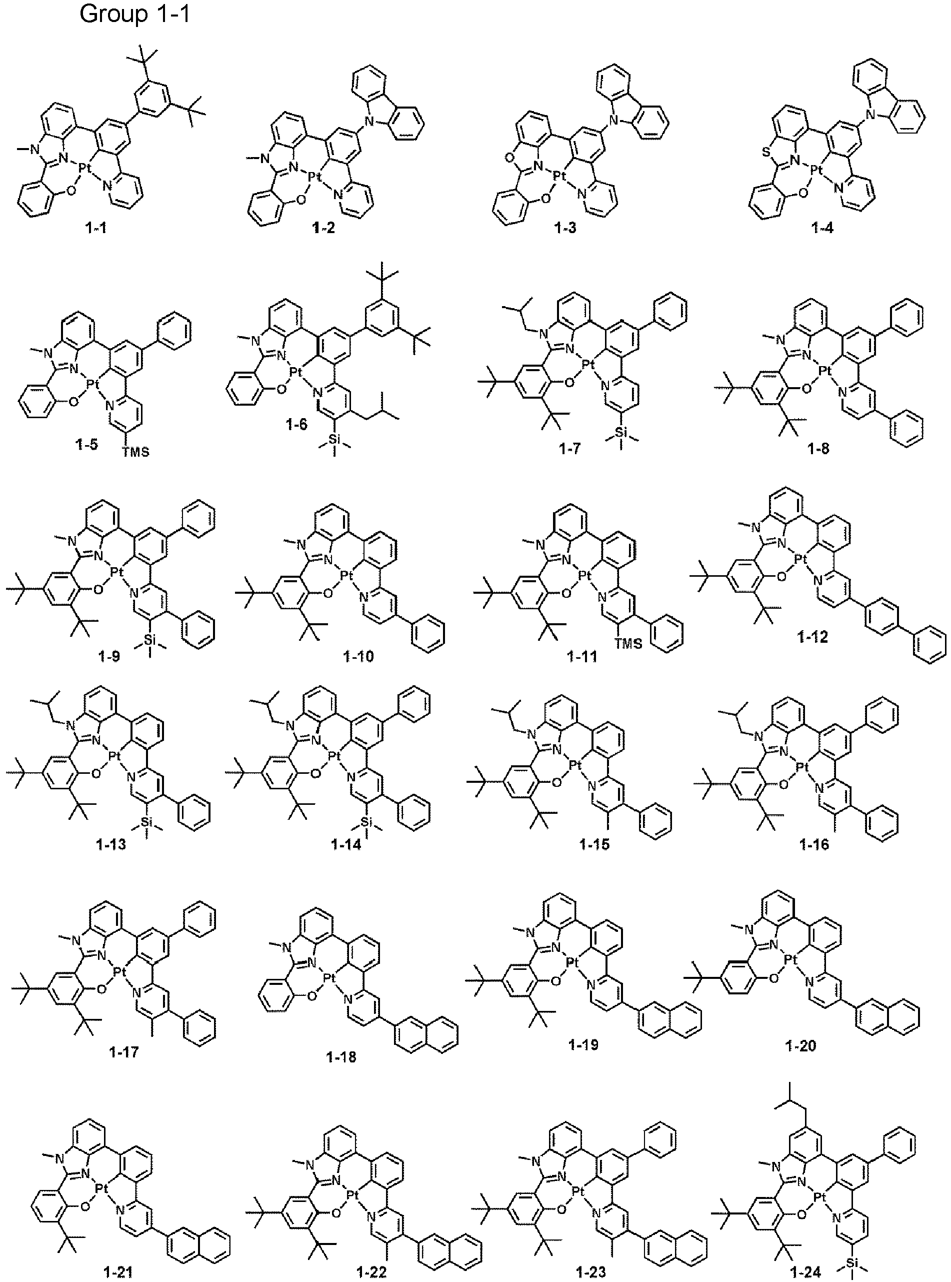

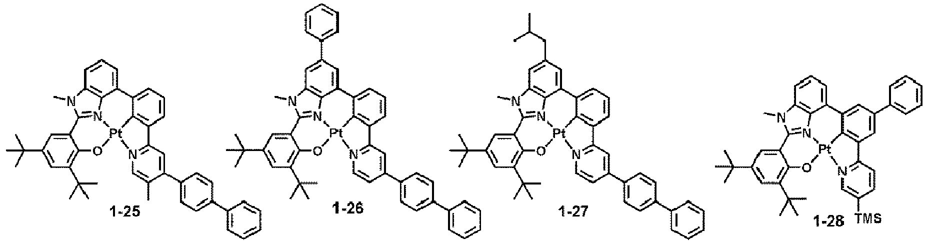

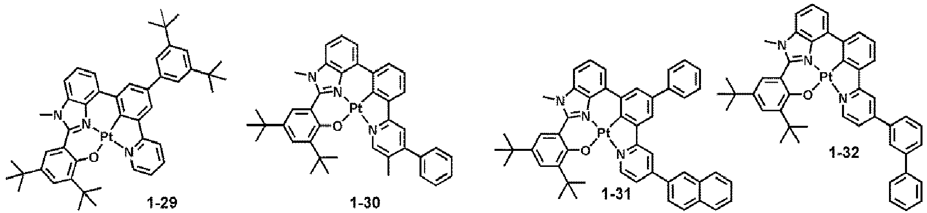

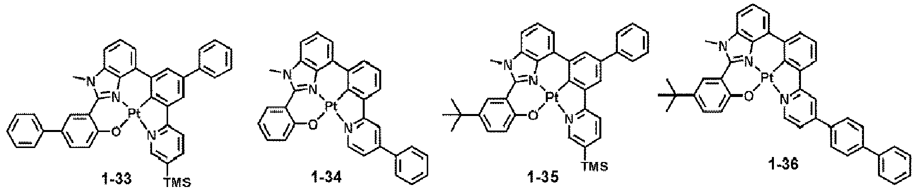

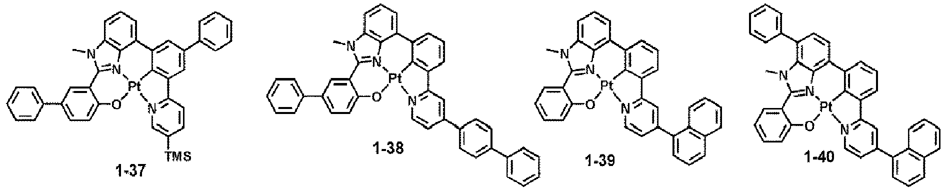

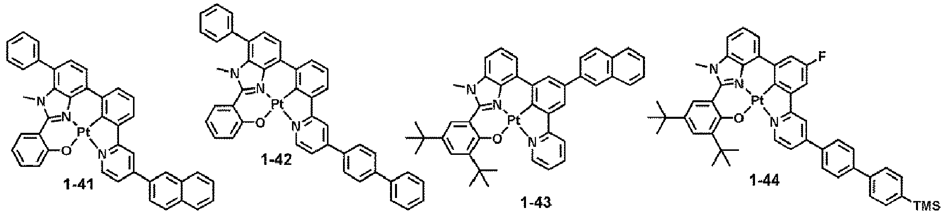

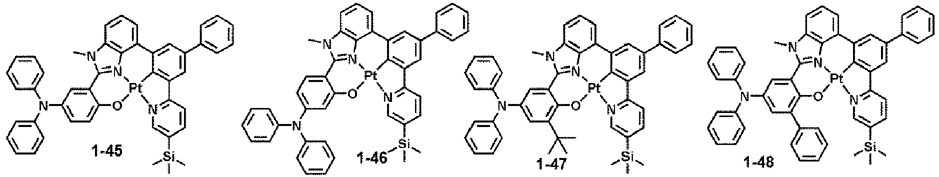

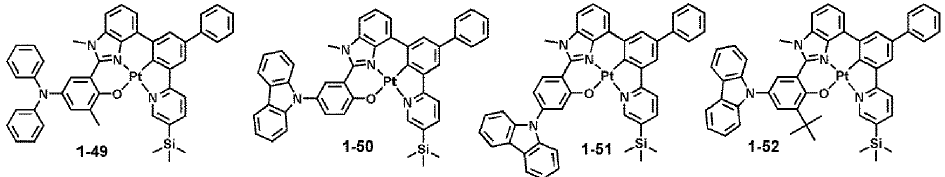

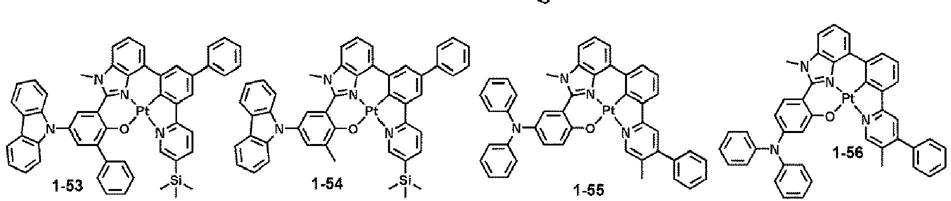

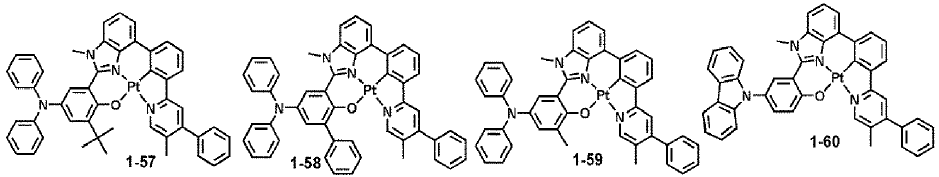

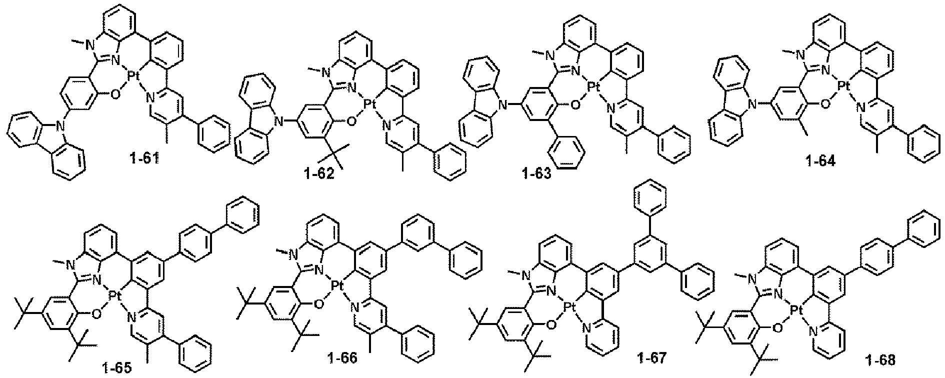

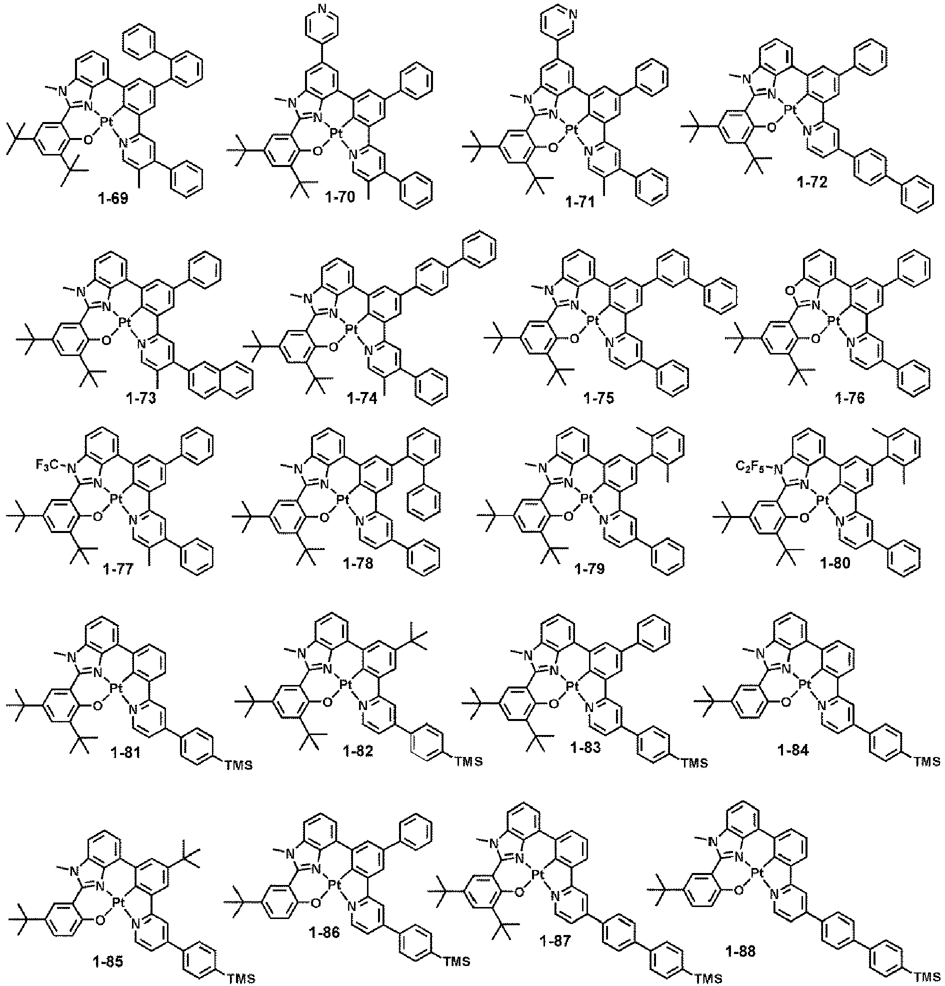

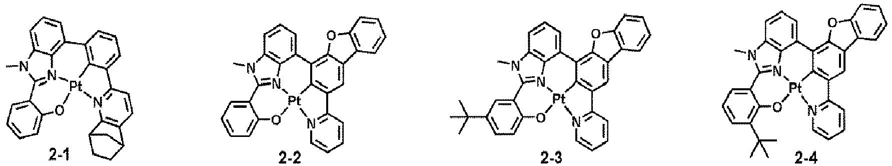

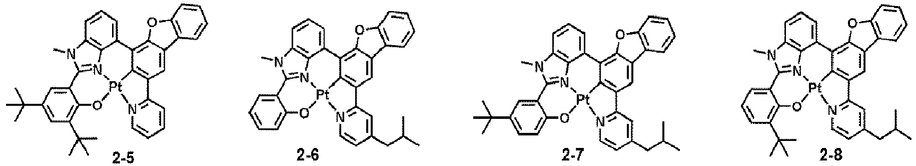

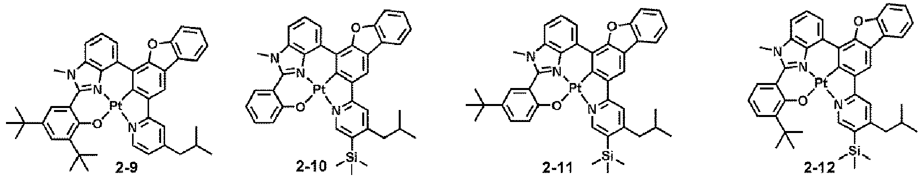

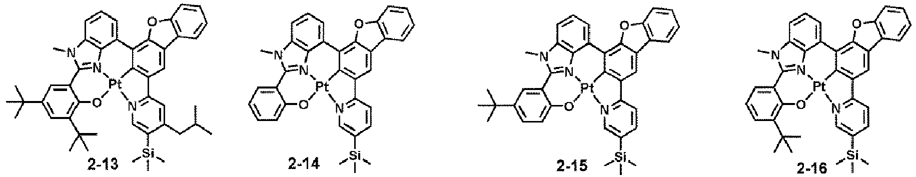

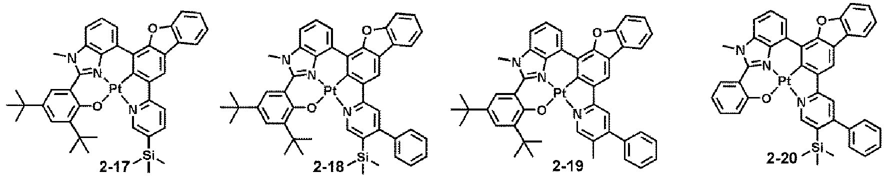

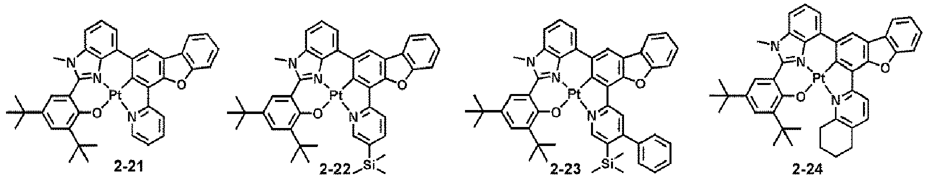

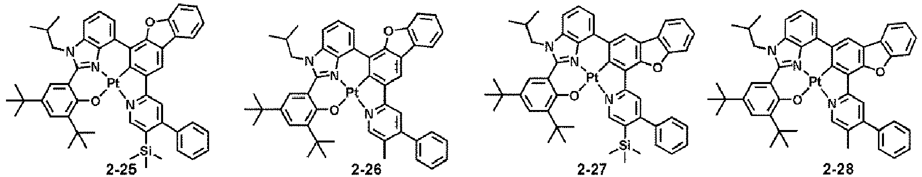

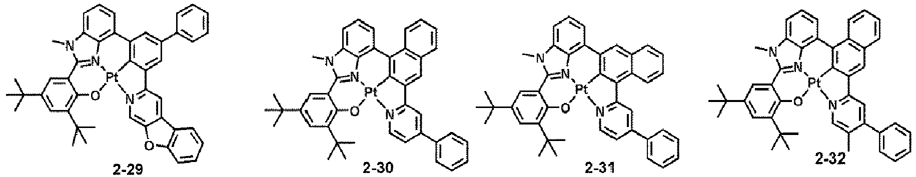

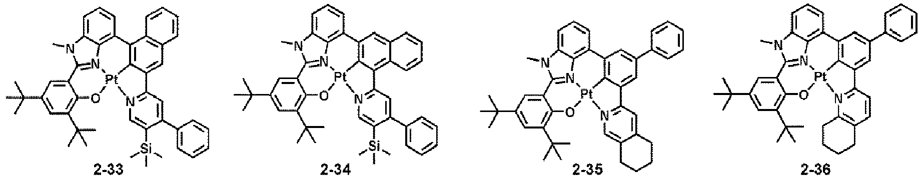

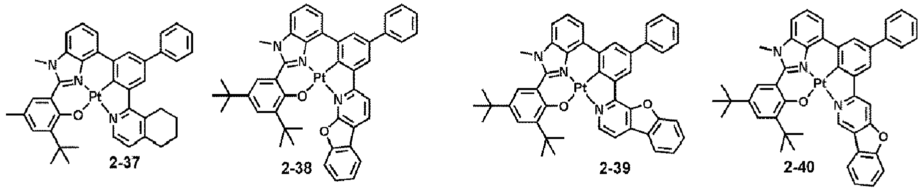

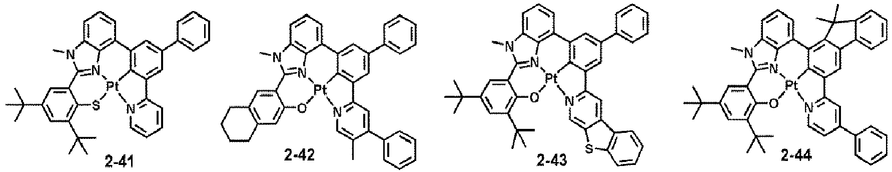

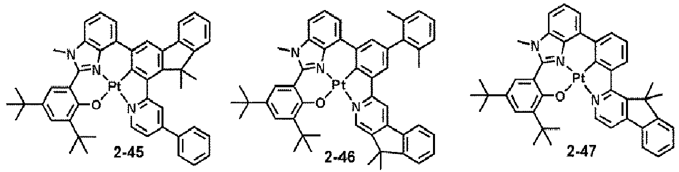

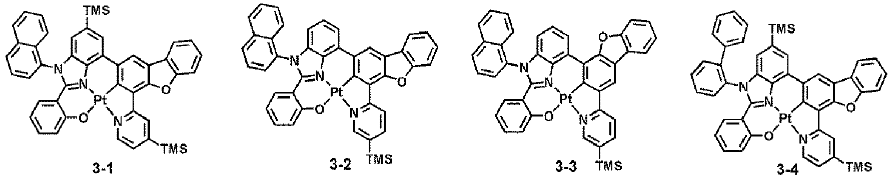

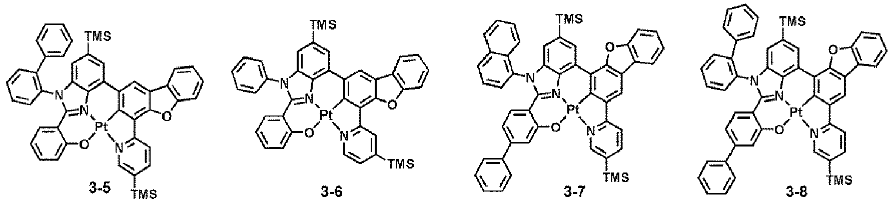

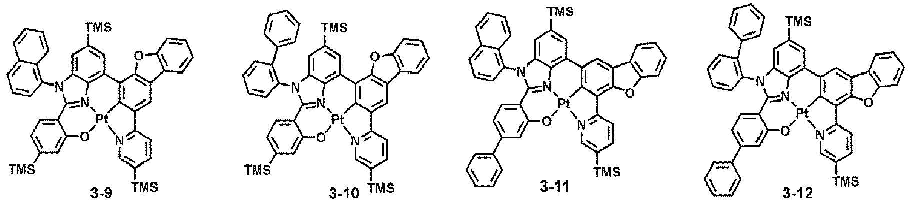

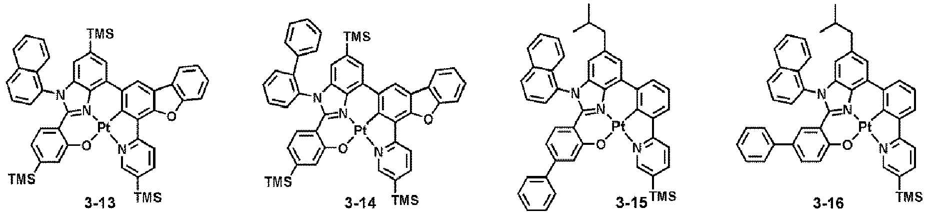

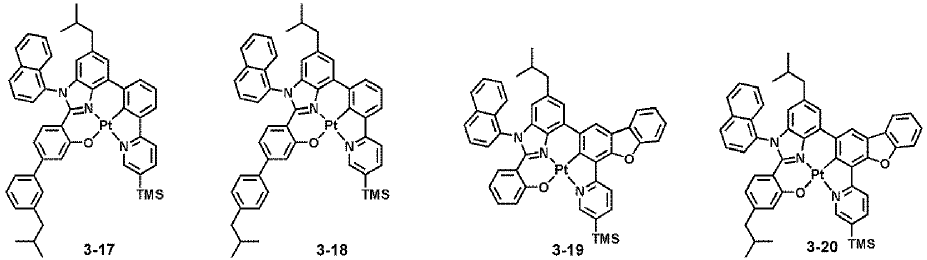

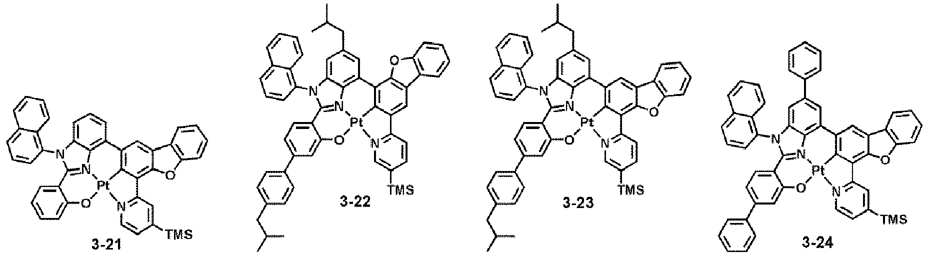

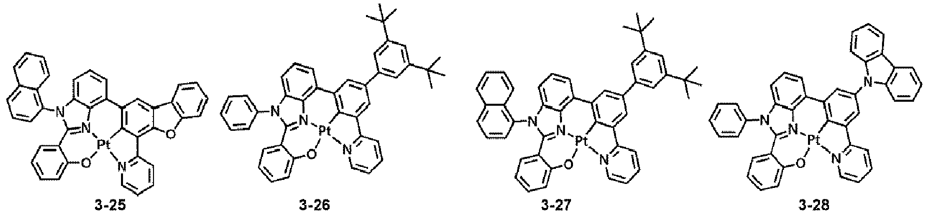

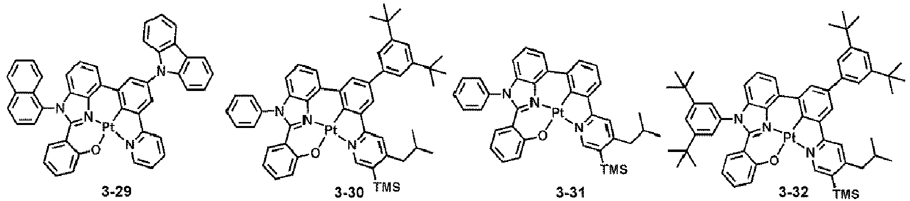

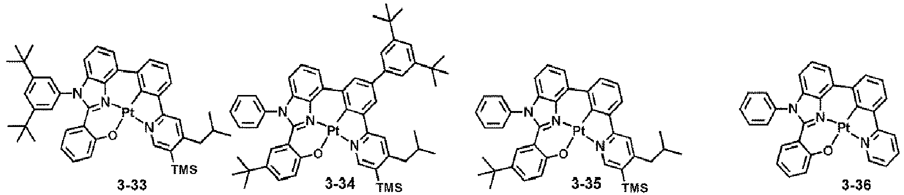

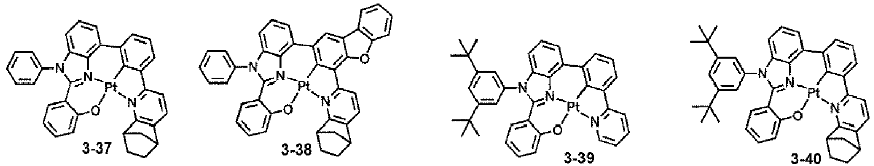

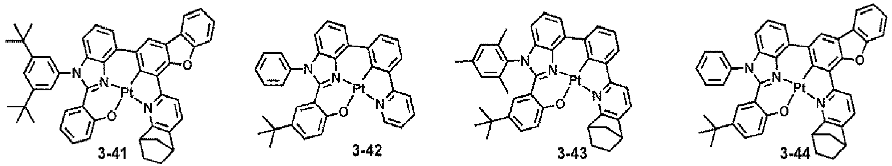

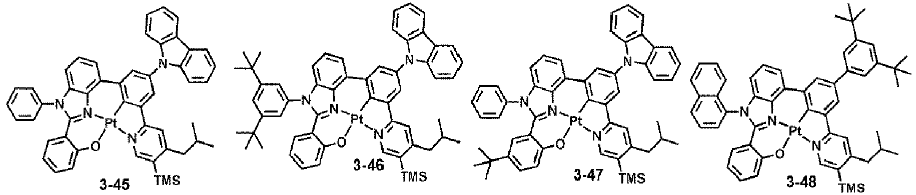

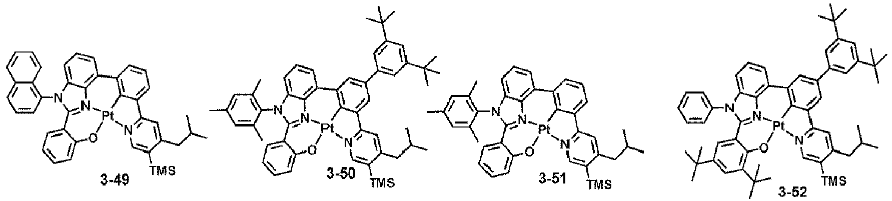

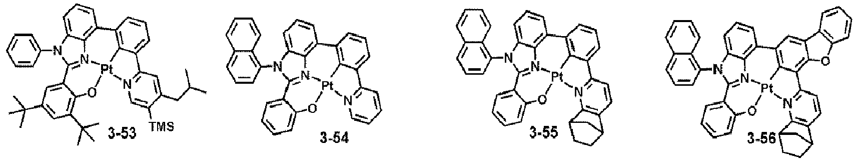

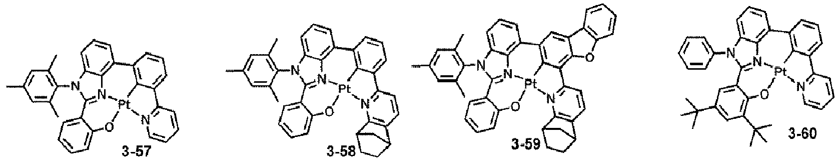

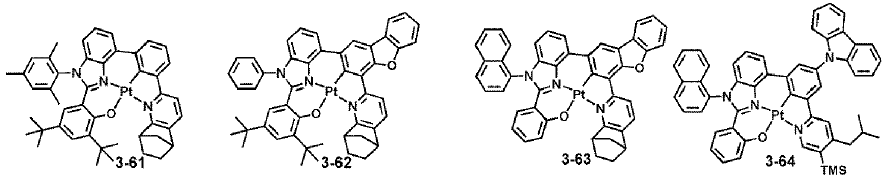

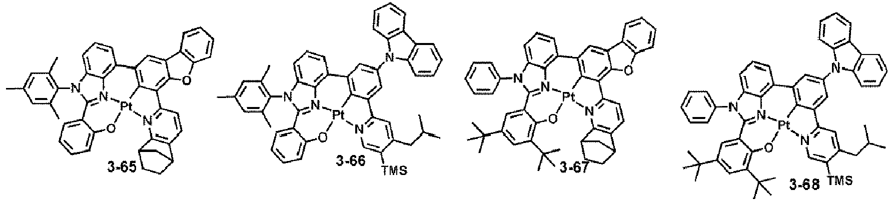

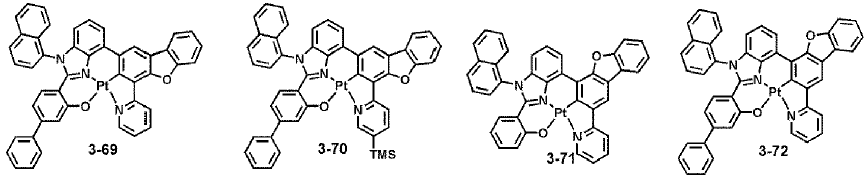

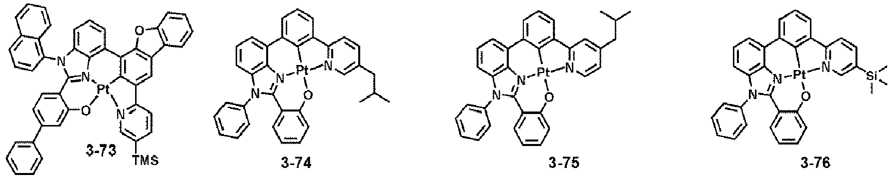

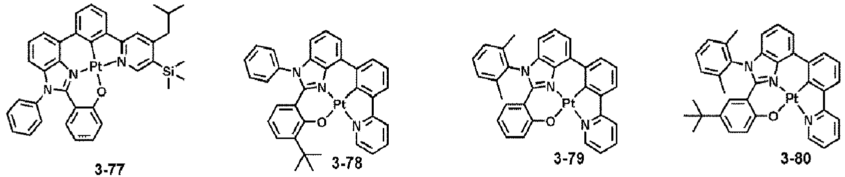

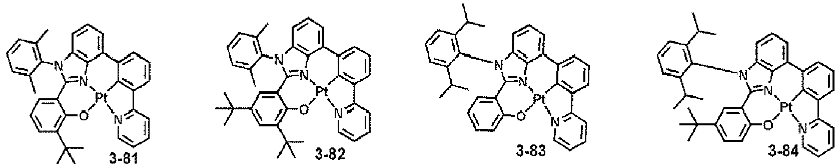

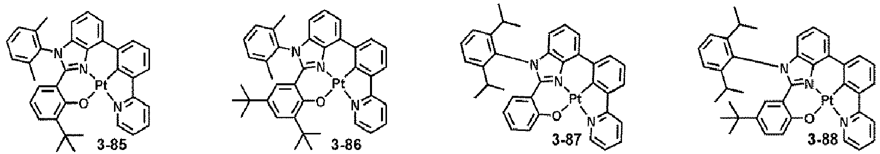

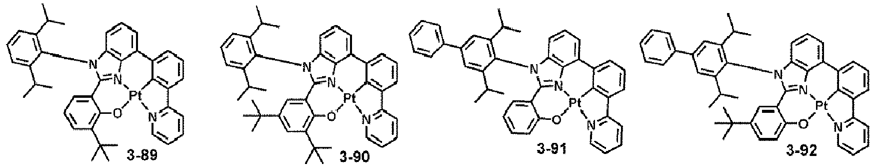

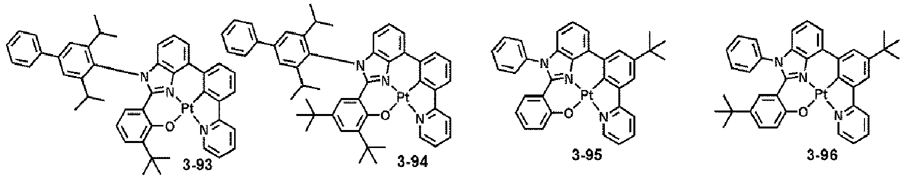

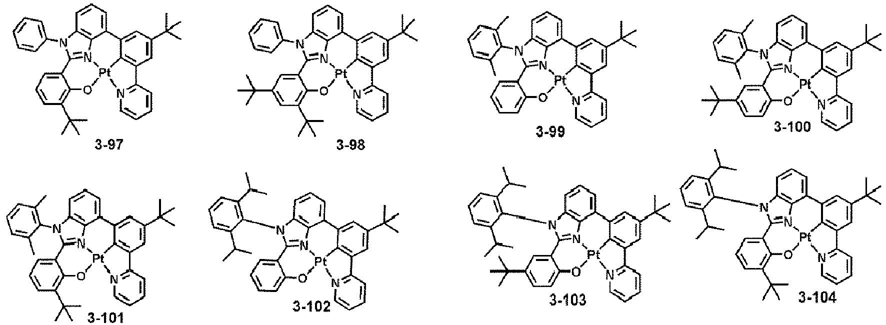

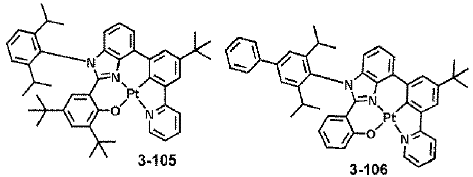

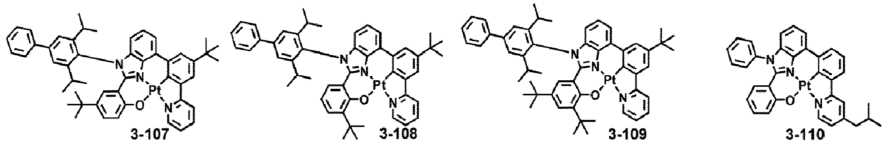

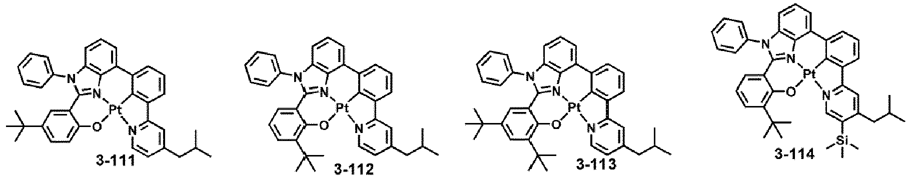

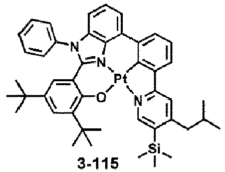

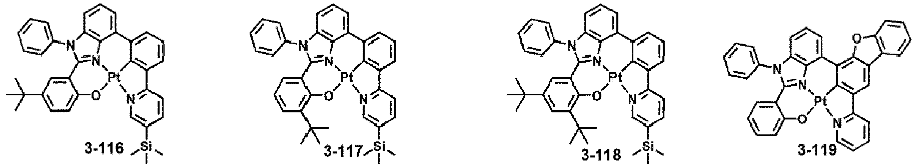

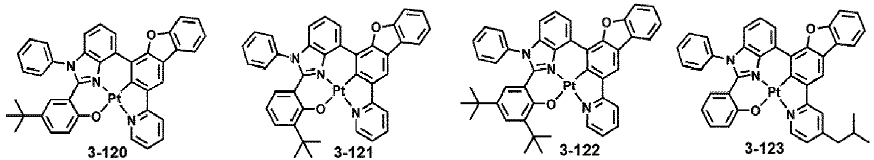

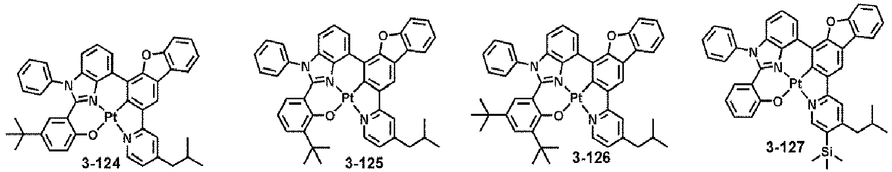

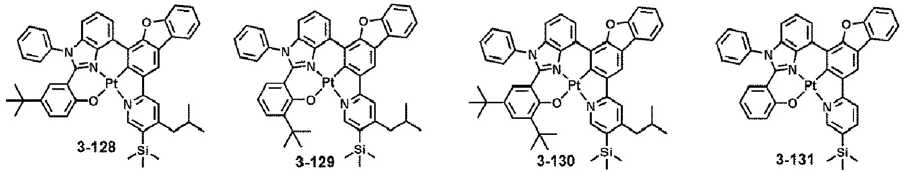

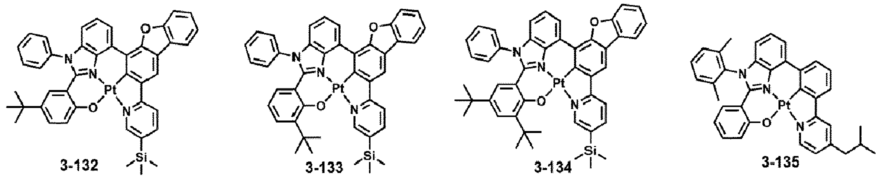

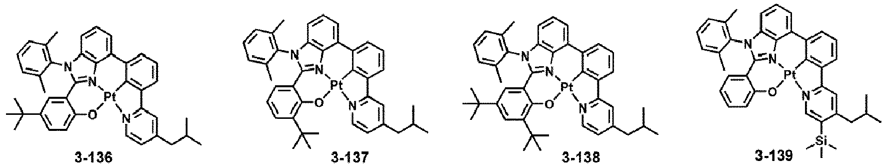

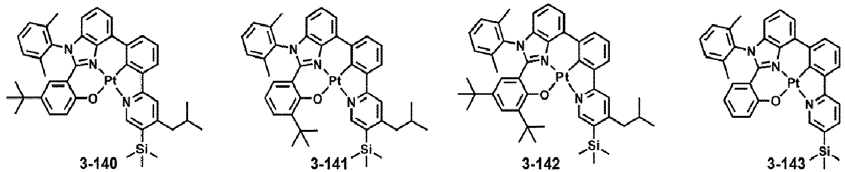

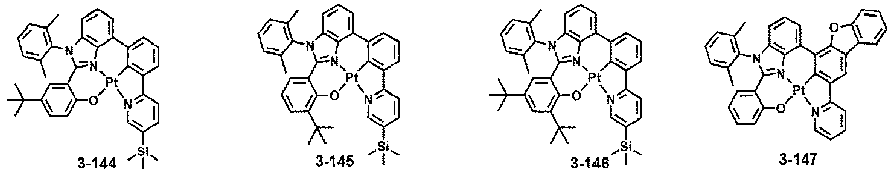

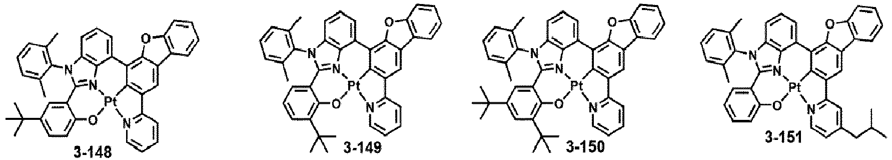

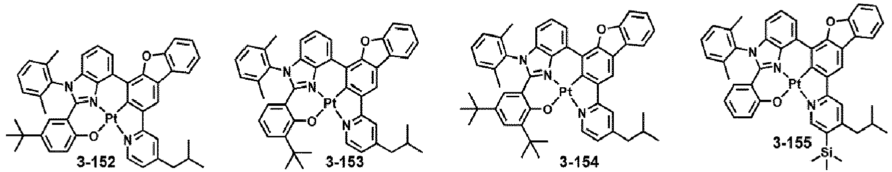

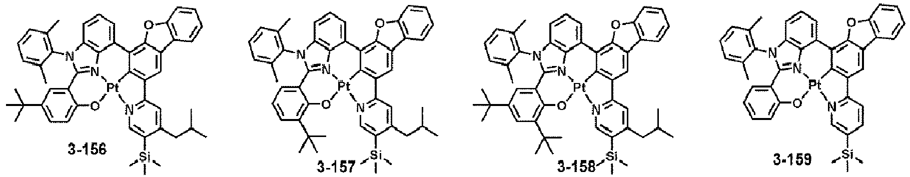

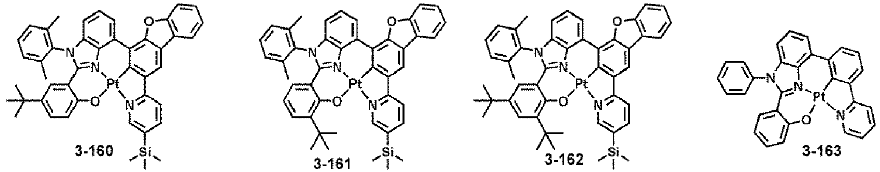

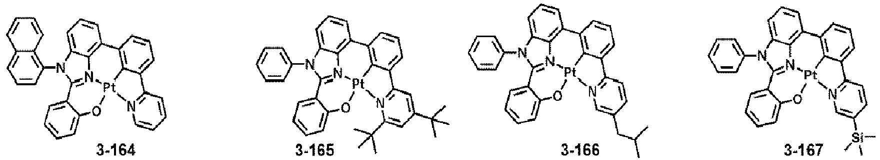

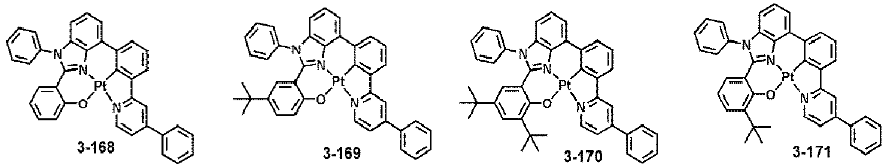

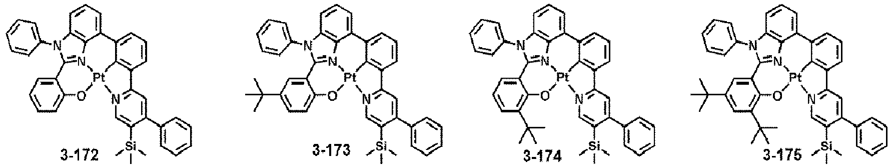

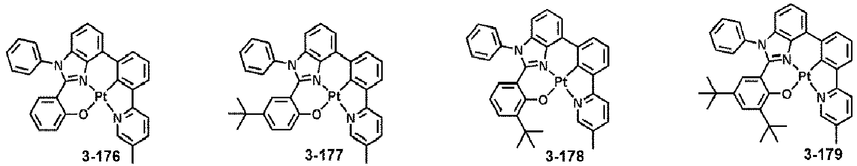

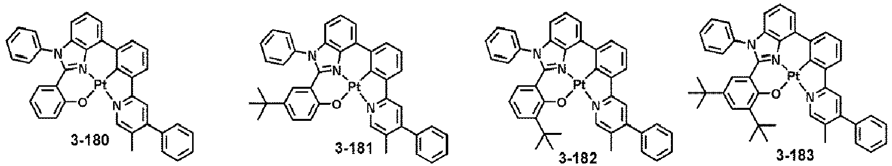

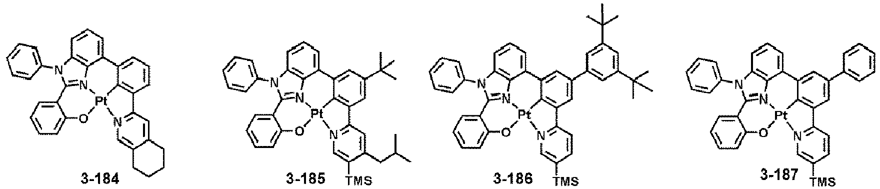

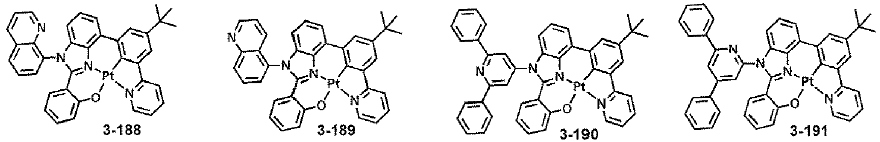

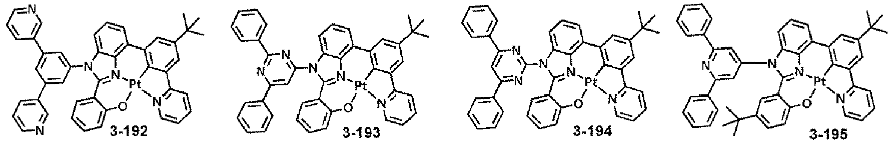

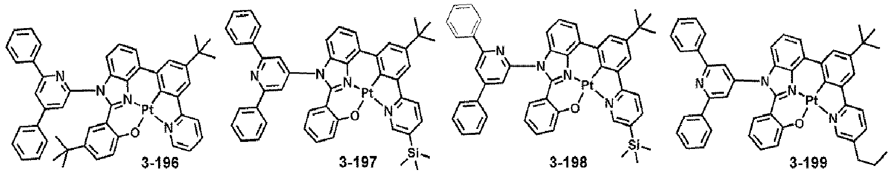

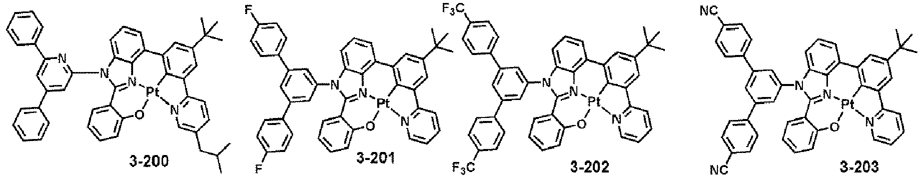

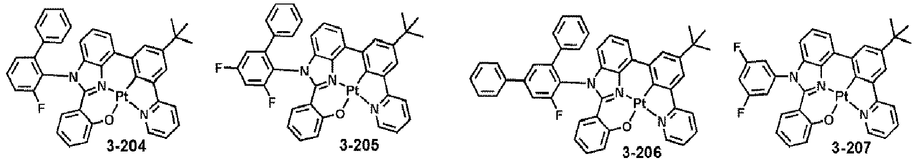

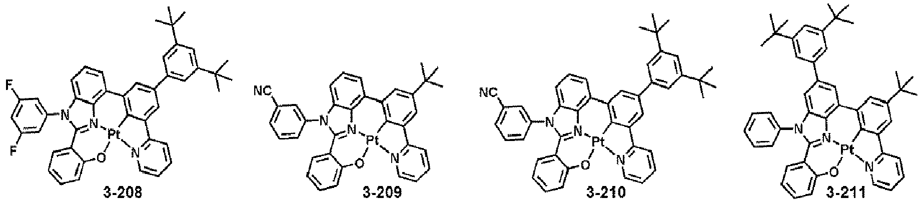

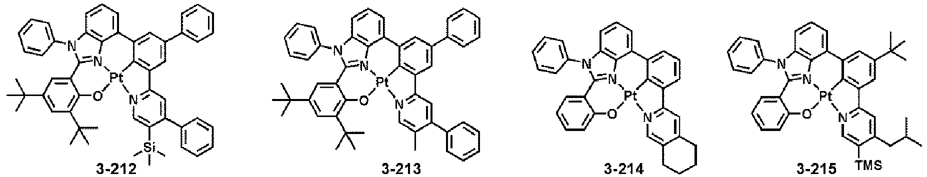

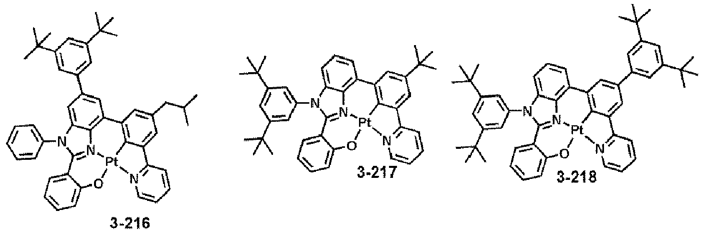

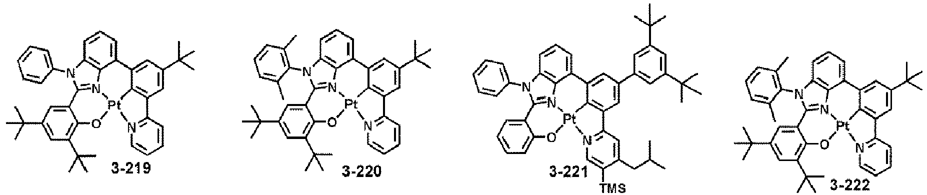

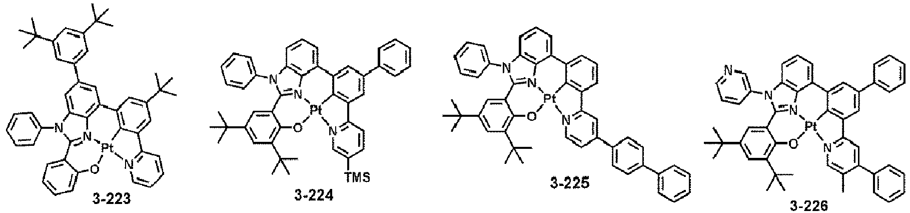

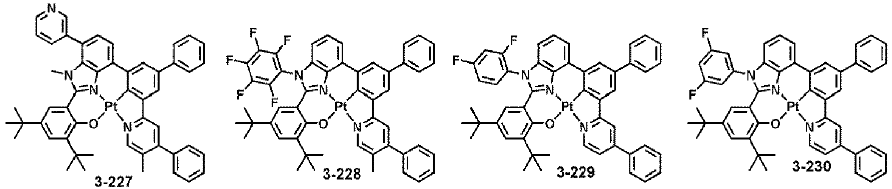

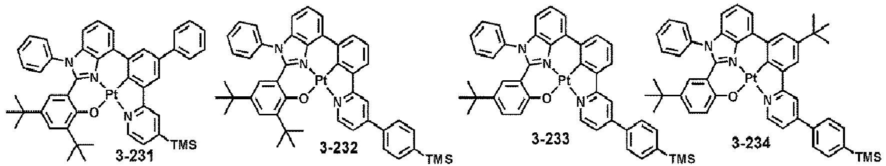

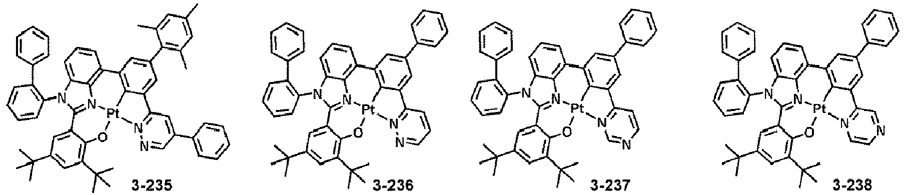

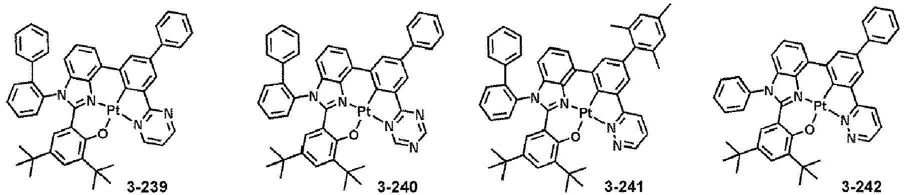

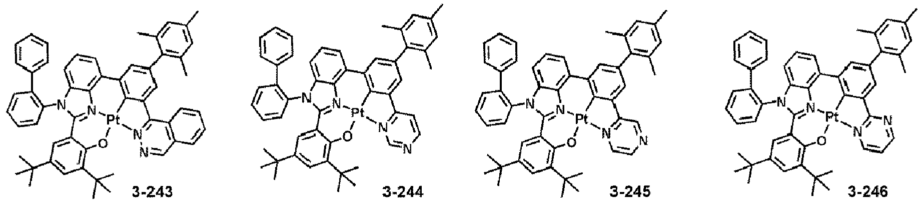

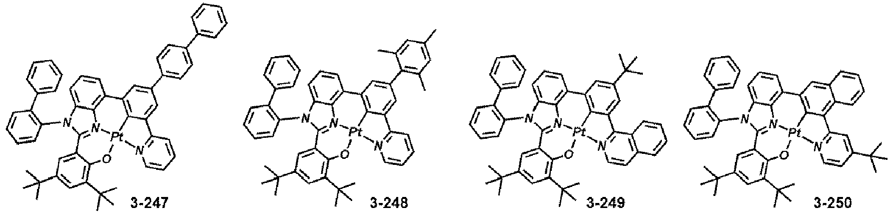

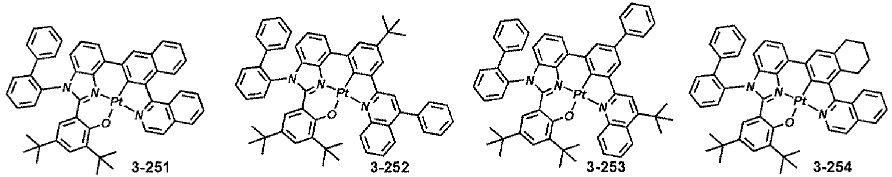

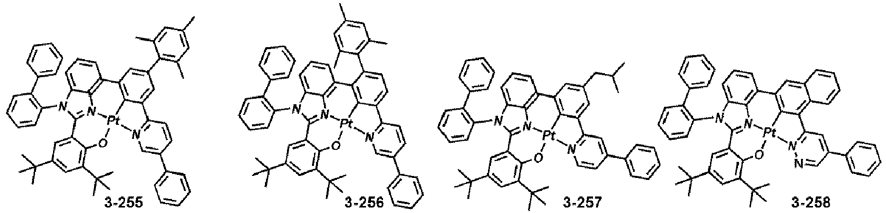

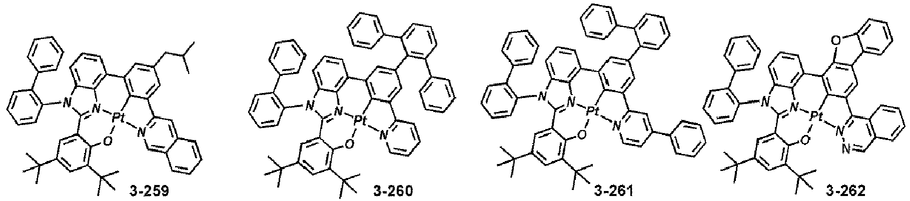

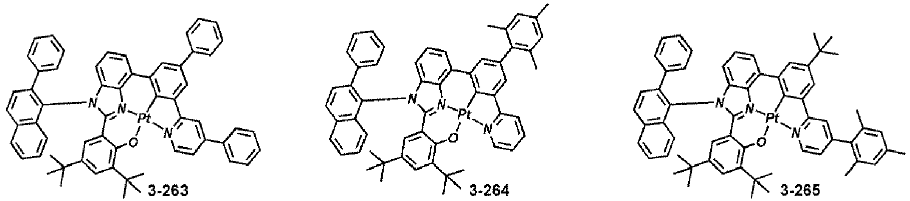

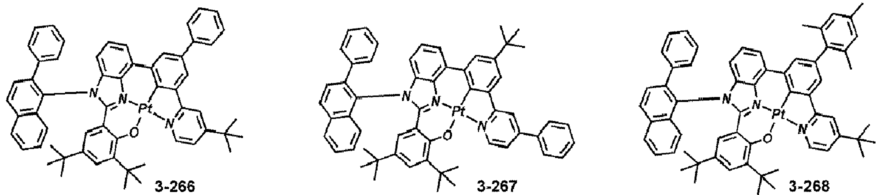

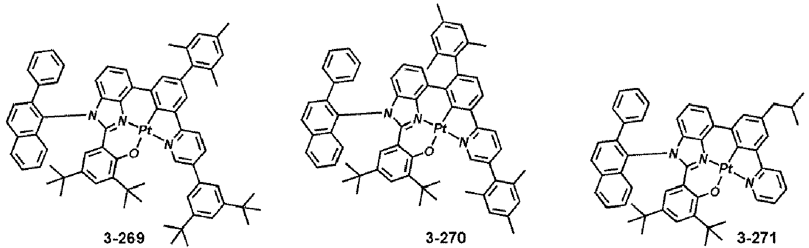

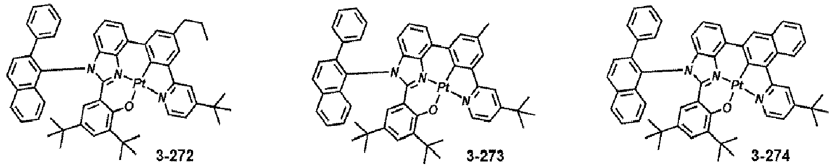

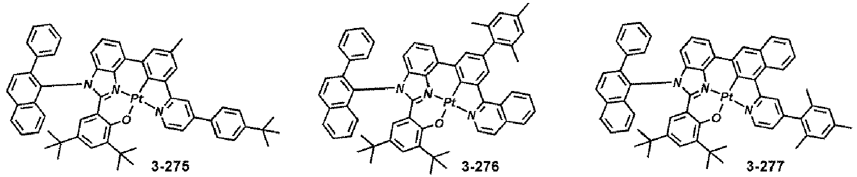

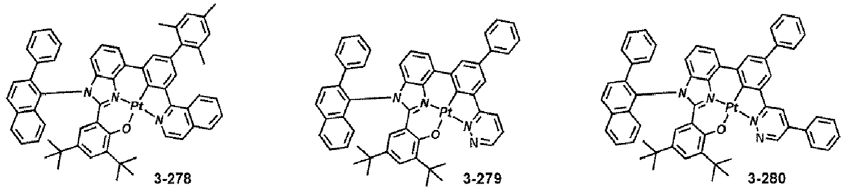

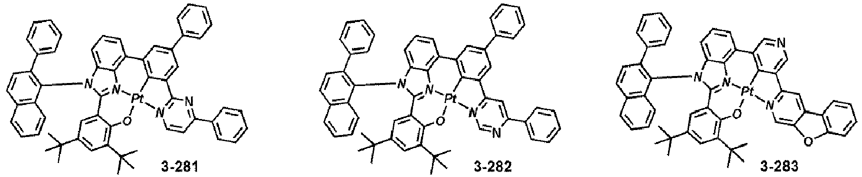

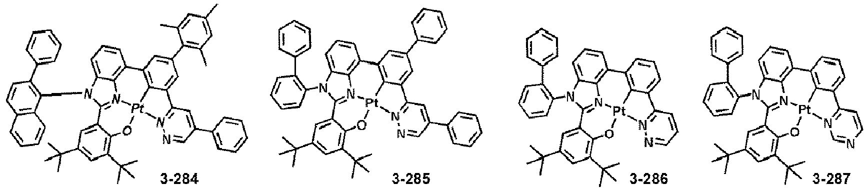

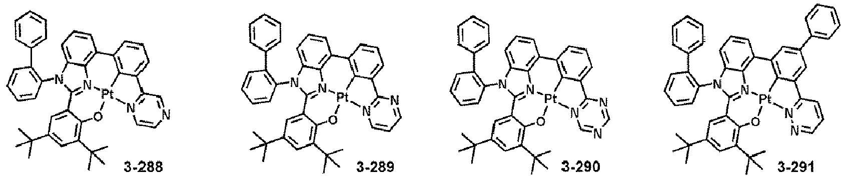

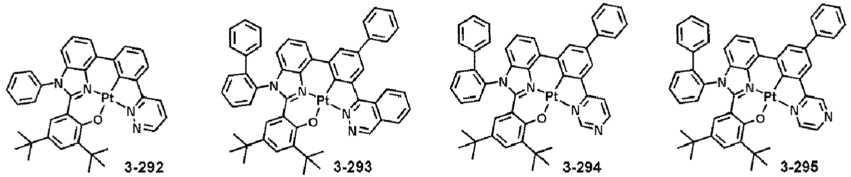

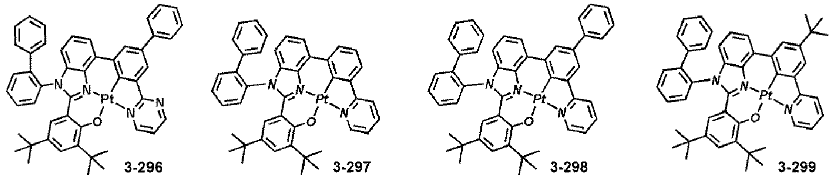

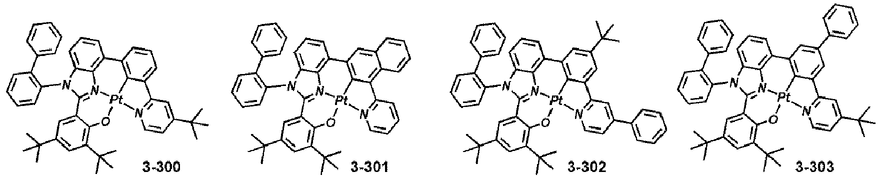

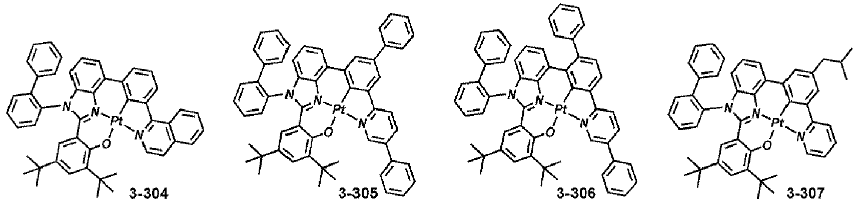

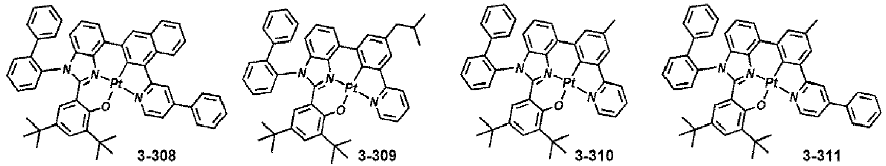

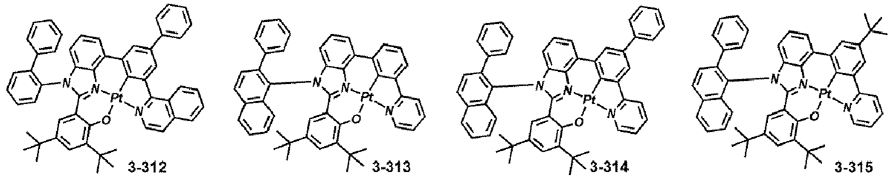

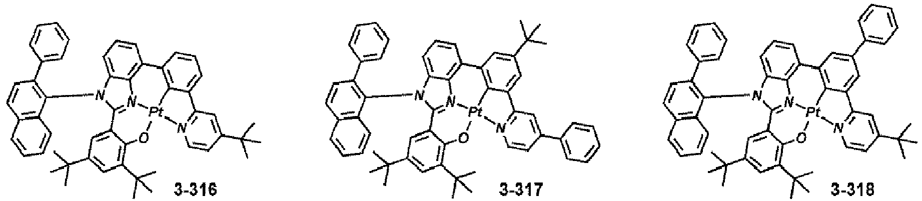

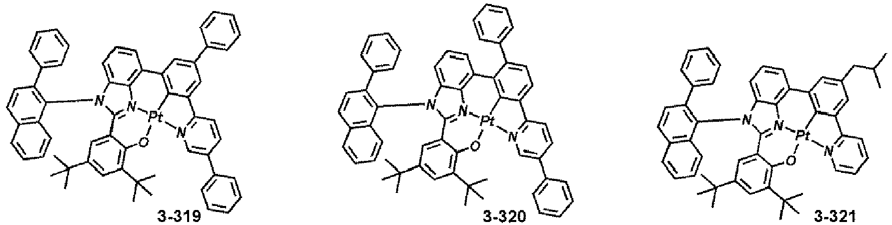

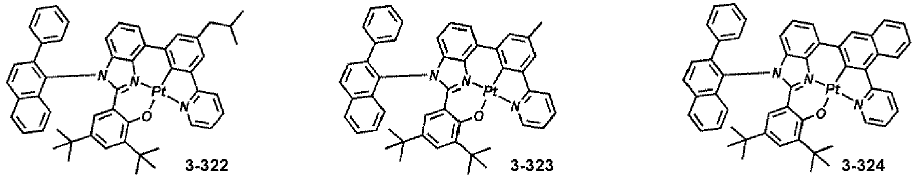

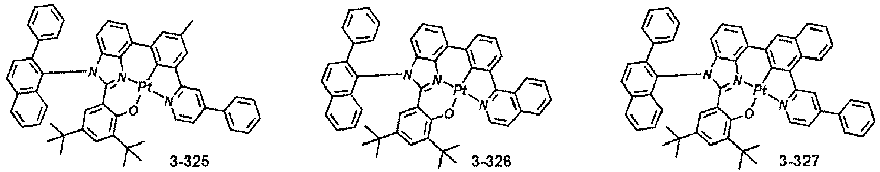

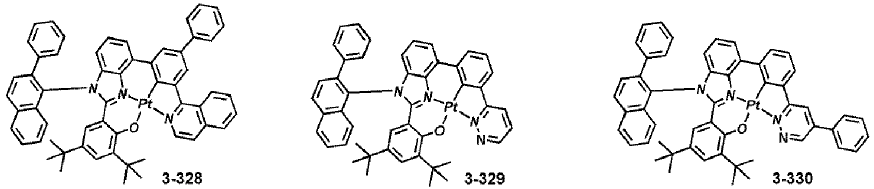

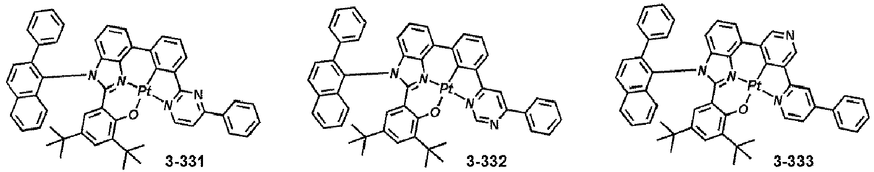

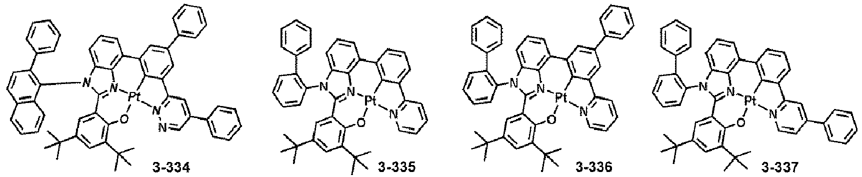

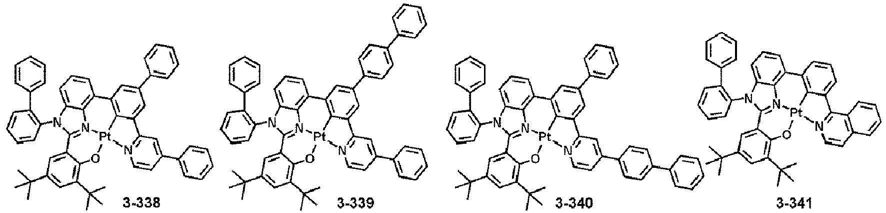

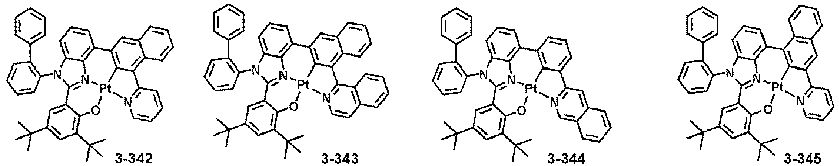

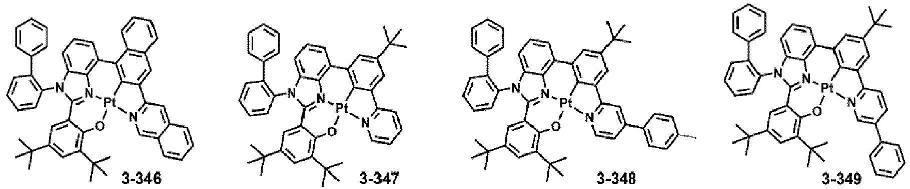

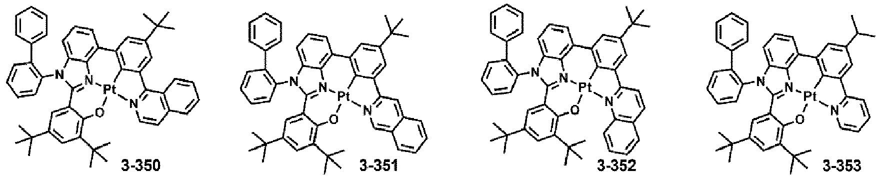

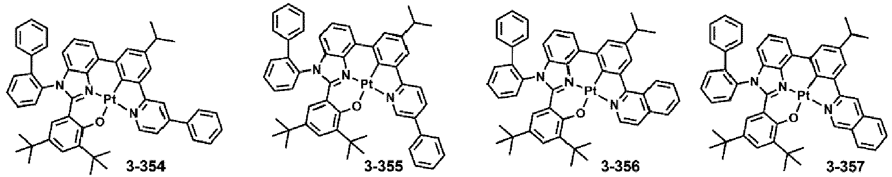

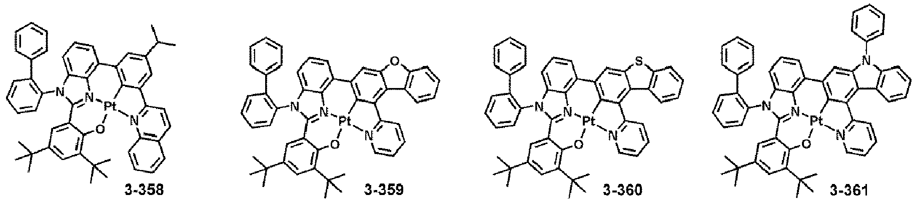

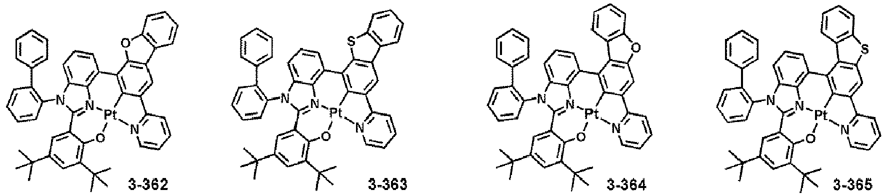

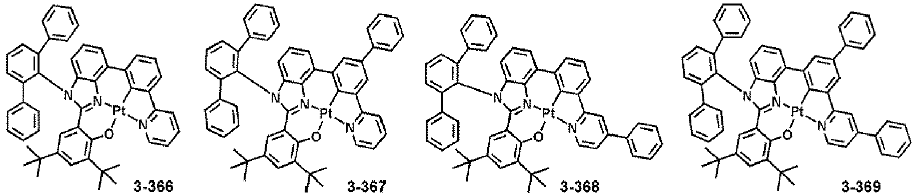

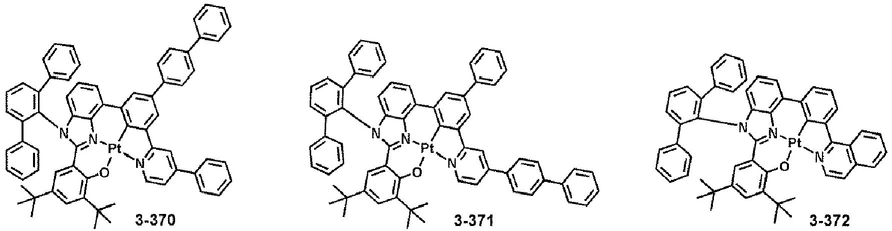

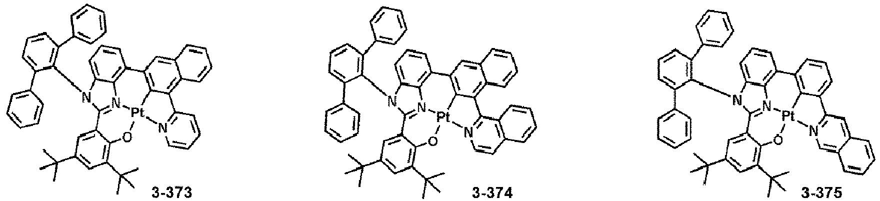

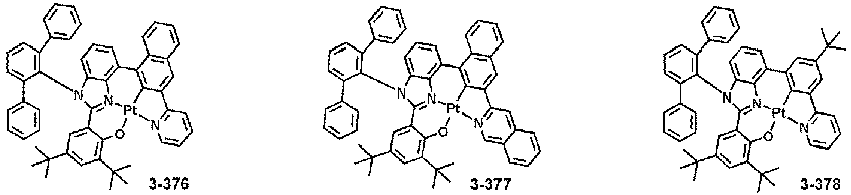

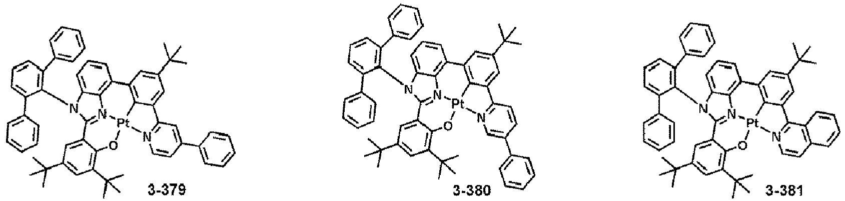

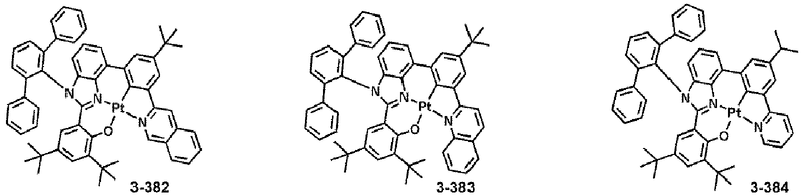

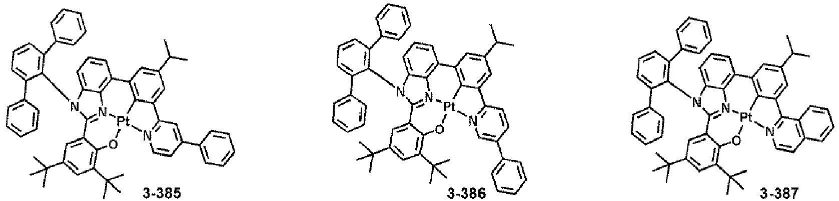

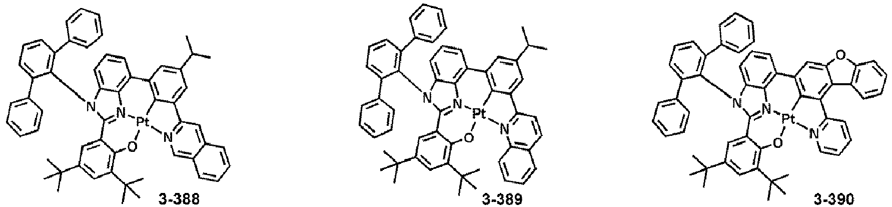

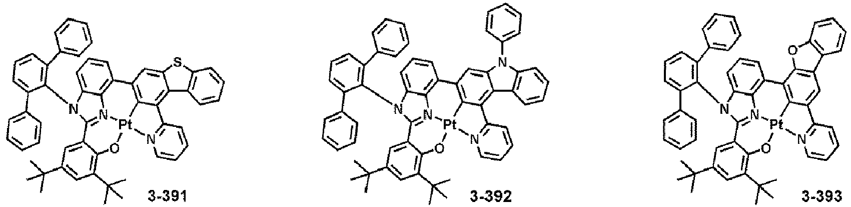

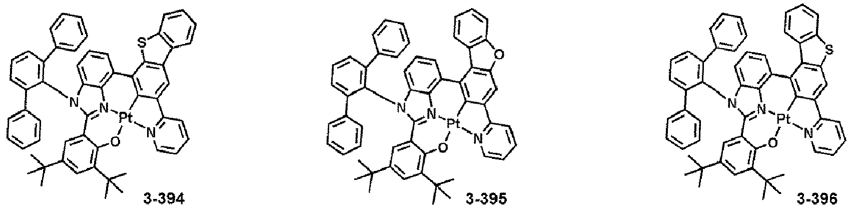

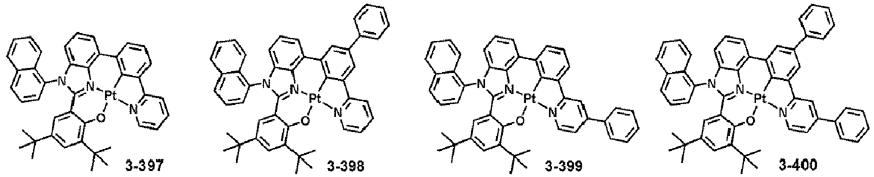

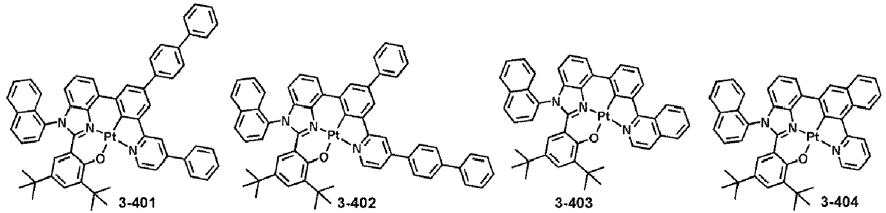

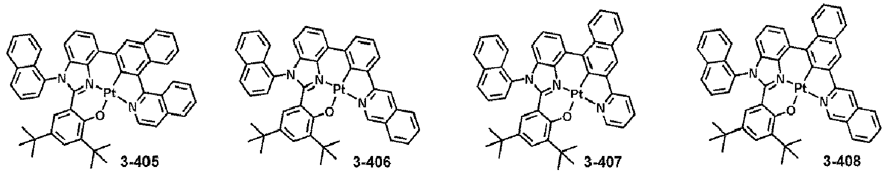

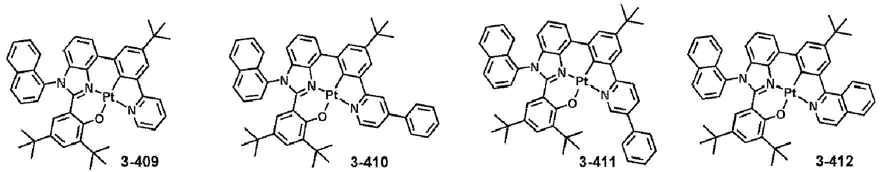

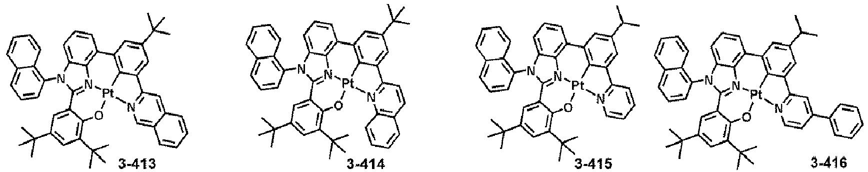

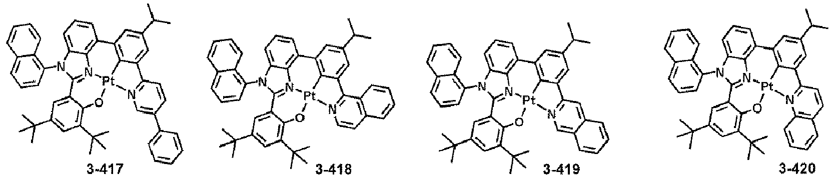

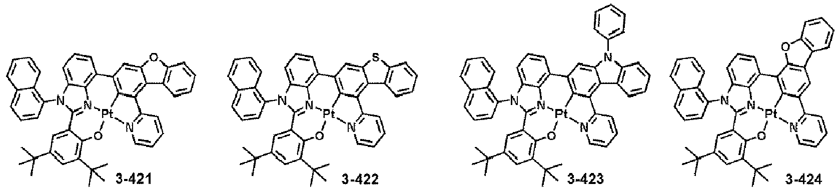

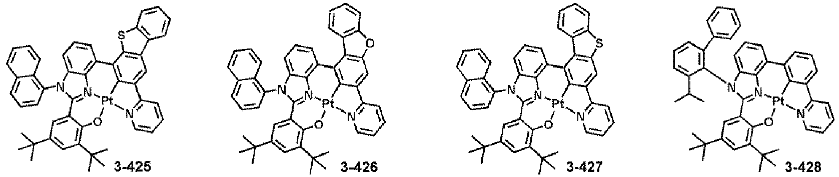

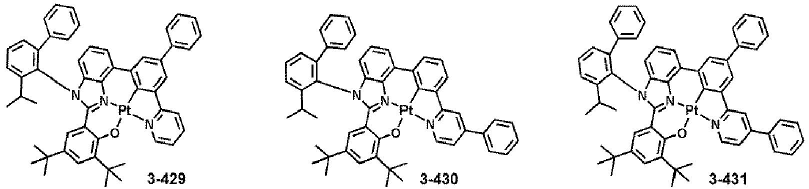

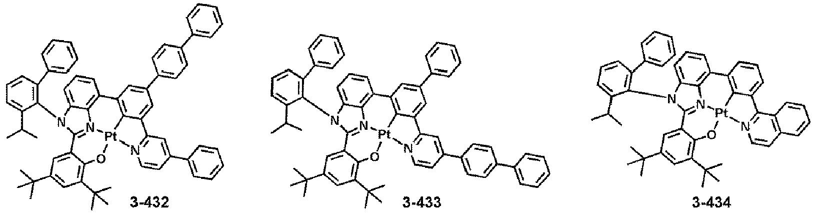

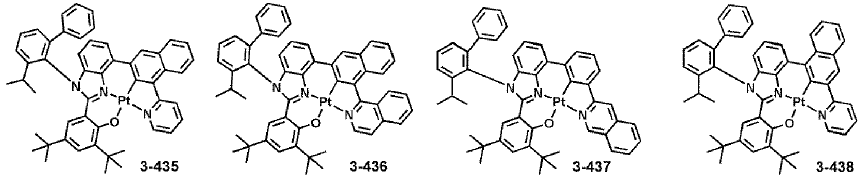

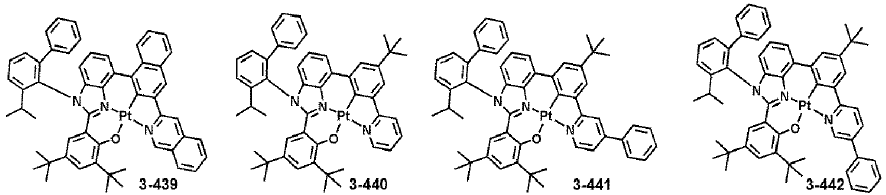

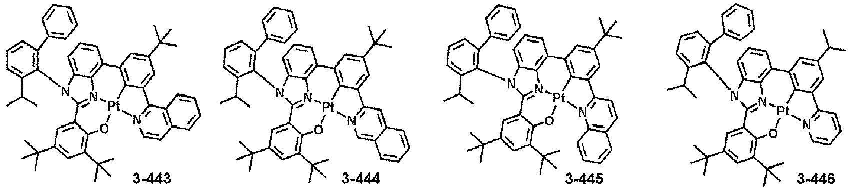

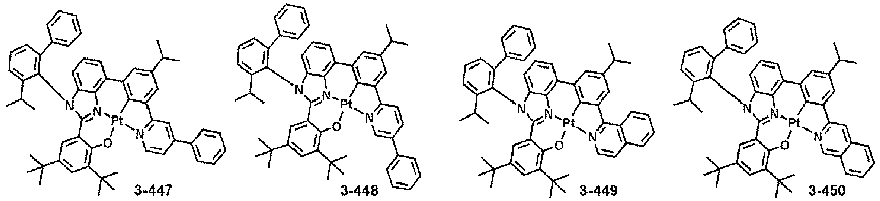

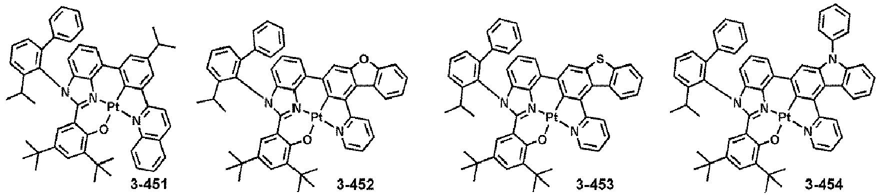

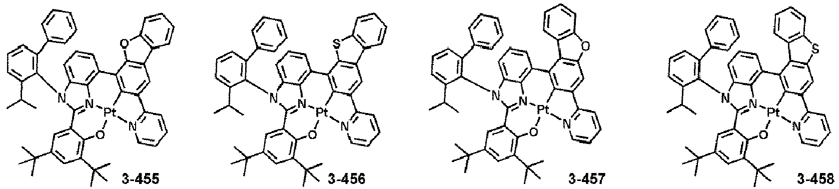

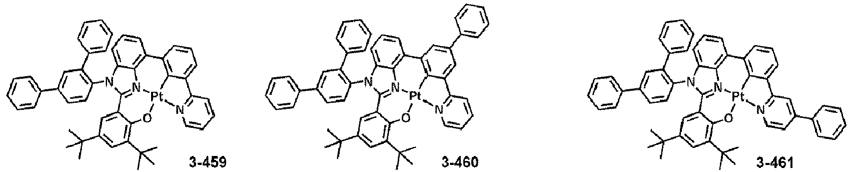

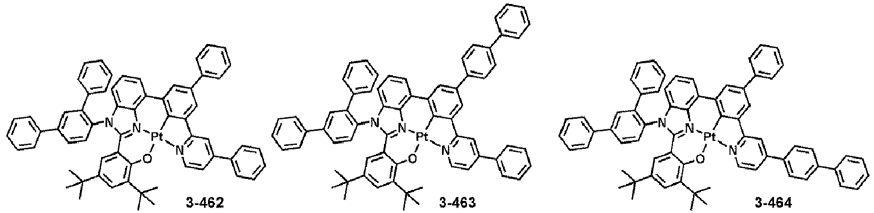

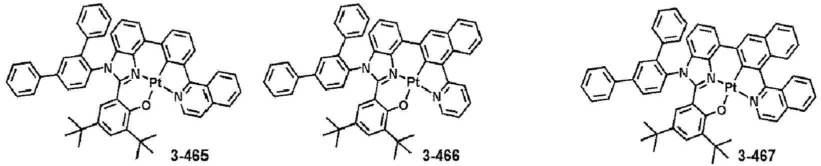

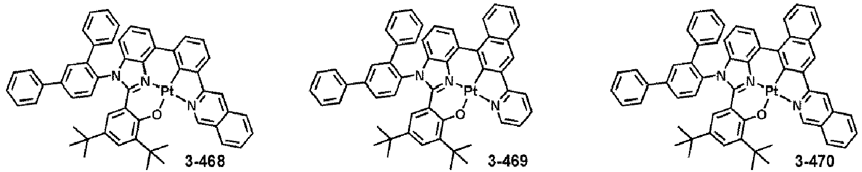

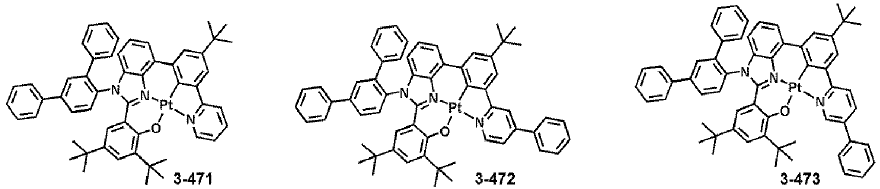

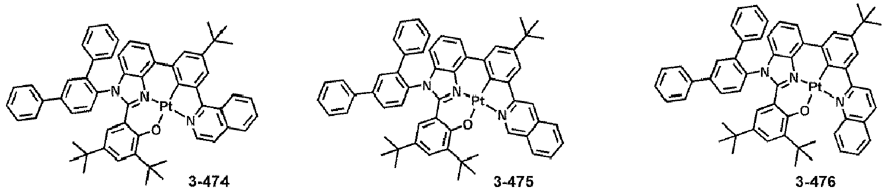

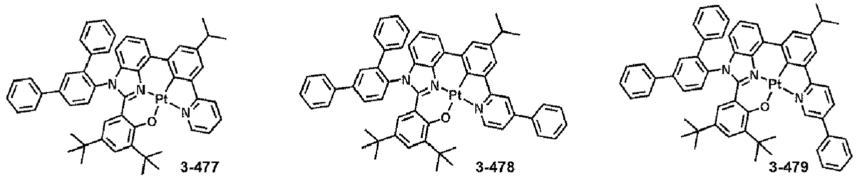

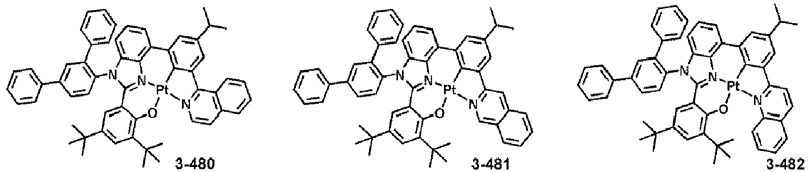

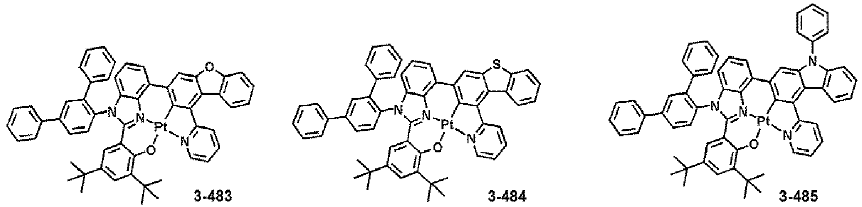

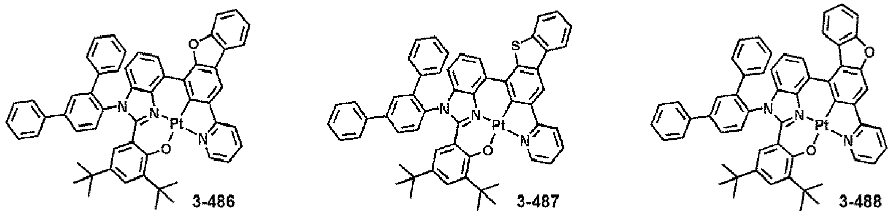

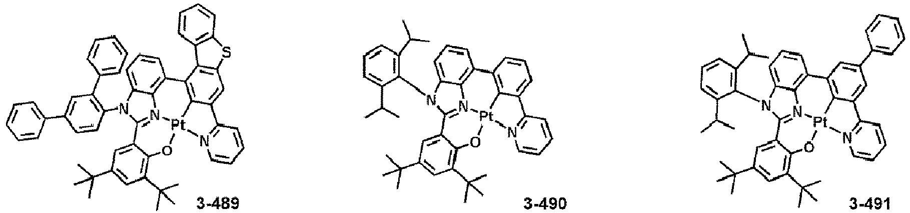

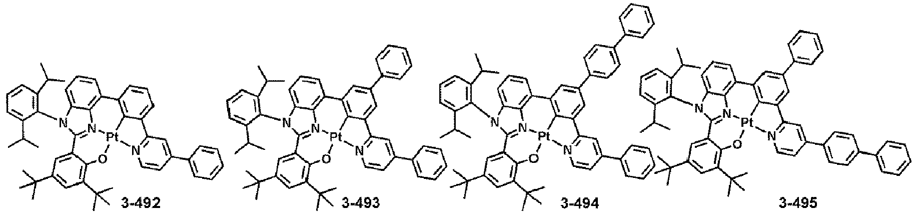

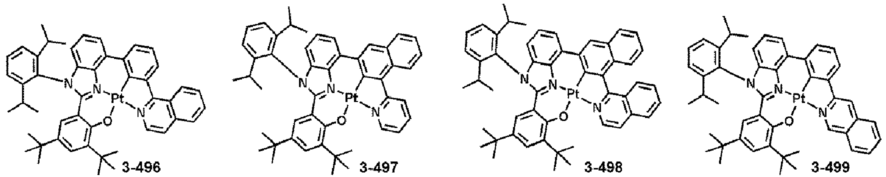

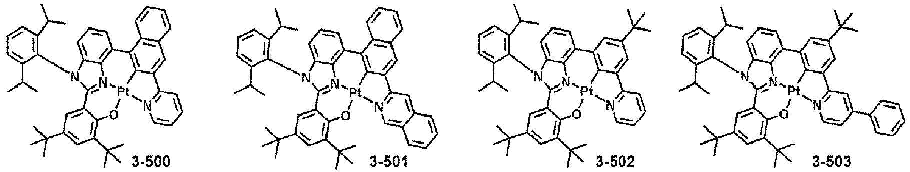

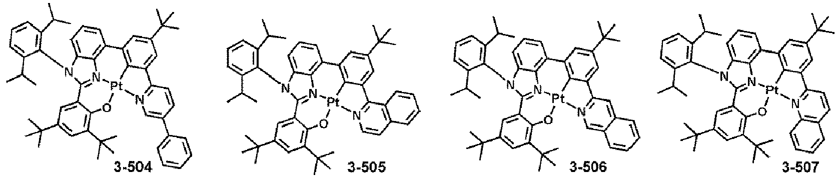

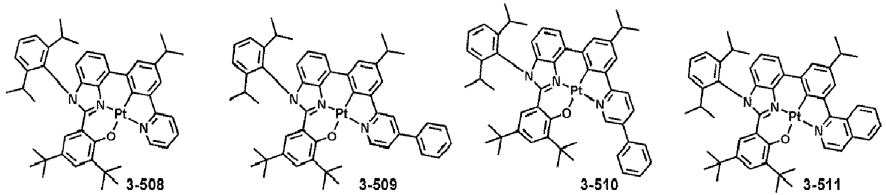

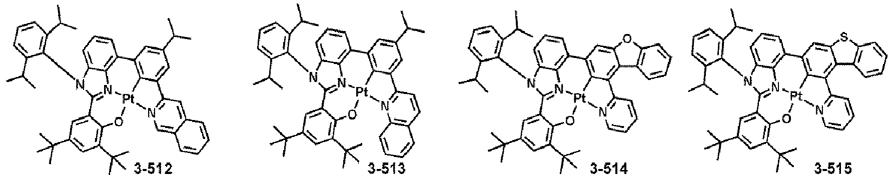

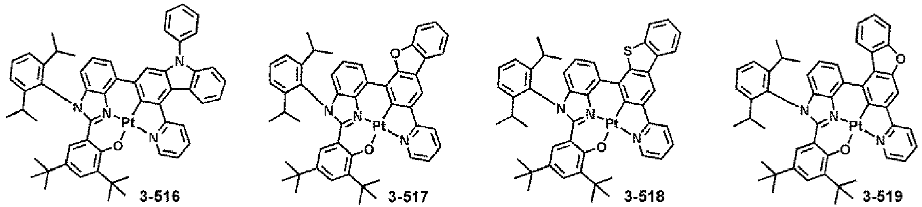

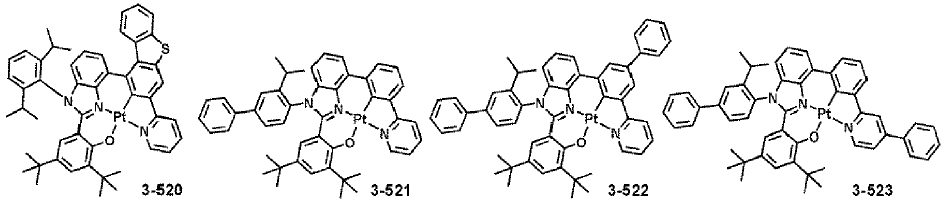

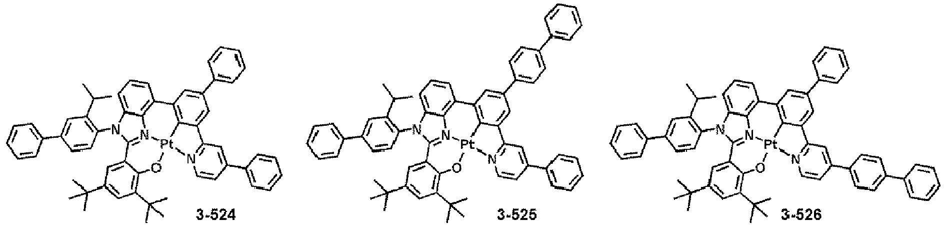

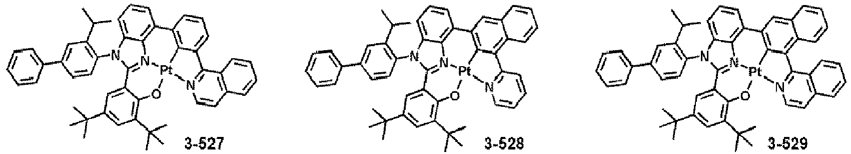

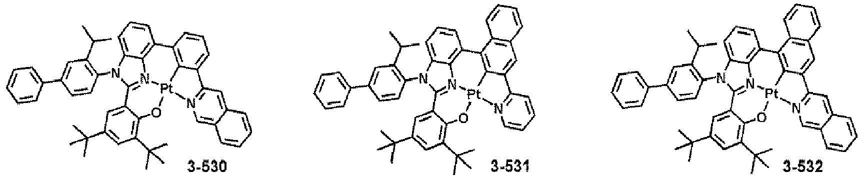

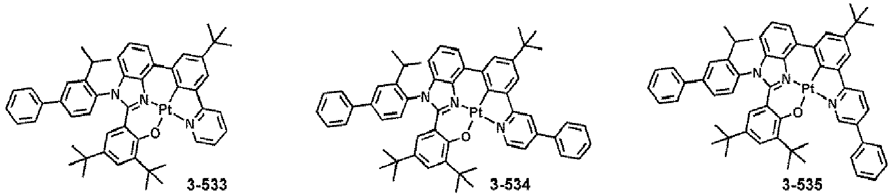

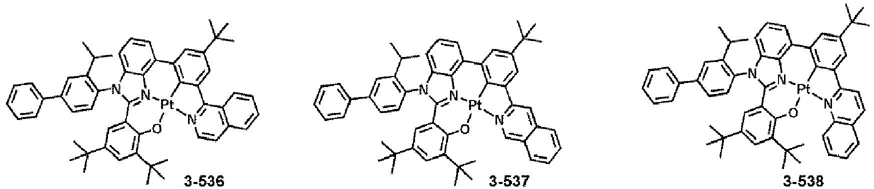

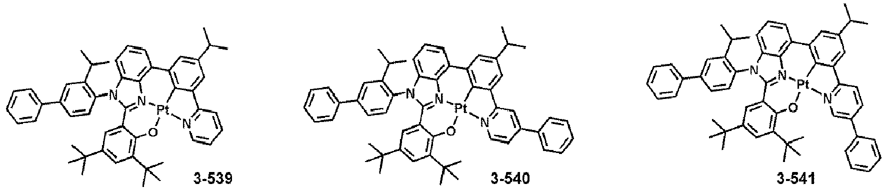

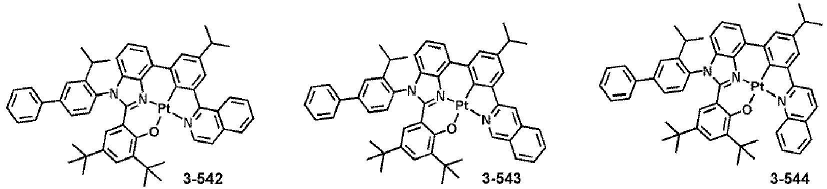

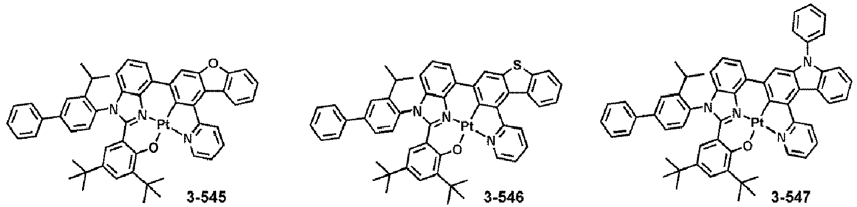

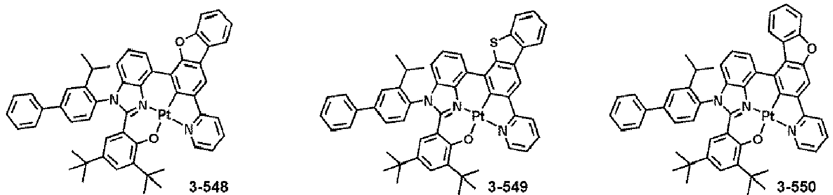

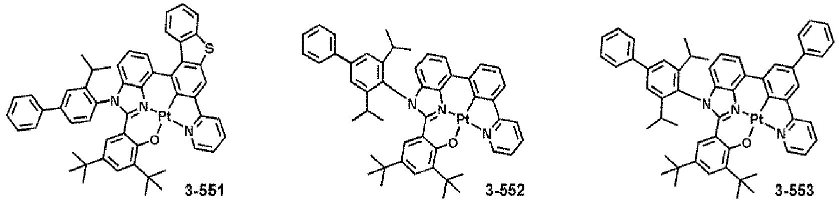

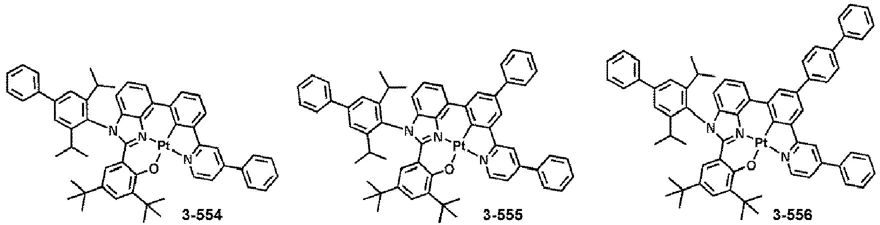

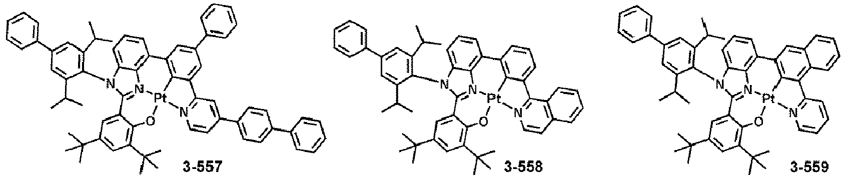

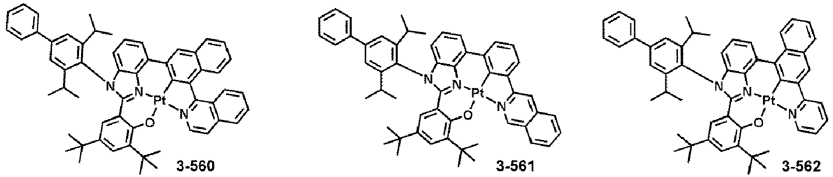

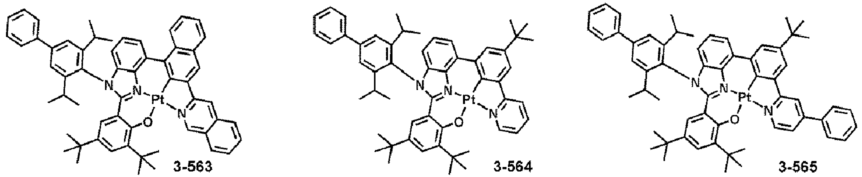

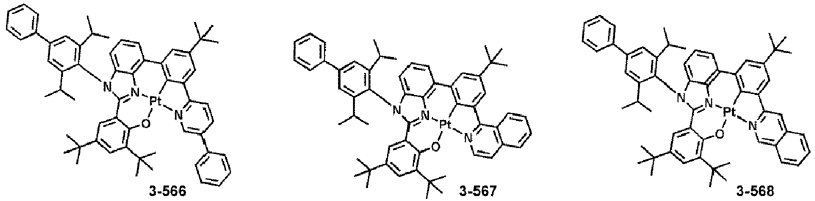

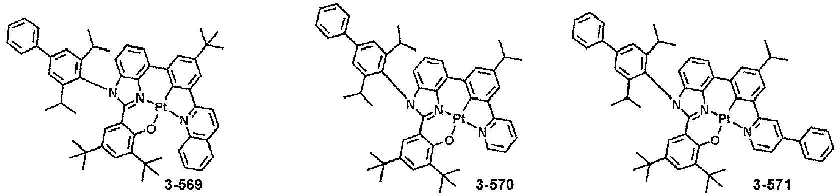

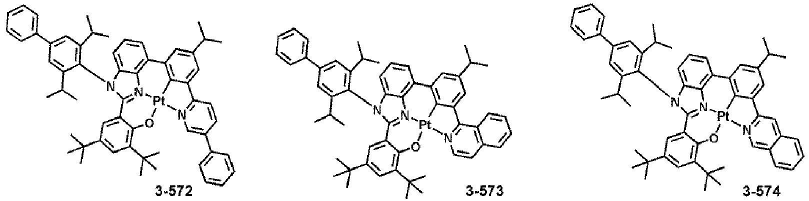

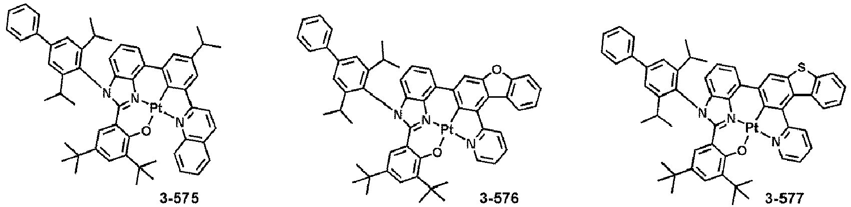

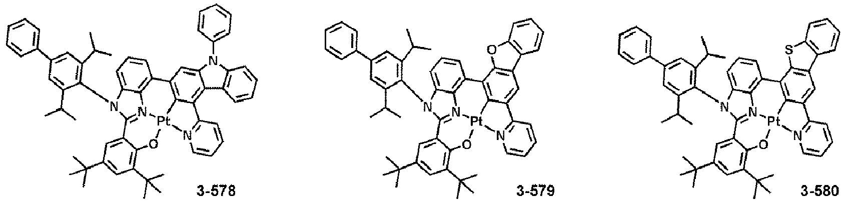

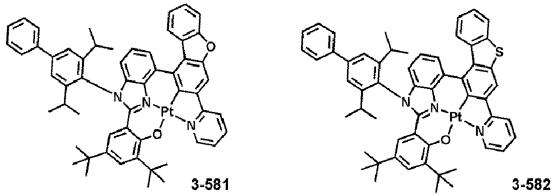

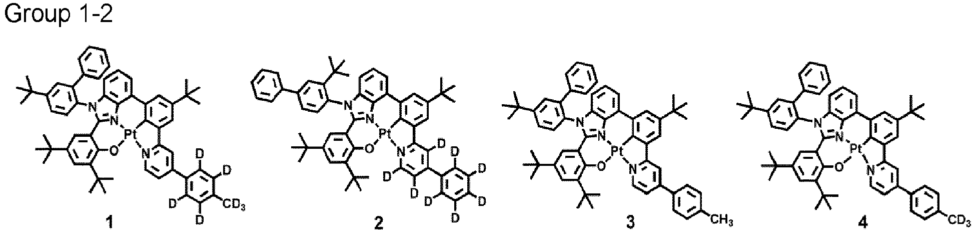

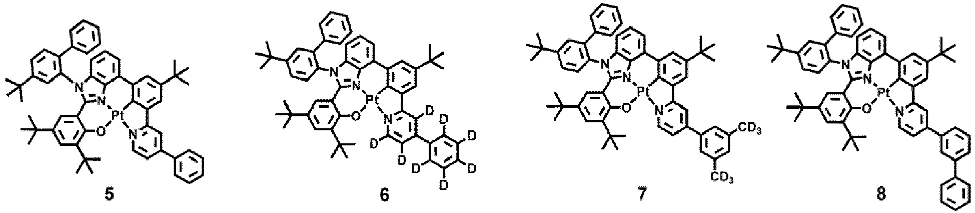

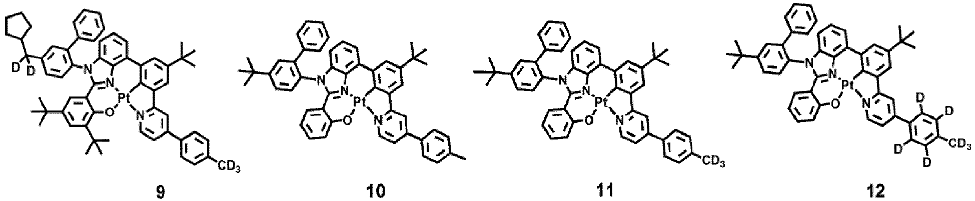

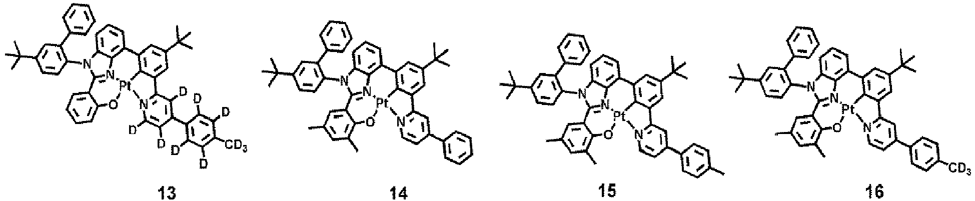

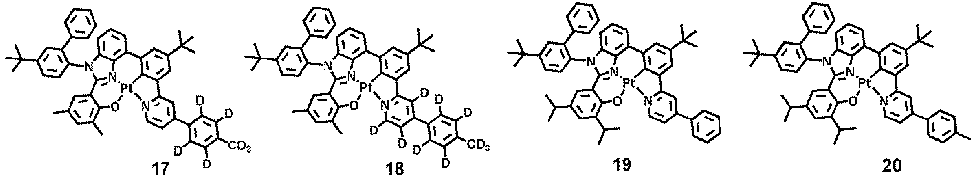

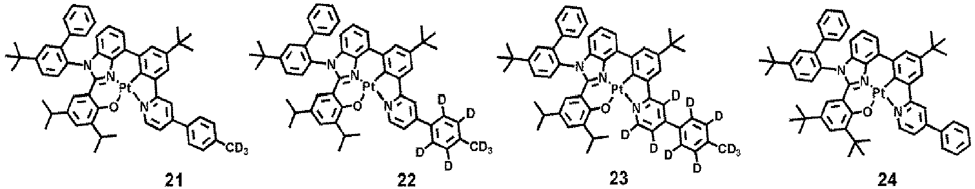

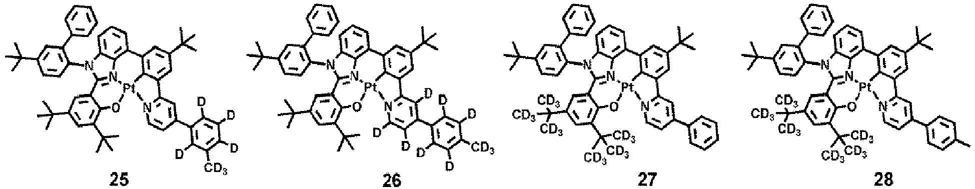

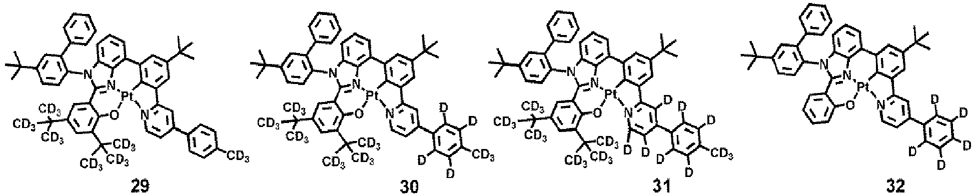

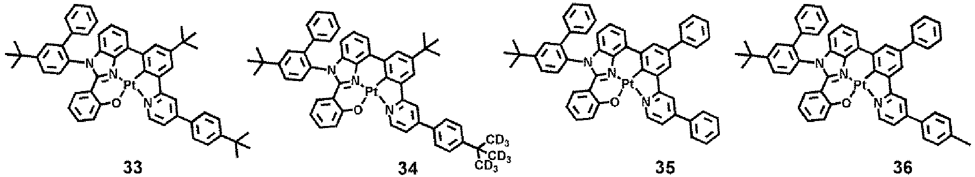

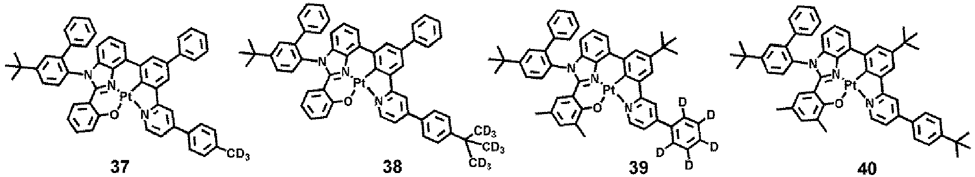

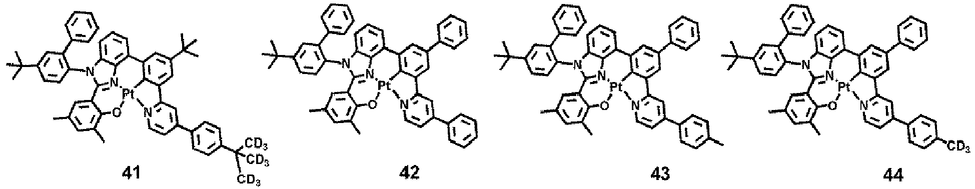

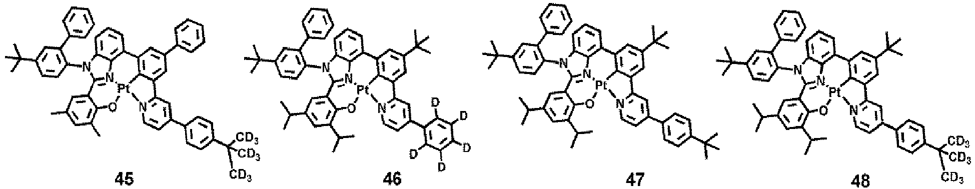

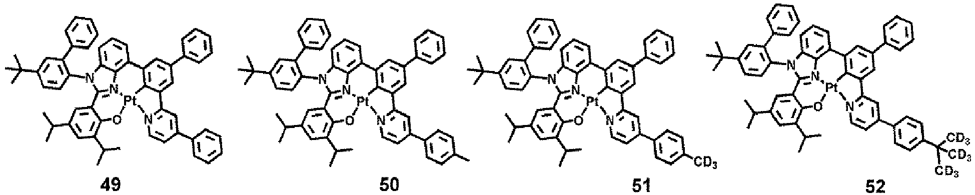

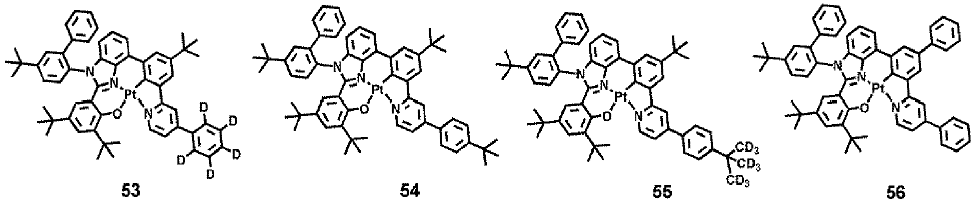

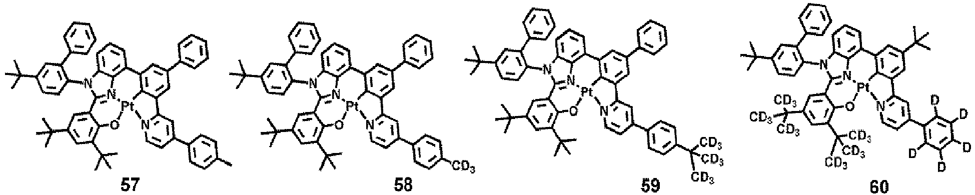

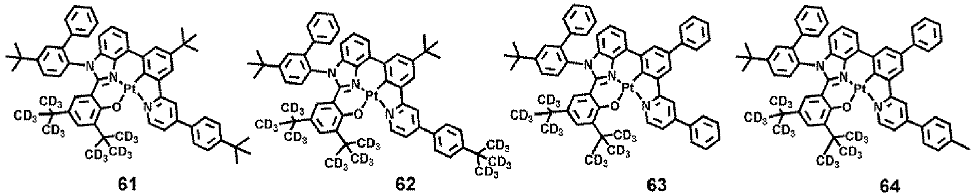

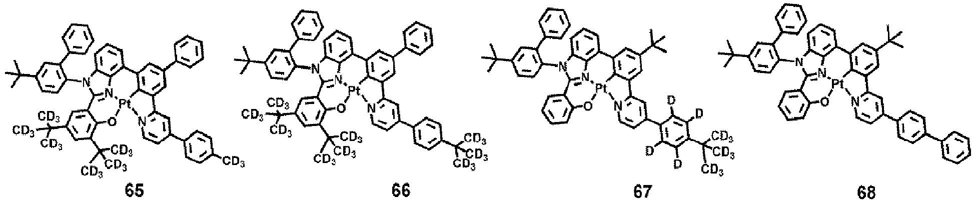

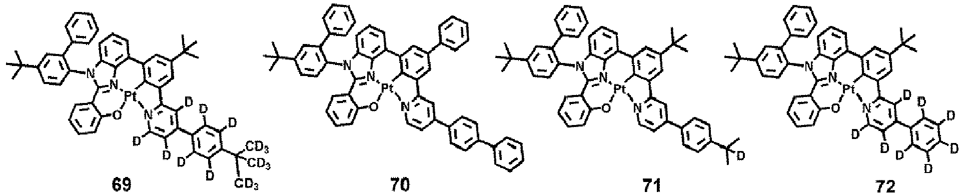

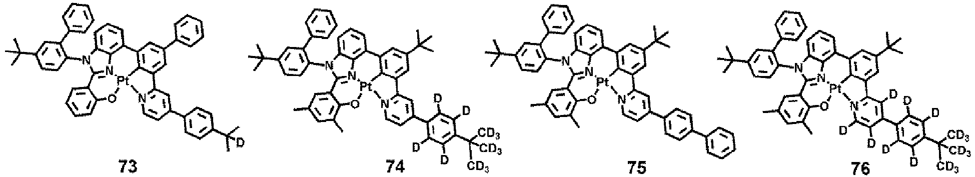

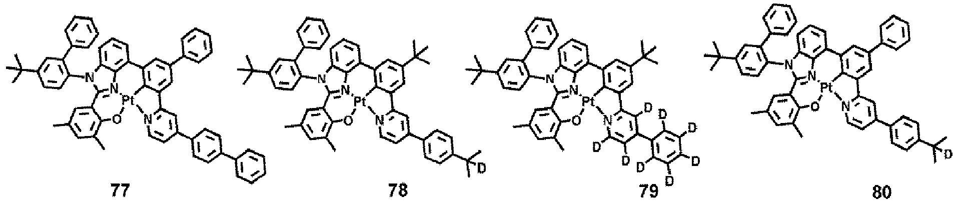

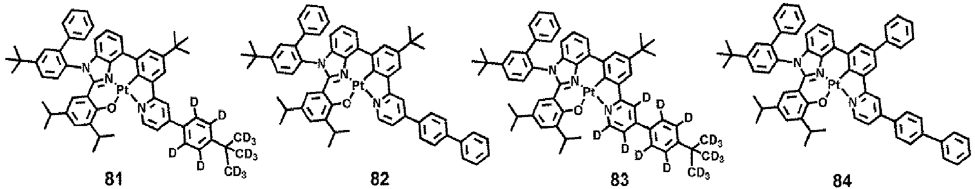

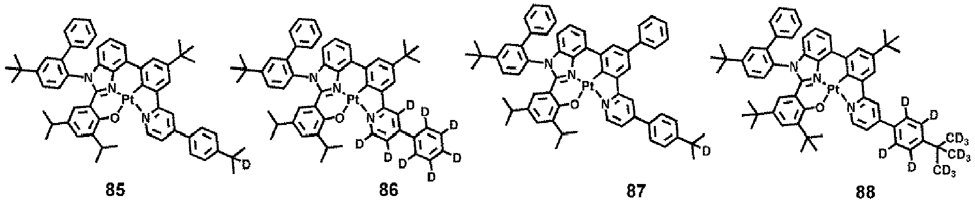

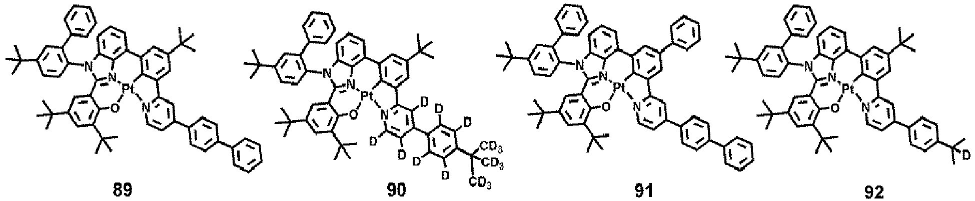

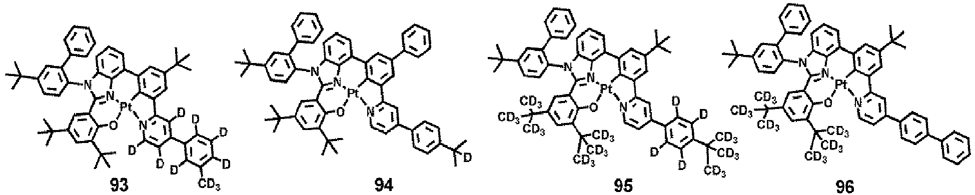

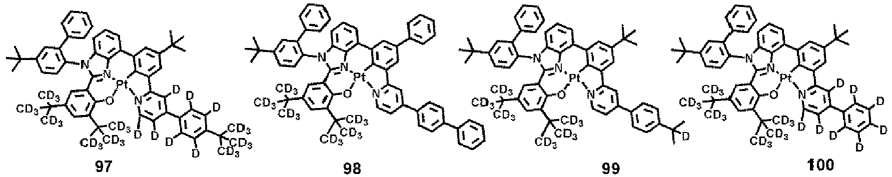

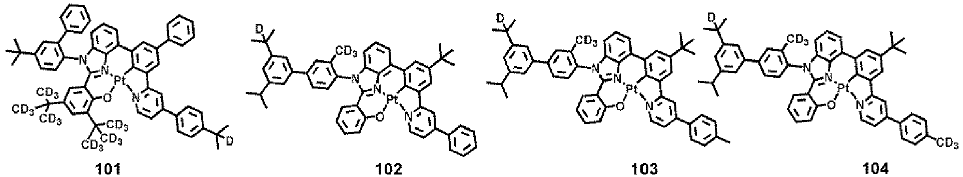

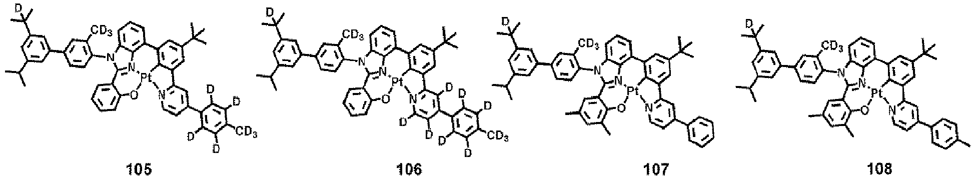

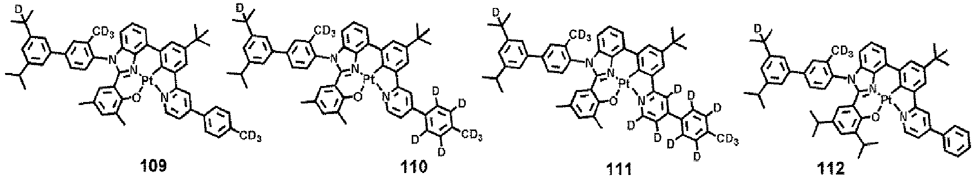

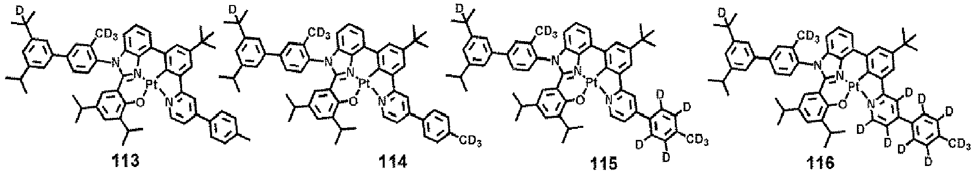

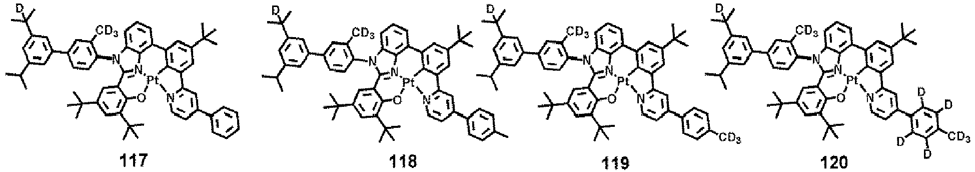

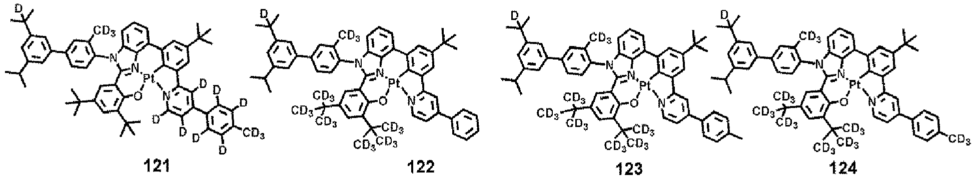

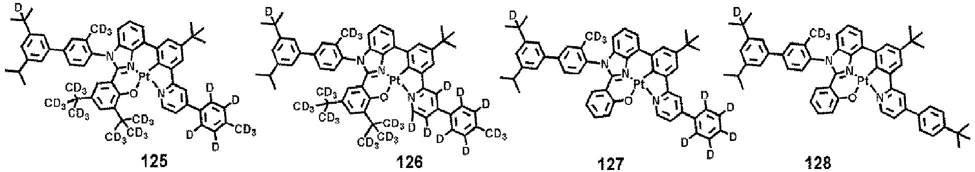

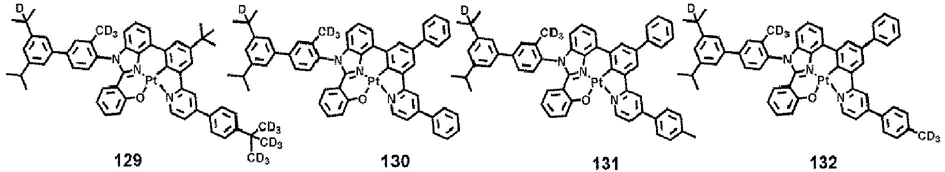

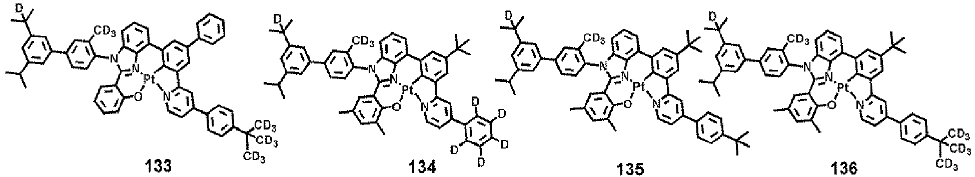

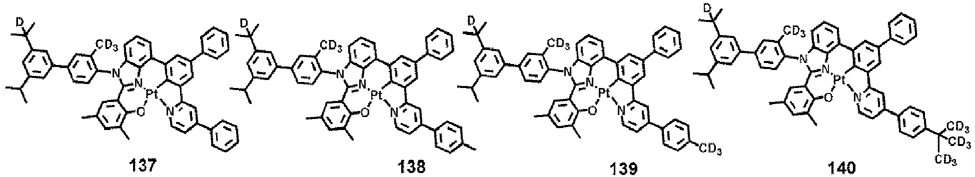

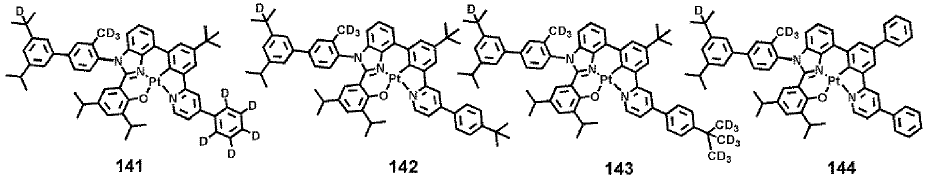

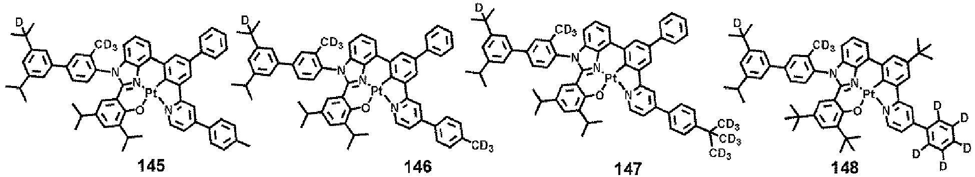

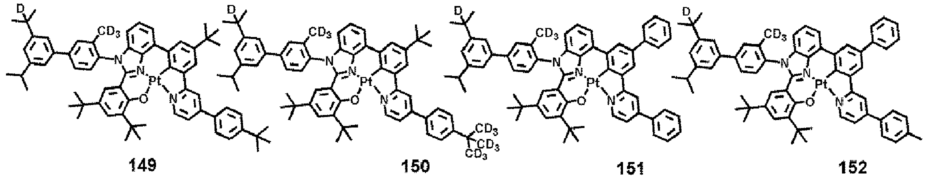

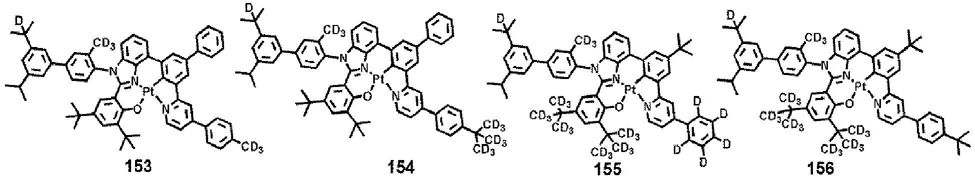

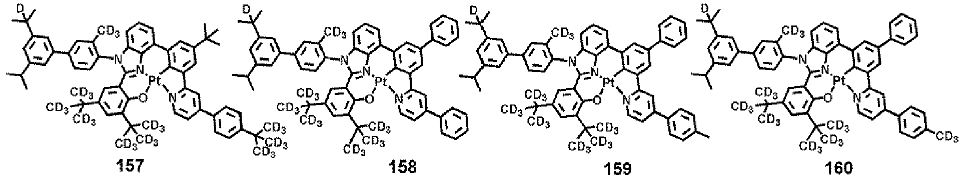

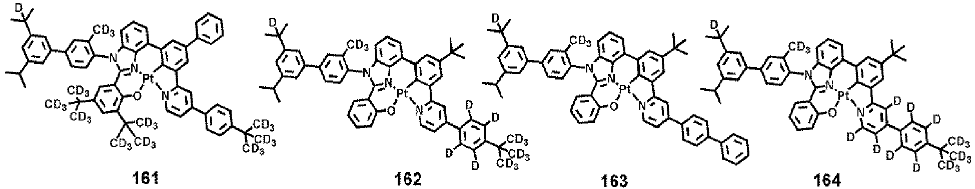

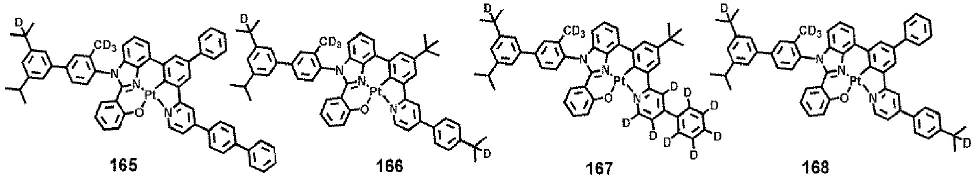

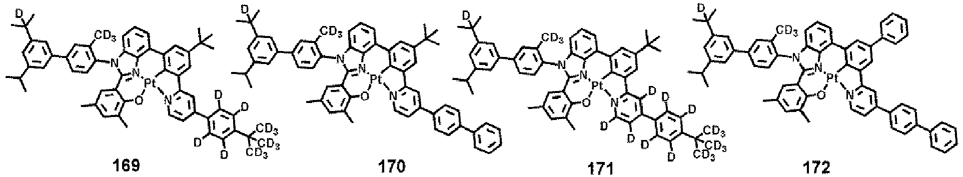

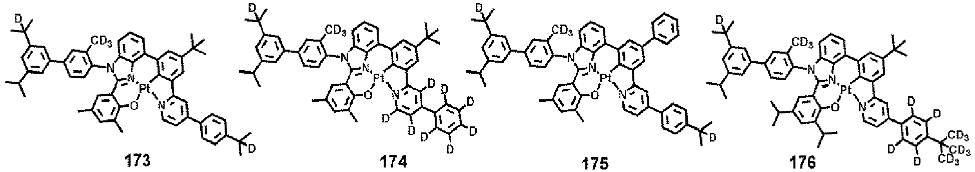

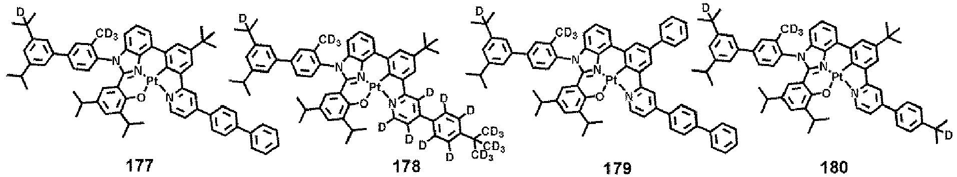

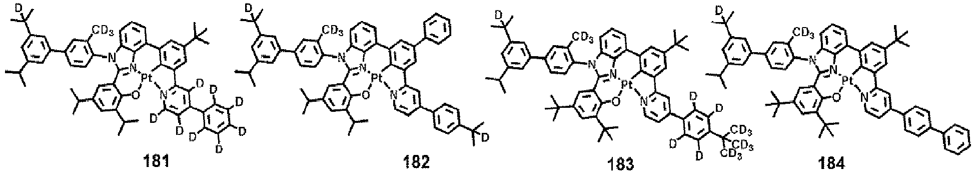

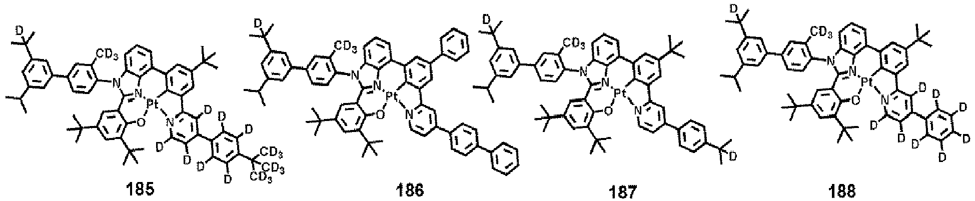

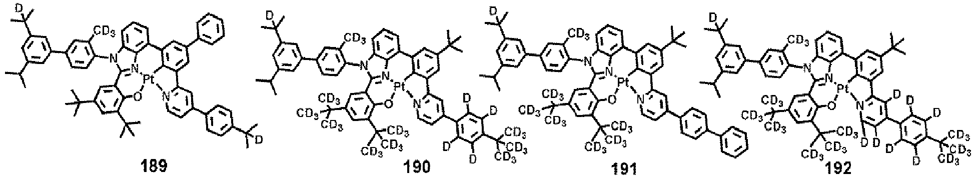

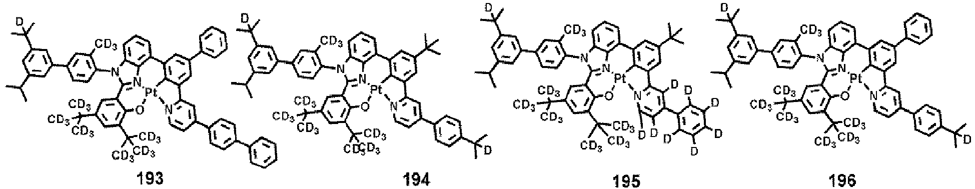

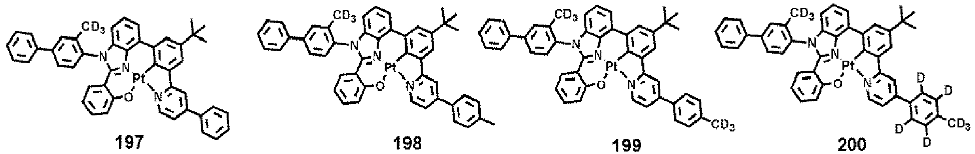

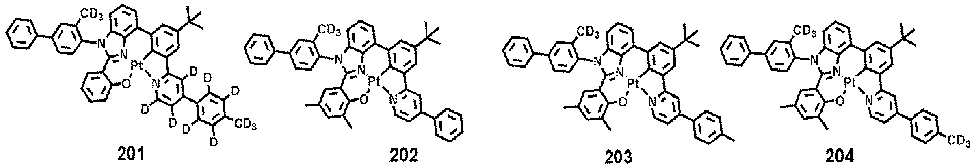

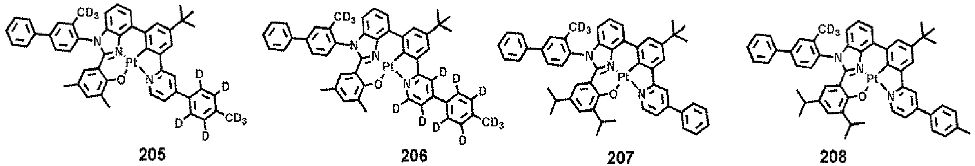

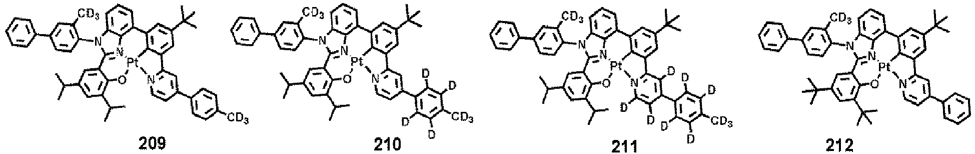

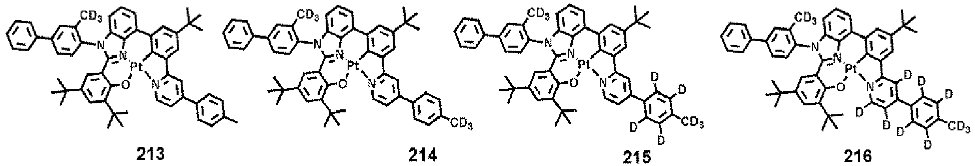

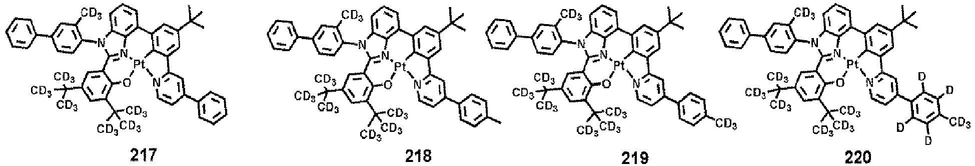

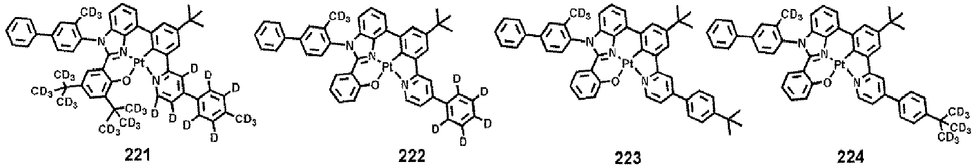

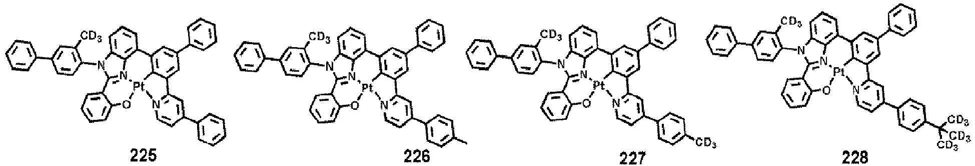

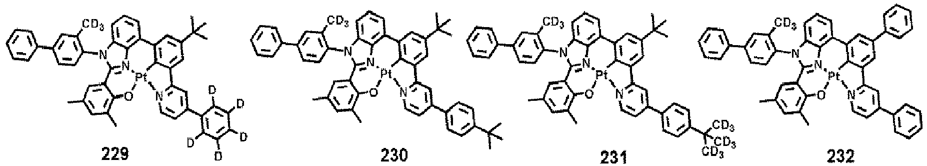

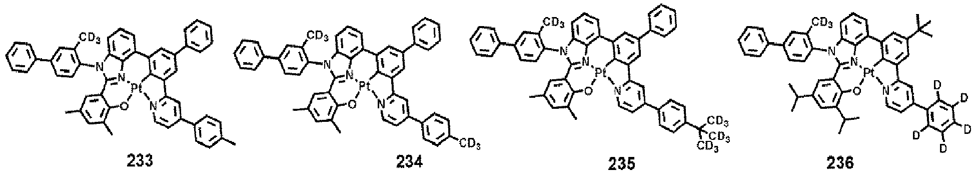

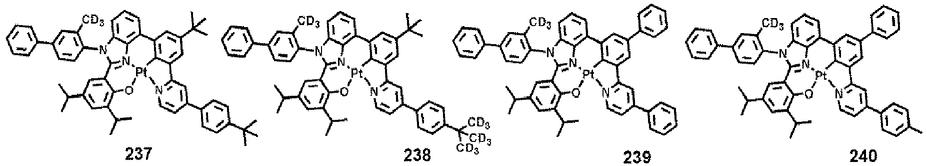

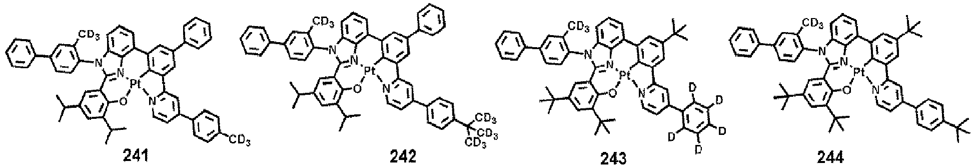

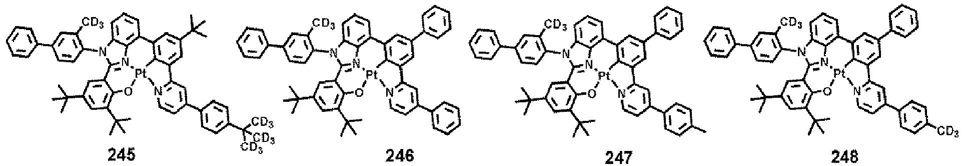

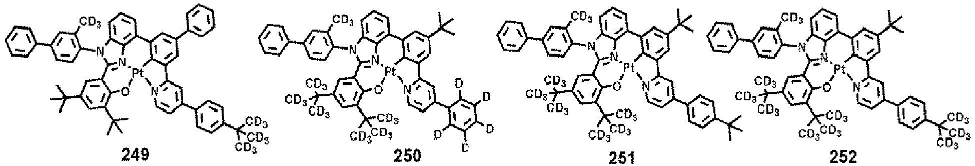

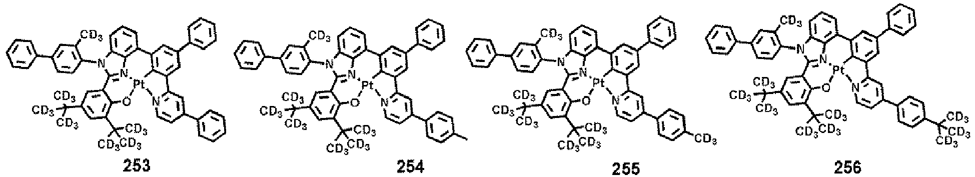

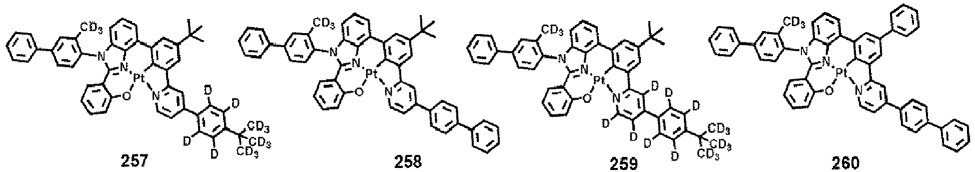

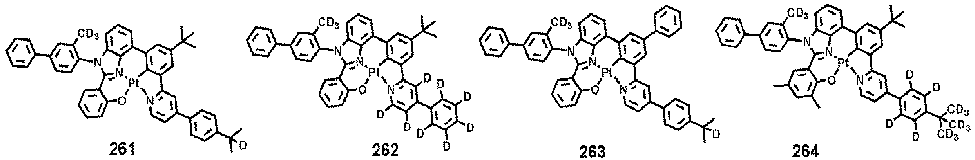

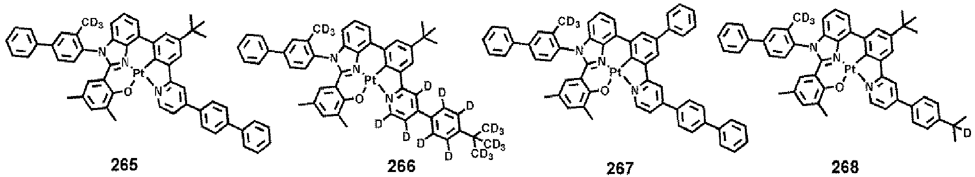

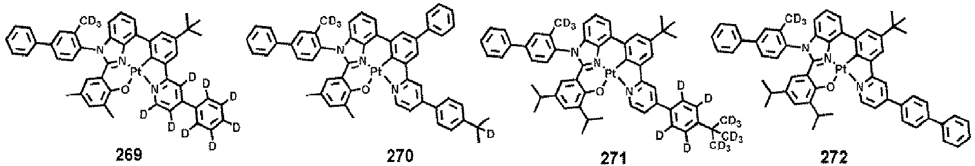

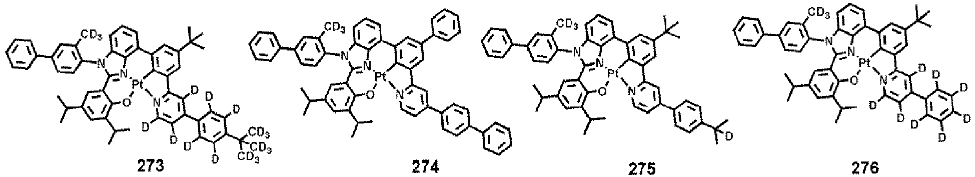

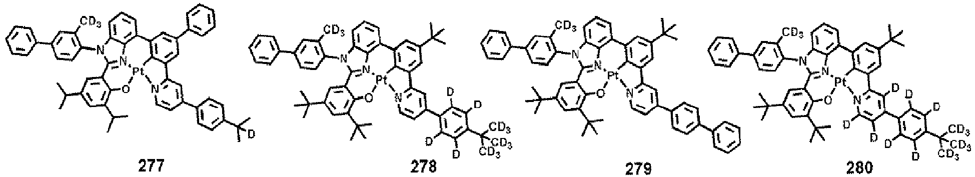

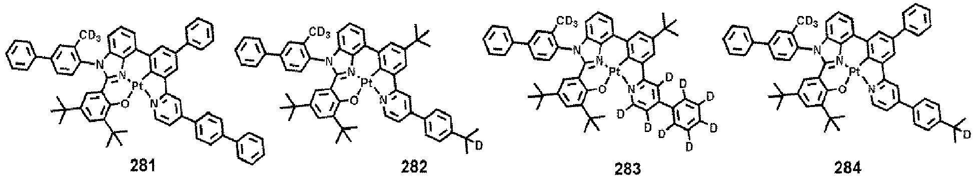

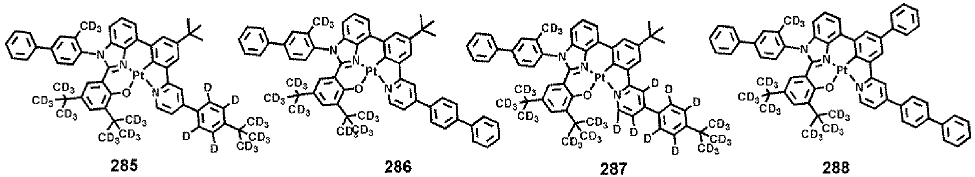

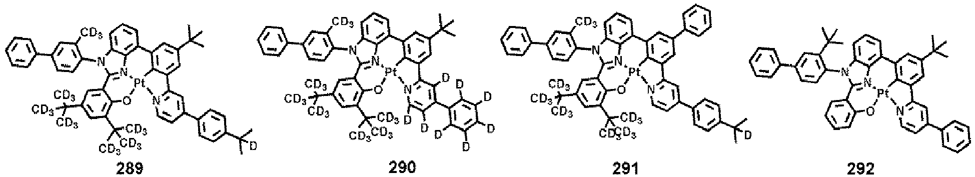

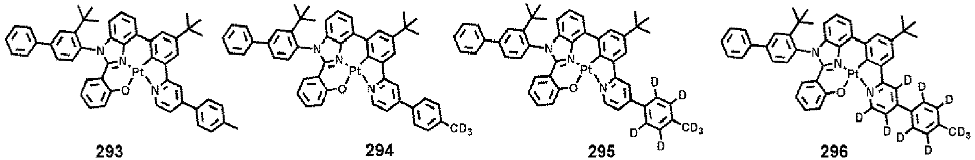

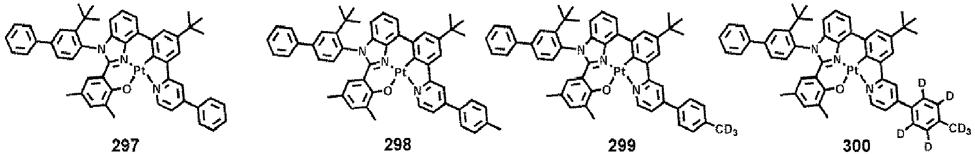

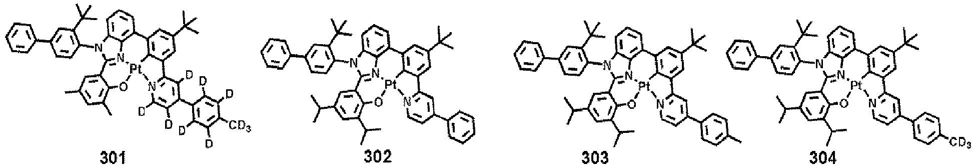

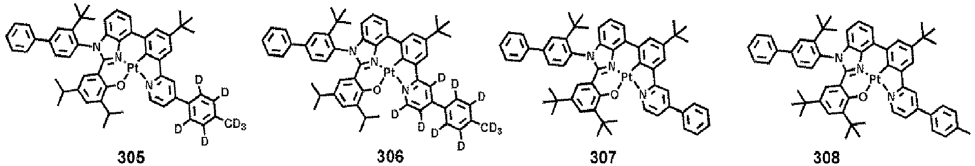

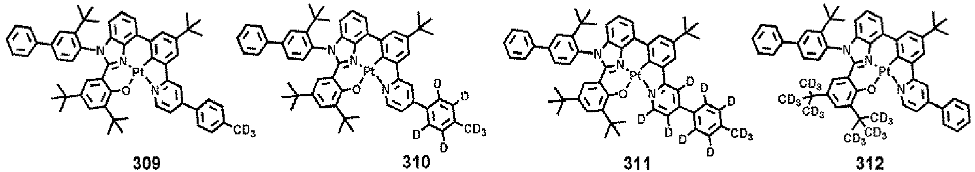

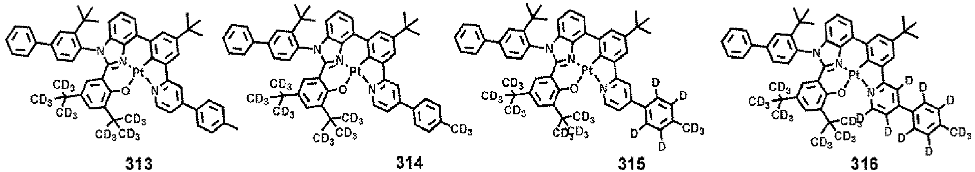

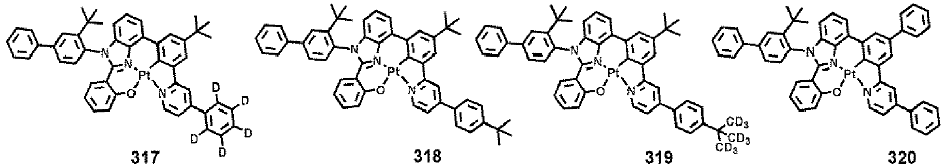

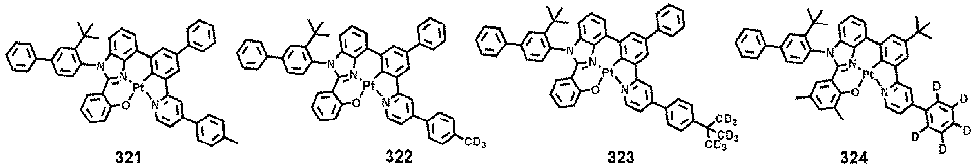

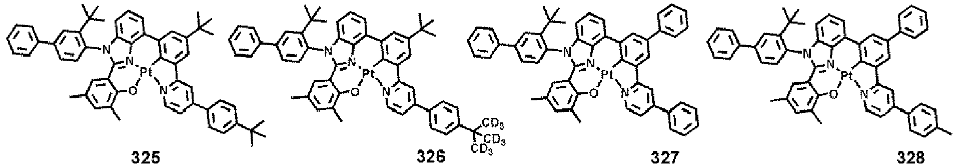

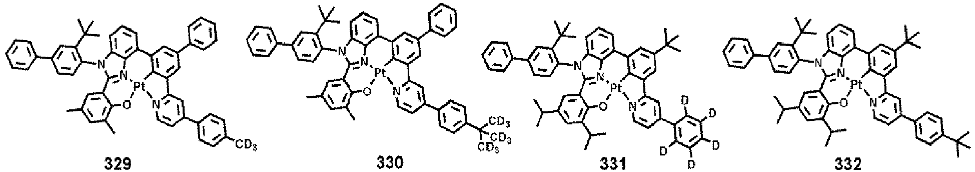

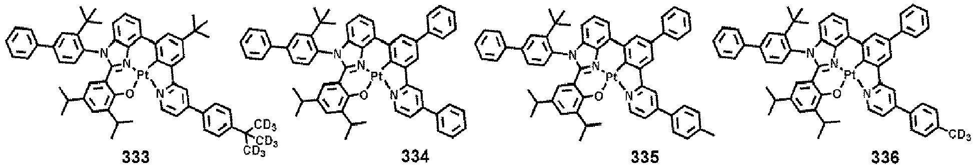

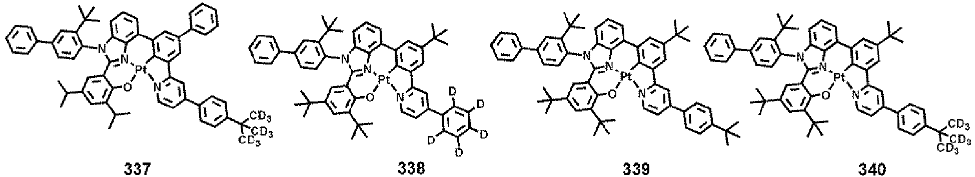

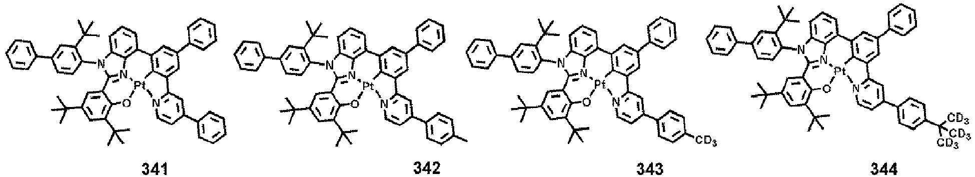

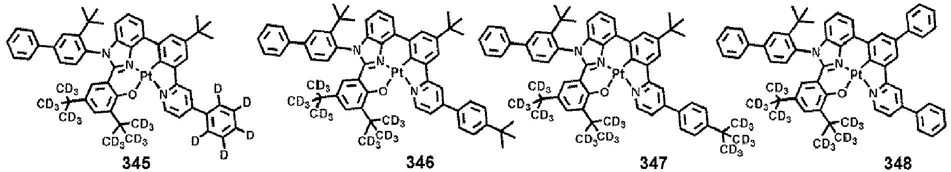

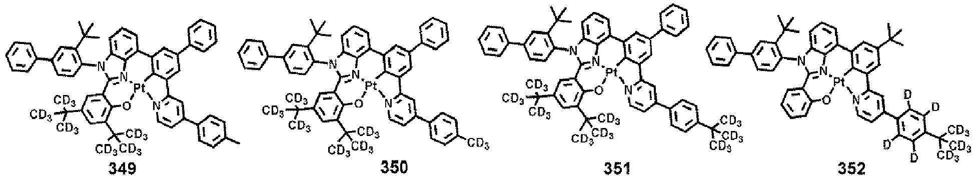

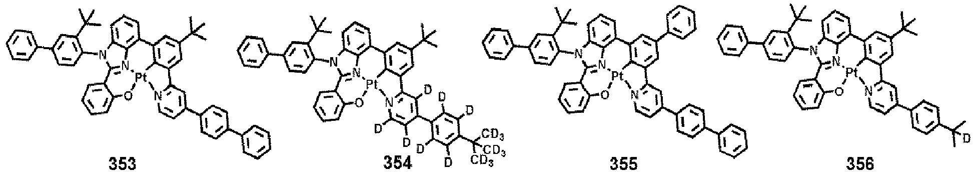

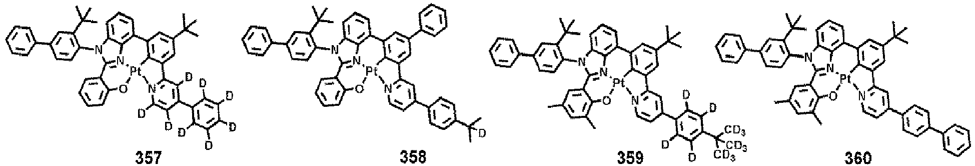

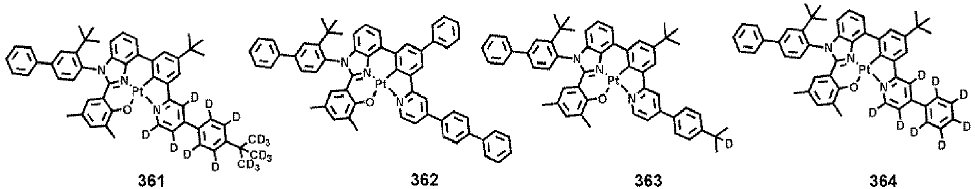

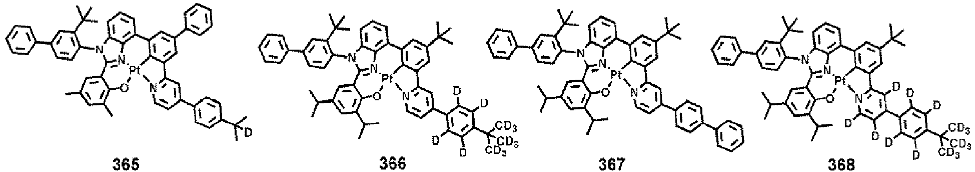

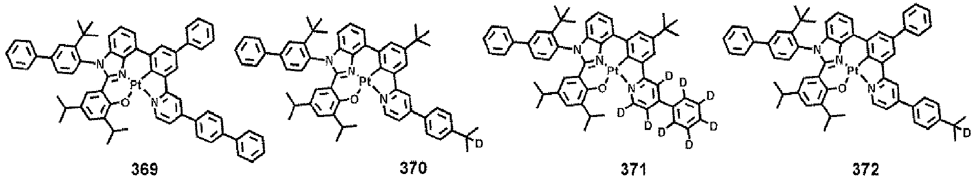

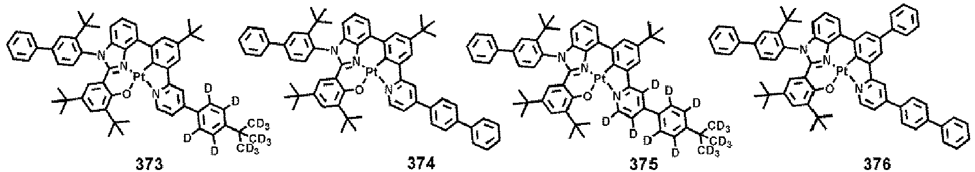

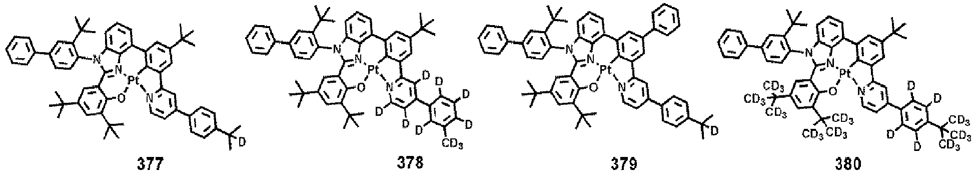

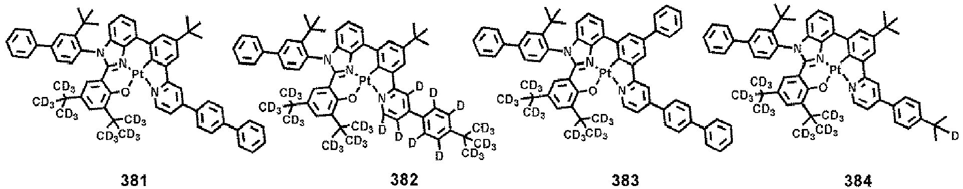

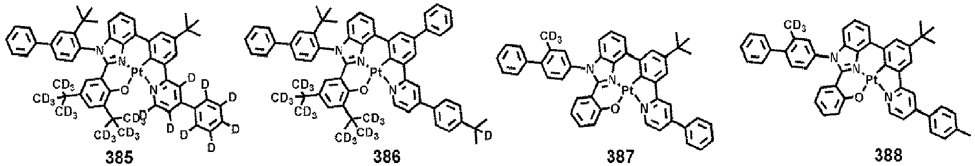

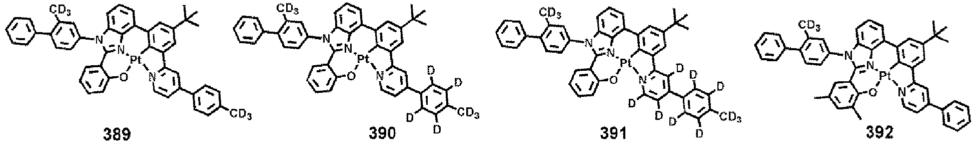

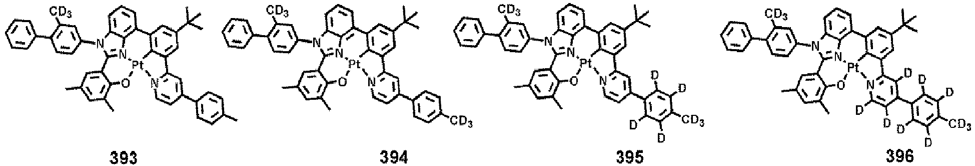

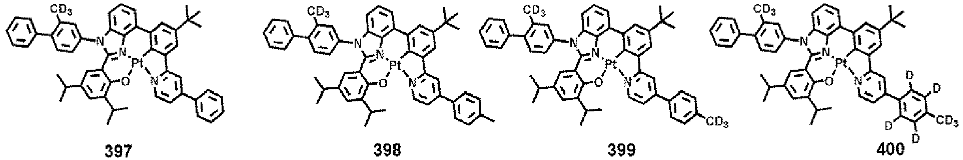

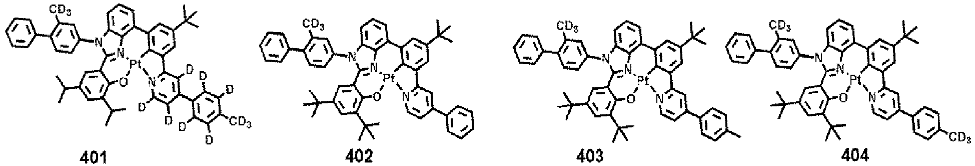

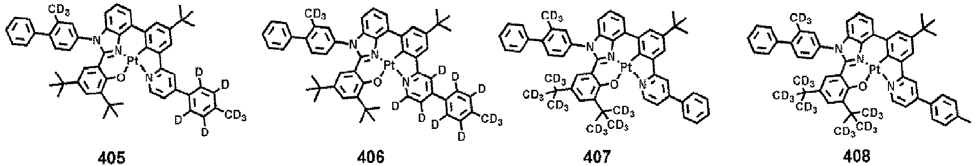

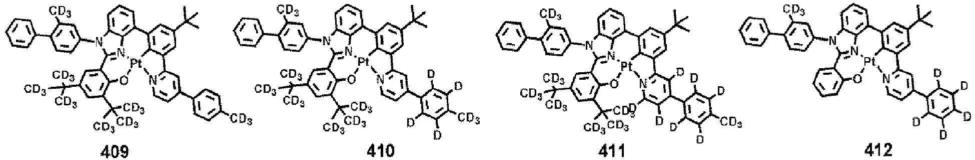

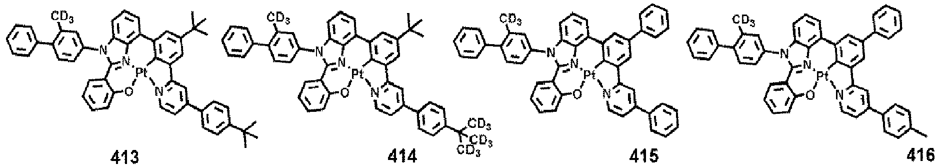

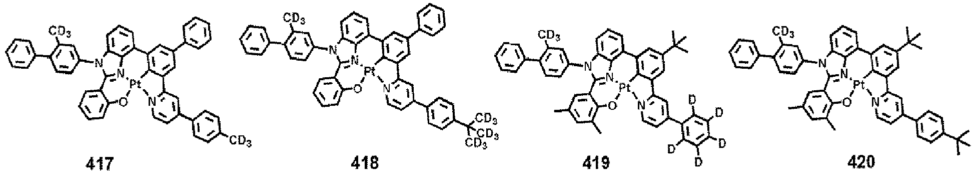

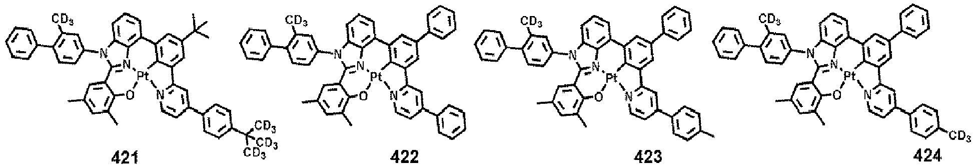

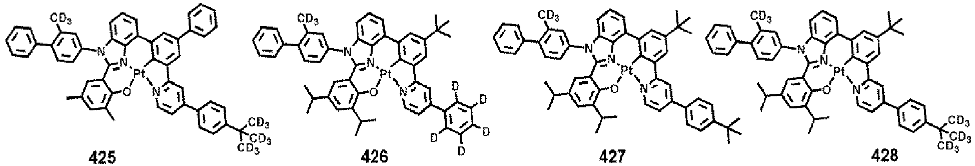

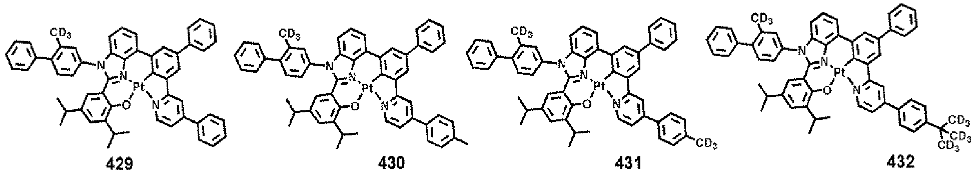

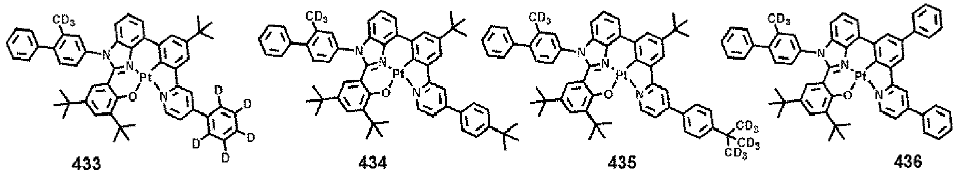

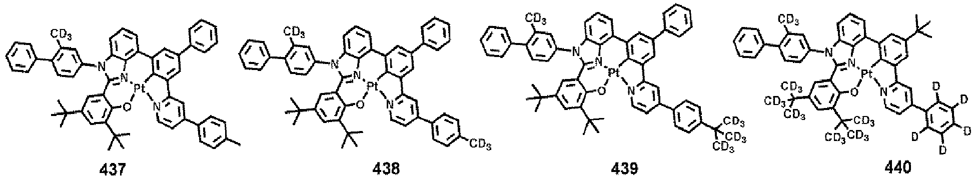

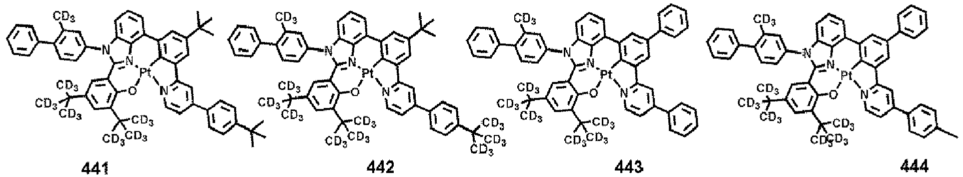

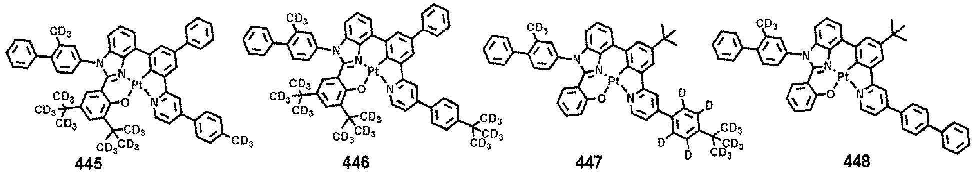

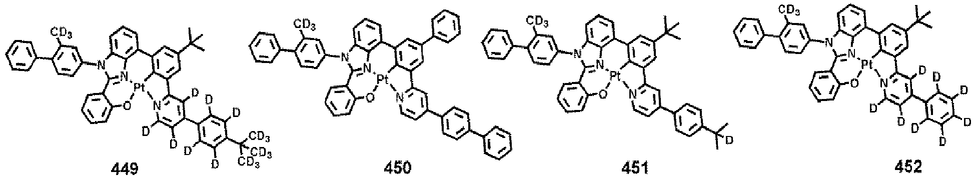

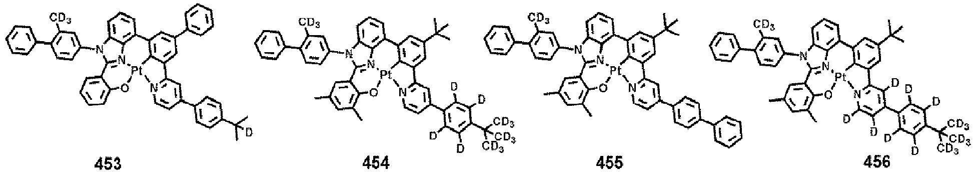

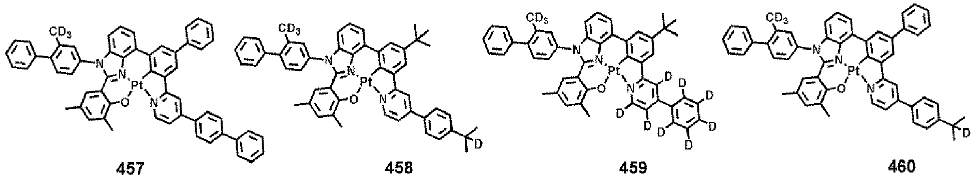

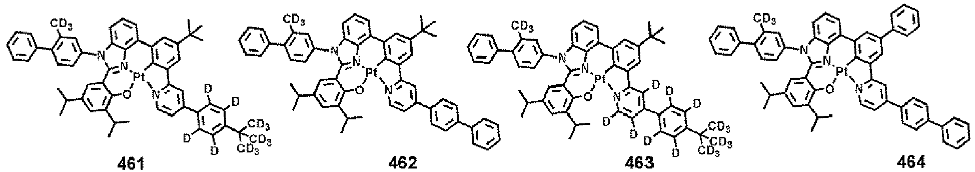

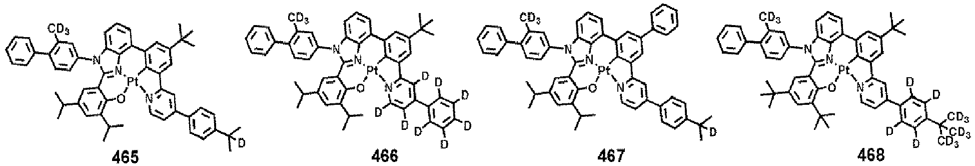

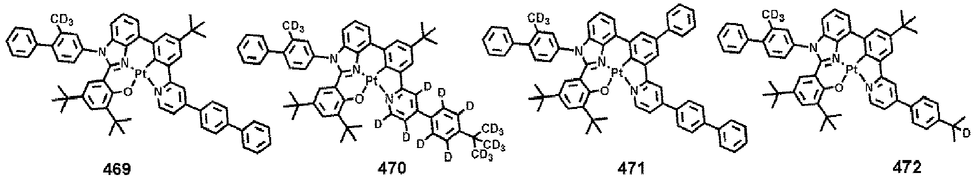

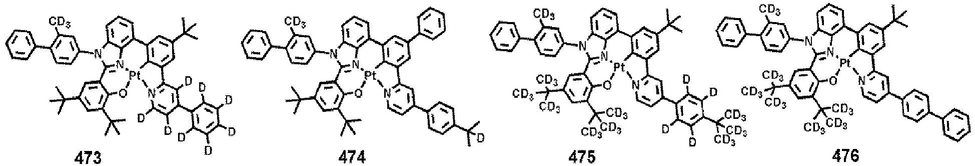

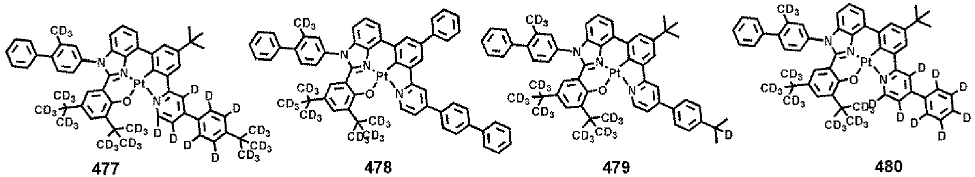

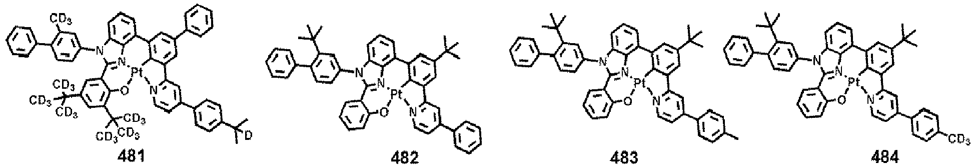

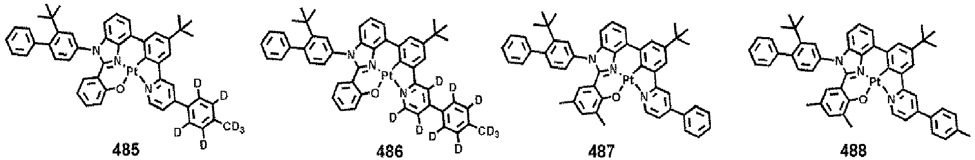

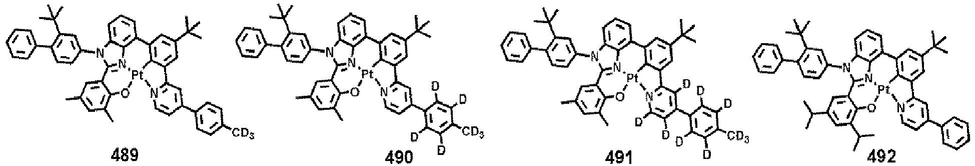

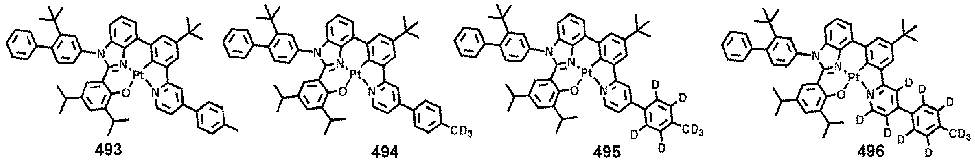

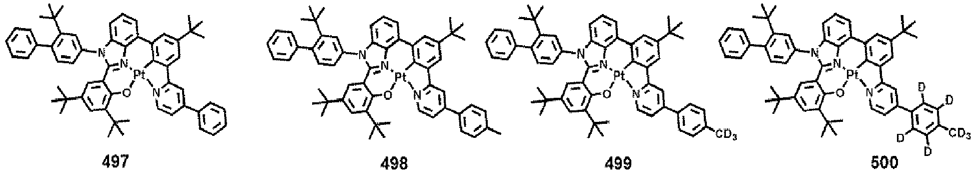

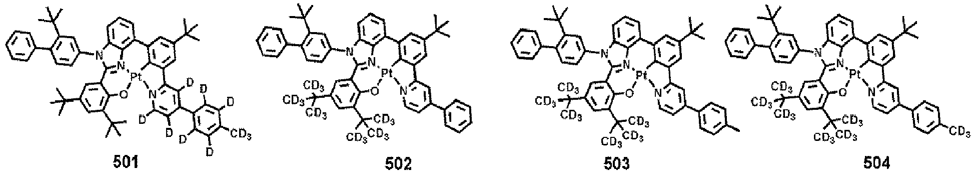

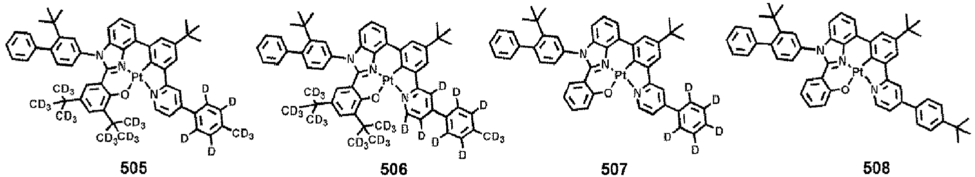

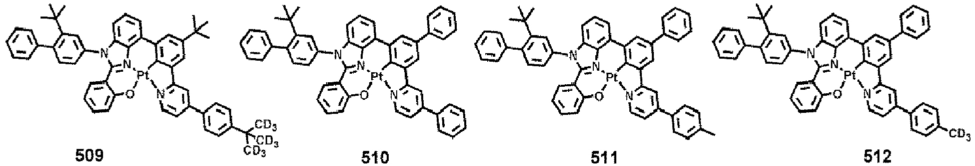

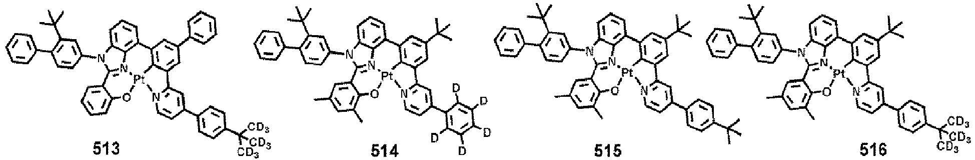

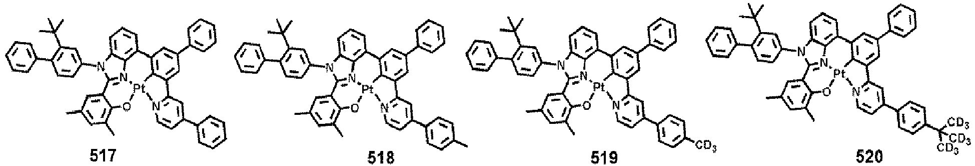

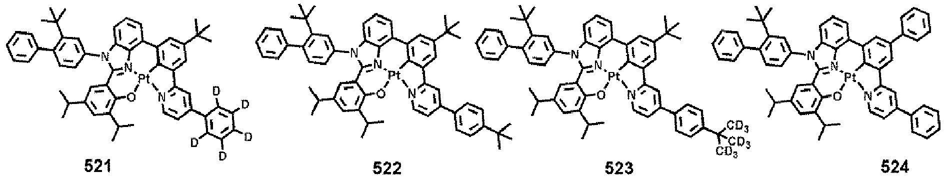

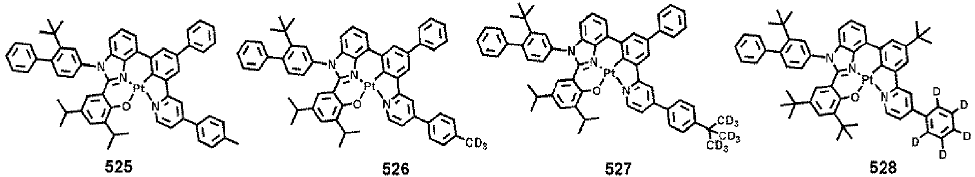

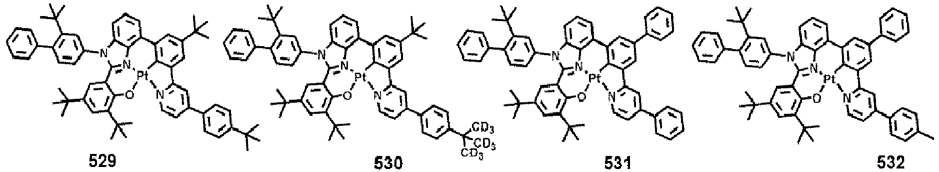

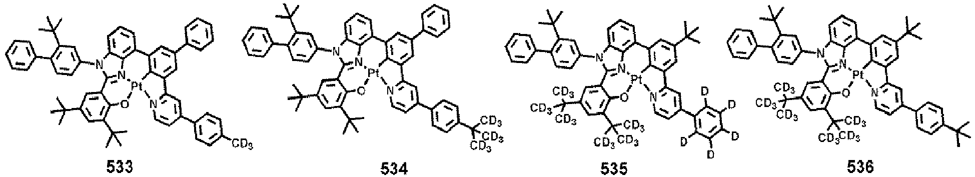

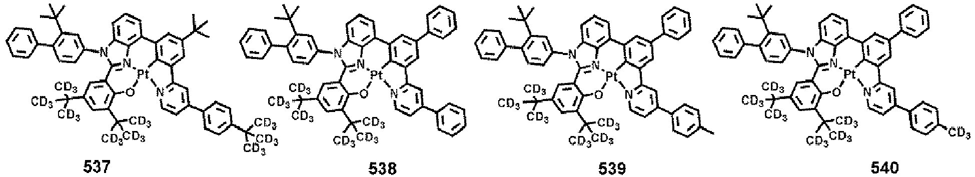

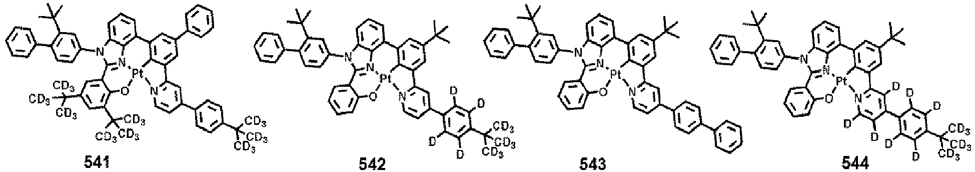

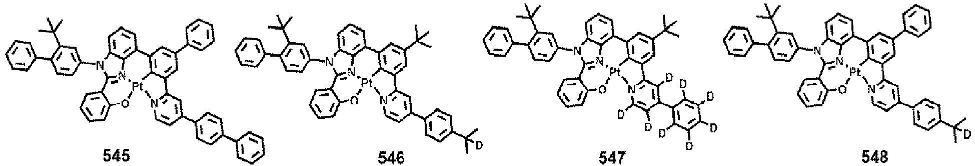

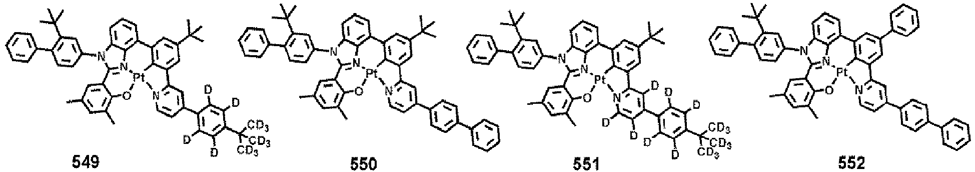

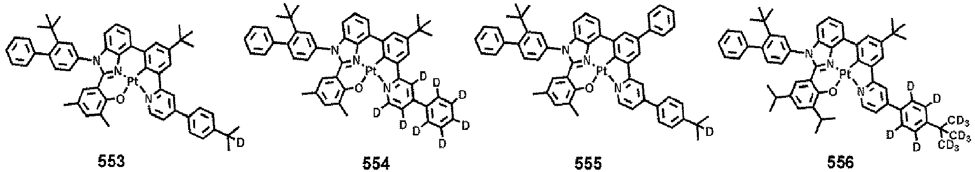

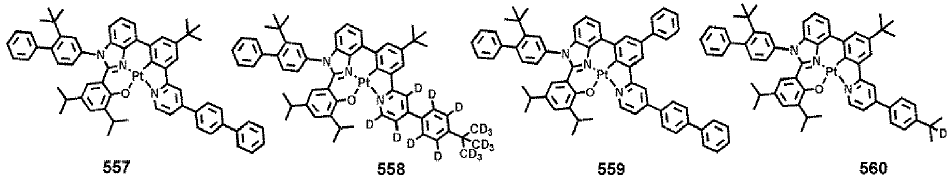

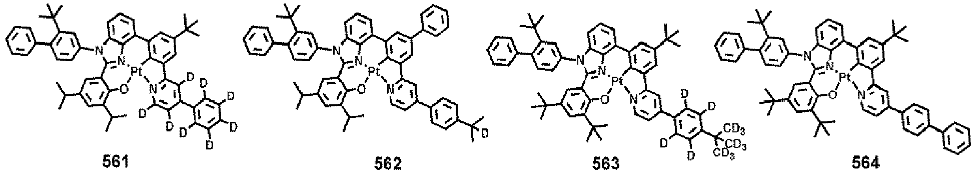

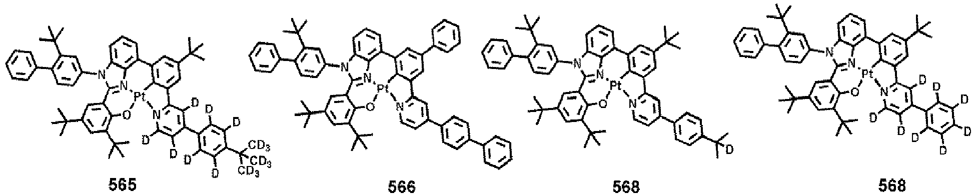

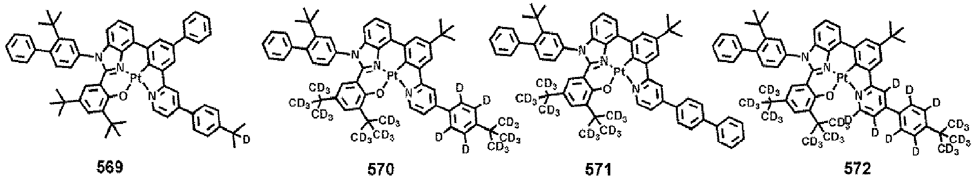

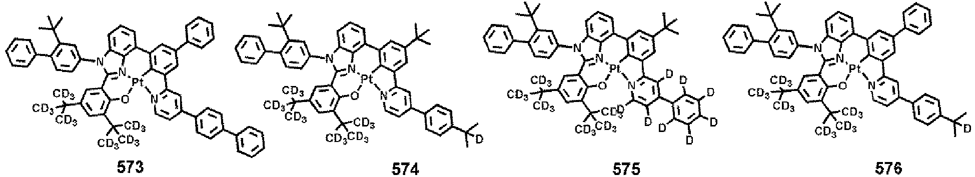

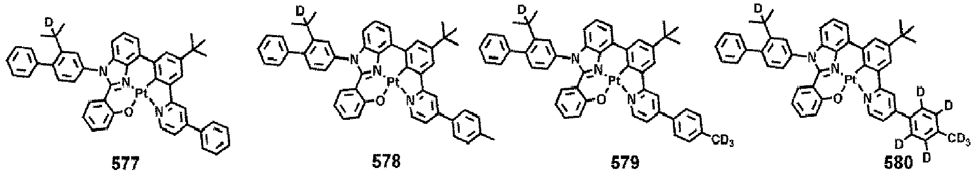

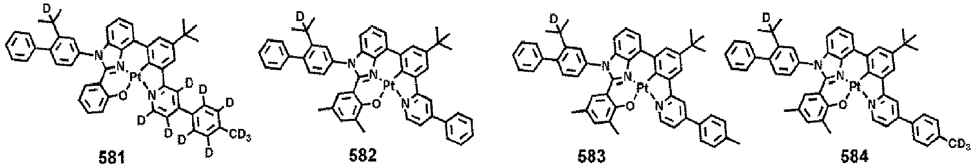

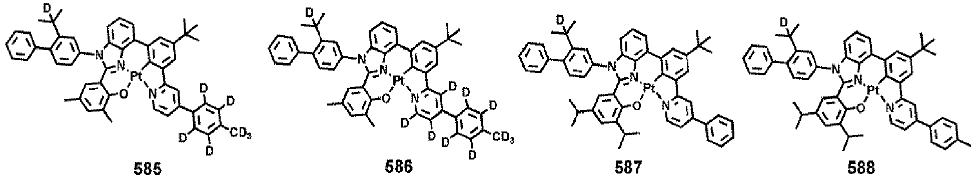

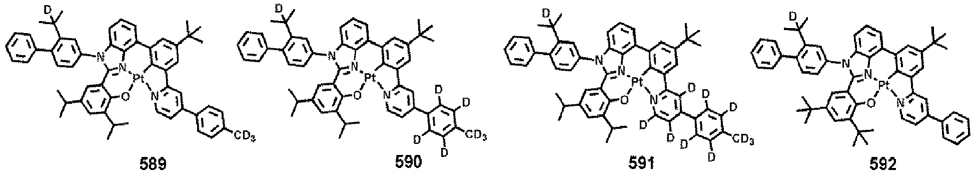

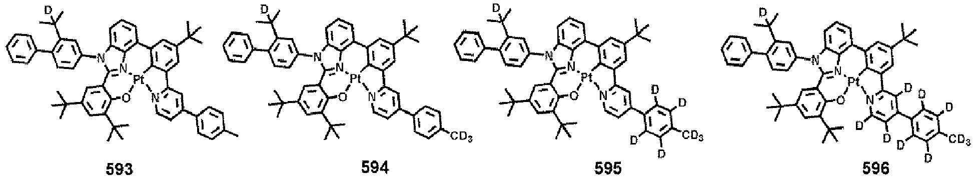

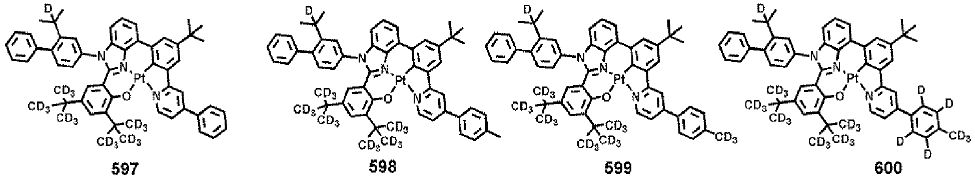

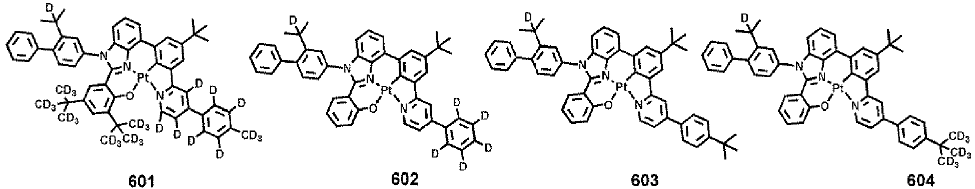

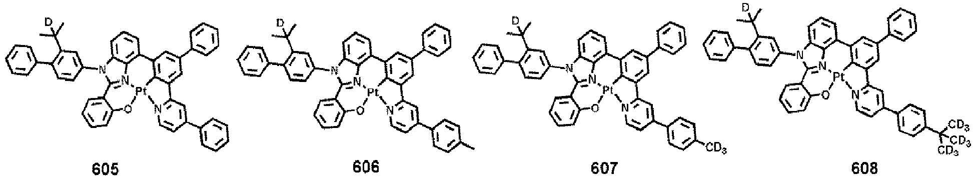

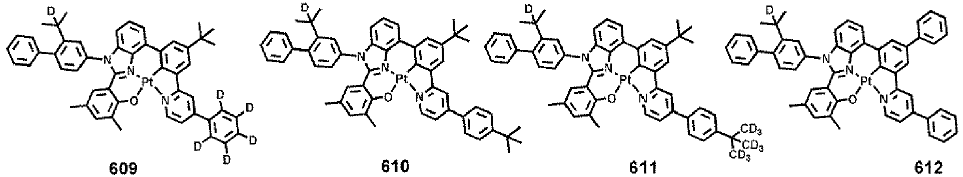

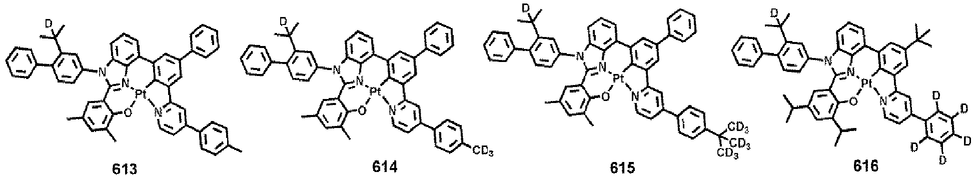

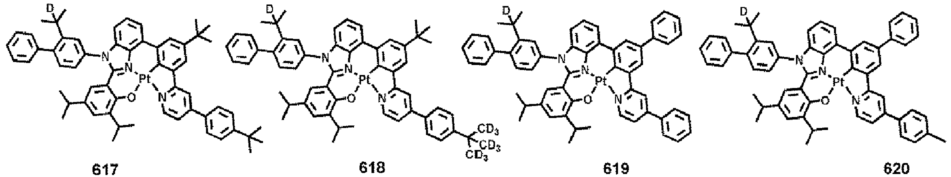

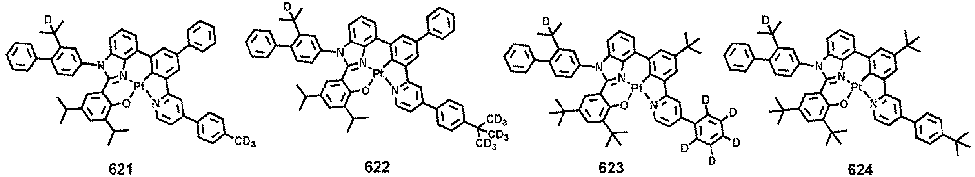

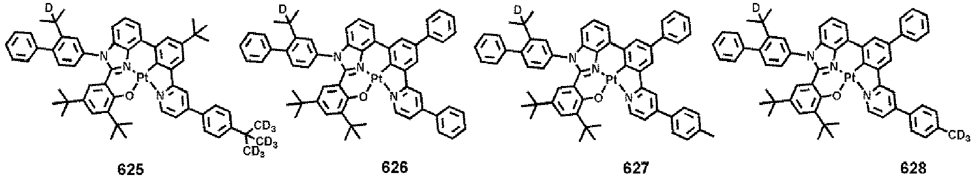

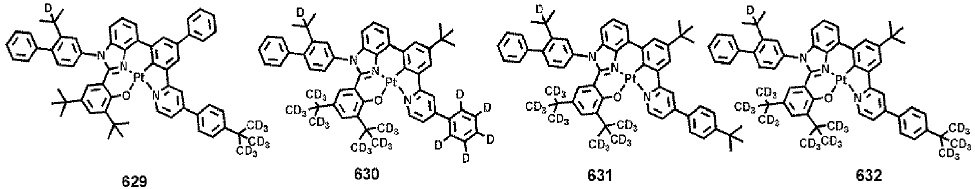

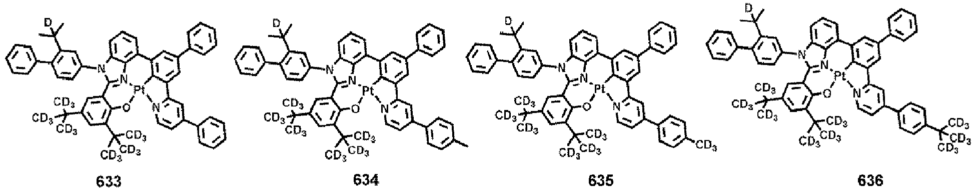

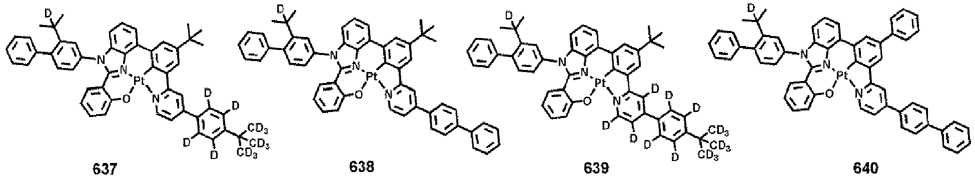

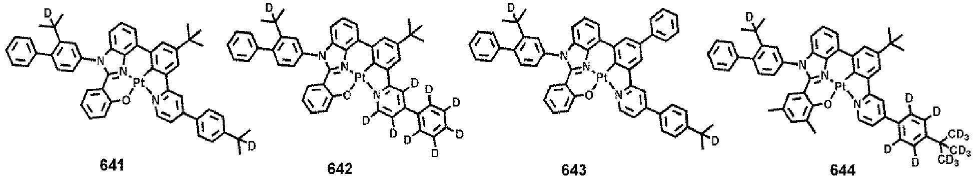

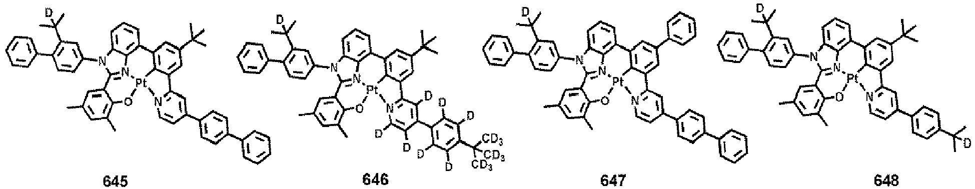

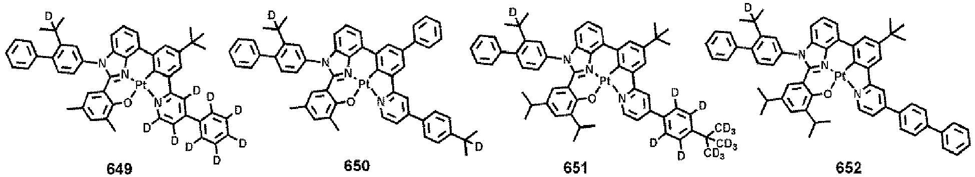

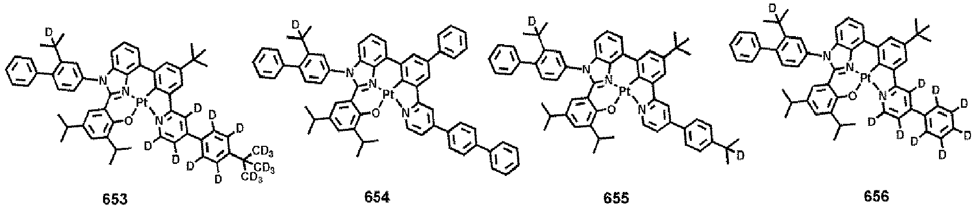

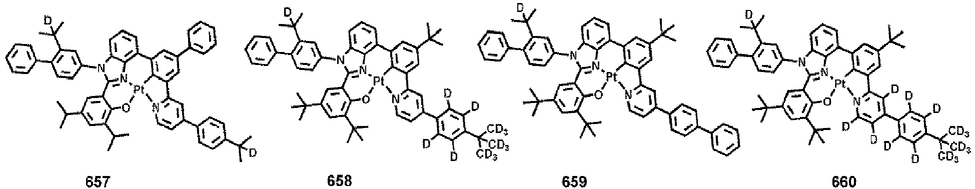

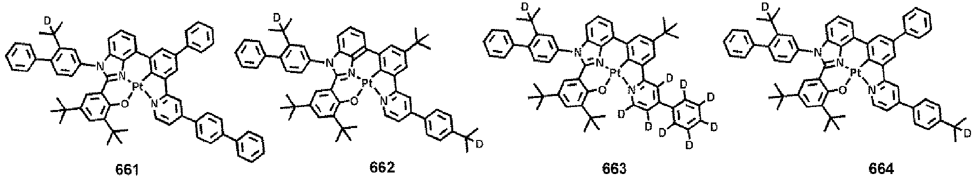

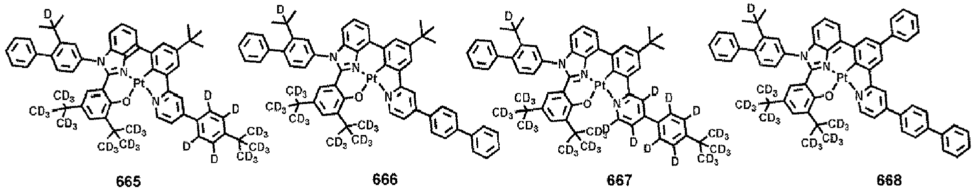

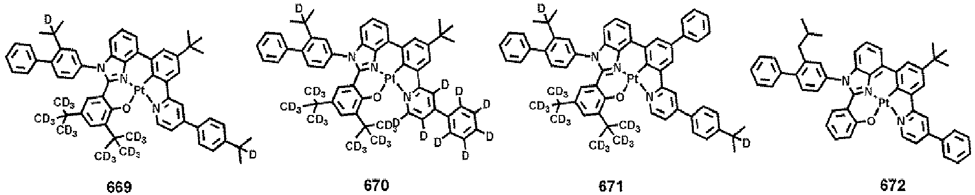

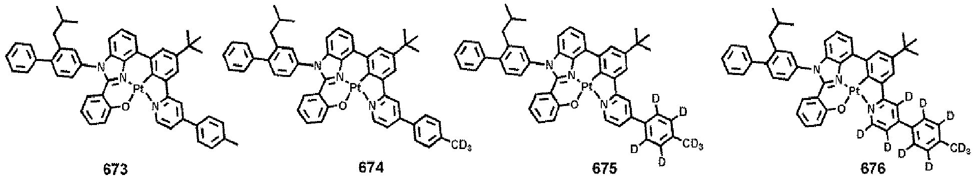

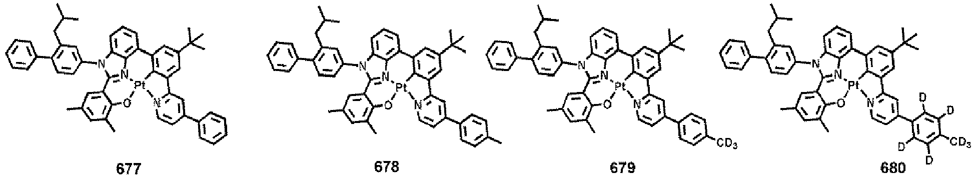

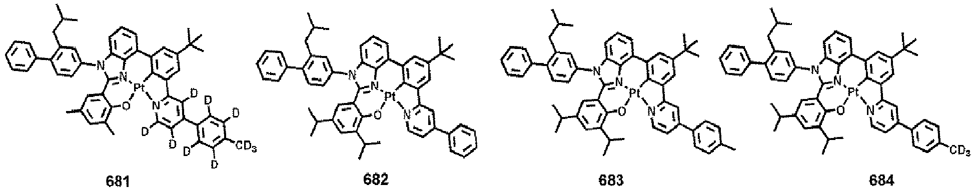

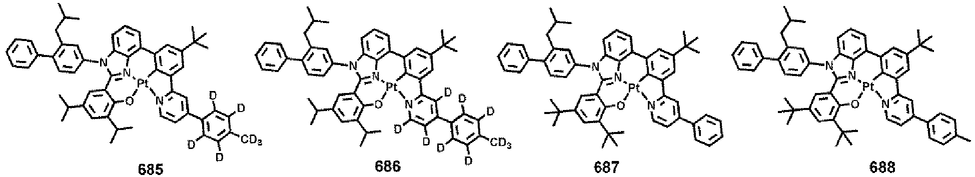

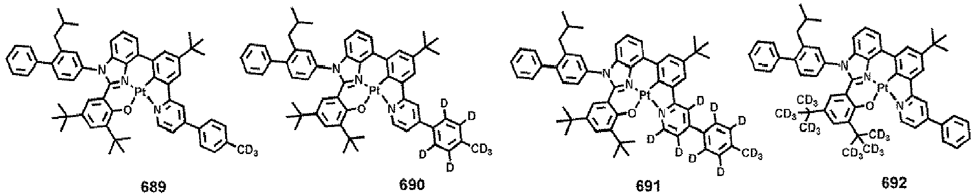

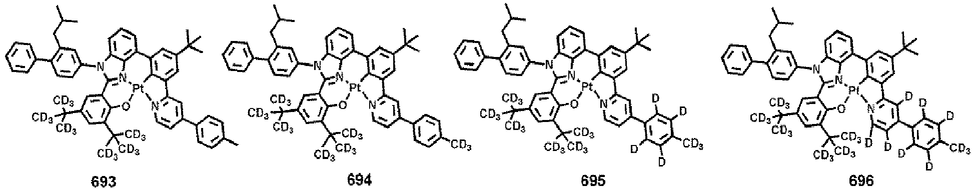

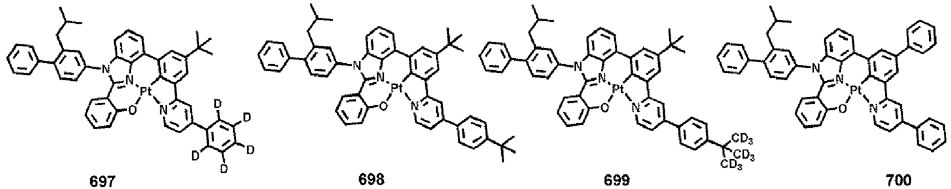

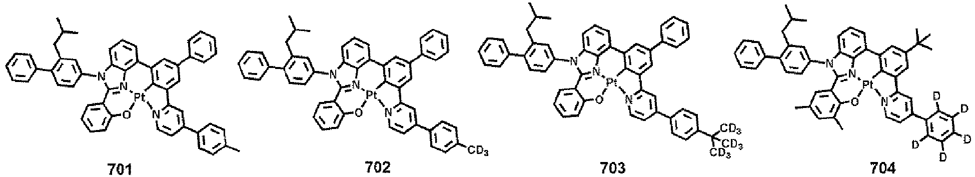

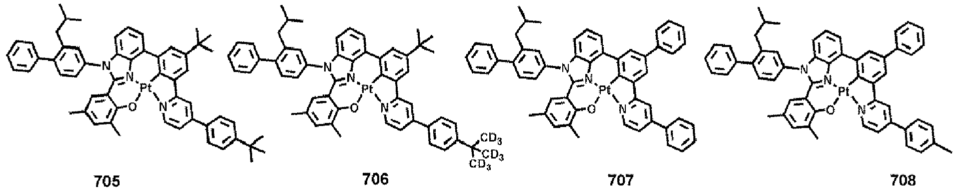

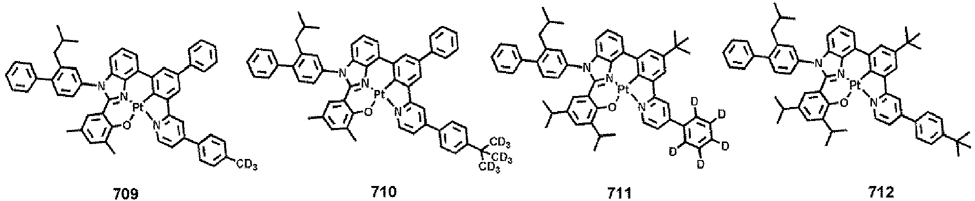

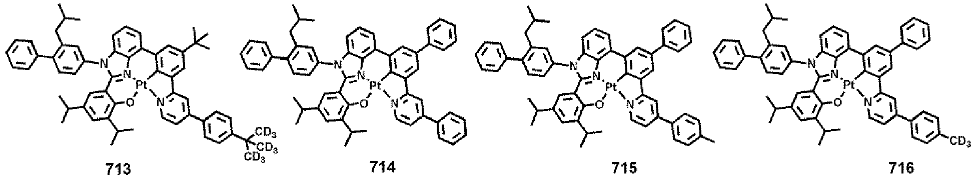

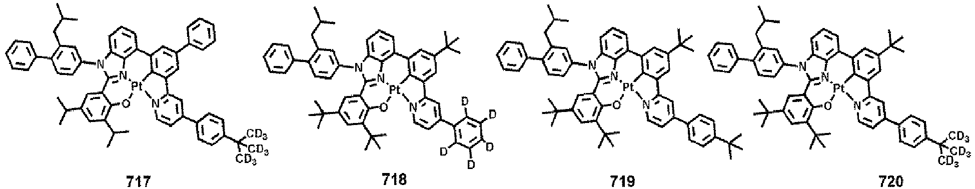

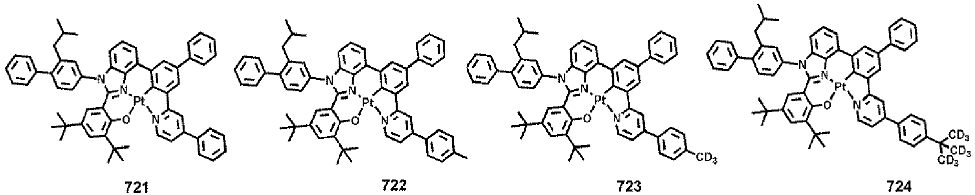

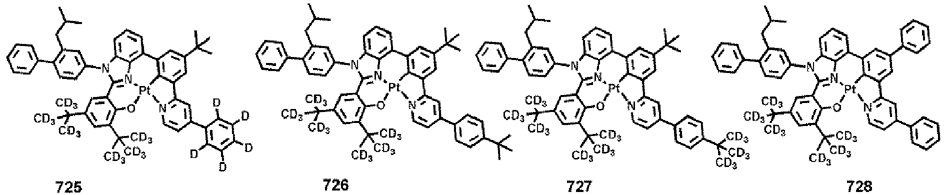

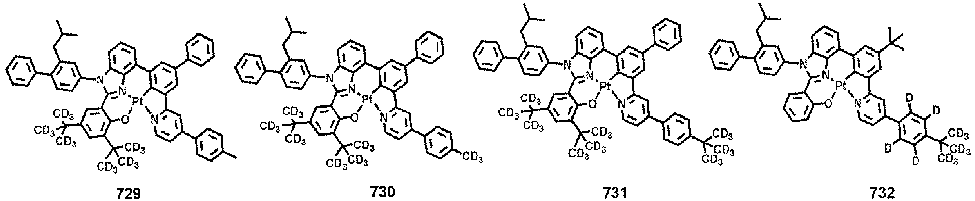

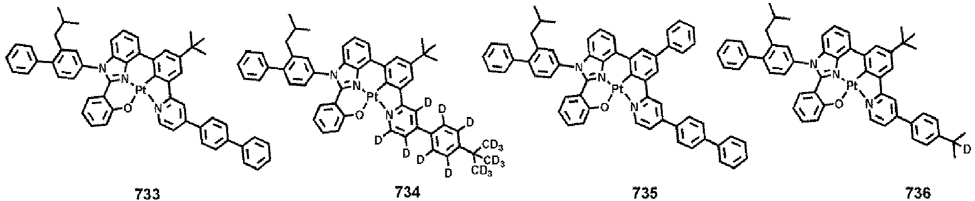

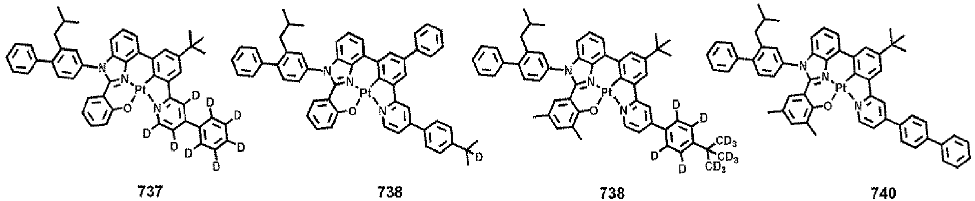

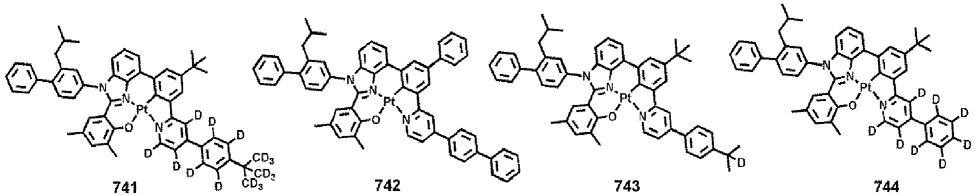

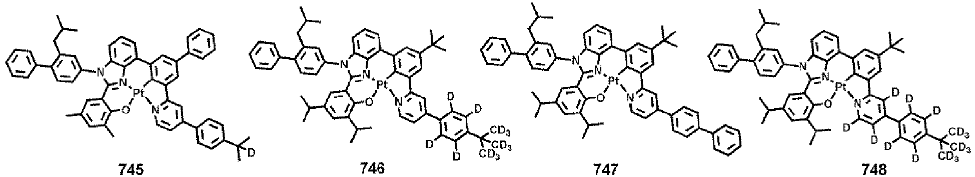

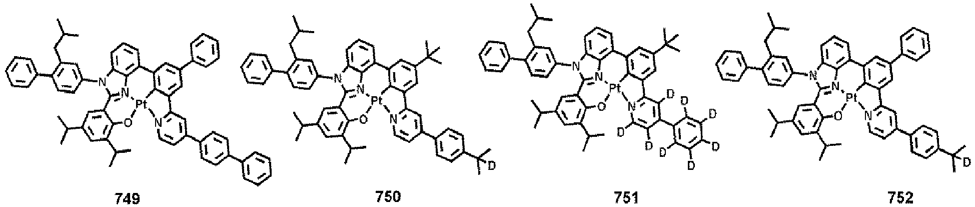

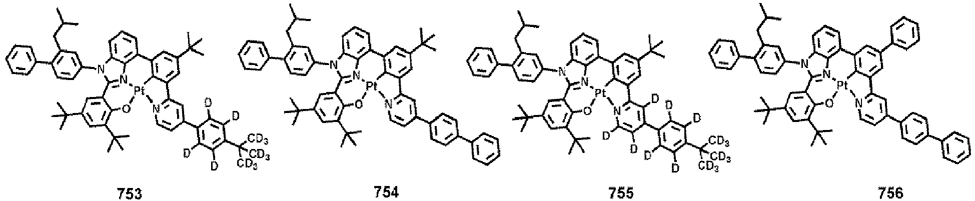

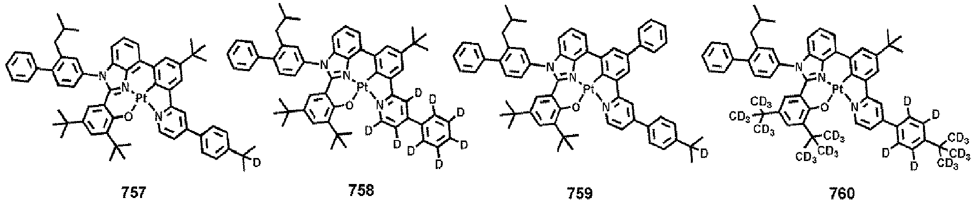

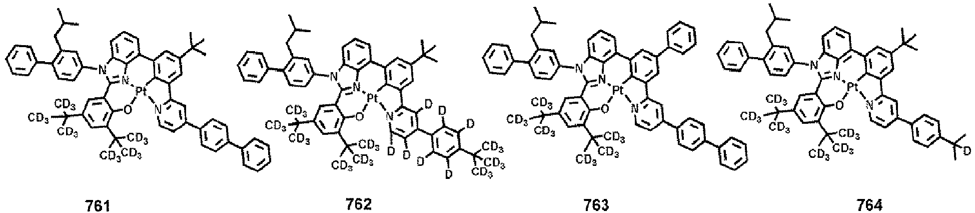

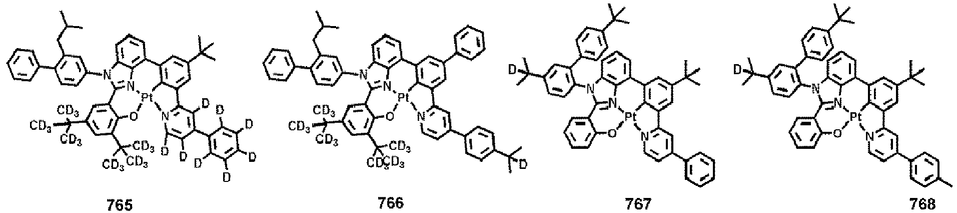

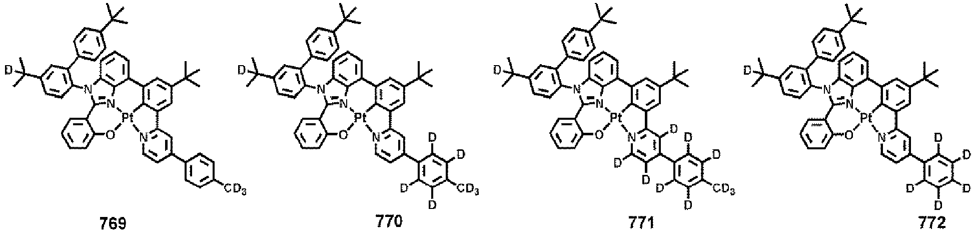

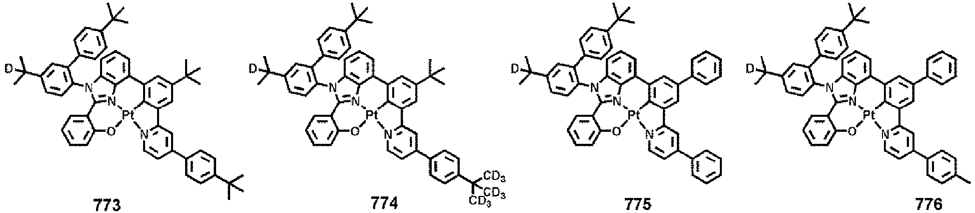

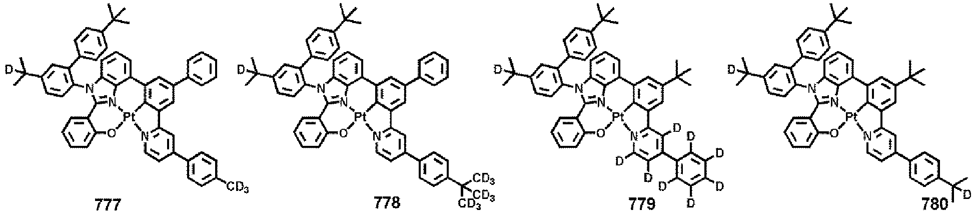

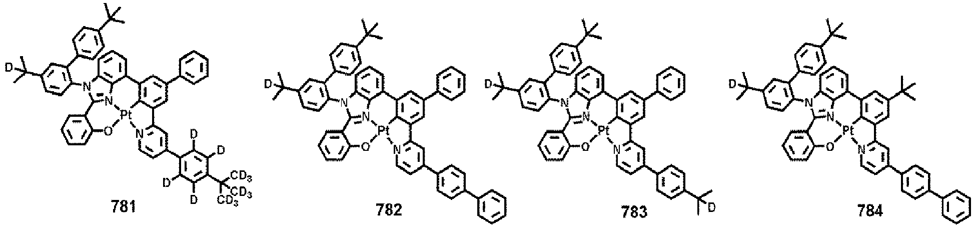

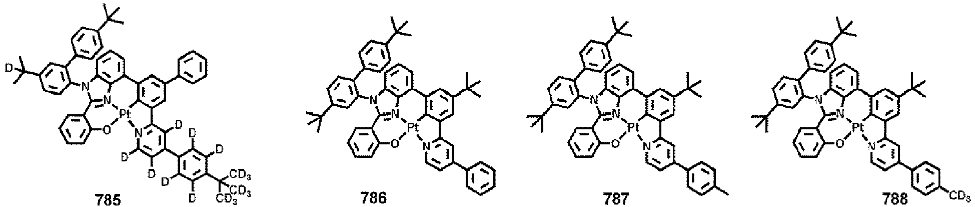

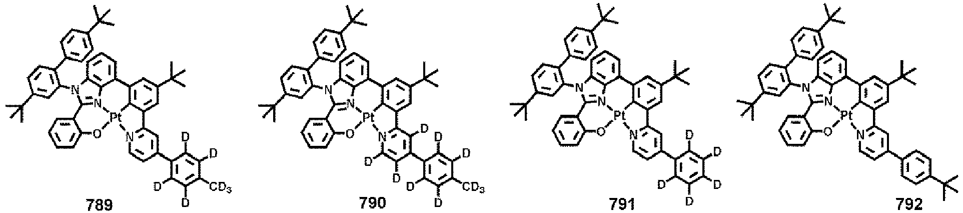

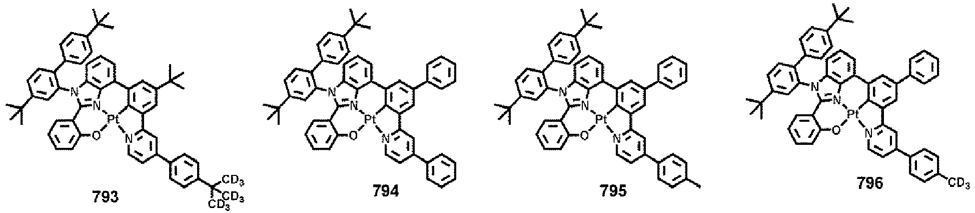

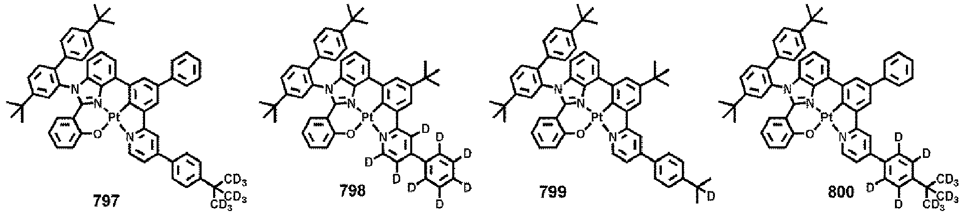

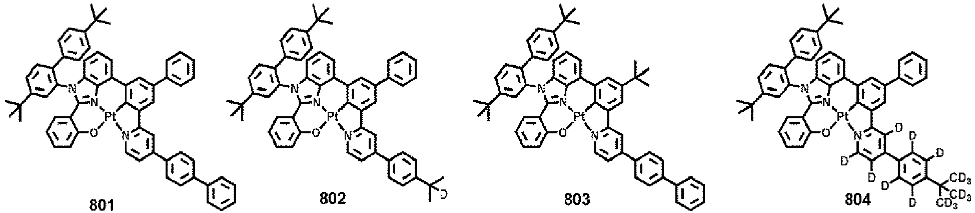

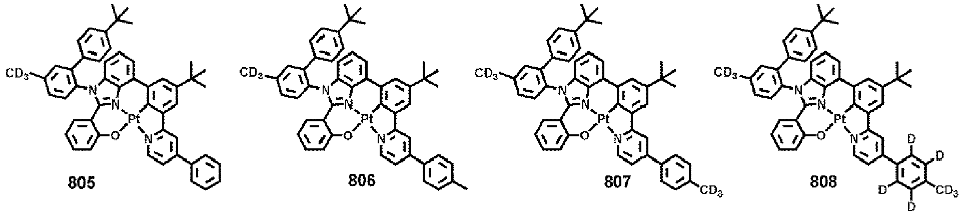

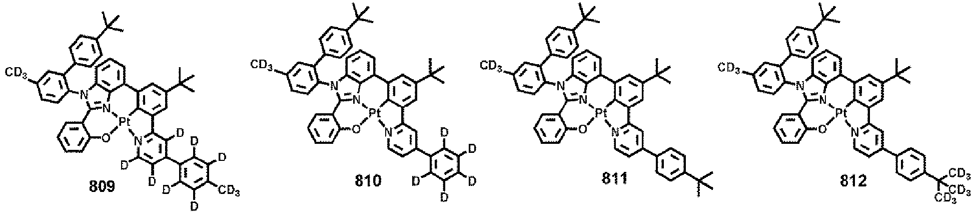

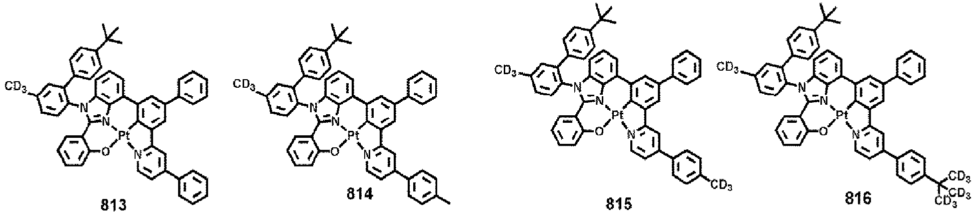

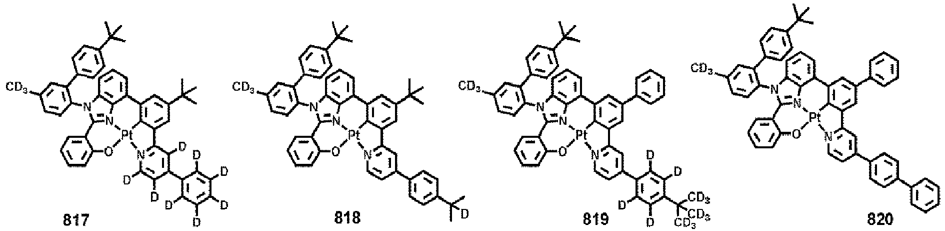

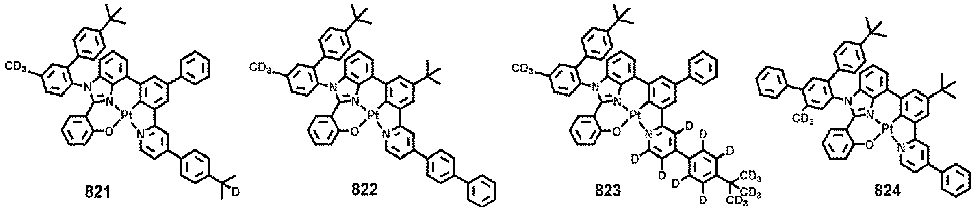

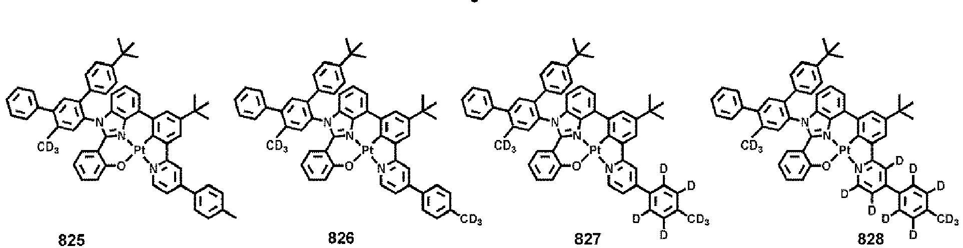

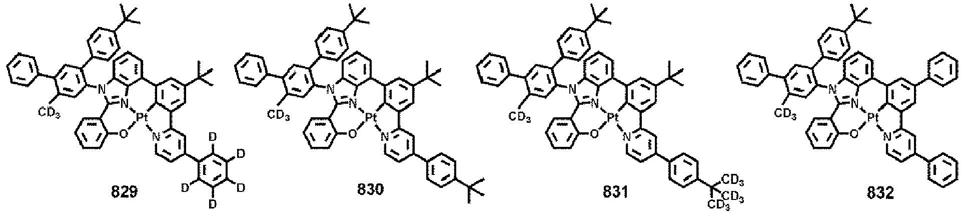

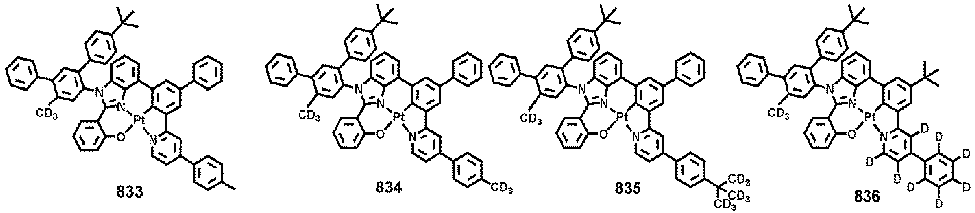

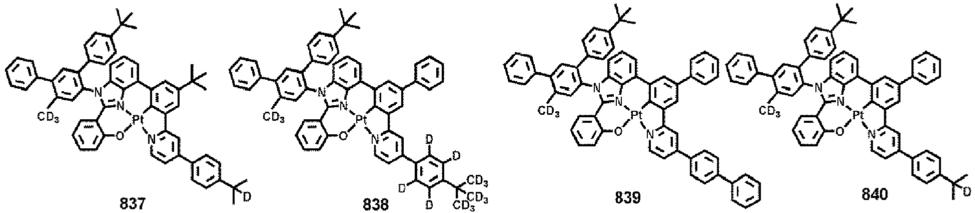

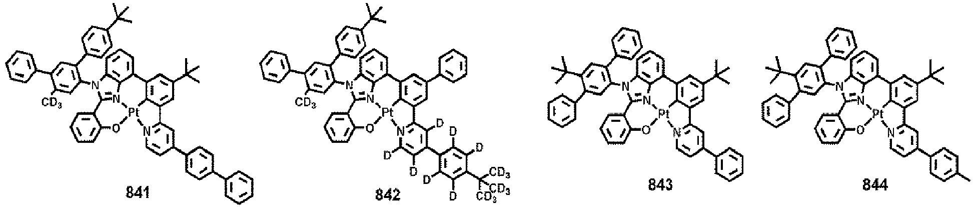

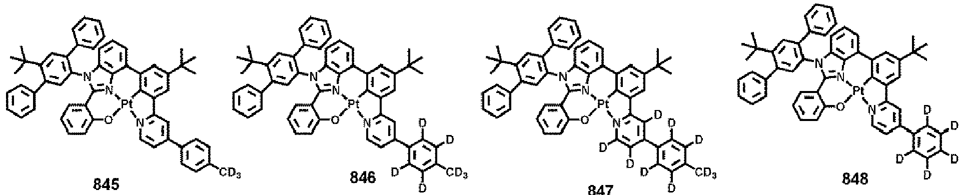

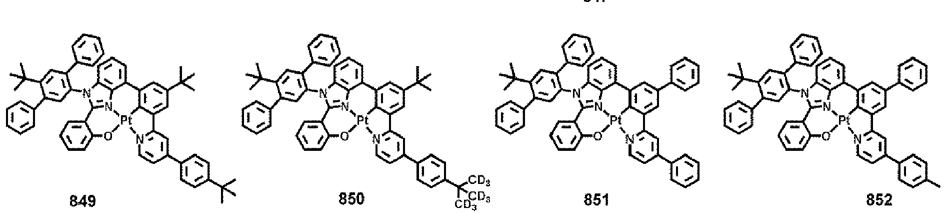

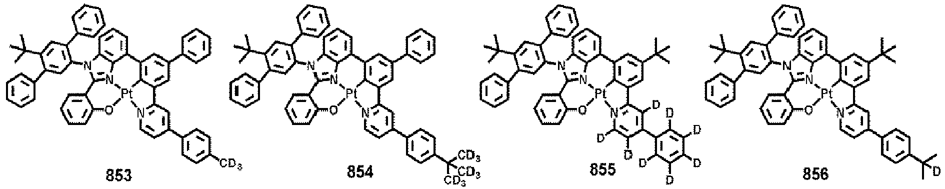

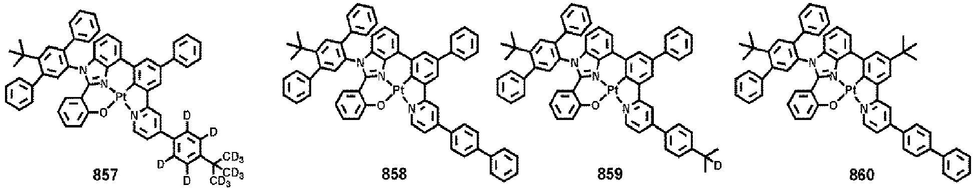

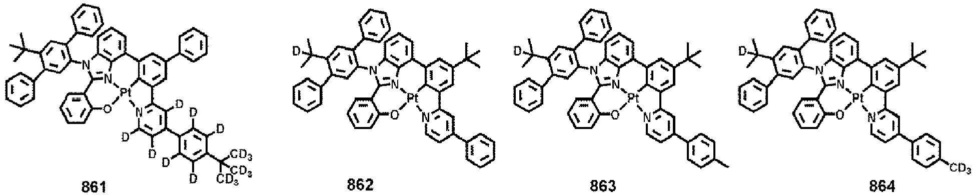

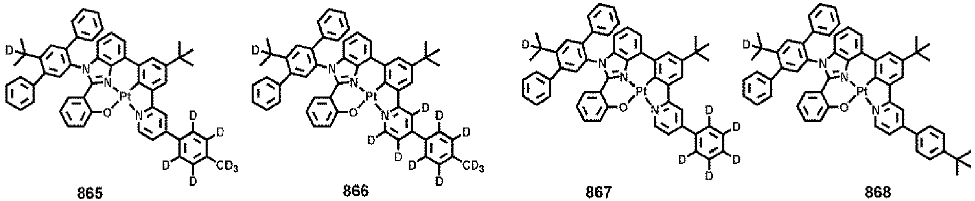

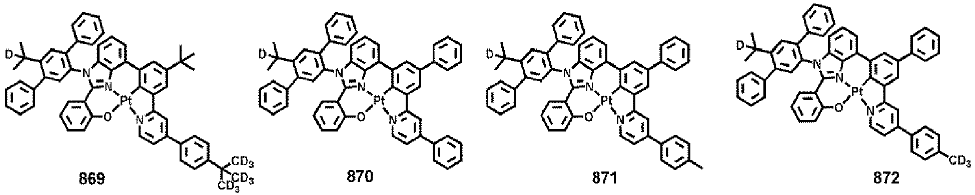

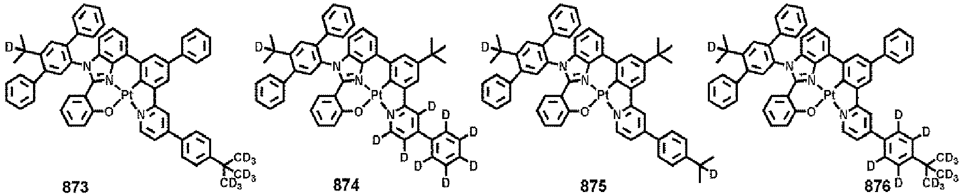

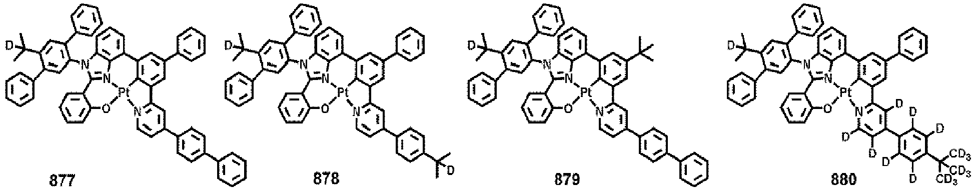

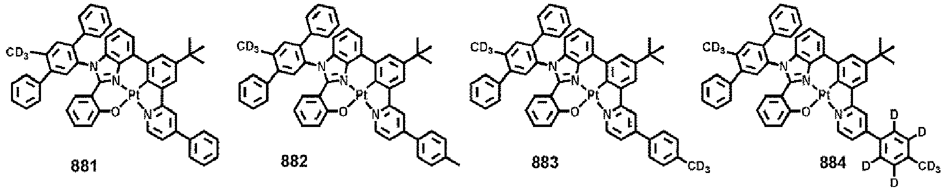

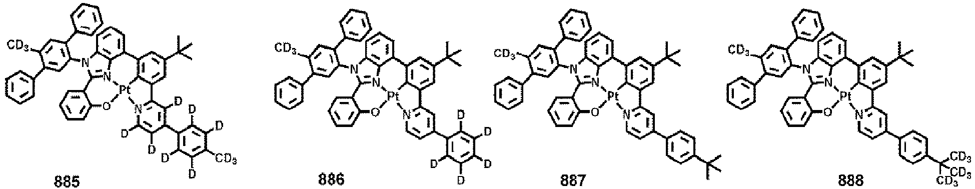

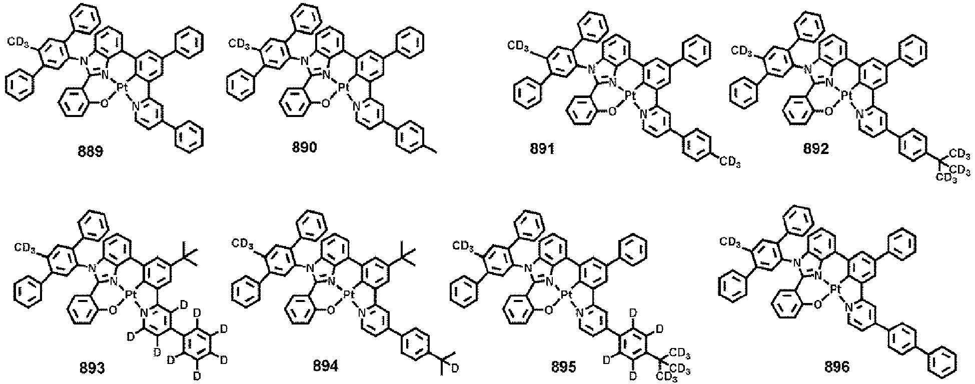

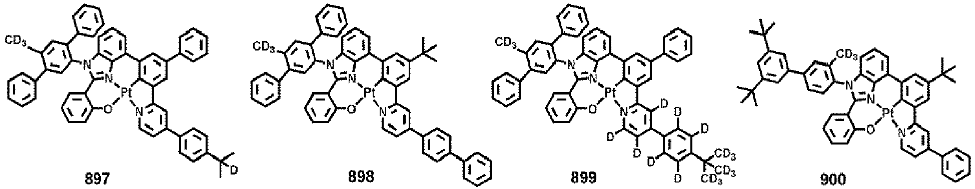

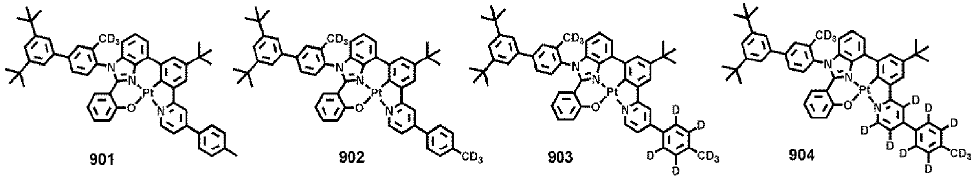

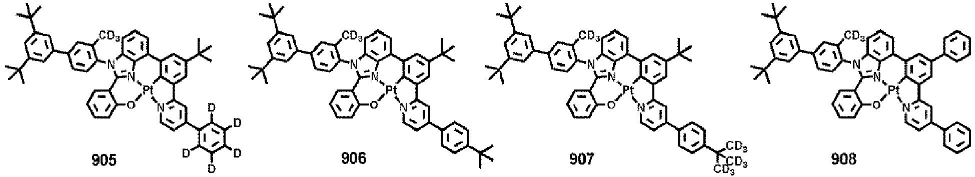

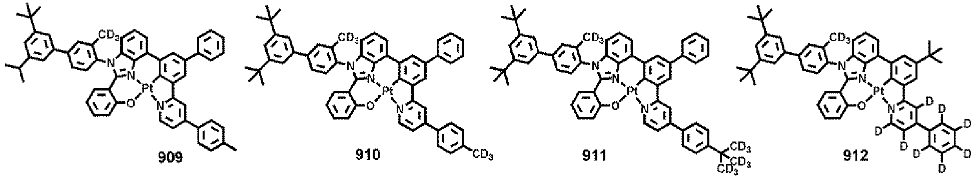

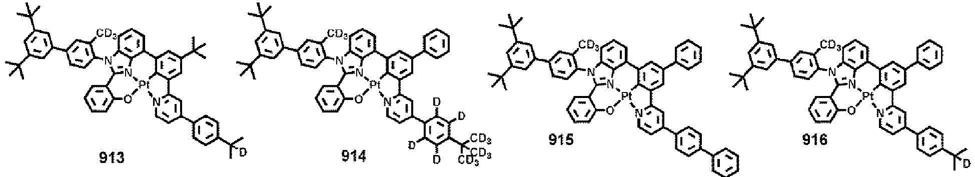

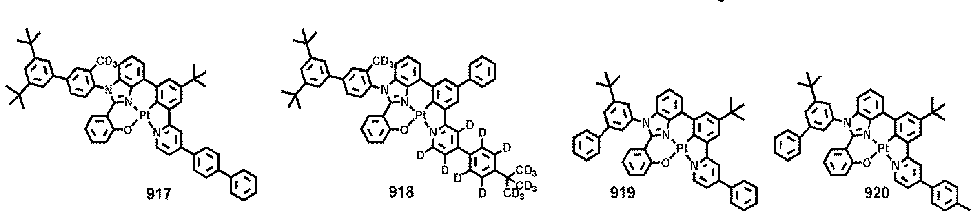

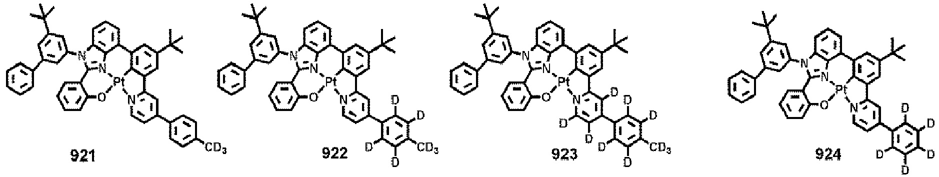

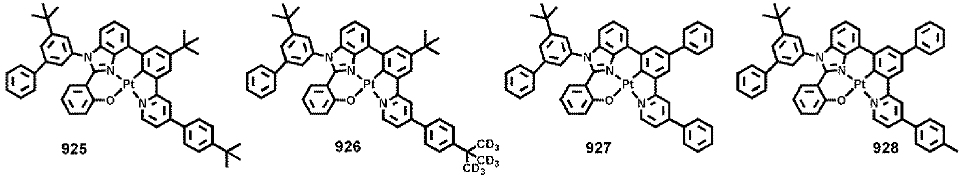

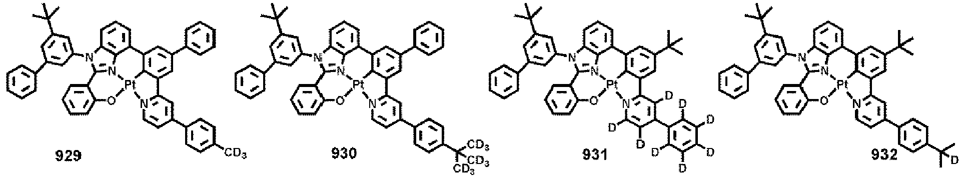

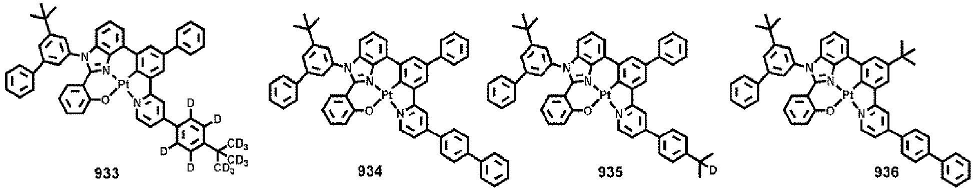

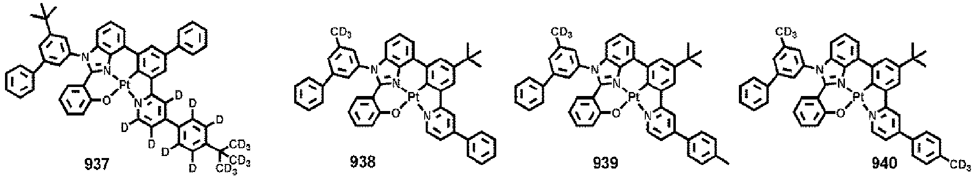

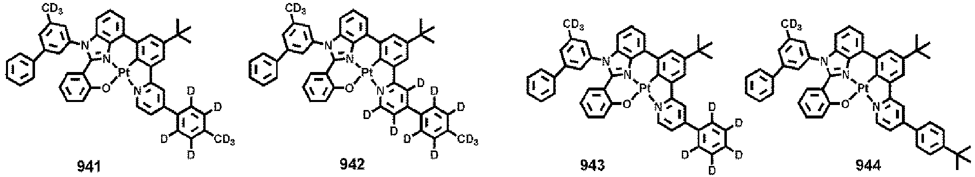

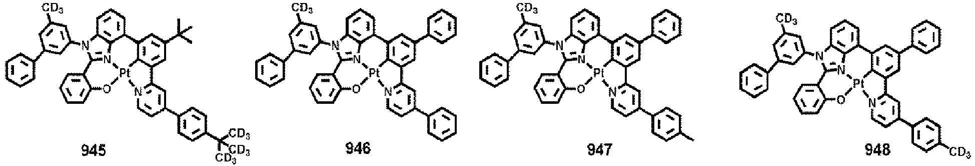

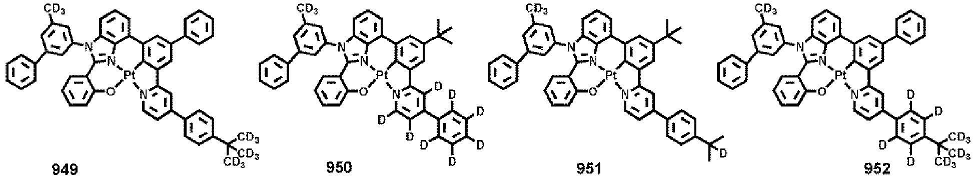

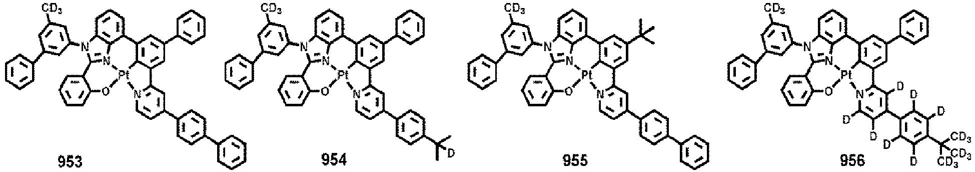

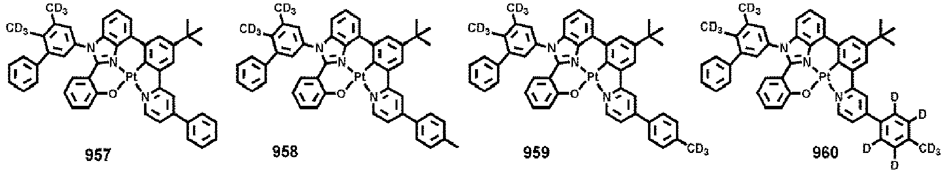

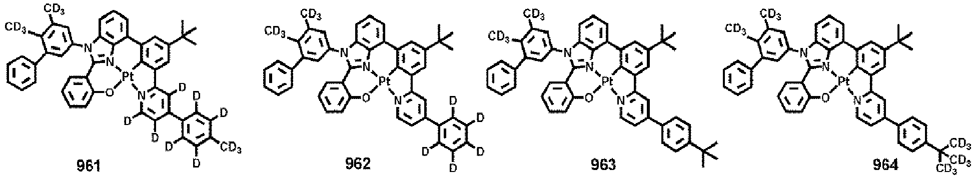

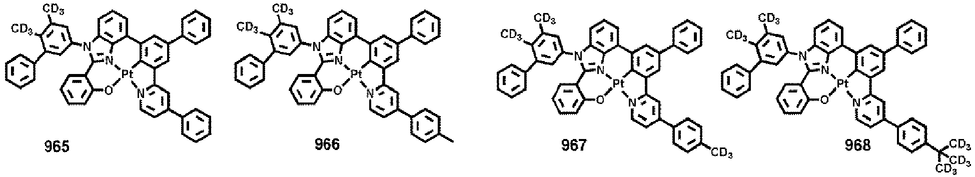

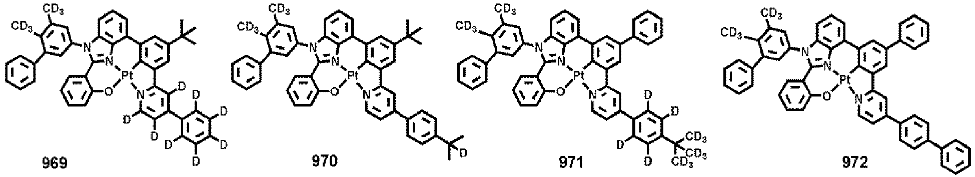

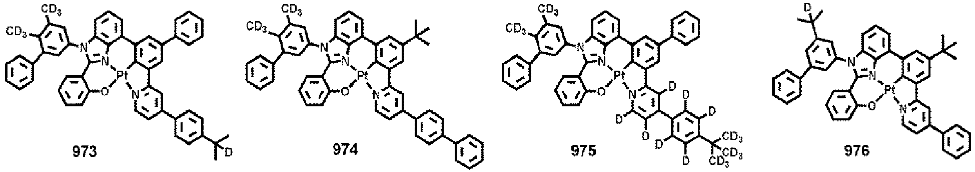

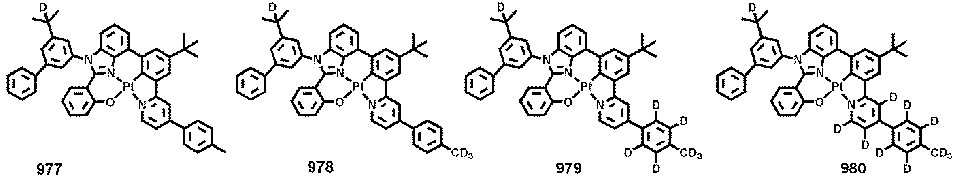

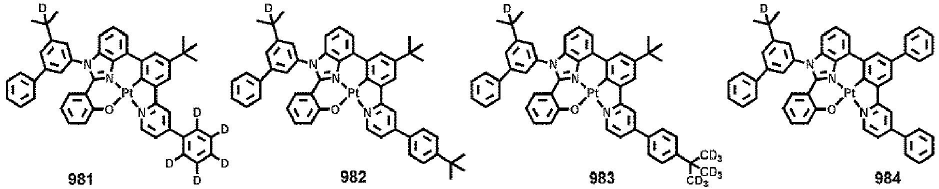

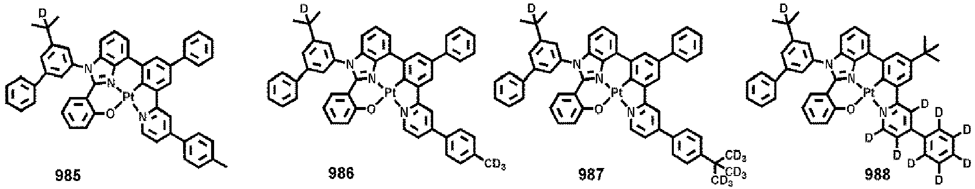

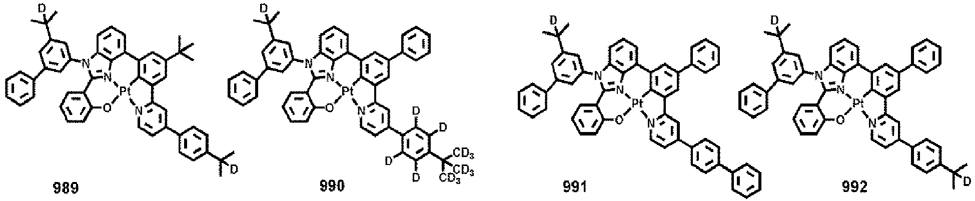

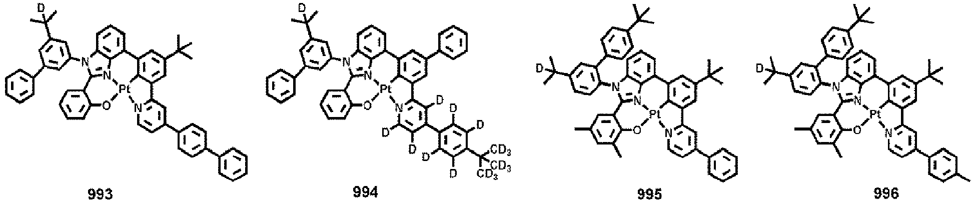

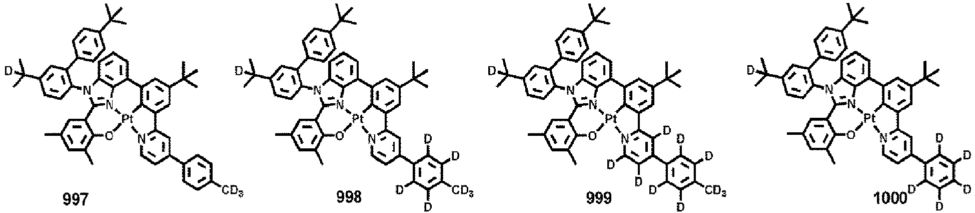

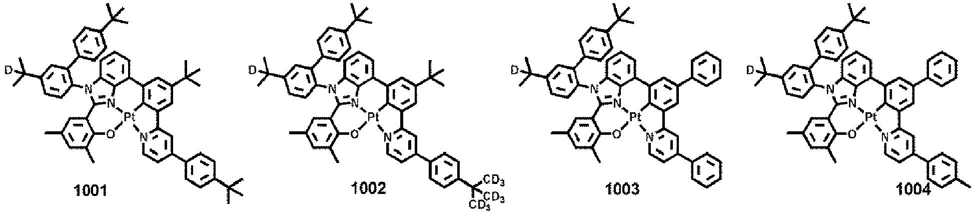

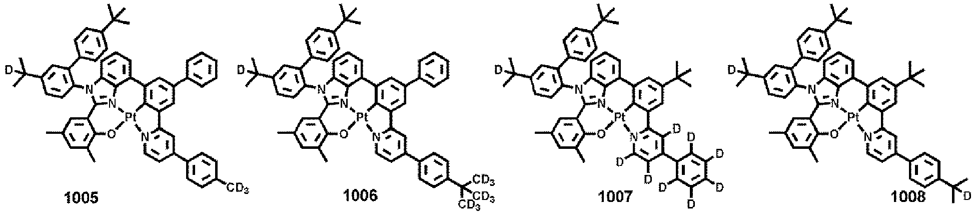

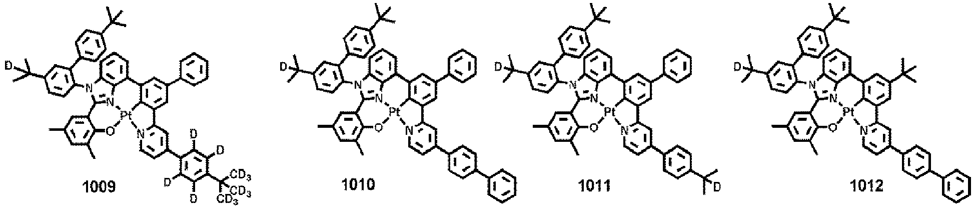

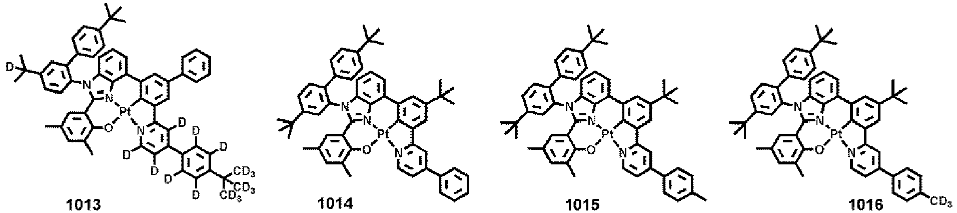

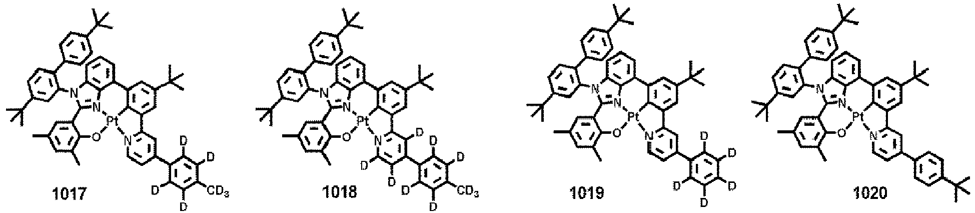

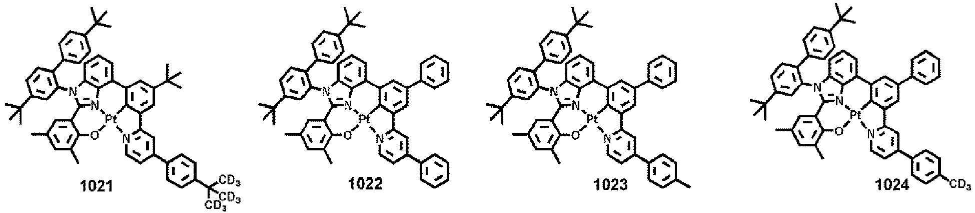

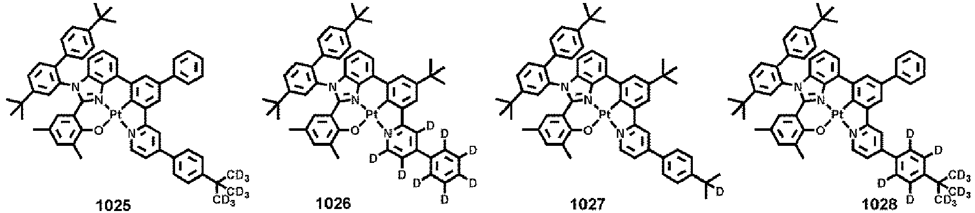

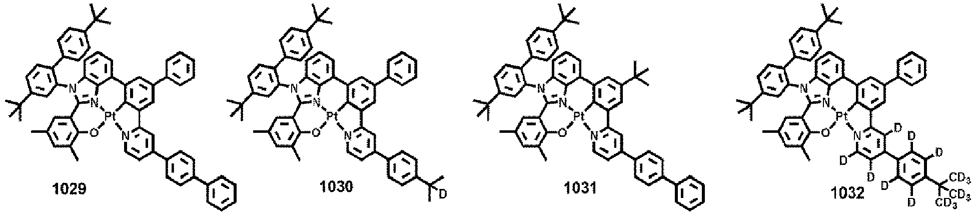

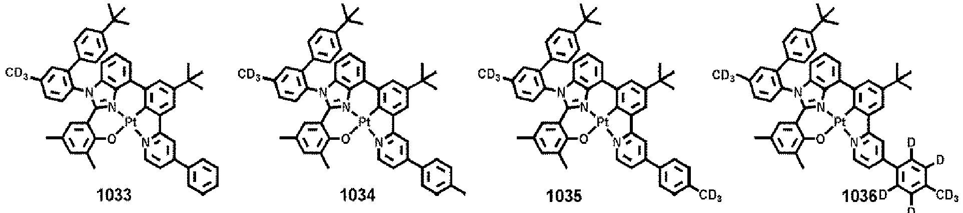

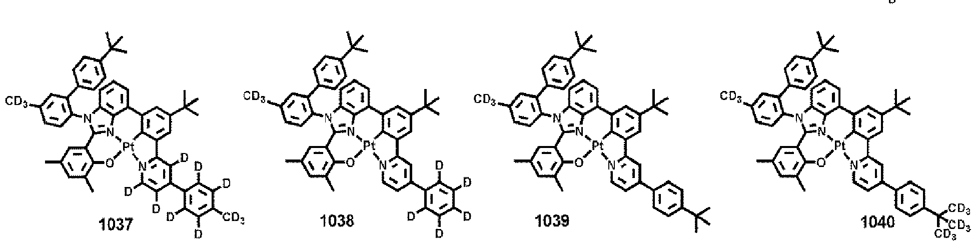

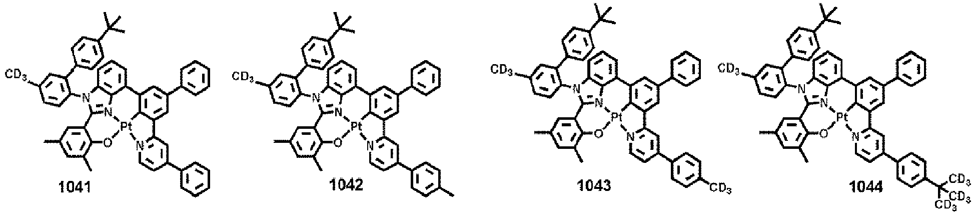

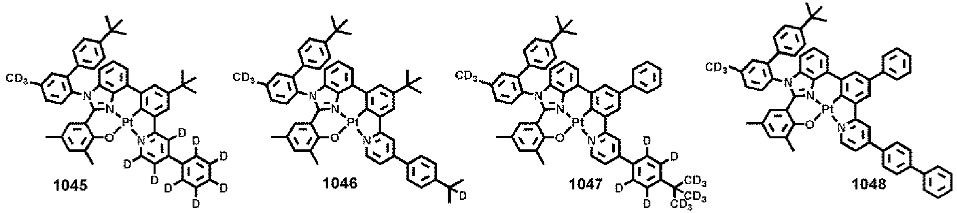

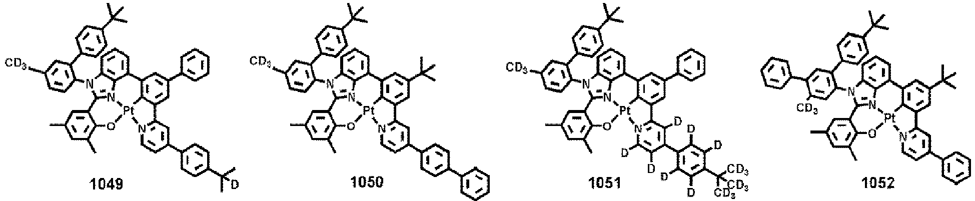

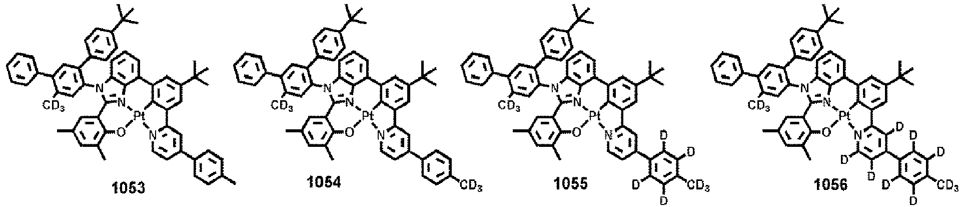

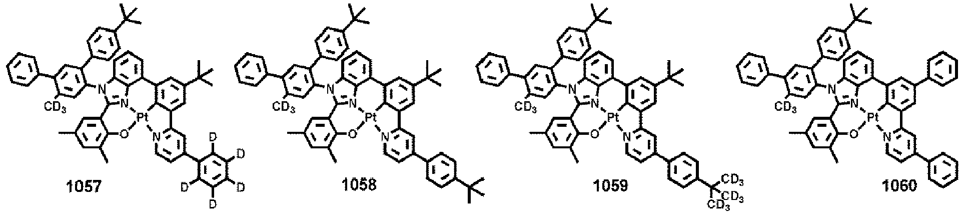

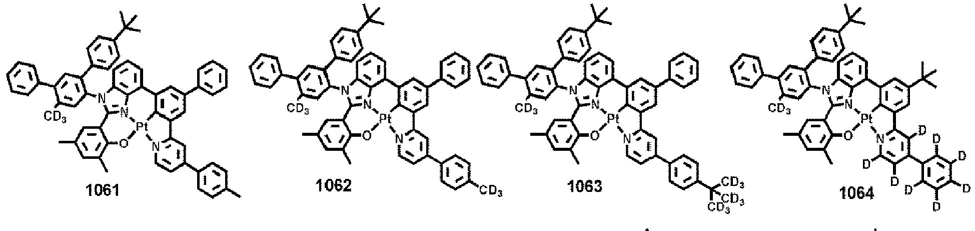

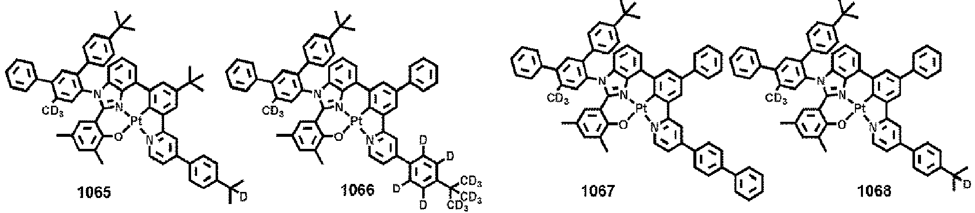

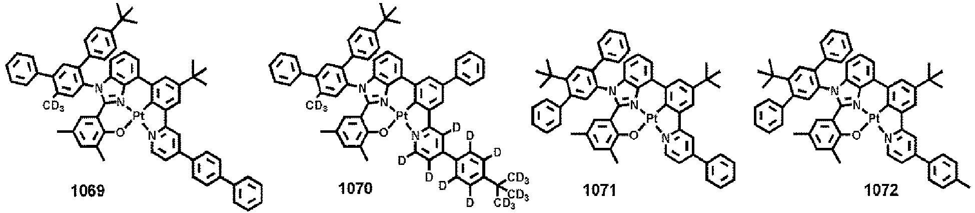

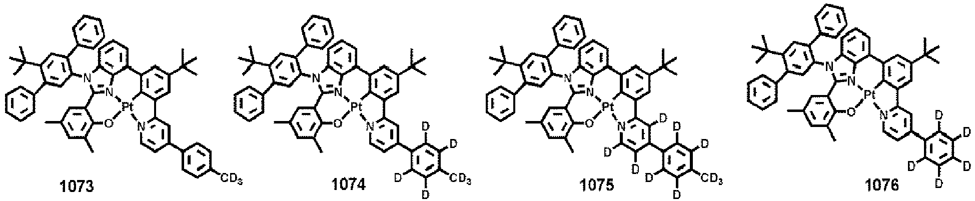

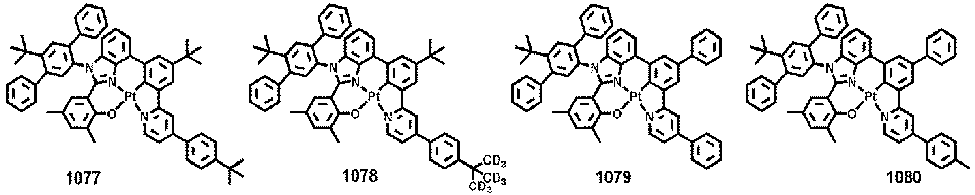

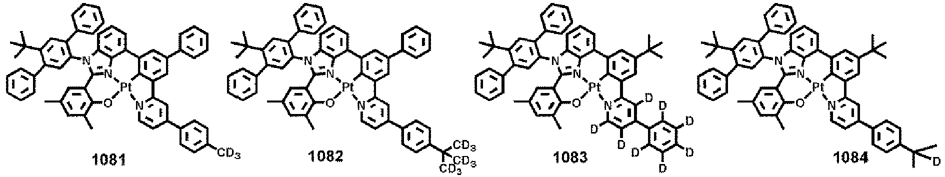

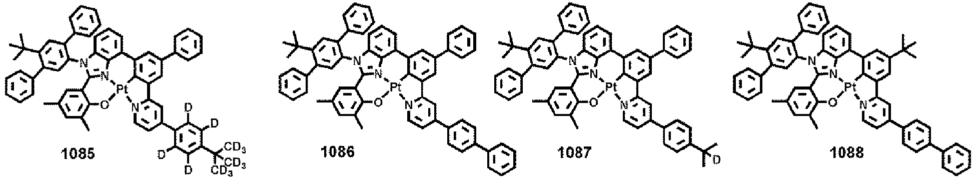

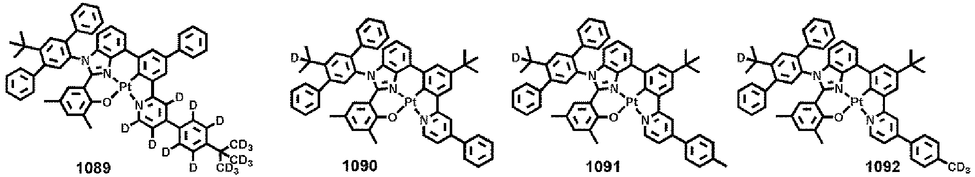

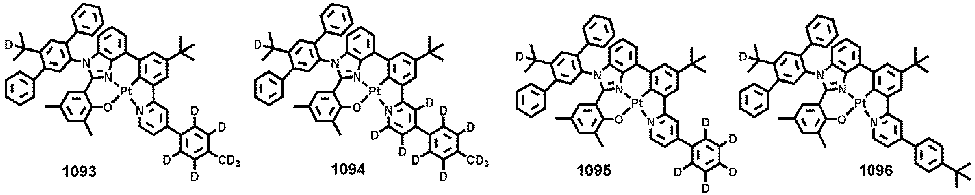

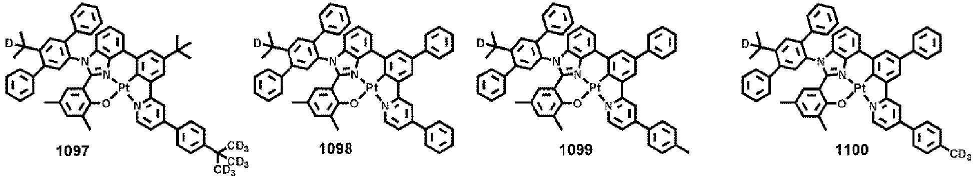

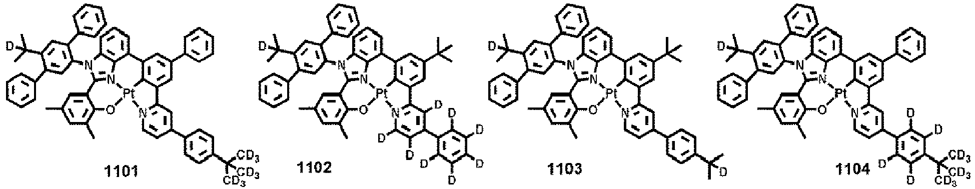

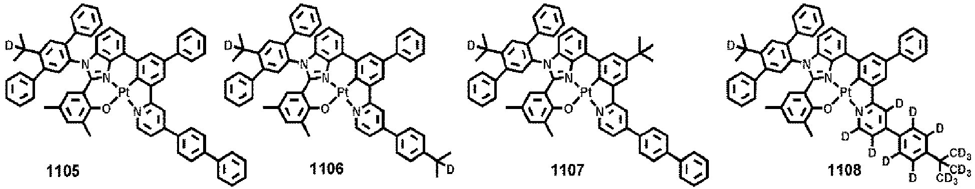

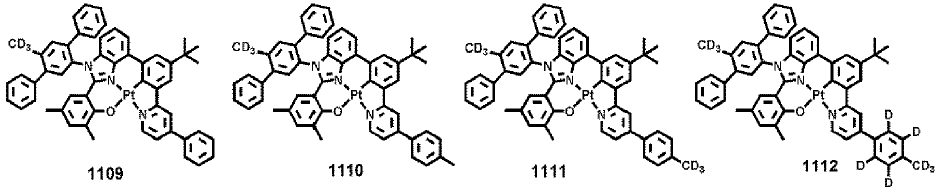

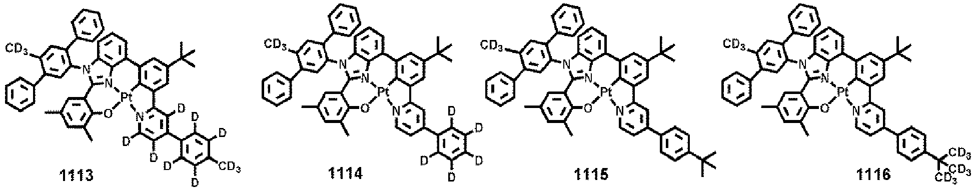

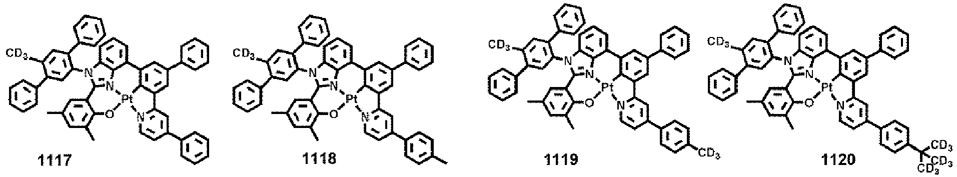

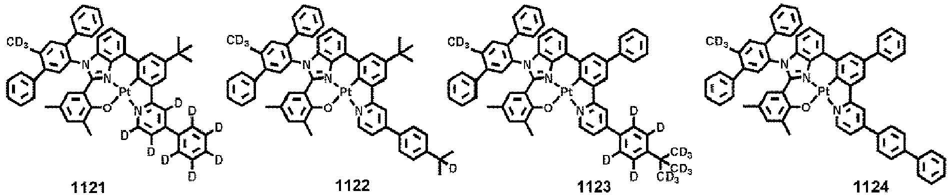

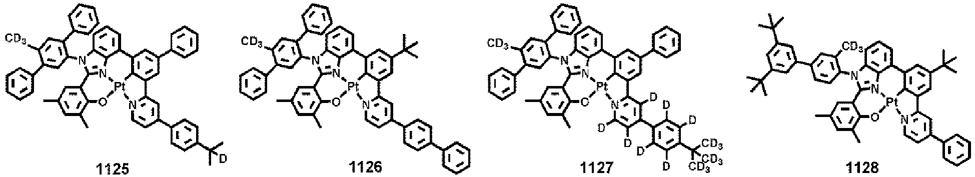

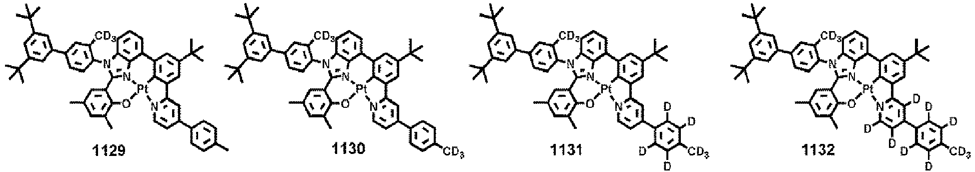

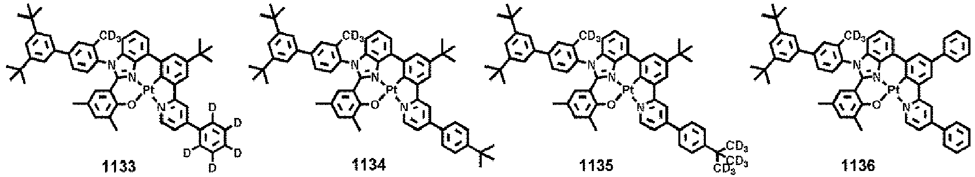

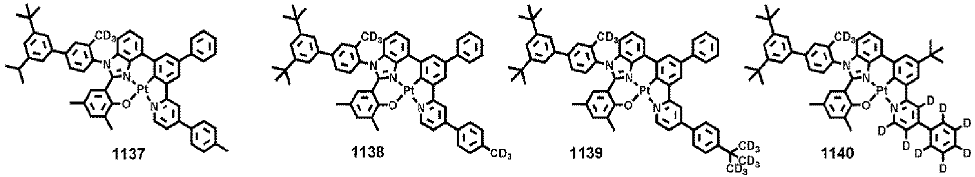

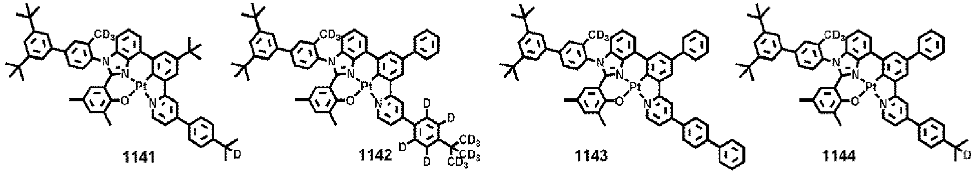

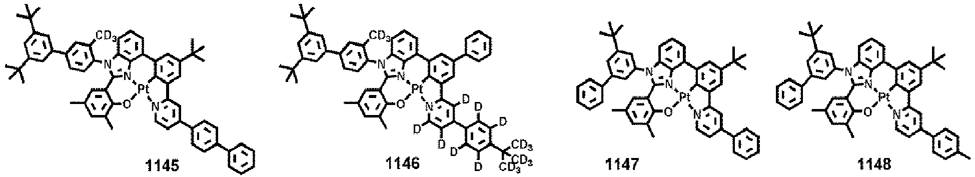

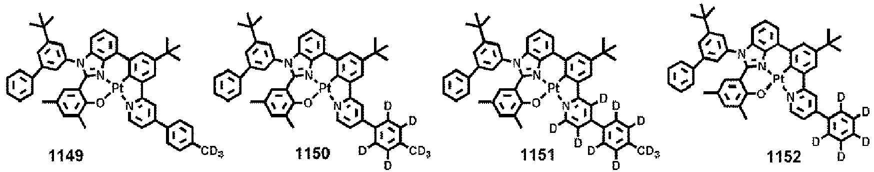

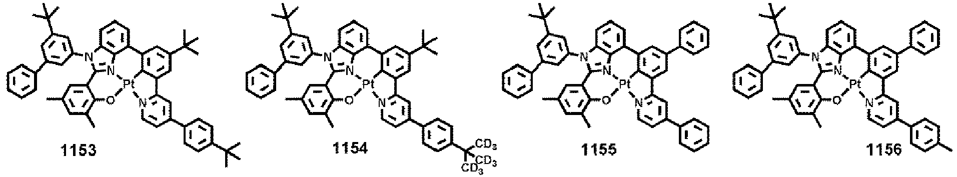

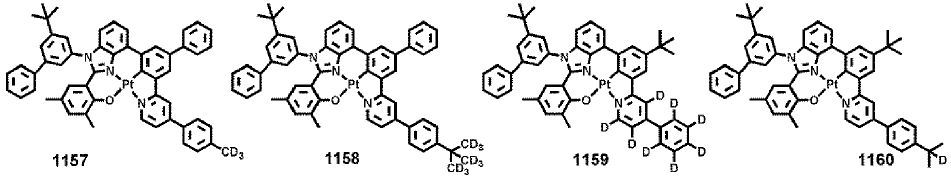

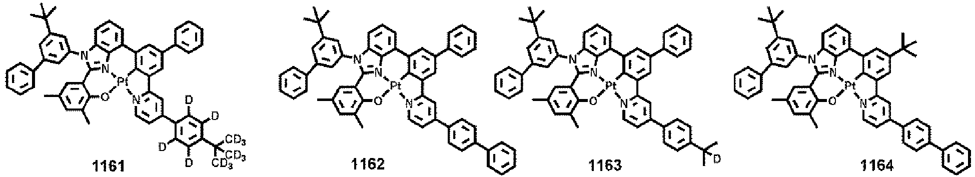

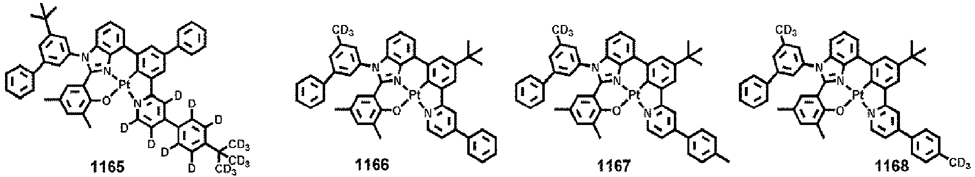

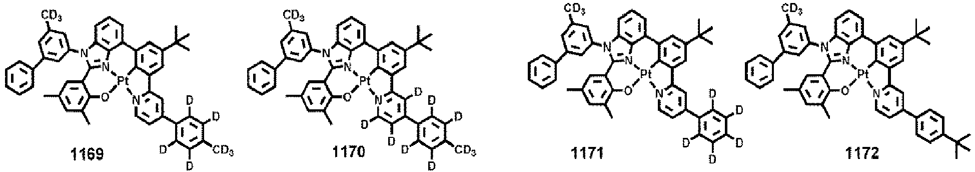

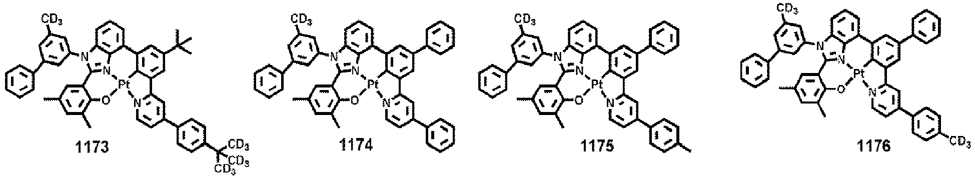

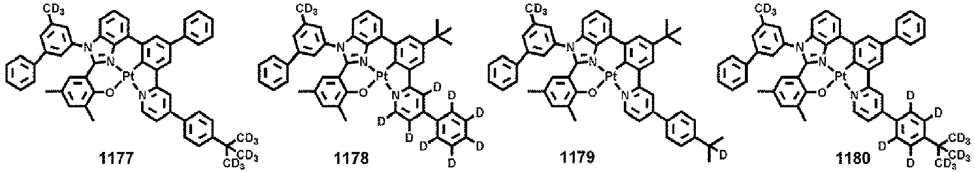

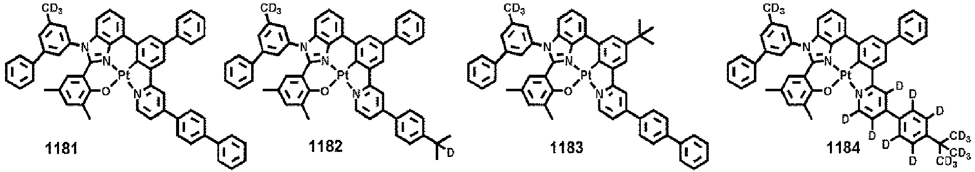

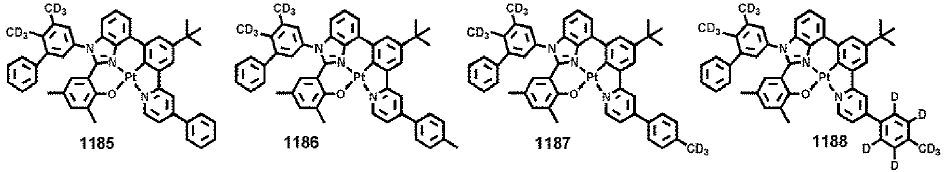

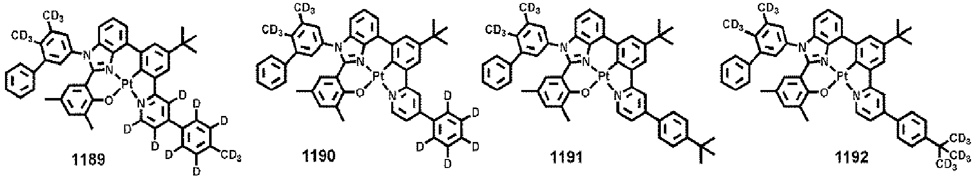

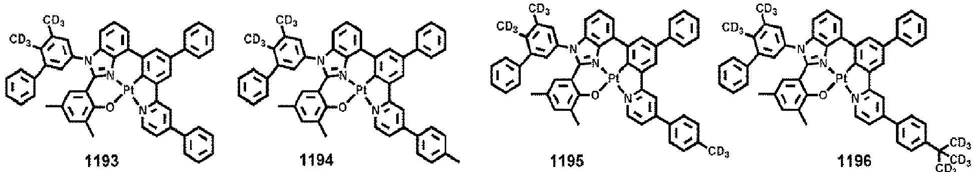

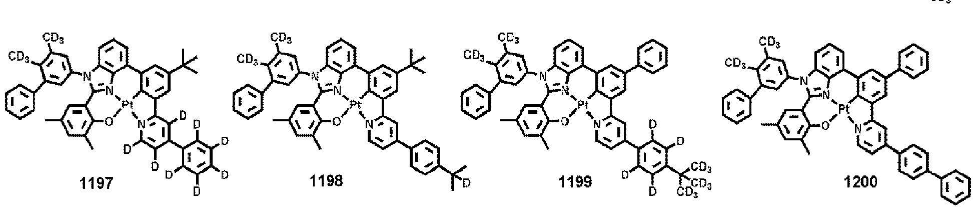

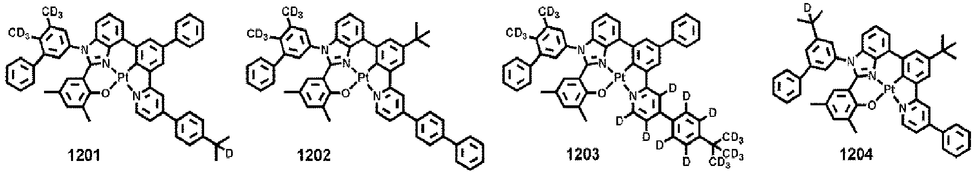

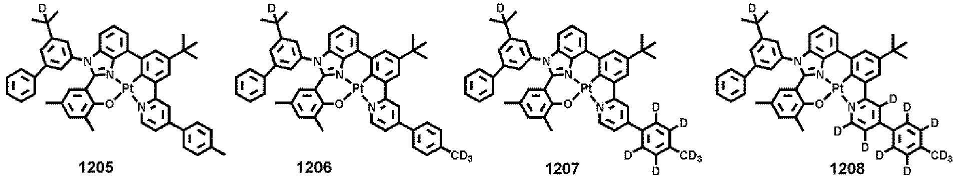

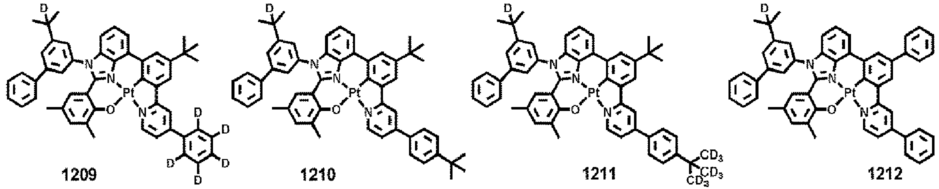

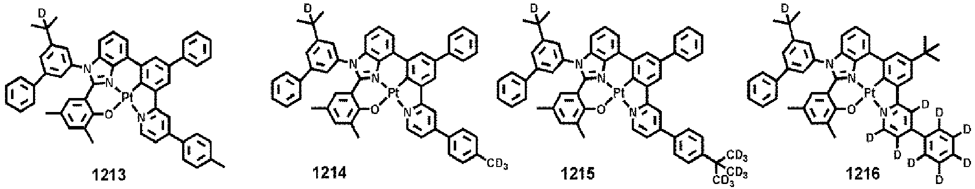

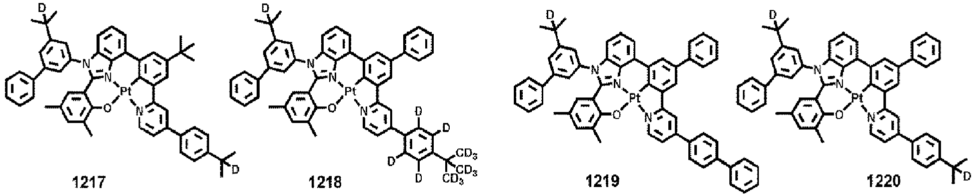

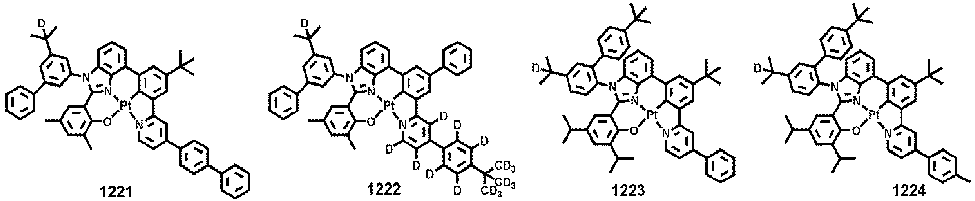

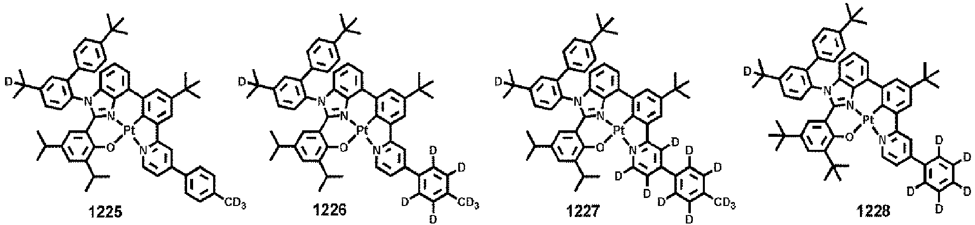

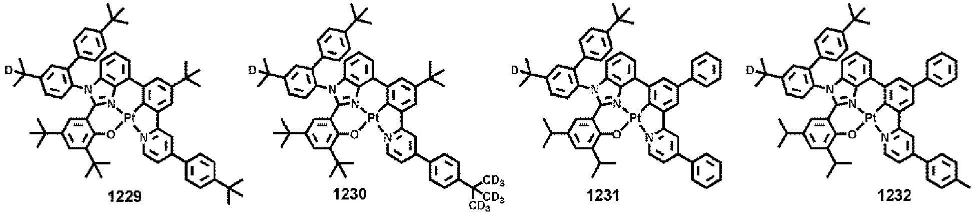

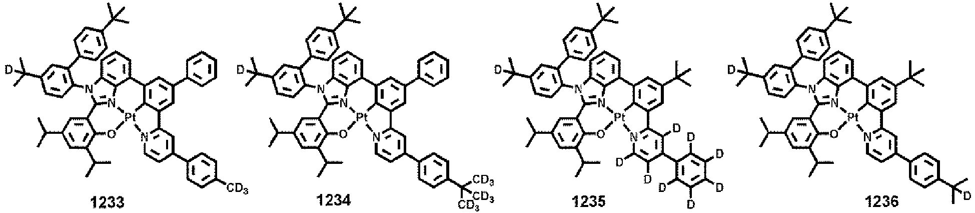

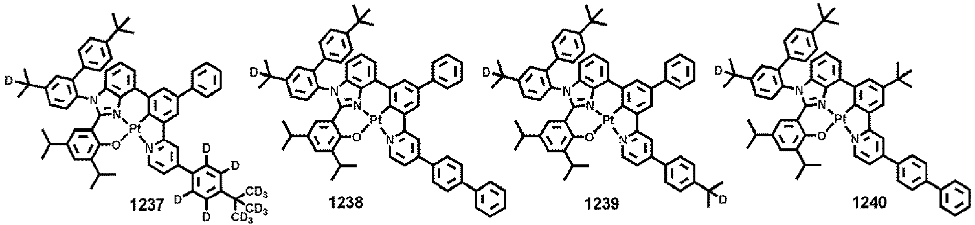

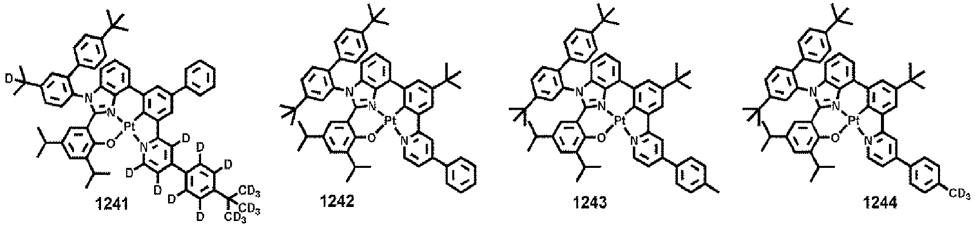

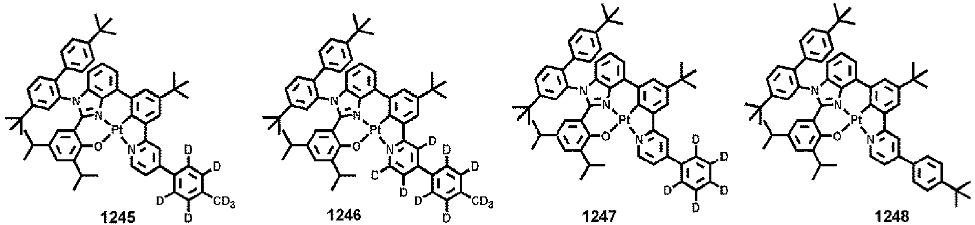

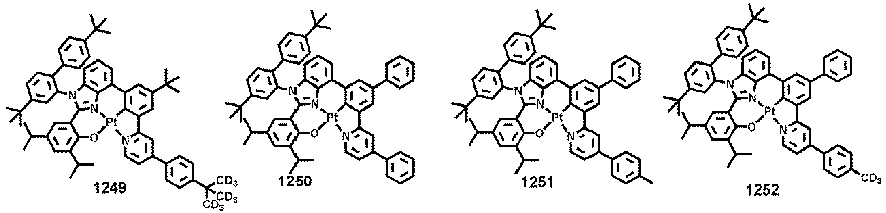

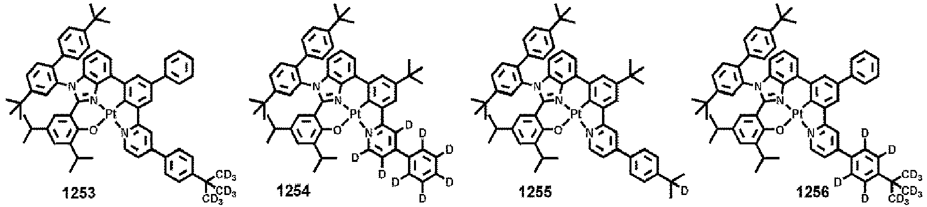

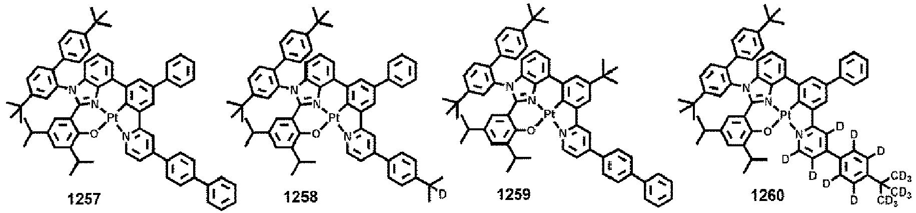

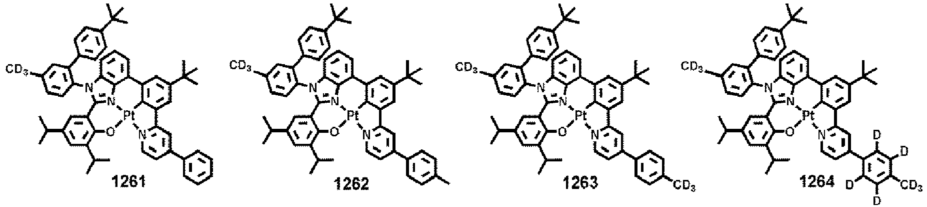

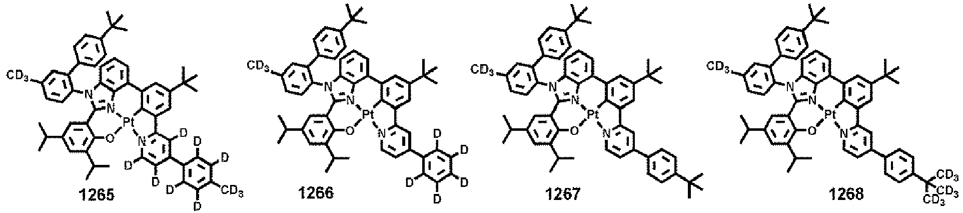

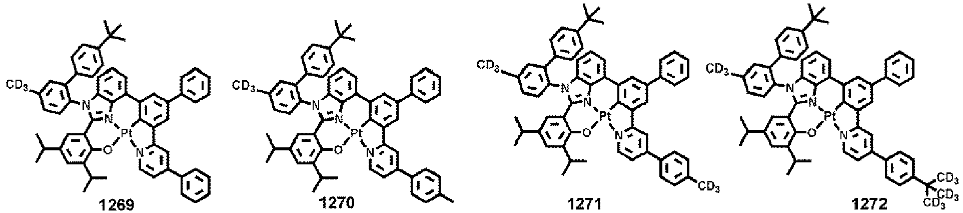

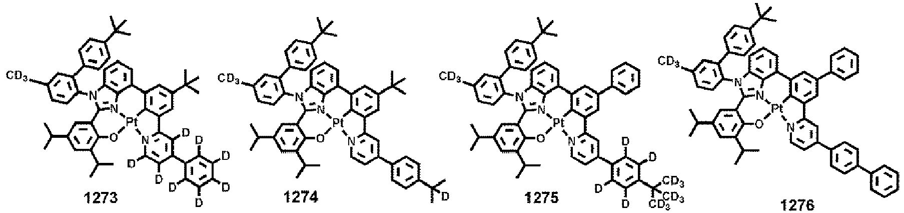

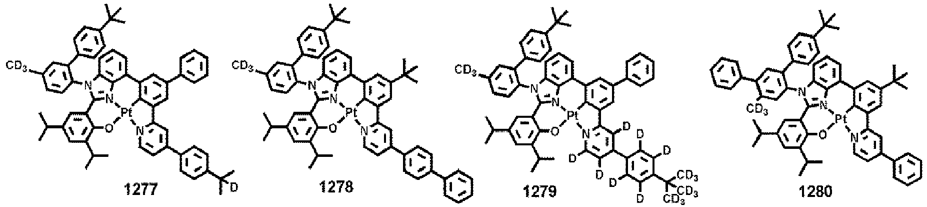

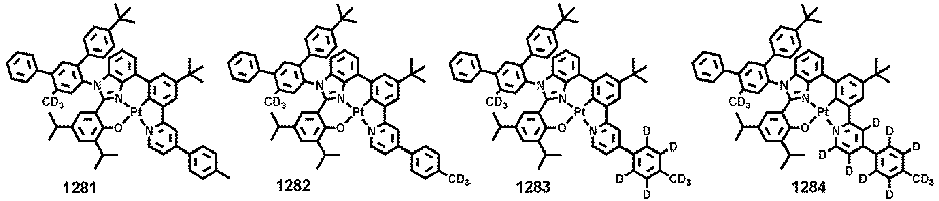

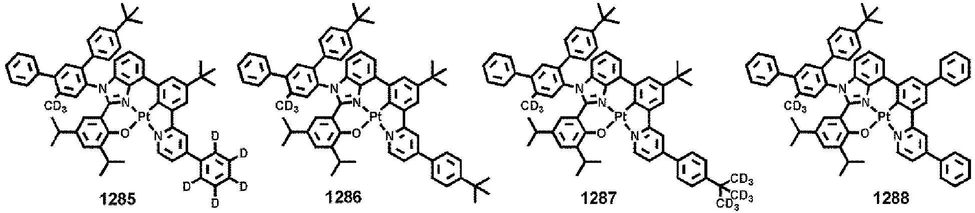

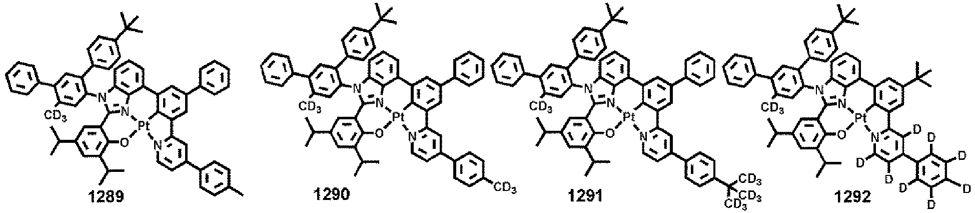

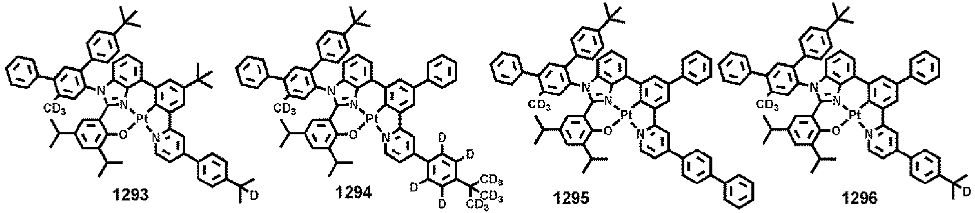

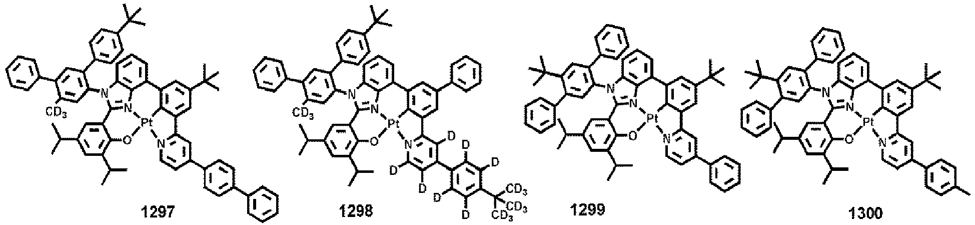

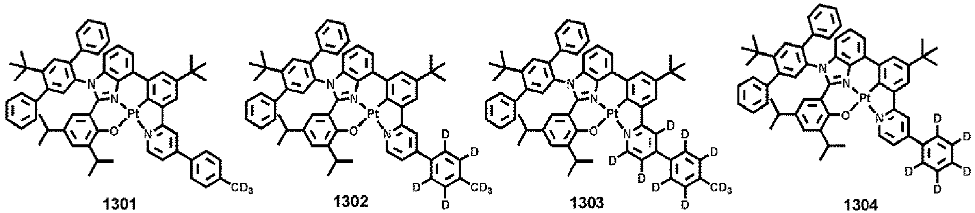

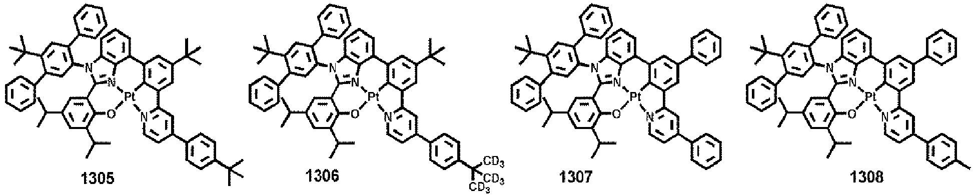

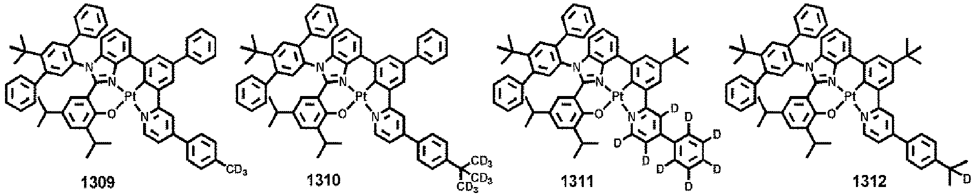

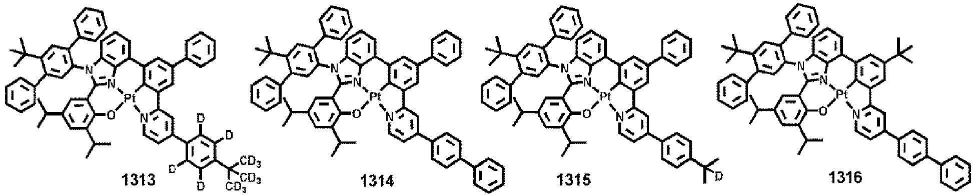

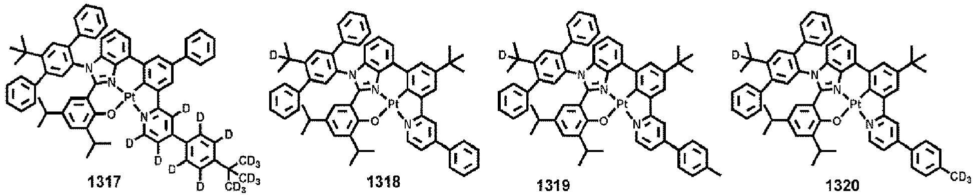

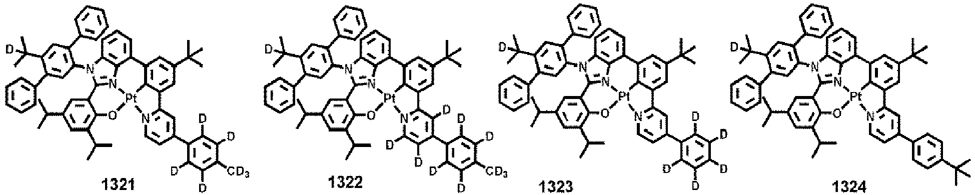

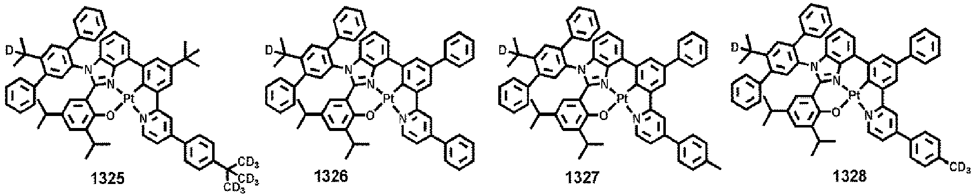

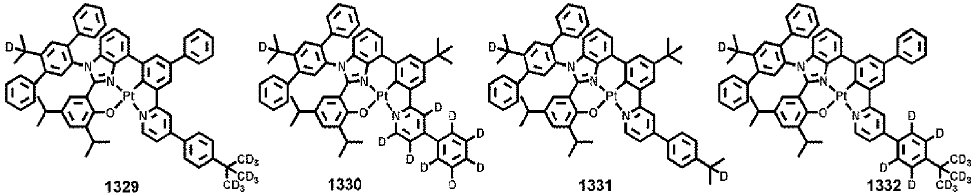

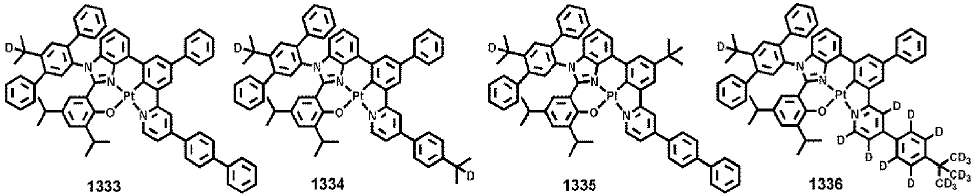

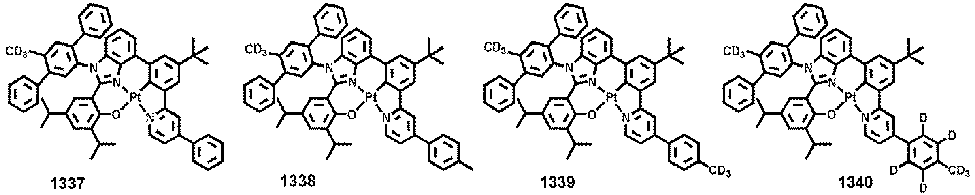

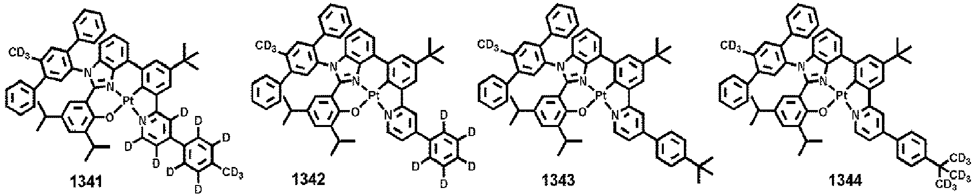

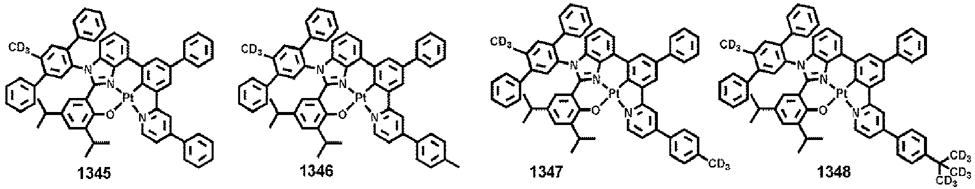

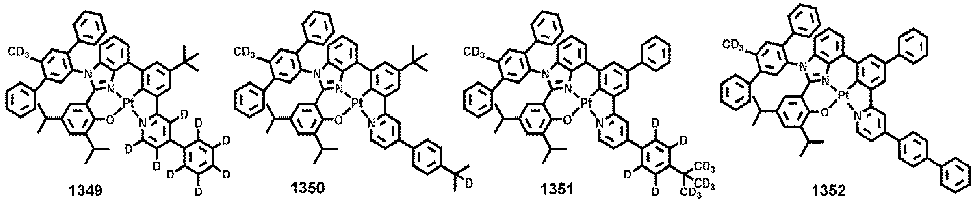

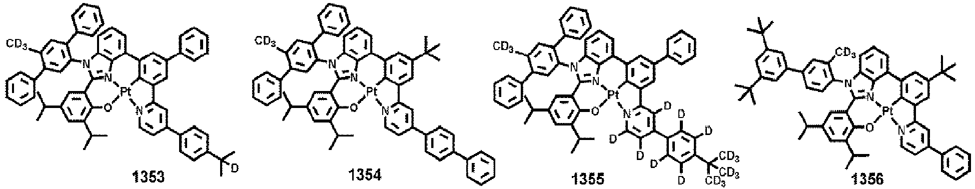

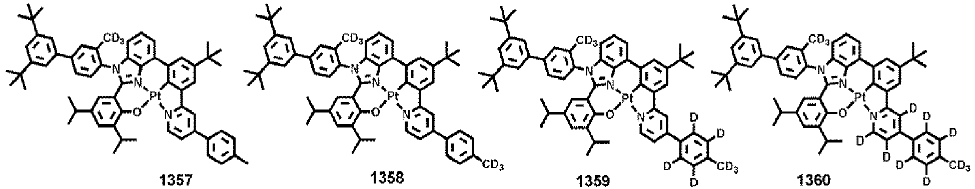

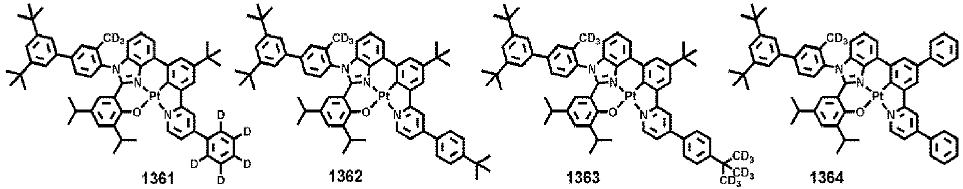

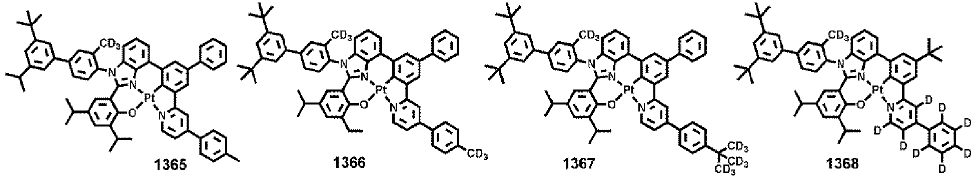

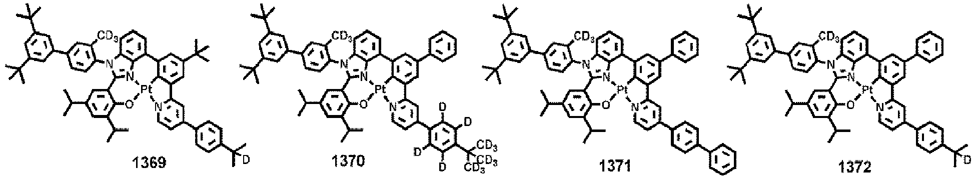

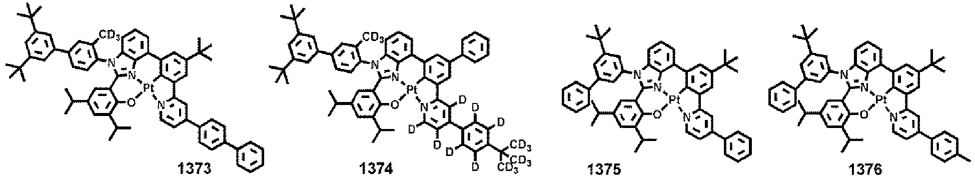

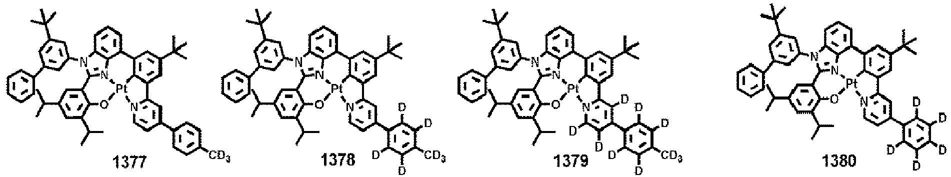

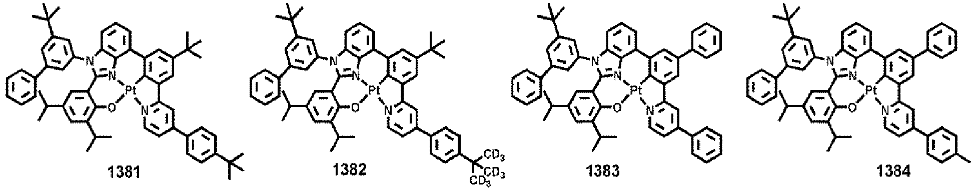

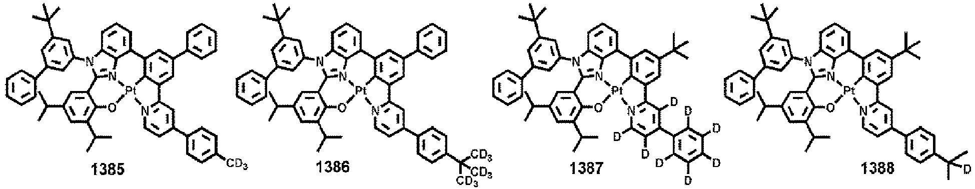

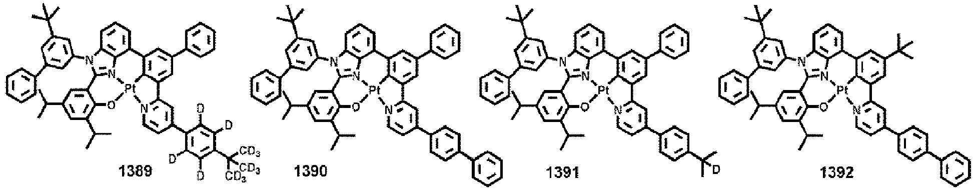

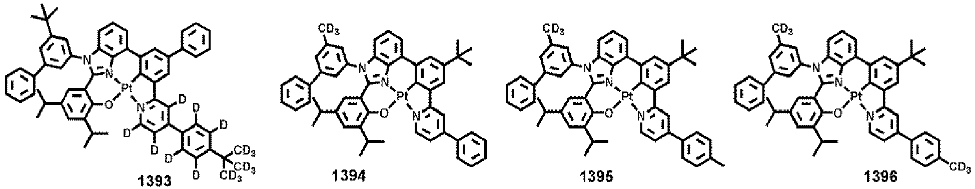

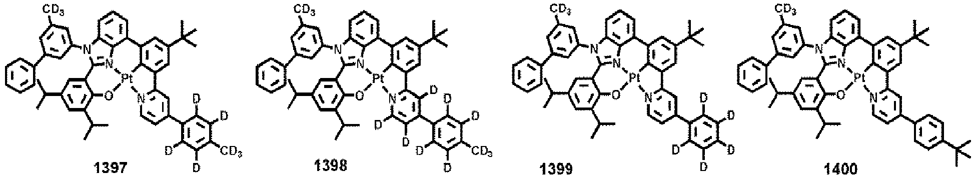

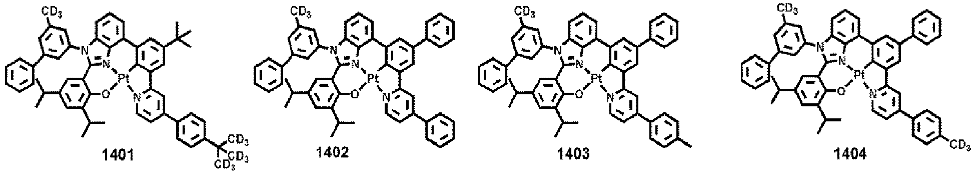

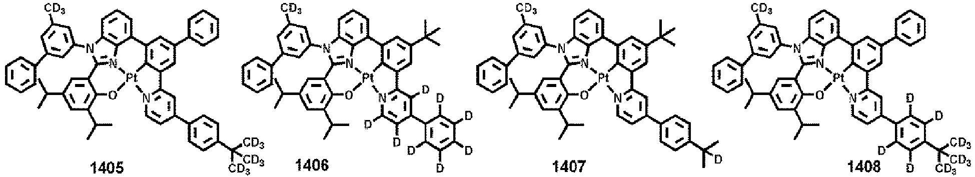

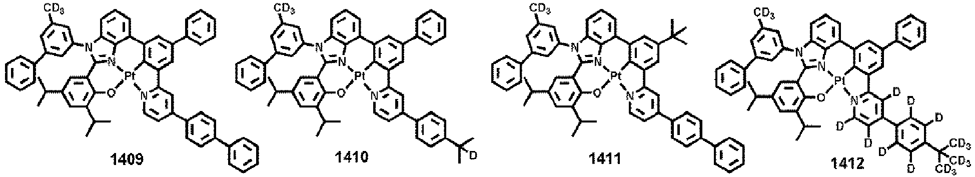

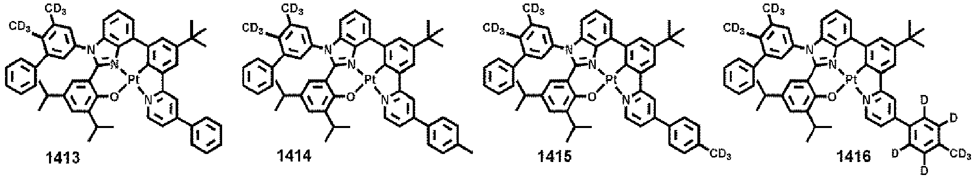

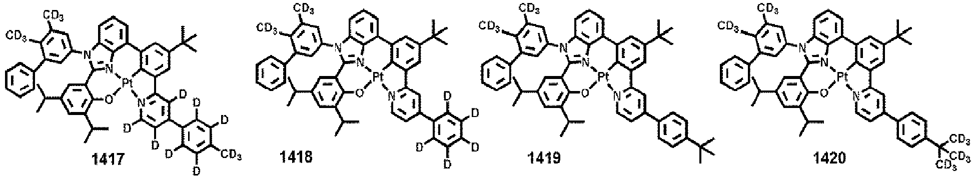

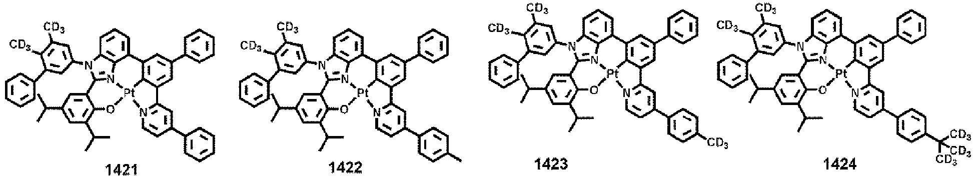

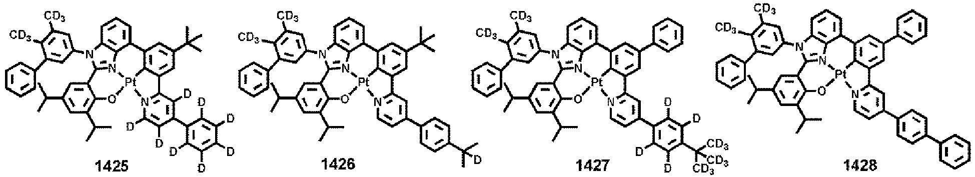

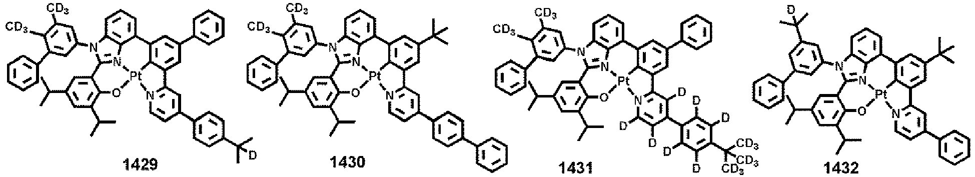

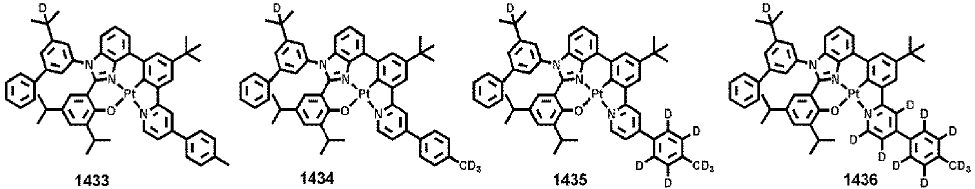

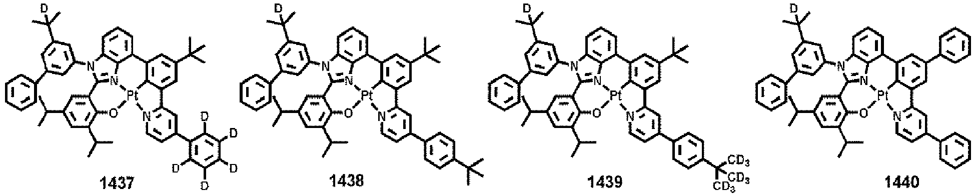

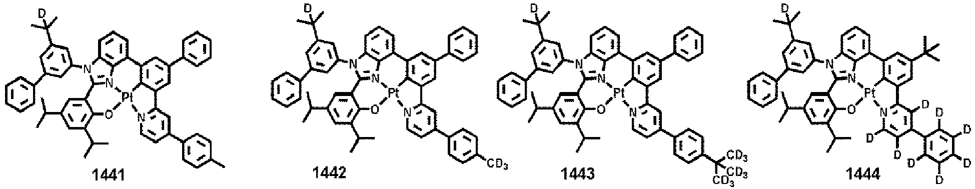

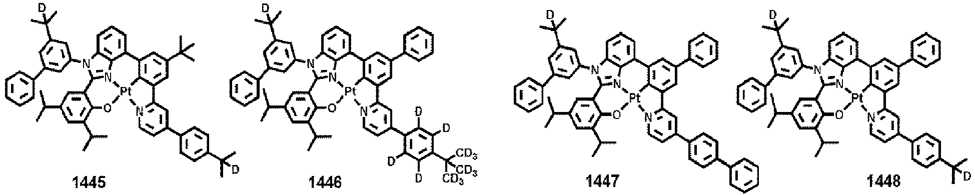

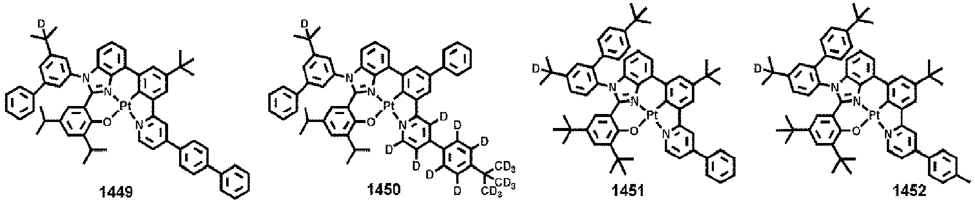

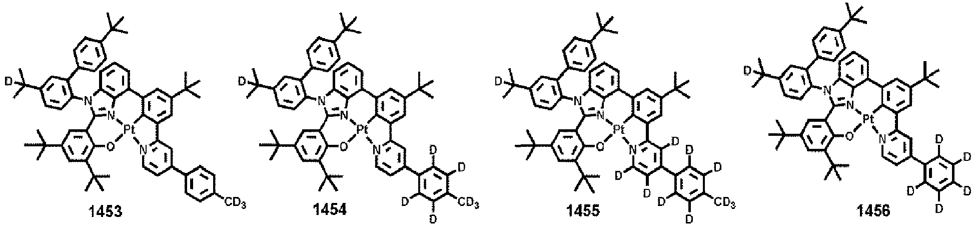

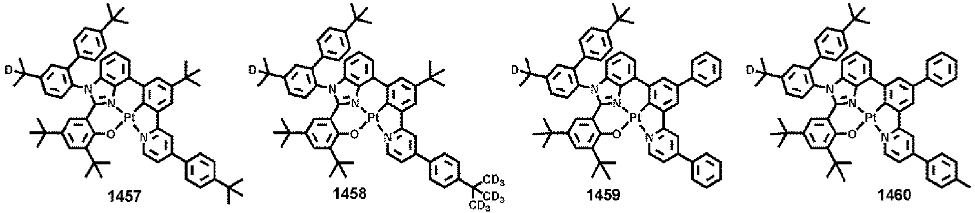

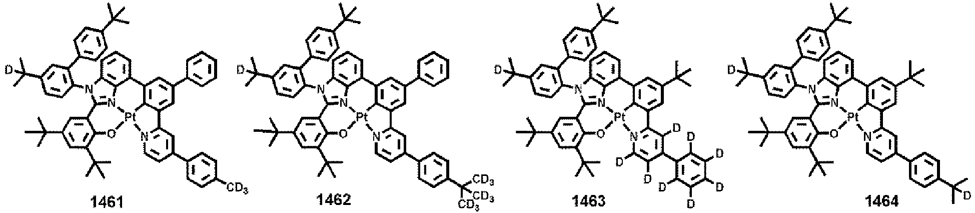

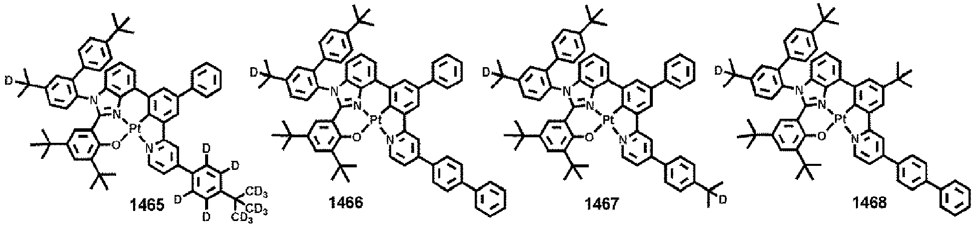

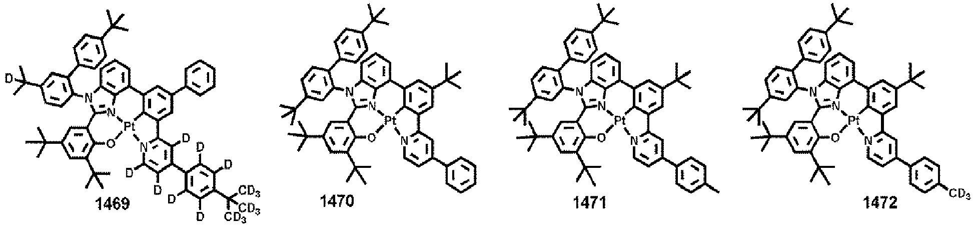

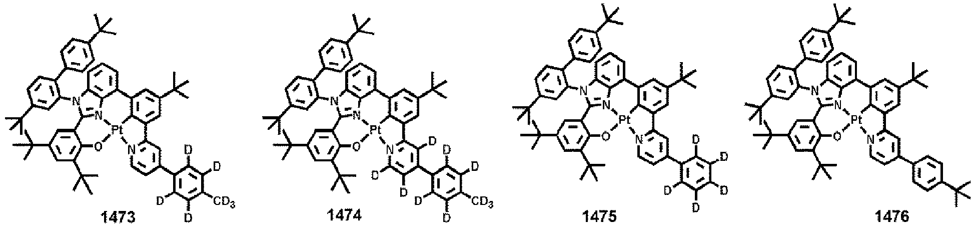

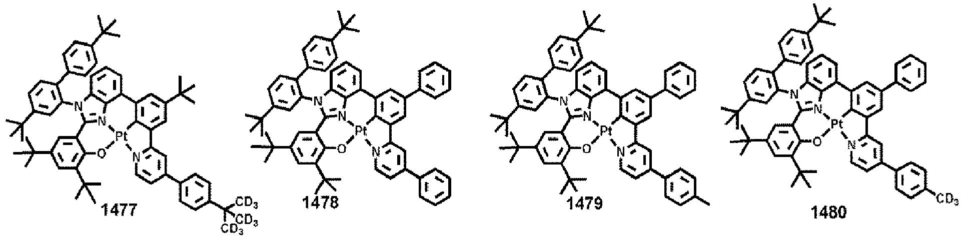

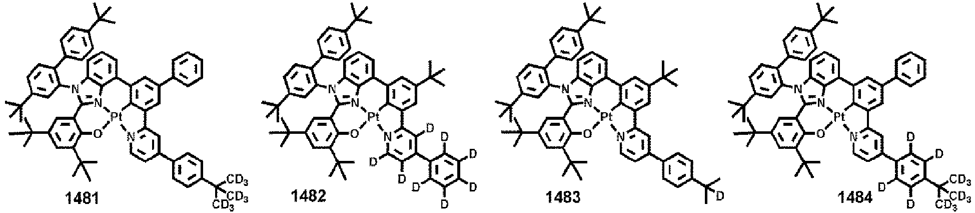

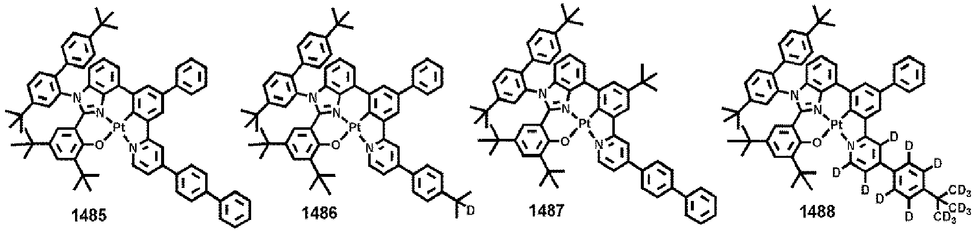

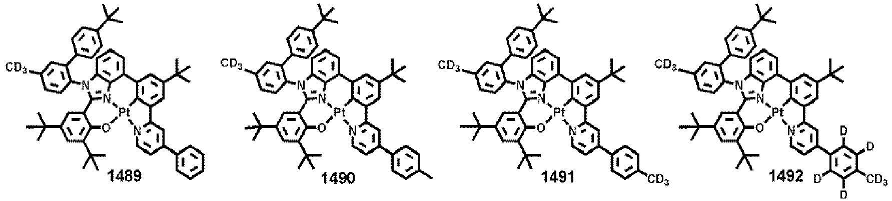

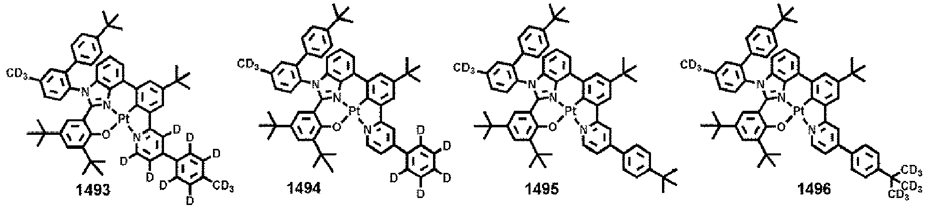

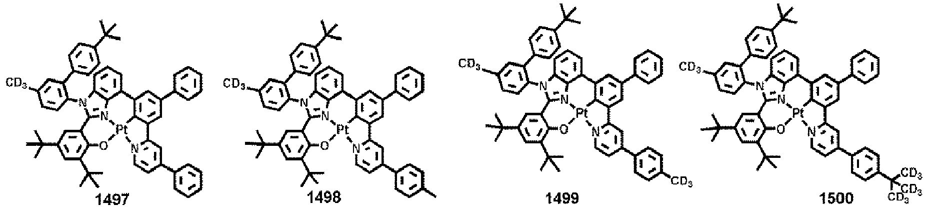

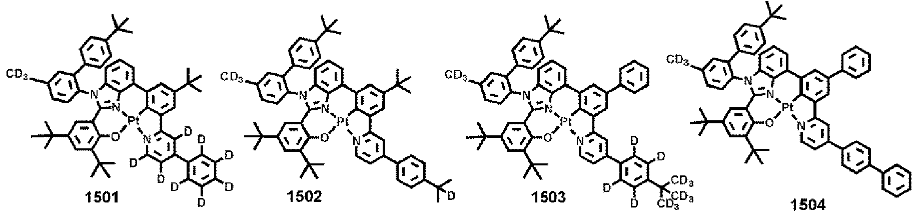

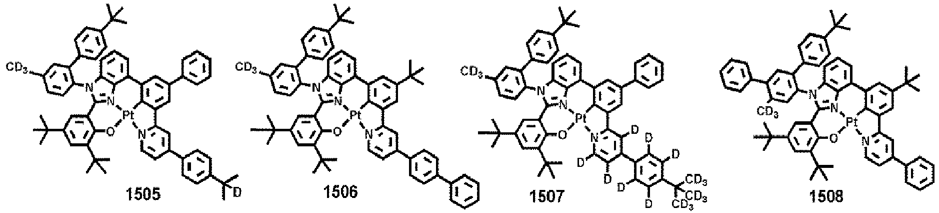

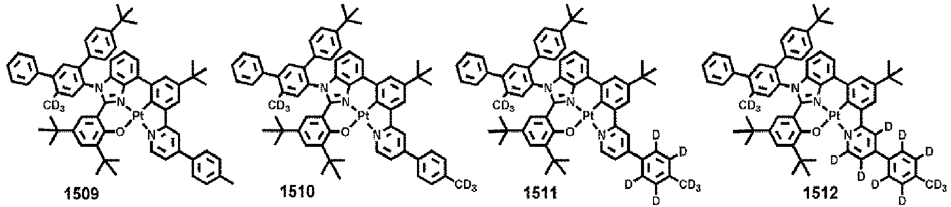

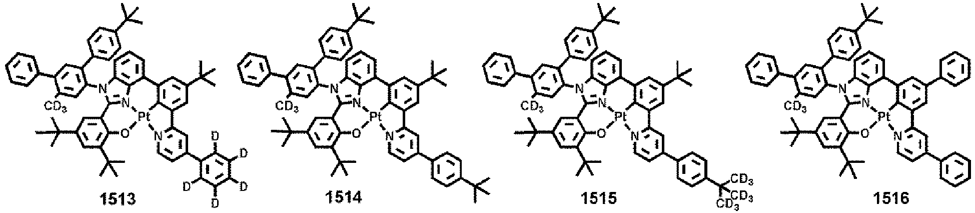

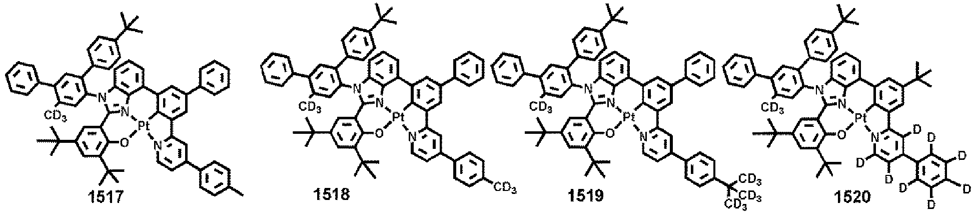

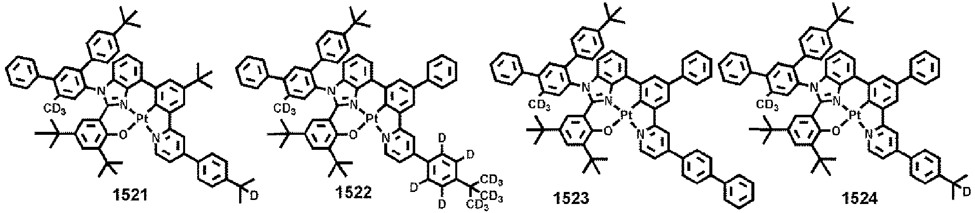

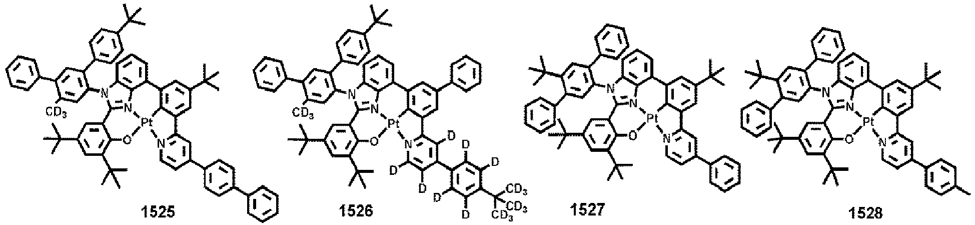

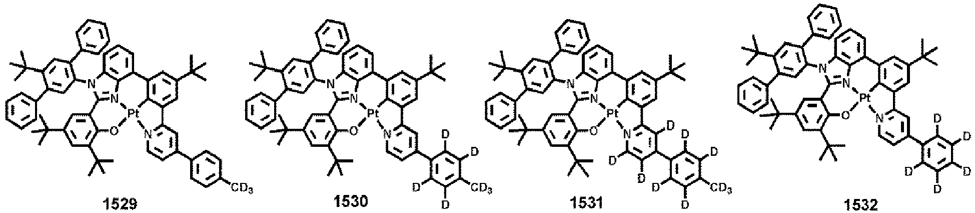

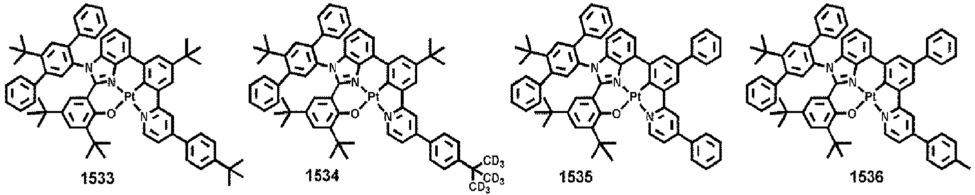

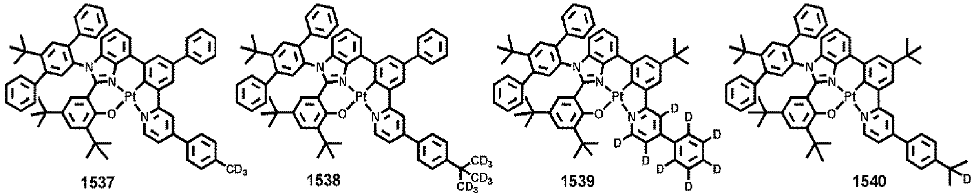

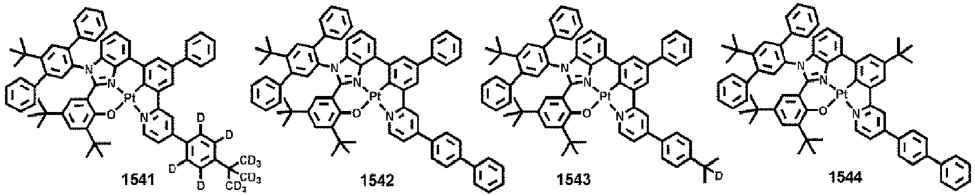

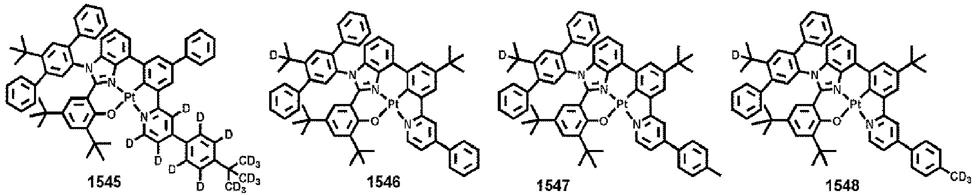

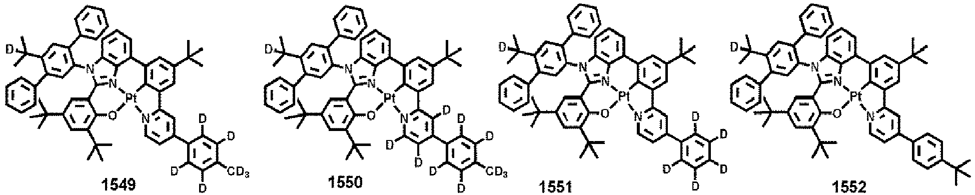

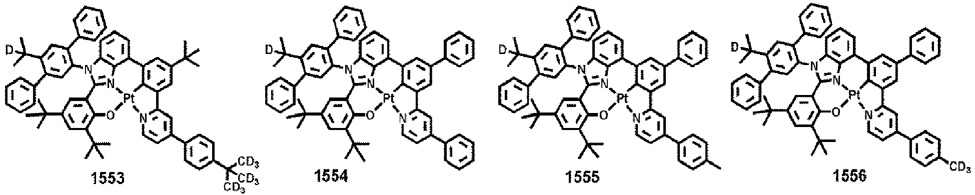

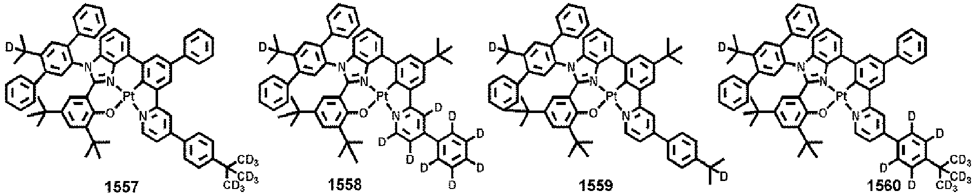

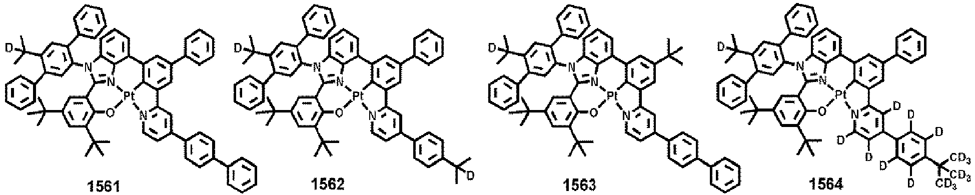

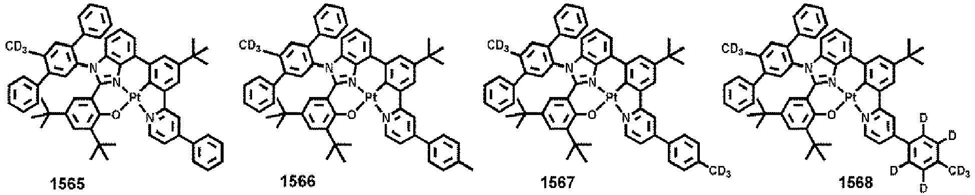

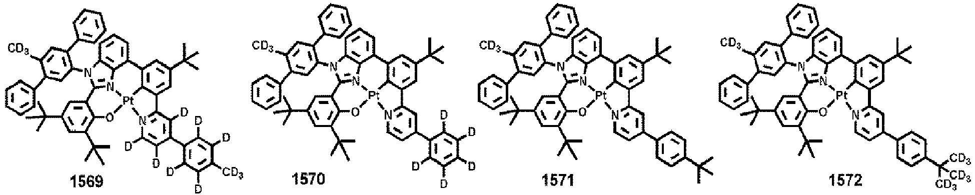

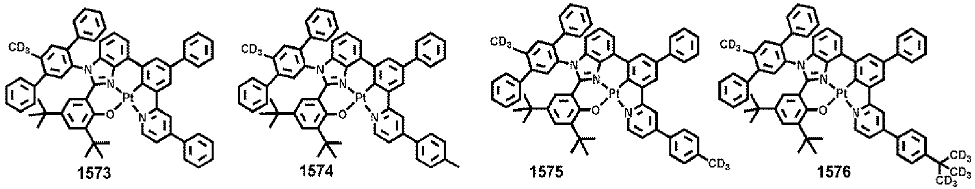

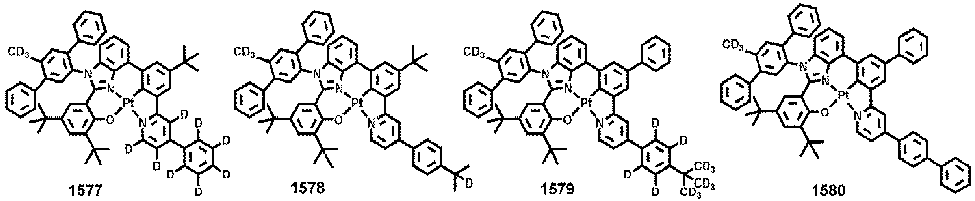

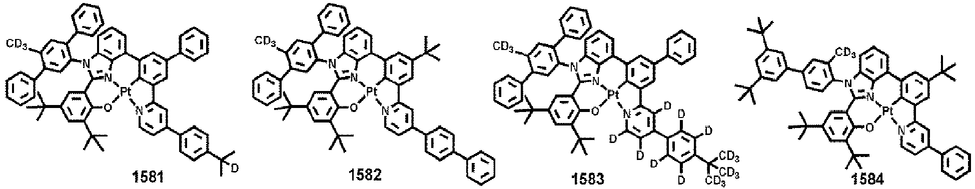

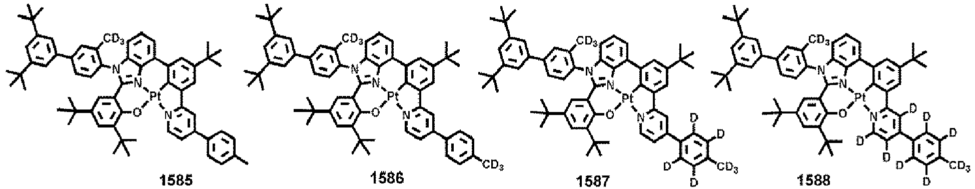

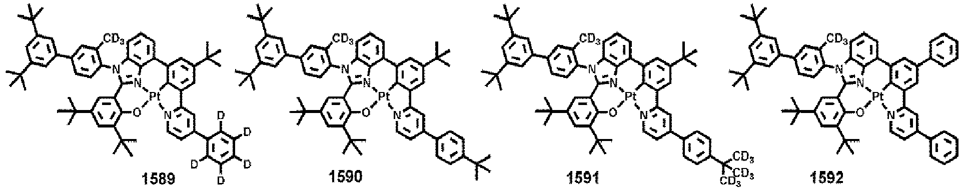

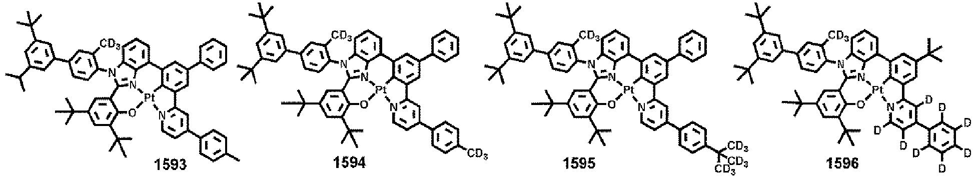

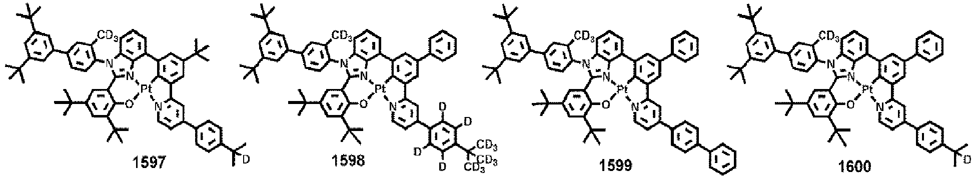

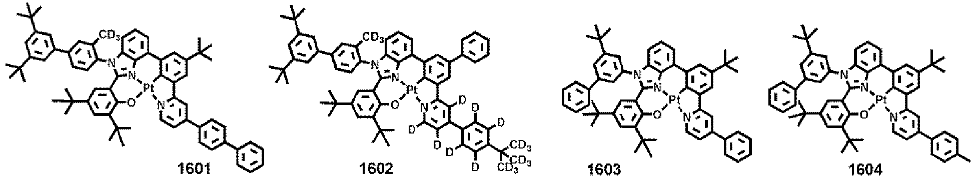

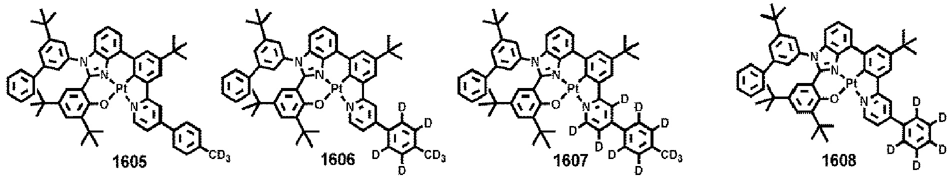

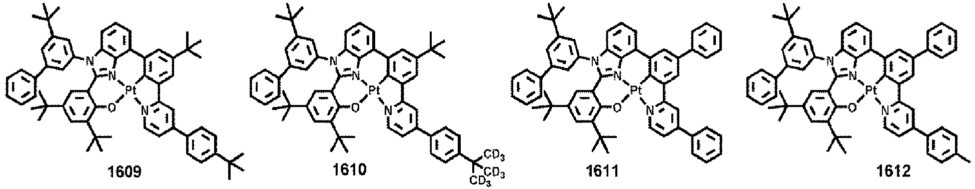

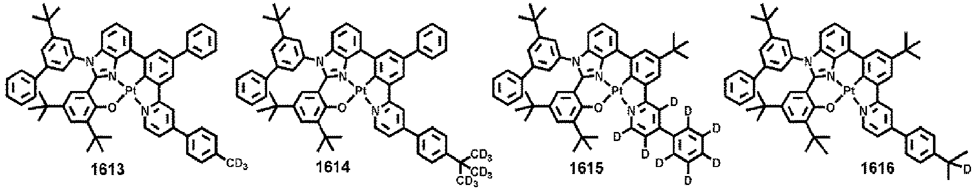

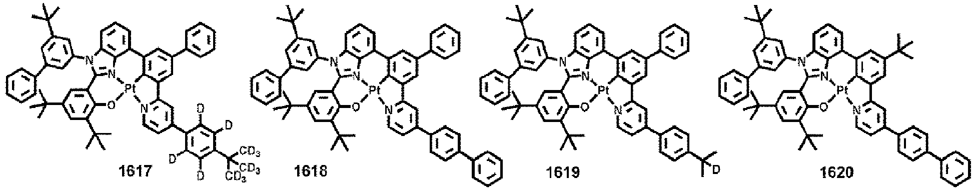

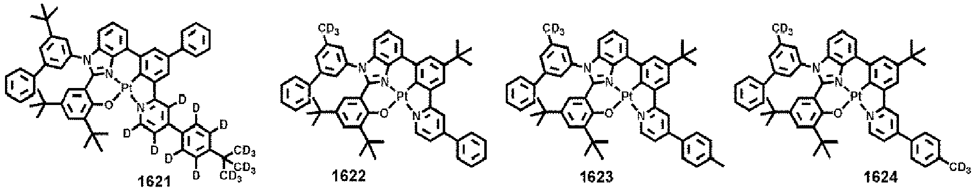

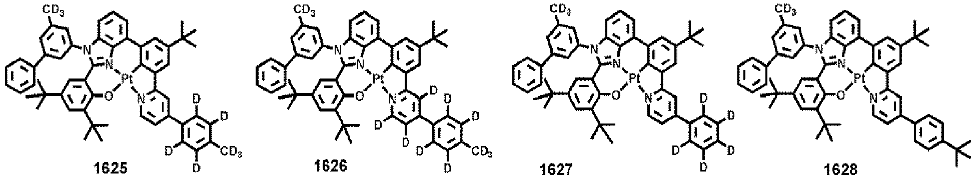

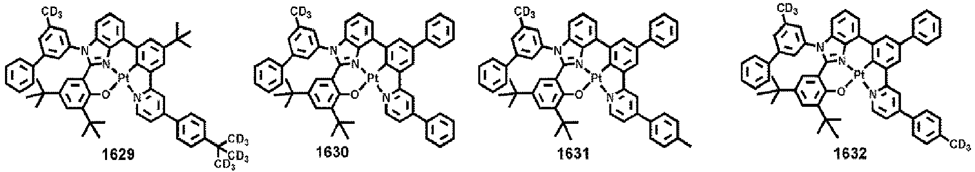

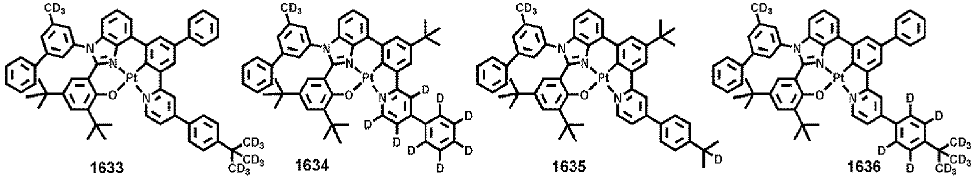

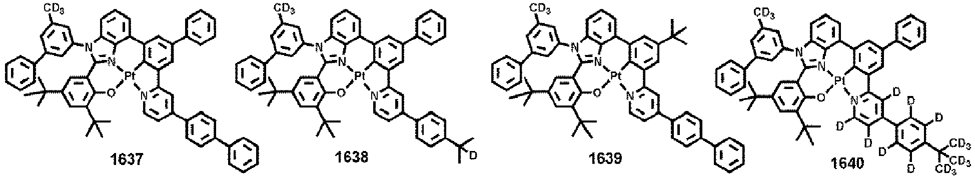

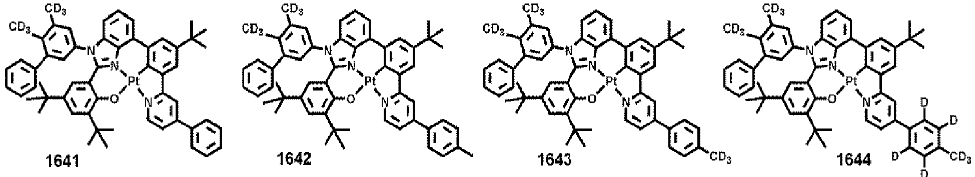

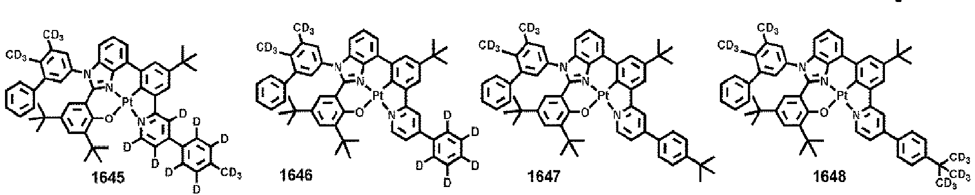

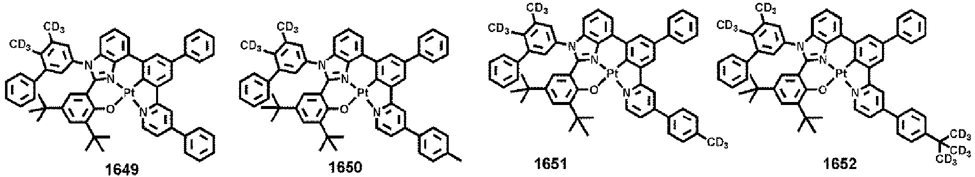

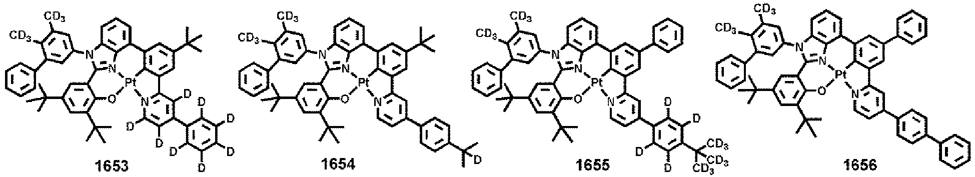

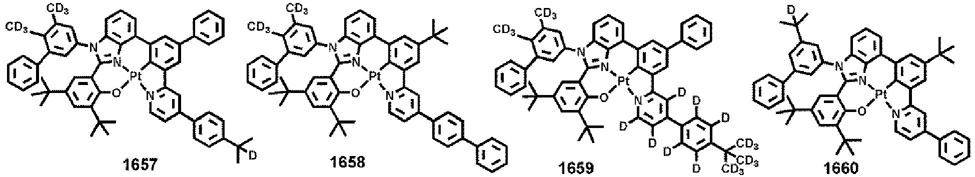

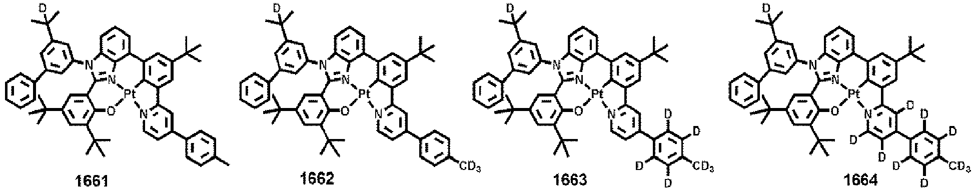

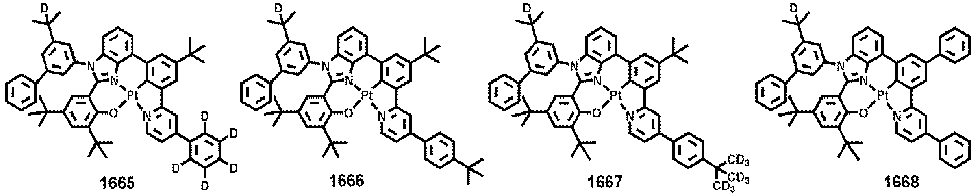

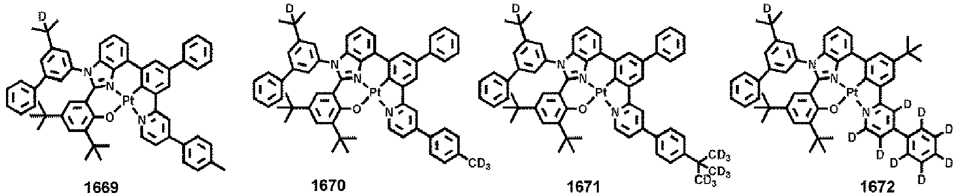

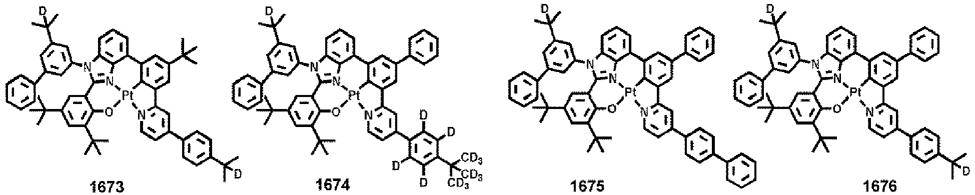

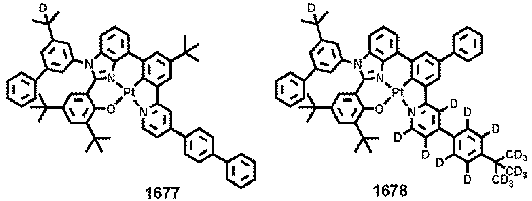

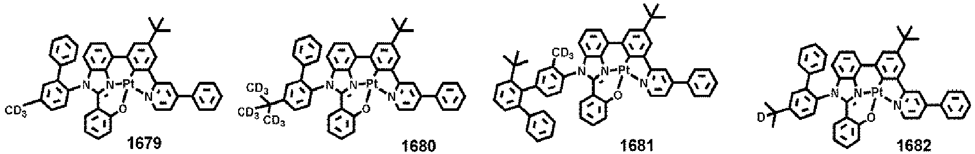

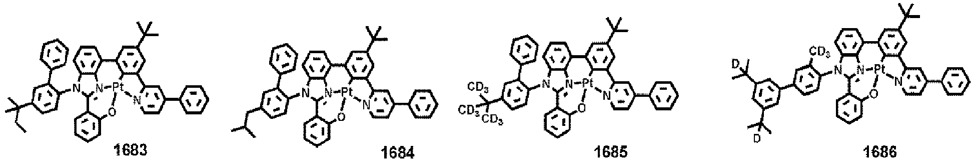

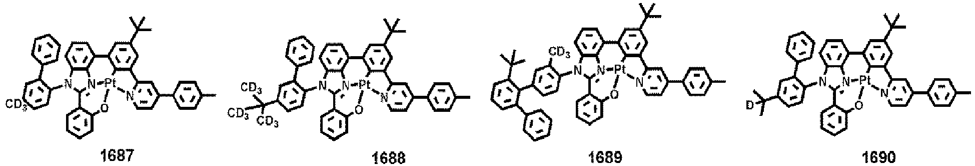

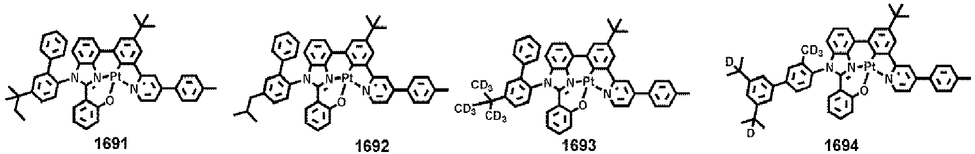

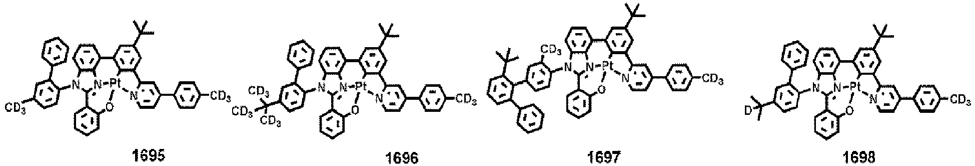

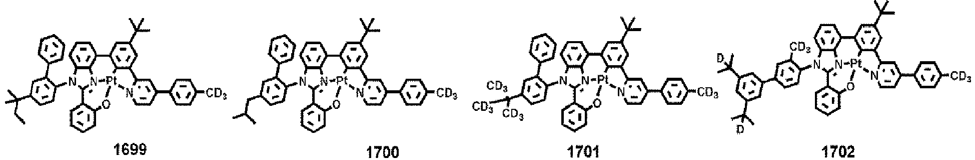

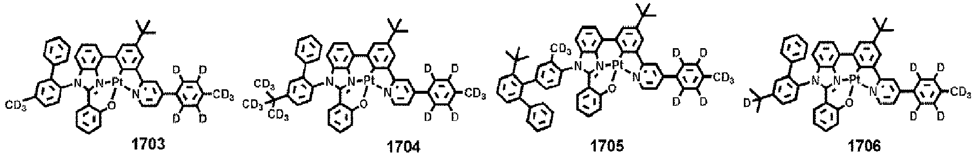

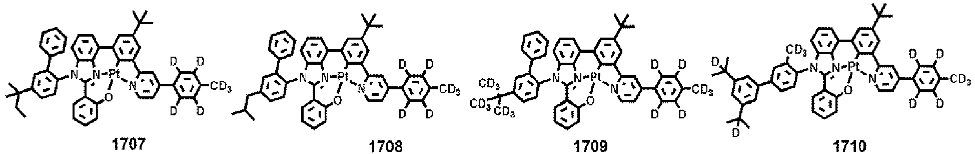

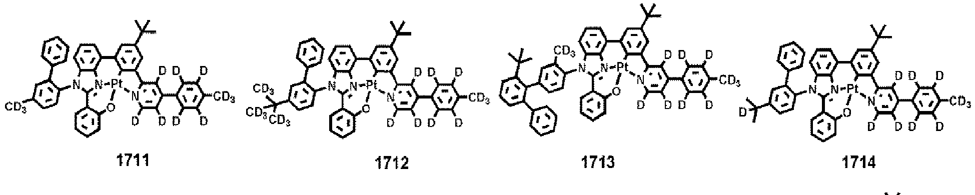

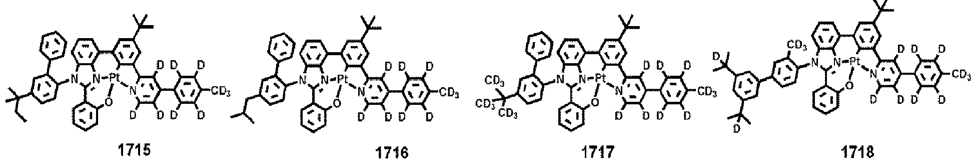

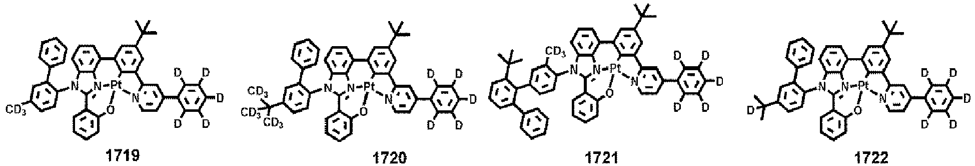

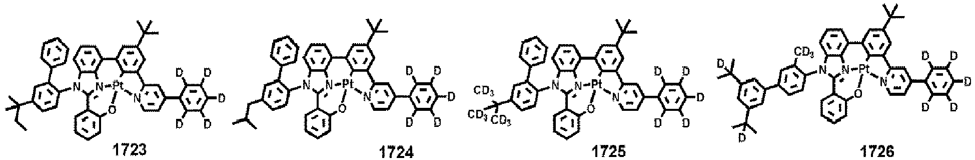

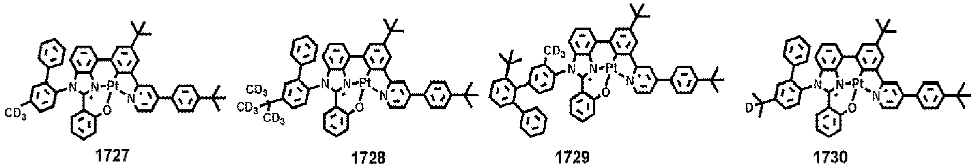

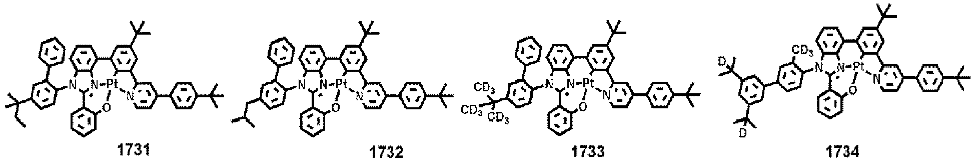

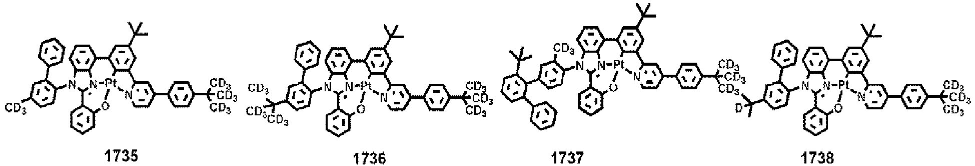

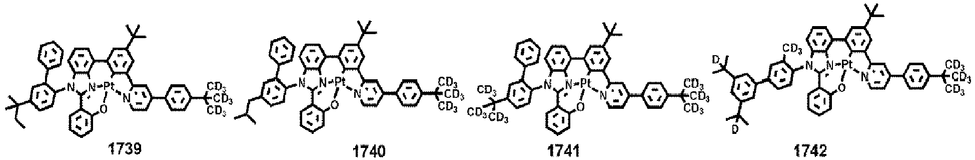

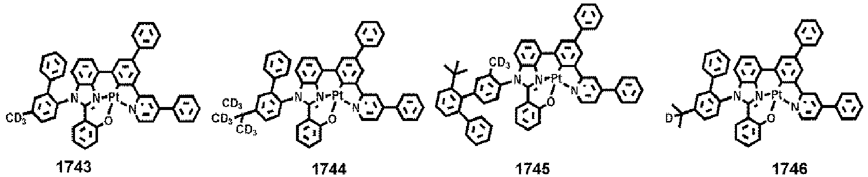

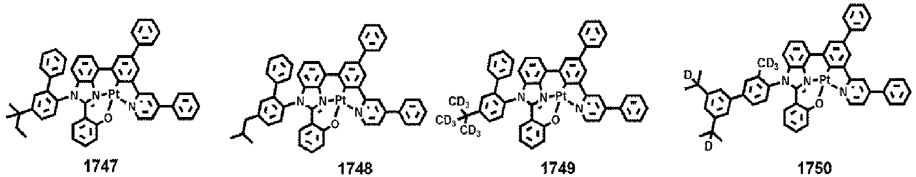

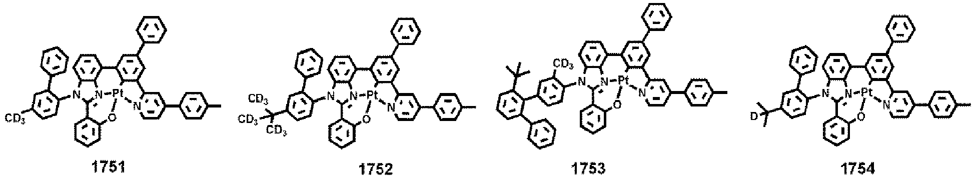

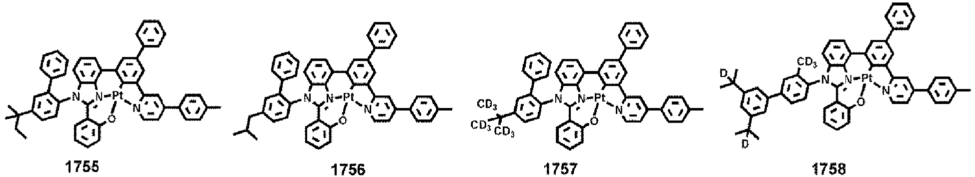

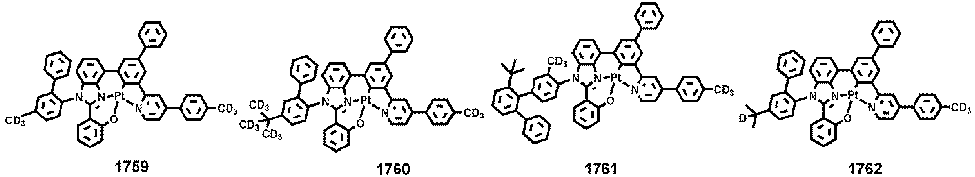

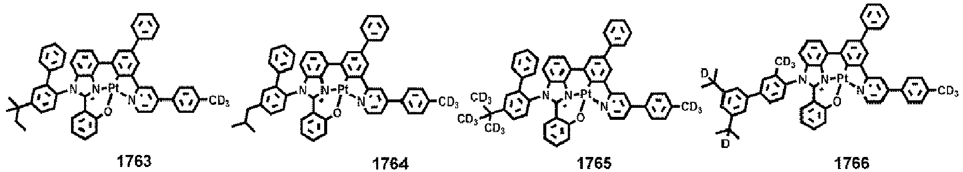

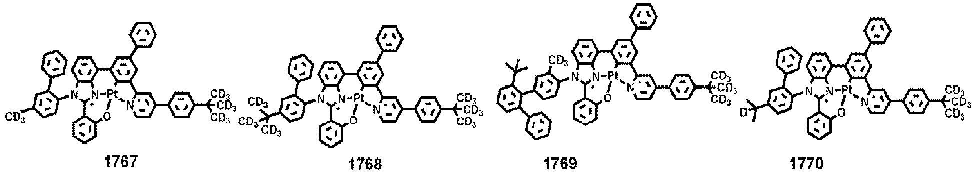

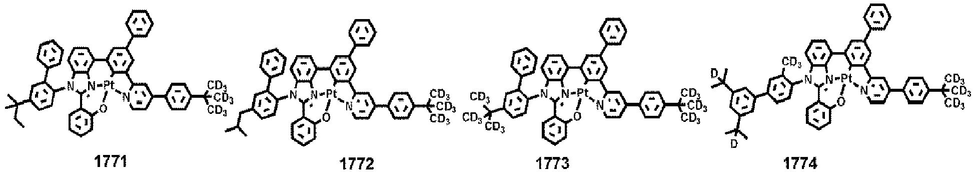

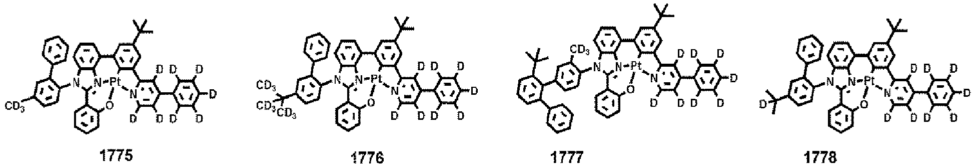

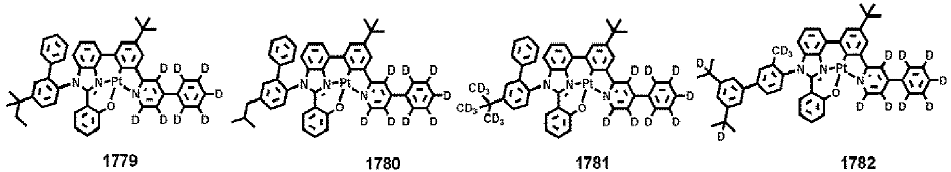

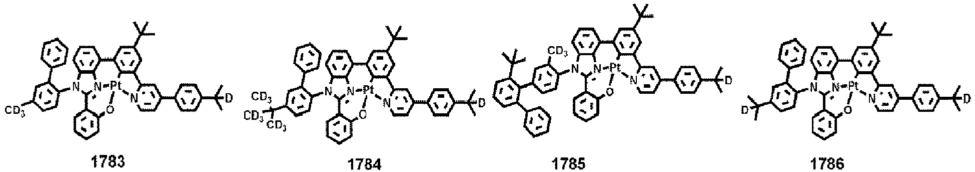

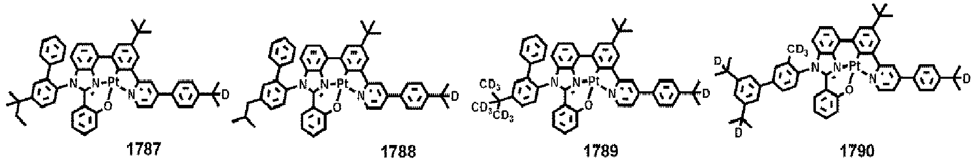

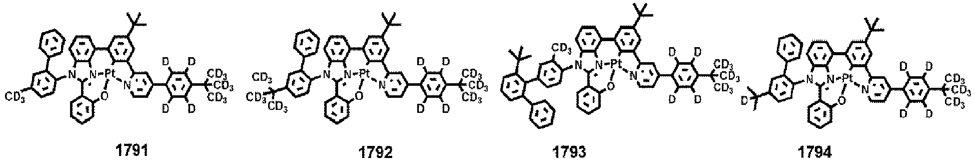

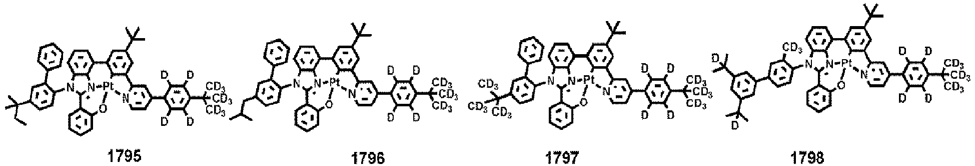

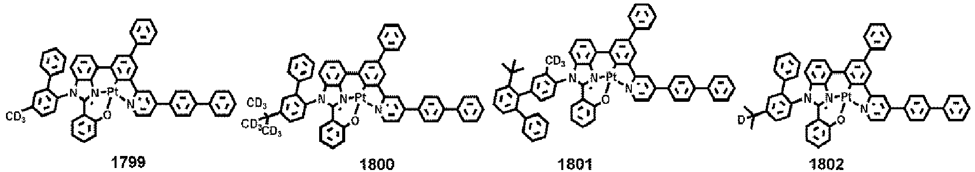

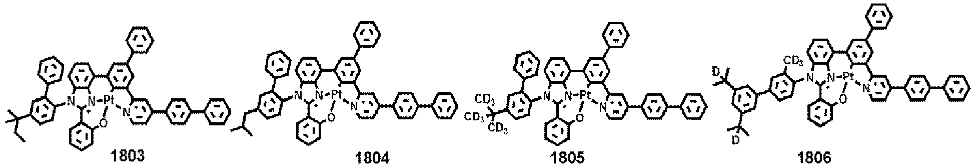

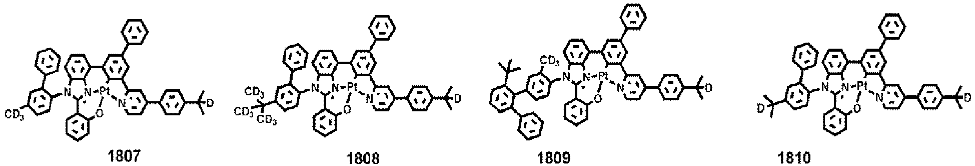

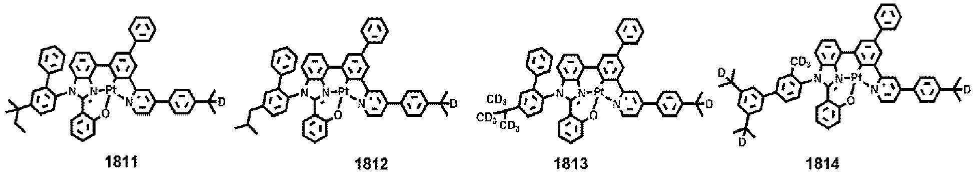

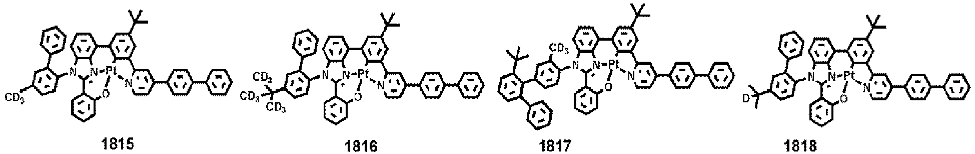

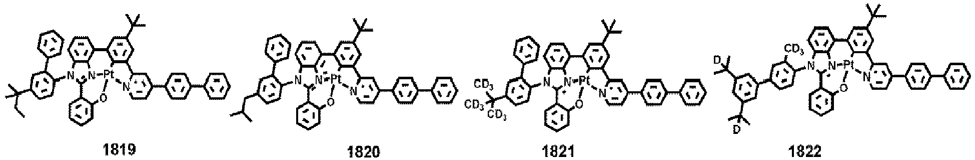

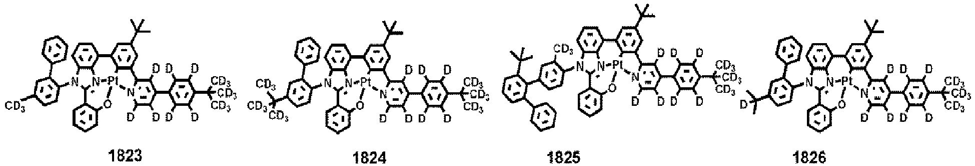

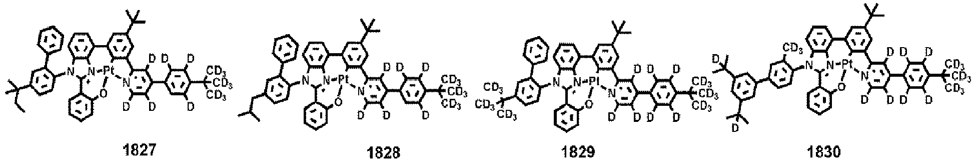

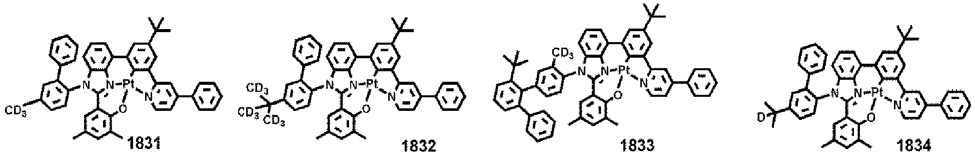

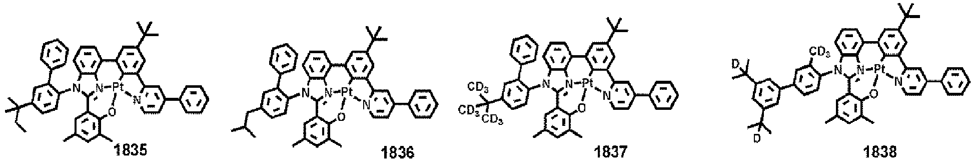

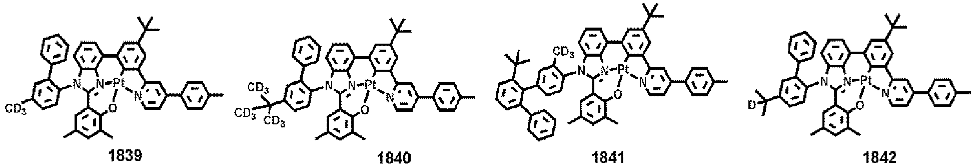

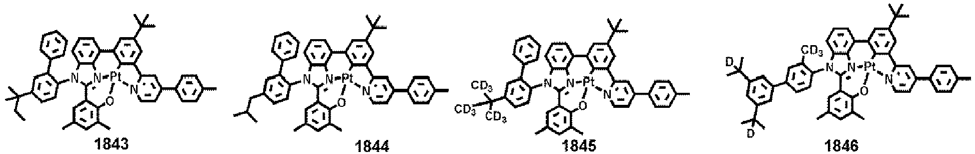

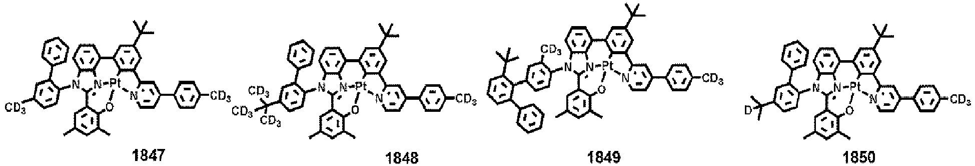

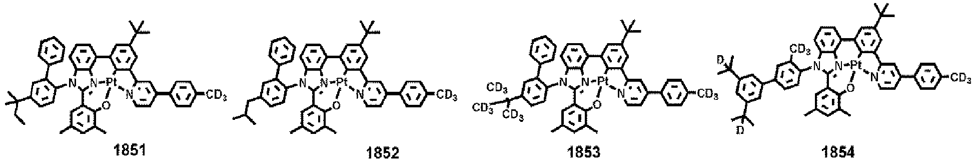

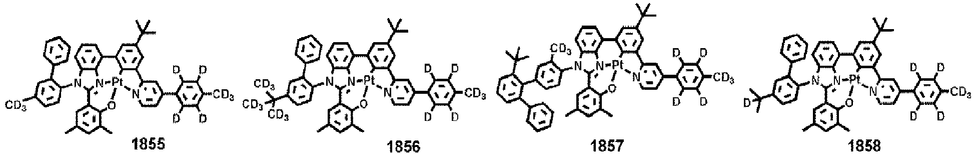

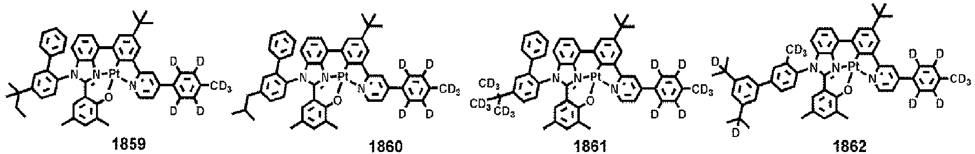

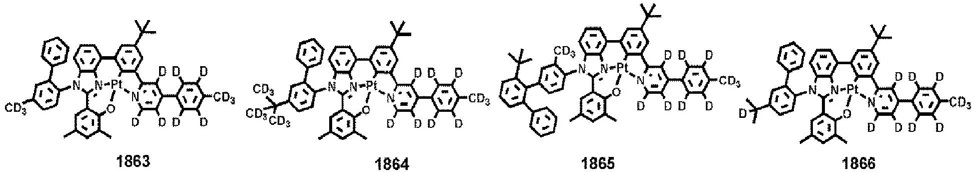

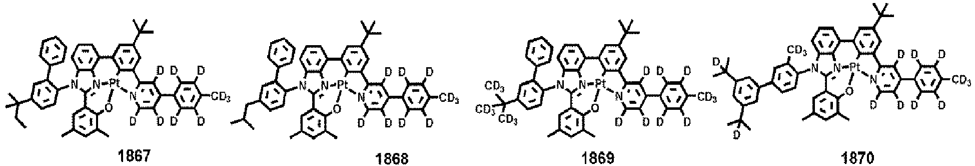

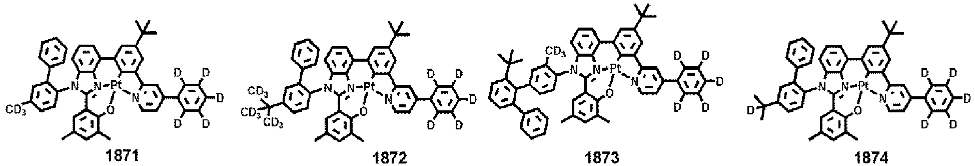

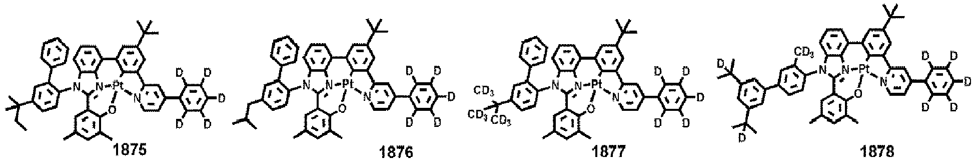

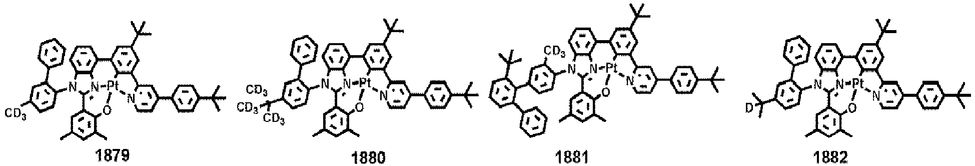

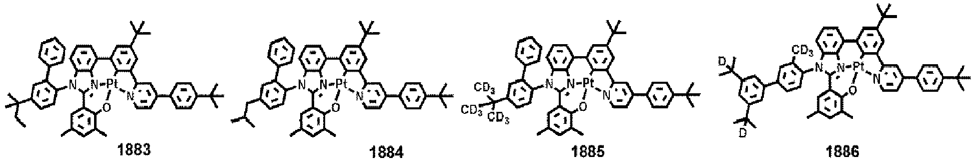

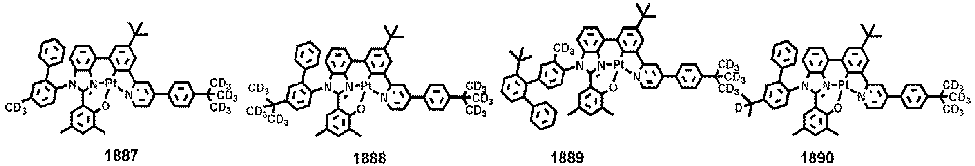

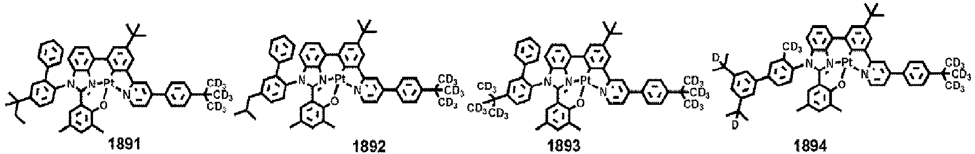

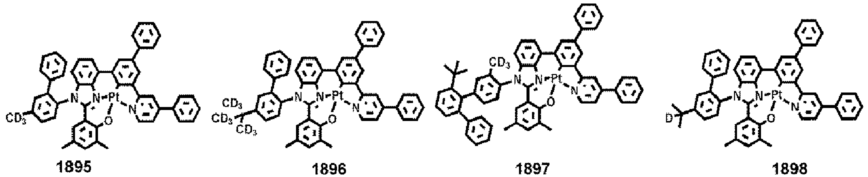

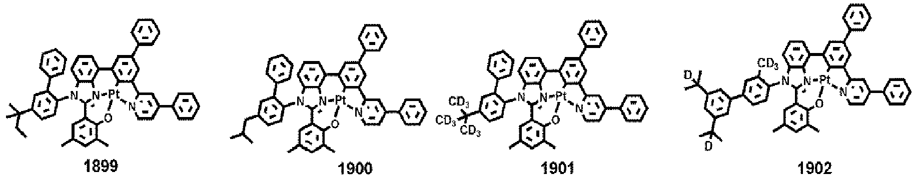

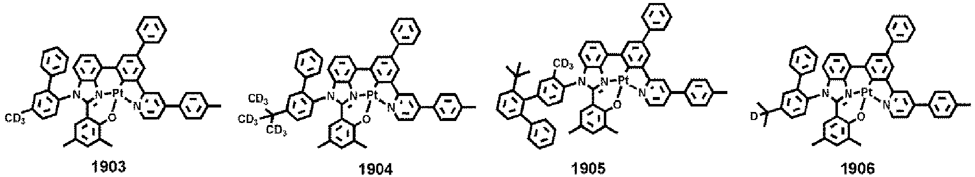

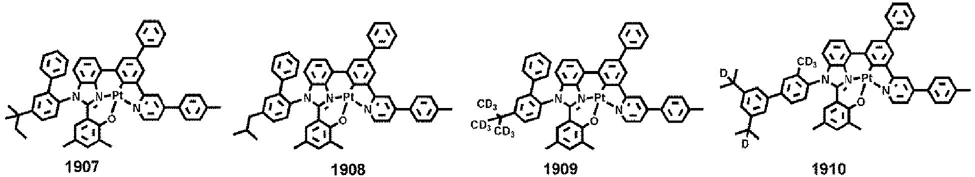

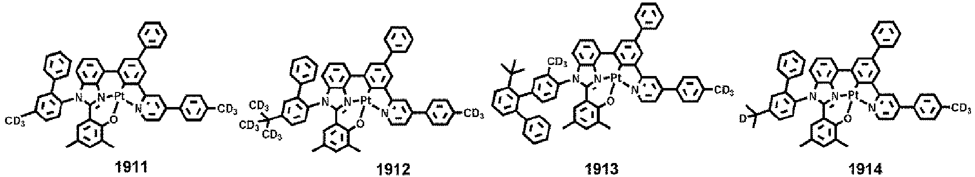

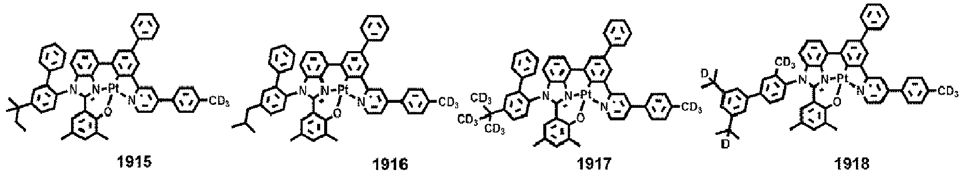

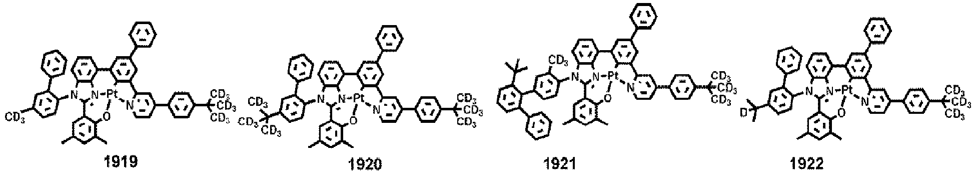

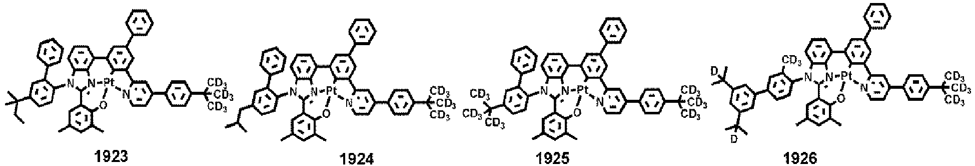

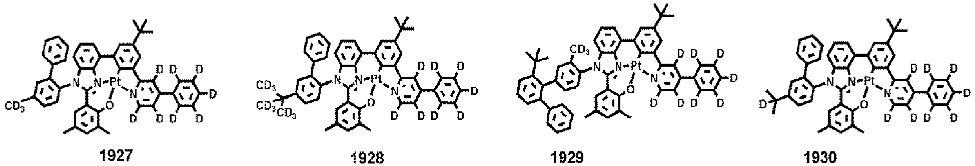

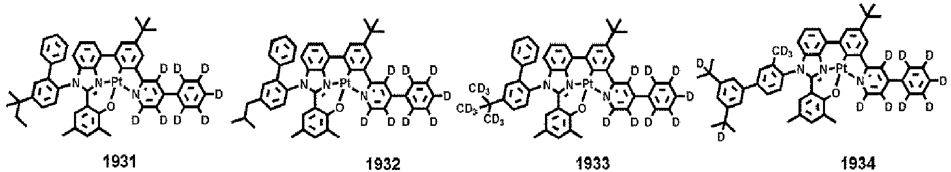

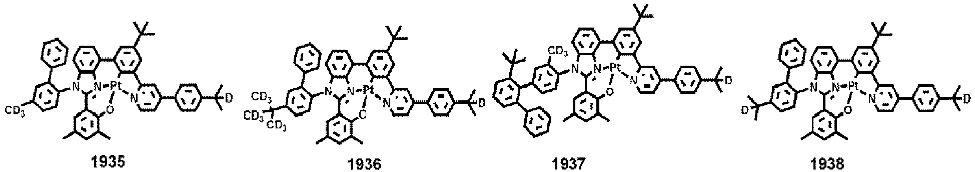

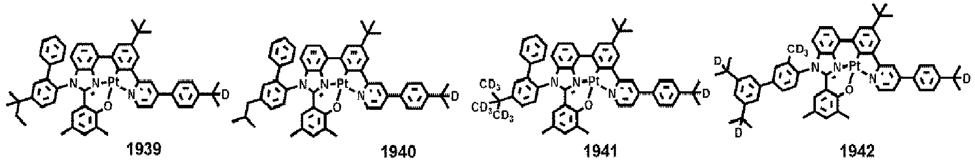

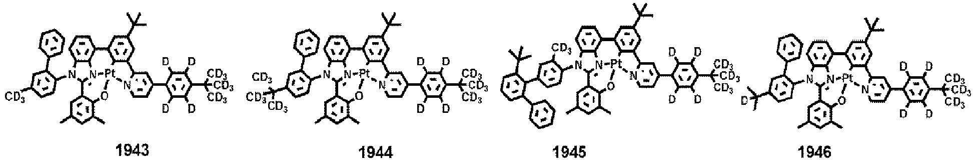

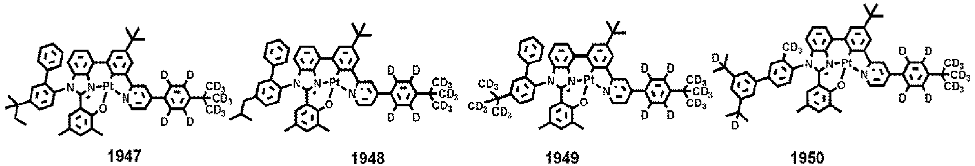

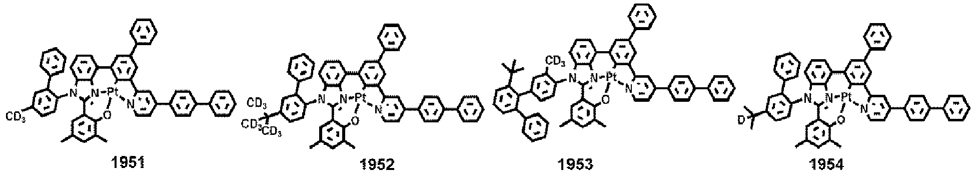

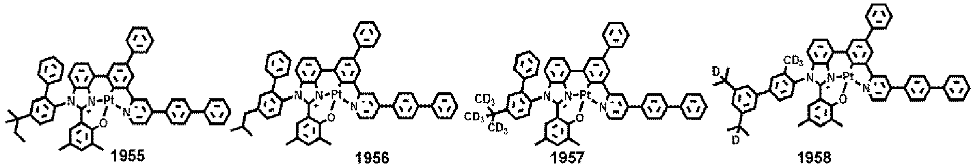

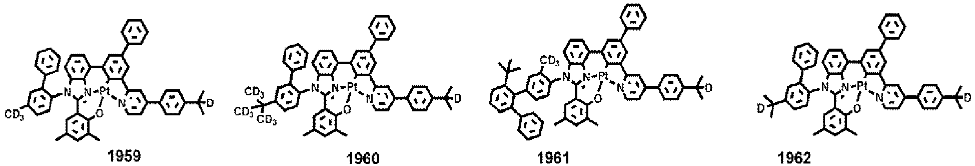

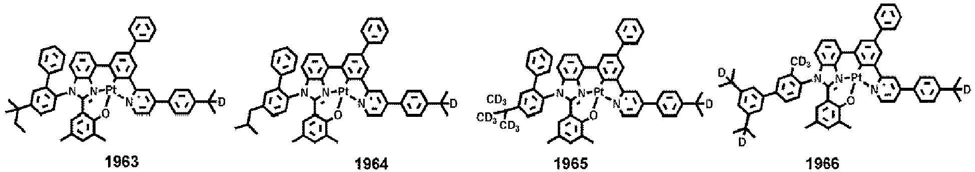

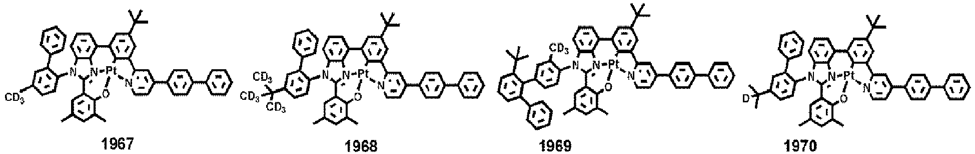

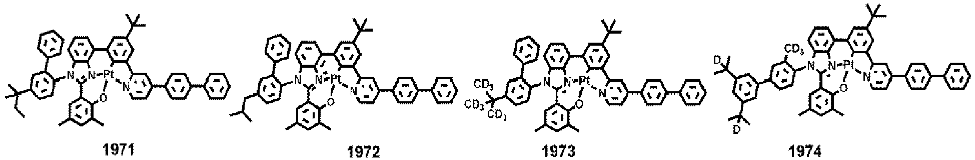

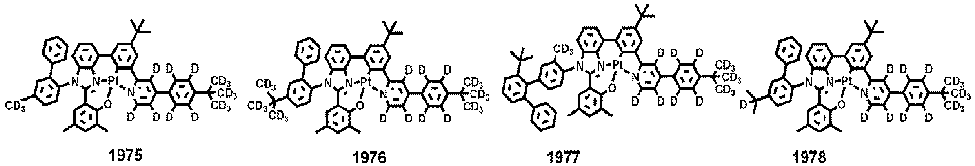

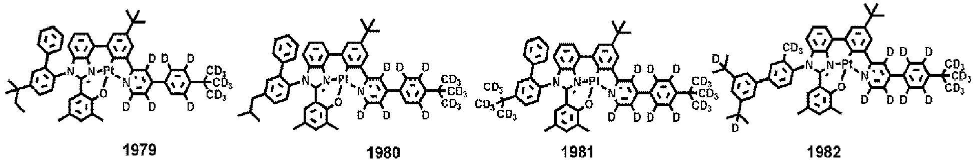

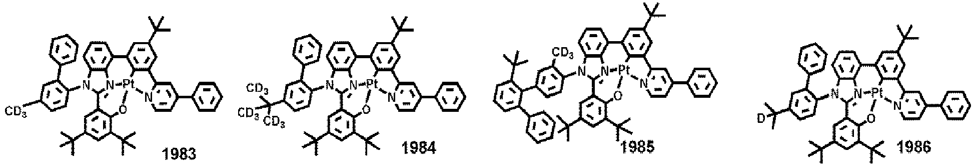

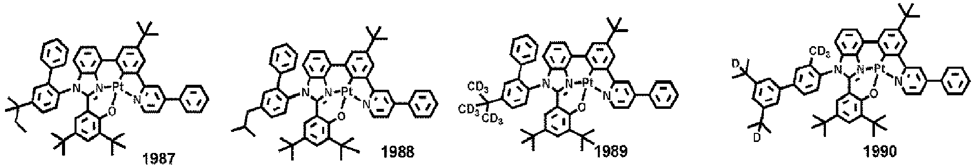

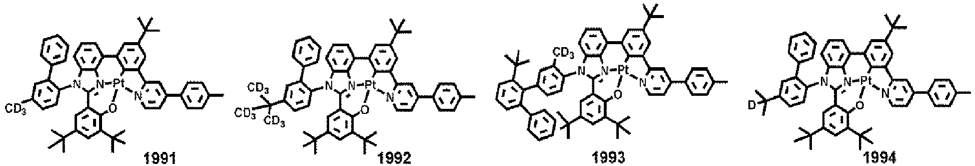

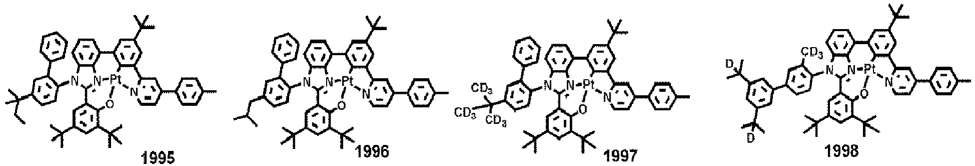

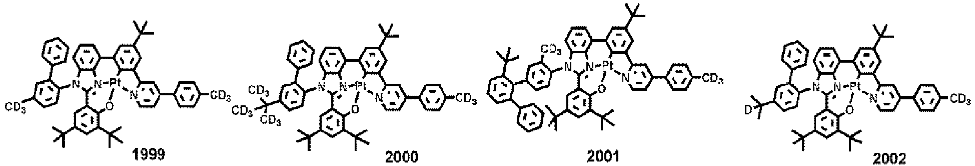

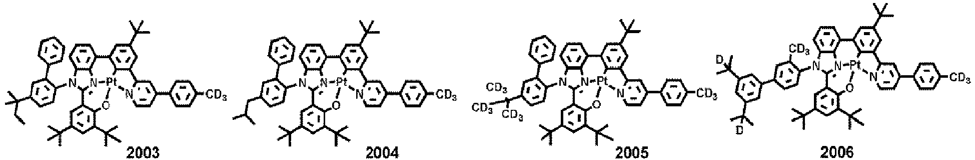

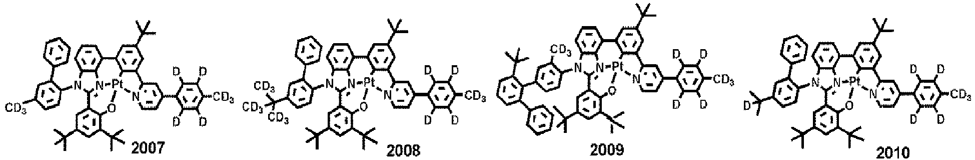

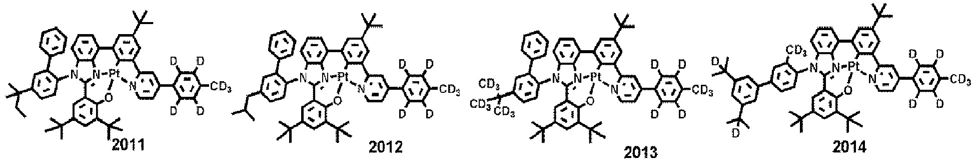

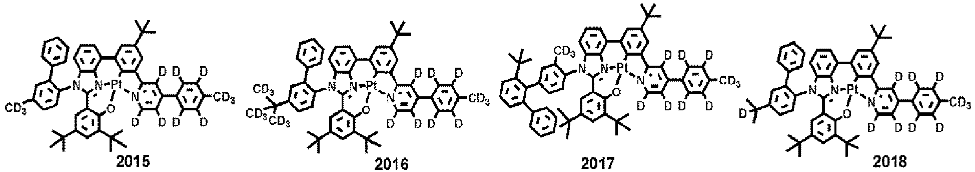

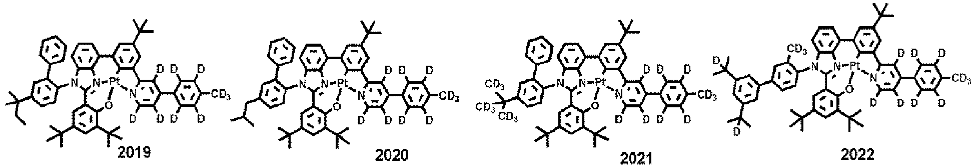

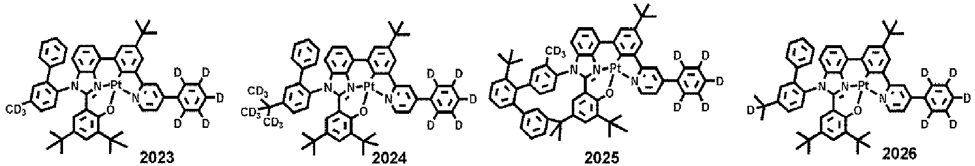

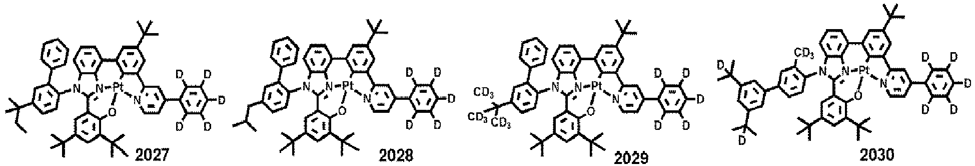

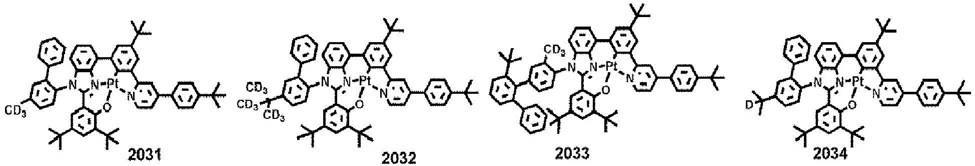

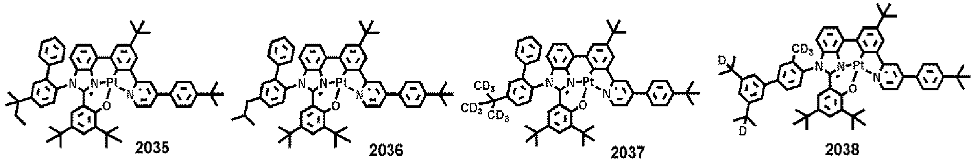

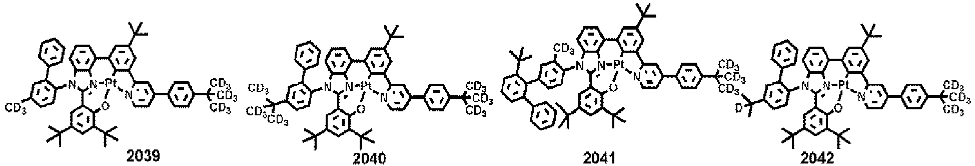

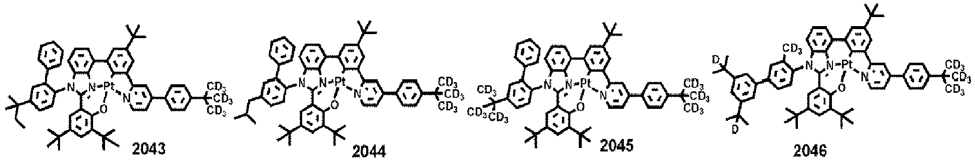

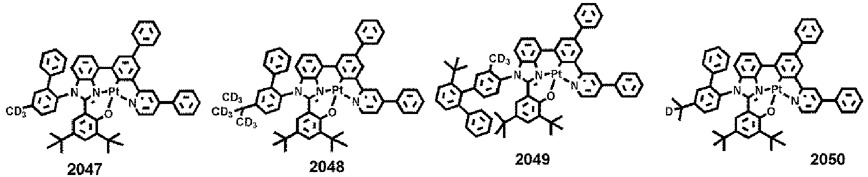

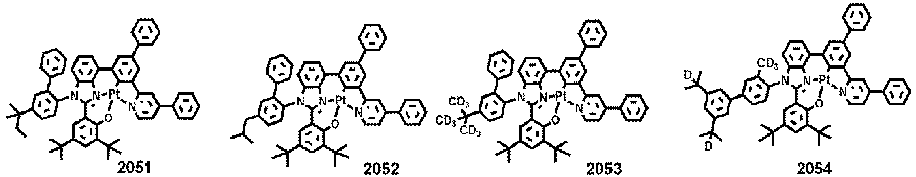

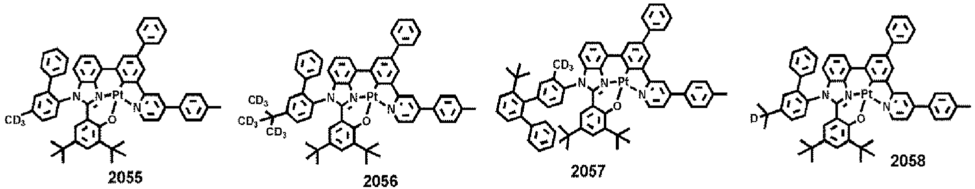

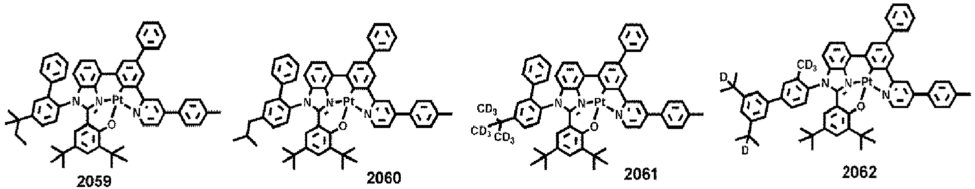

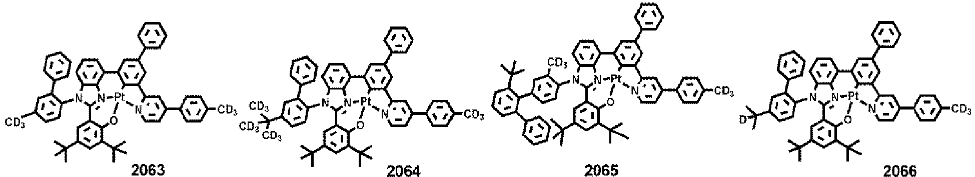

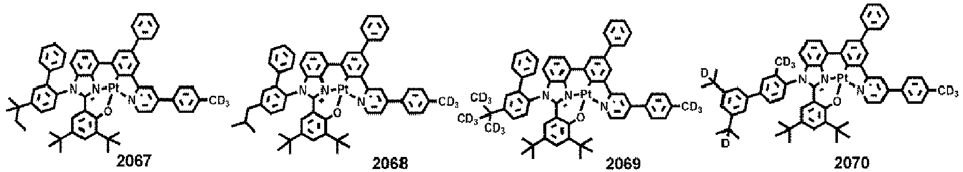

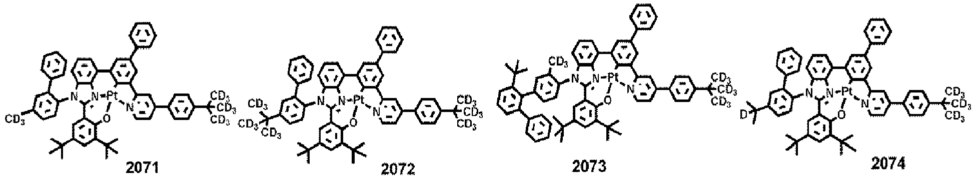

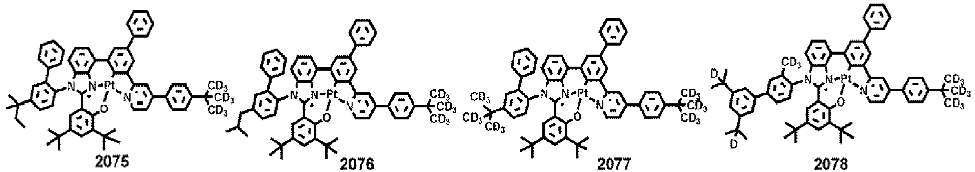

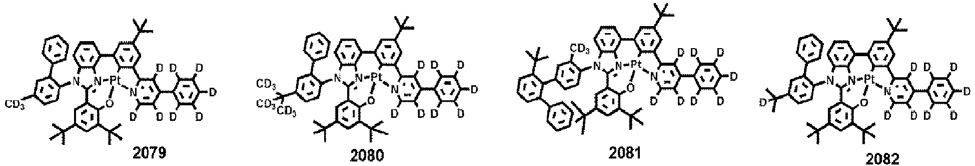

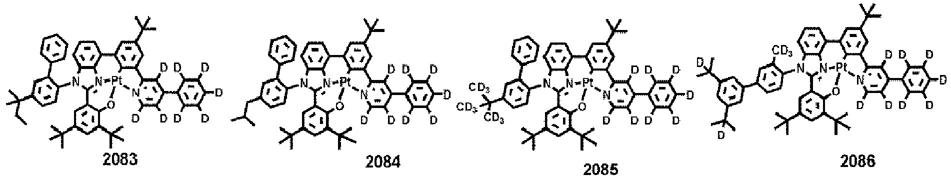

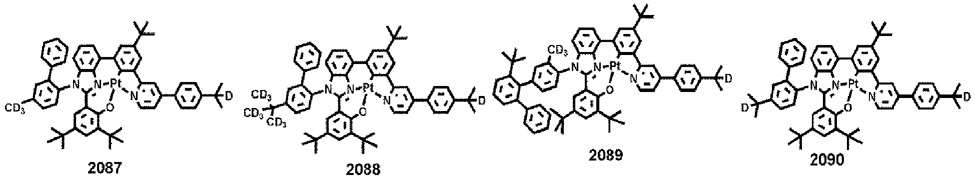

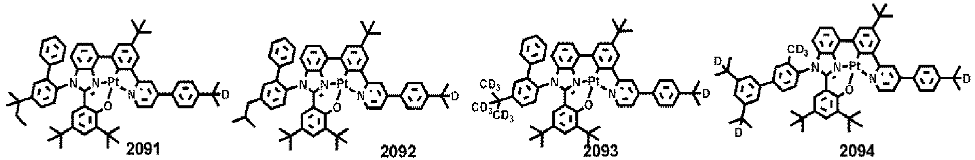

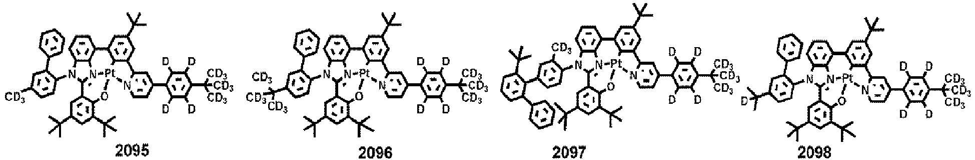

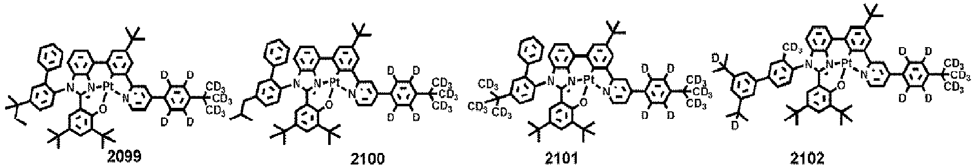

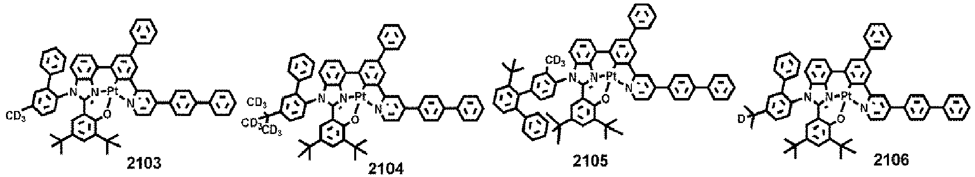

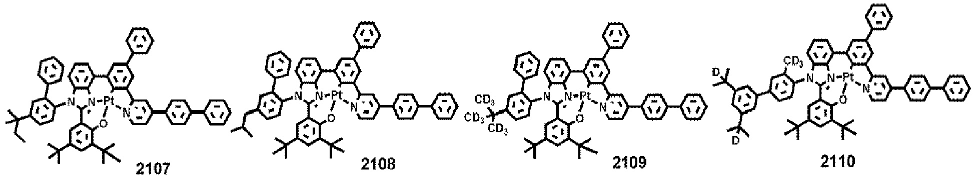

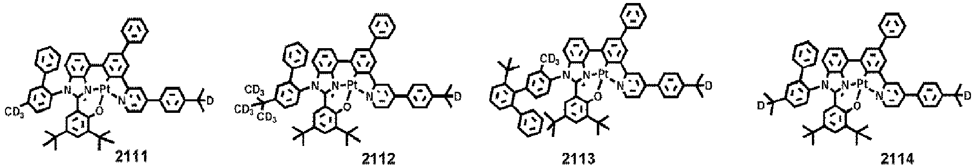

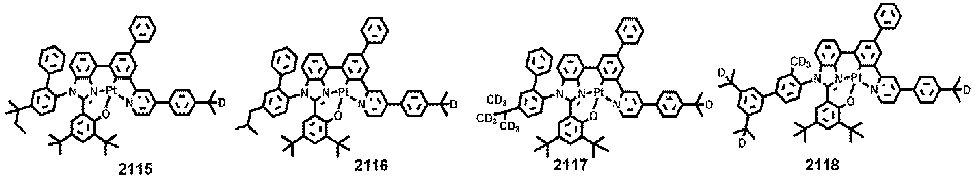

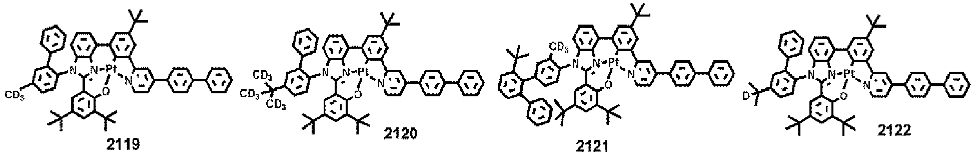

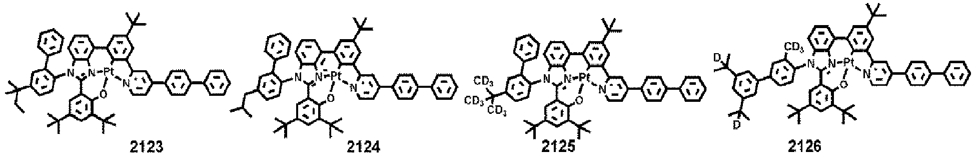

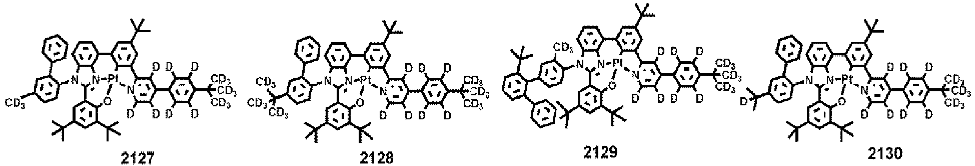

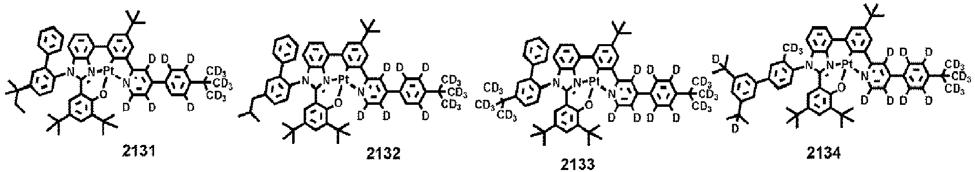

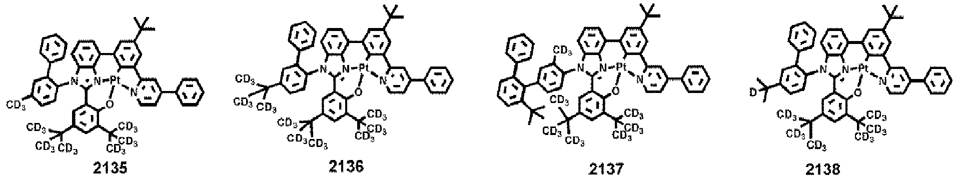

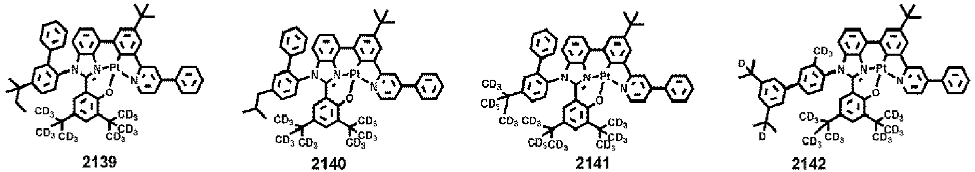

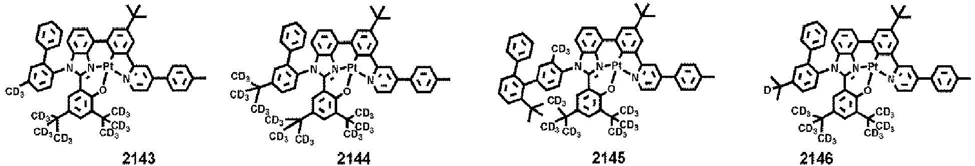

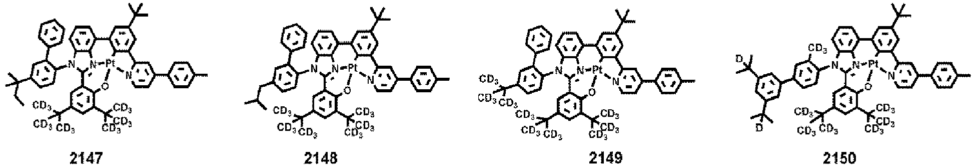

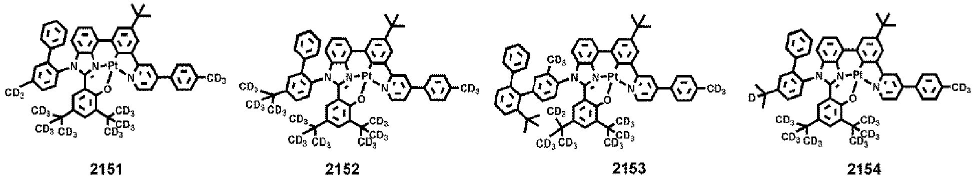

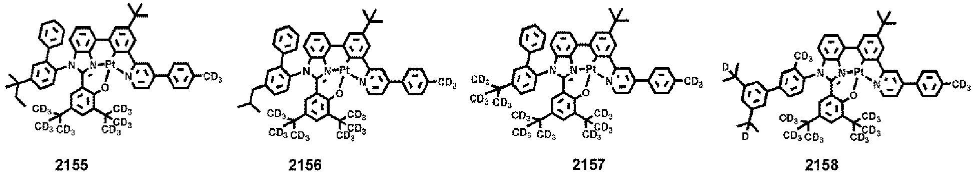

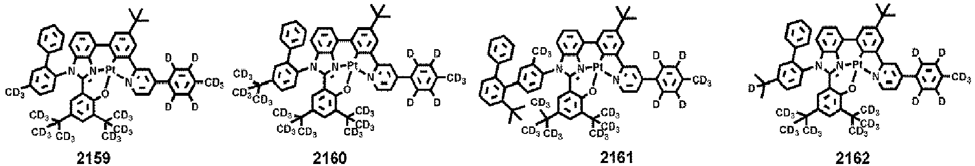

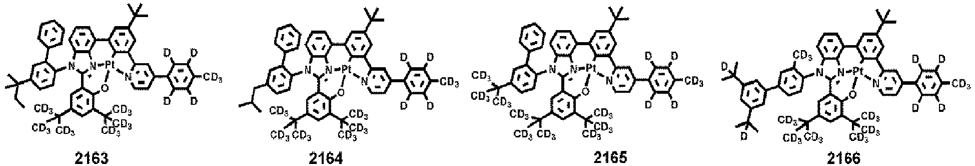

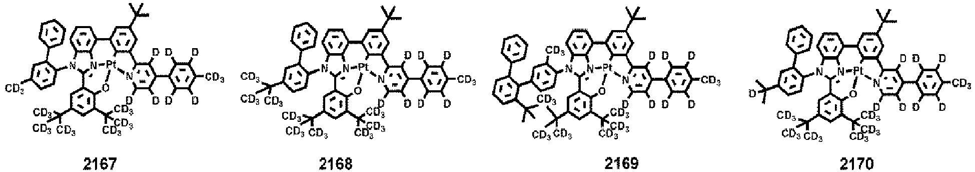

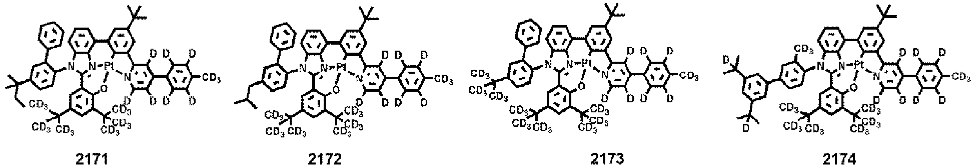

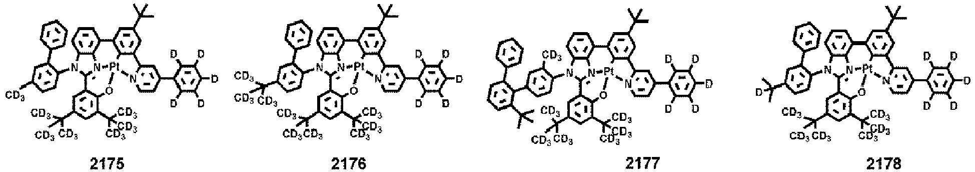

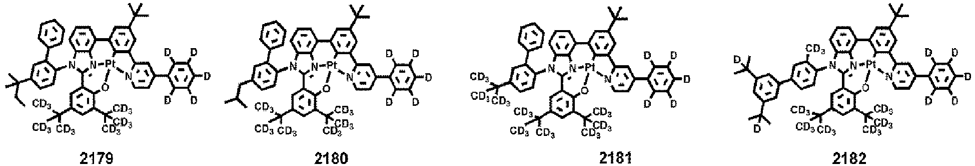

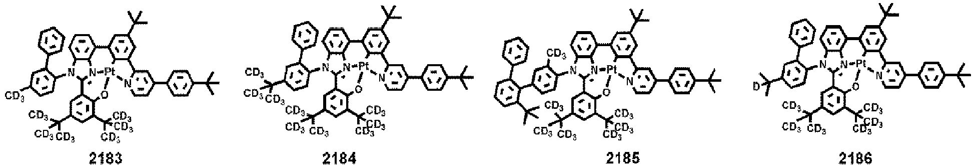

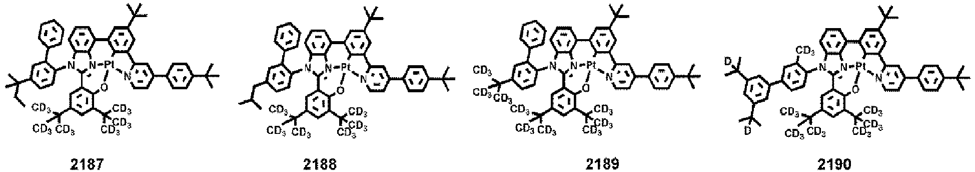

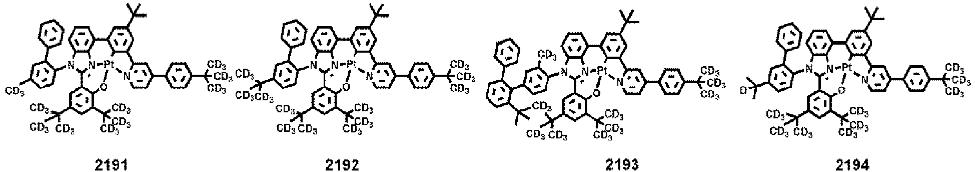

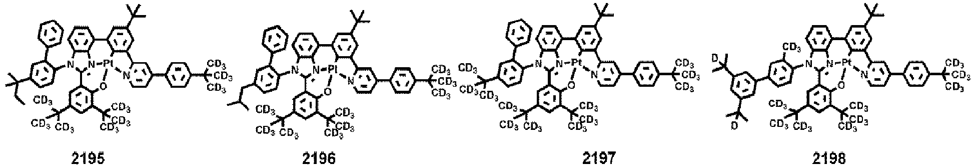

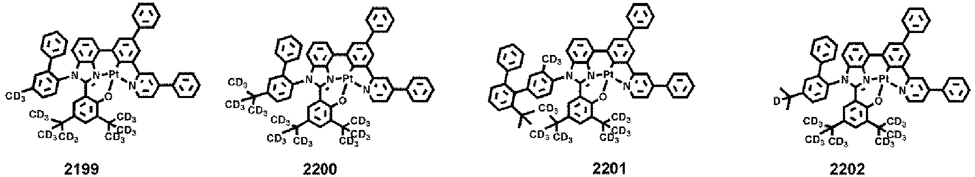

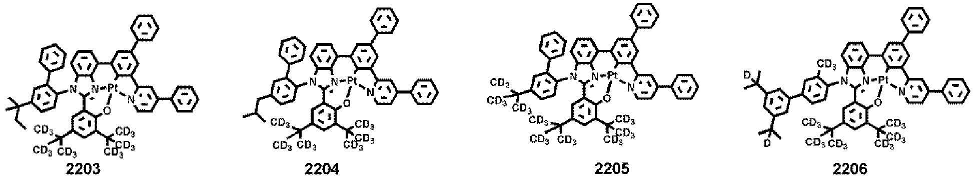

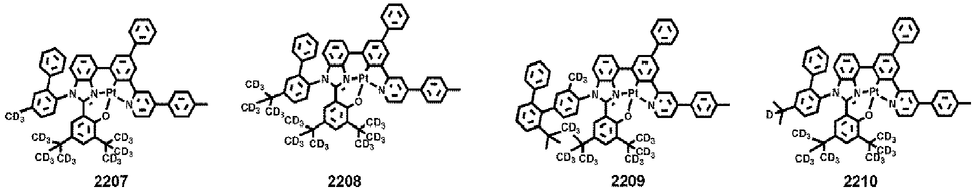

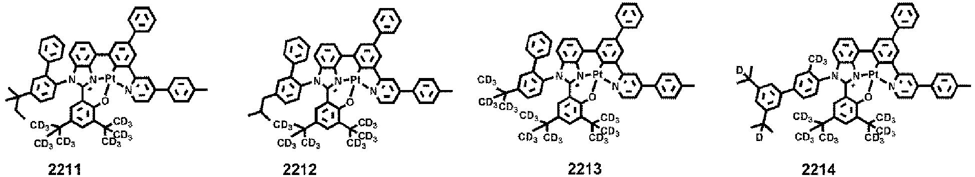

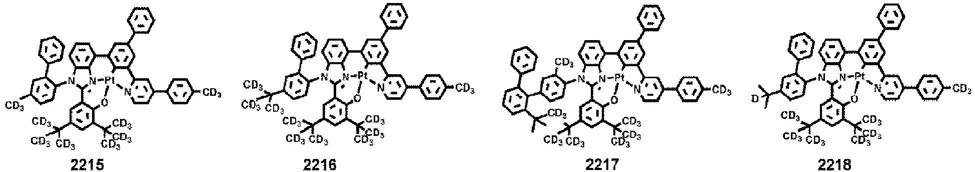

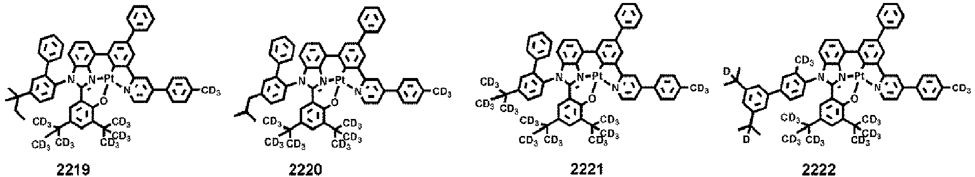

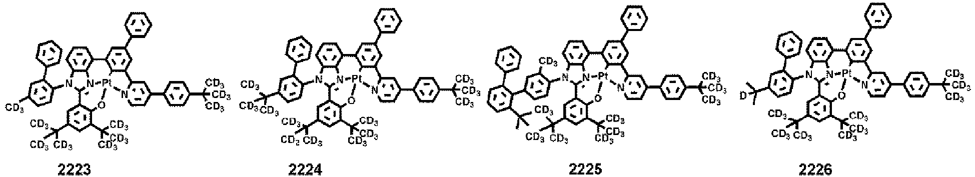

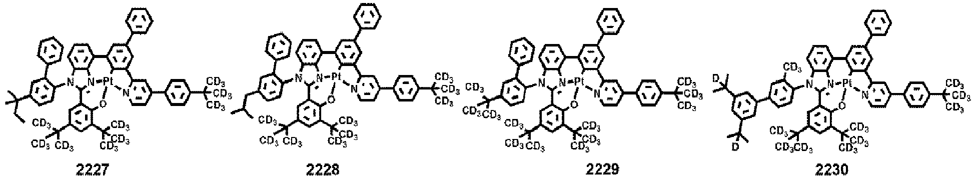

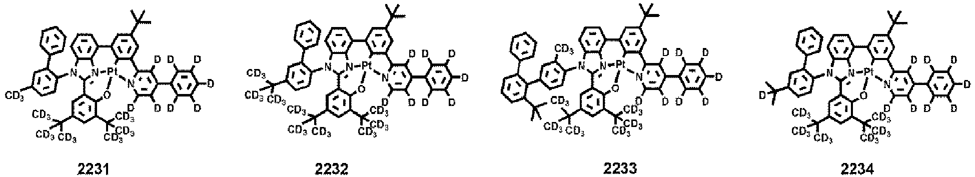

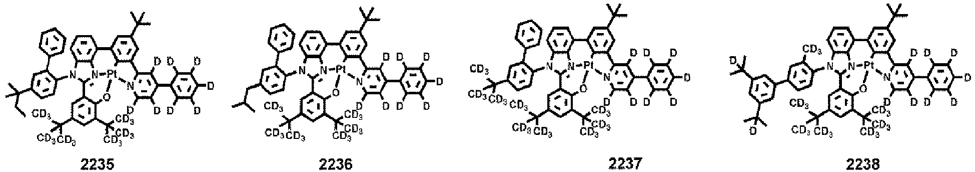

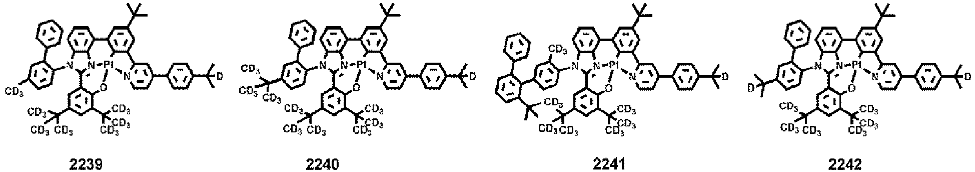

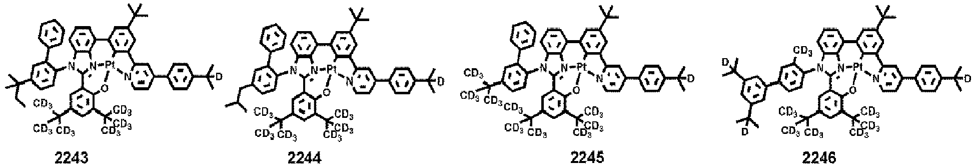

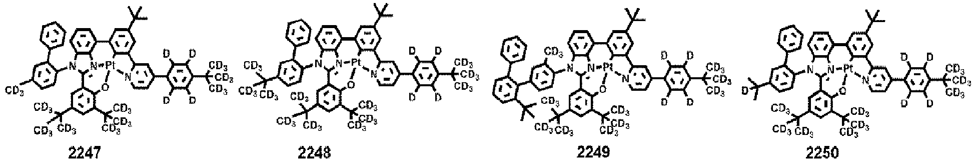

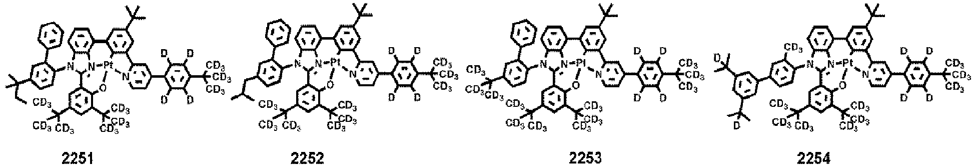

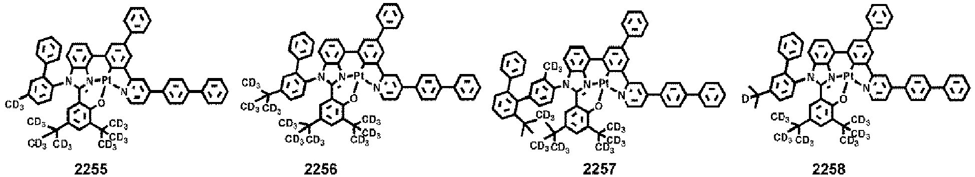

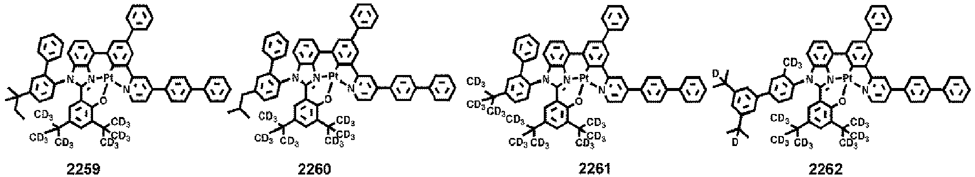

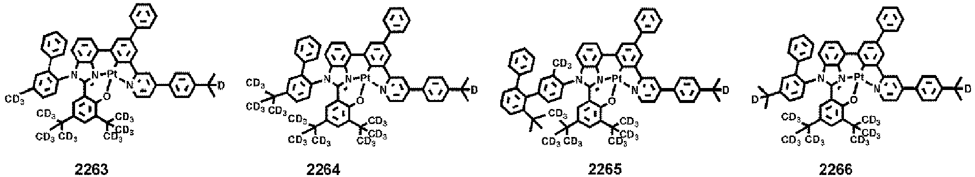

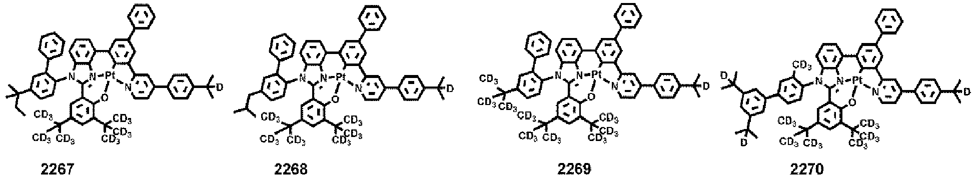

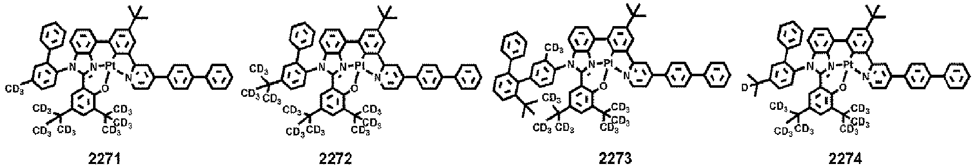

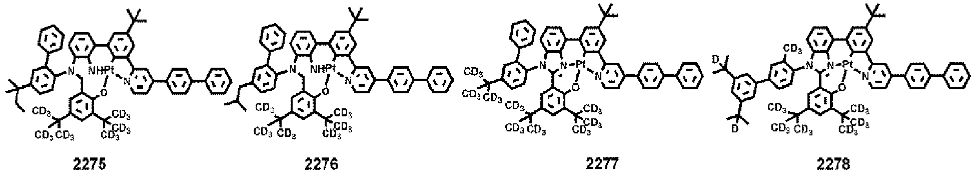

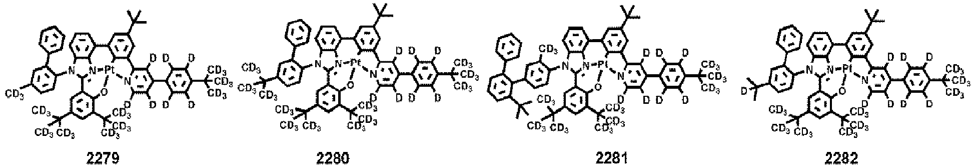

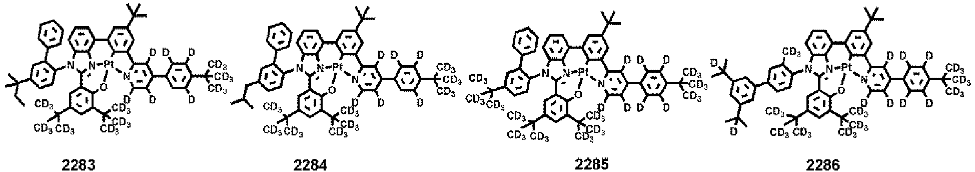

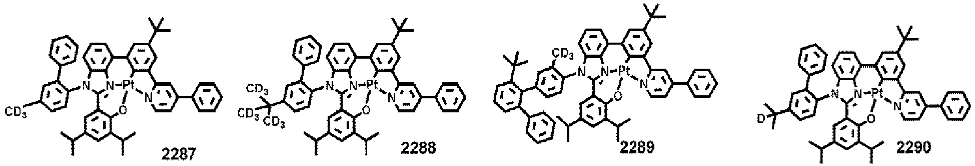

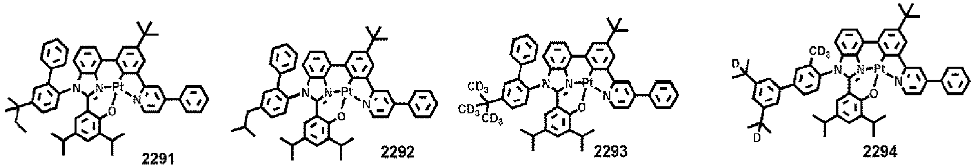

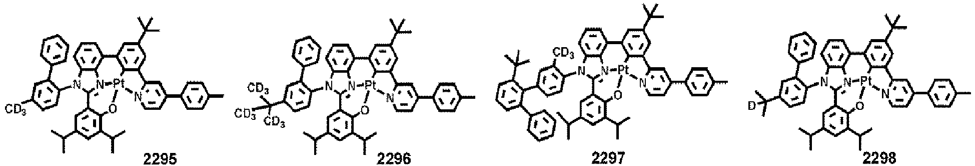

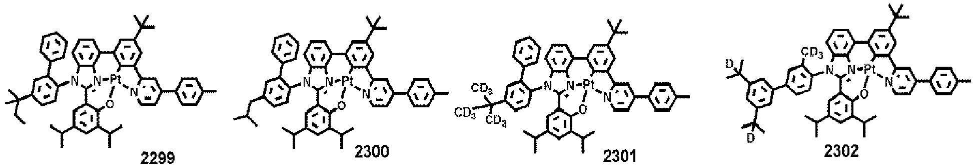

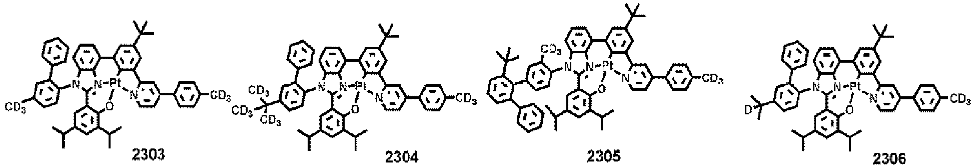

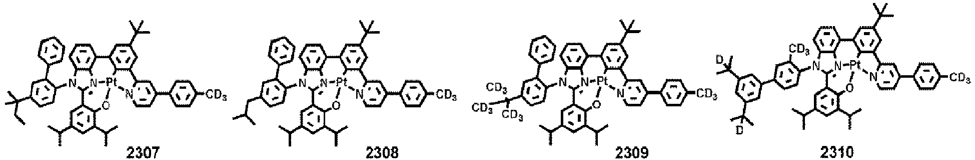

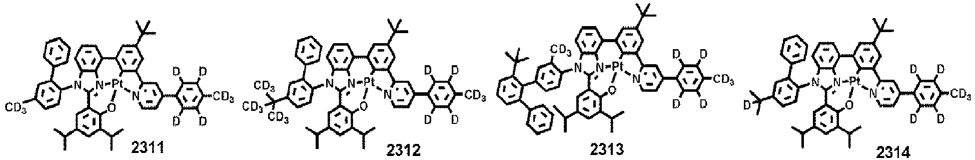

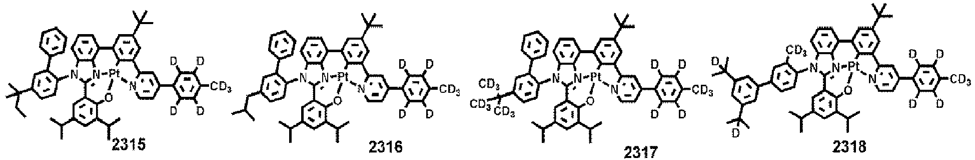

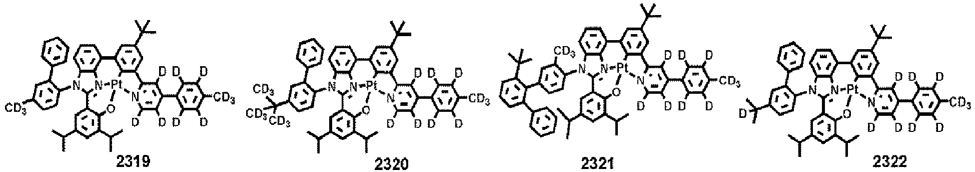

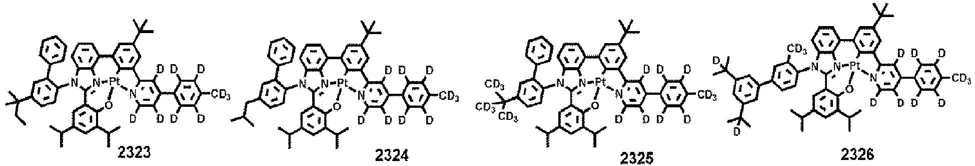

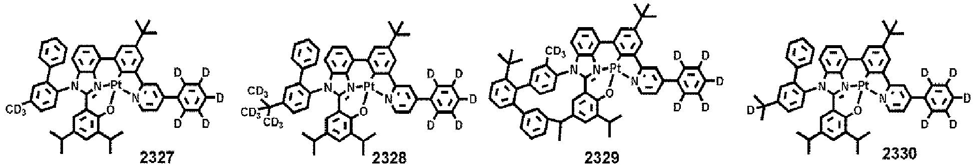

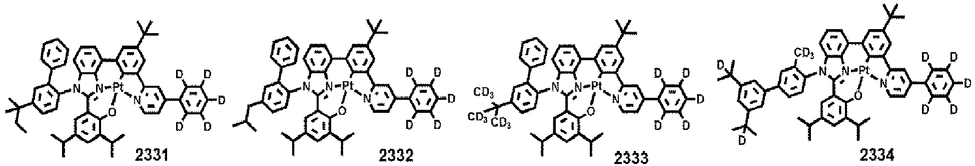

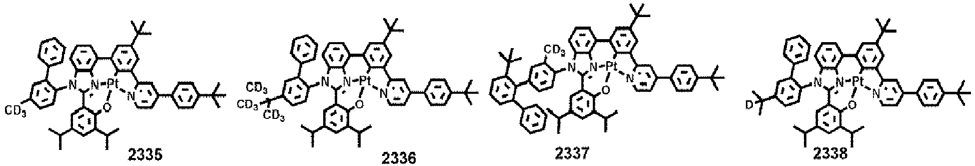

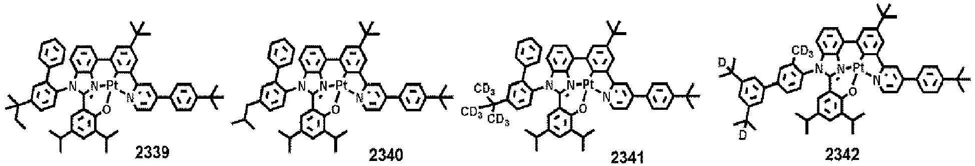

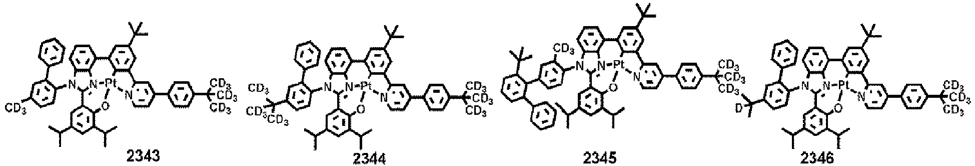

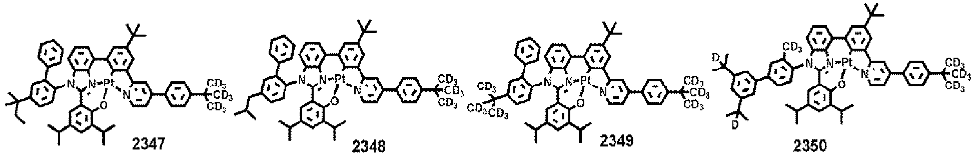

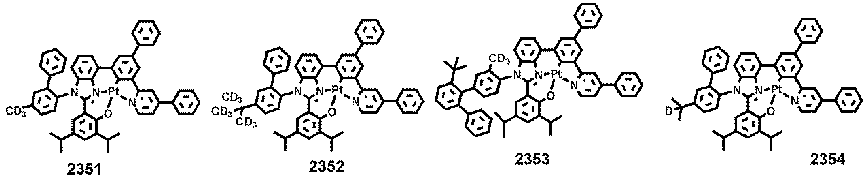

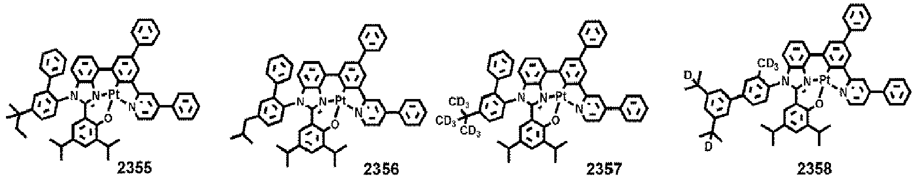

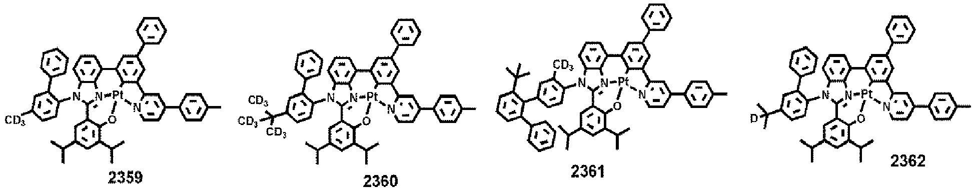

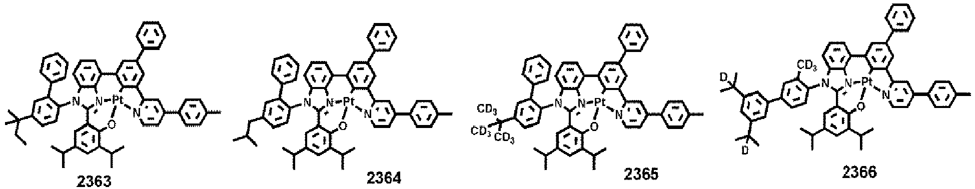

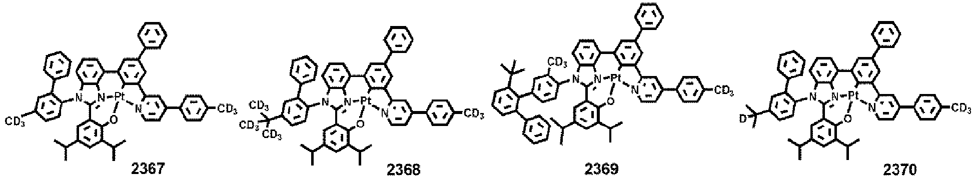

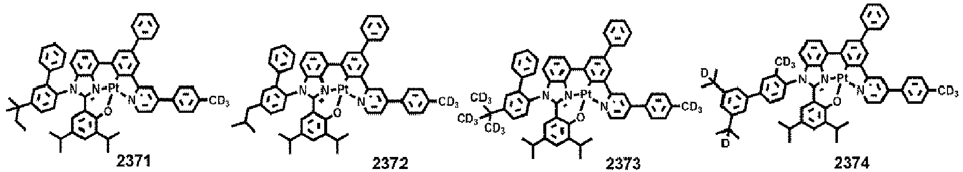

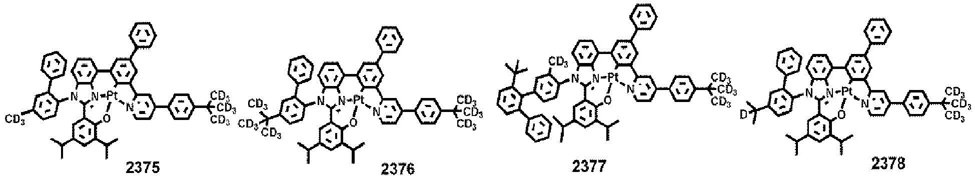

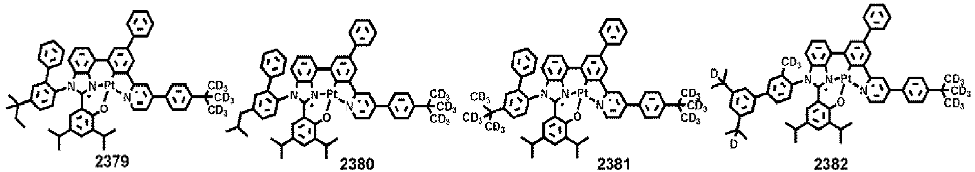

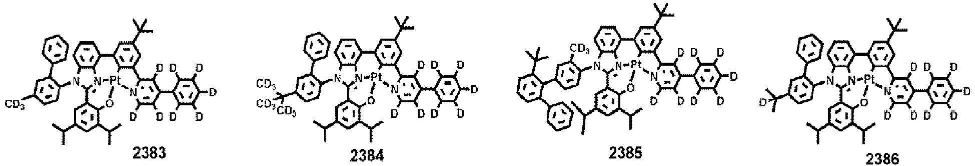

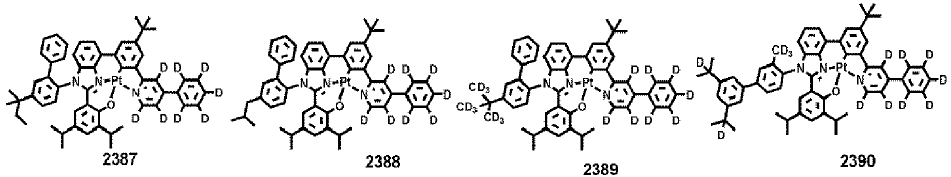

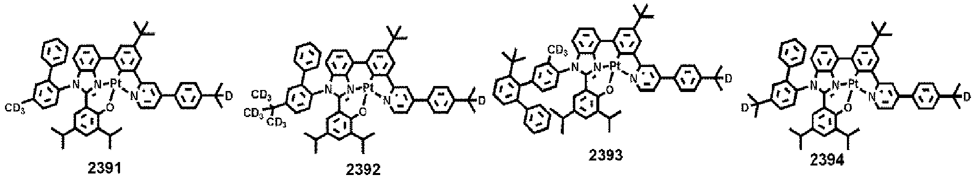

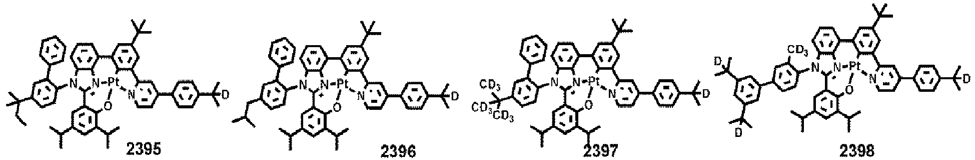

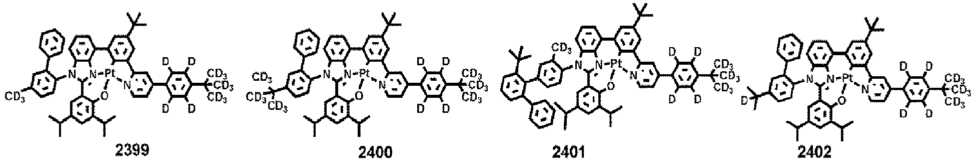

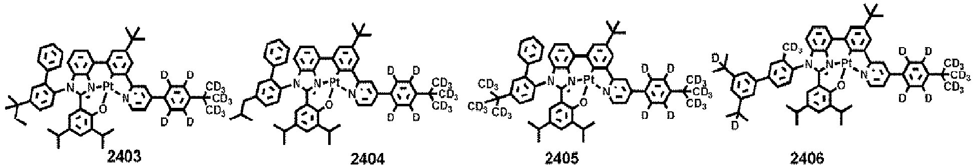

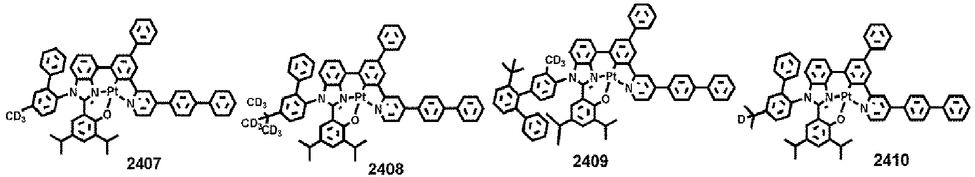

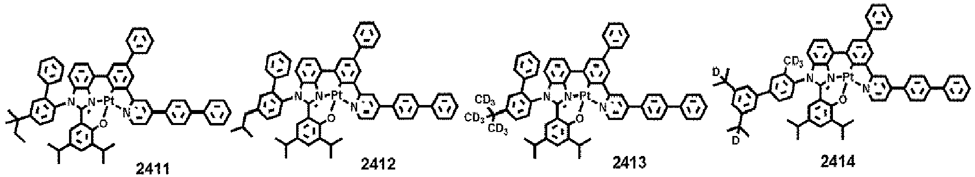

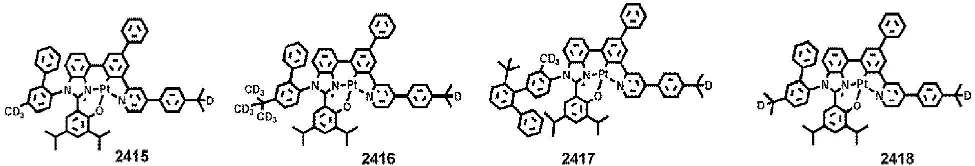

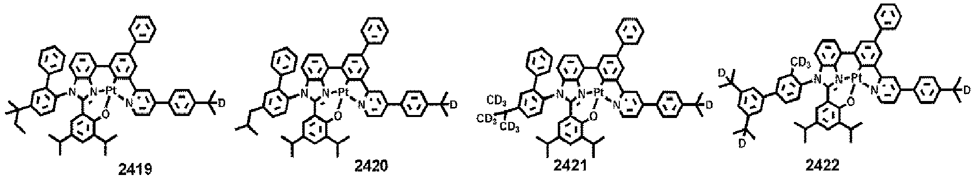

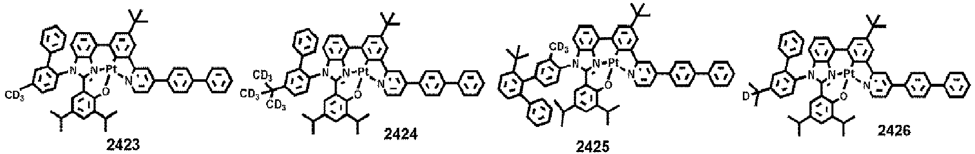

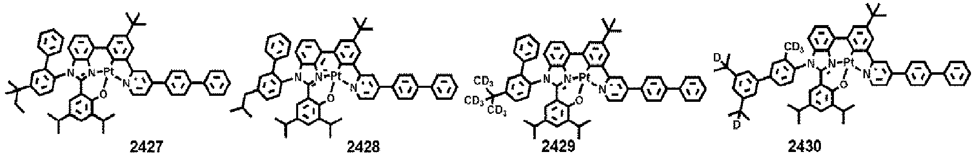

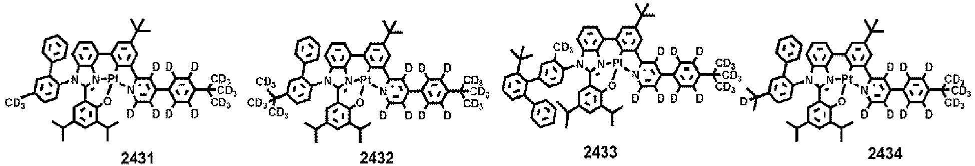

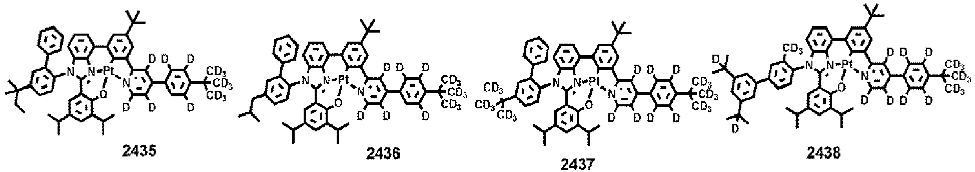

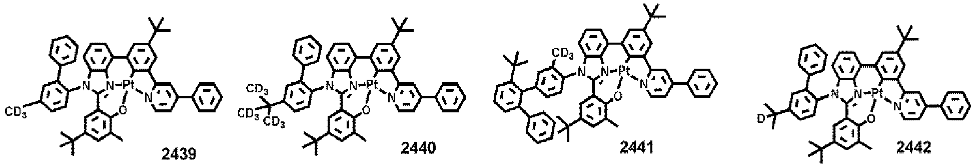

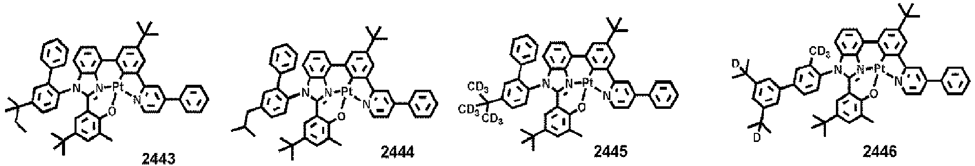

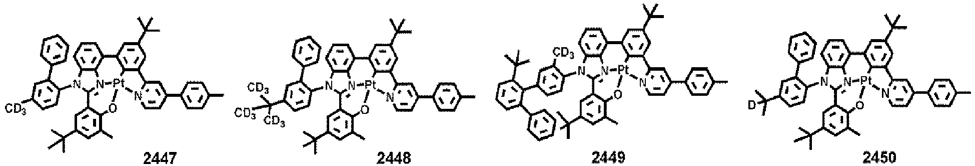

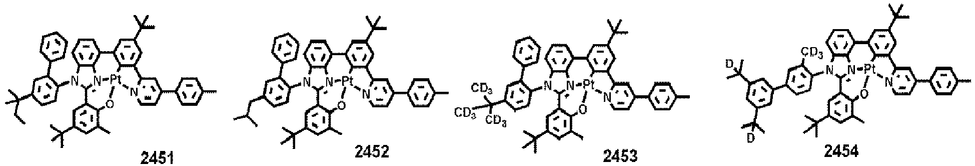

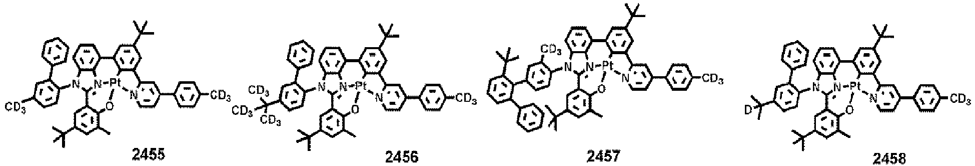

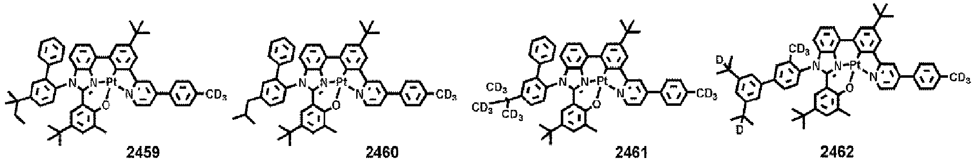

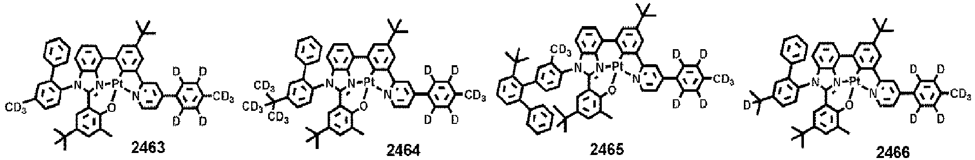

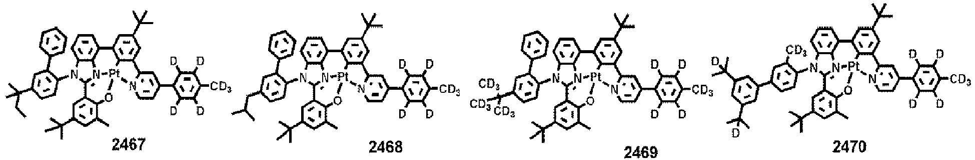

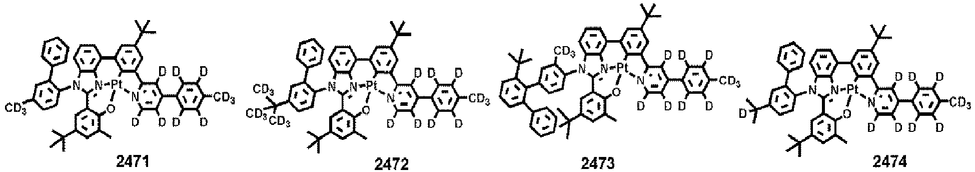

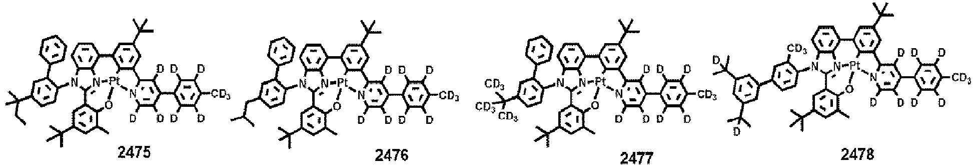

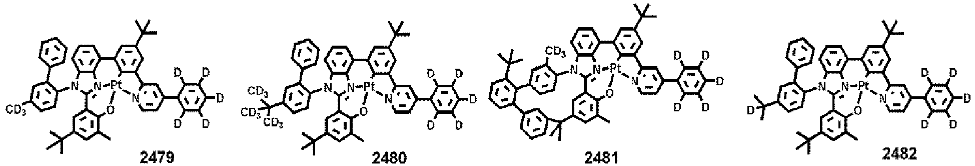

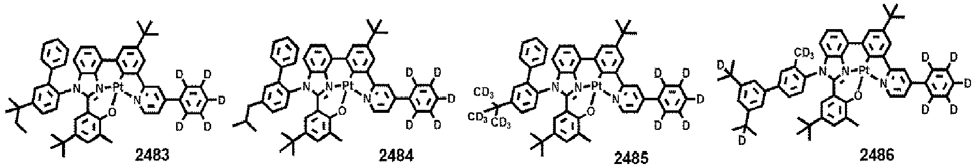

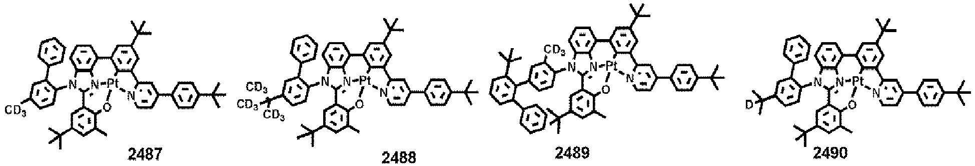

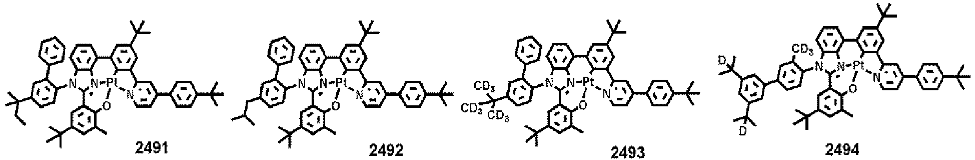

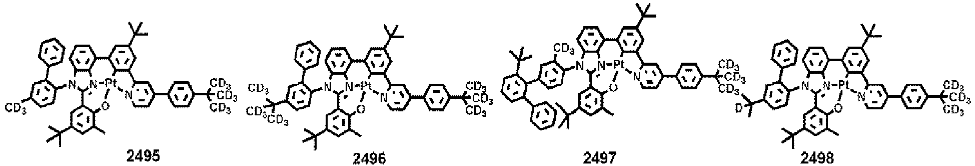

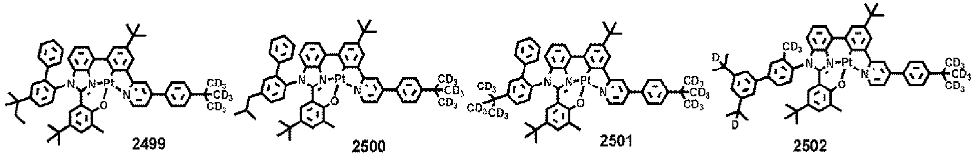

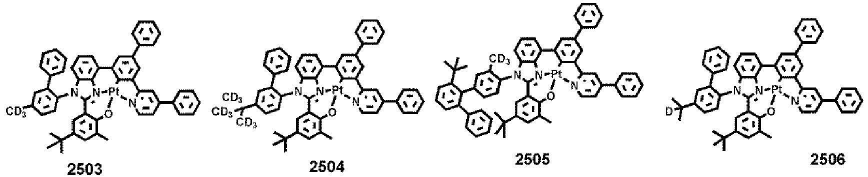

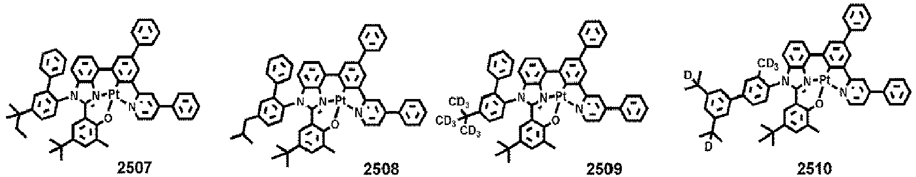

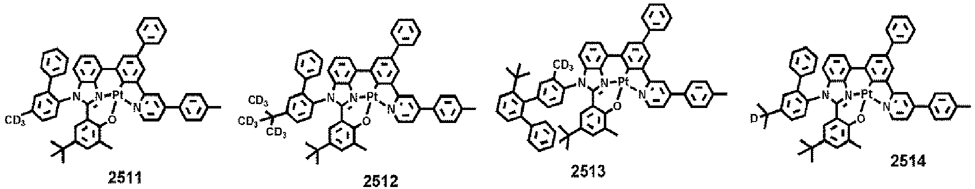

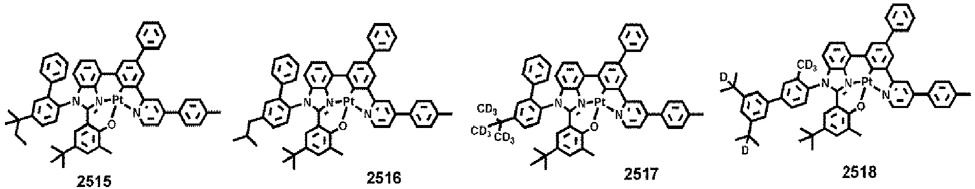

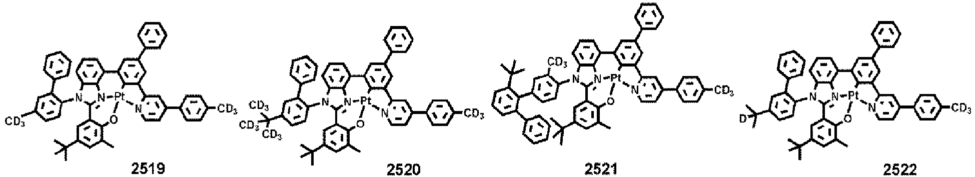

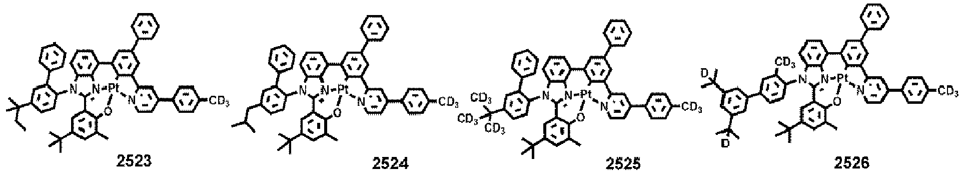

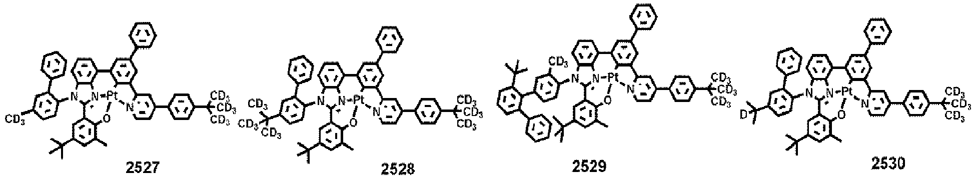

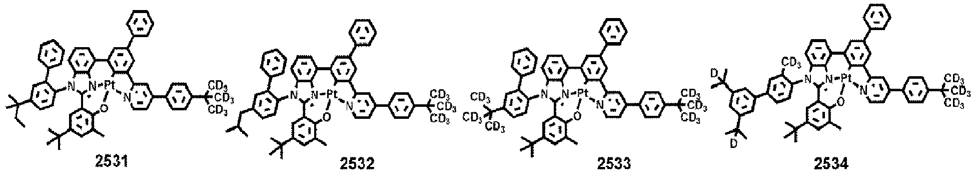

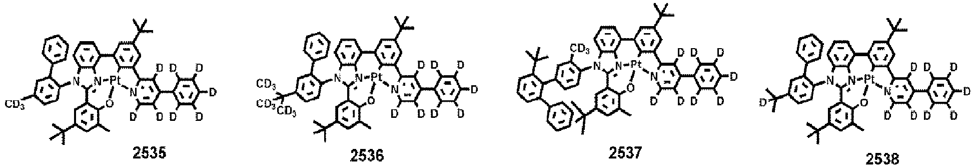

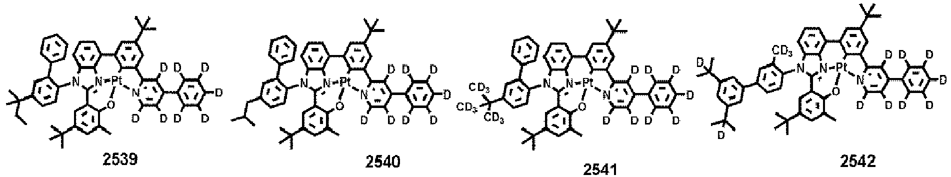

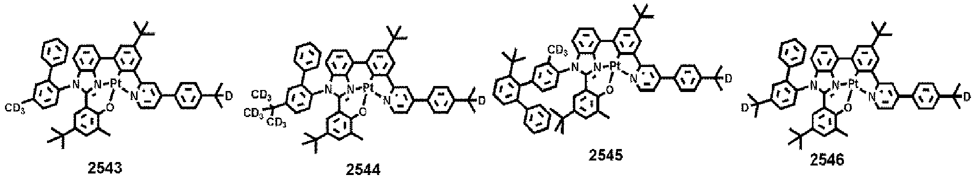

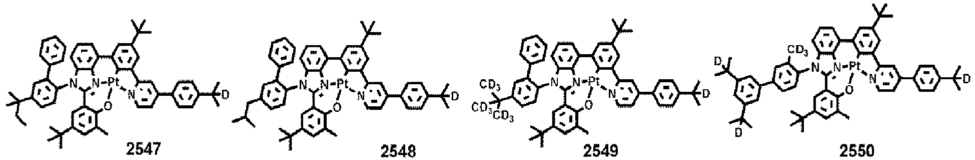

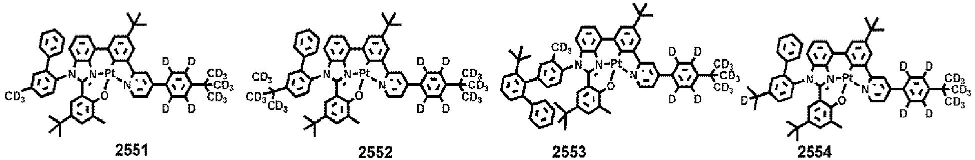

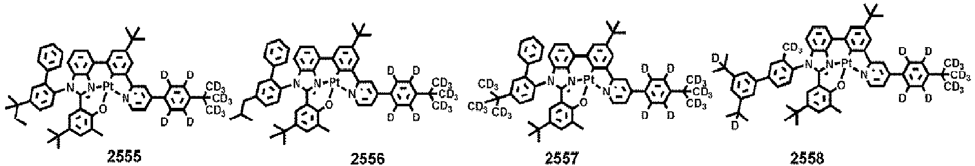

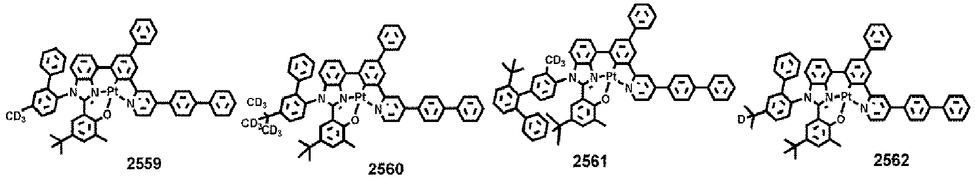

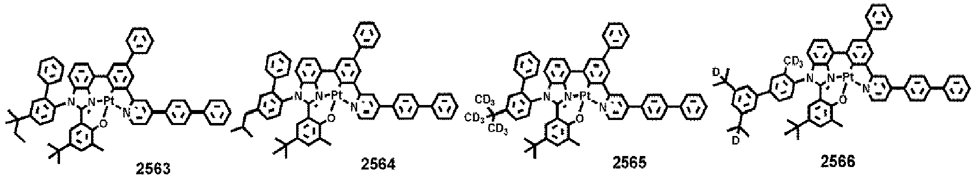

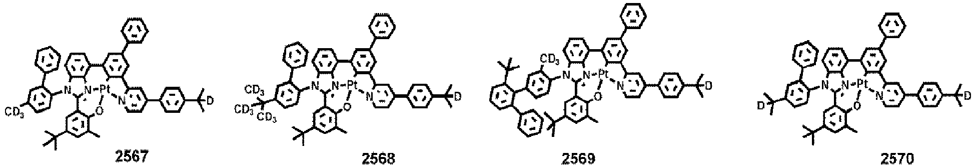

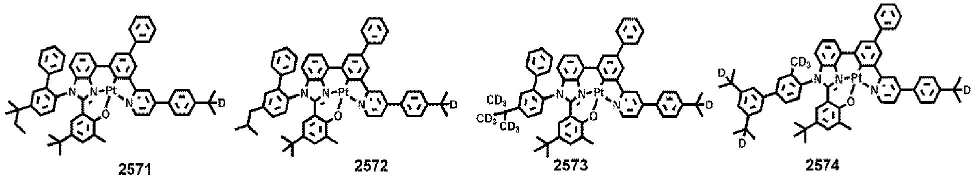

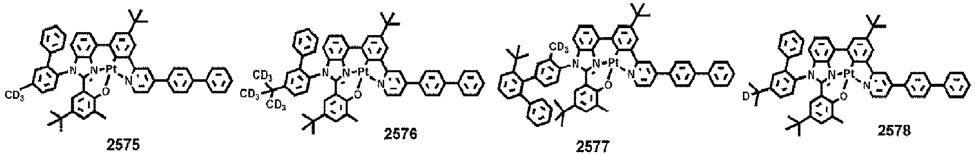

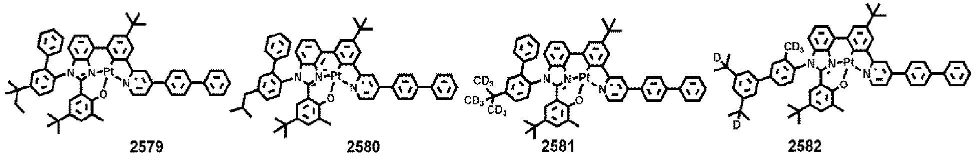

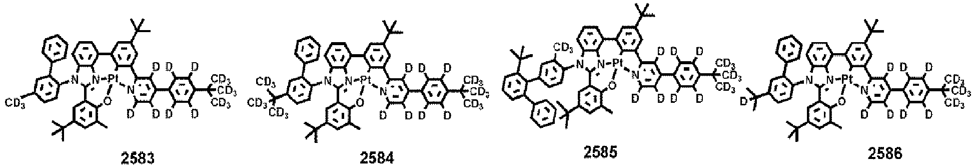

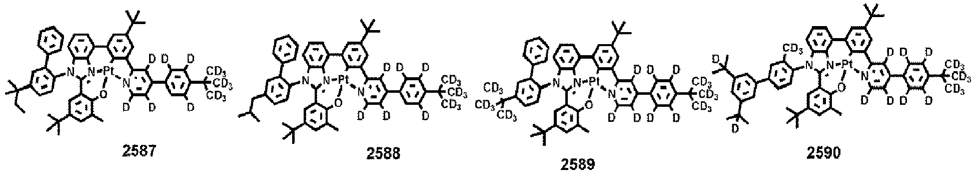

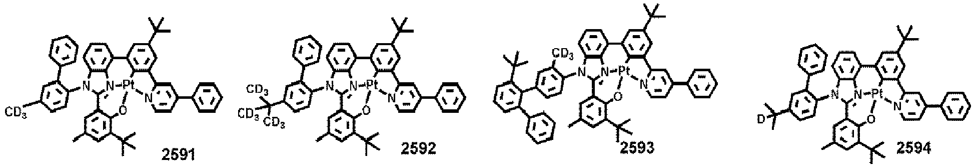

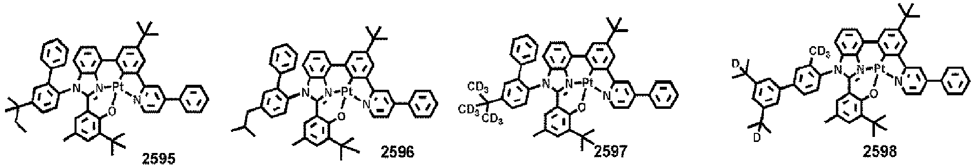

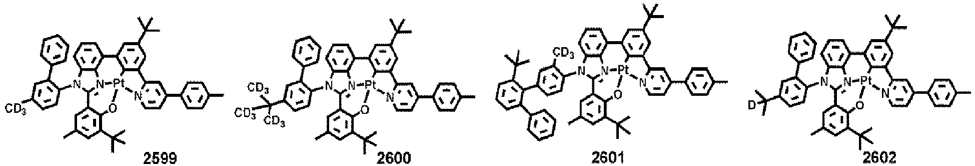

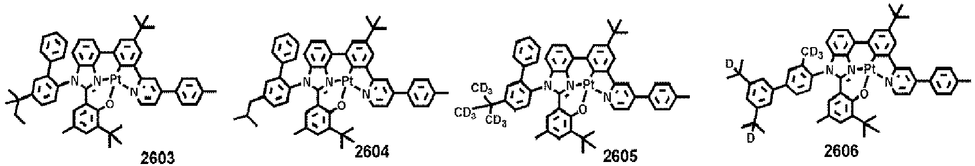

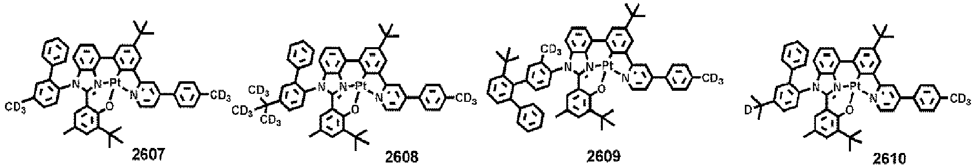

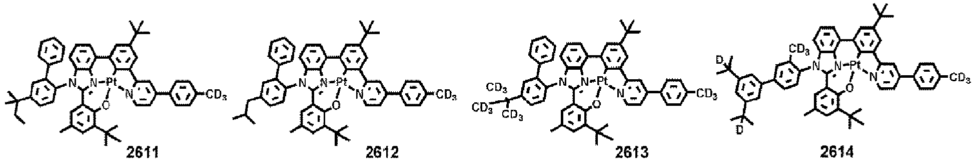

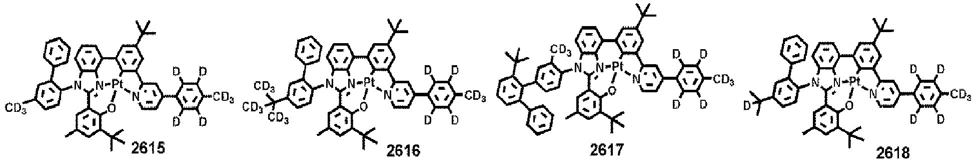

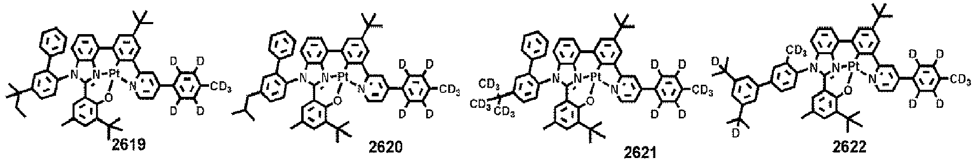

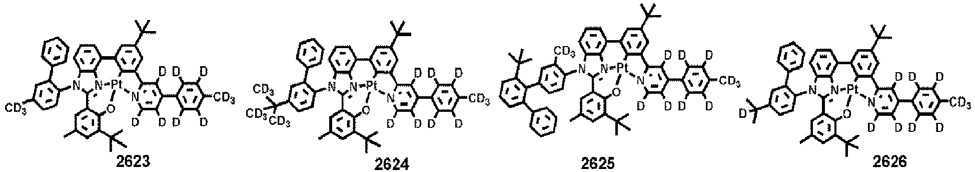

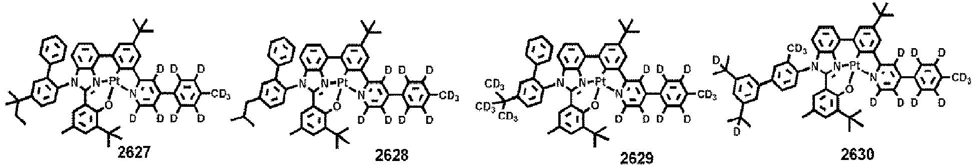

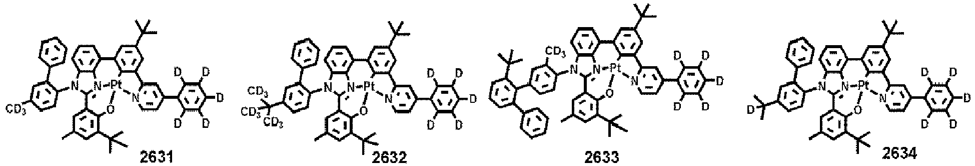

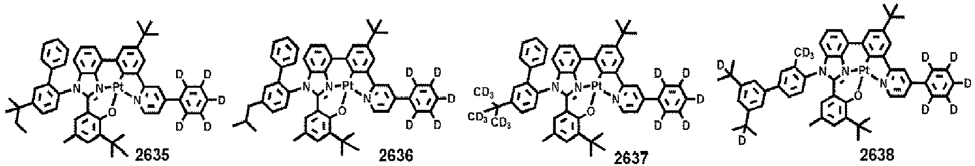

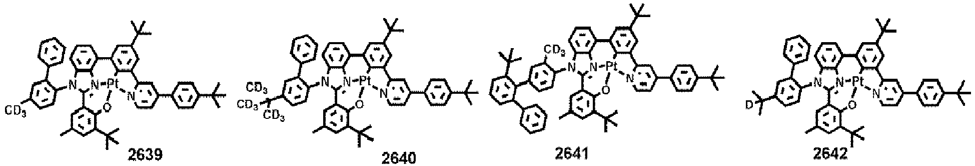

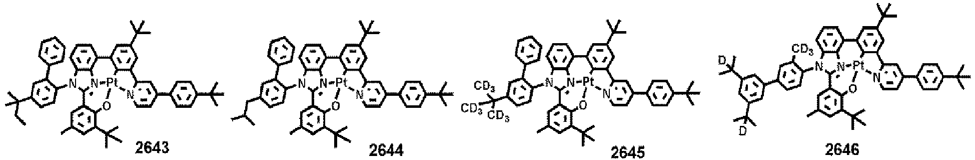

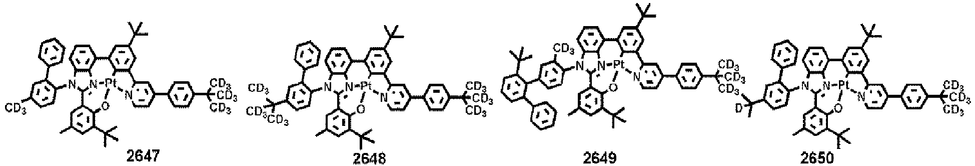

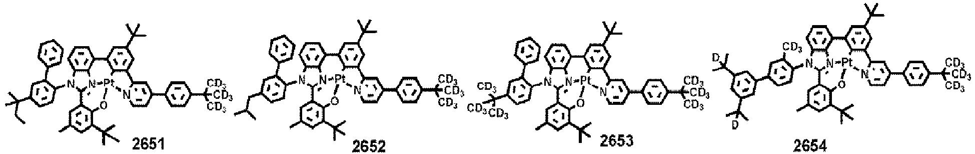

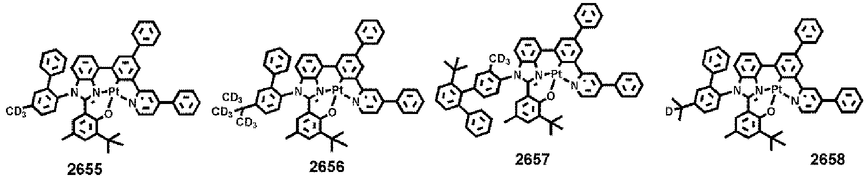

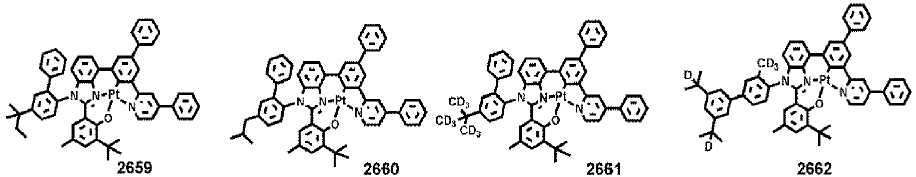

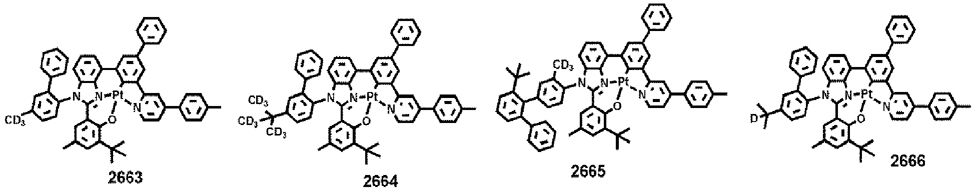

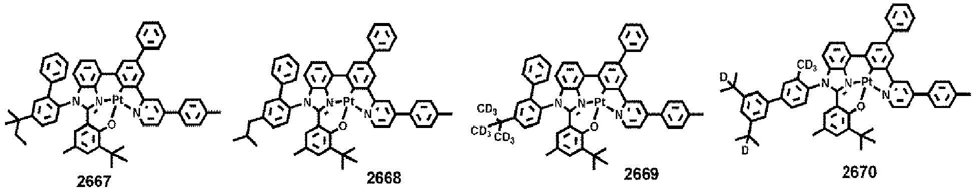

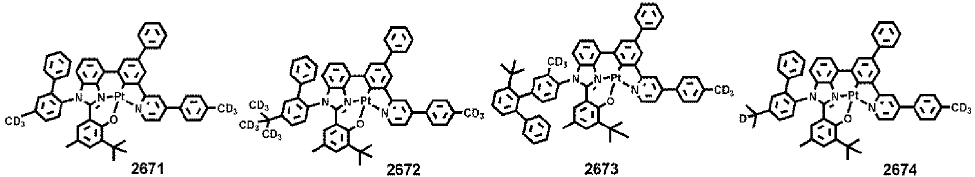

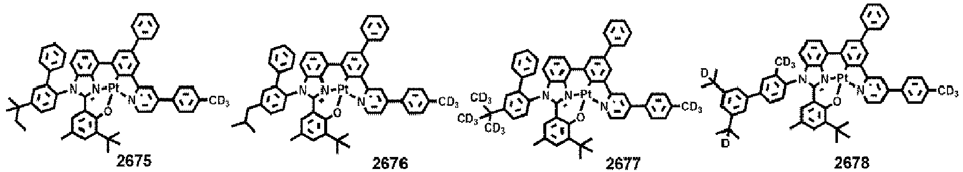

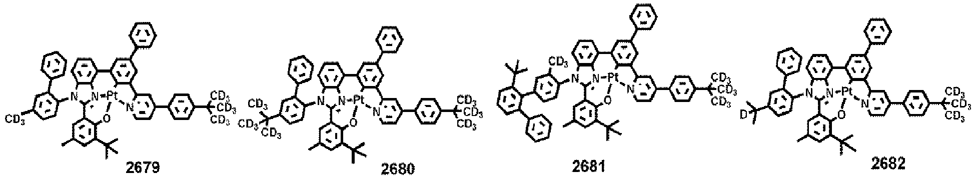

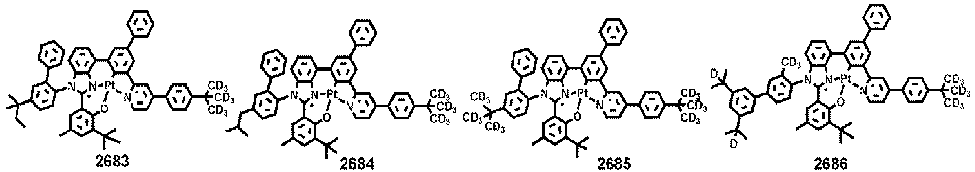

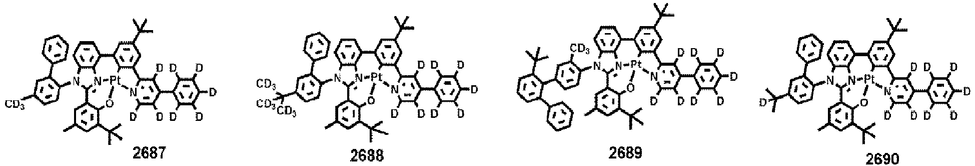

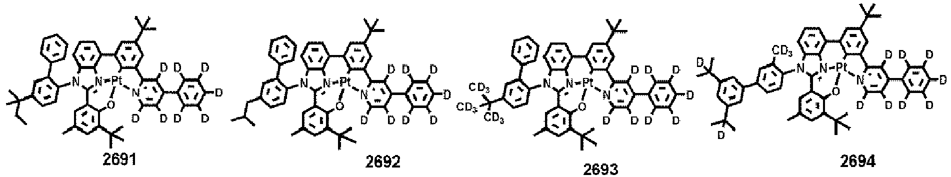

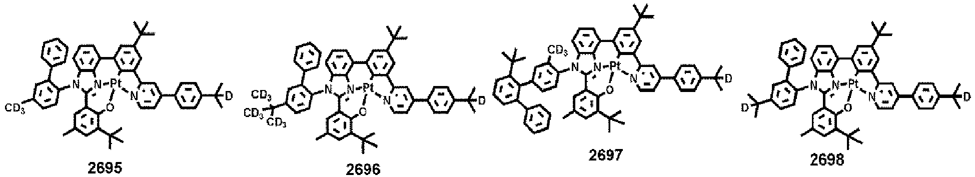

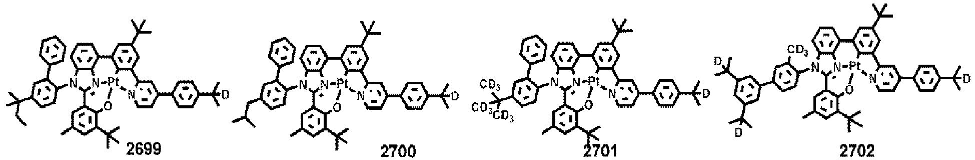

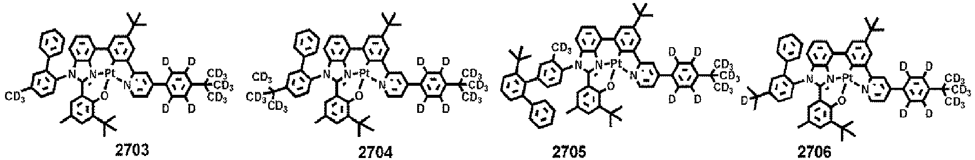

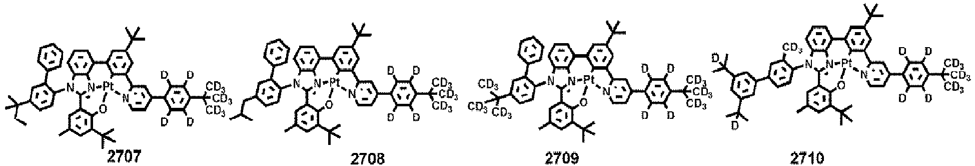

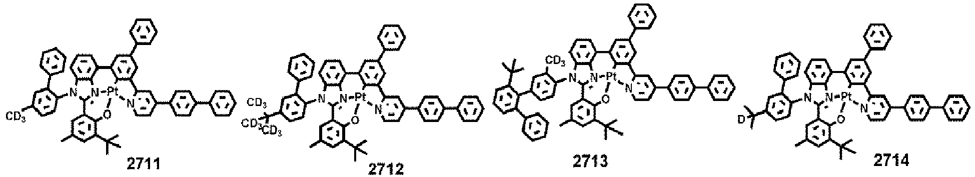

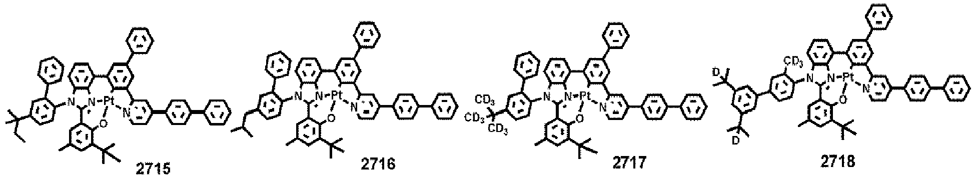

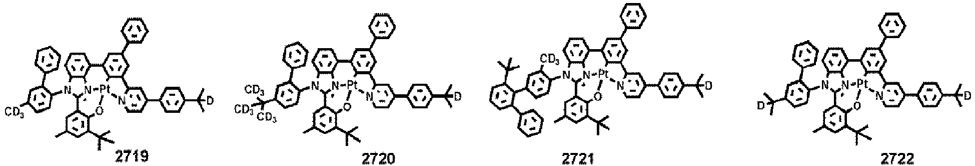

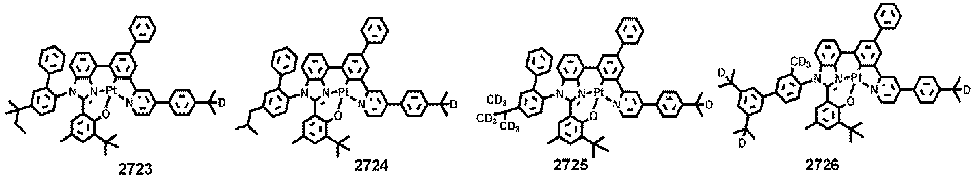

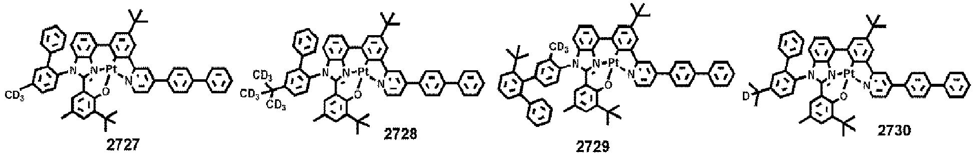

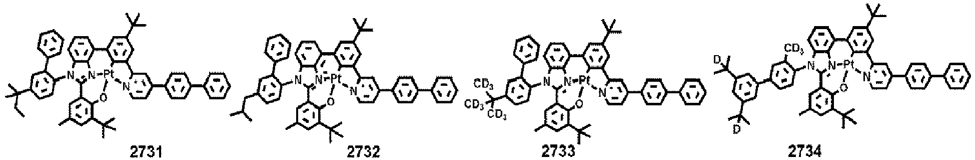

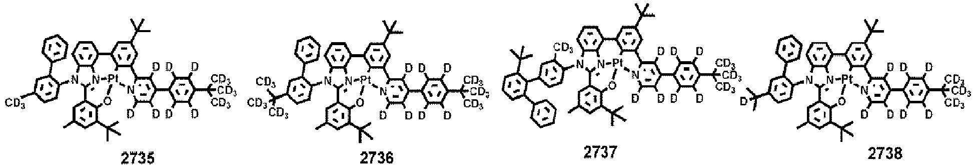

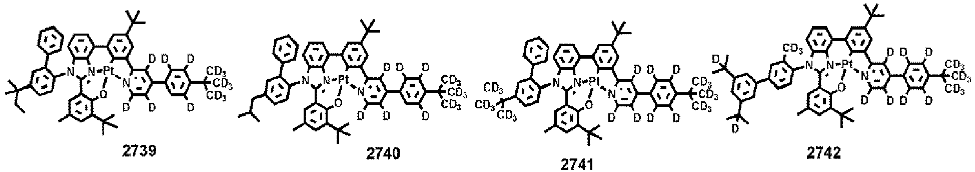

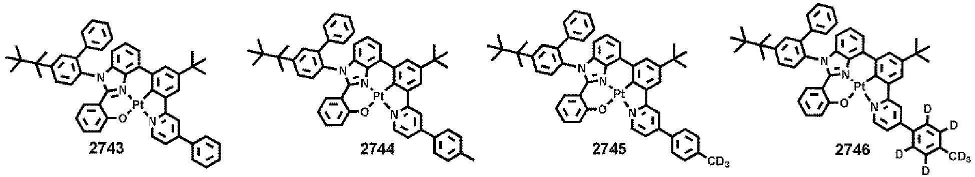

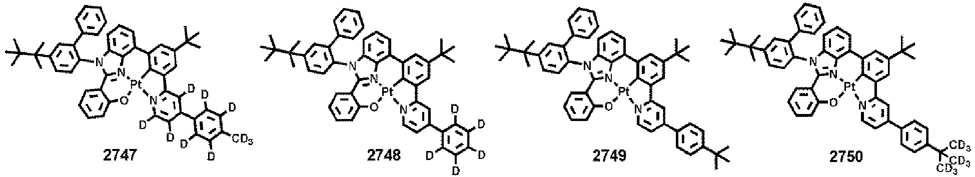

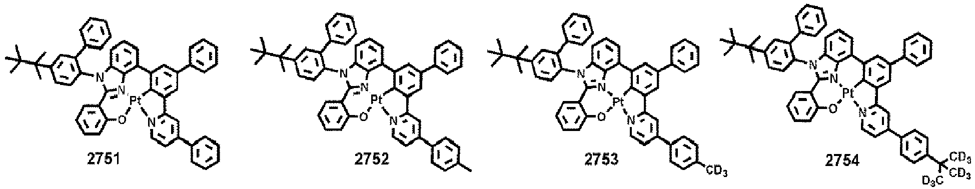

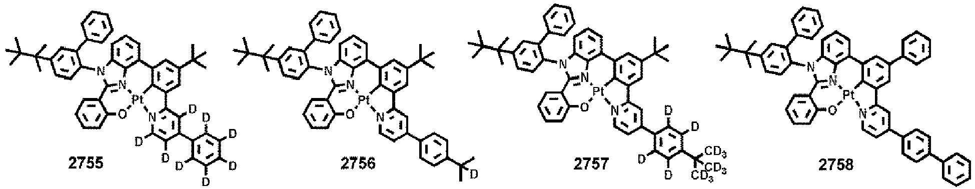

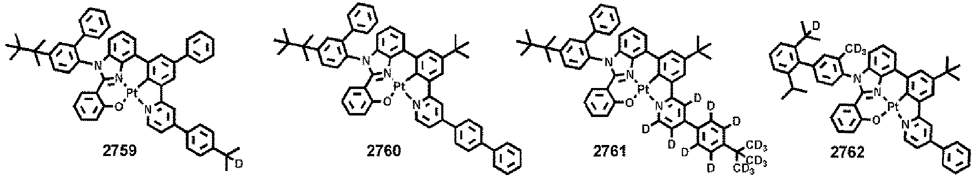

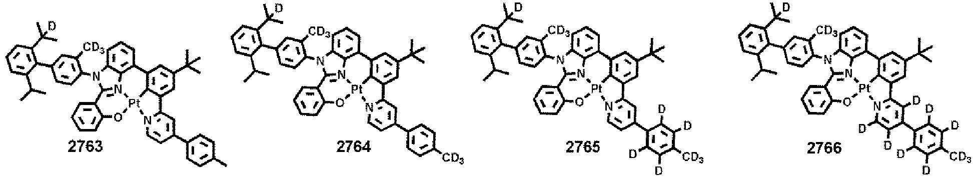

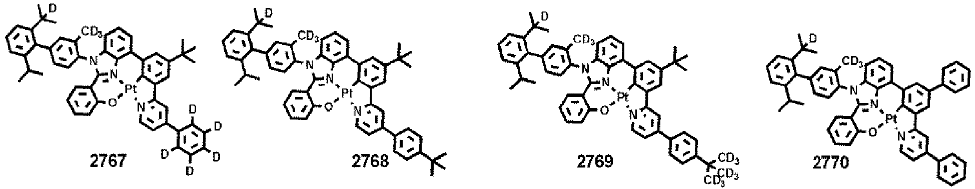

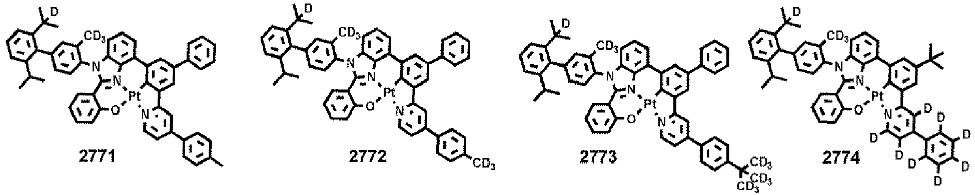

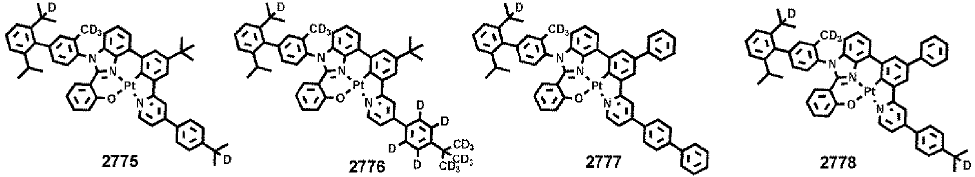

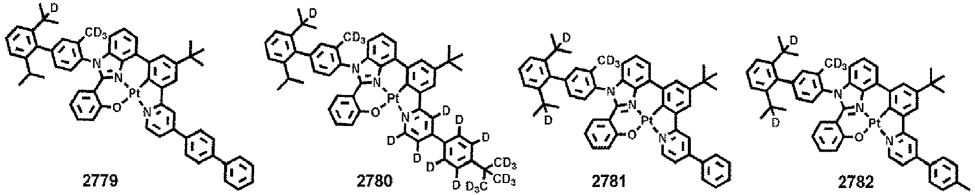

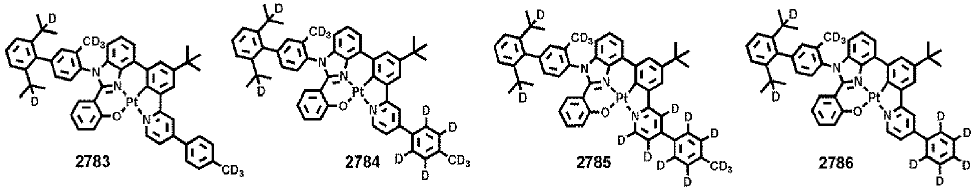

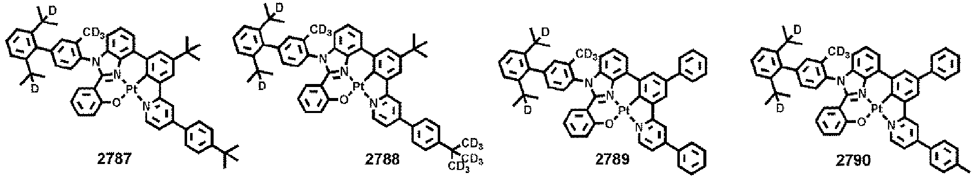

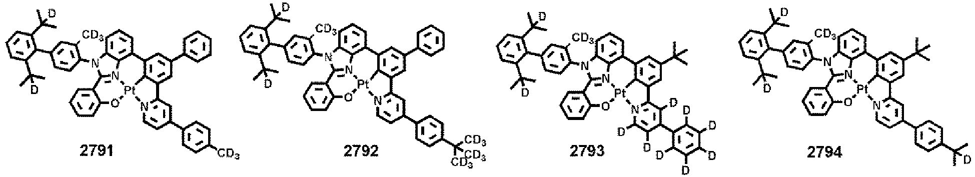

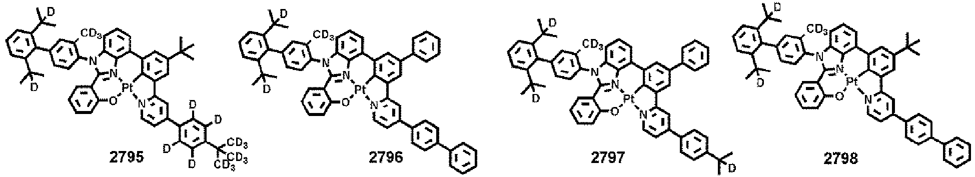

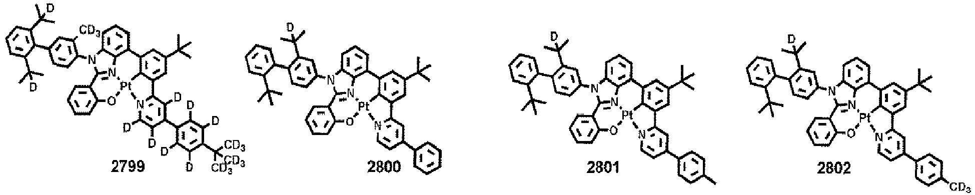

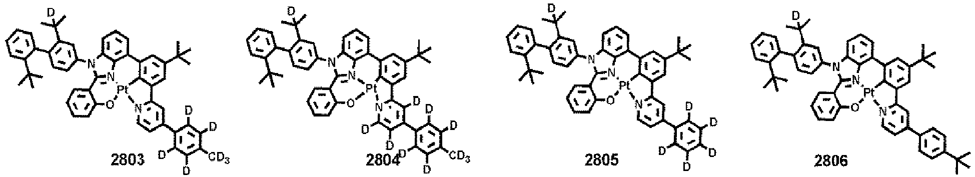

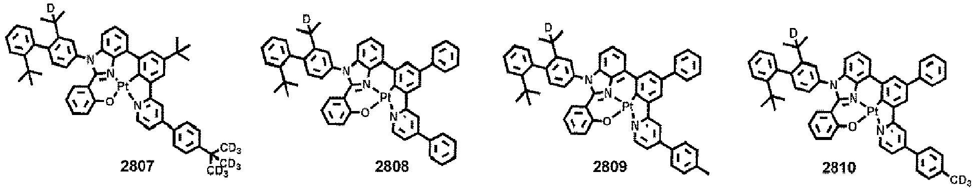

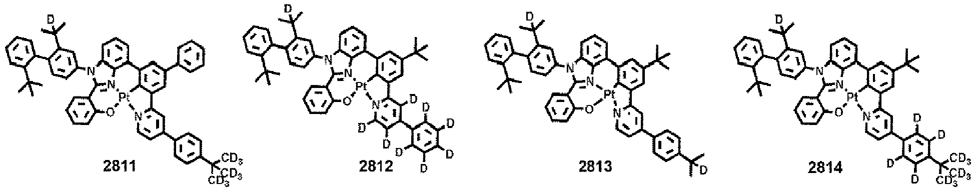

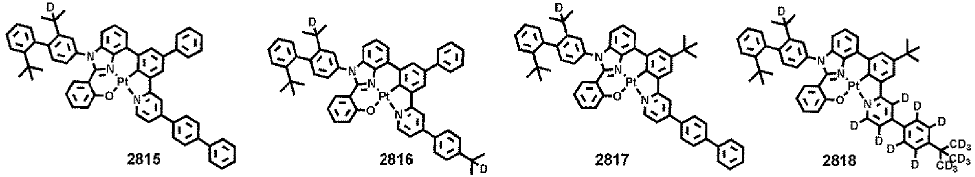

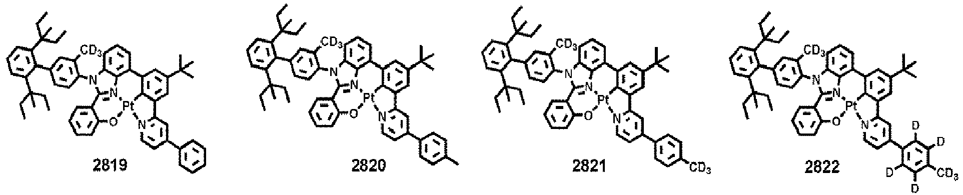

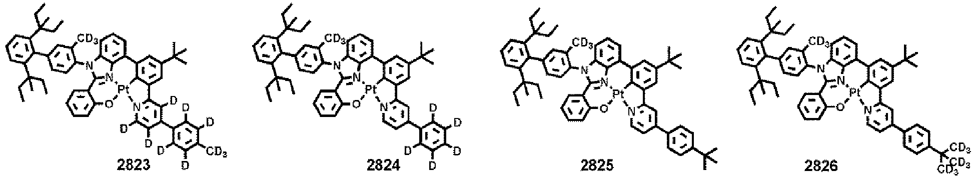

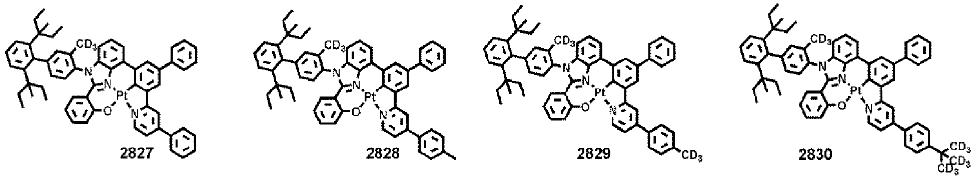

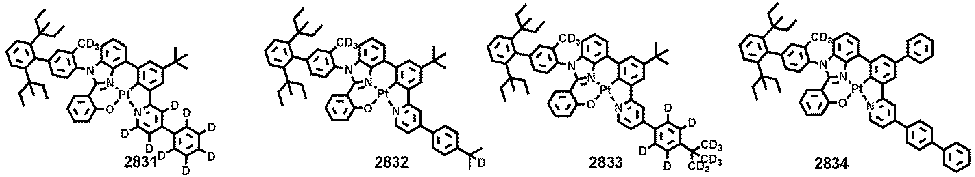

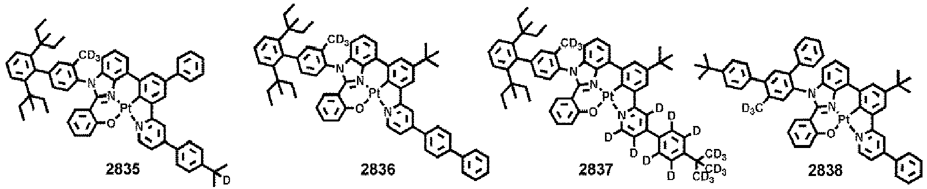

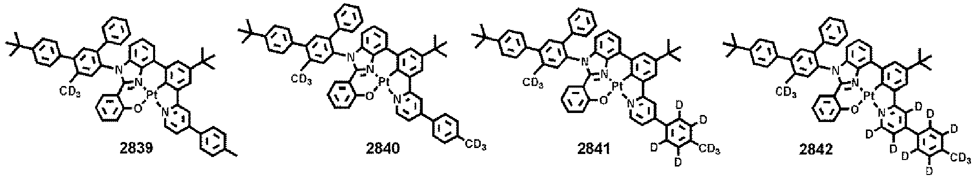

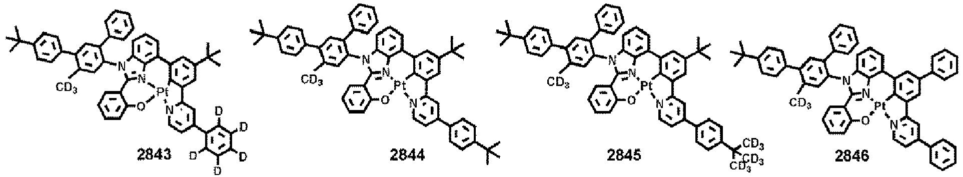

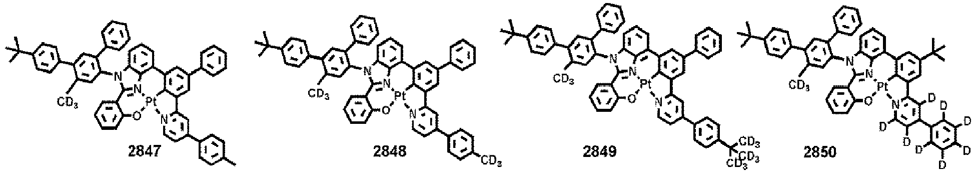

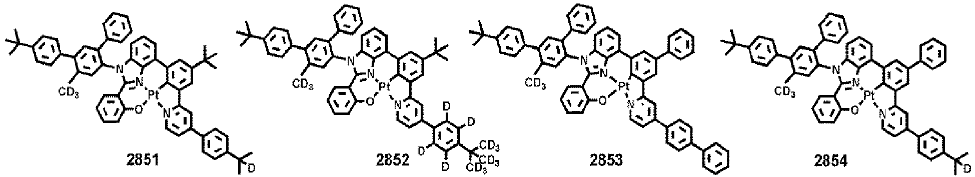

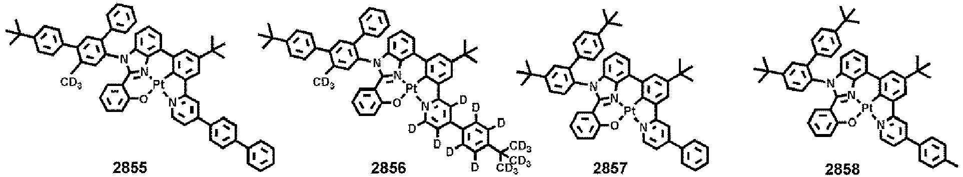

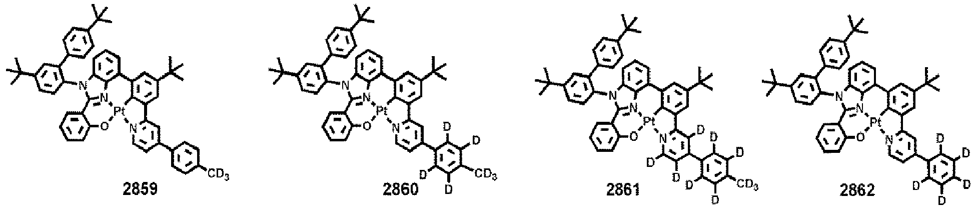

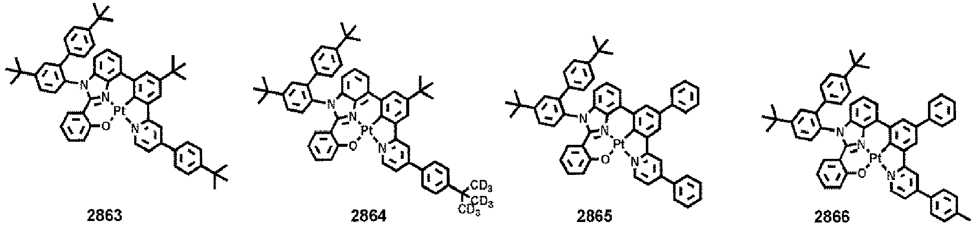

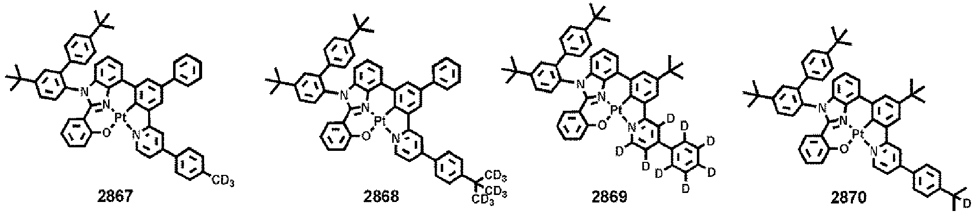

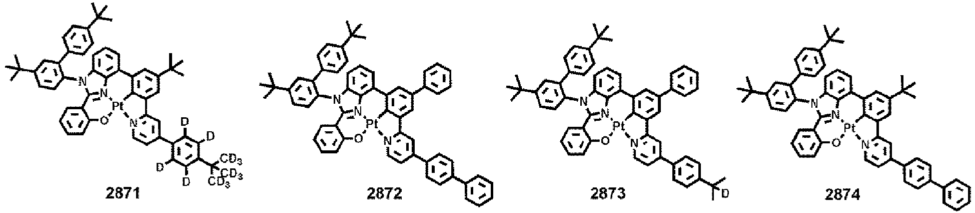

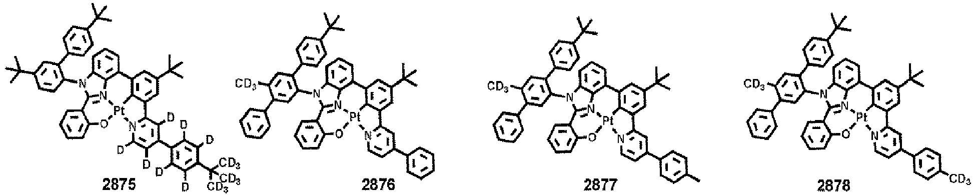

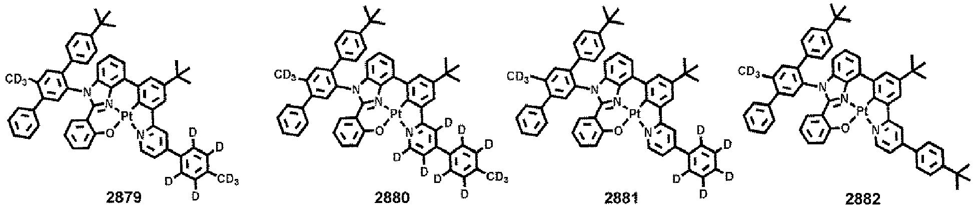

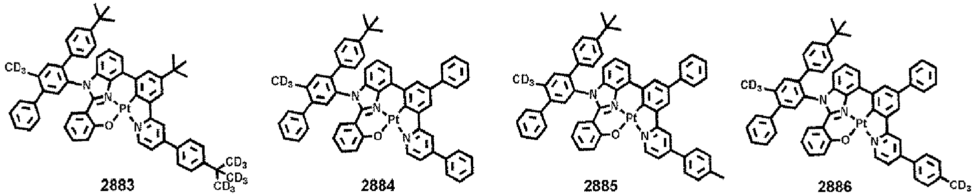

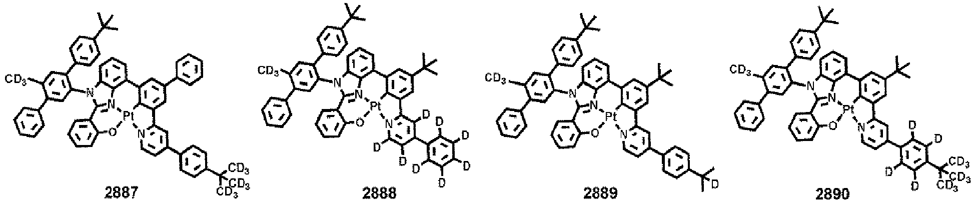

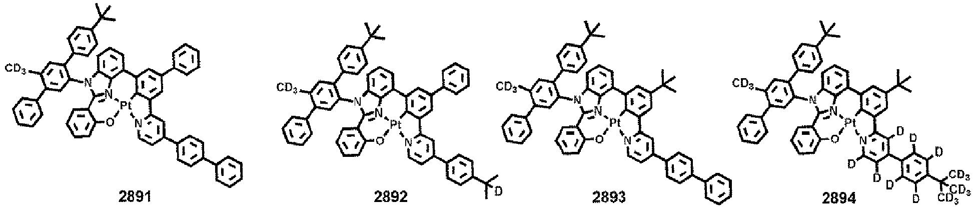

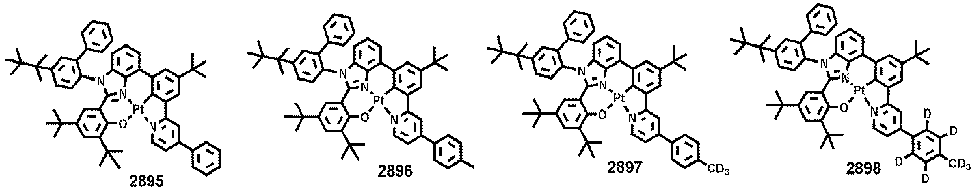

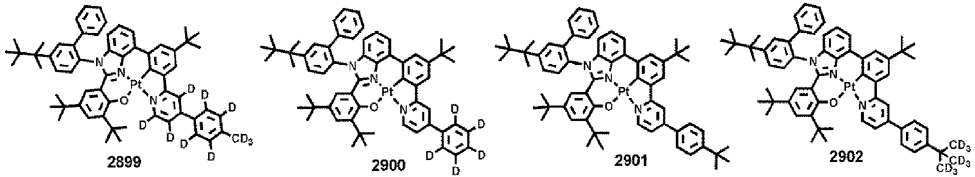

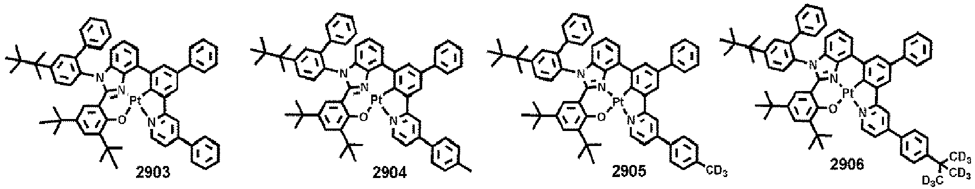

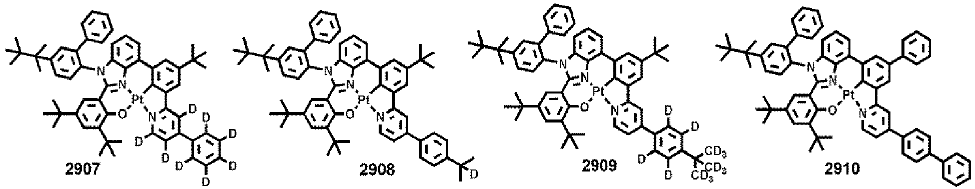

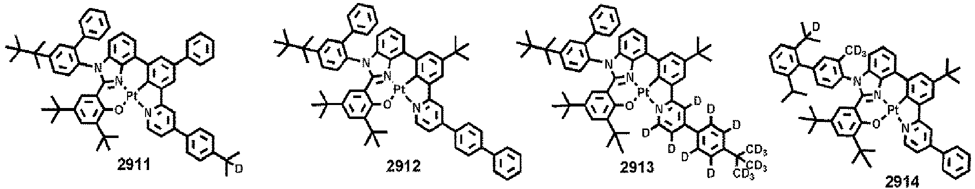

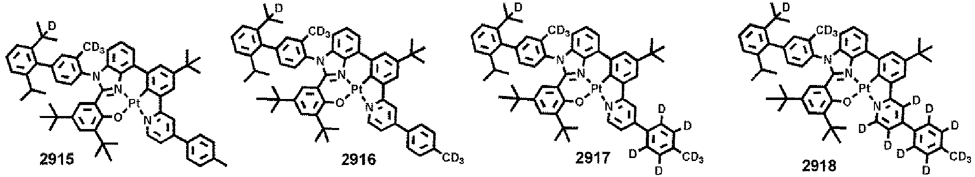

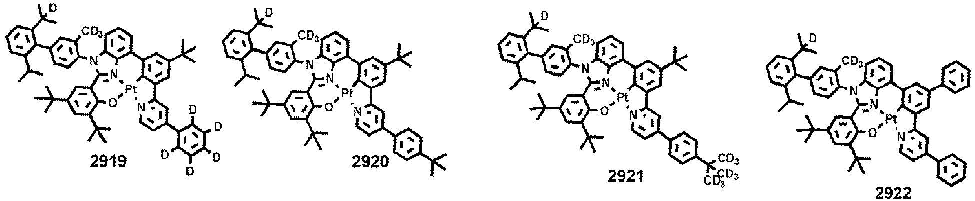

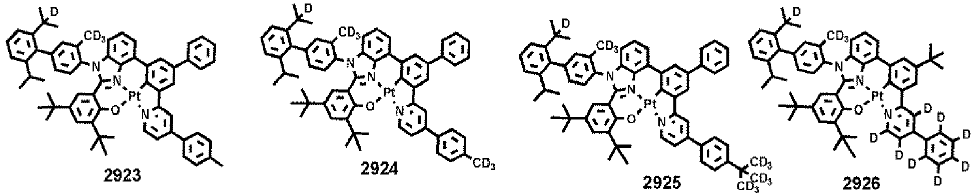

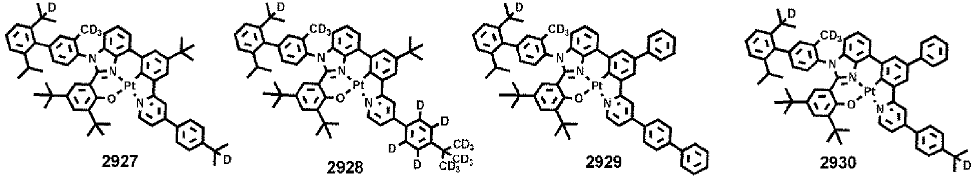

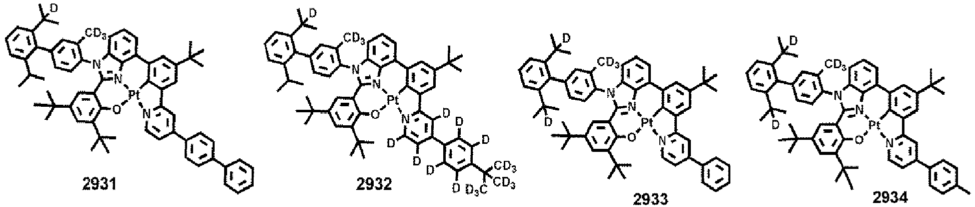

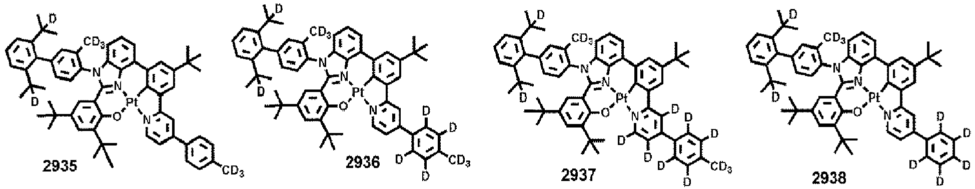

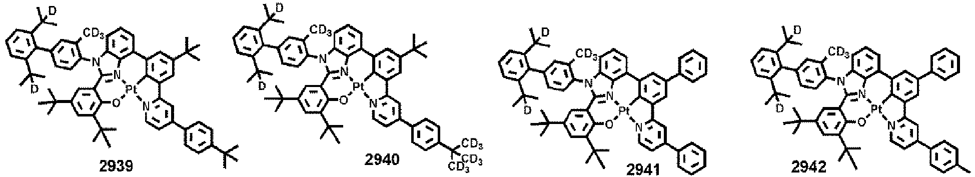

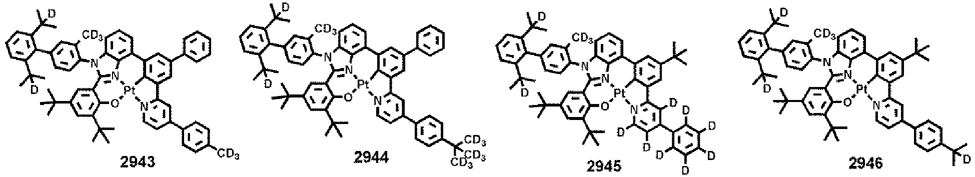

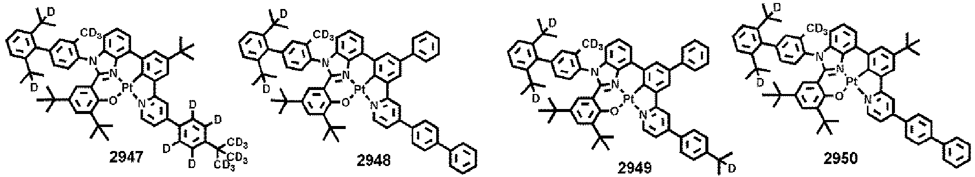

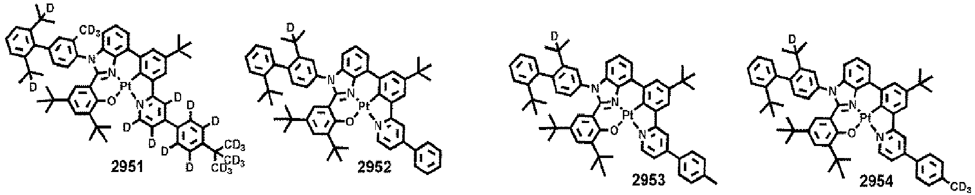

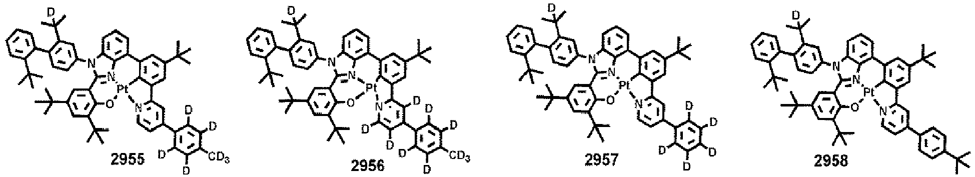

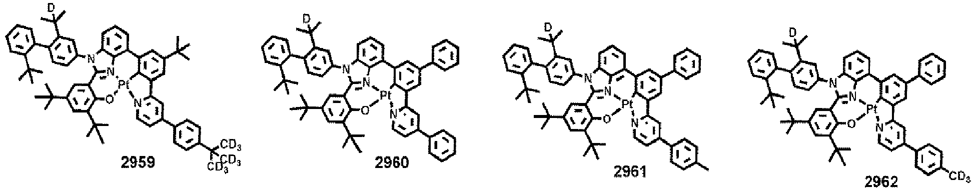

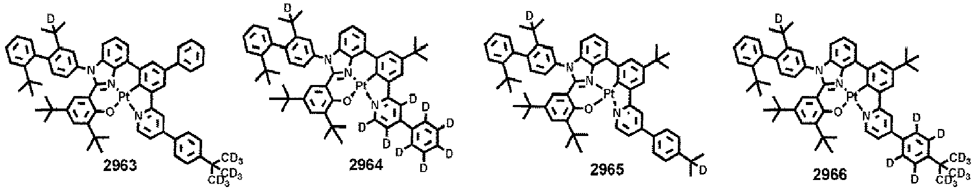

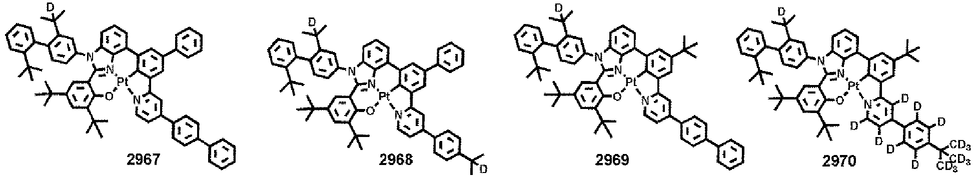

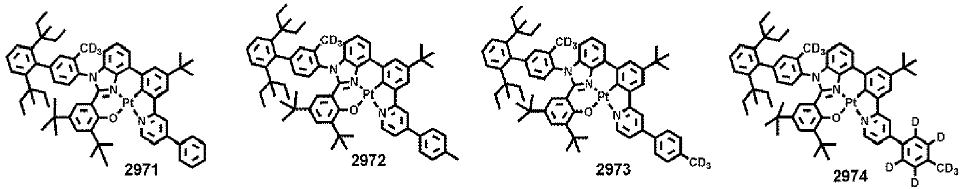

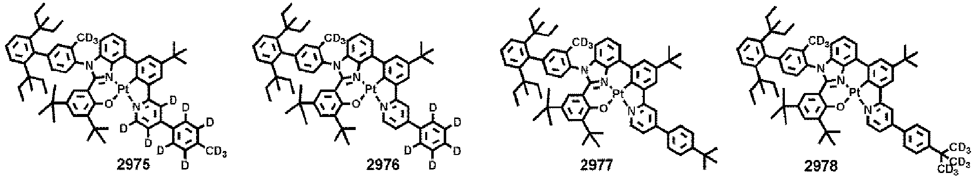

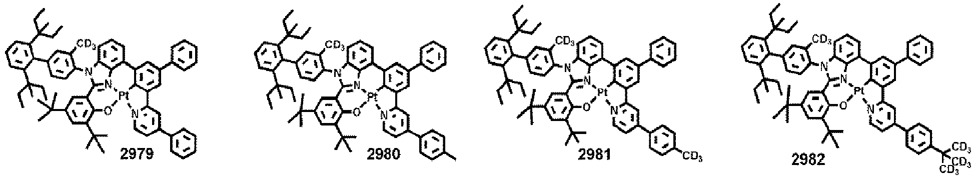

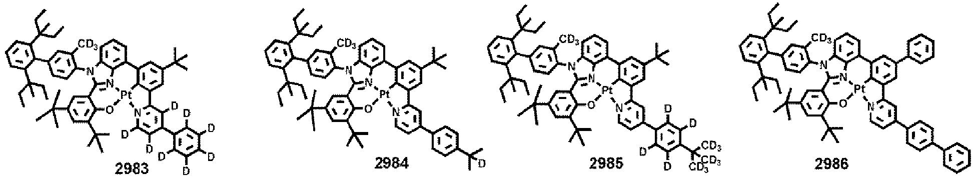

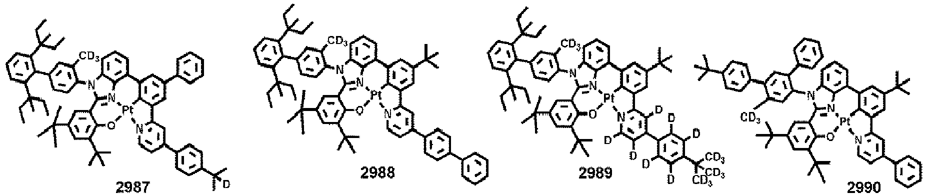

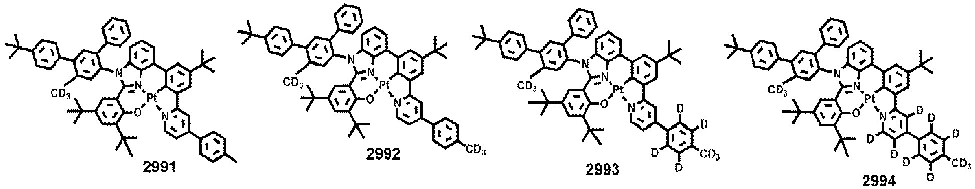

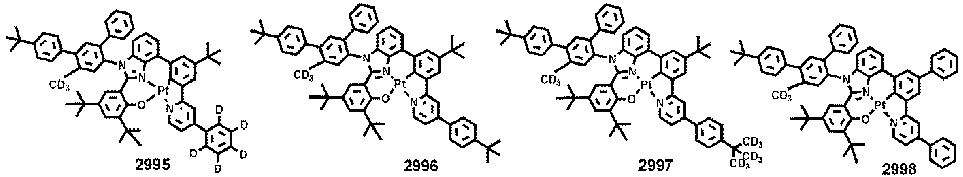

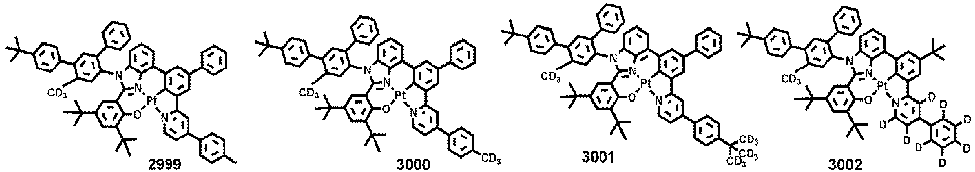

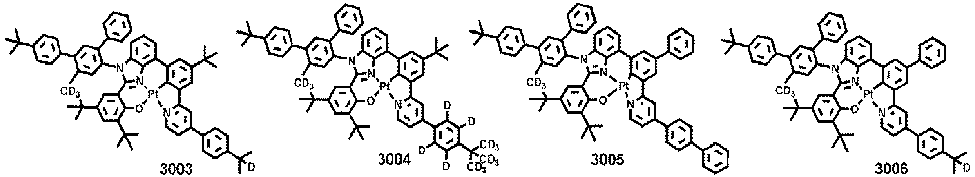

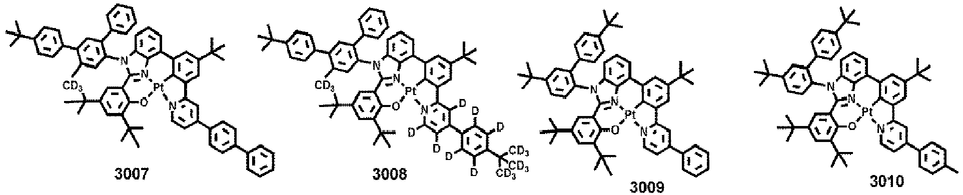

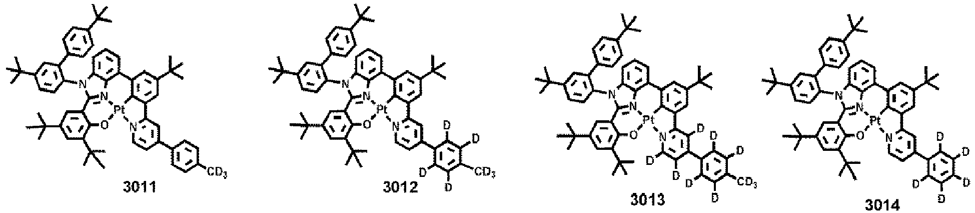

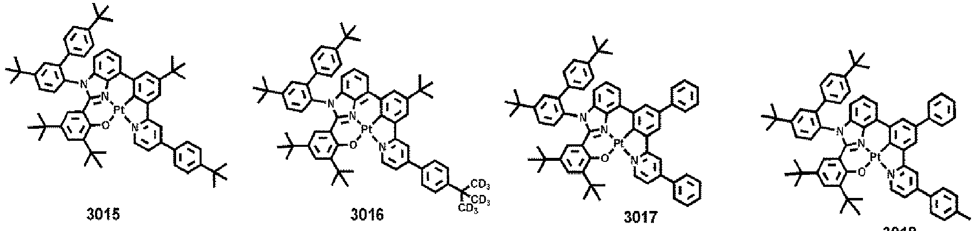

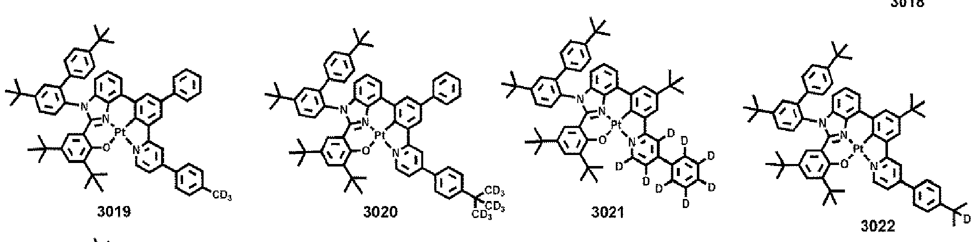

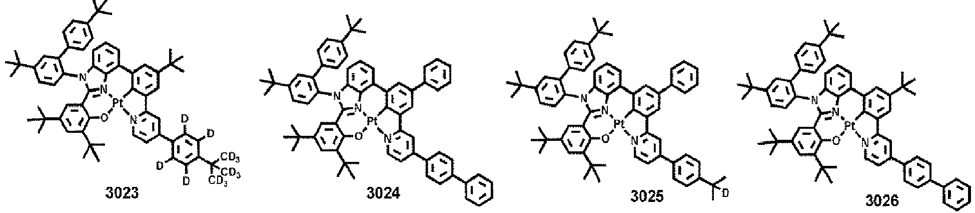

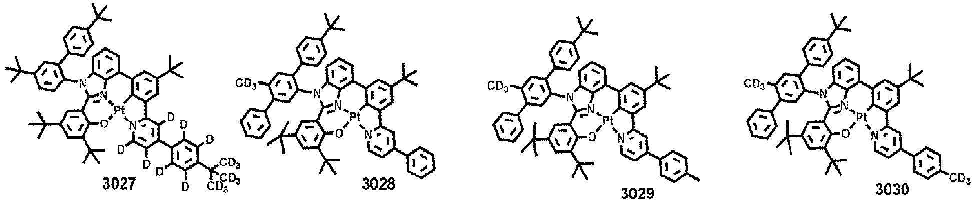

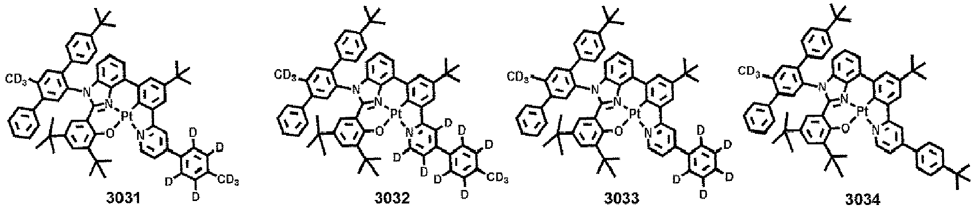

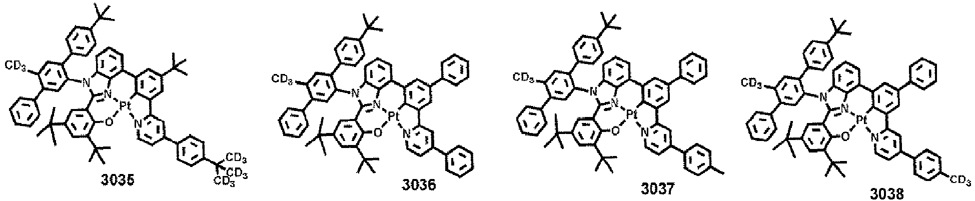

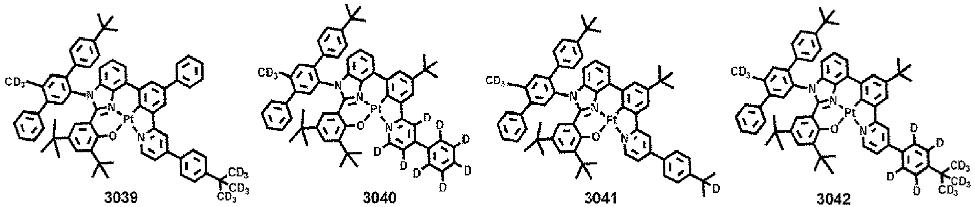

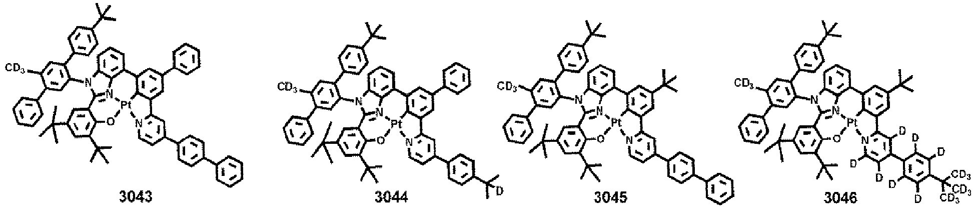

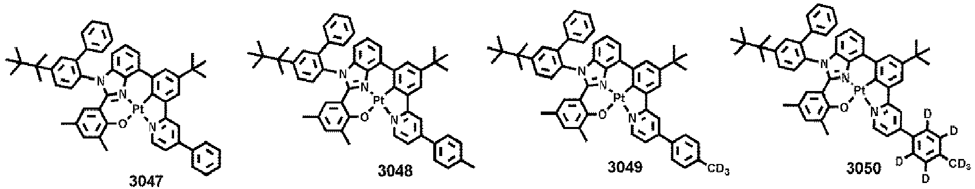

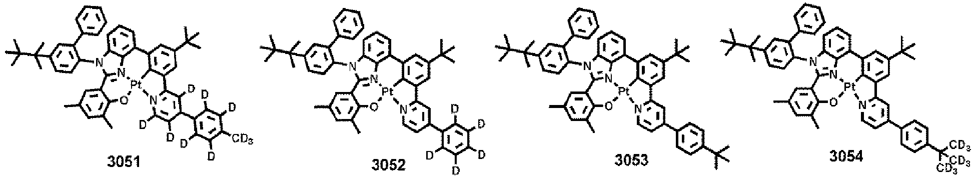

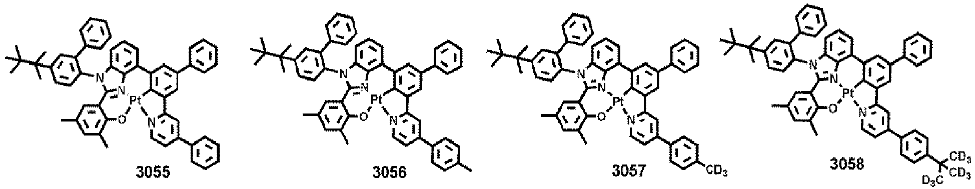

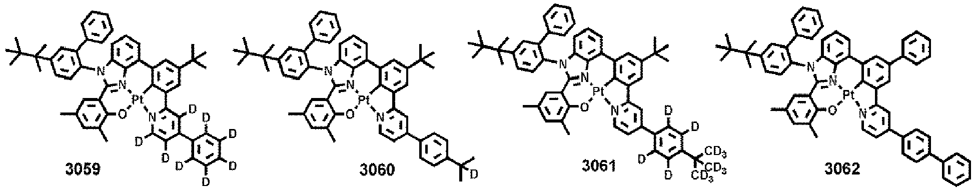

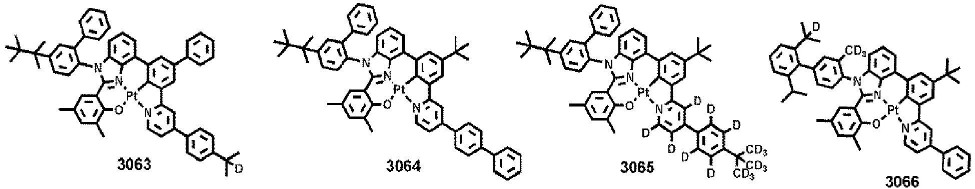

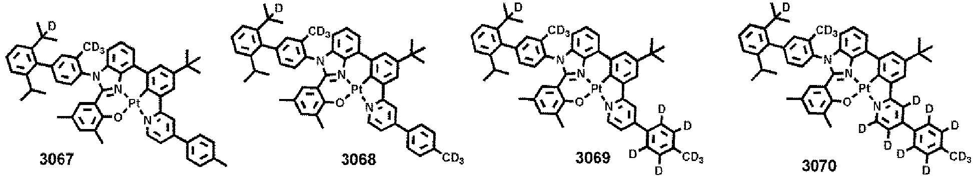

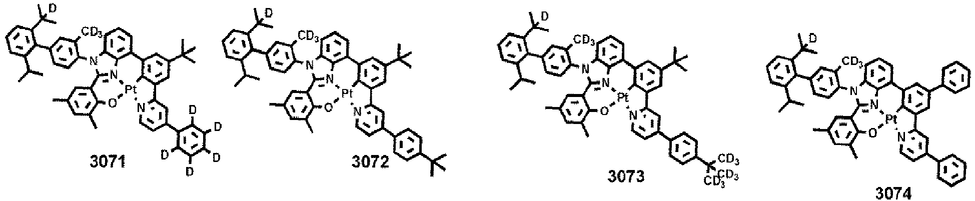

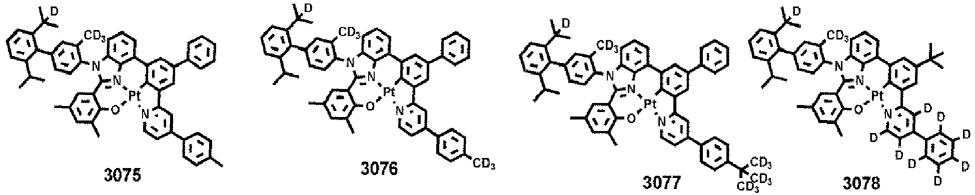

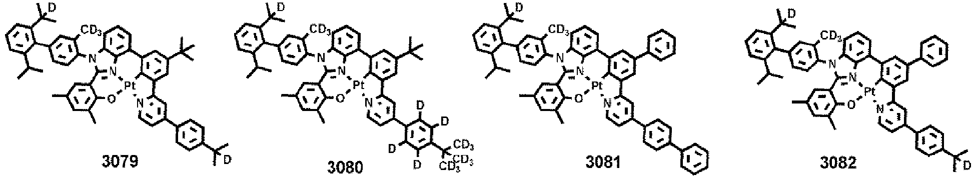

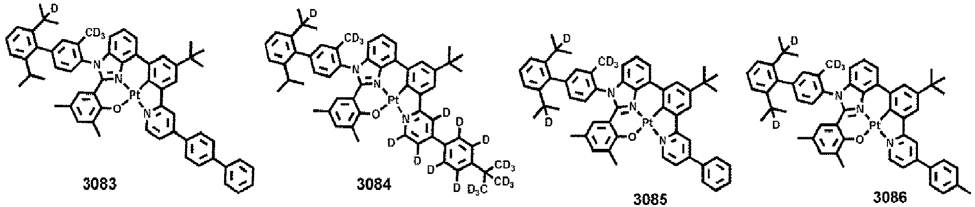

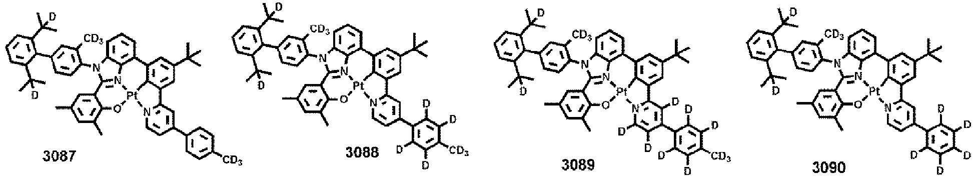

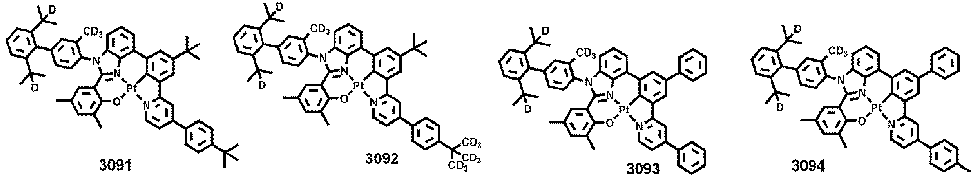

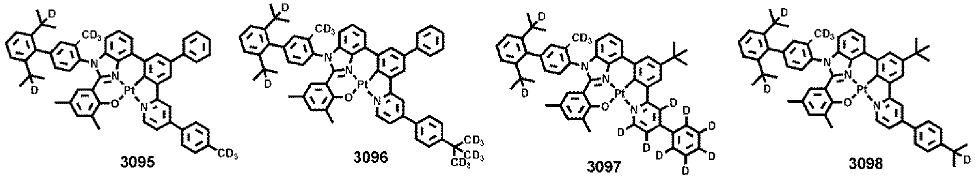

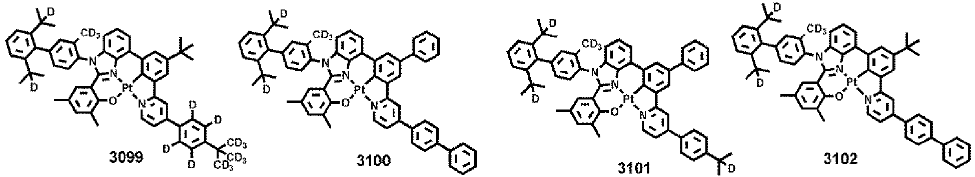

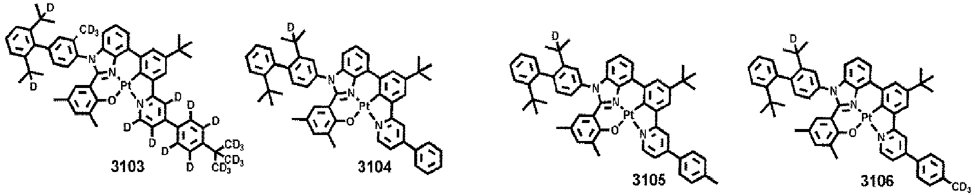

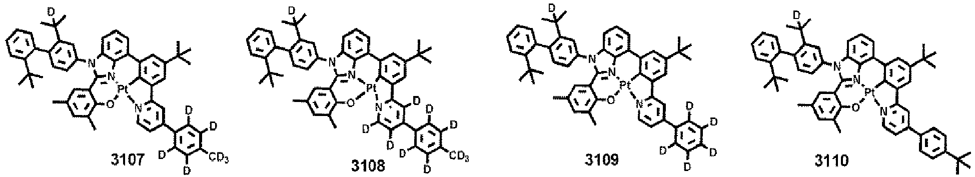

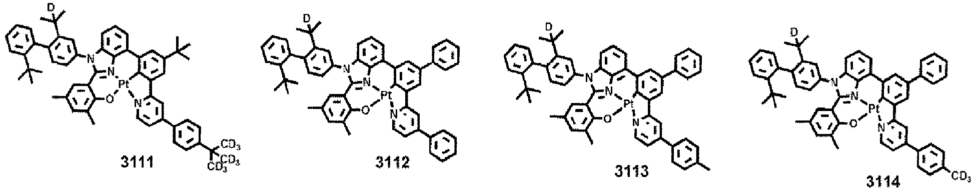

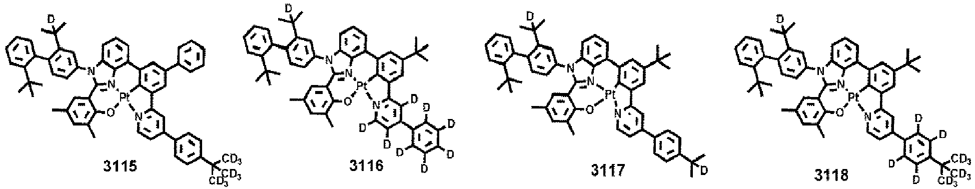

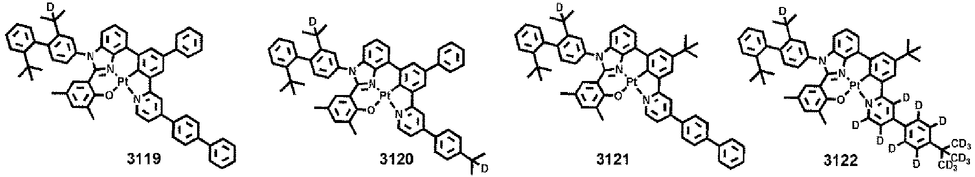

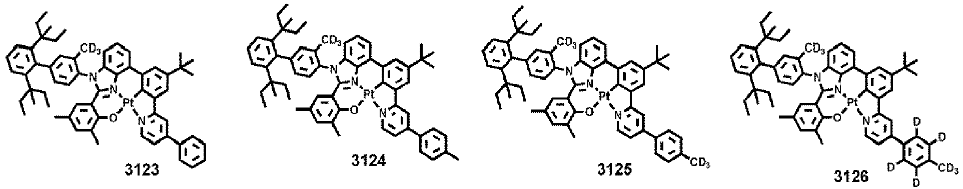

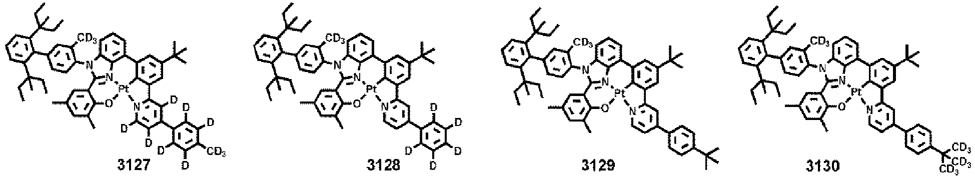

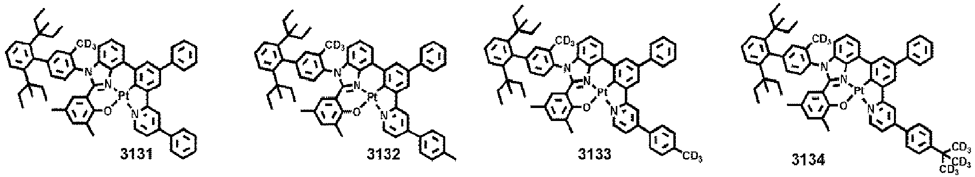

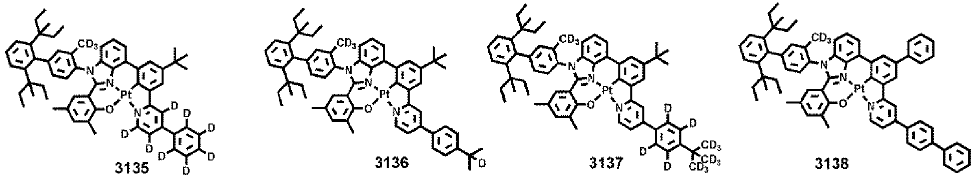

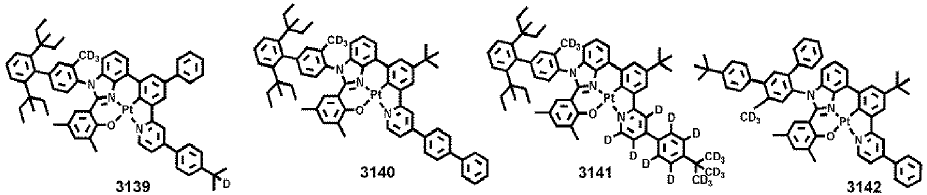

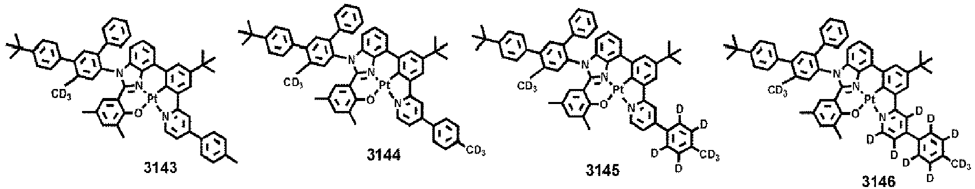

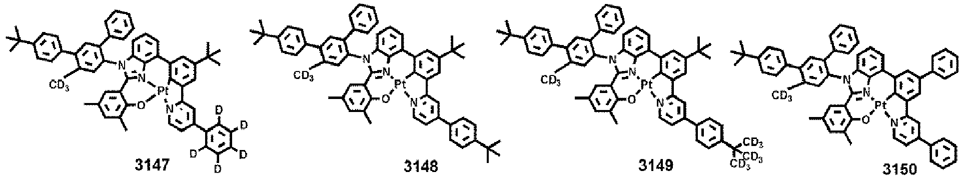

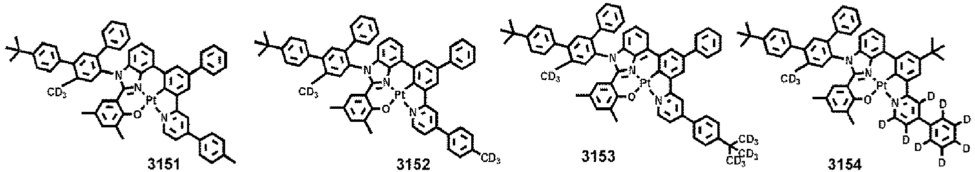

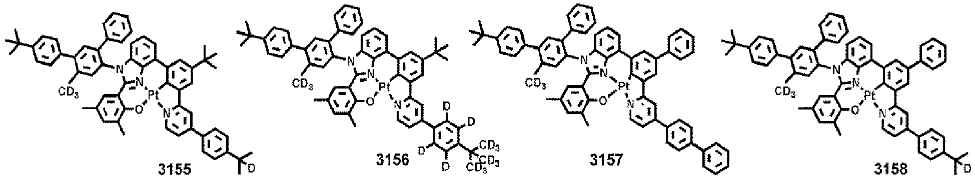

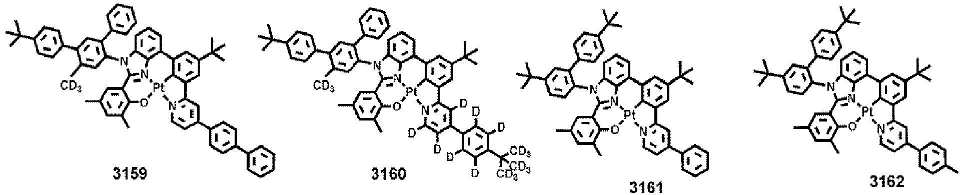

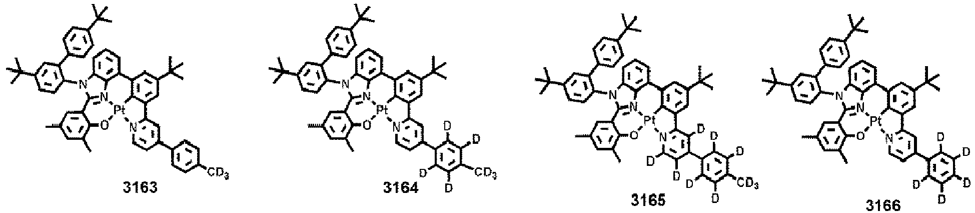

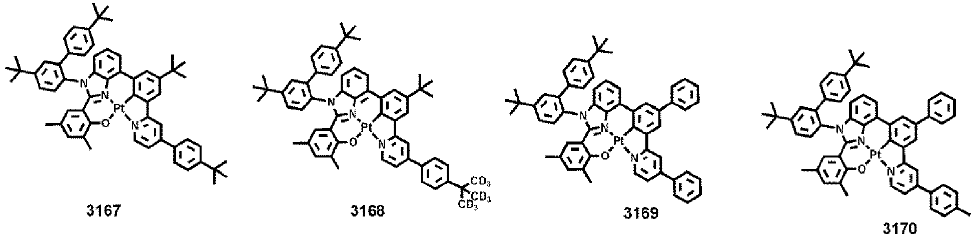

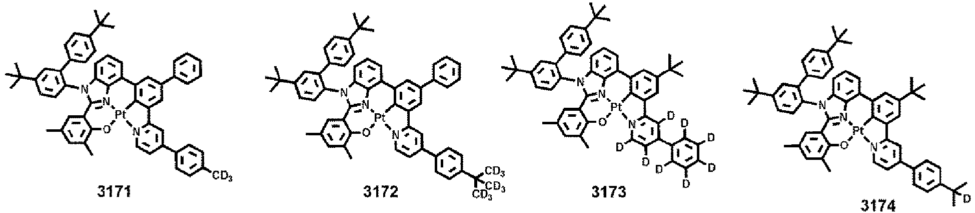

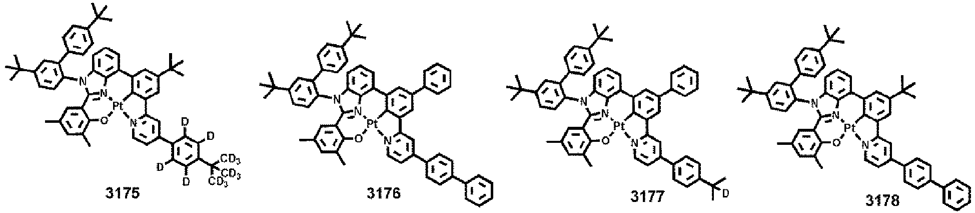

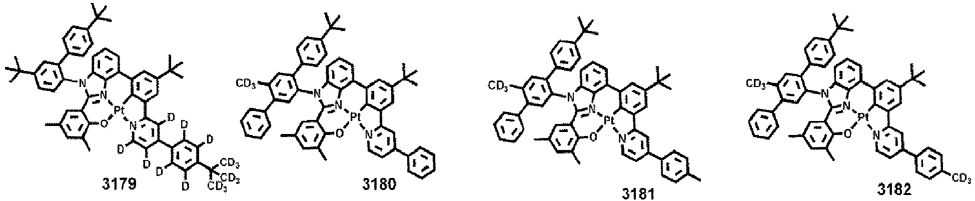

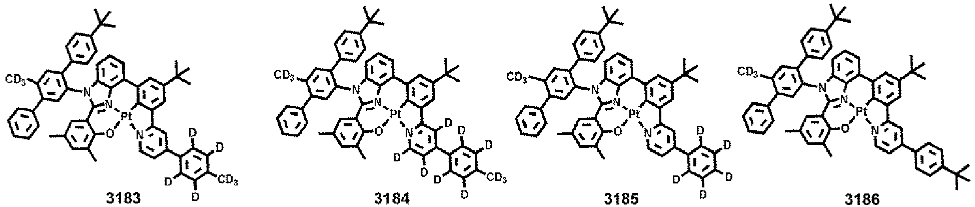

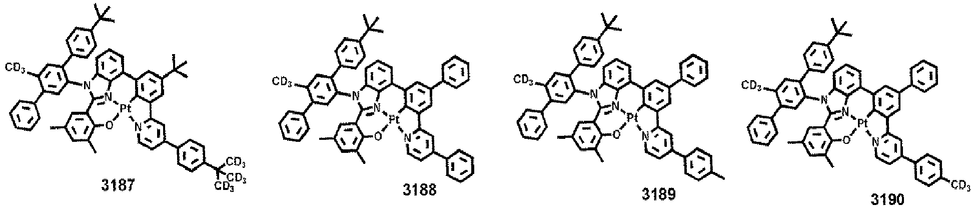

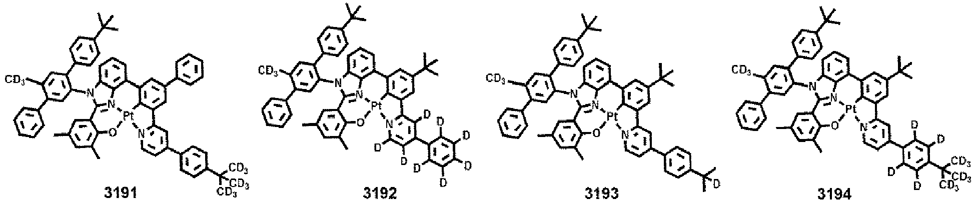

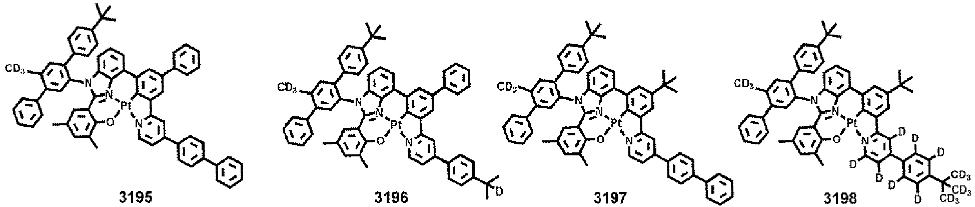

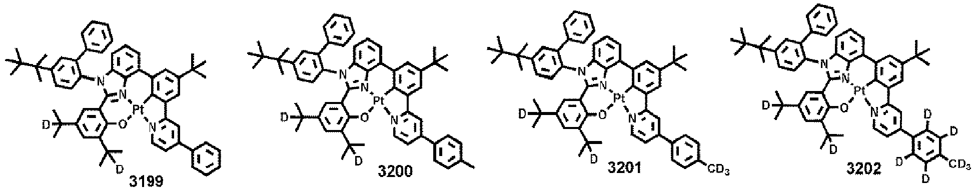

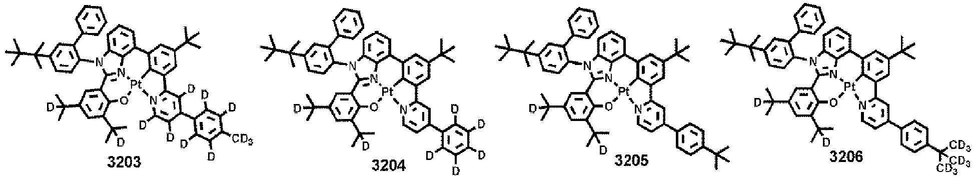

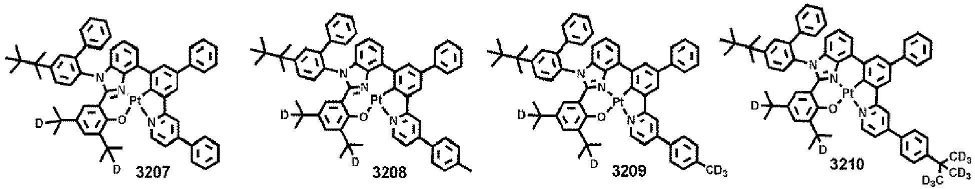

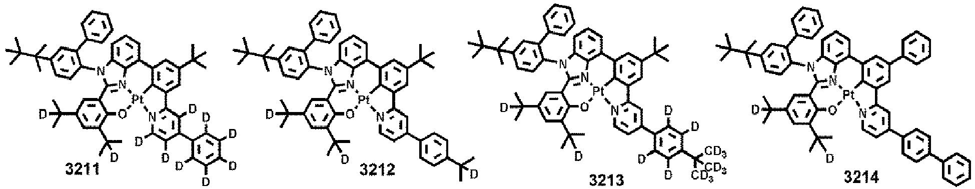

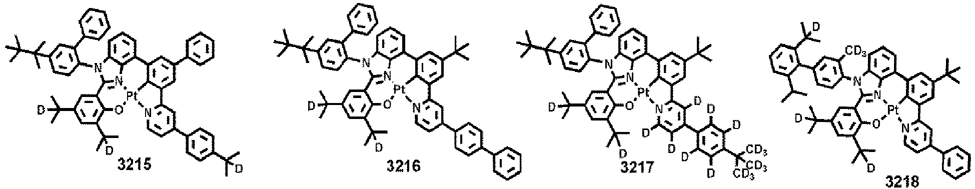

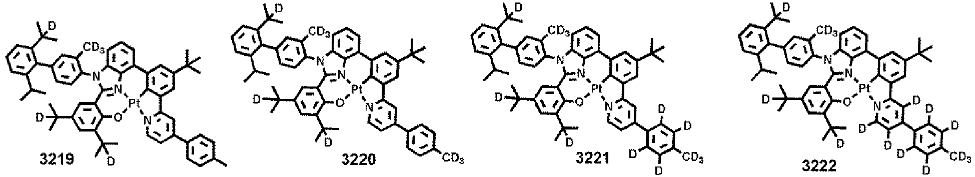

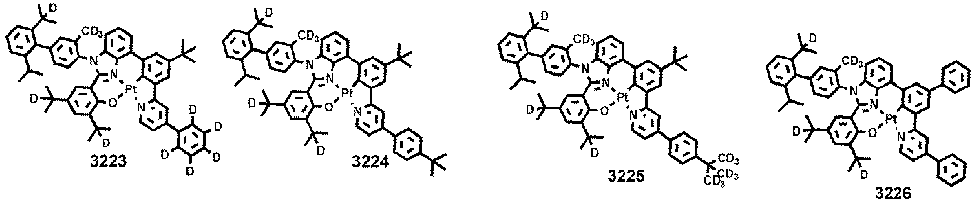

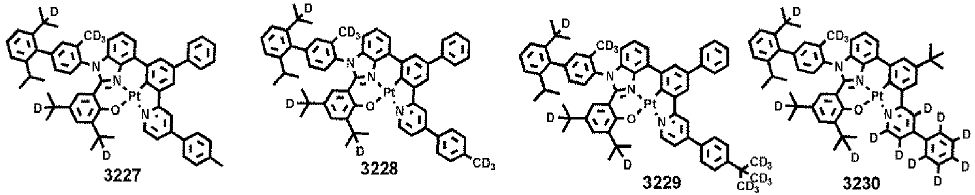

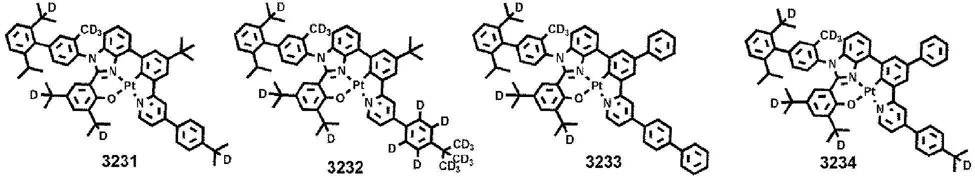

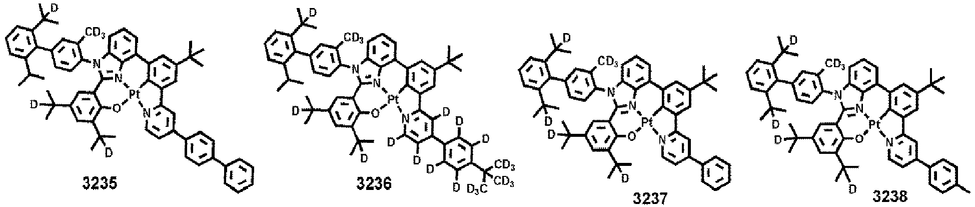

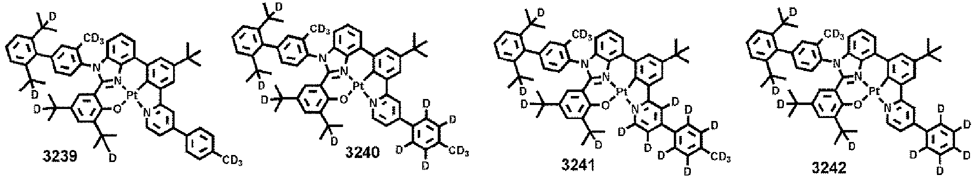

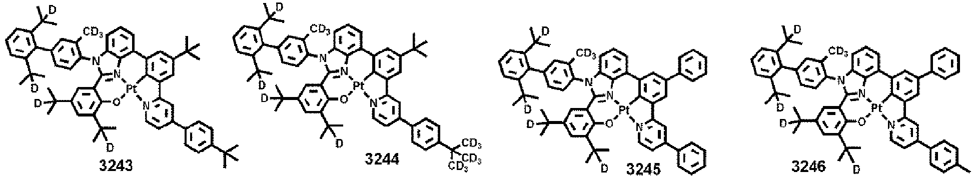

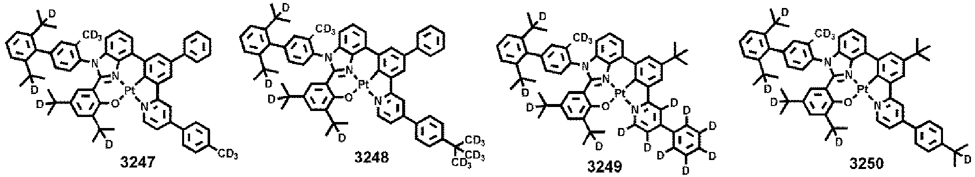

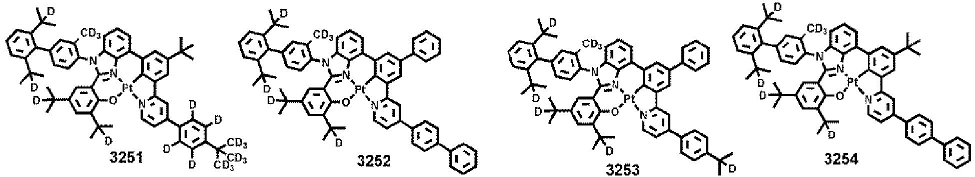

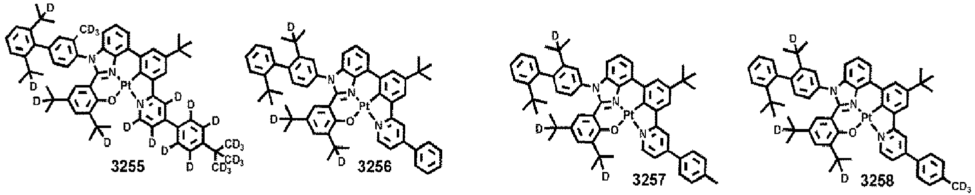

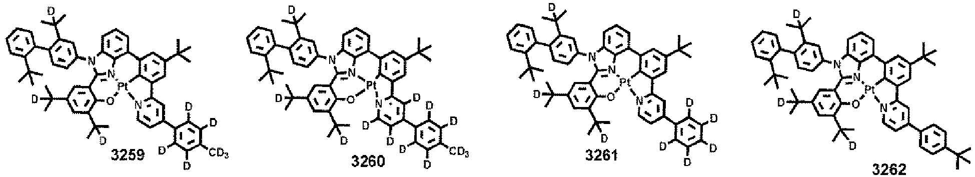

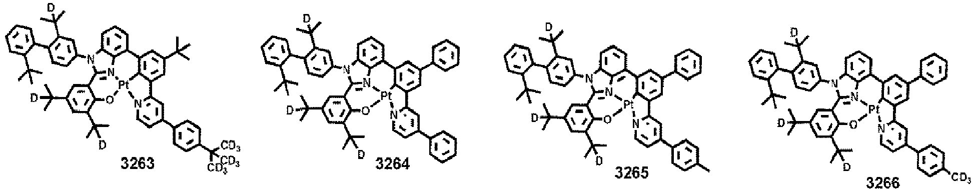

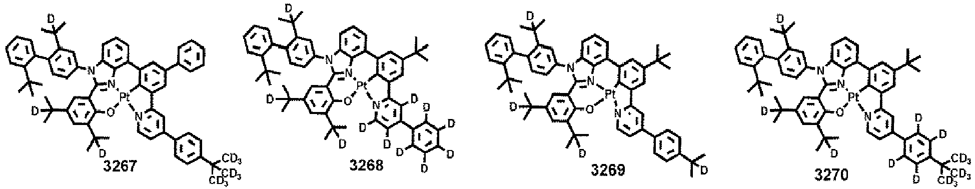

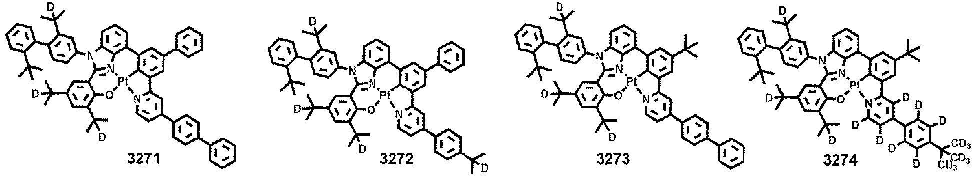

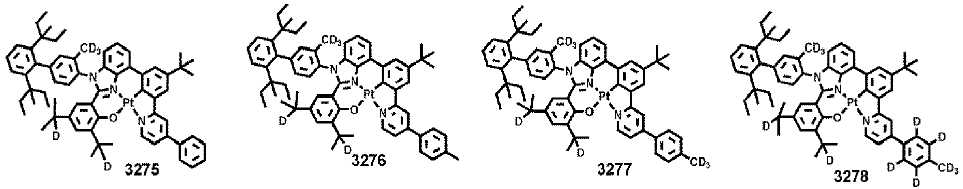

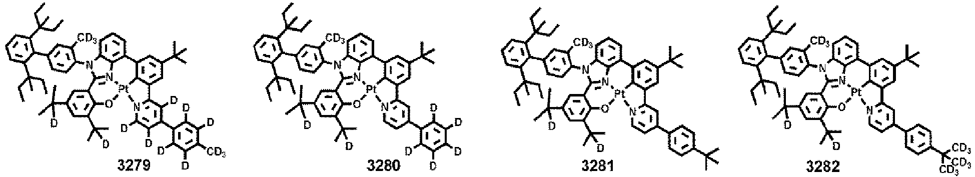

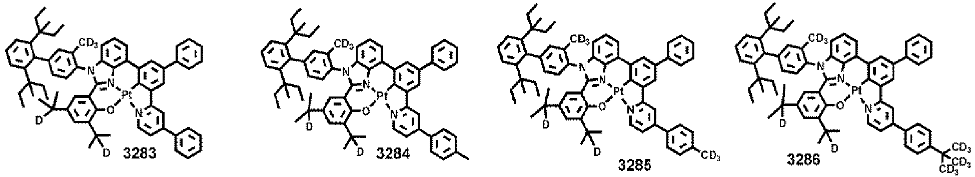

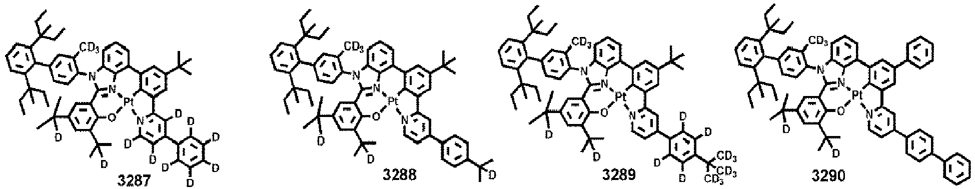

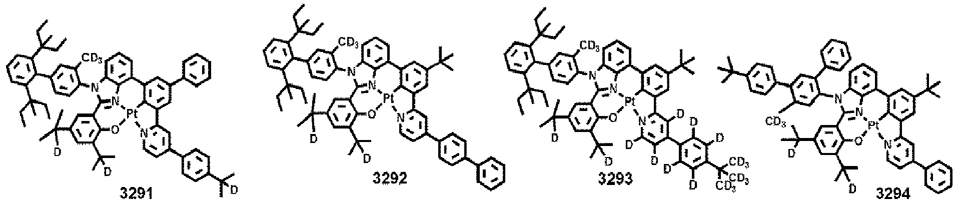

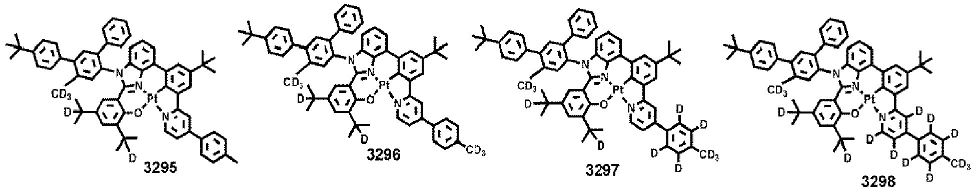

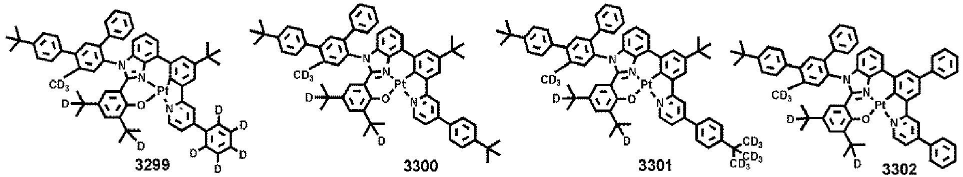

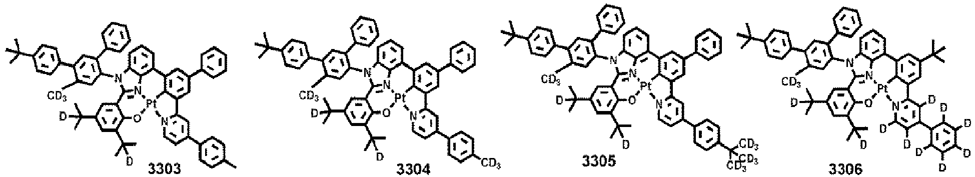

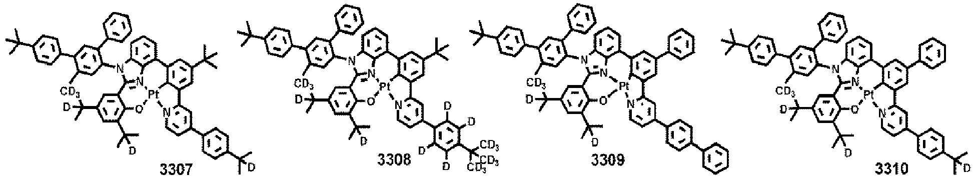

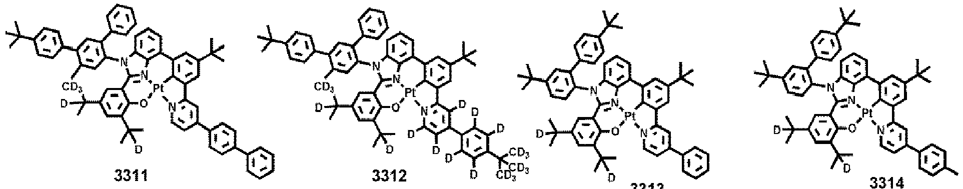

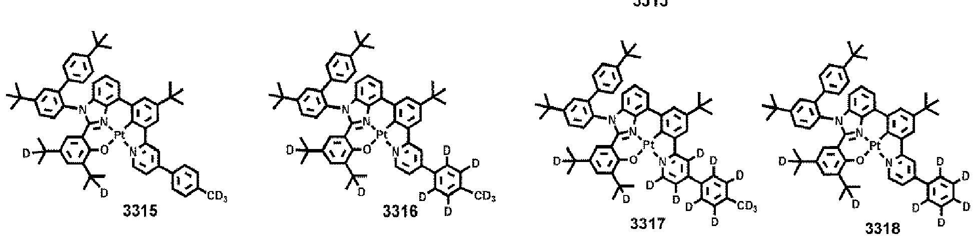

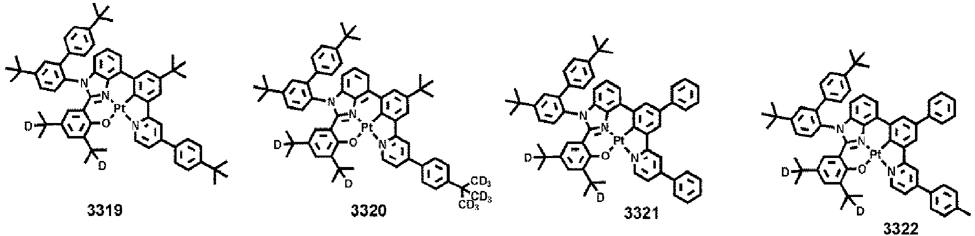

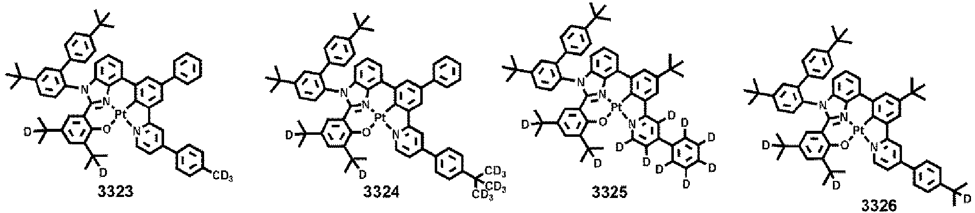

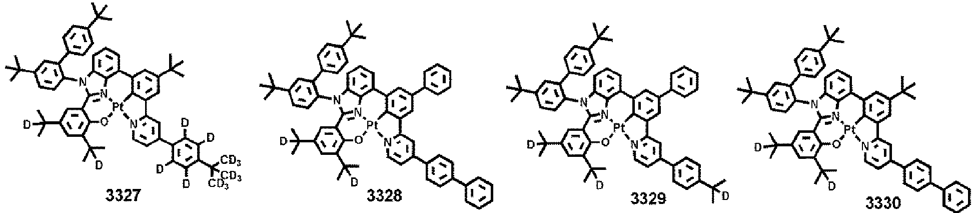

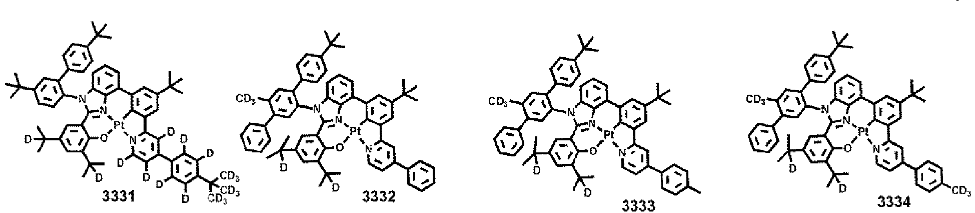

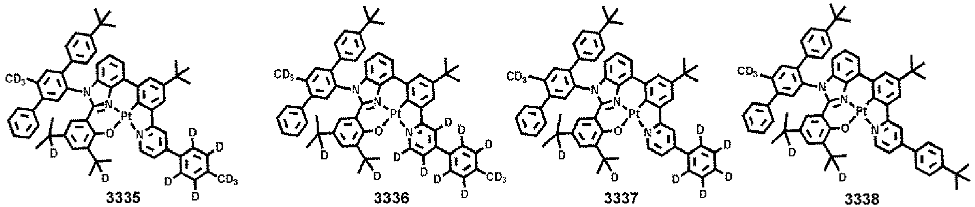

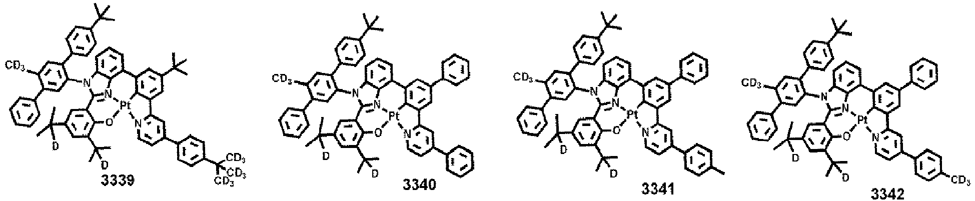

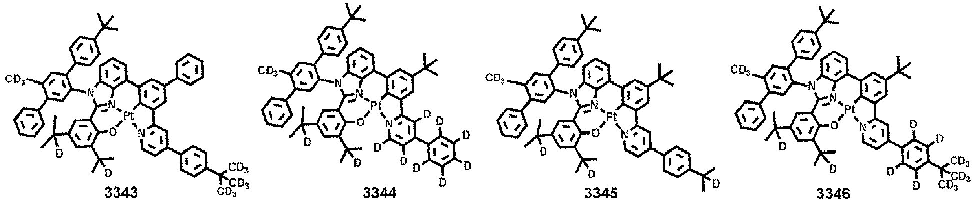

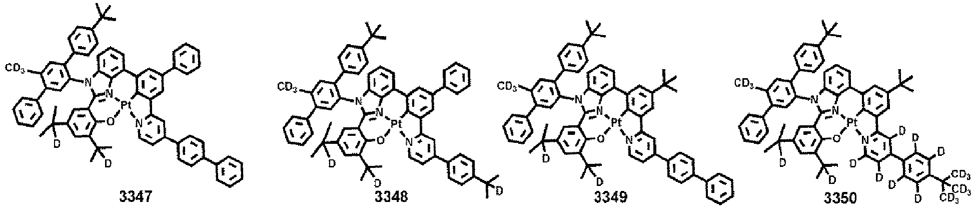

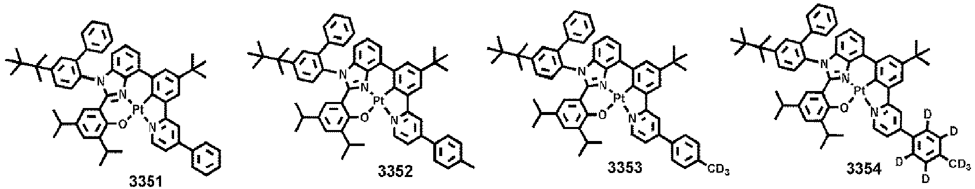

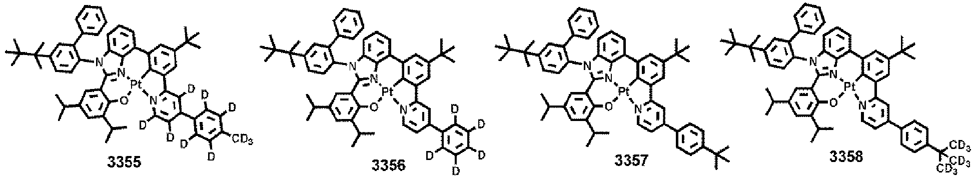

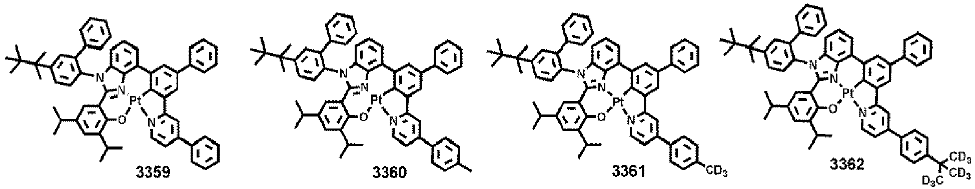

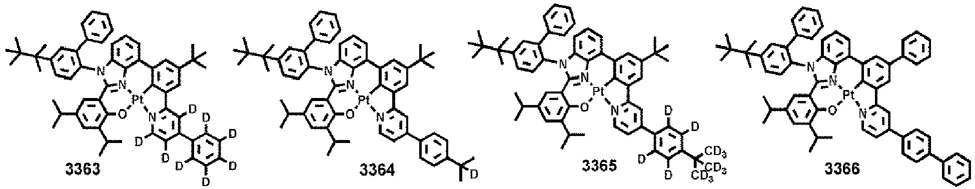

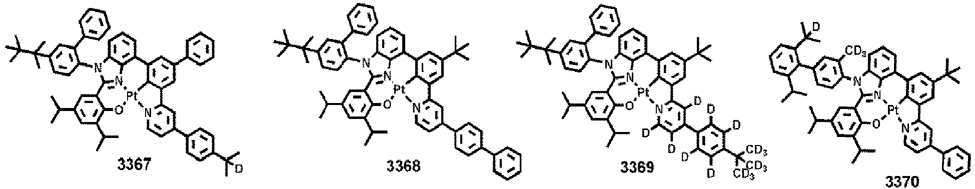

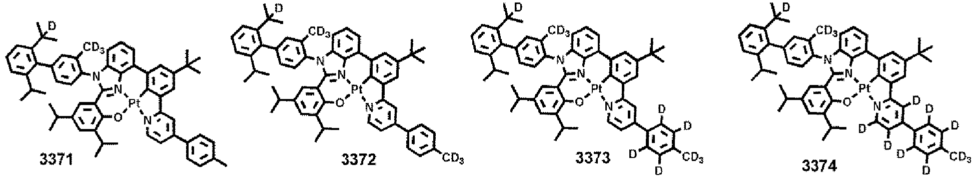

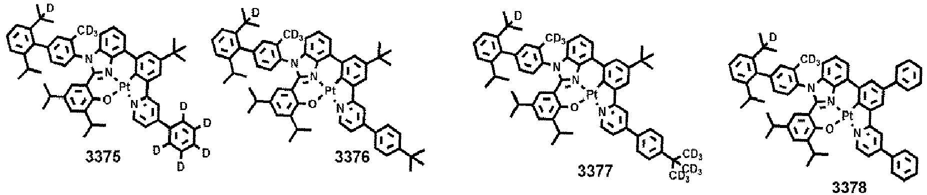

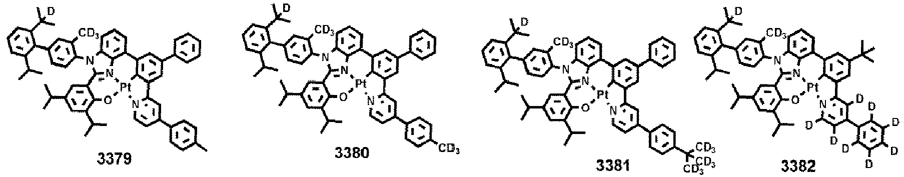

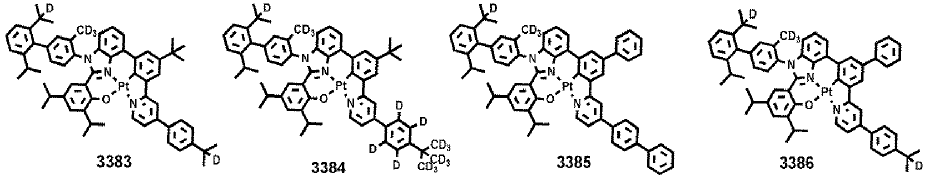

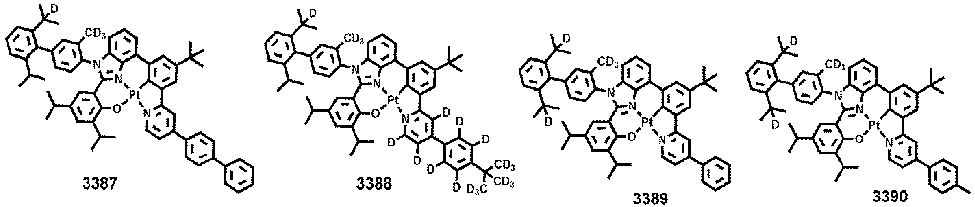

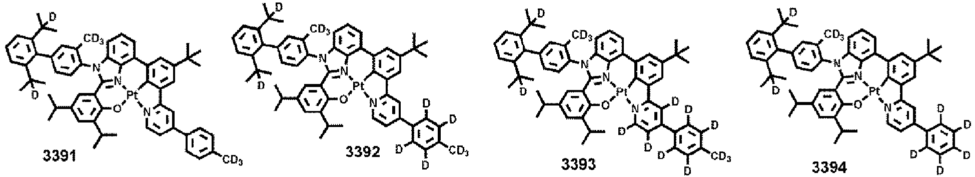

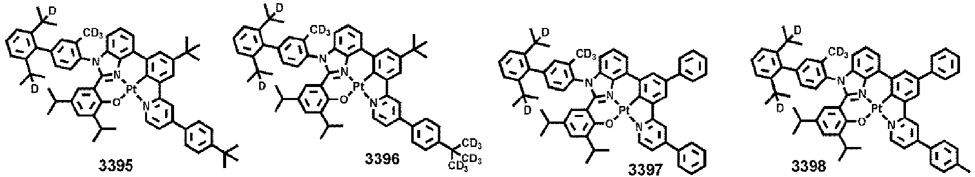

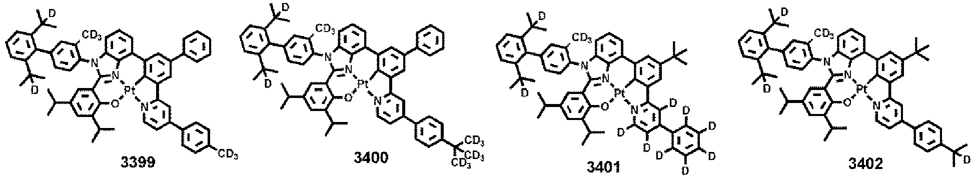

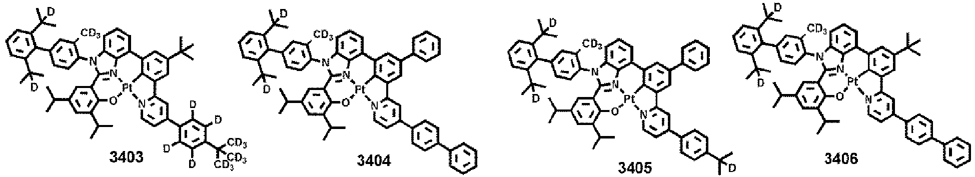

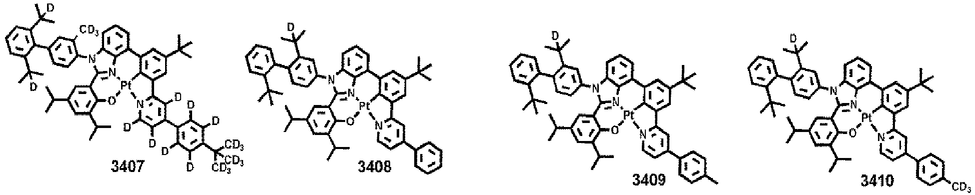

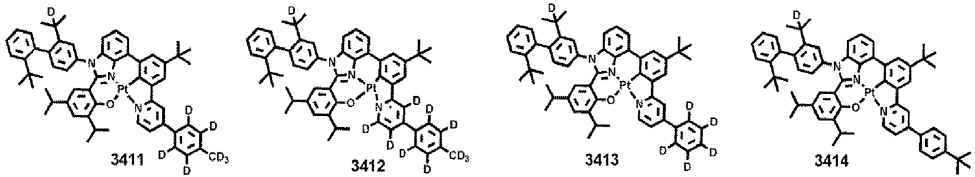

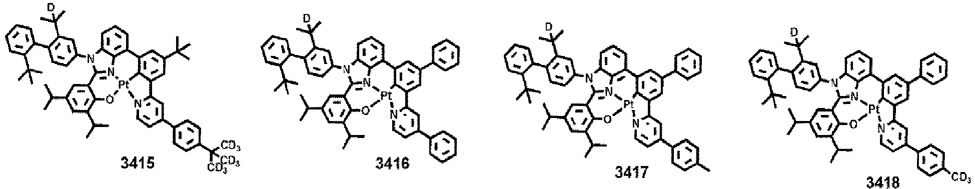

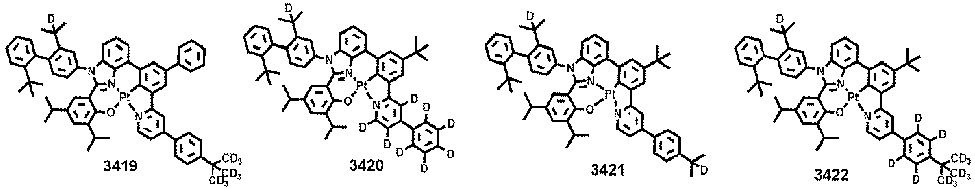

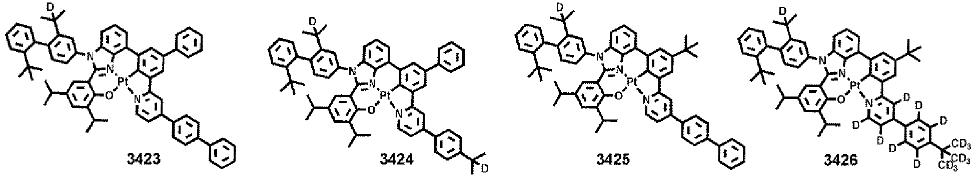

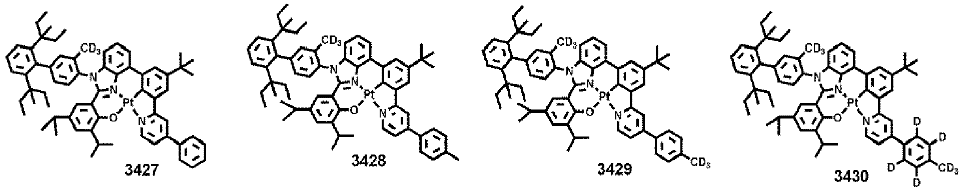

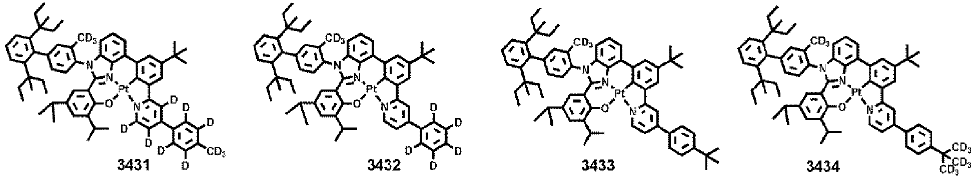

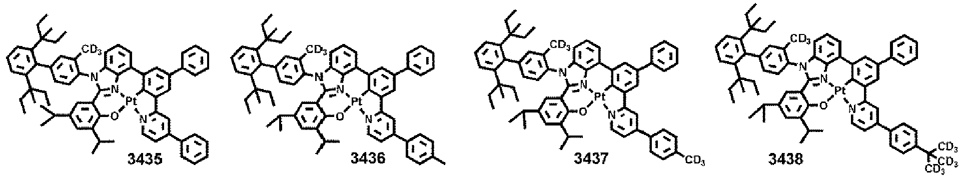

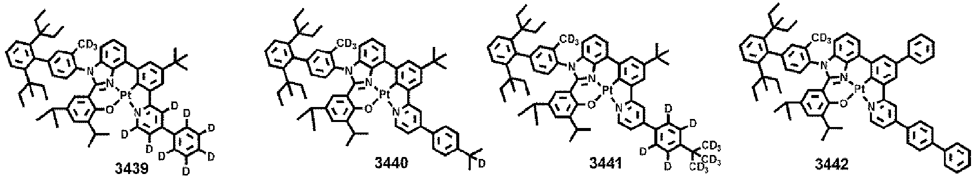

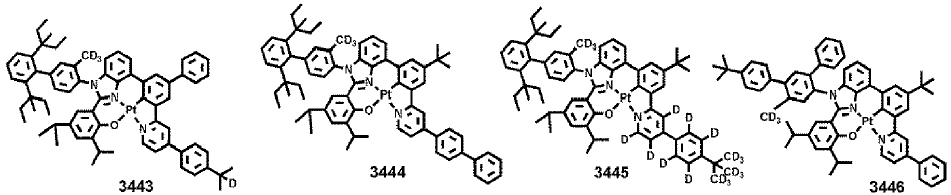

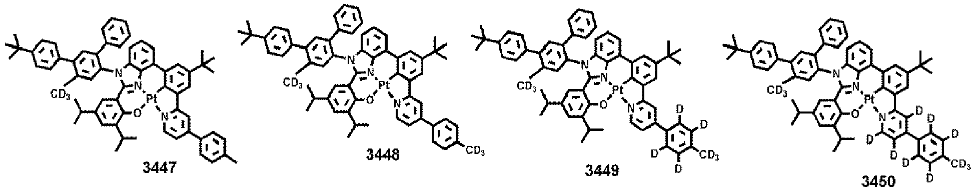

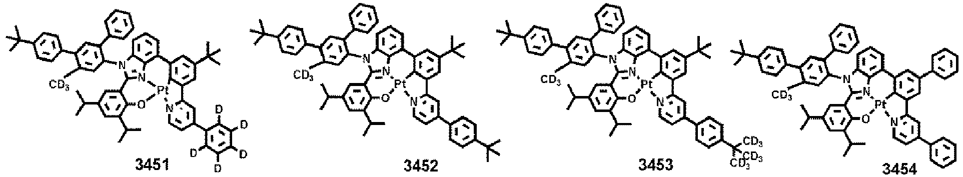

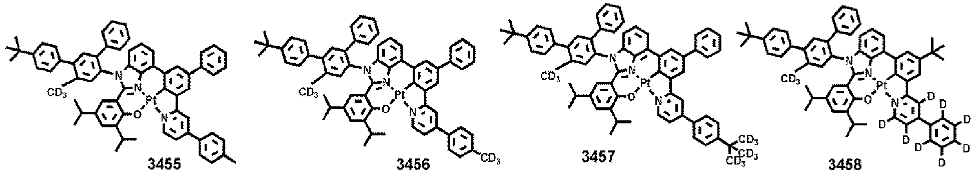

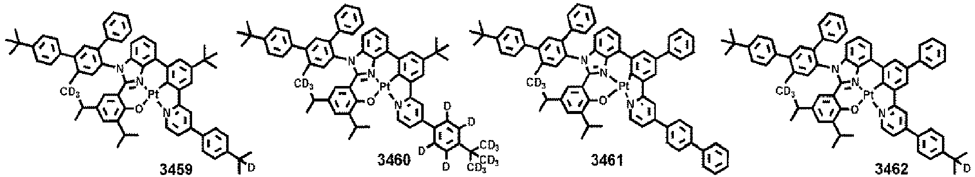

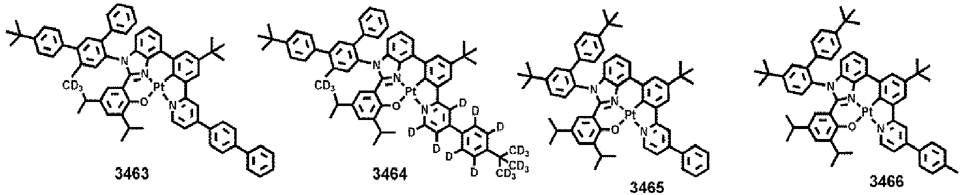

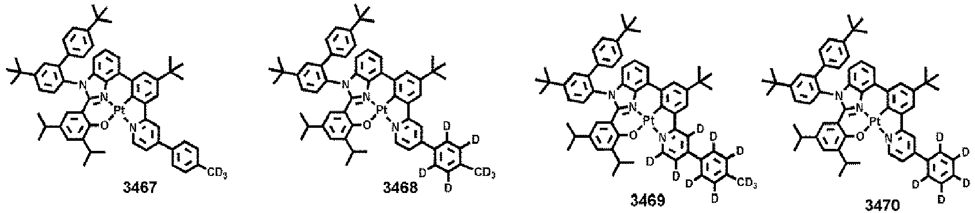

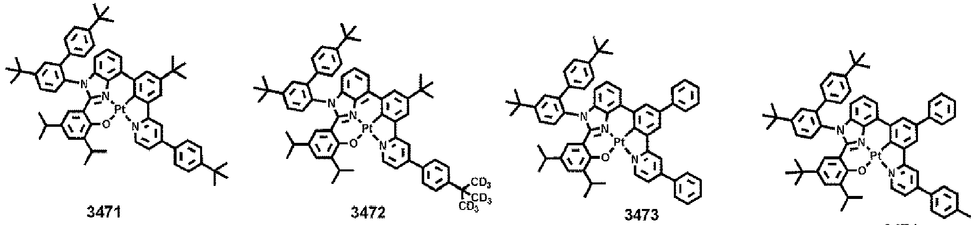

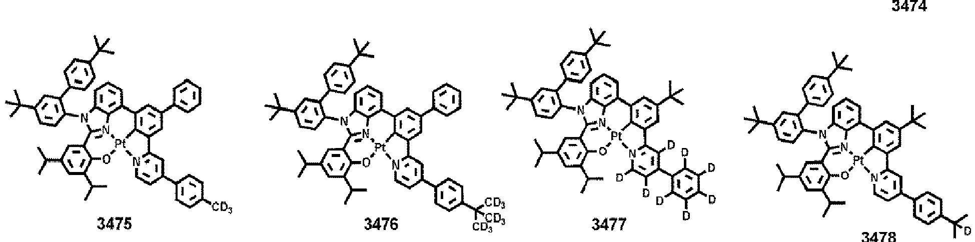

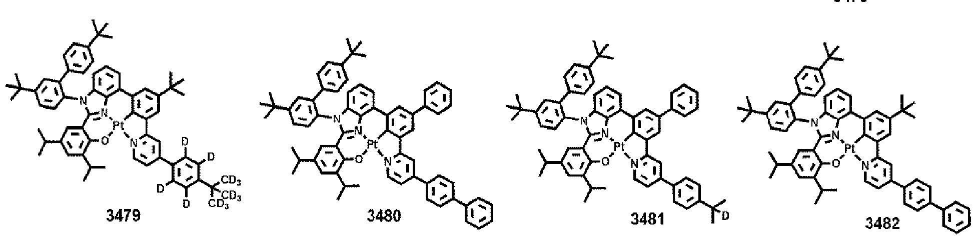

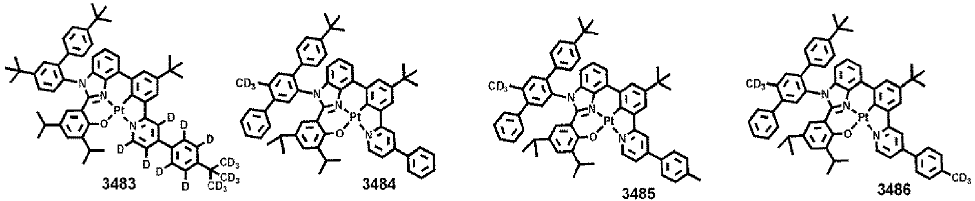

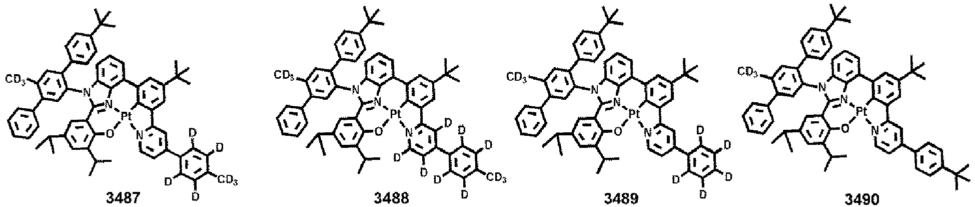

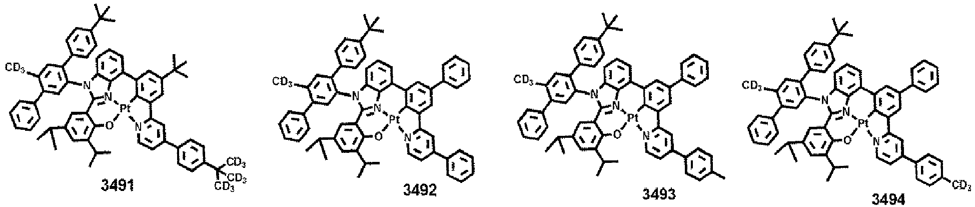

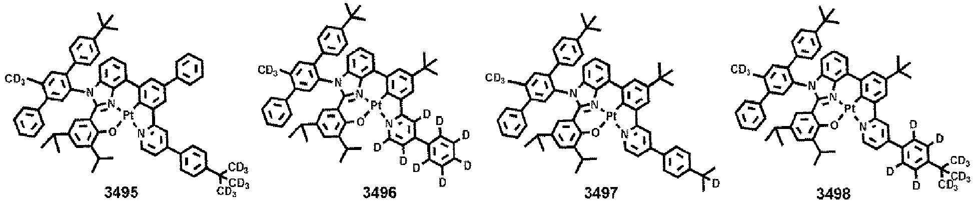

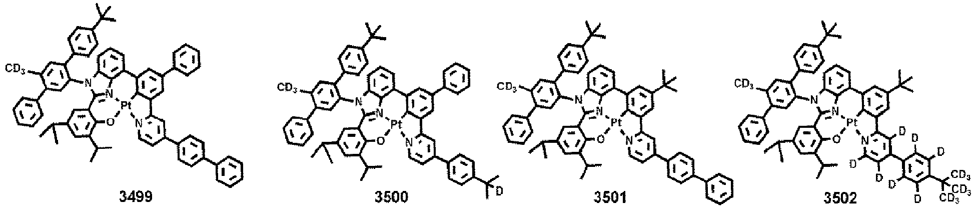

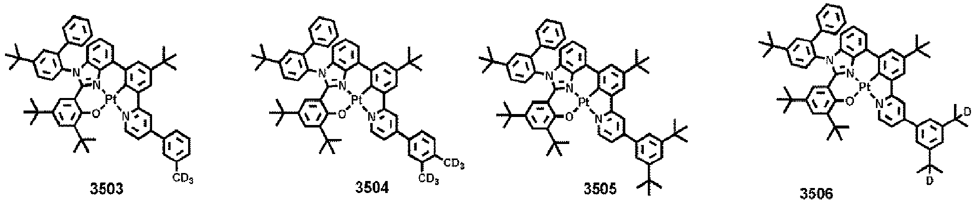

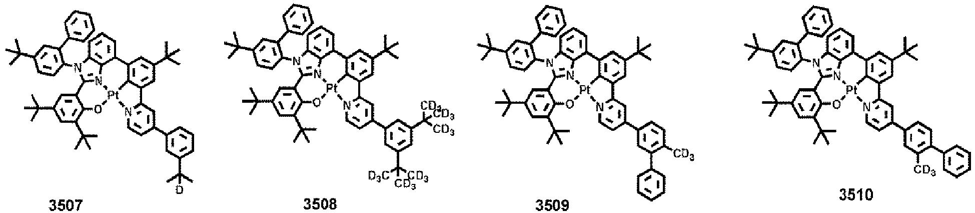

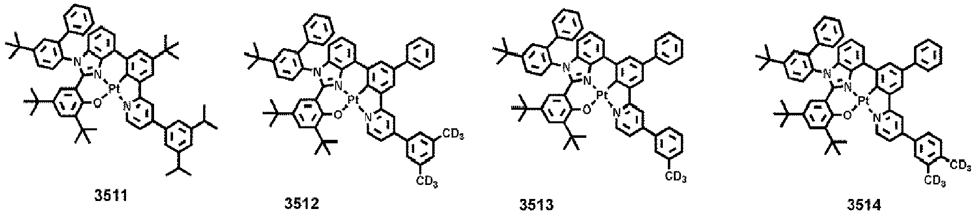

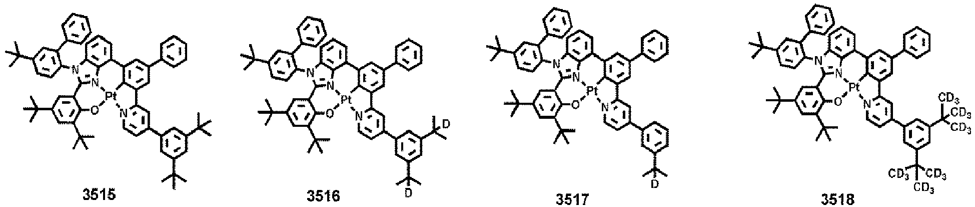

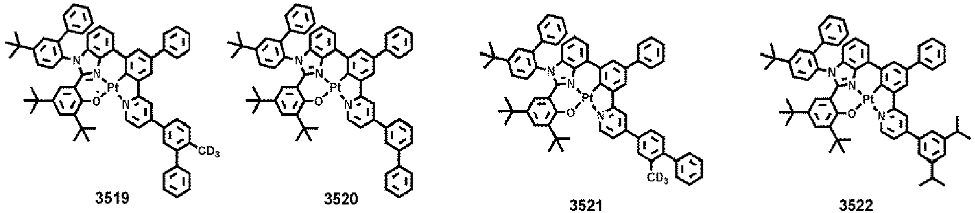

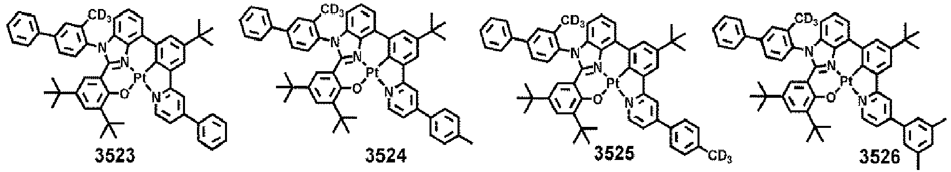

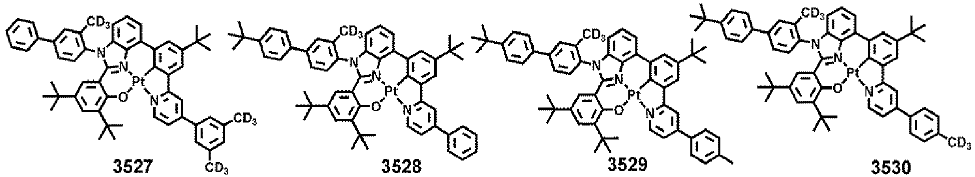

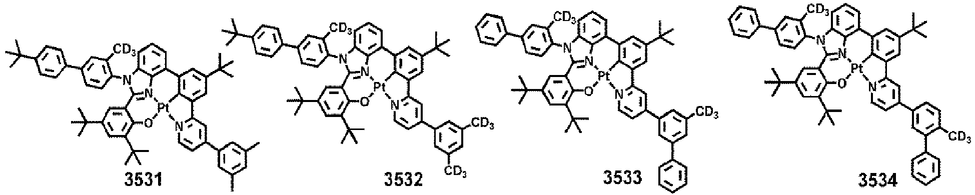

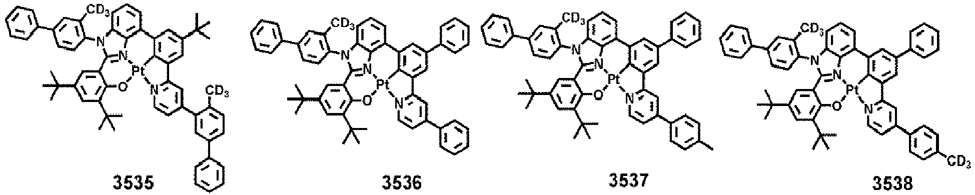

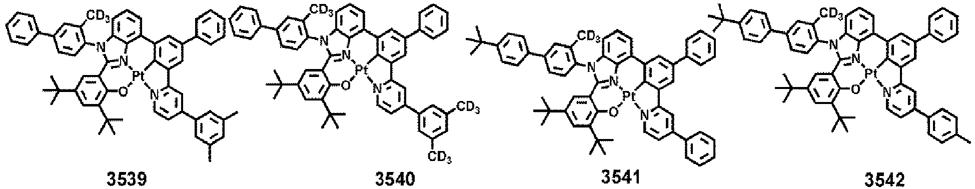

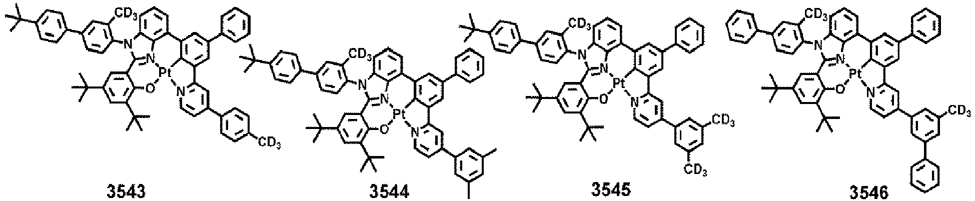

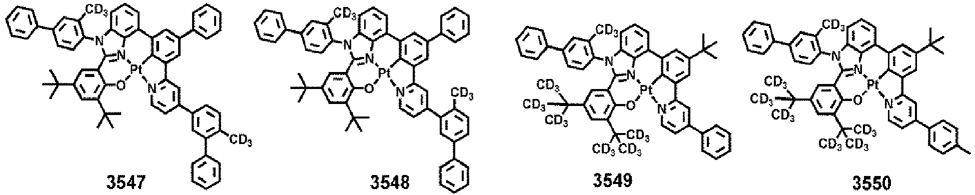

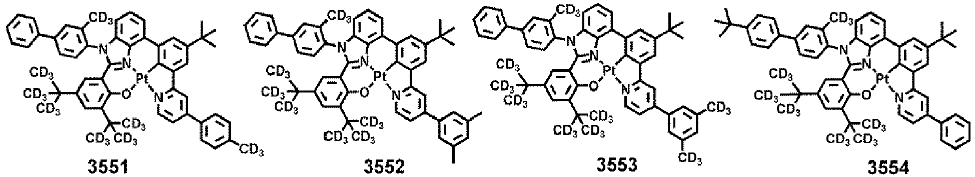

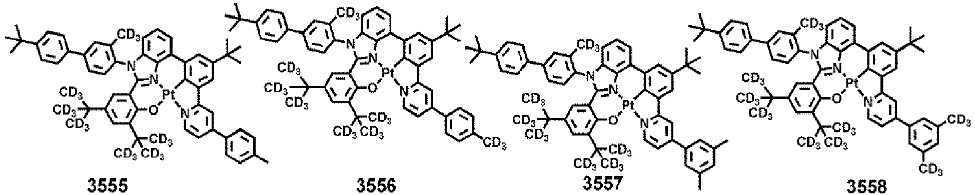

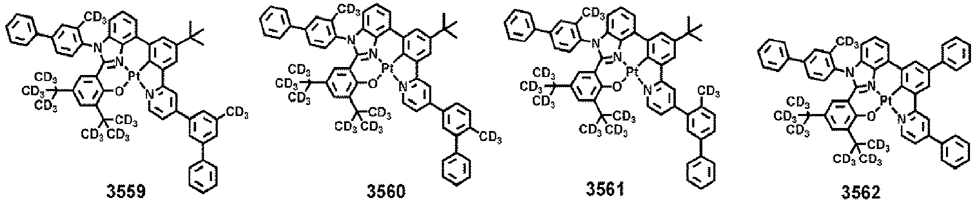

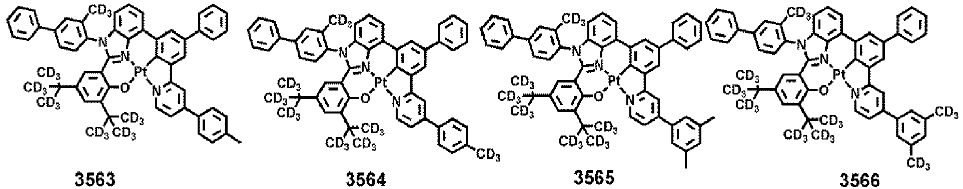

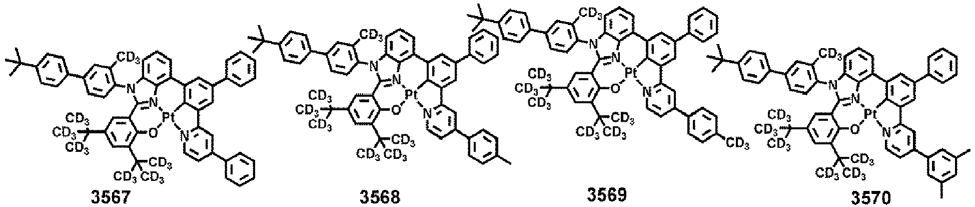

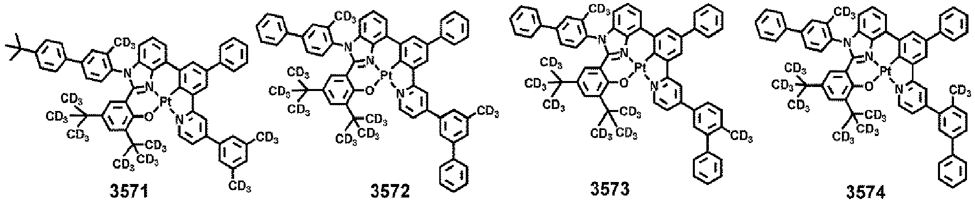

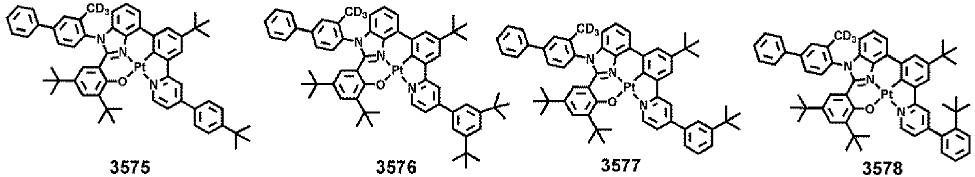

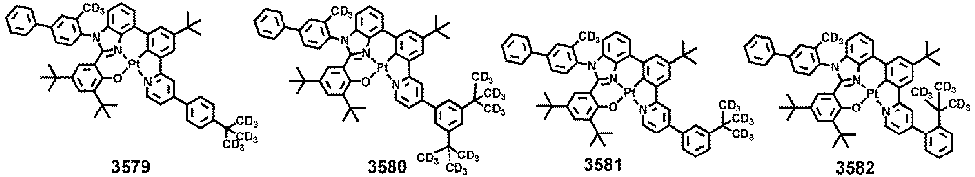

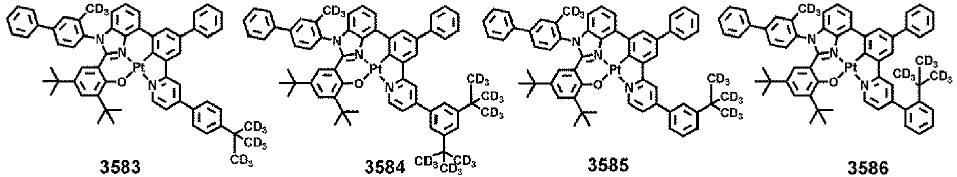

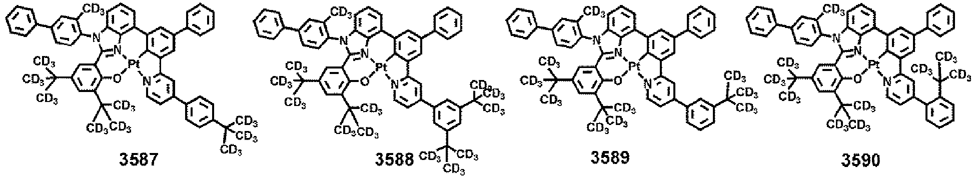

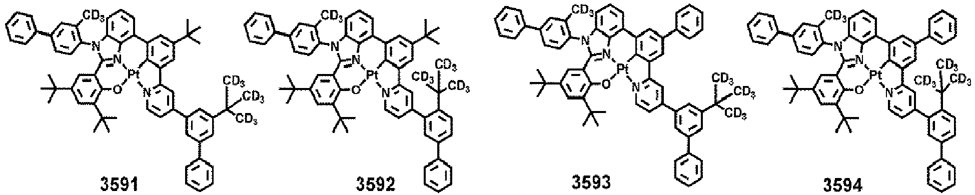

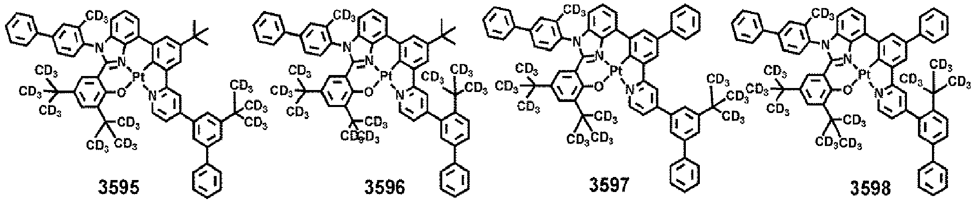

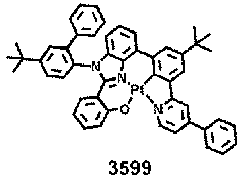

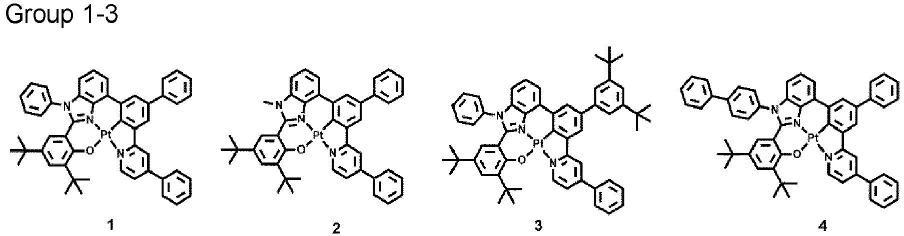

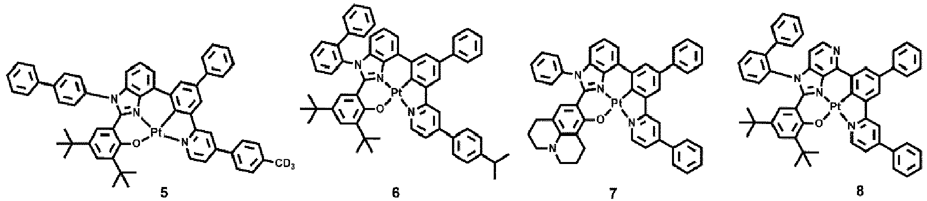

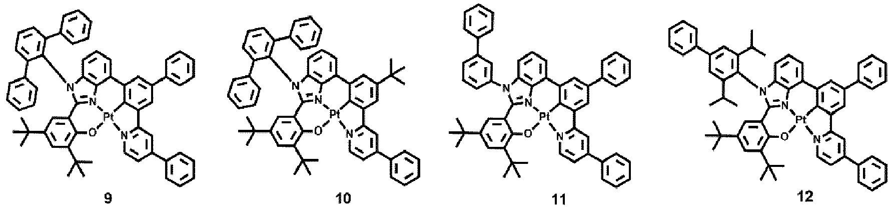

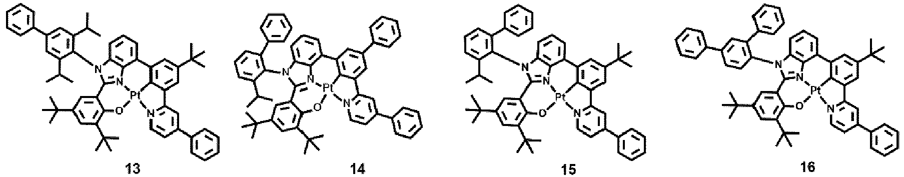

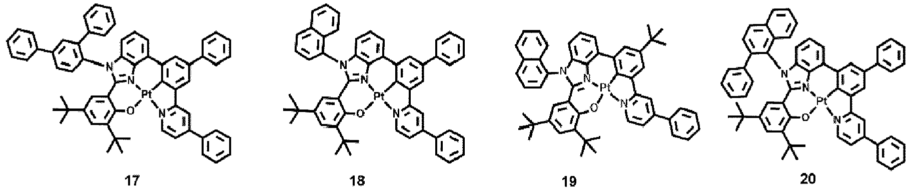

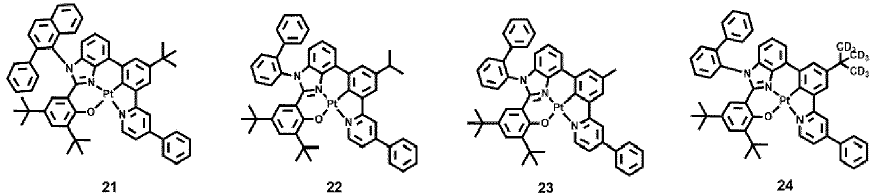

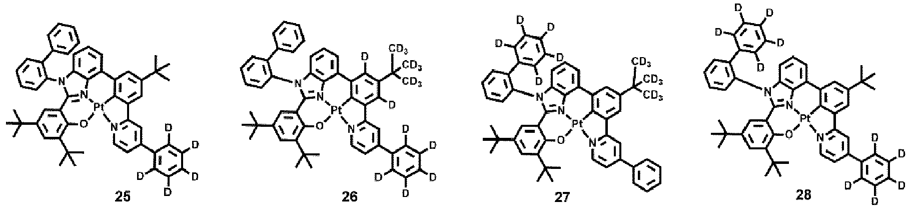

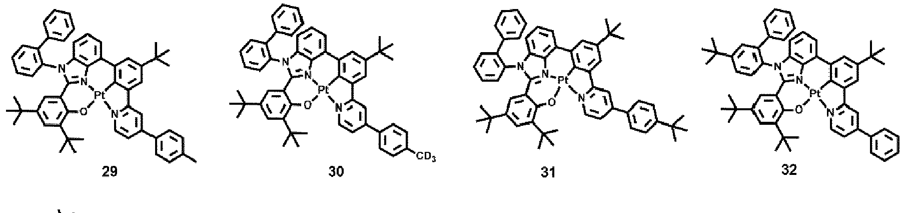

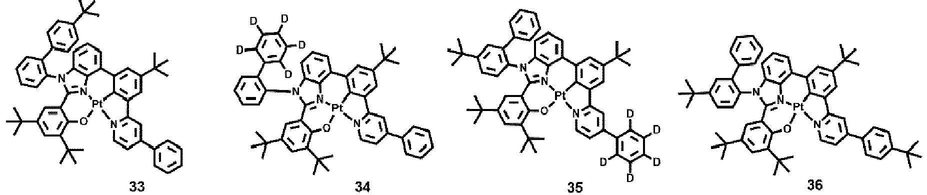

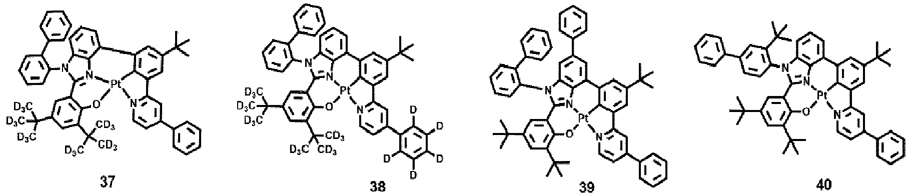

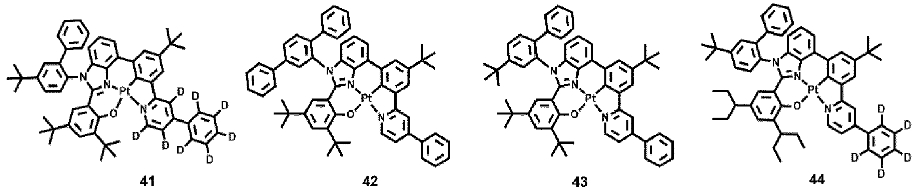

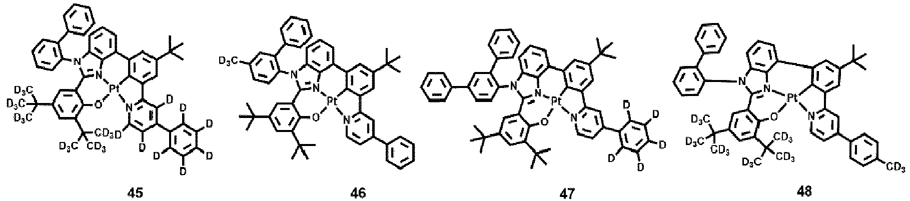

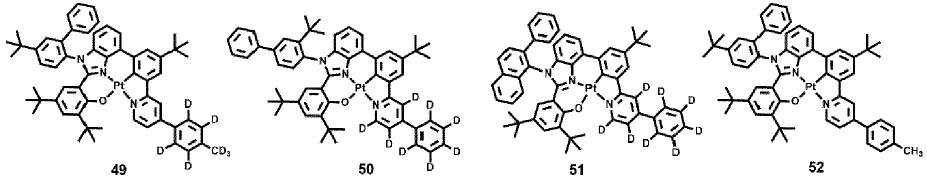

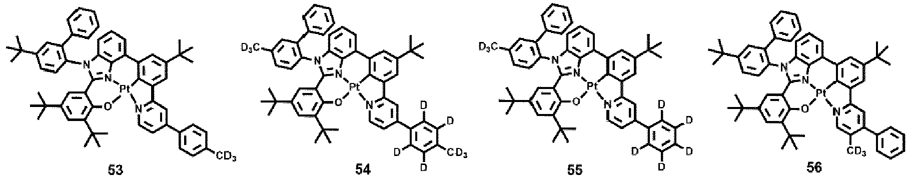

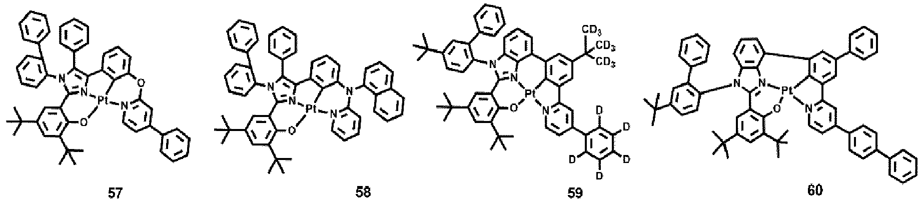

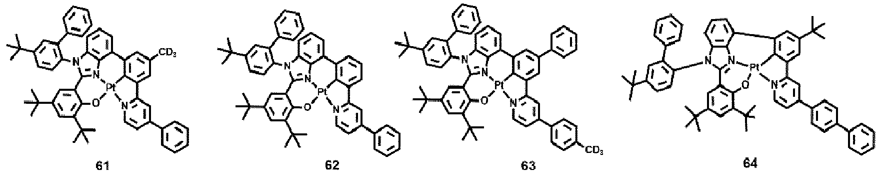

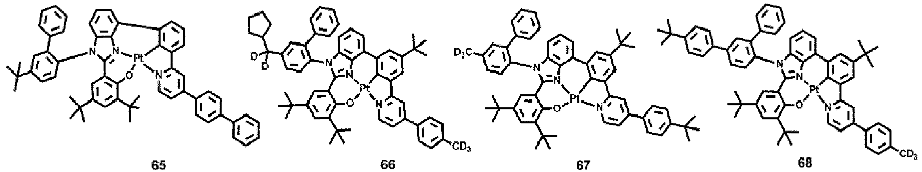

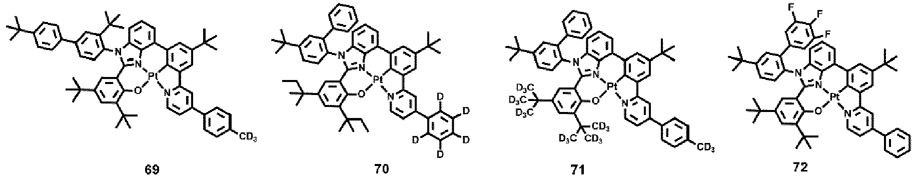

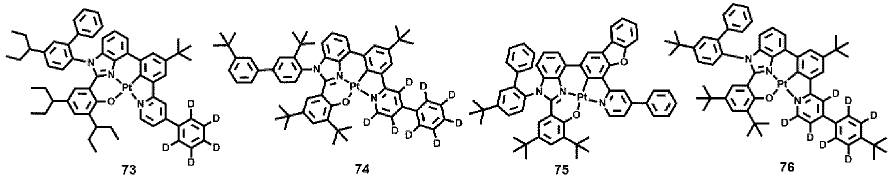

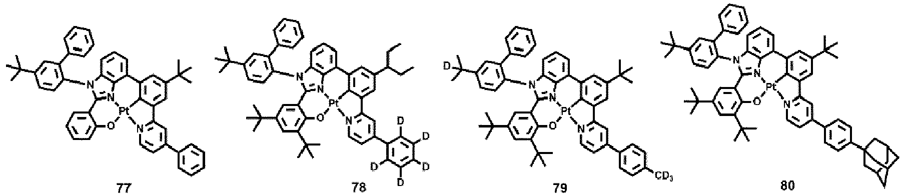

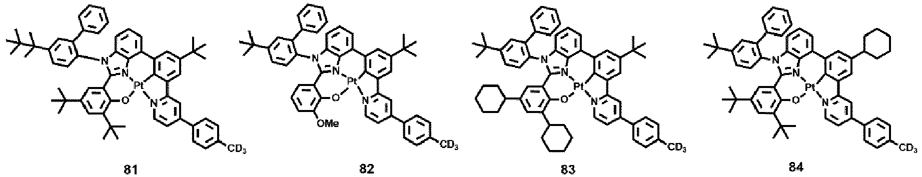

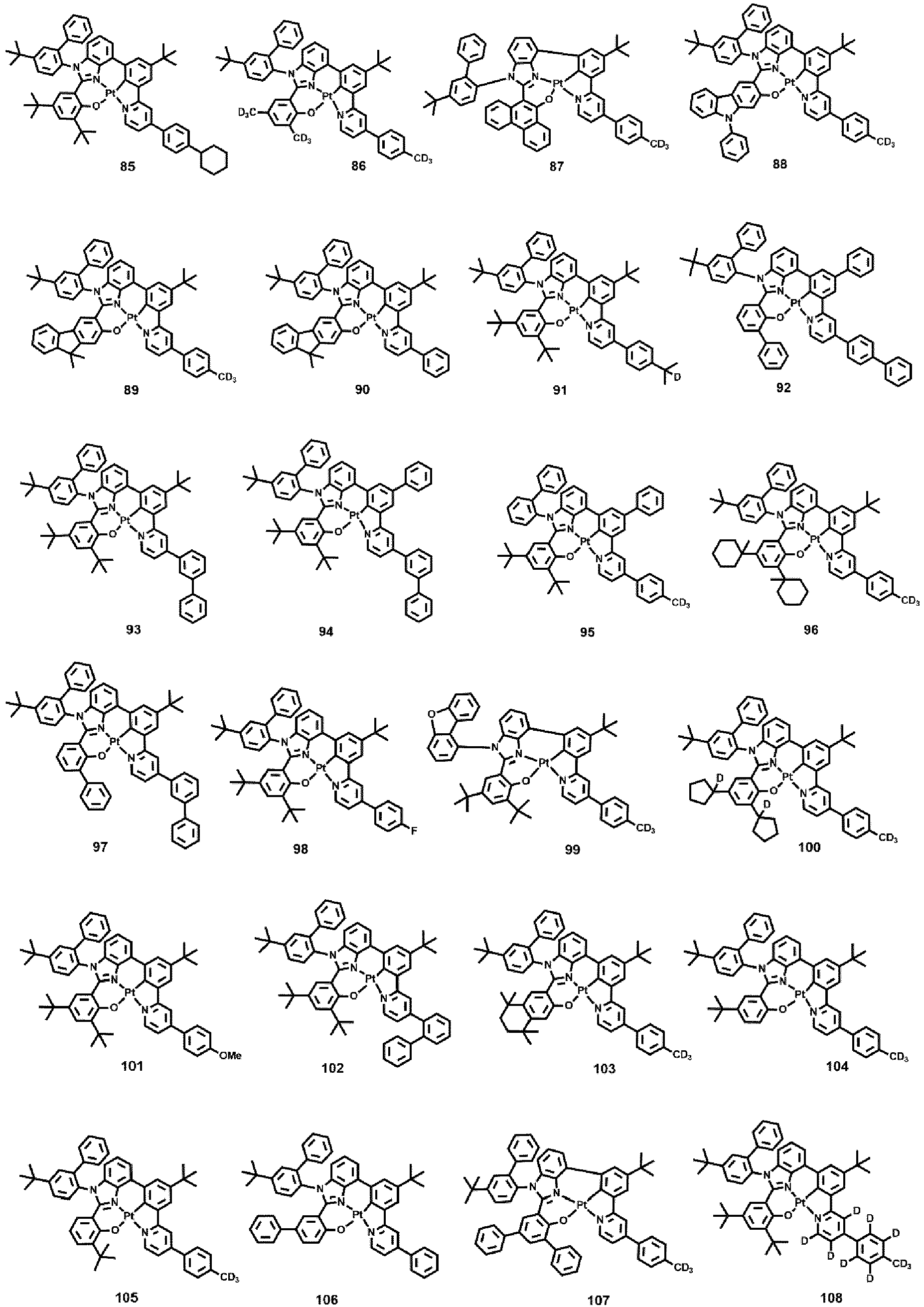

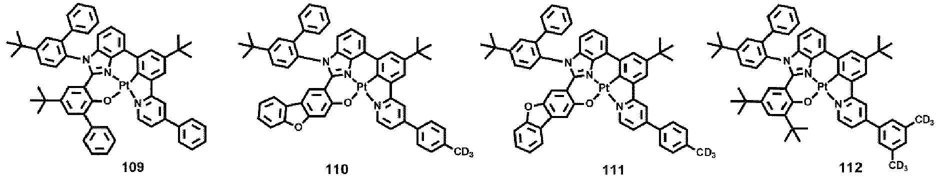

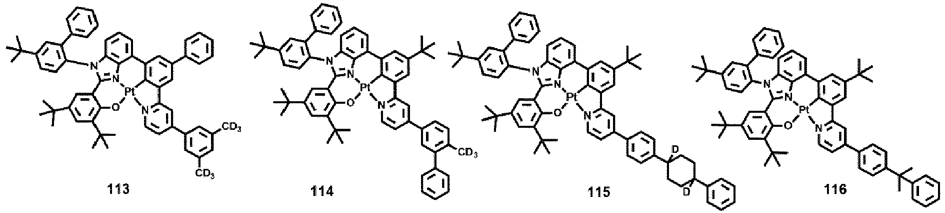

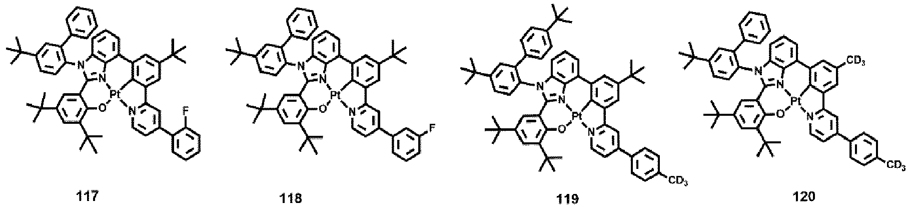

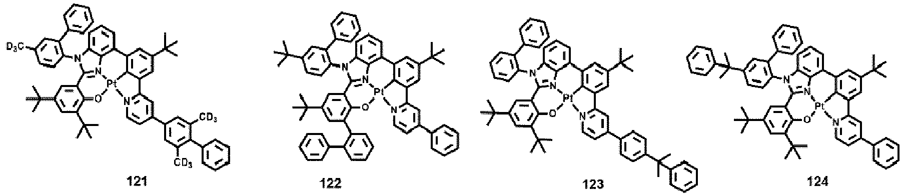

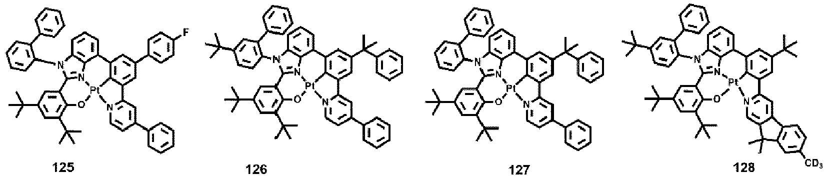

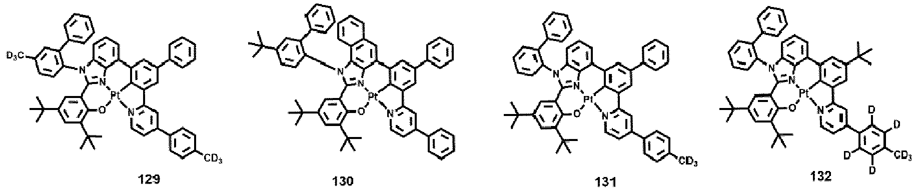

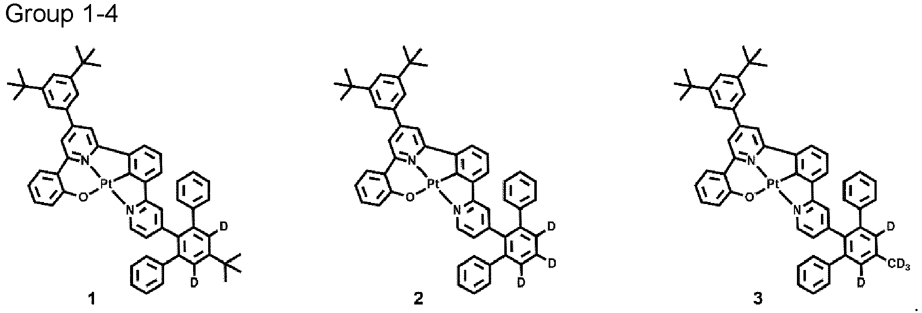

For example, the second compound may be one or more compounds of Group 2-1 to Group 2-5:

Group 2-1

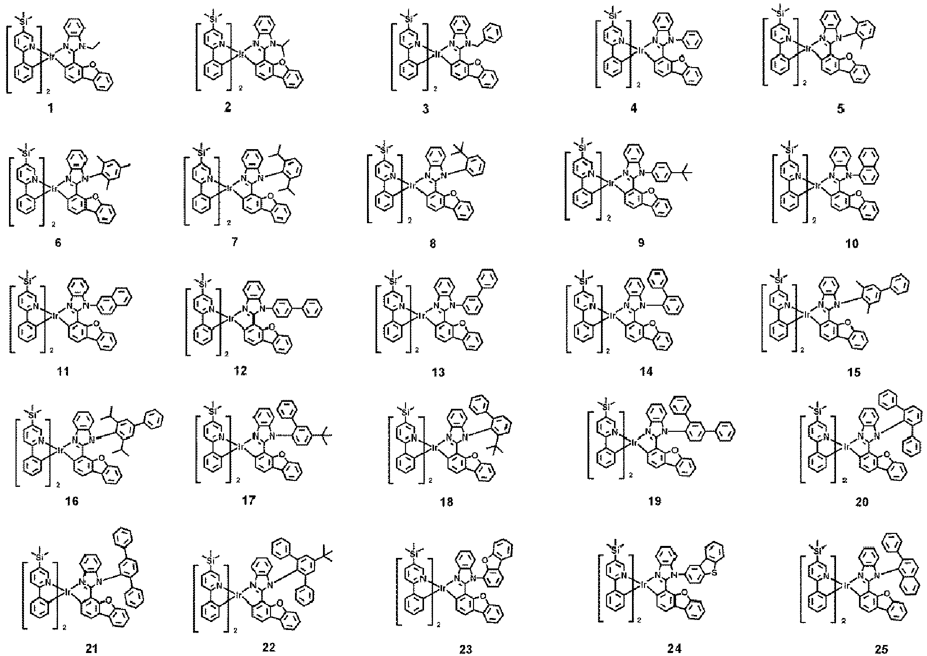

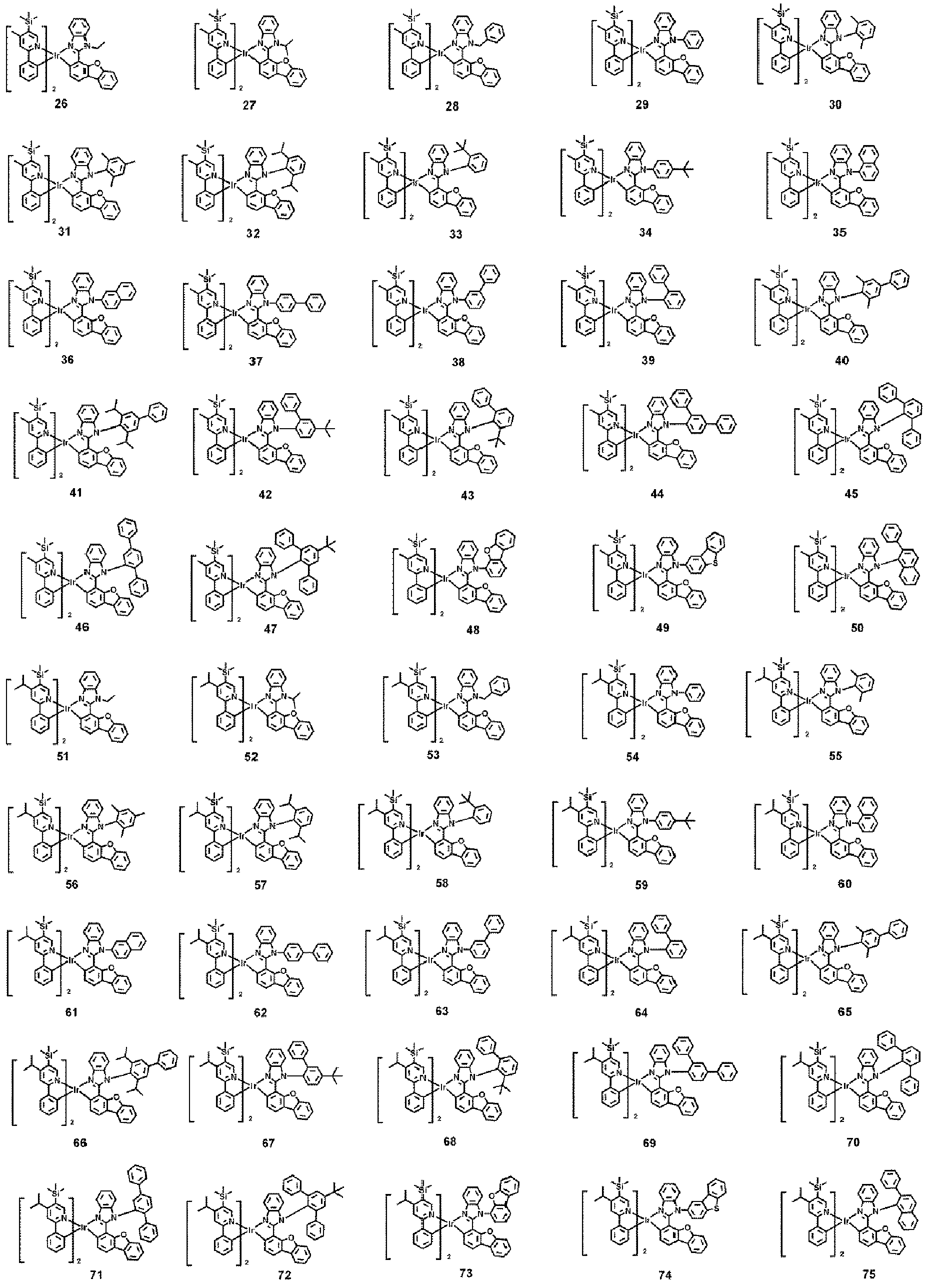

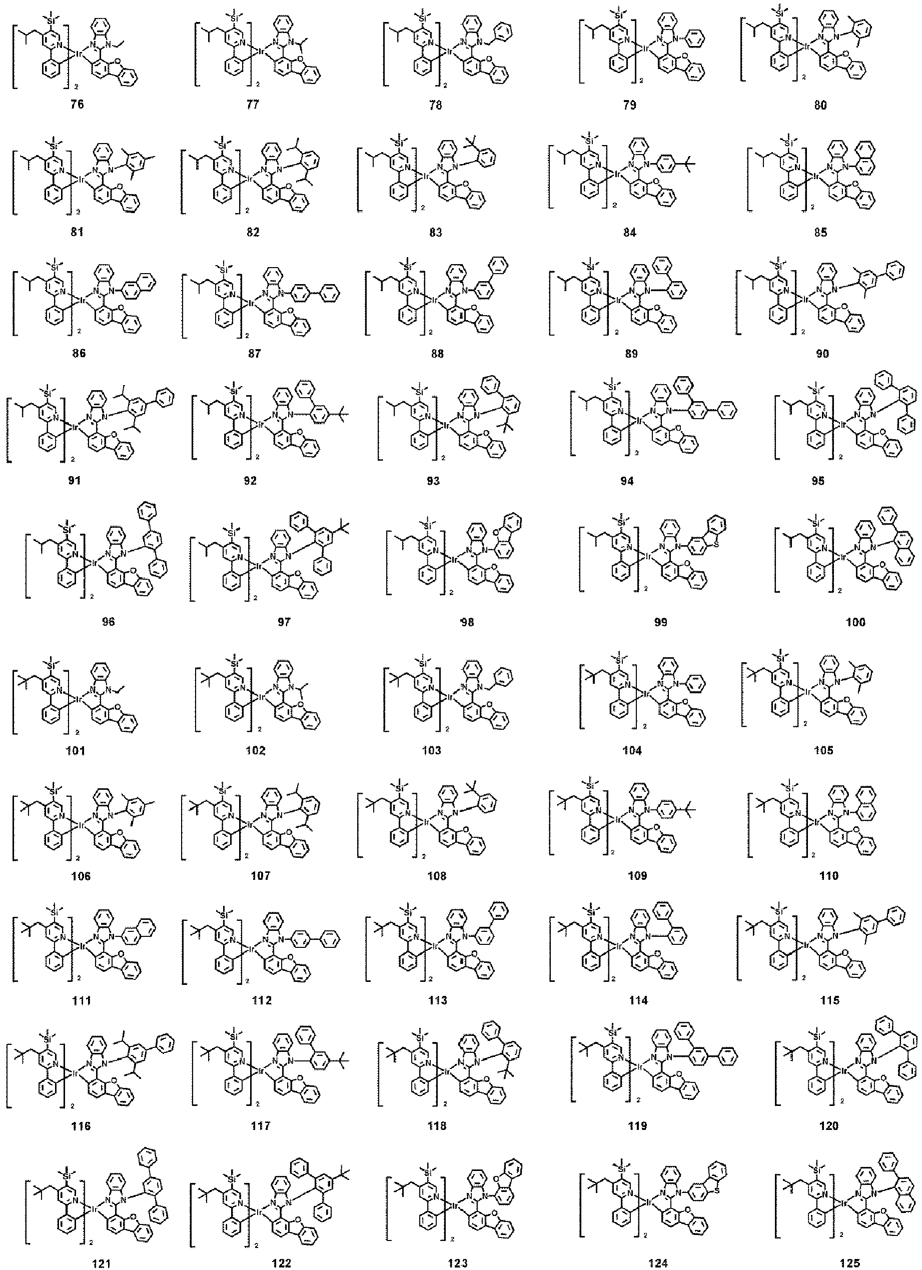

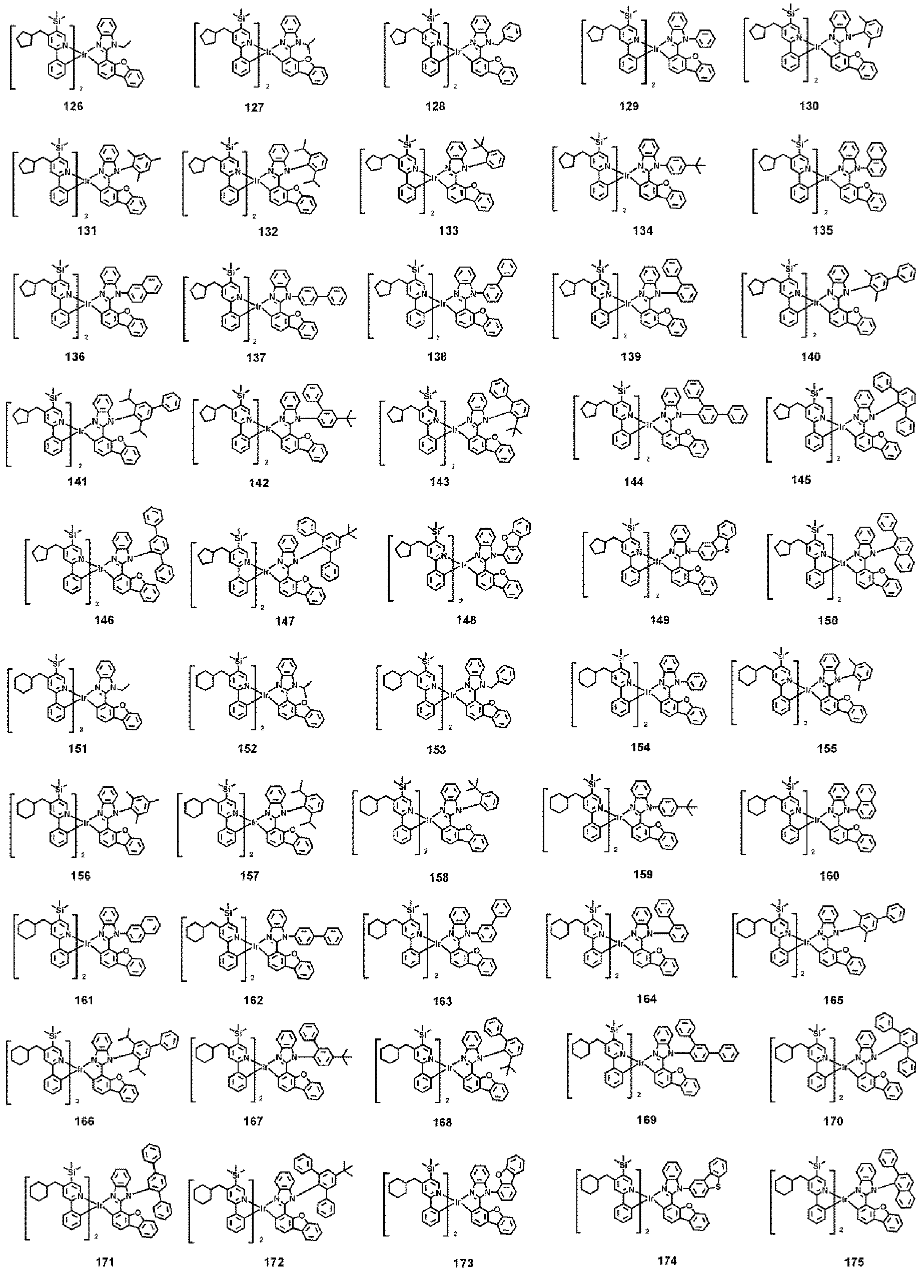

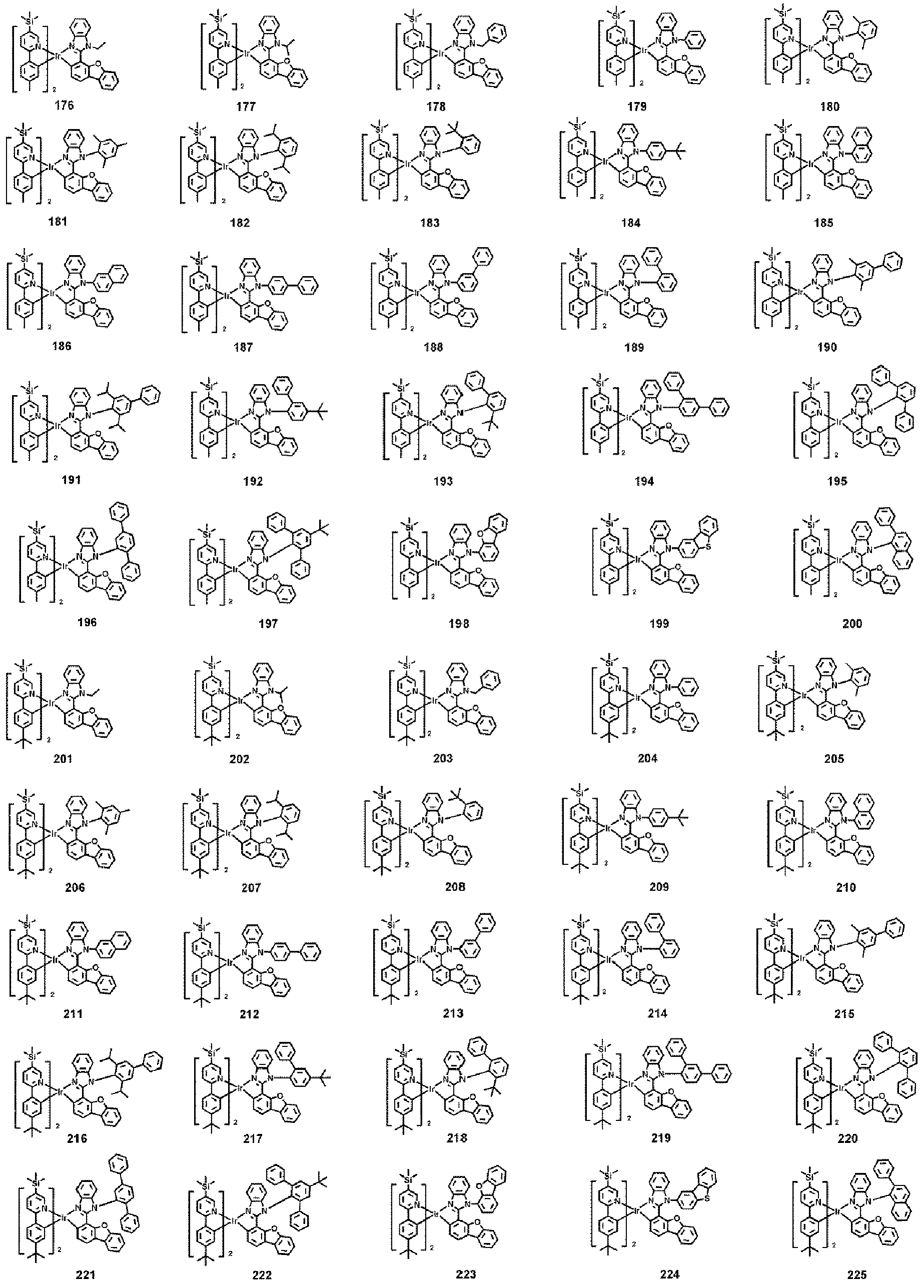

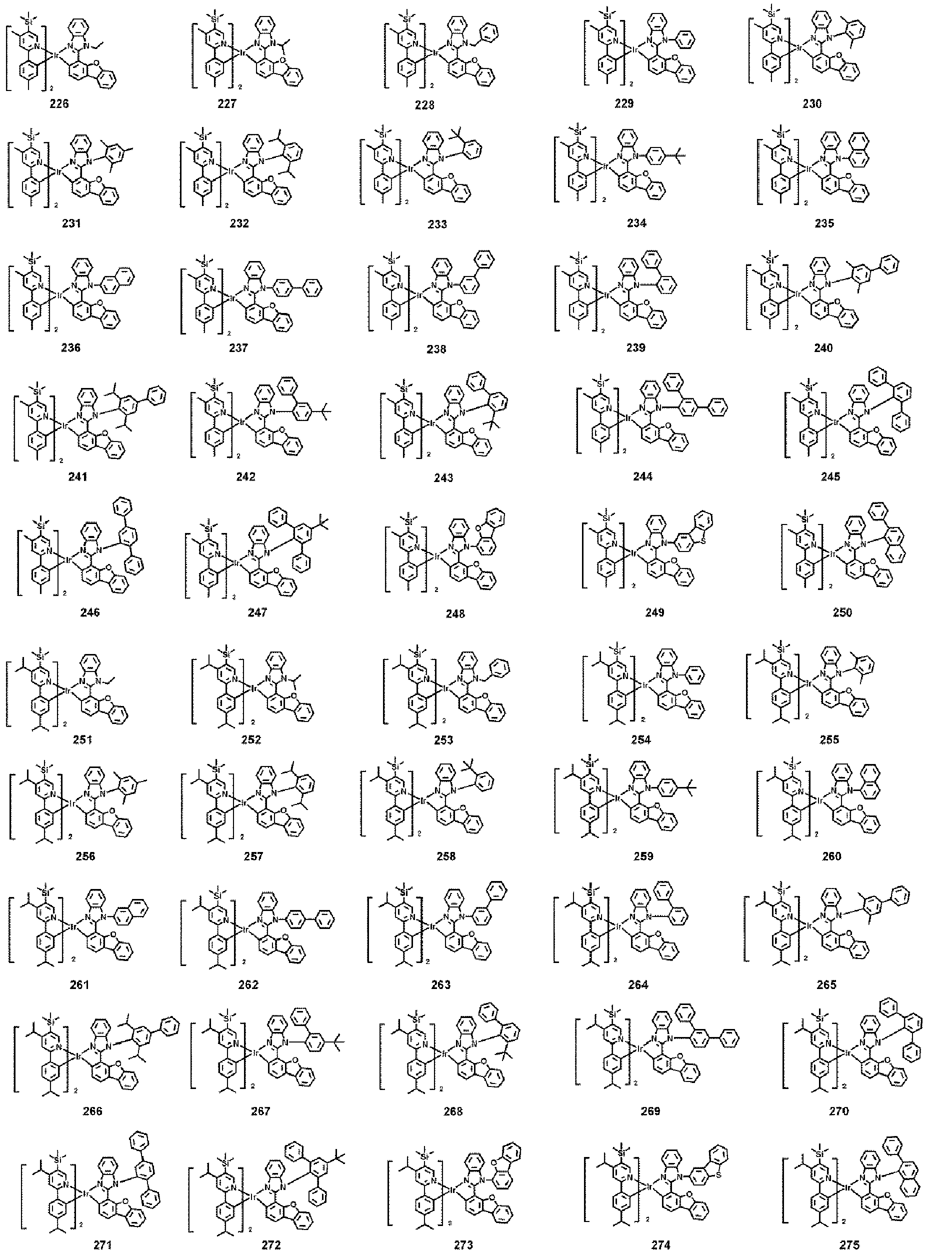

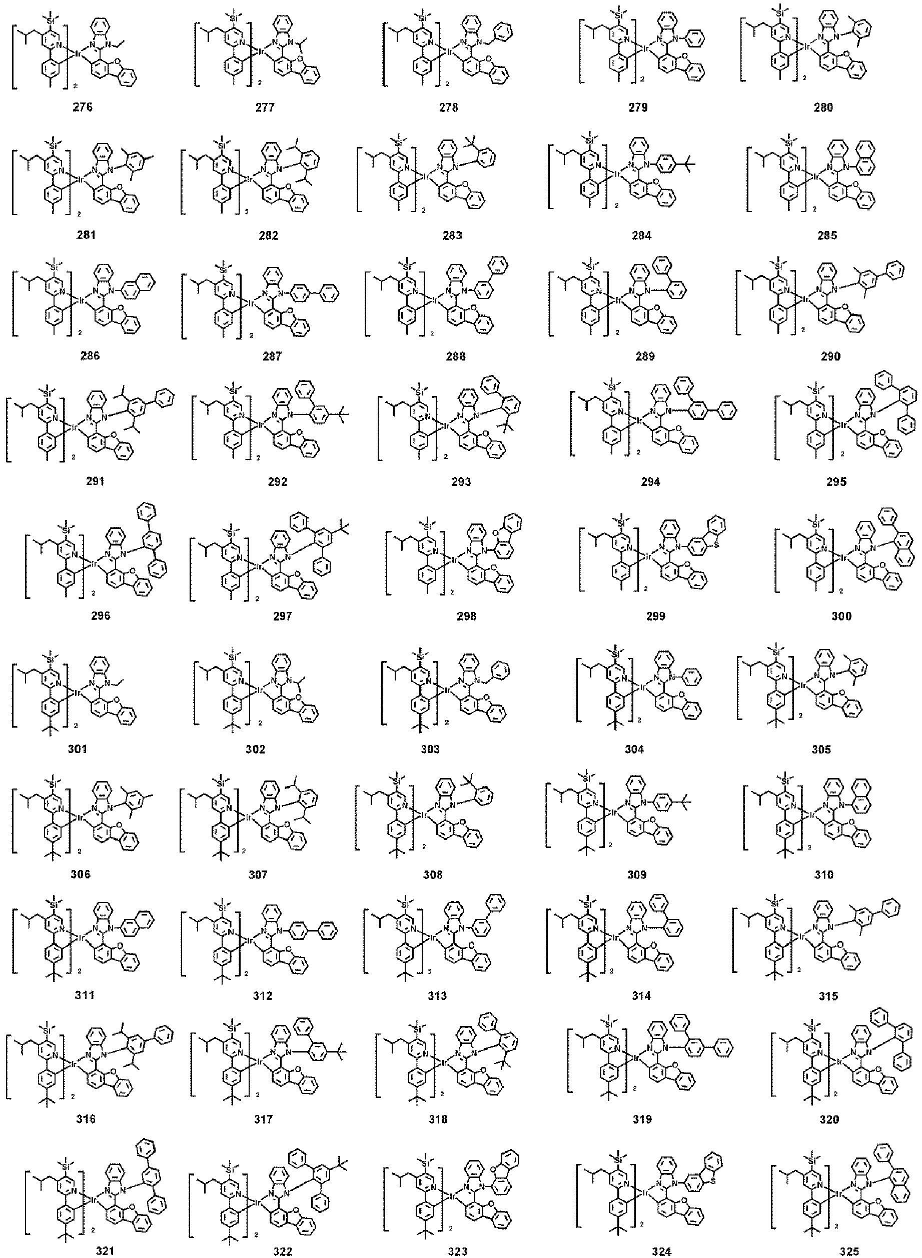

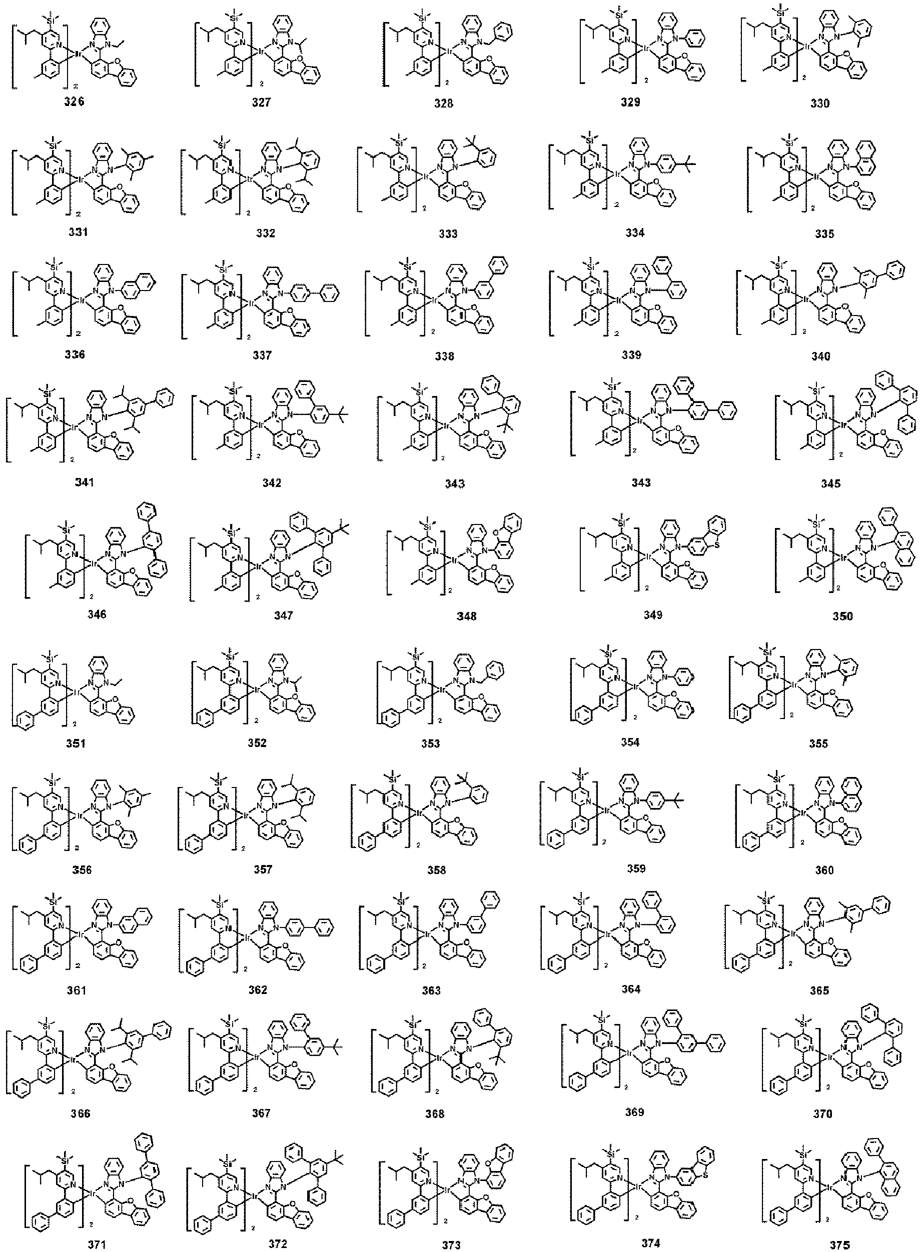

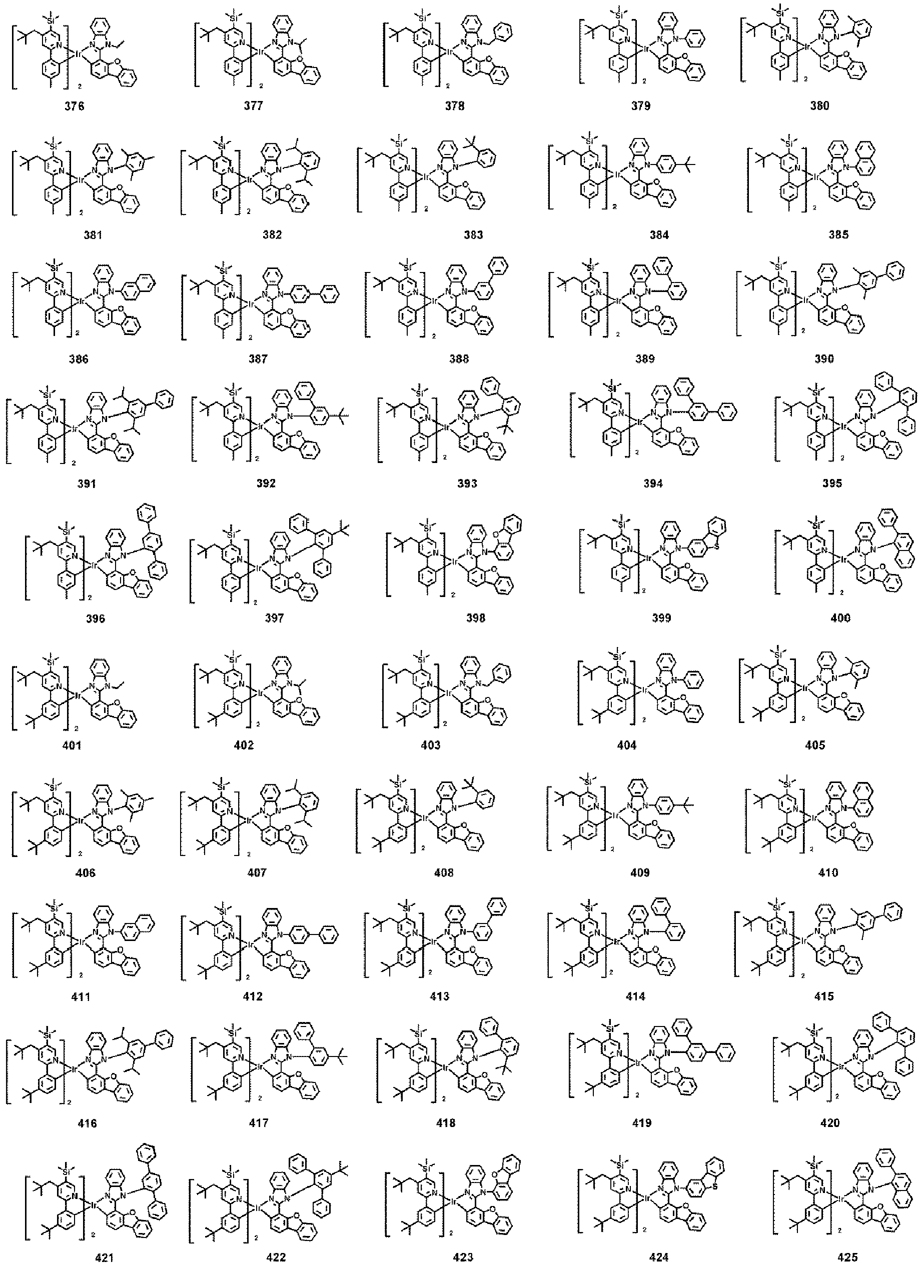

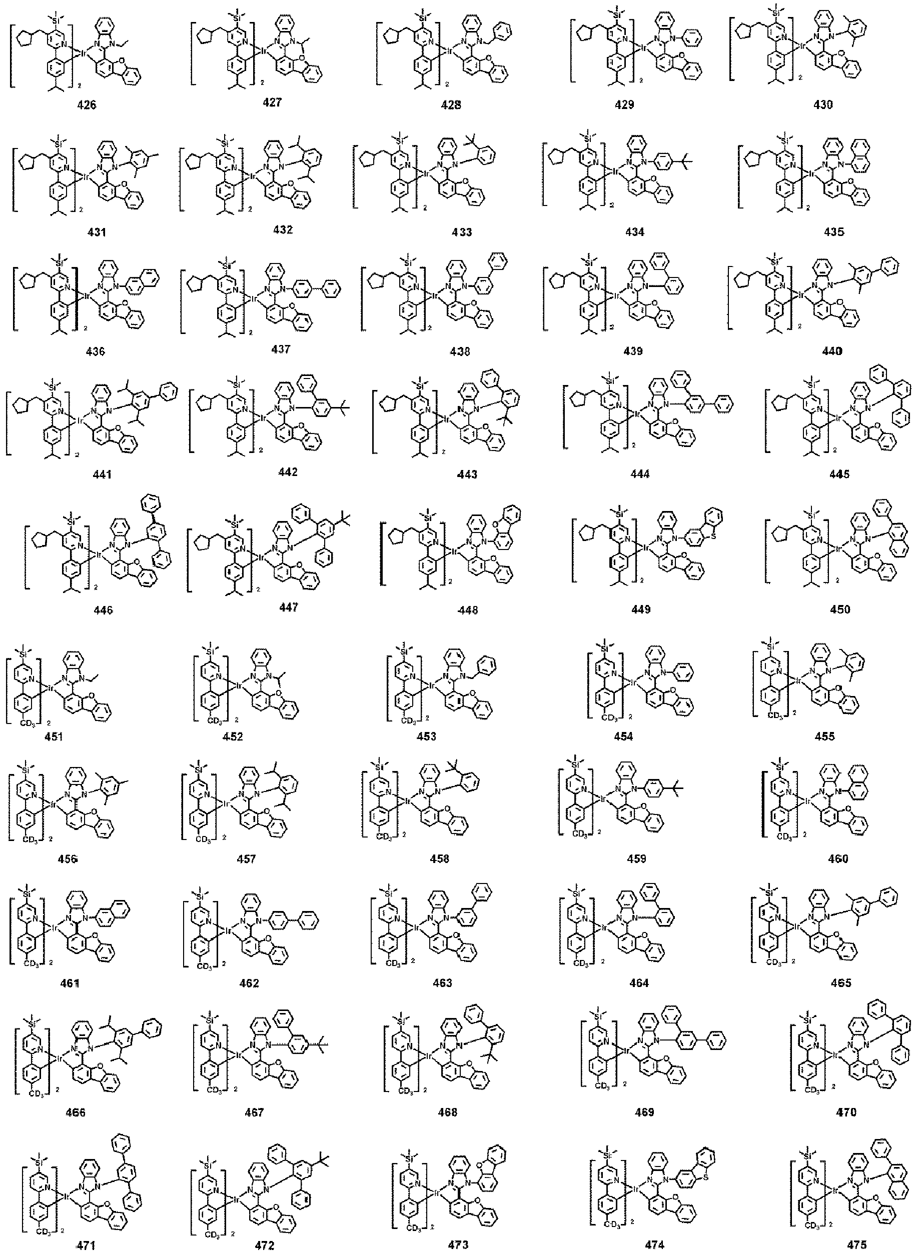

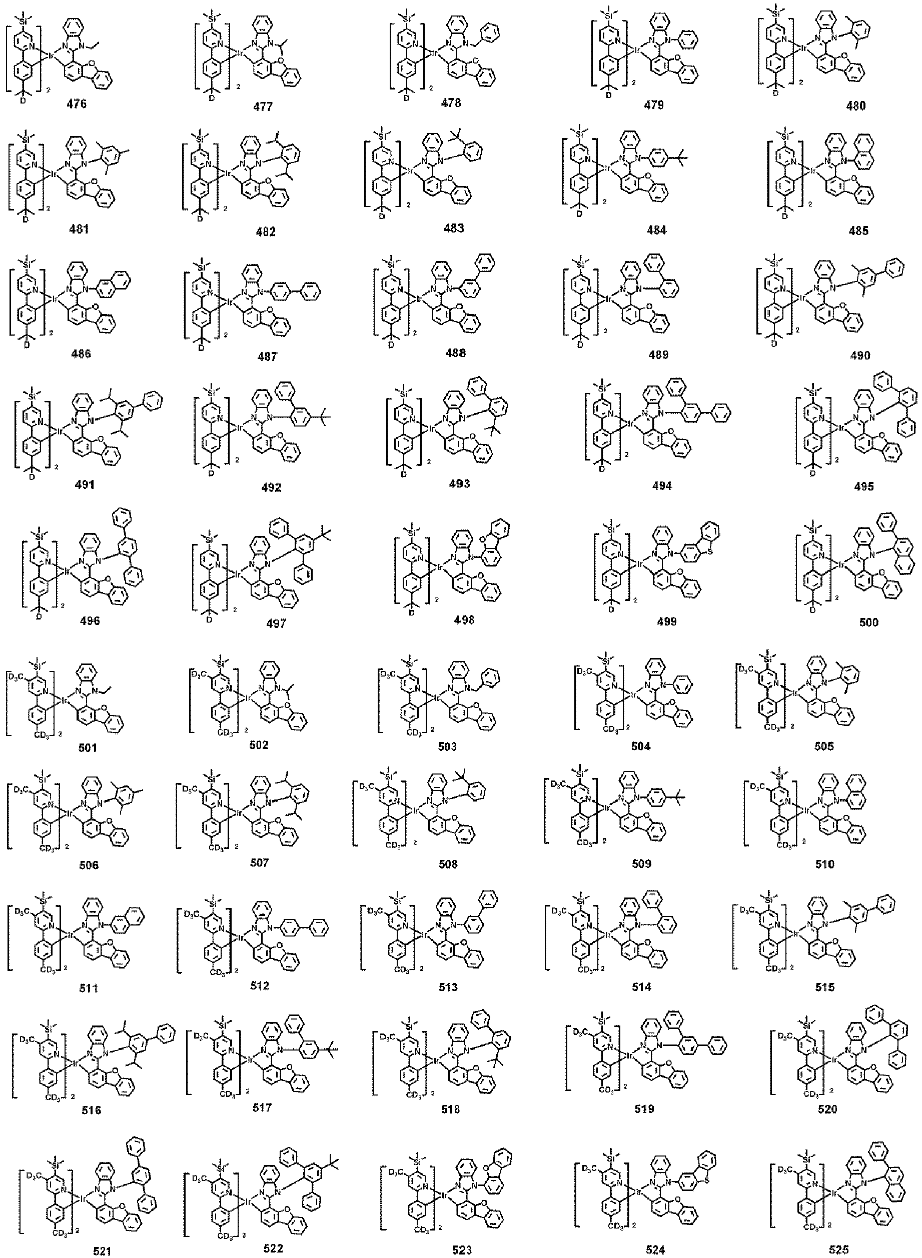

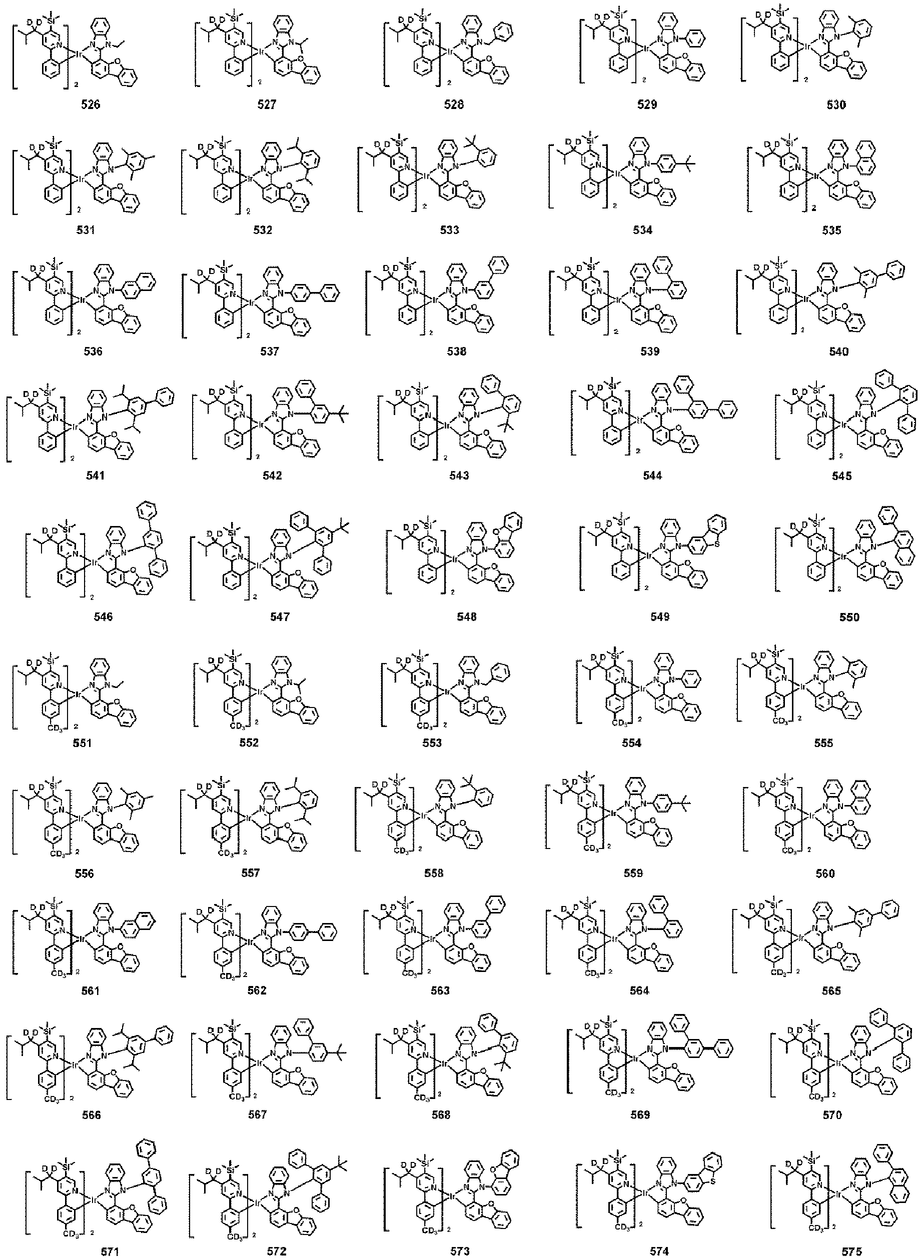

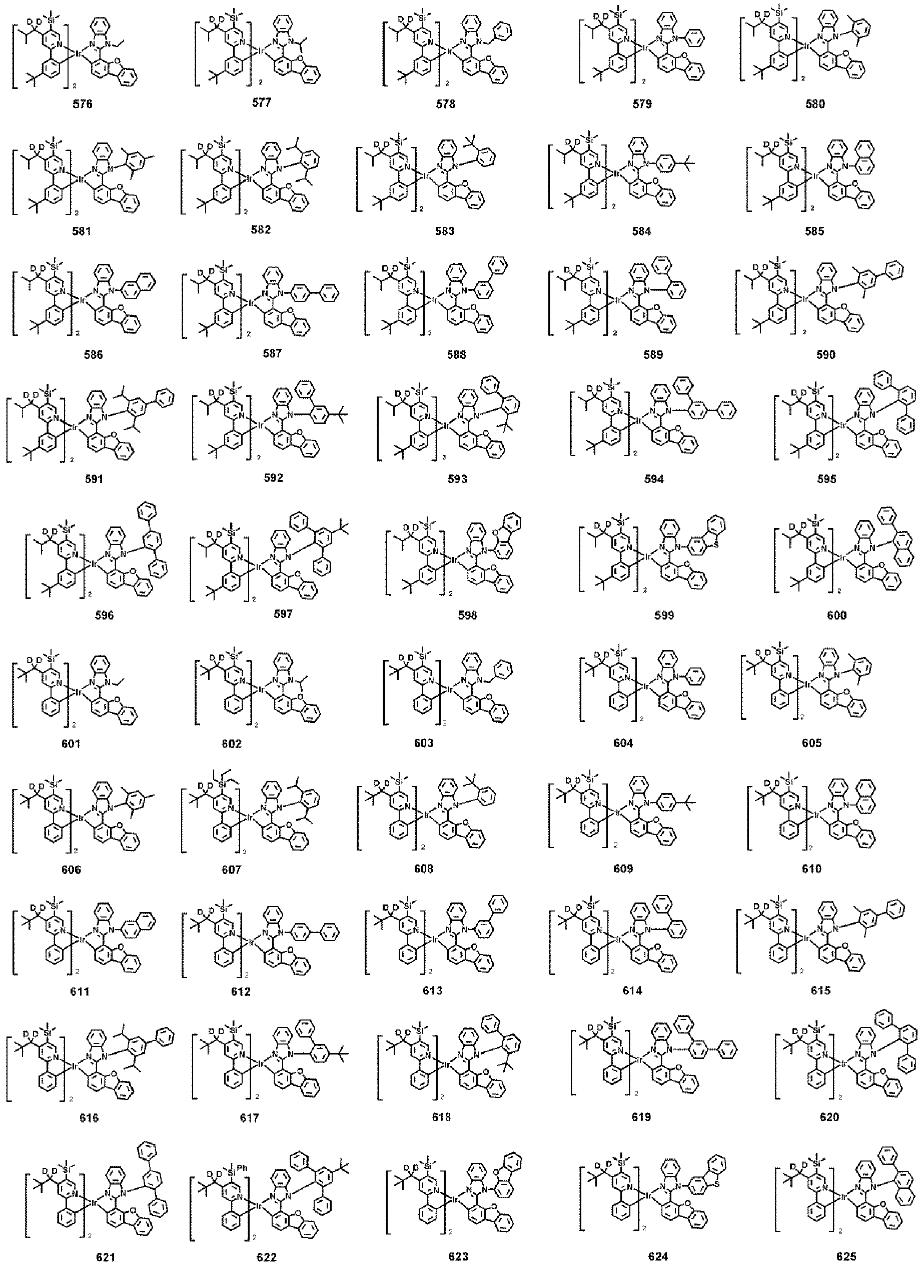

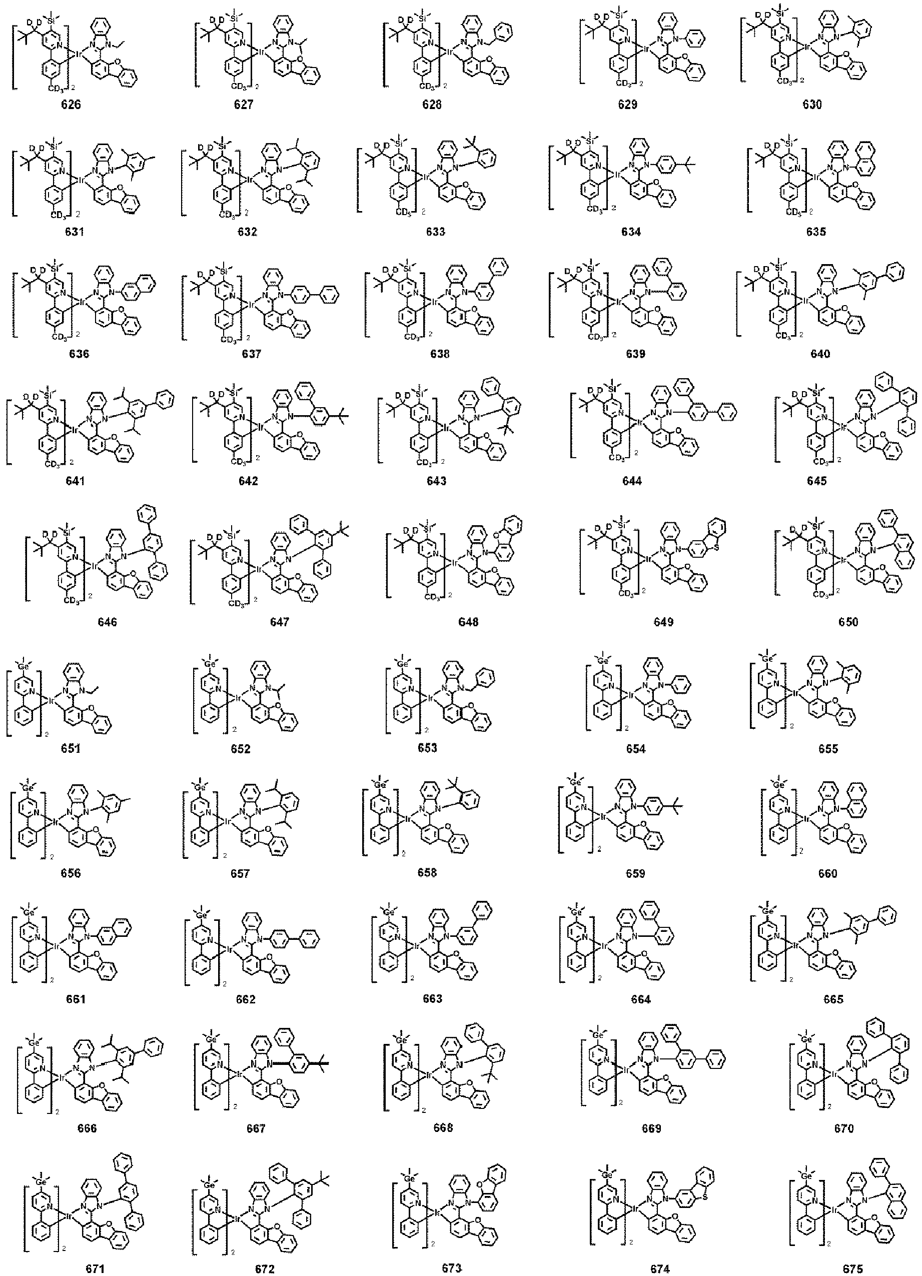

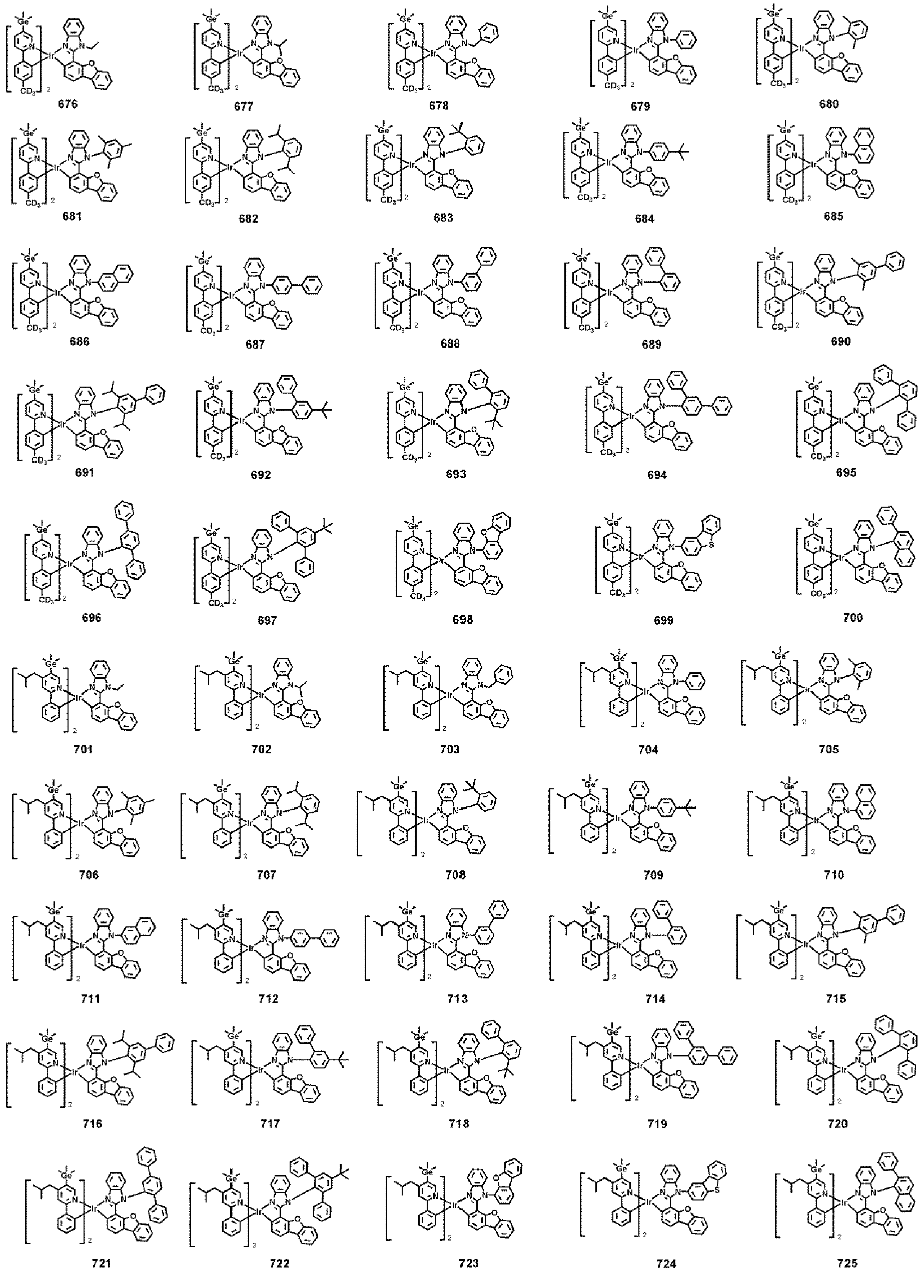

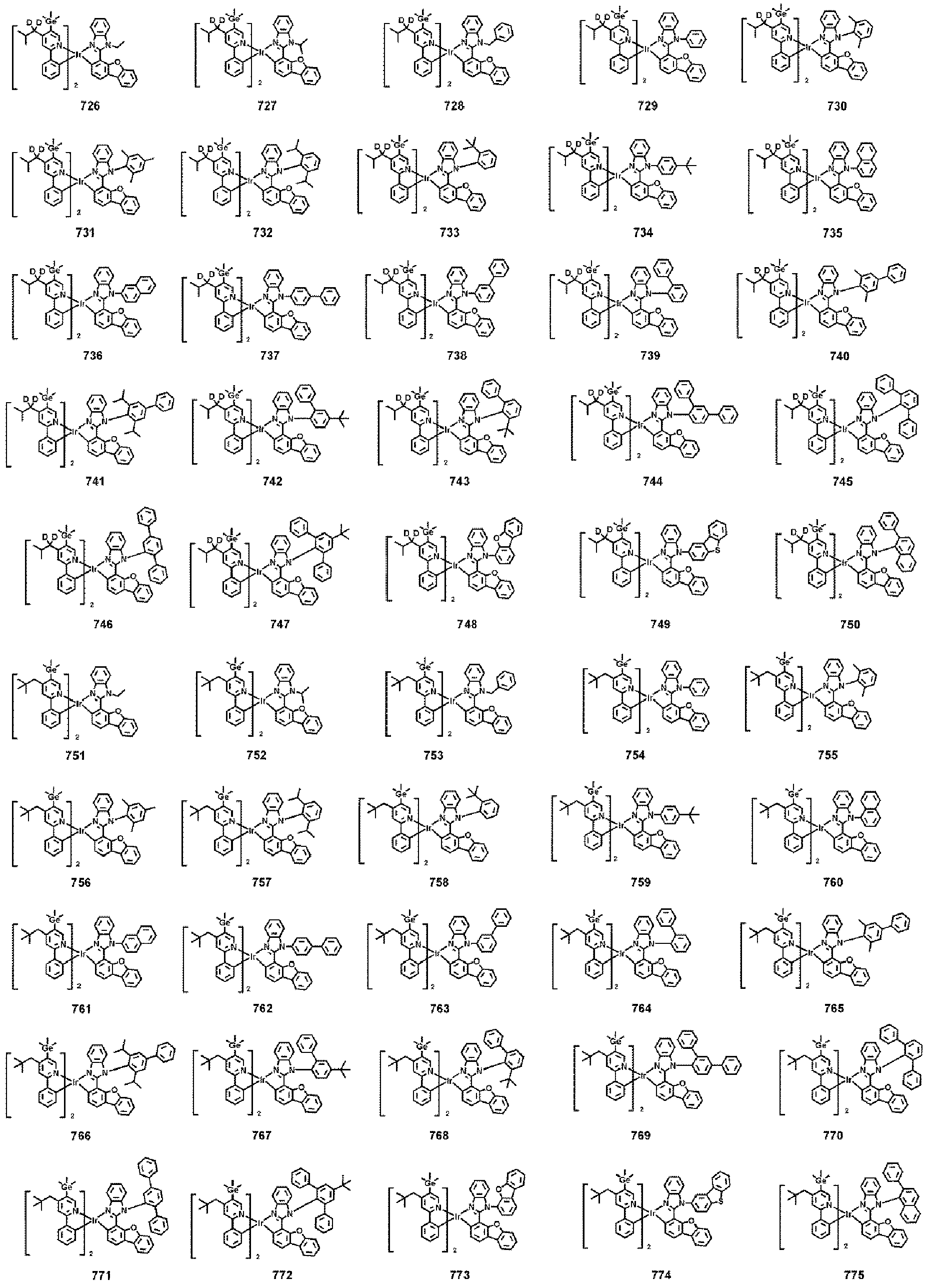

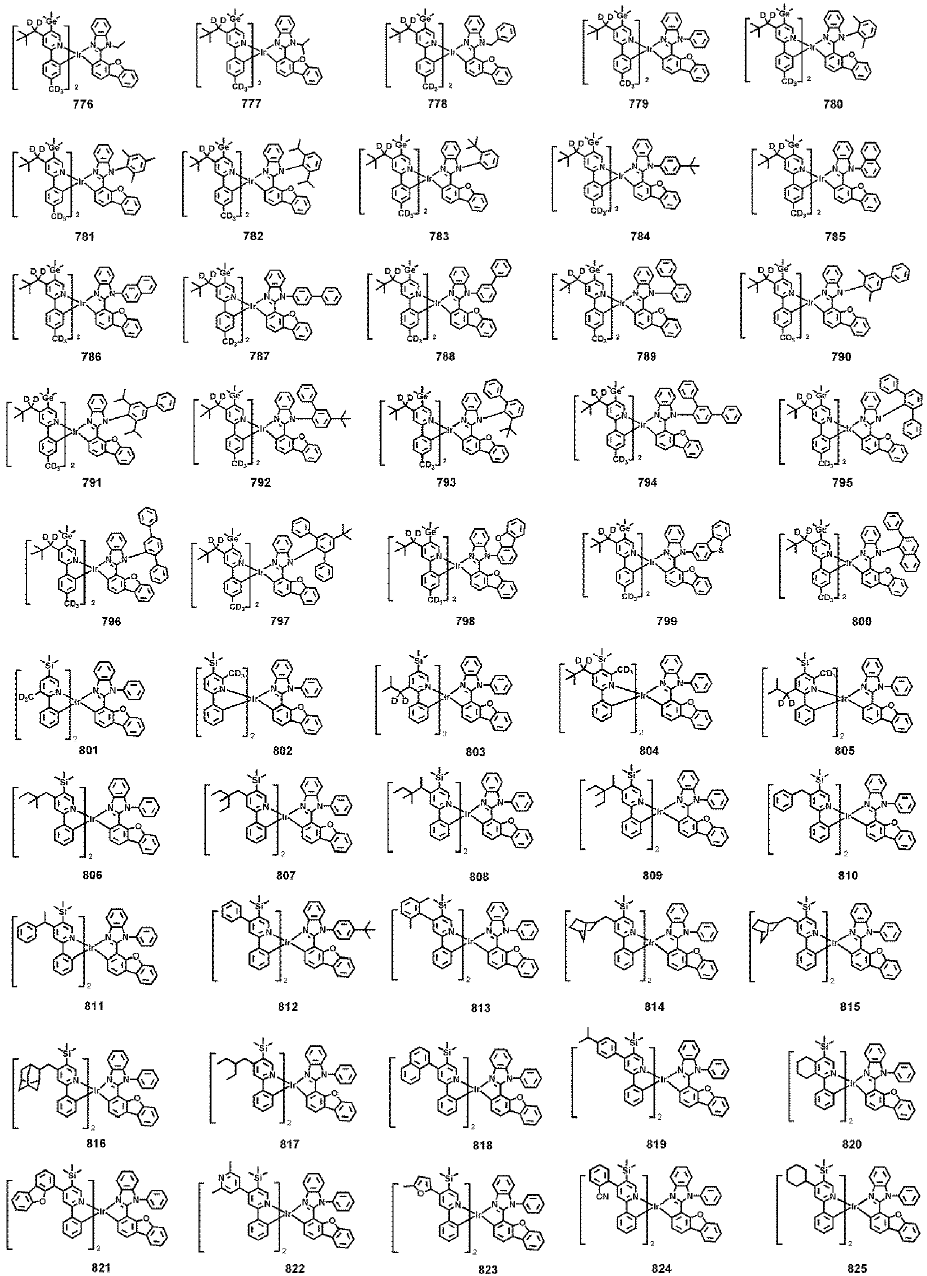

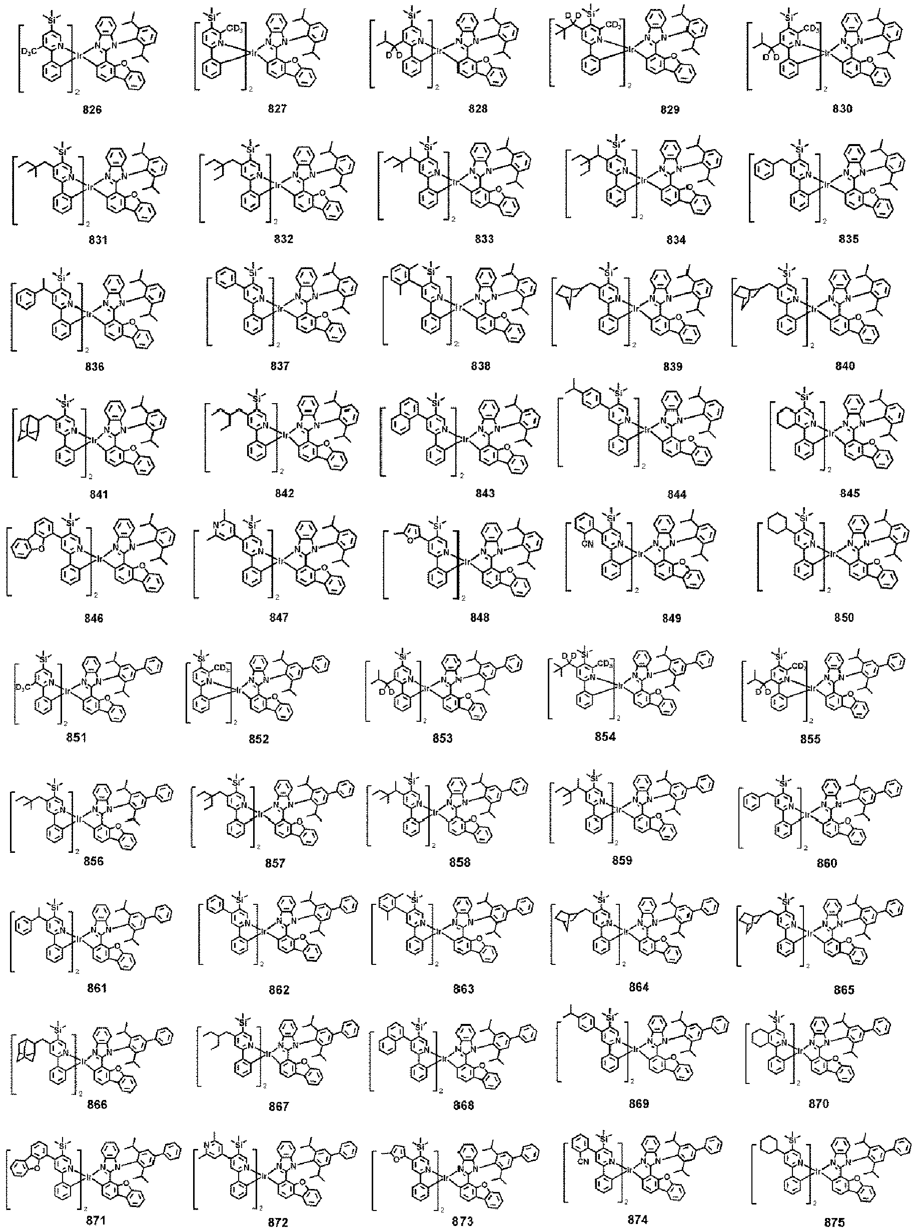

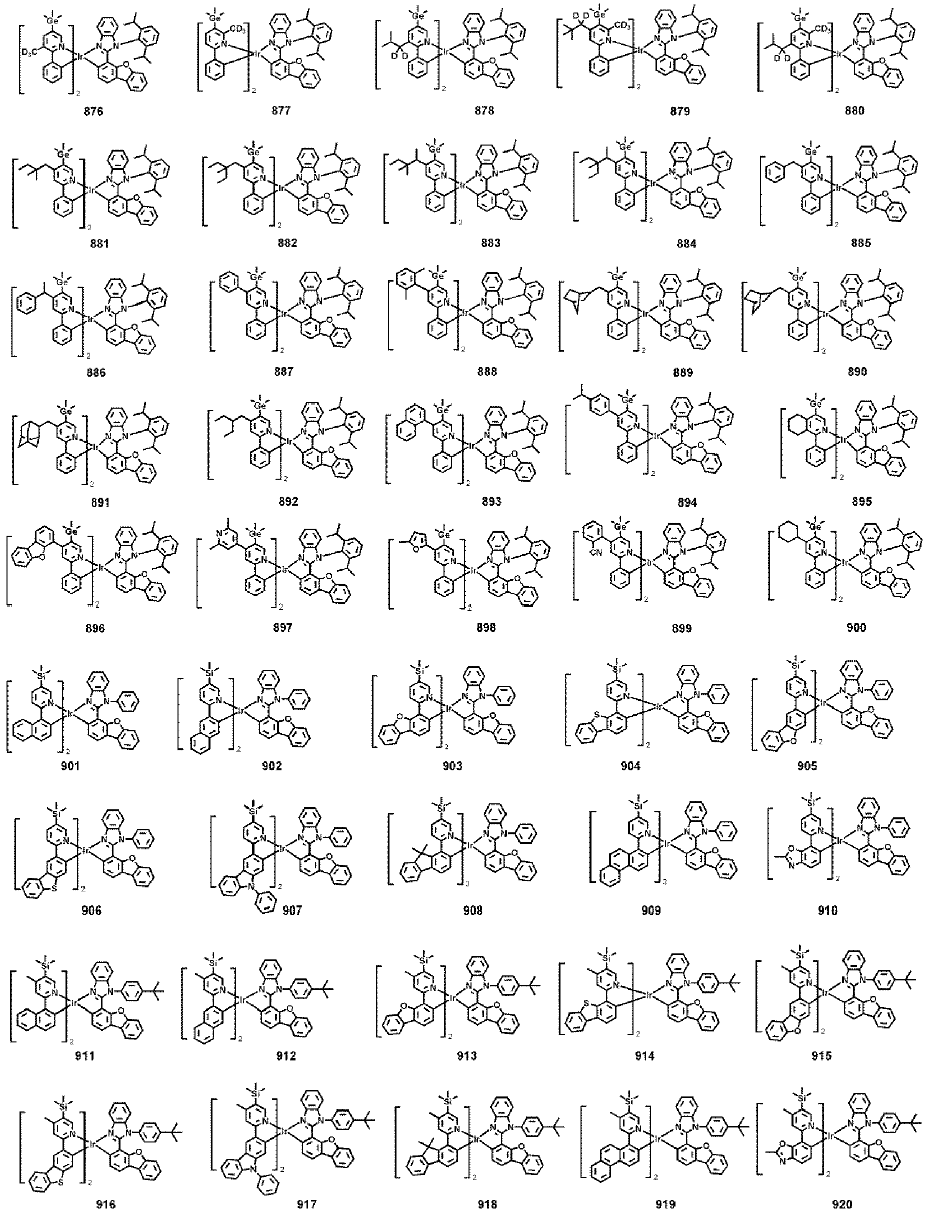

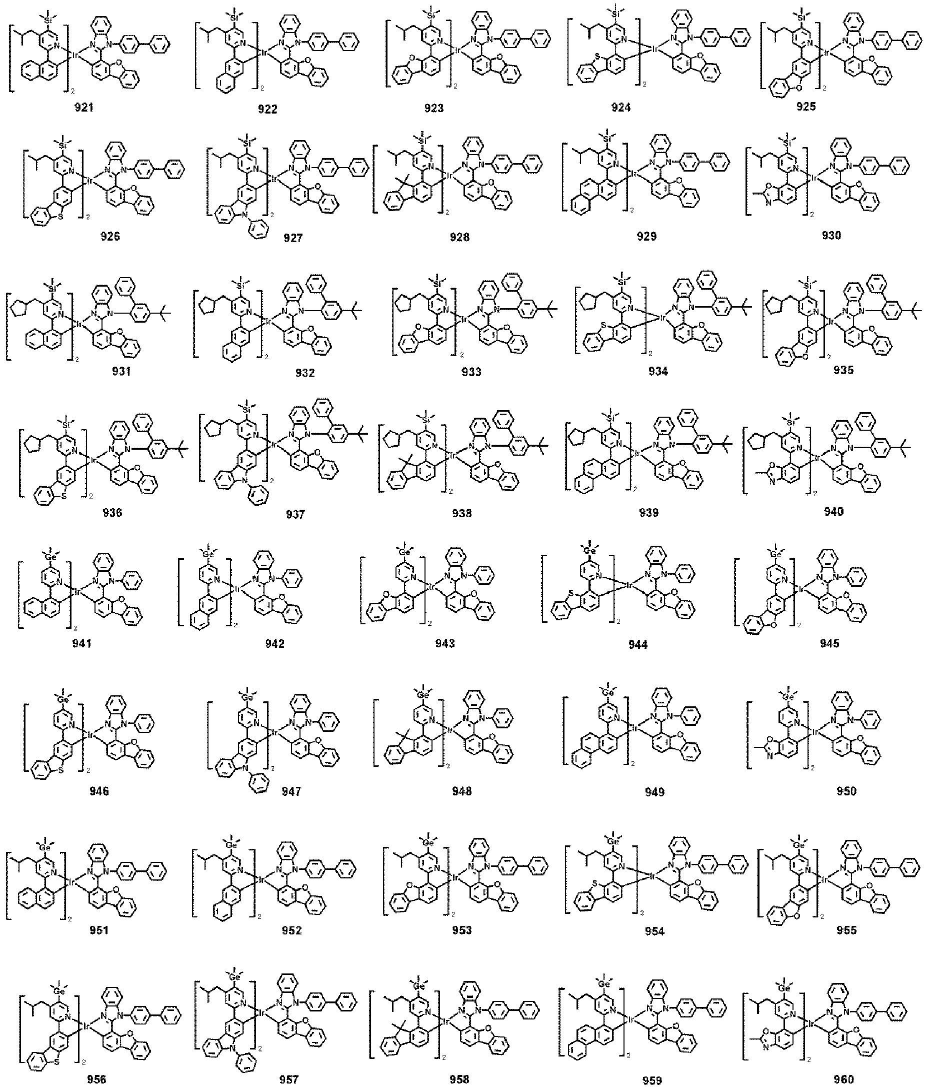

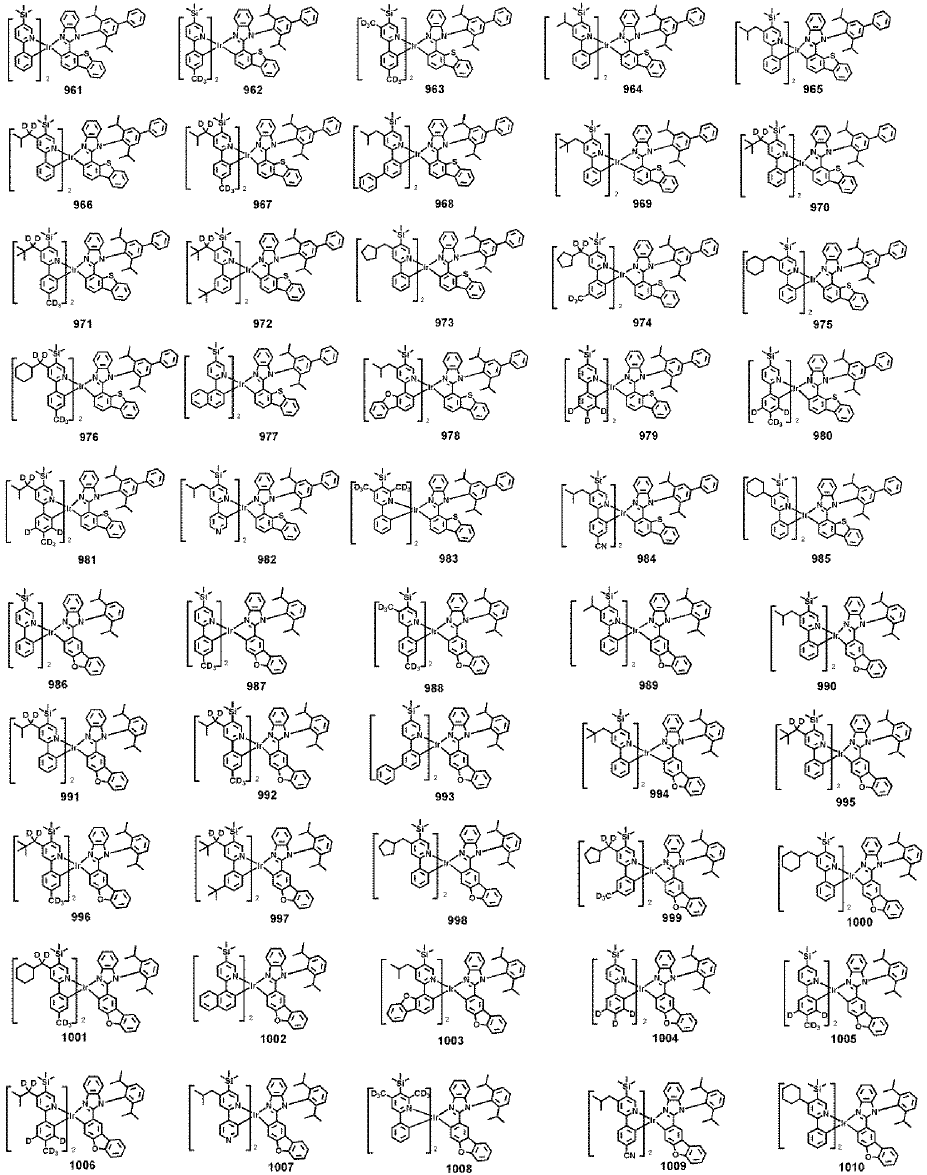

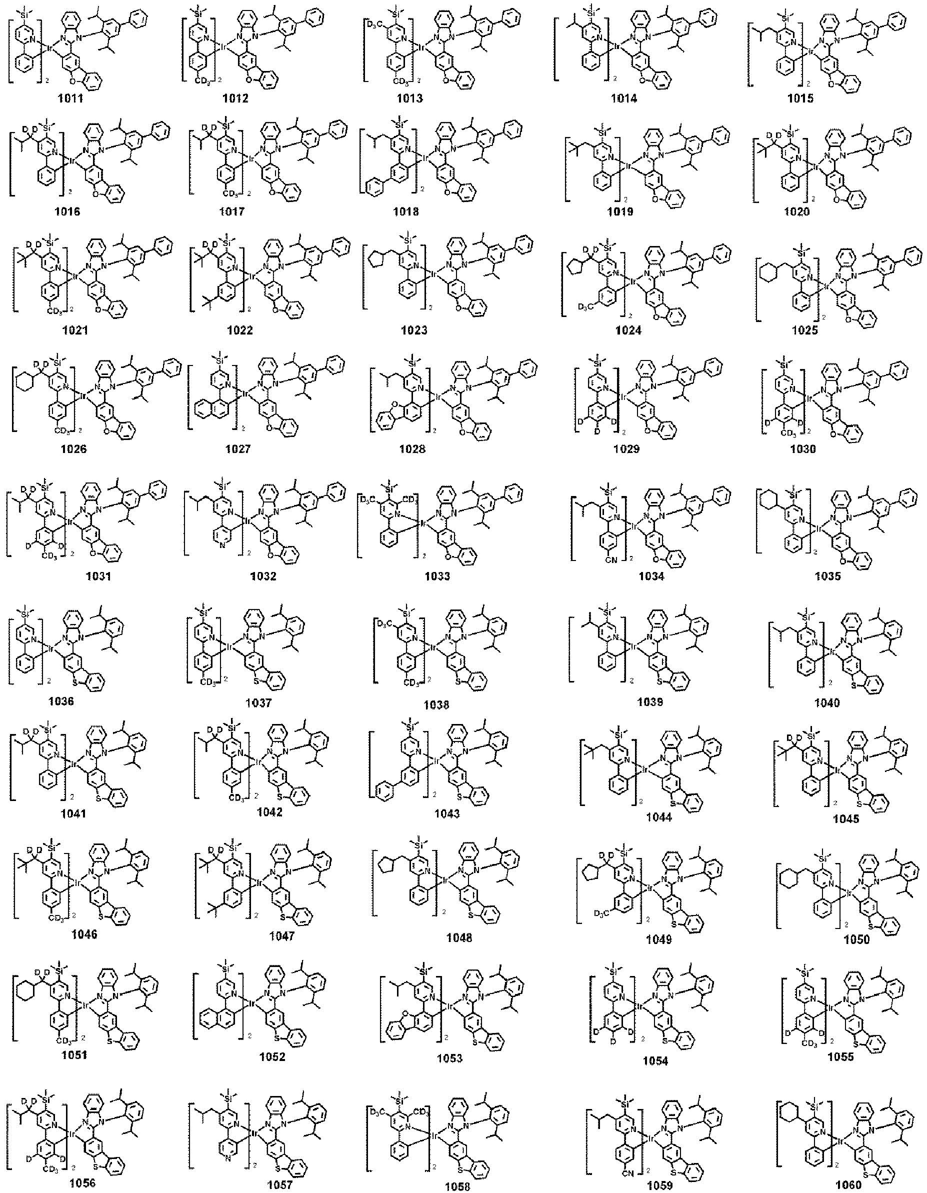

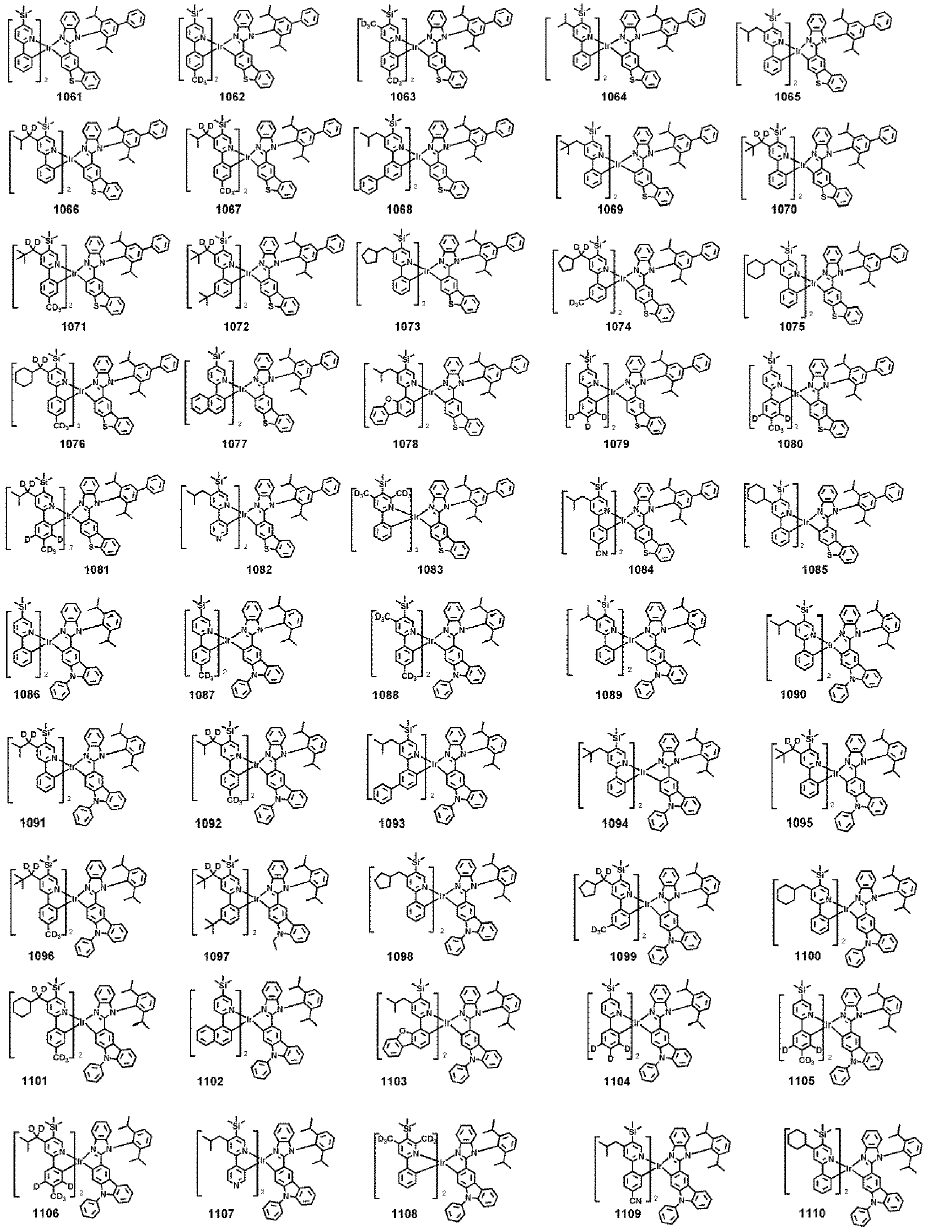

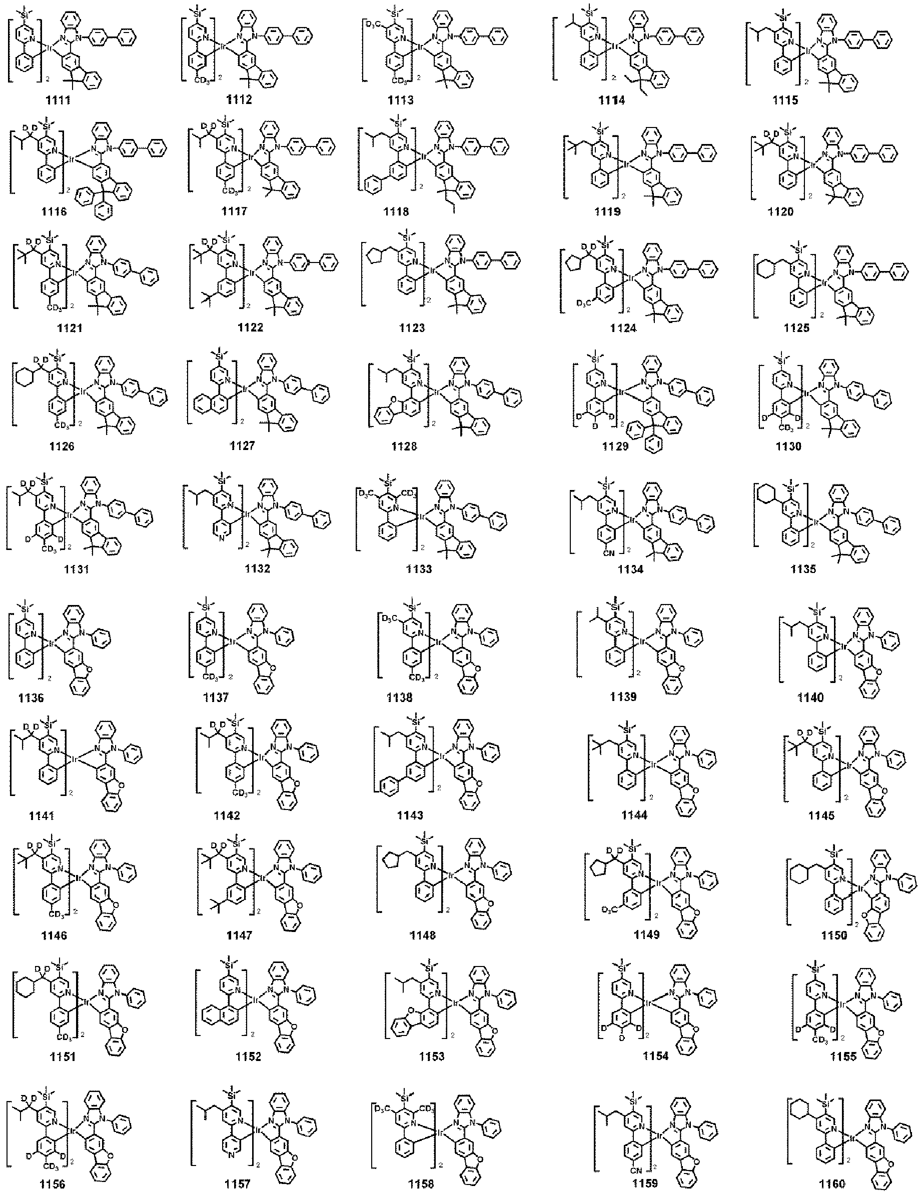

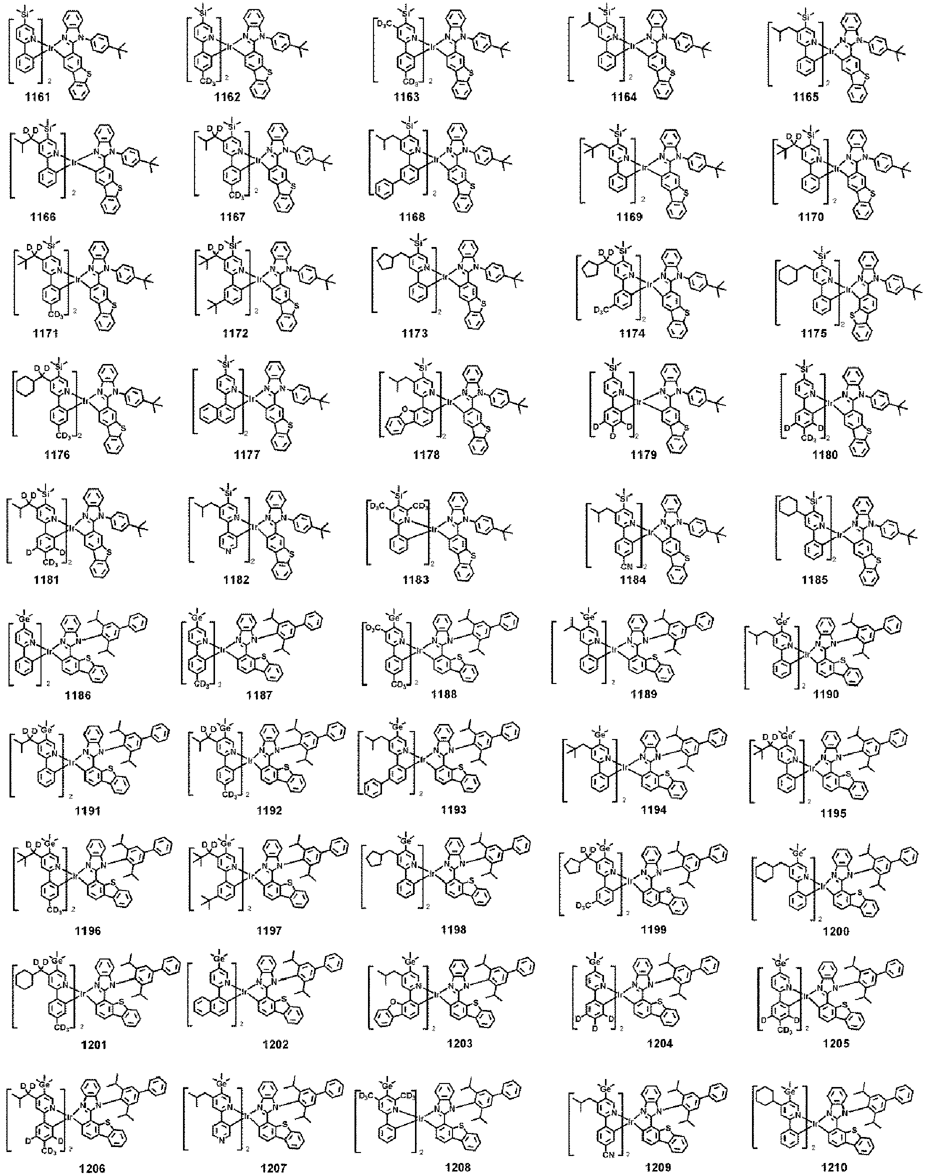

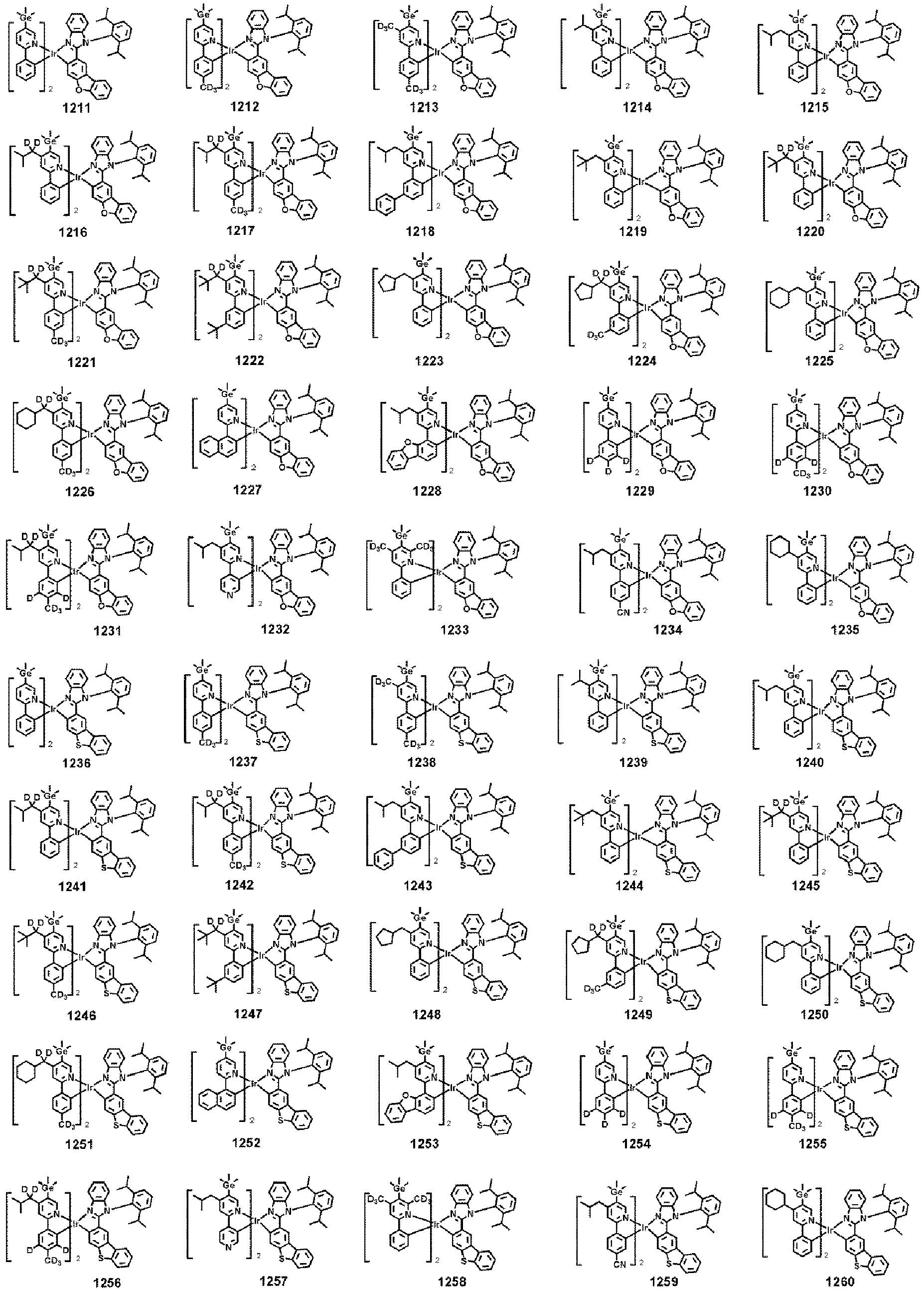

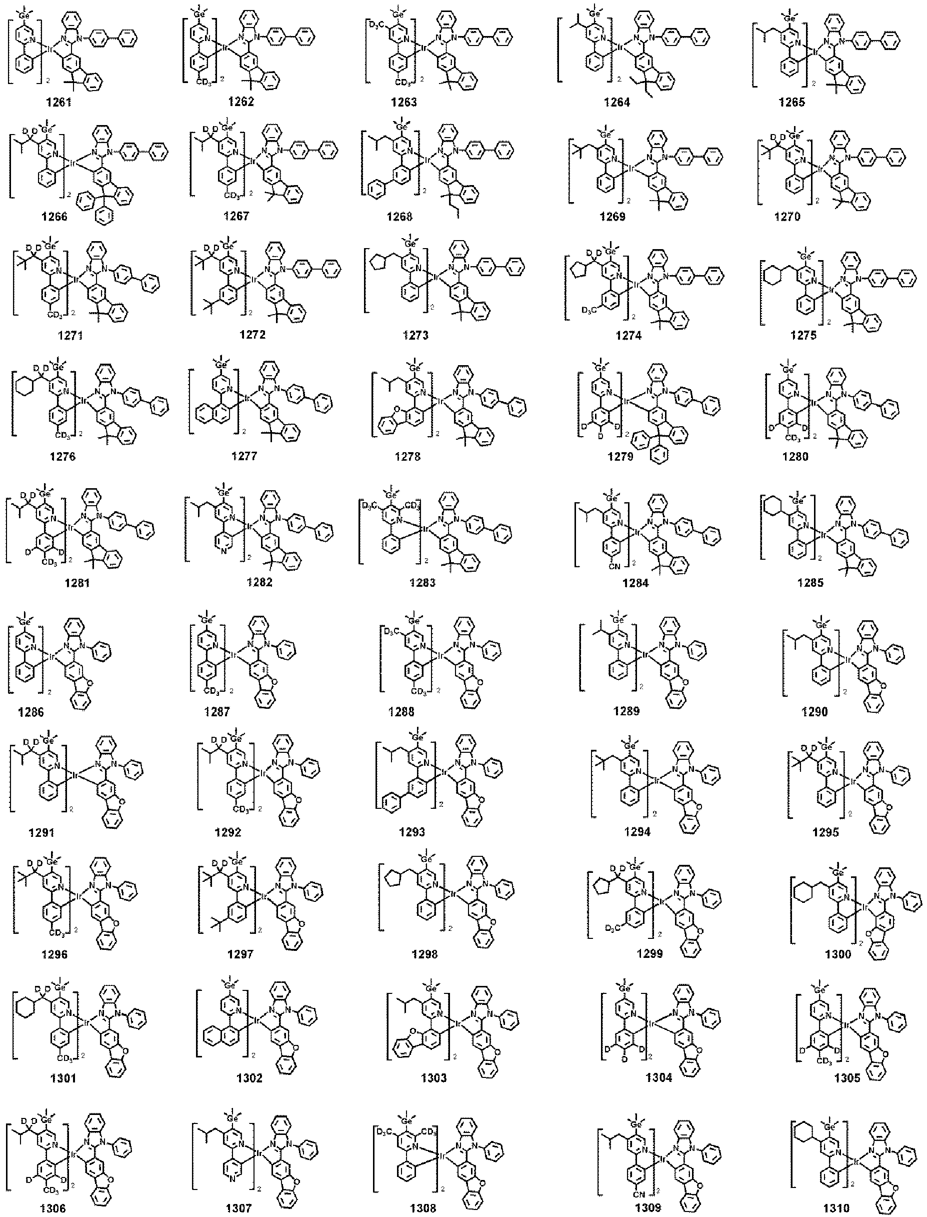

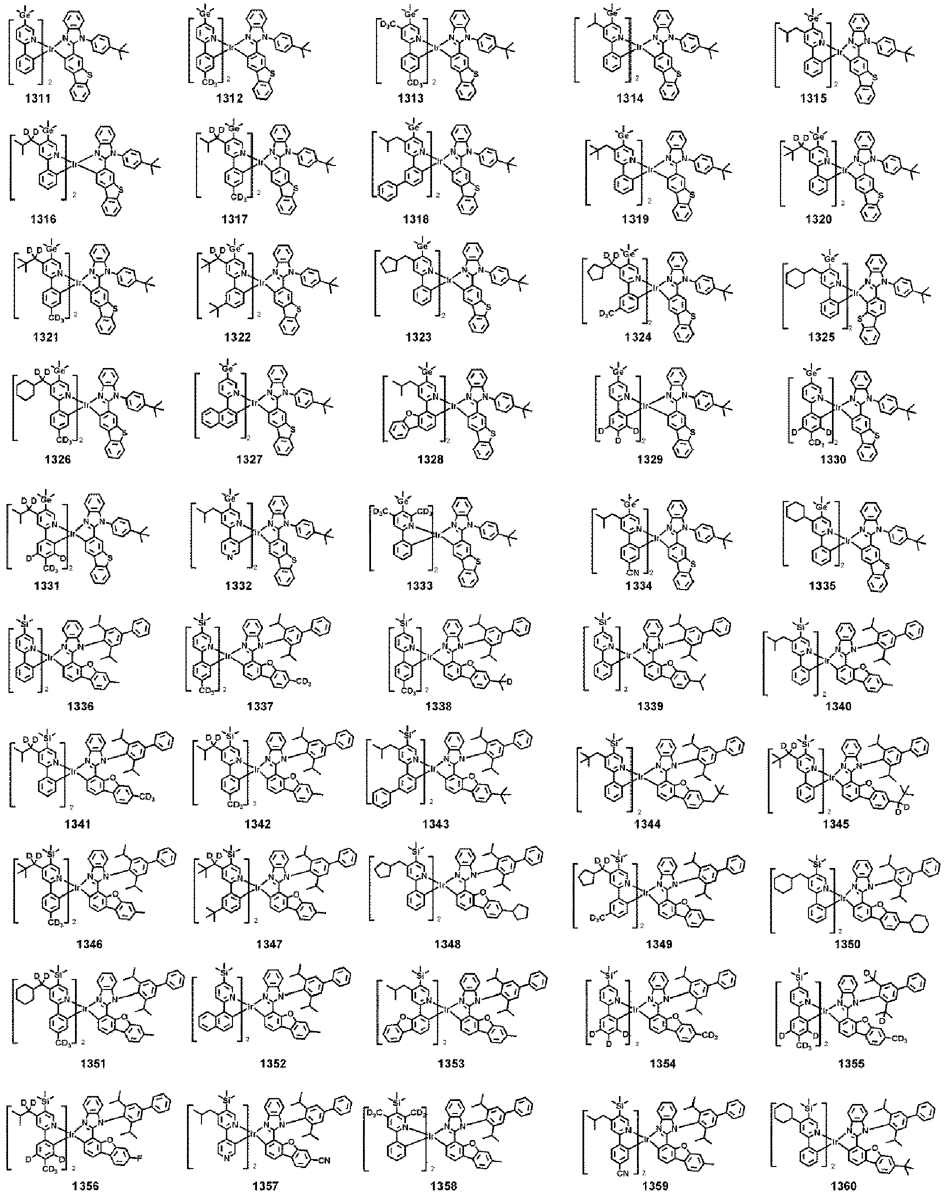

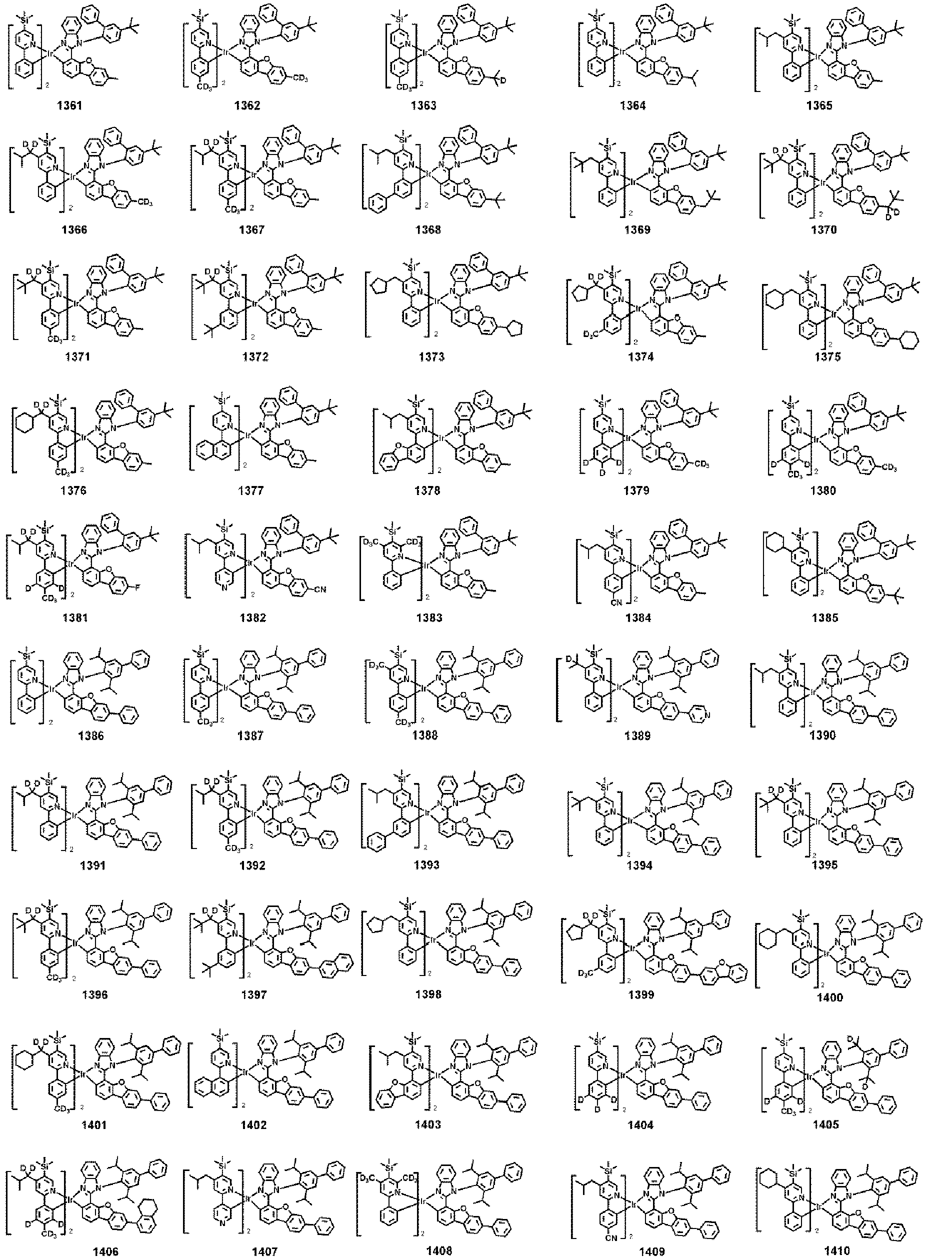

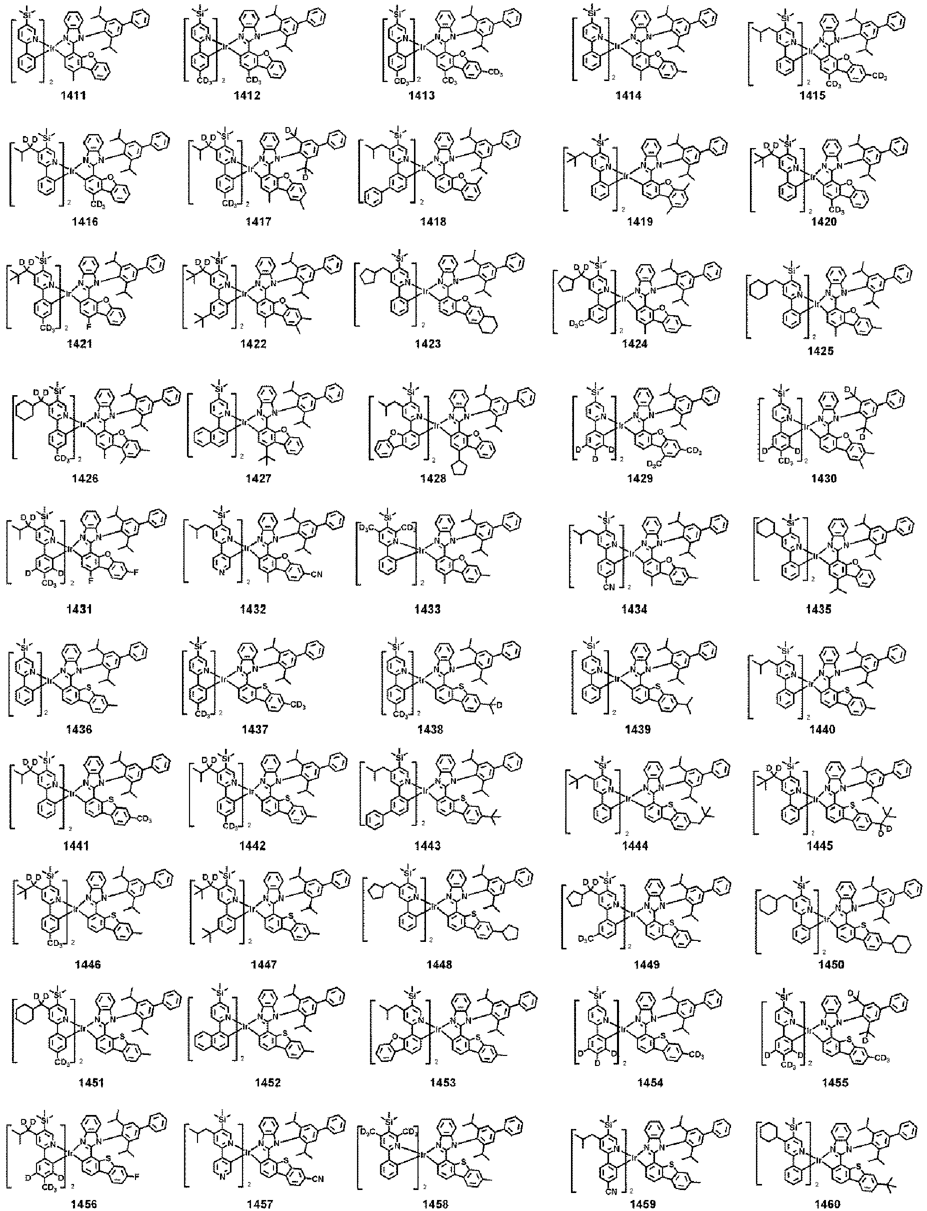

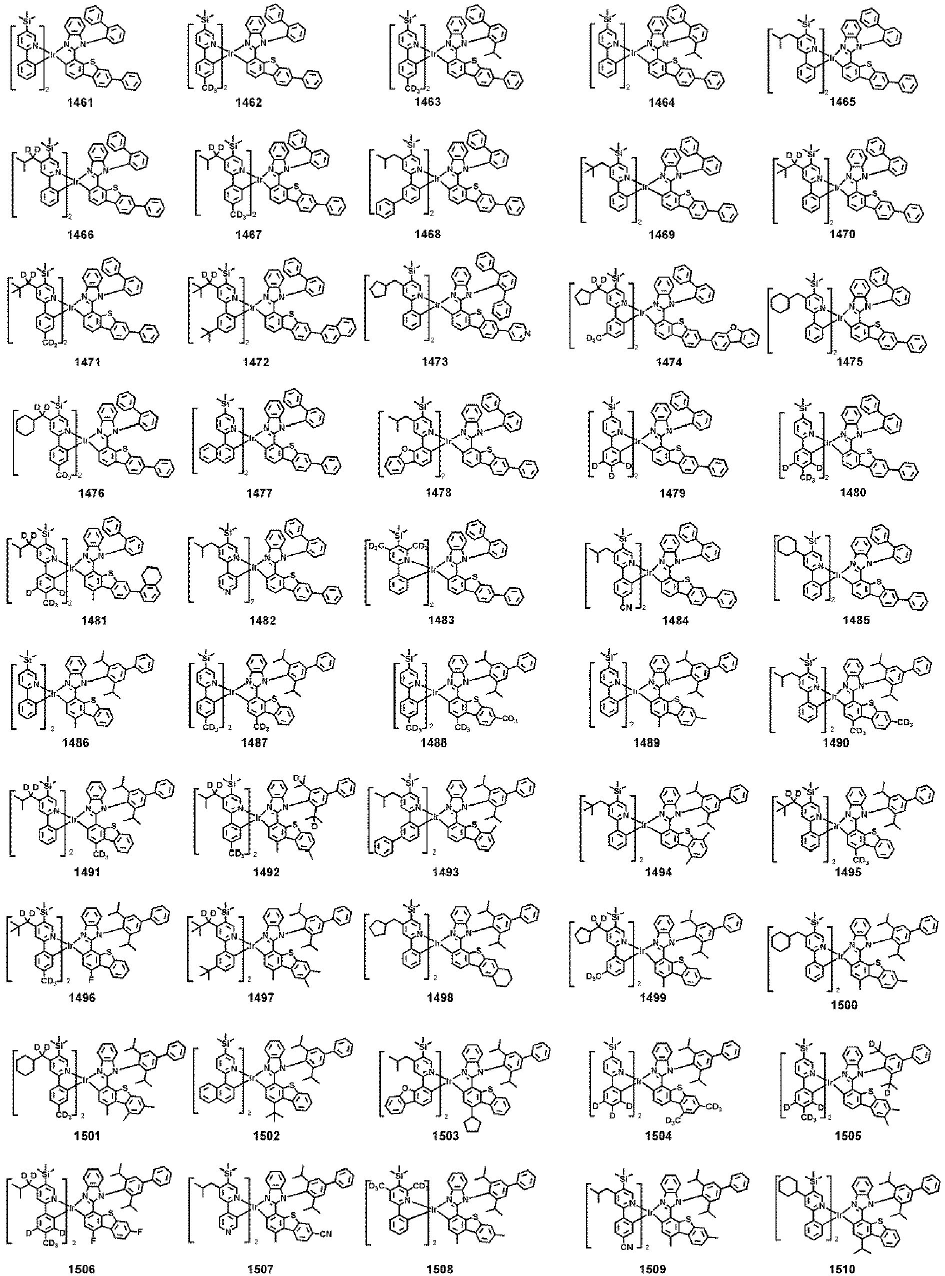

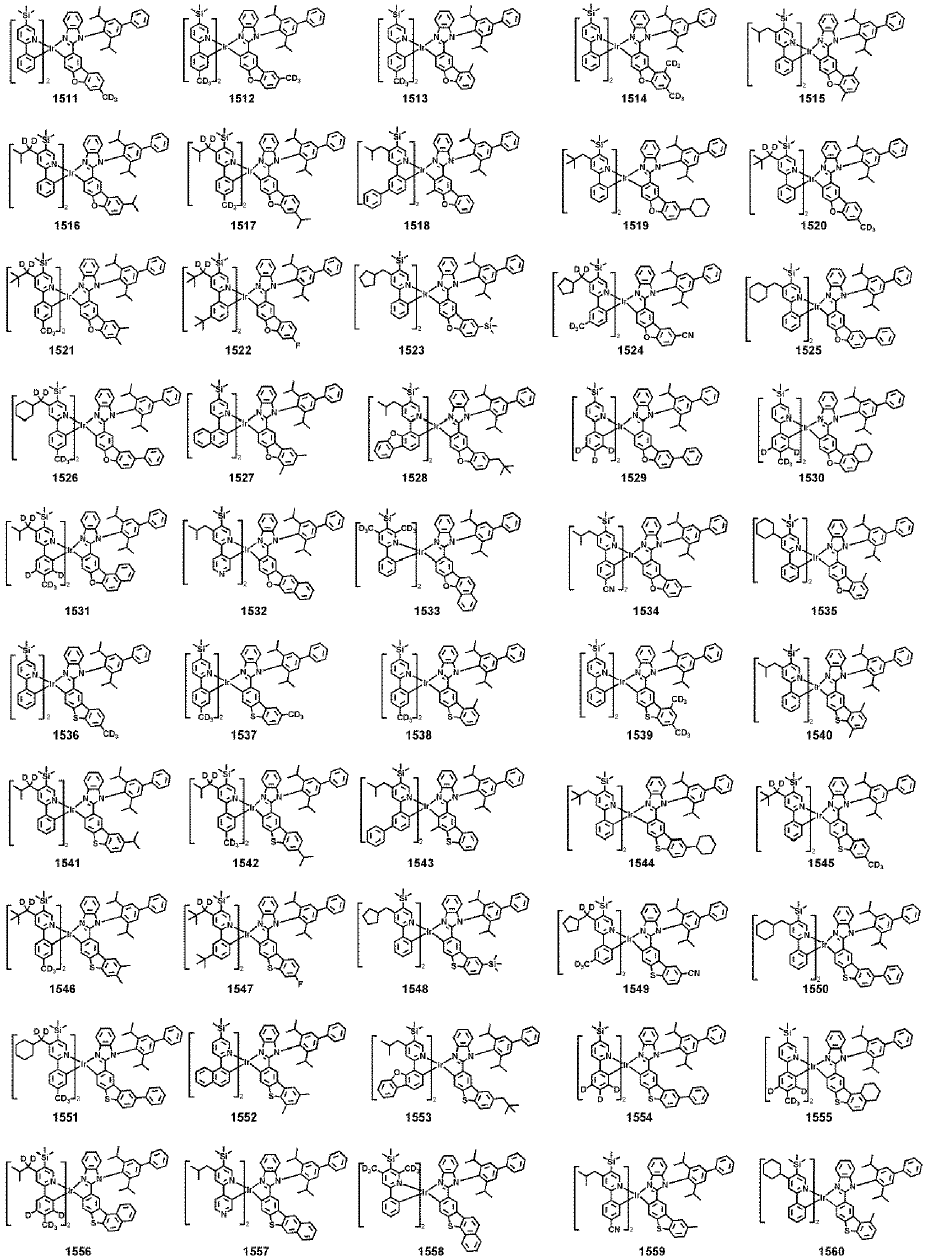

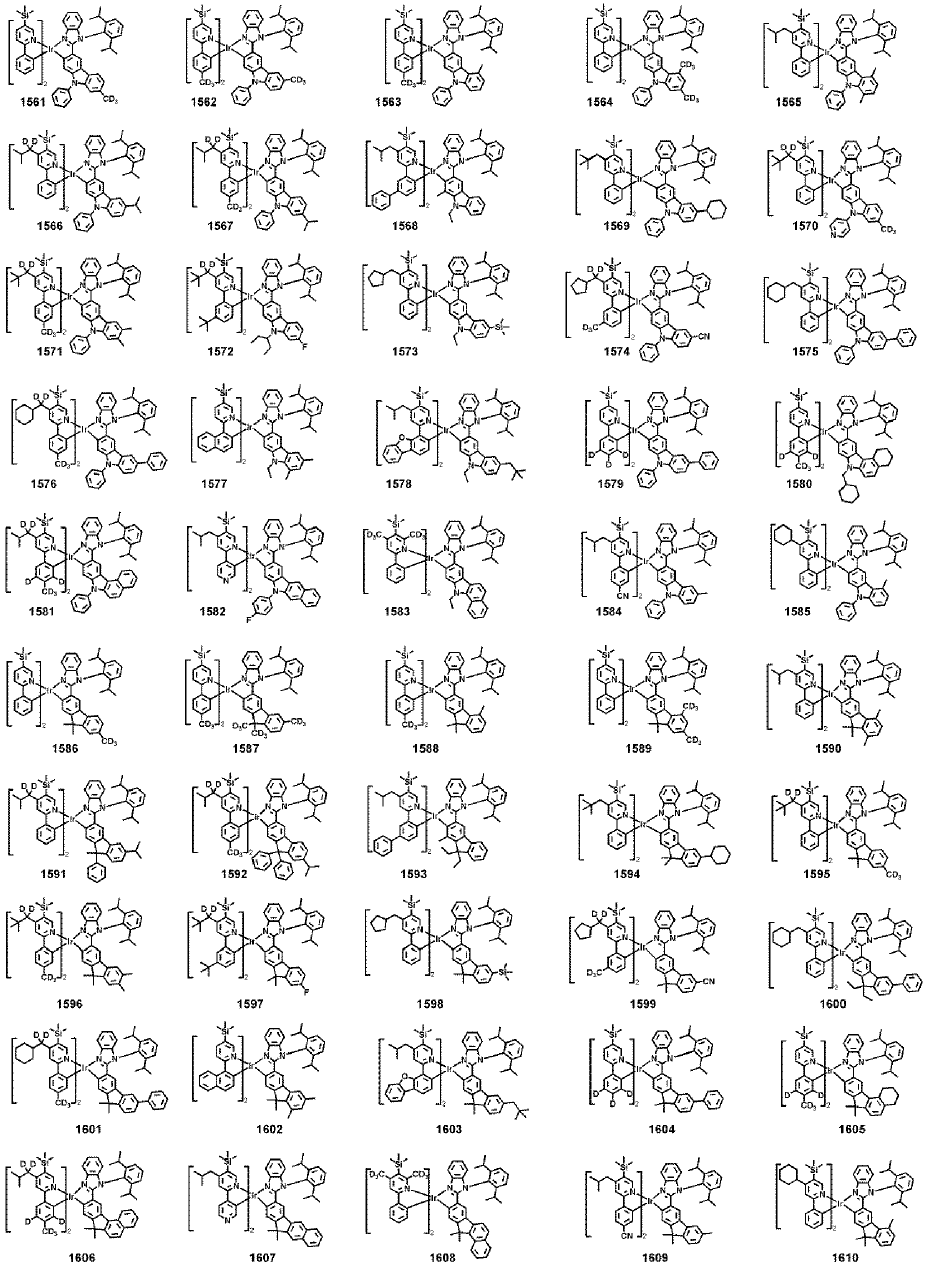

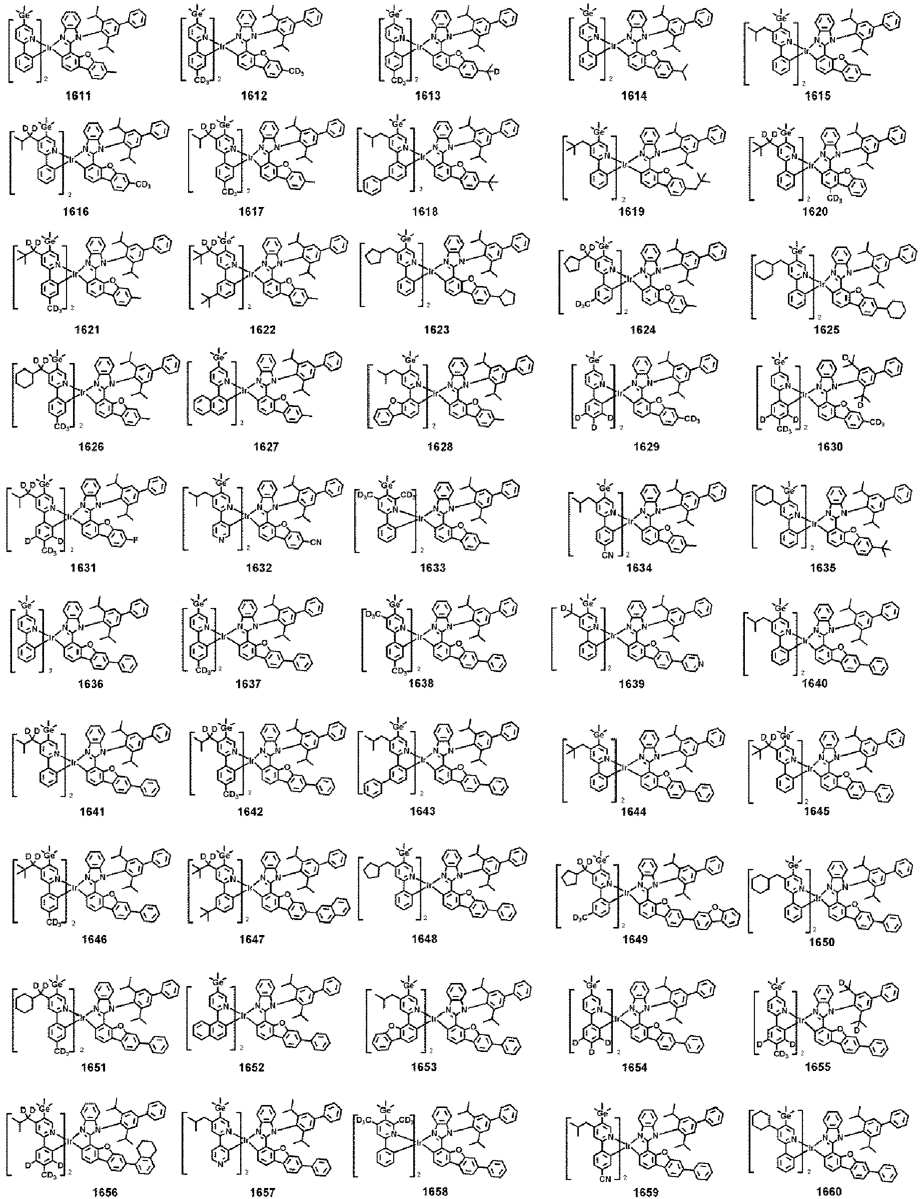

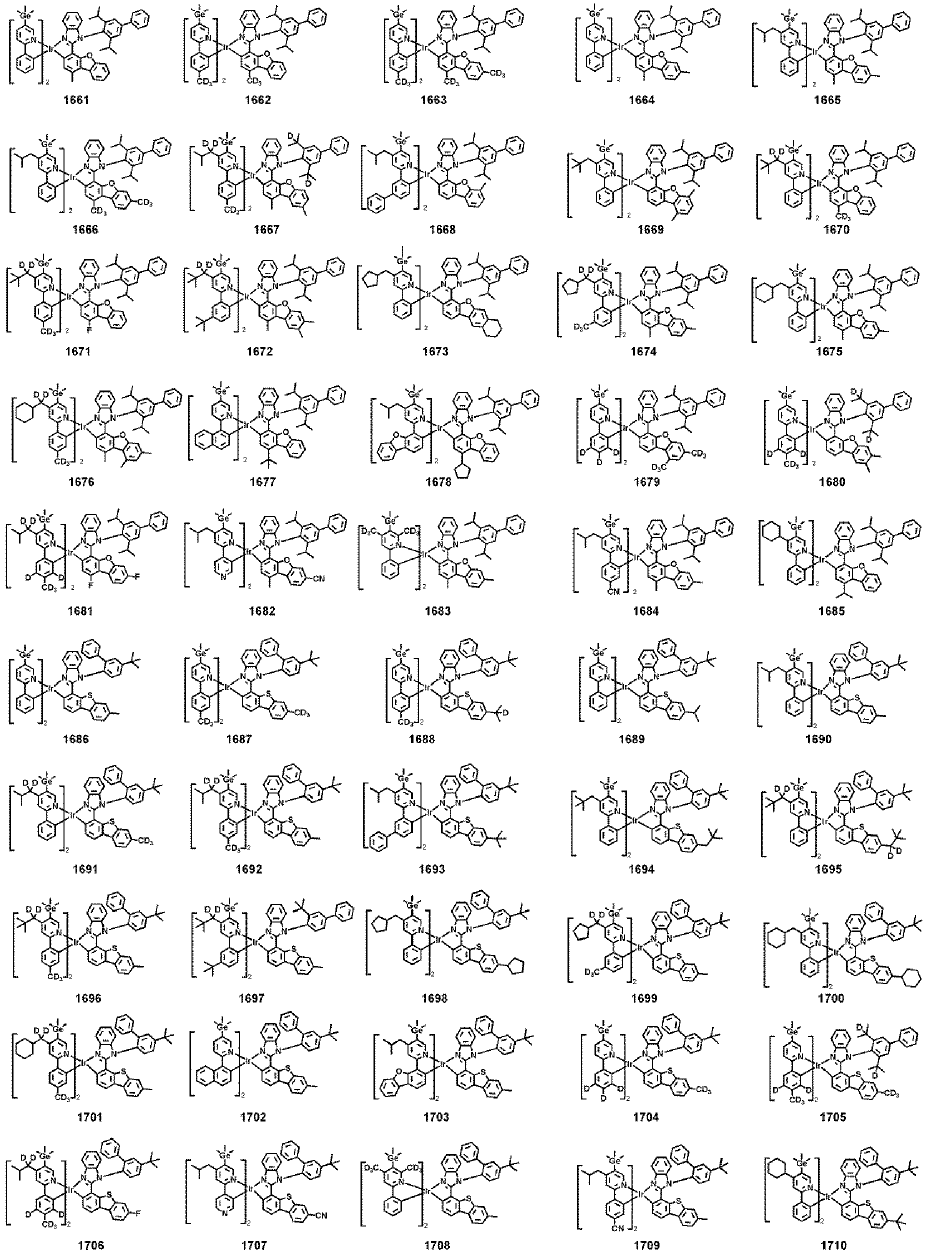

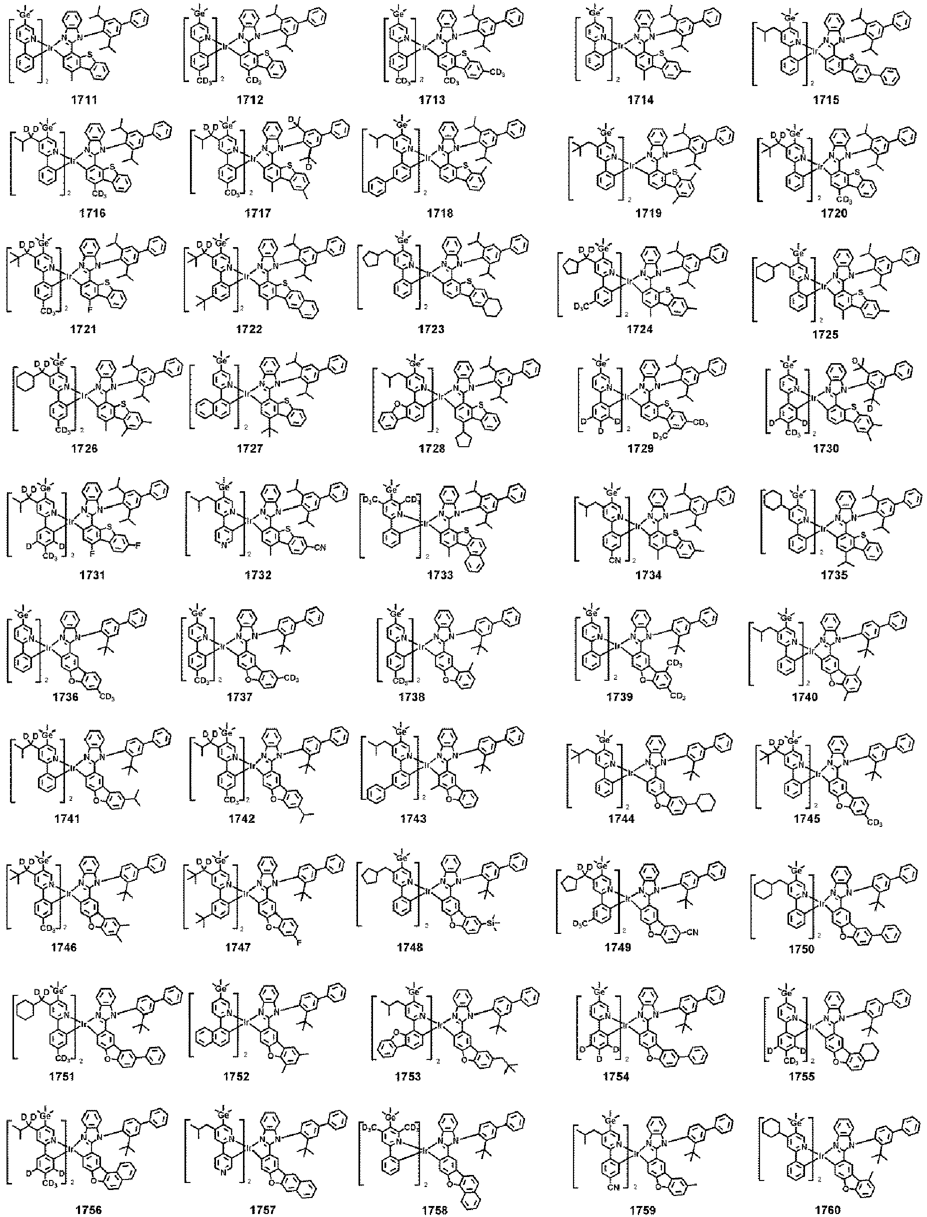

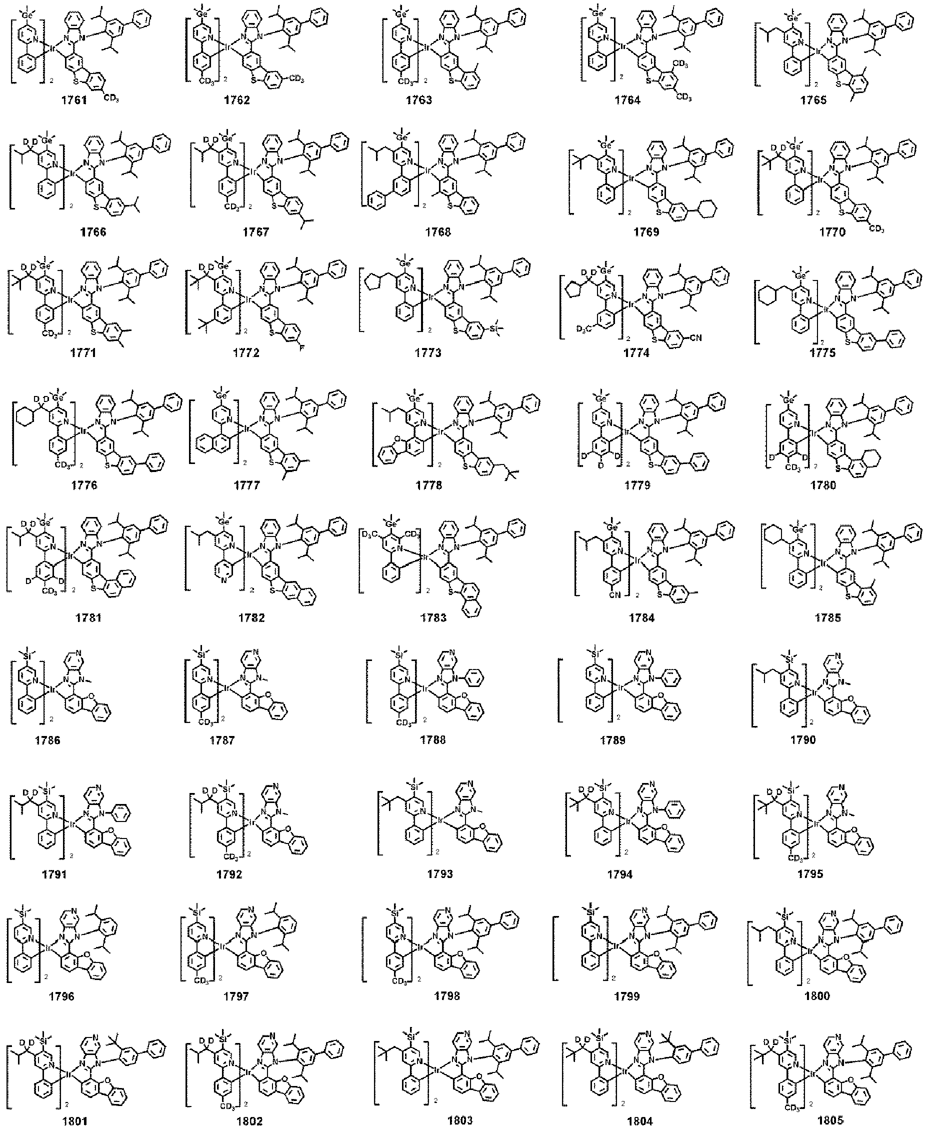

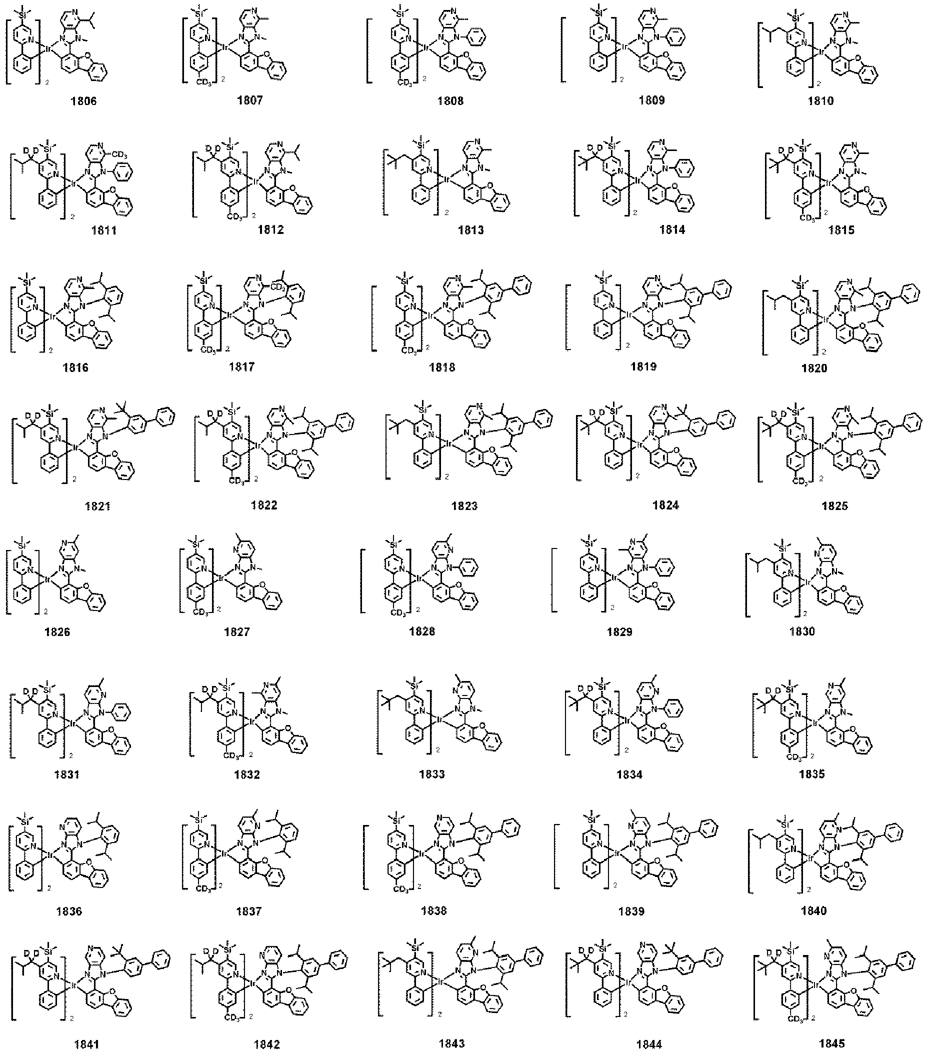

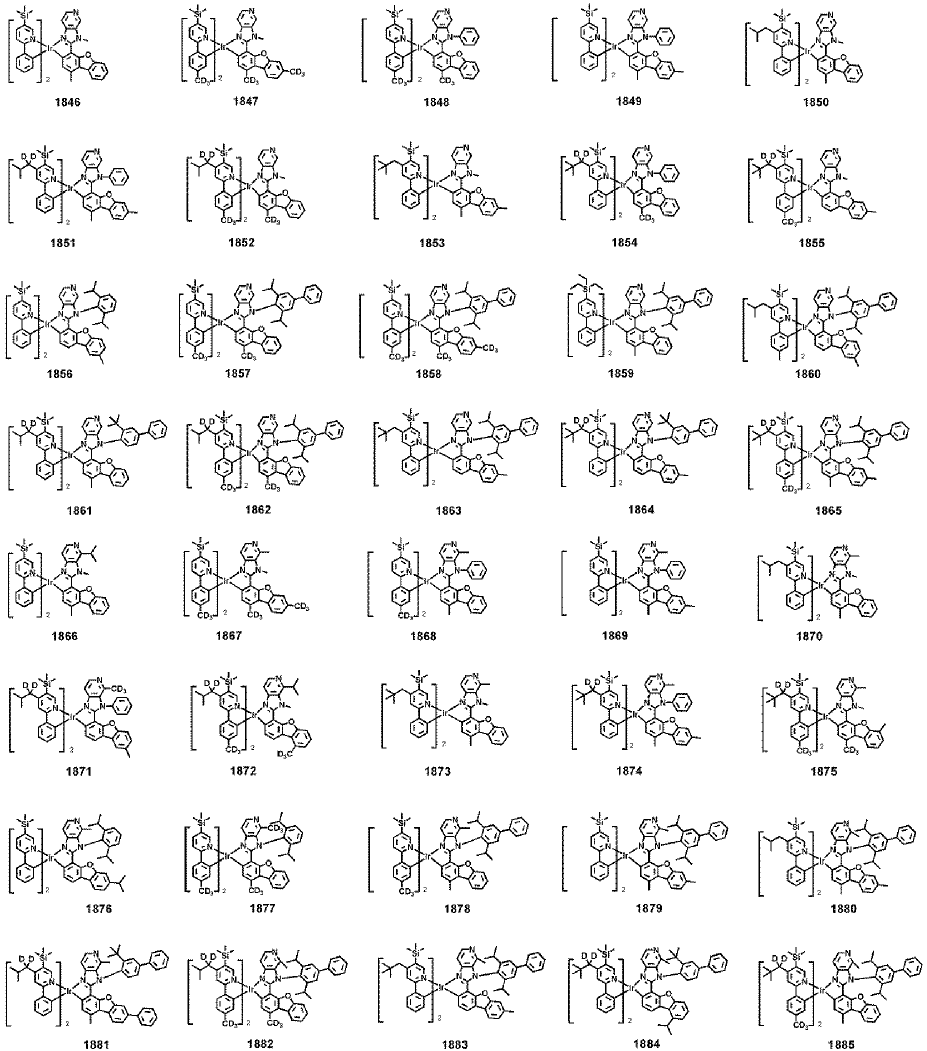

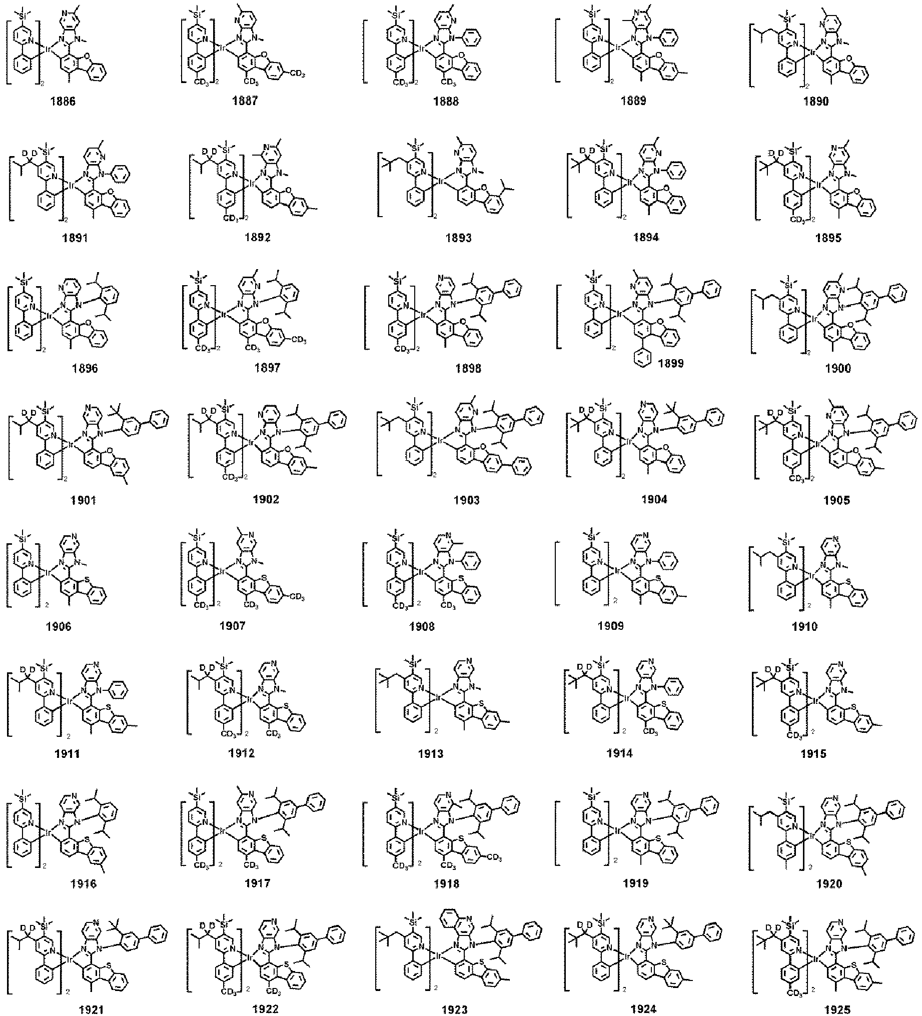

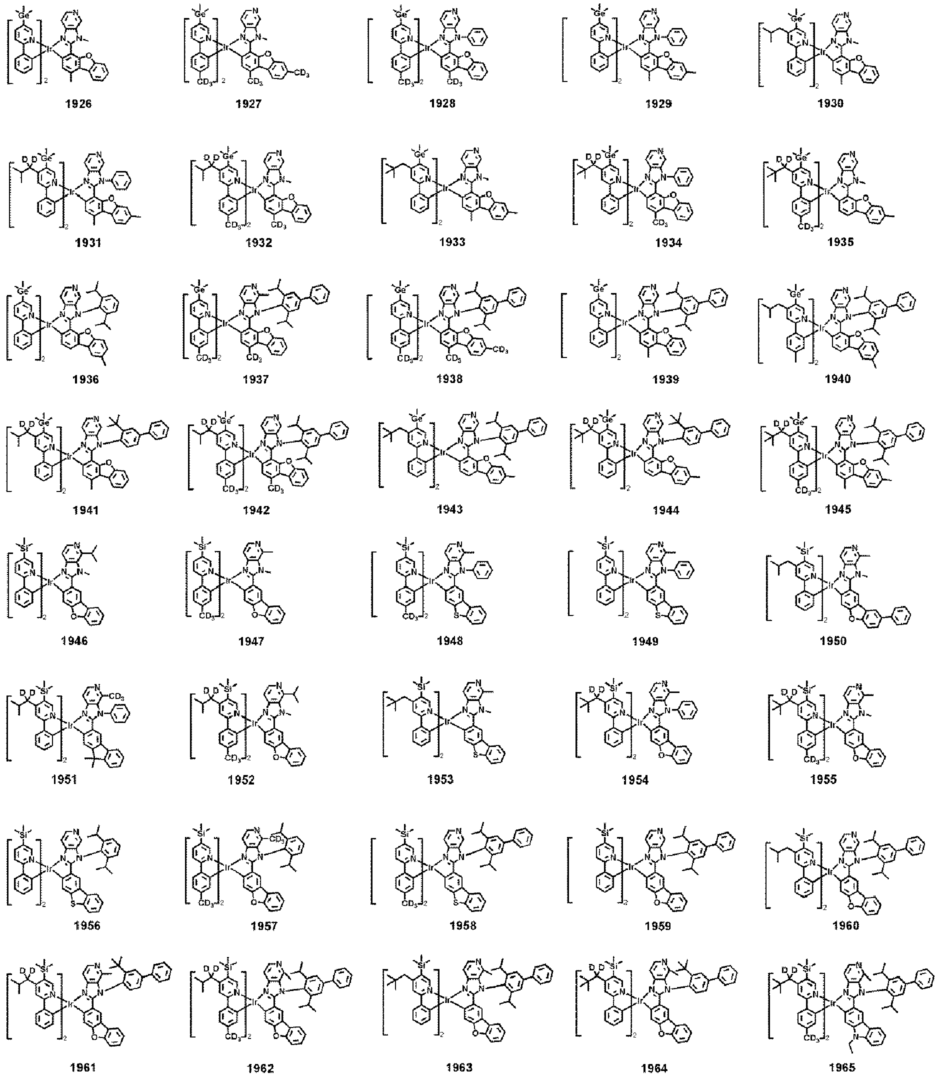

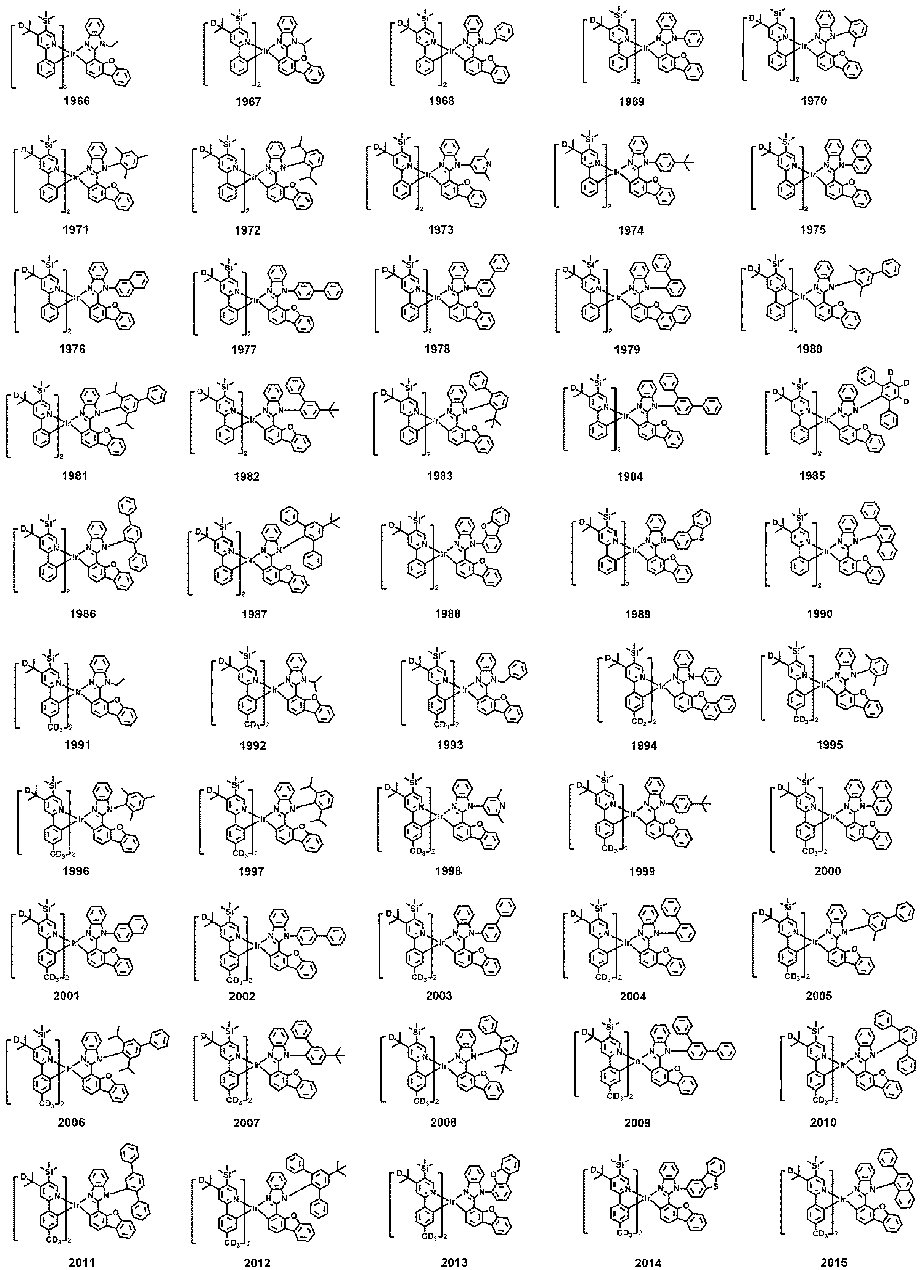

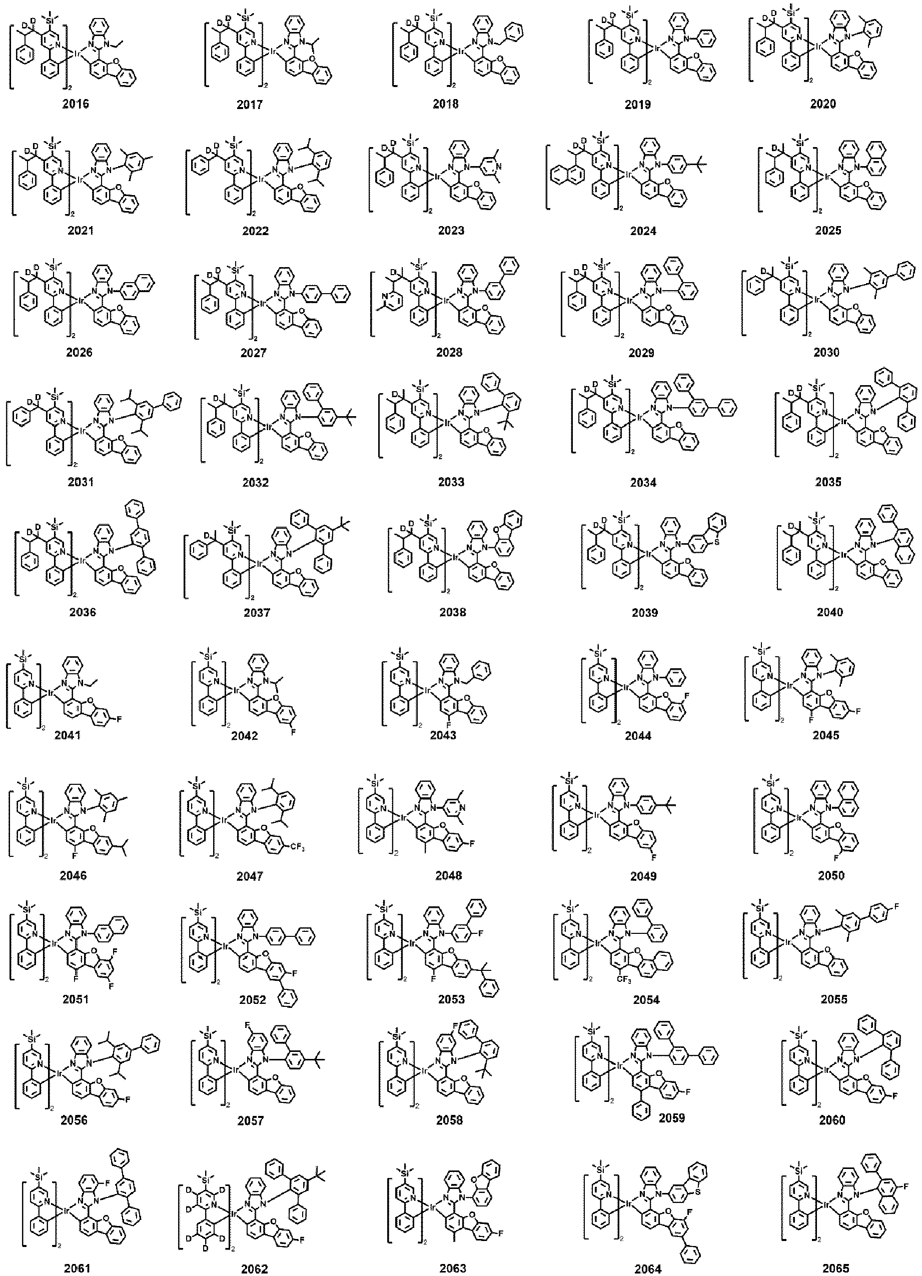

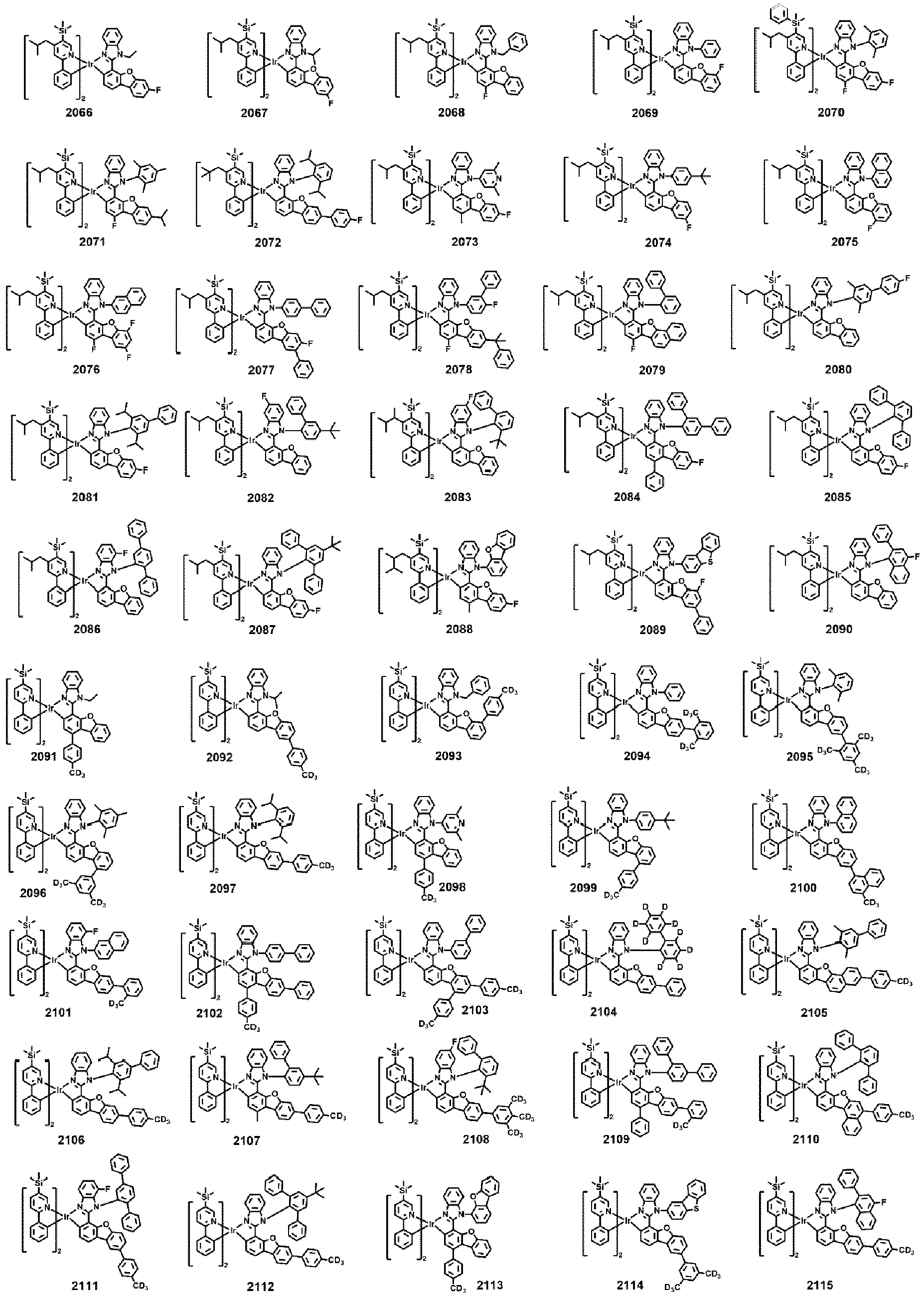

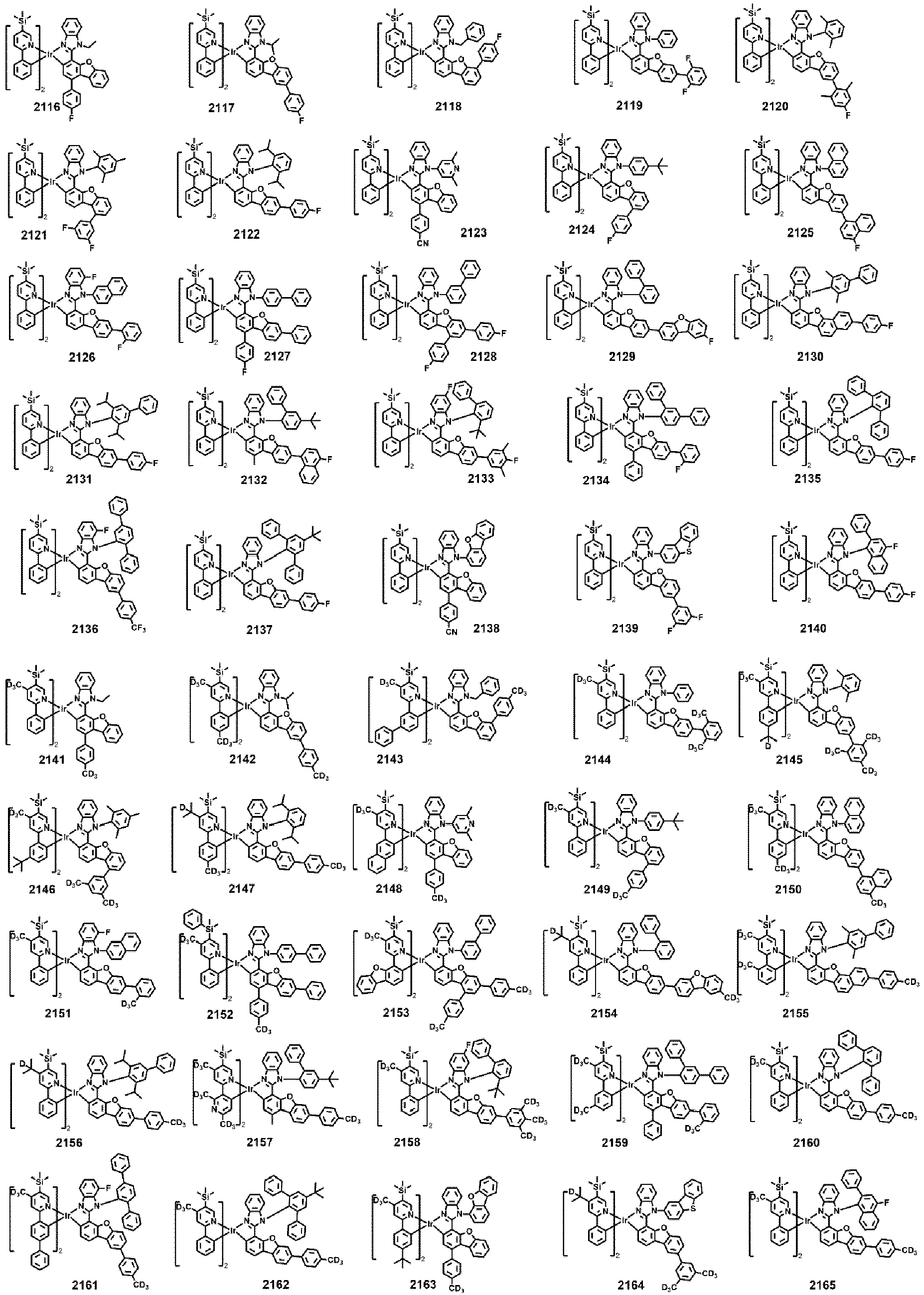

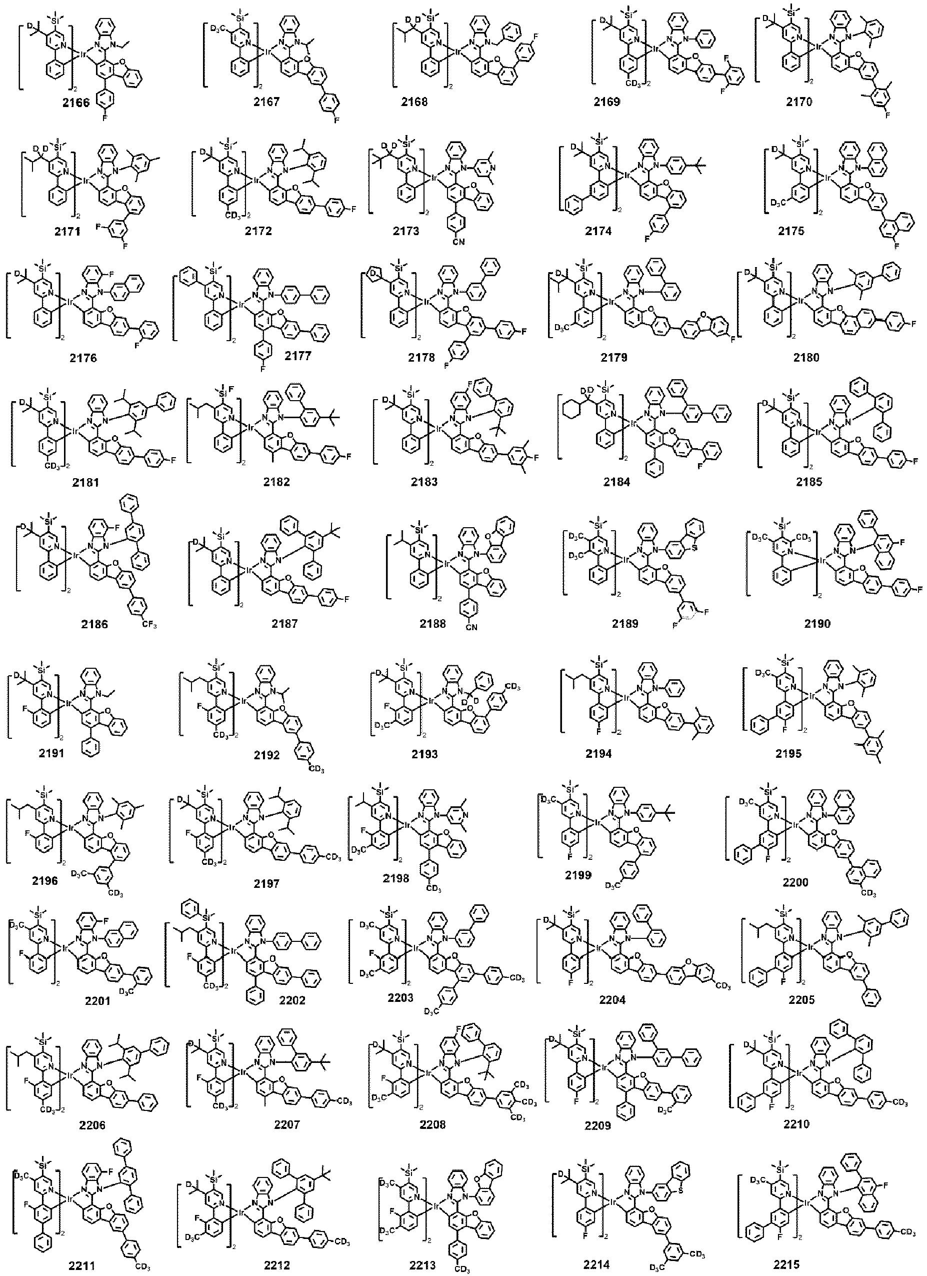

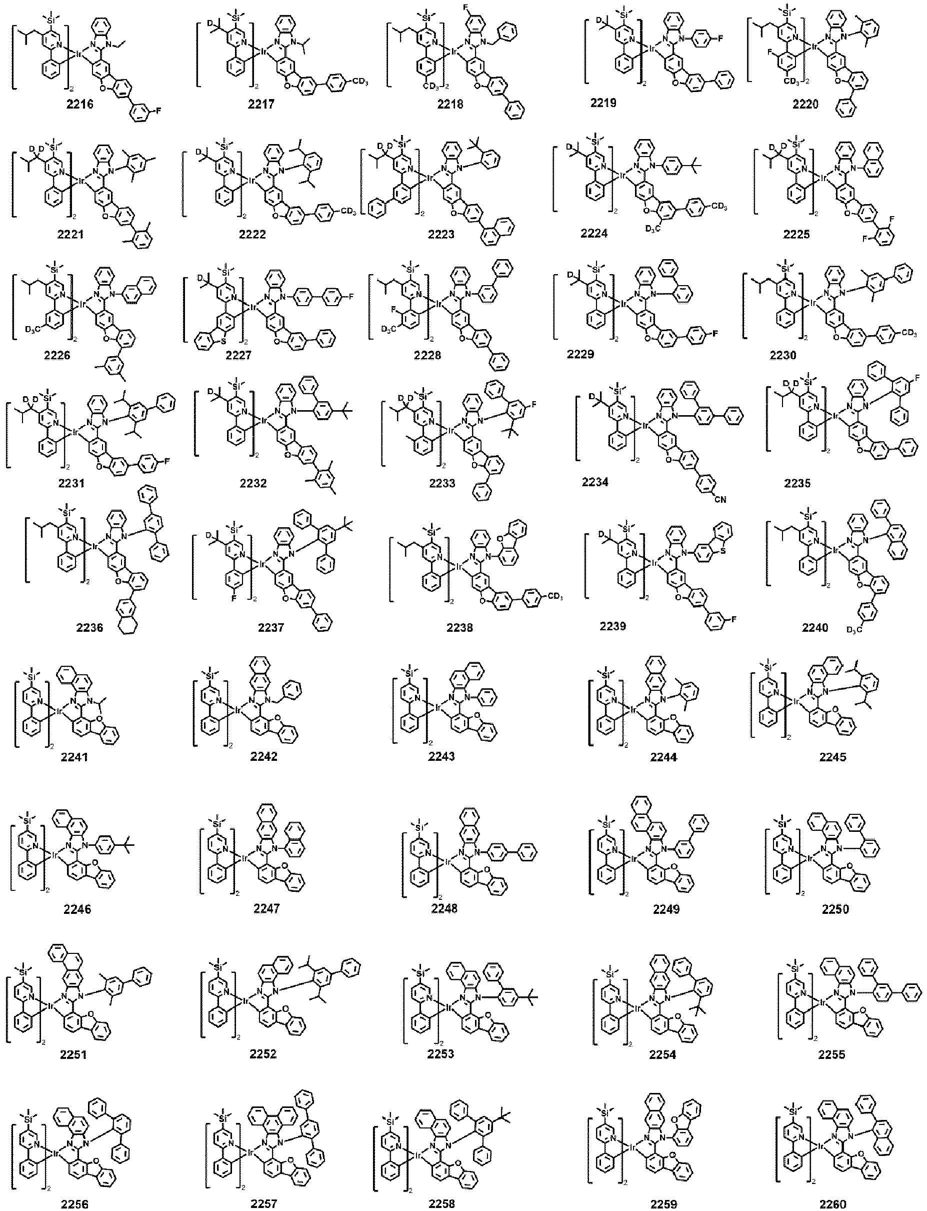

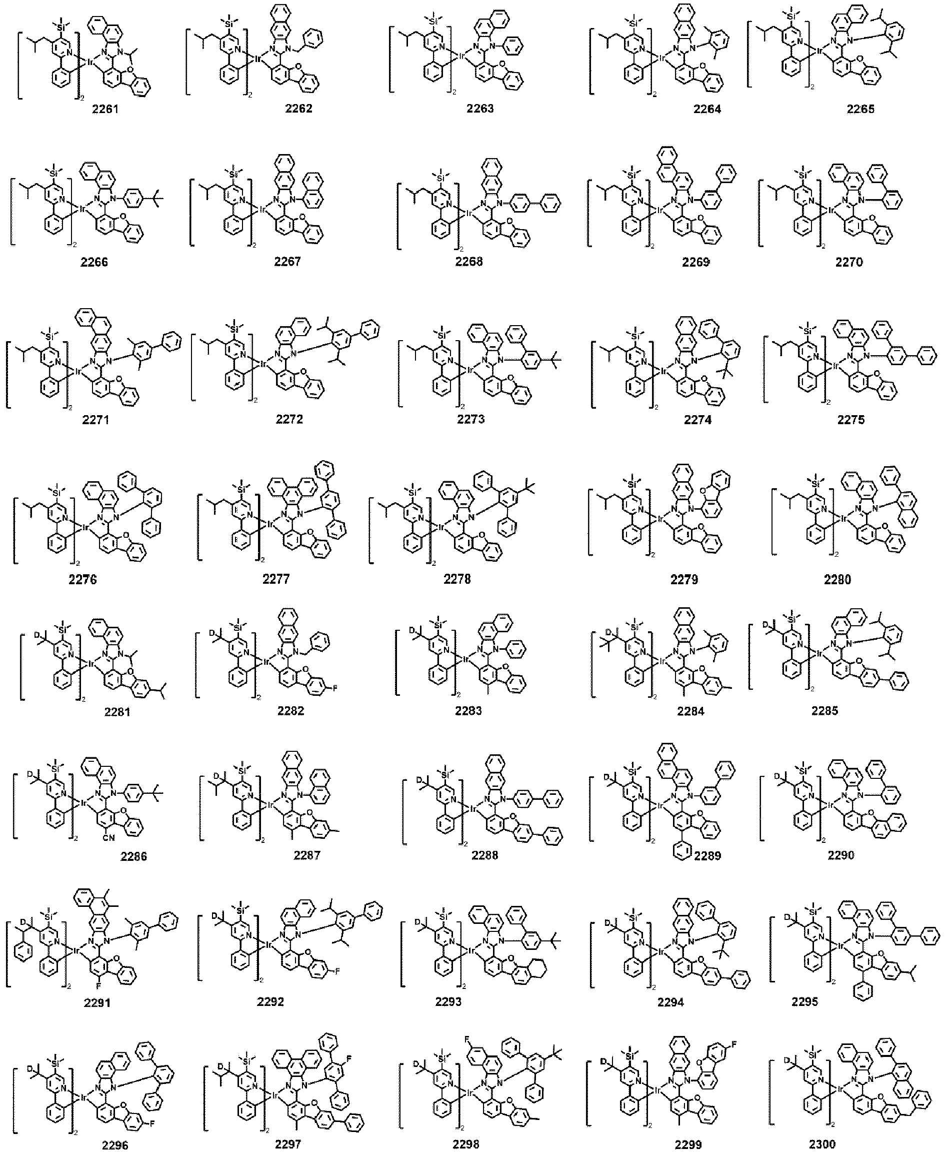

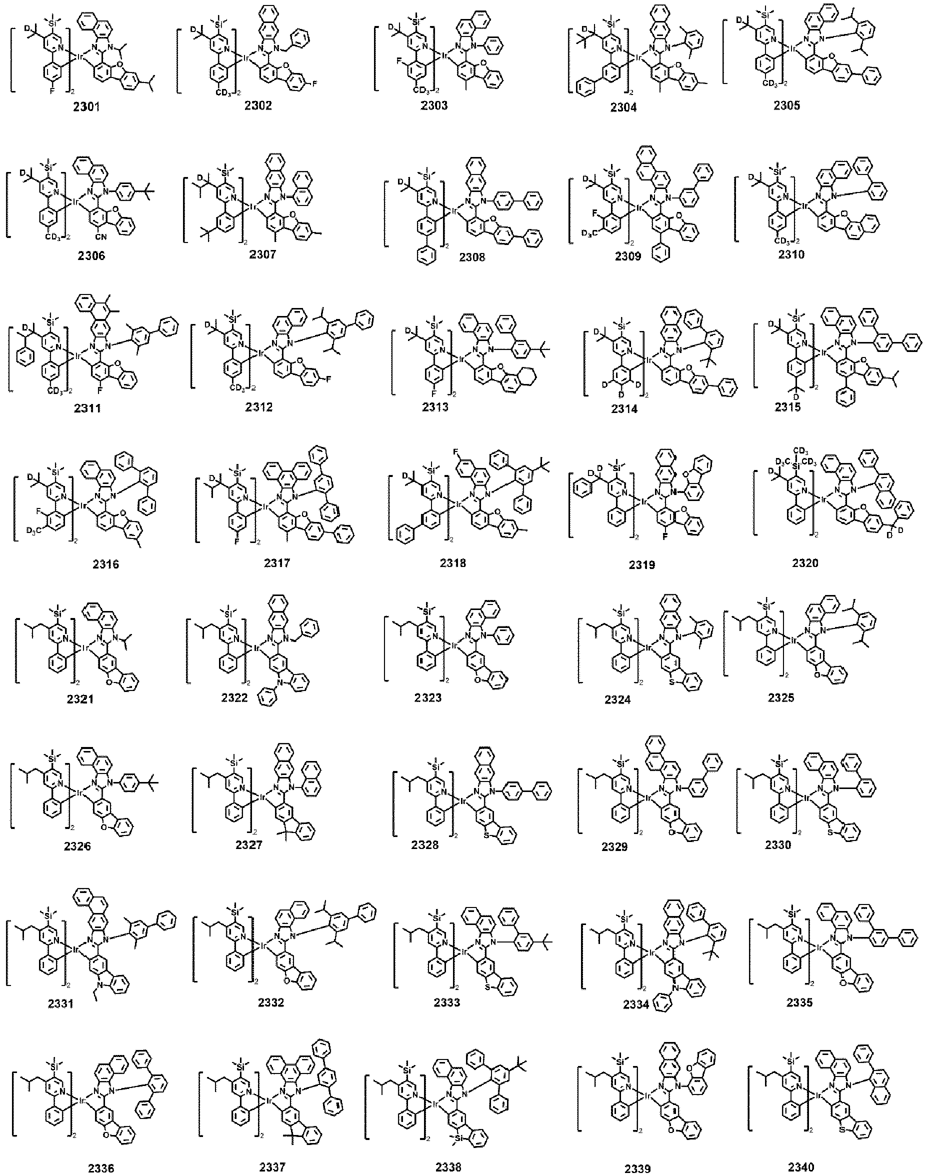

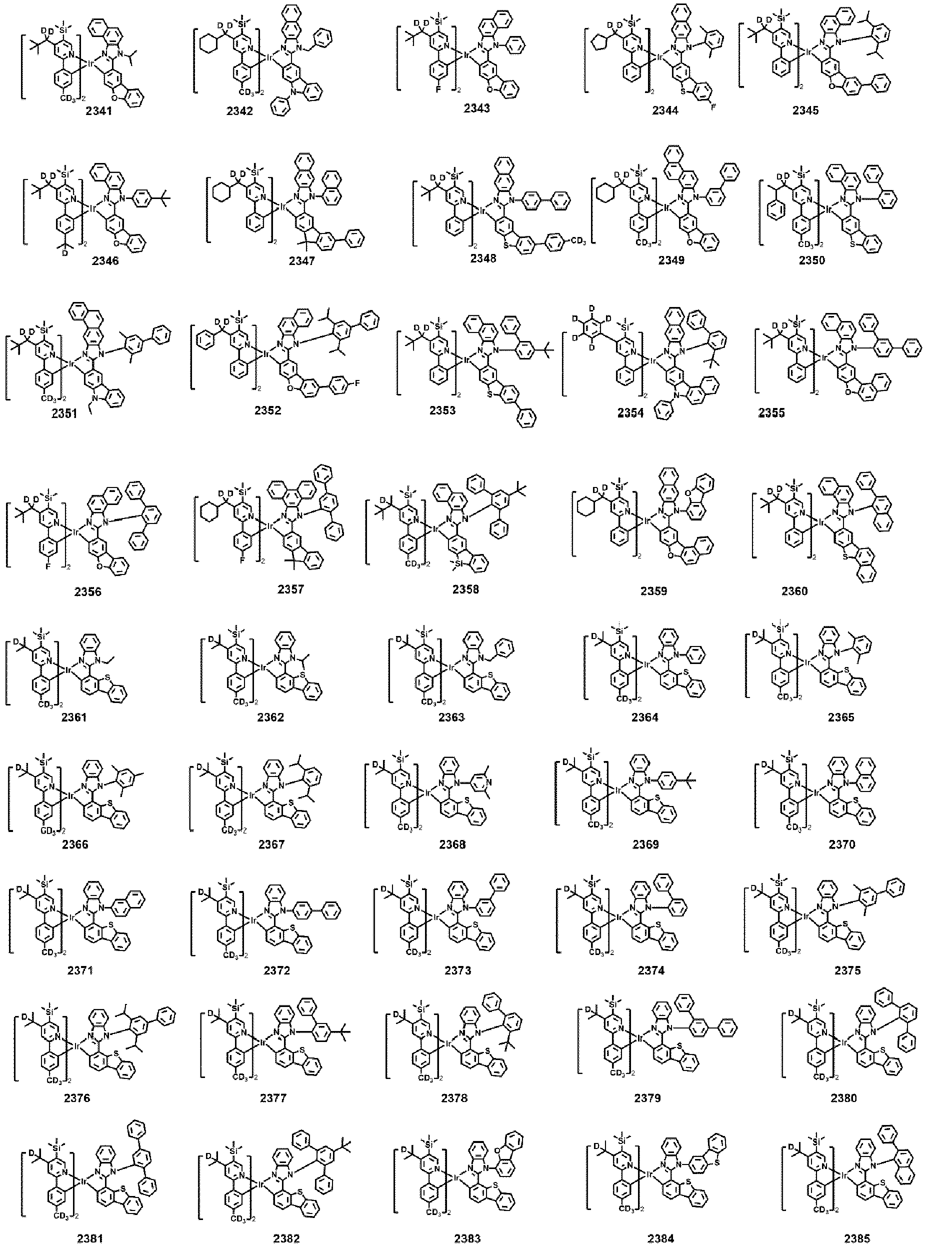

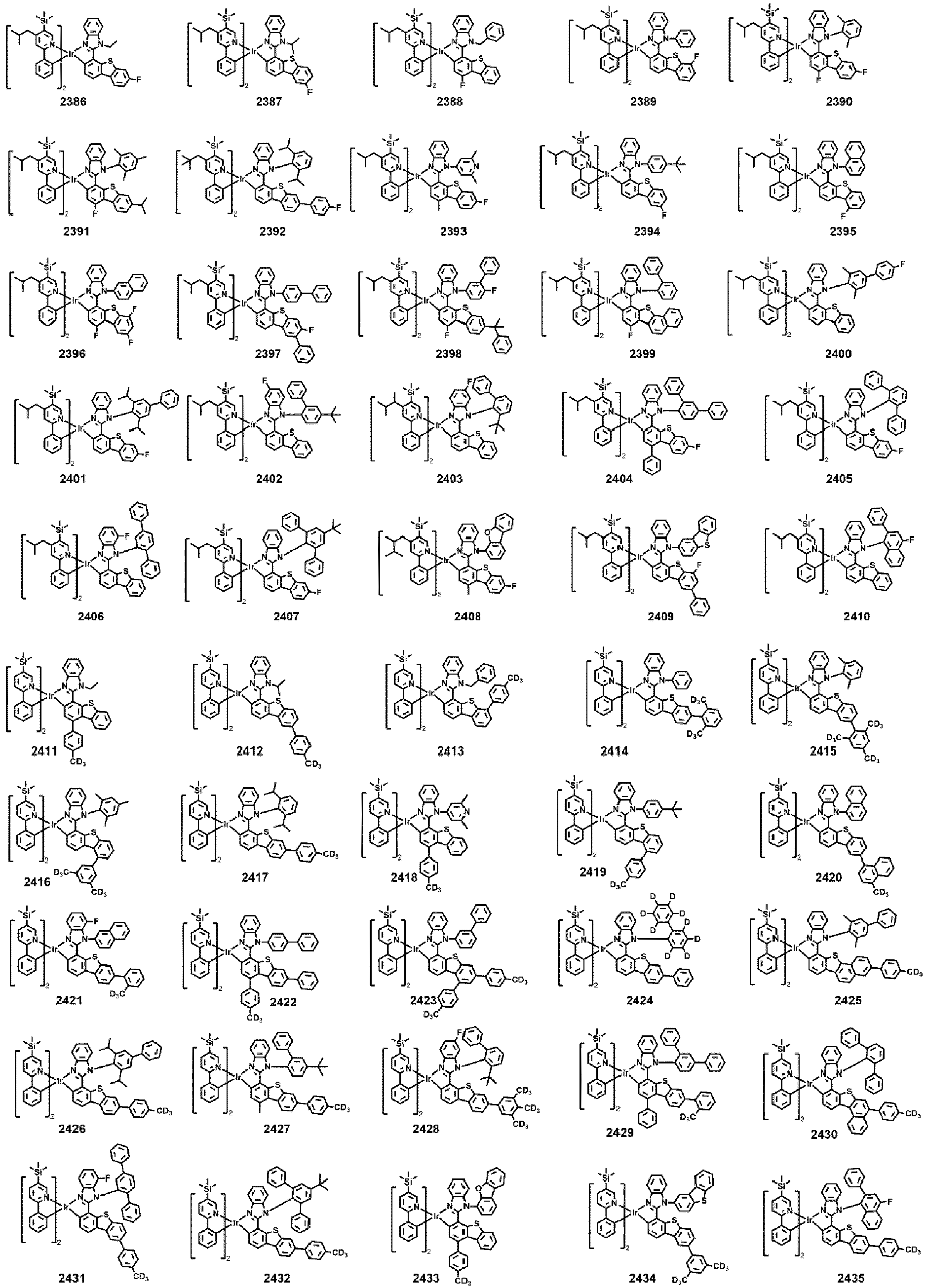

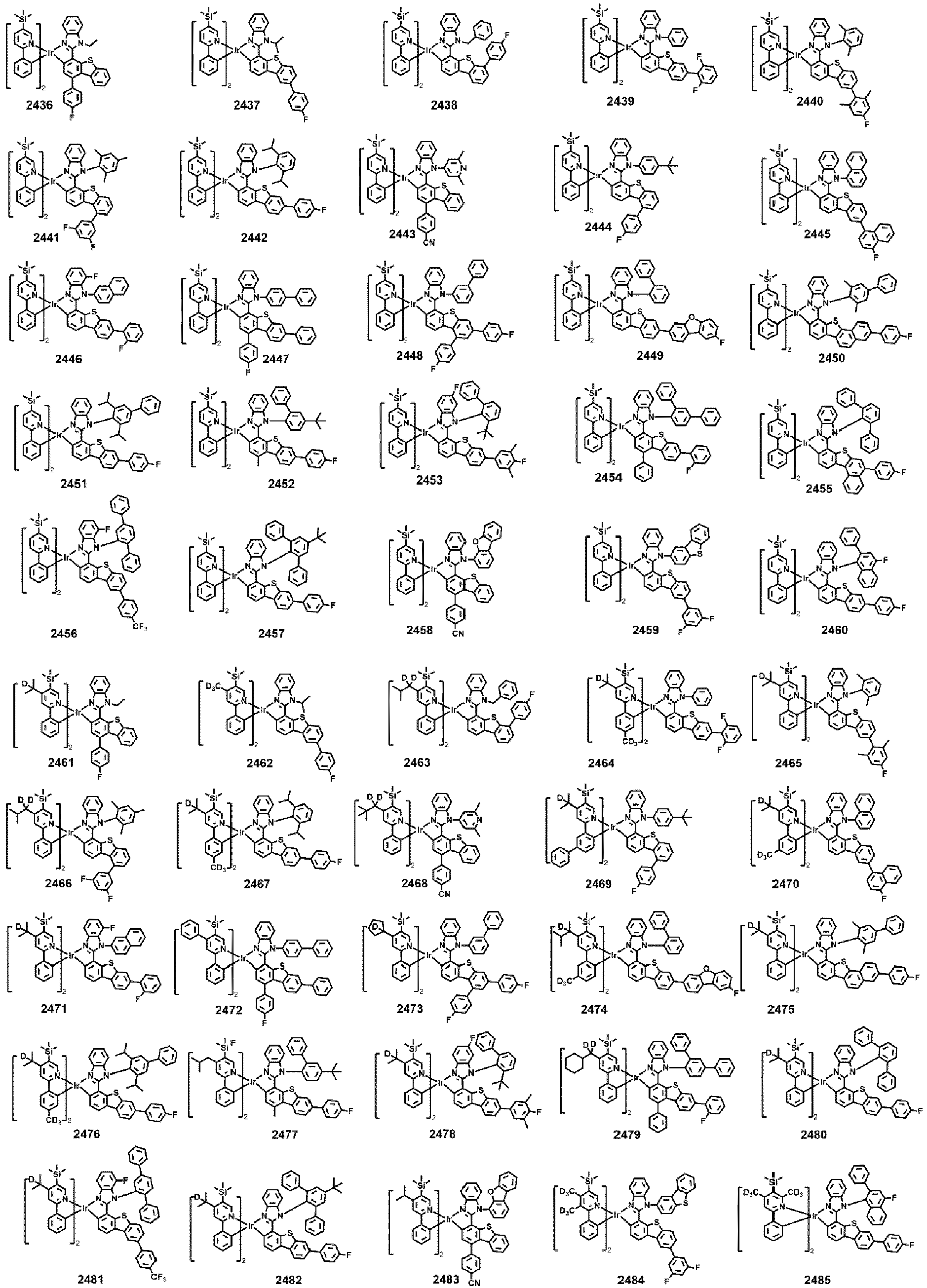

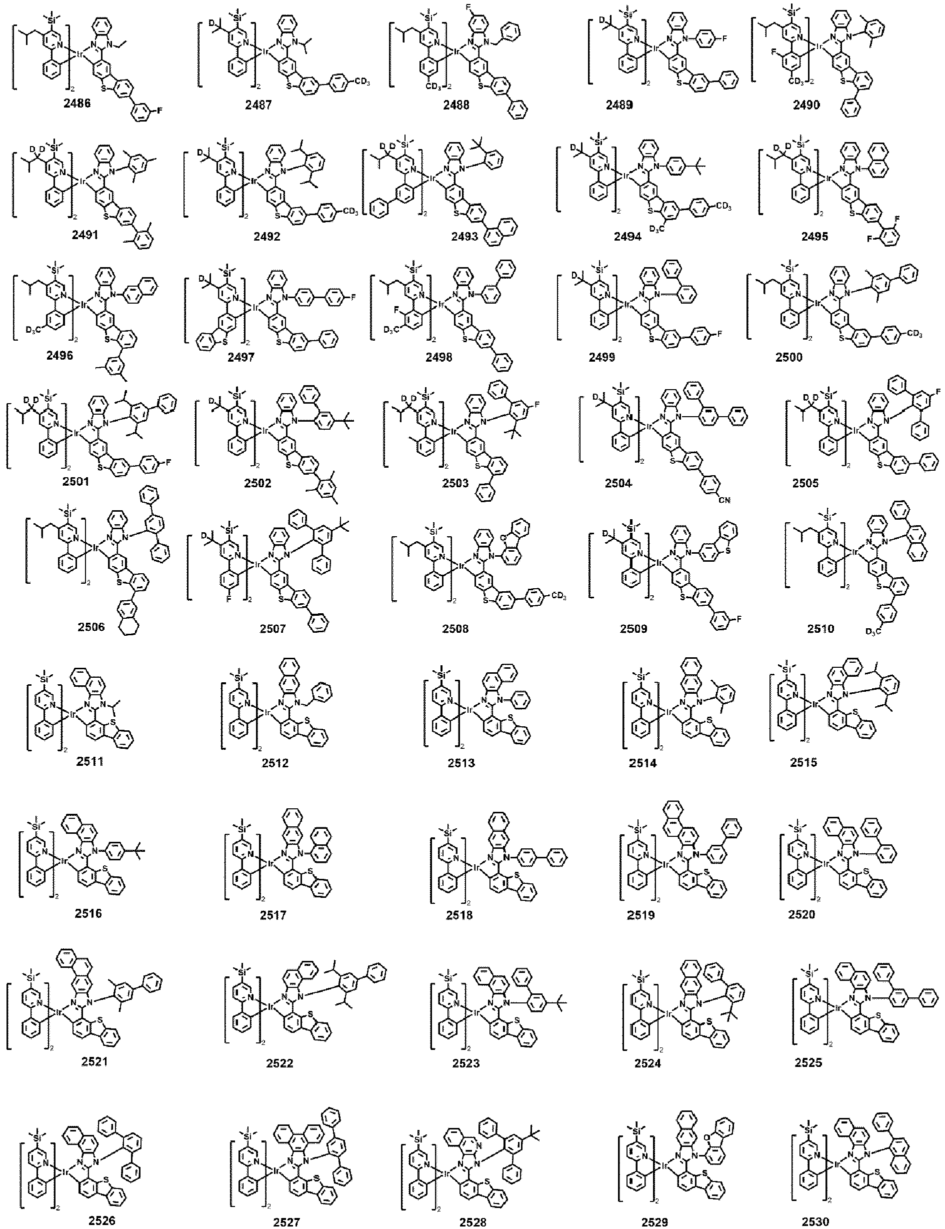

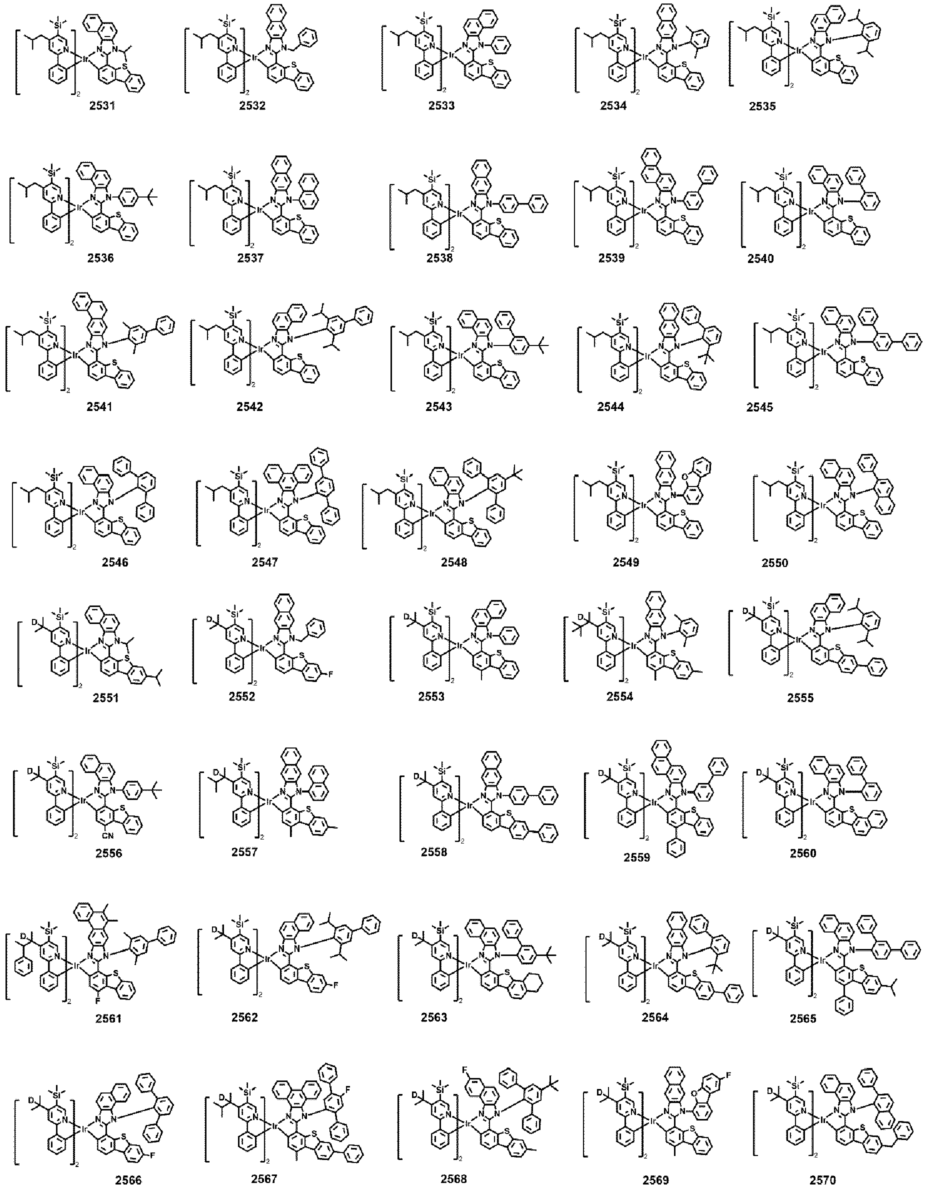

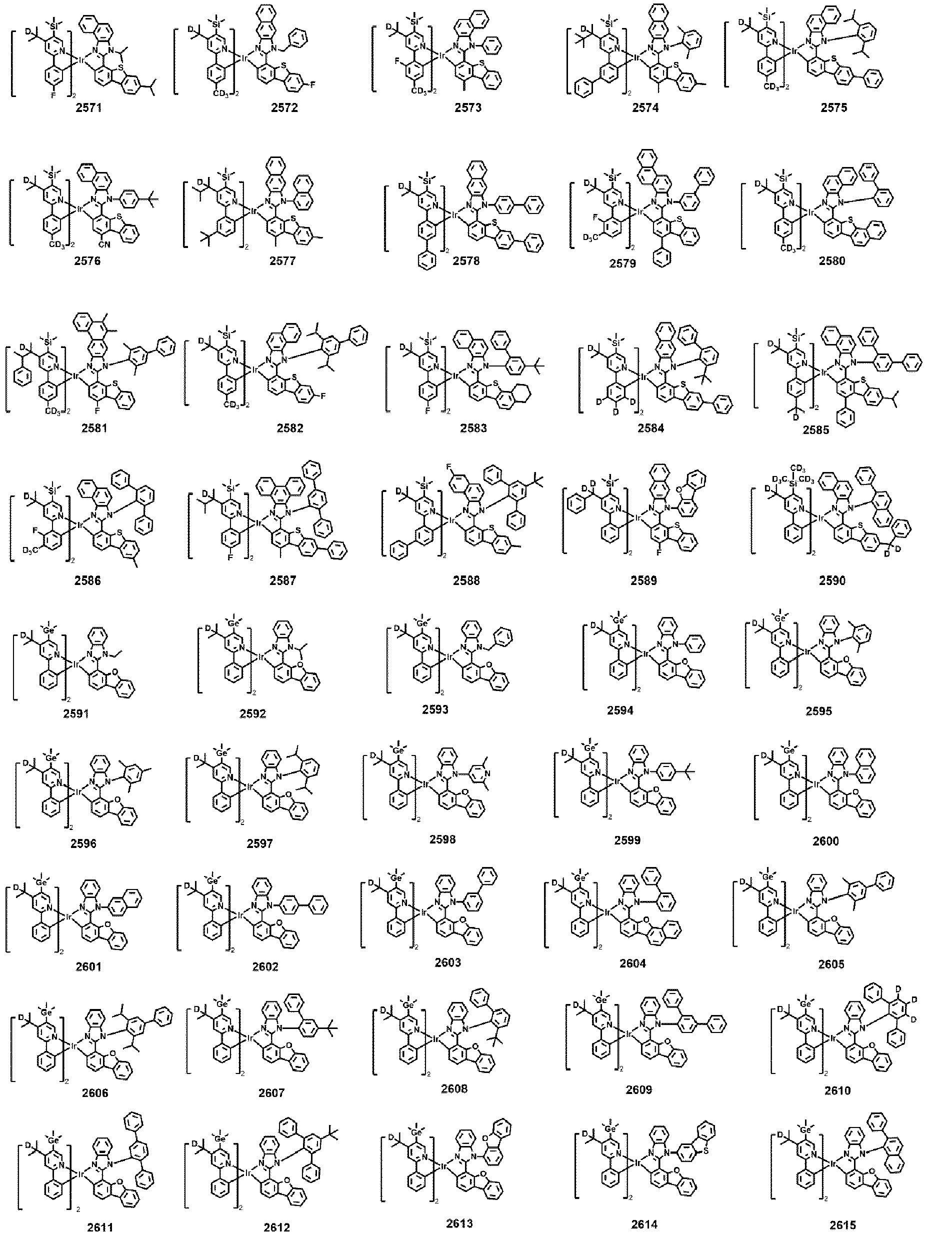

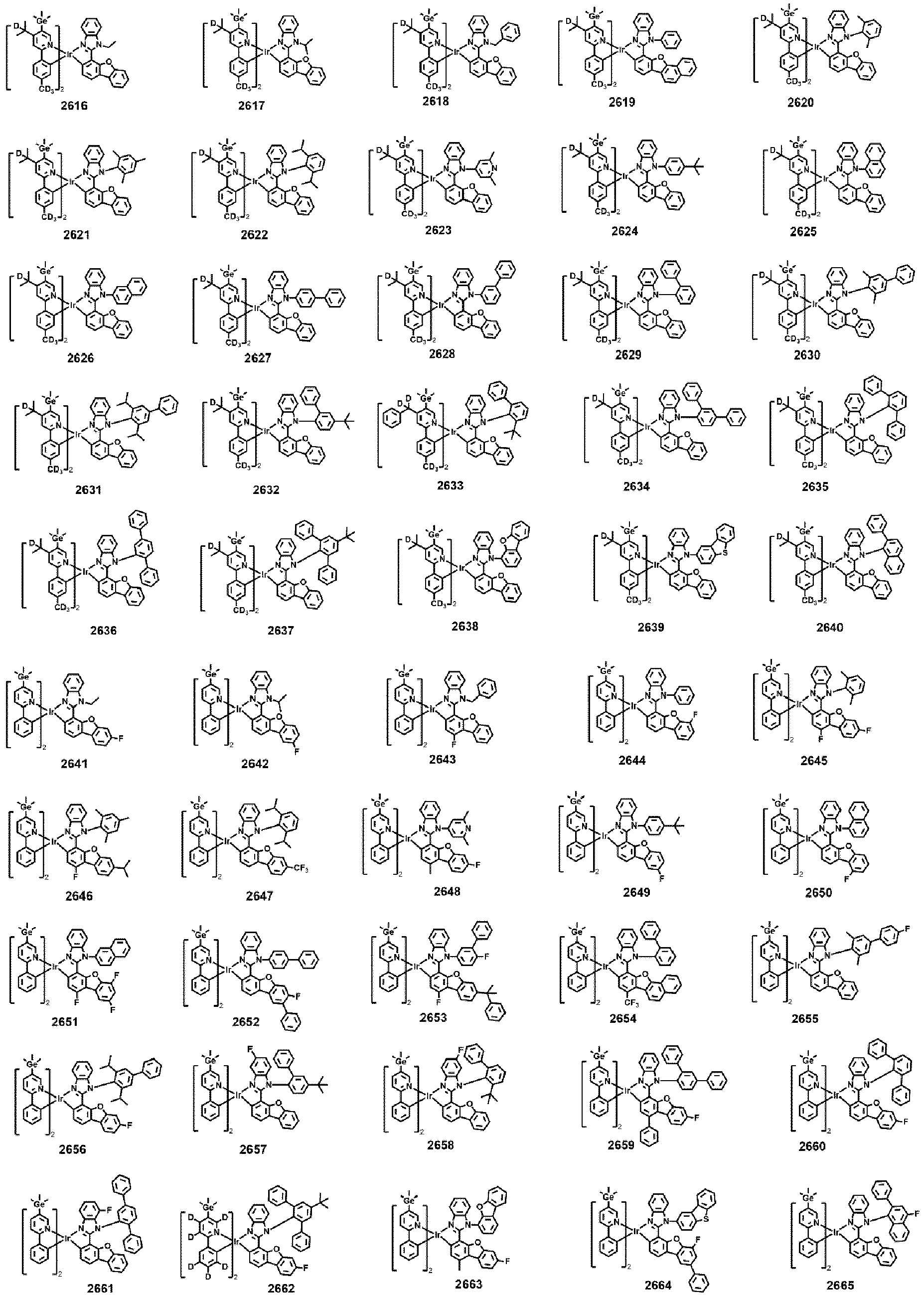

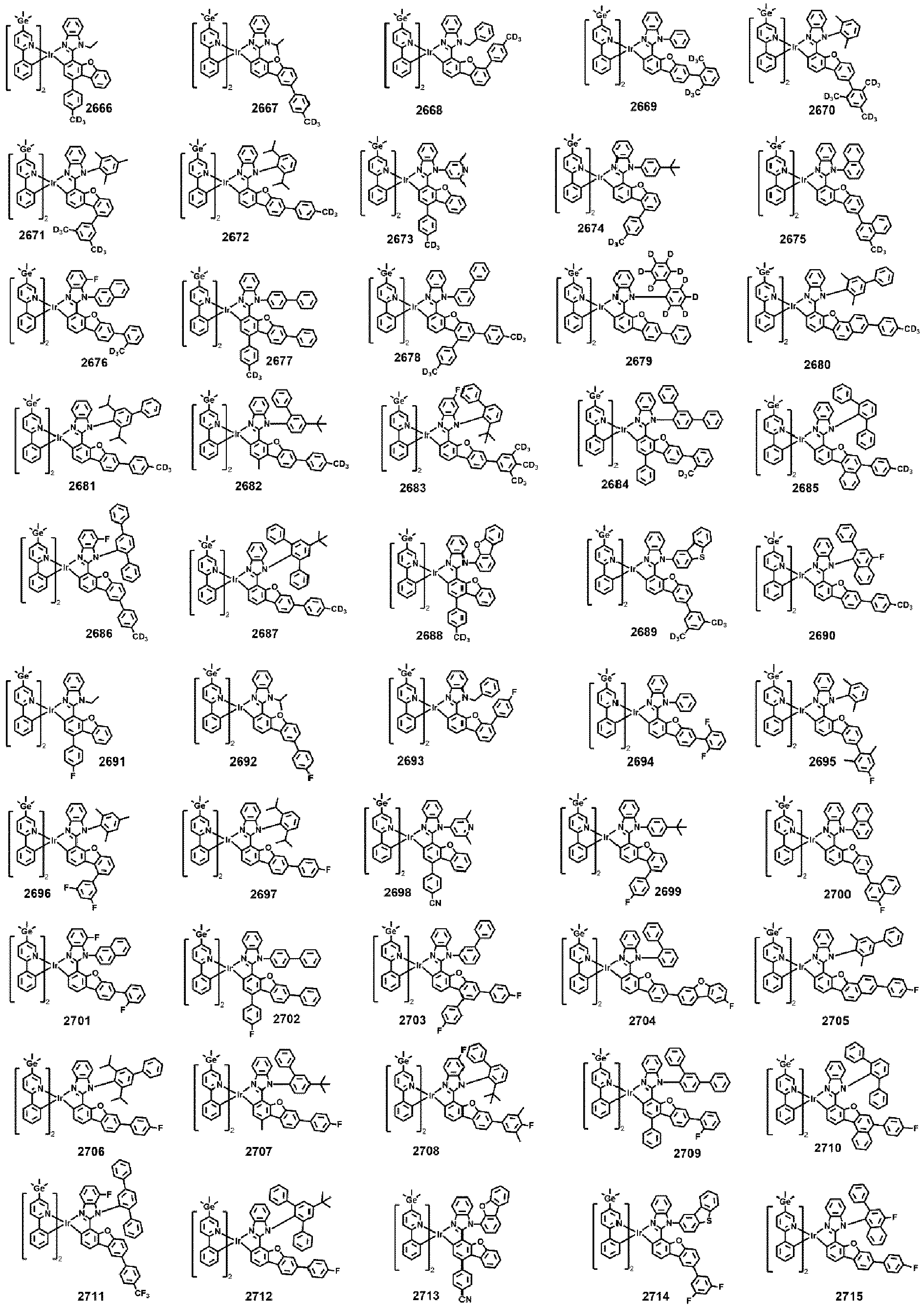

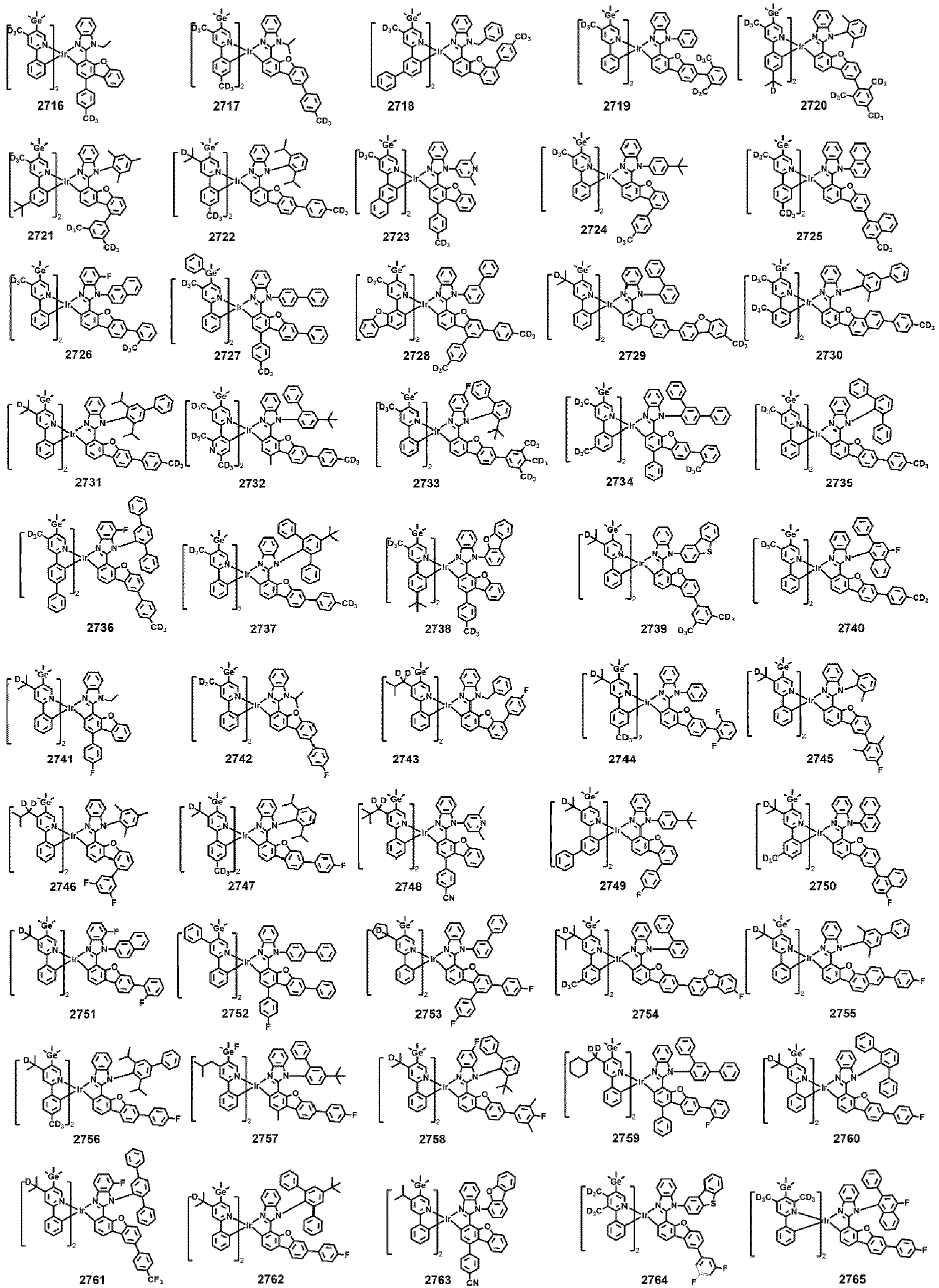

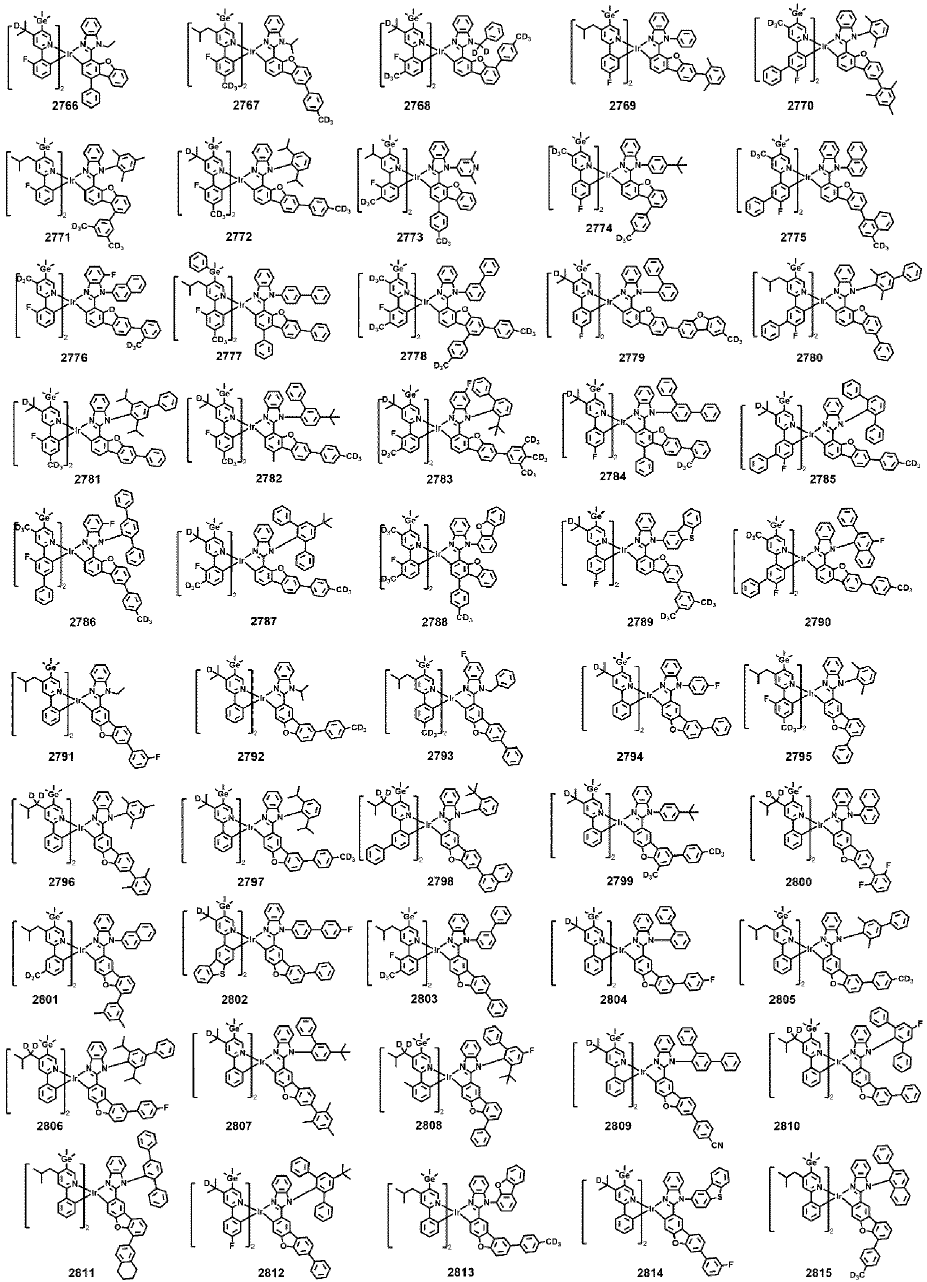

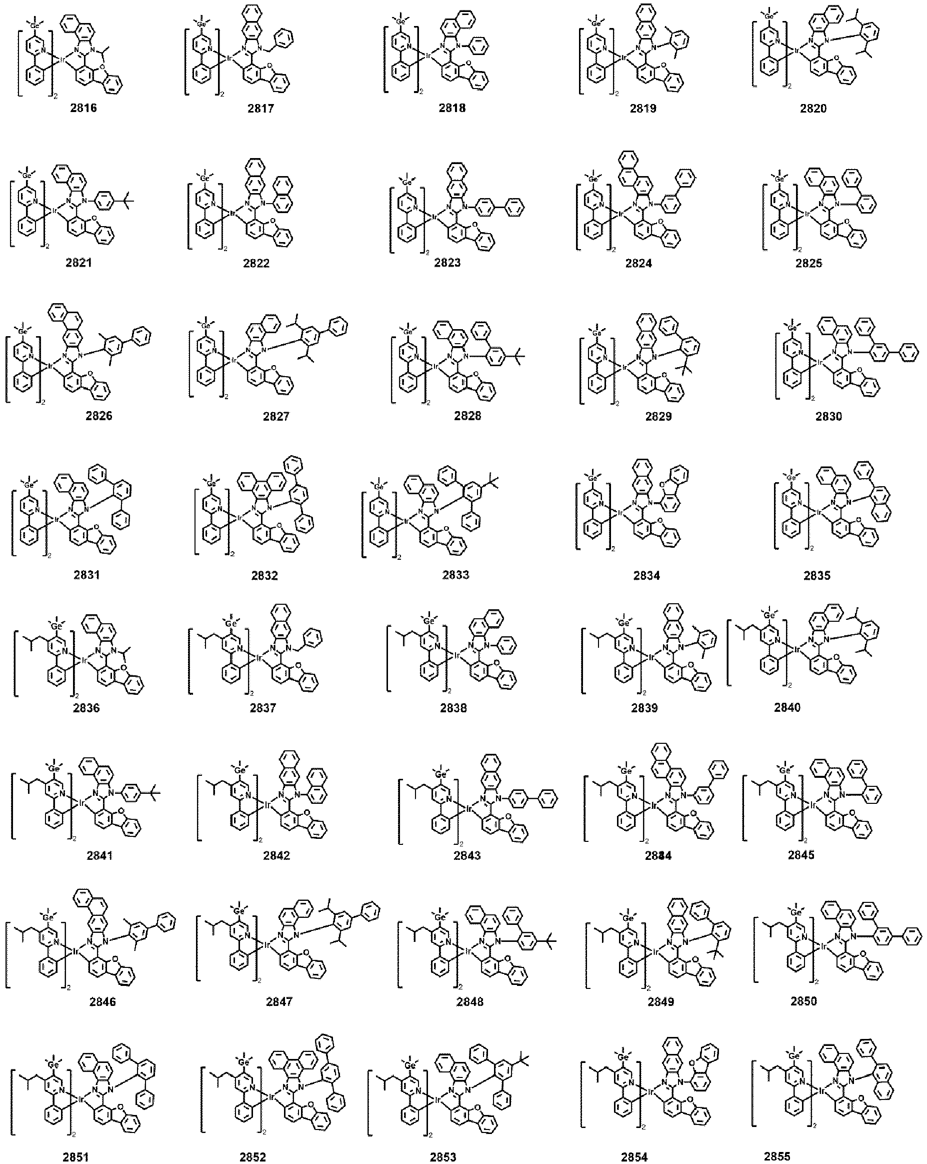

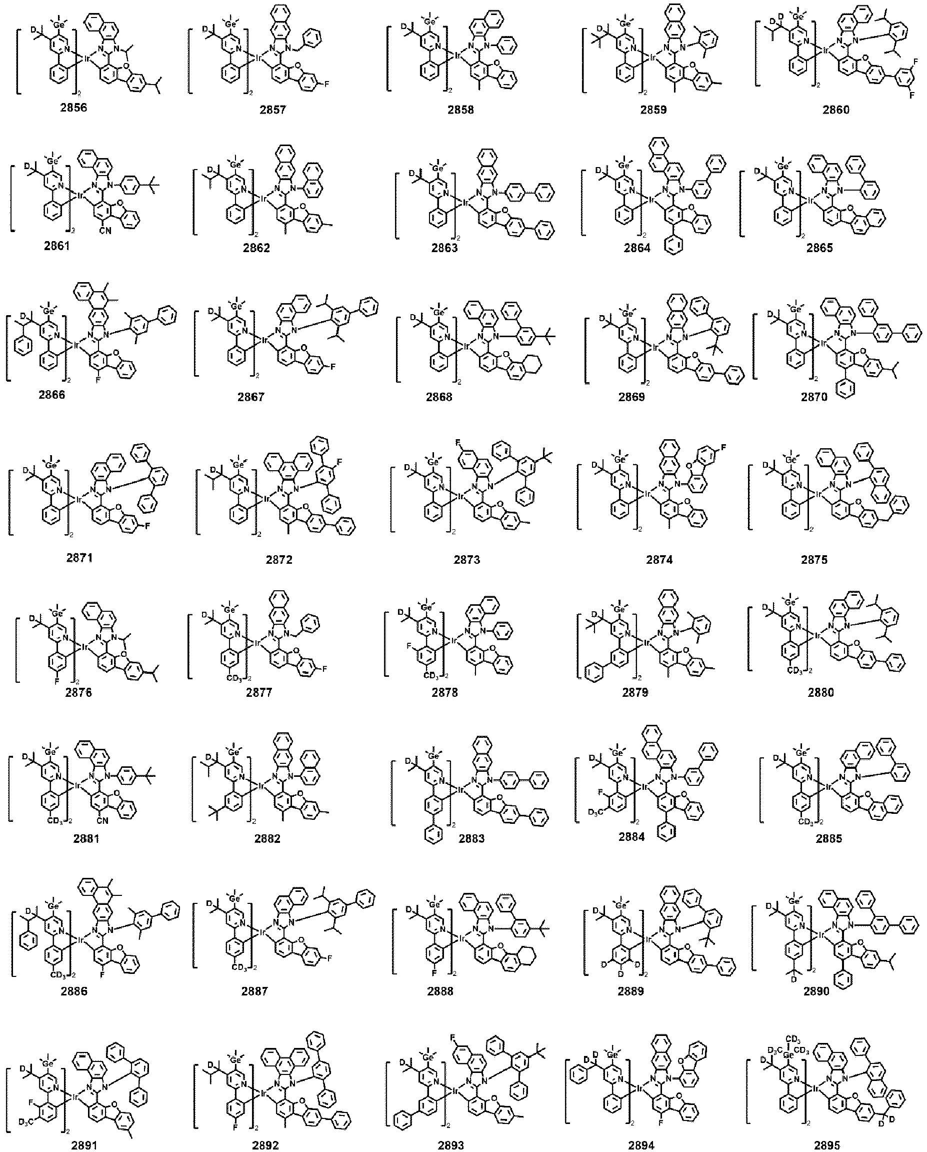

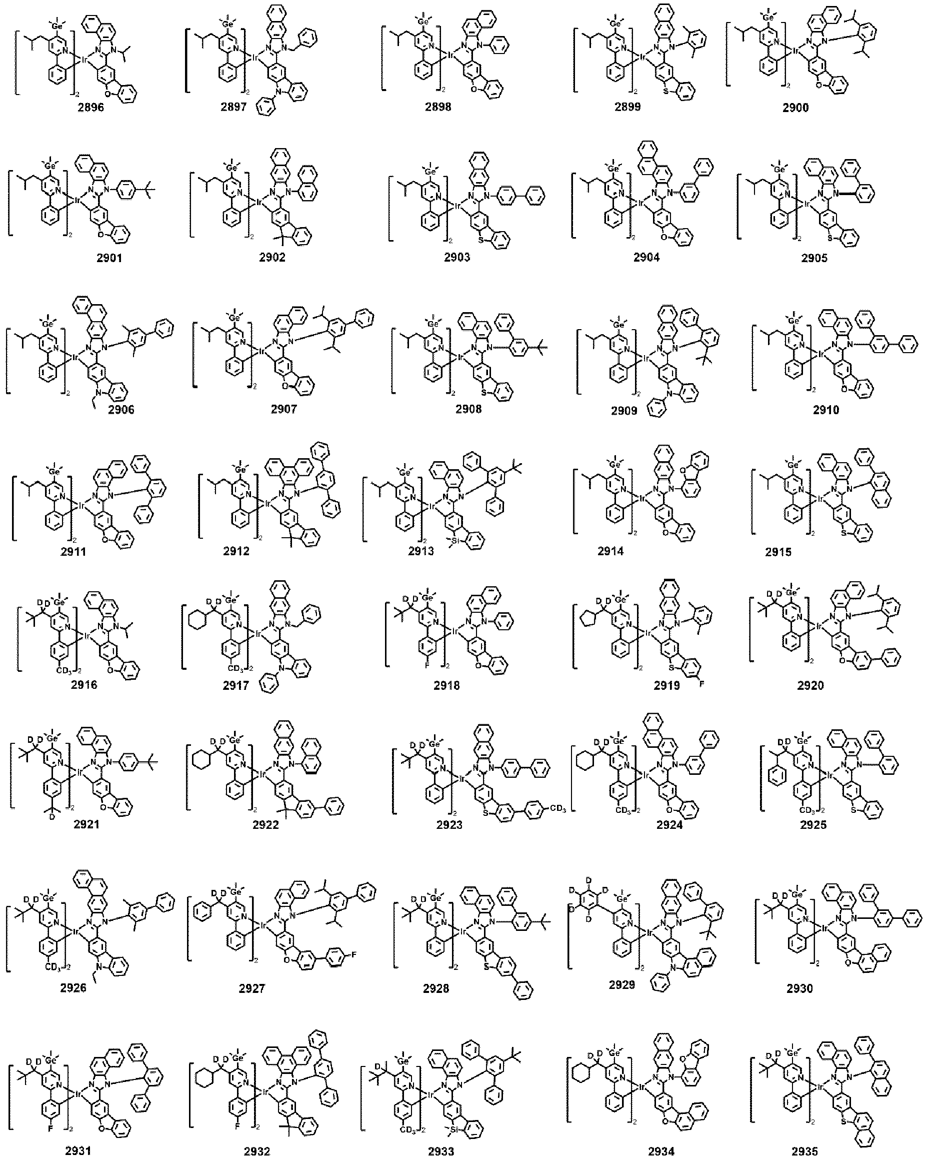

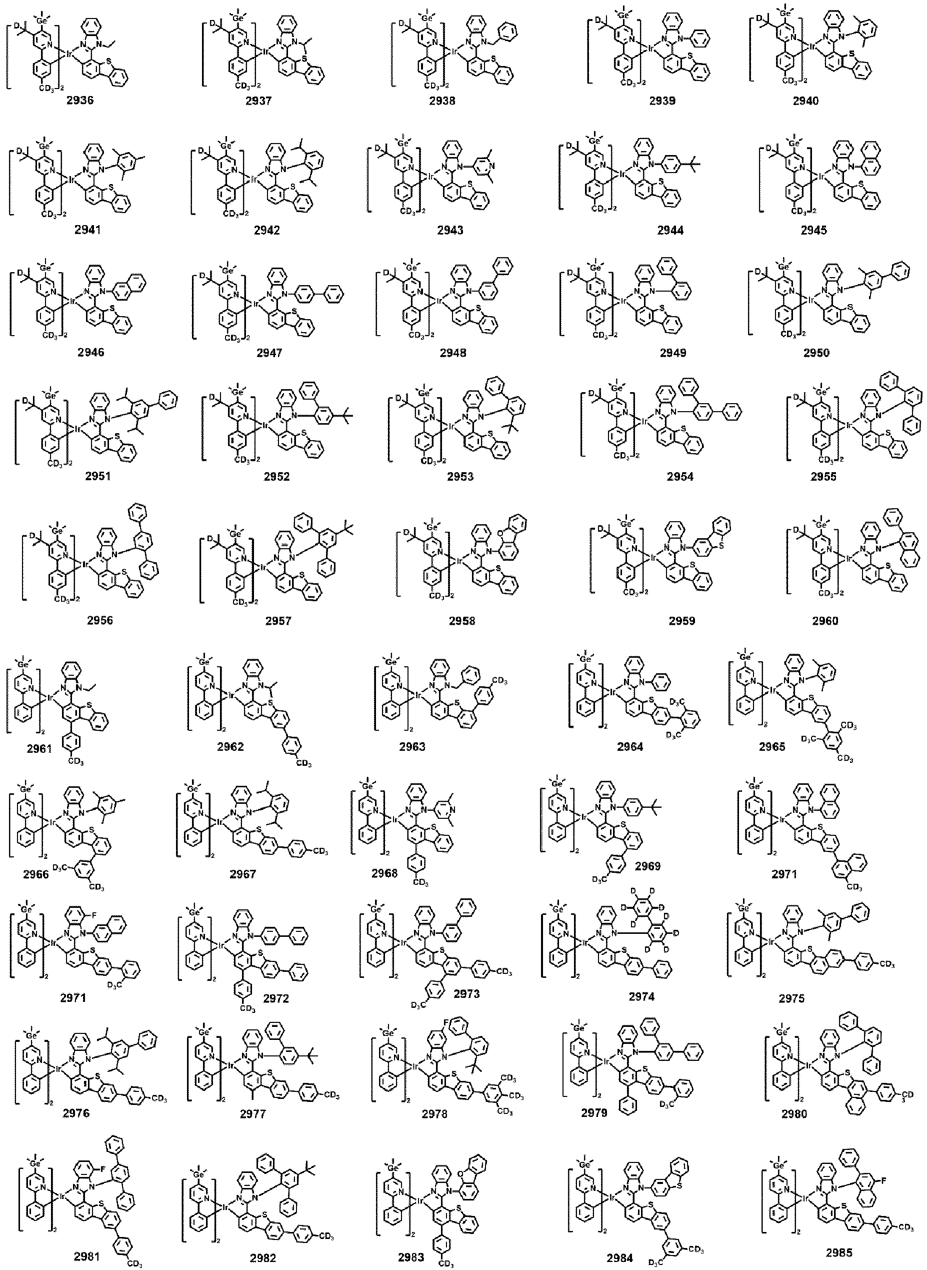

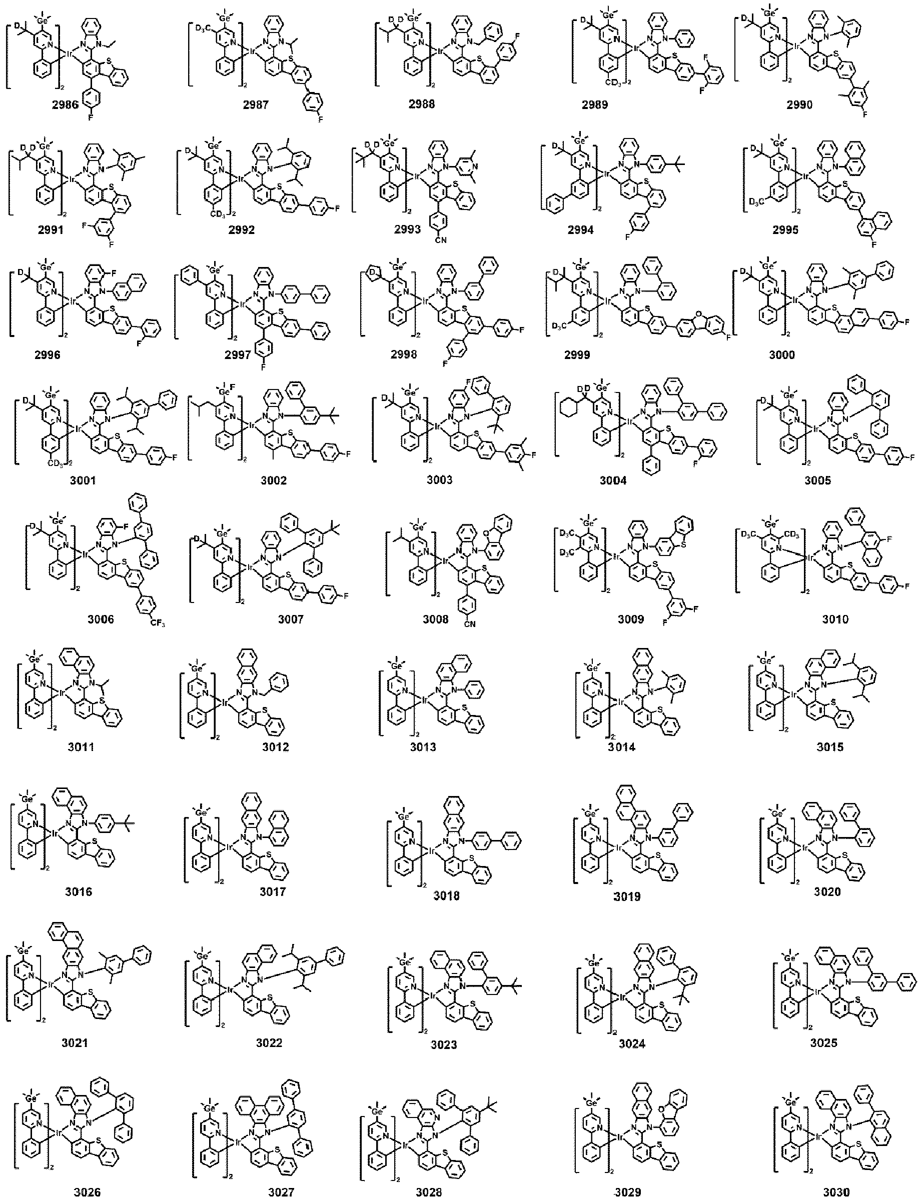

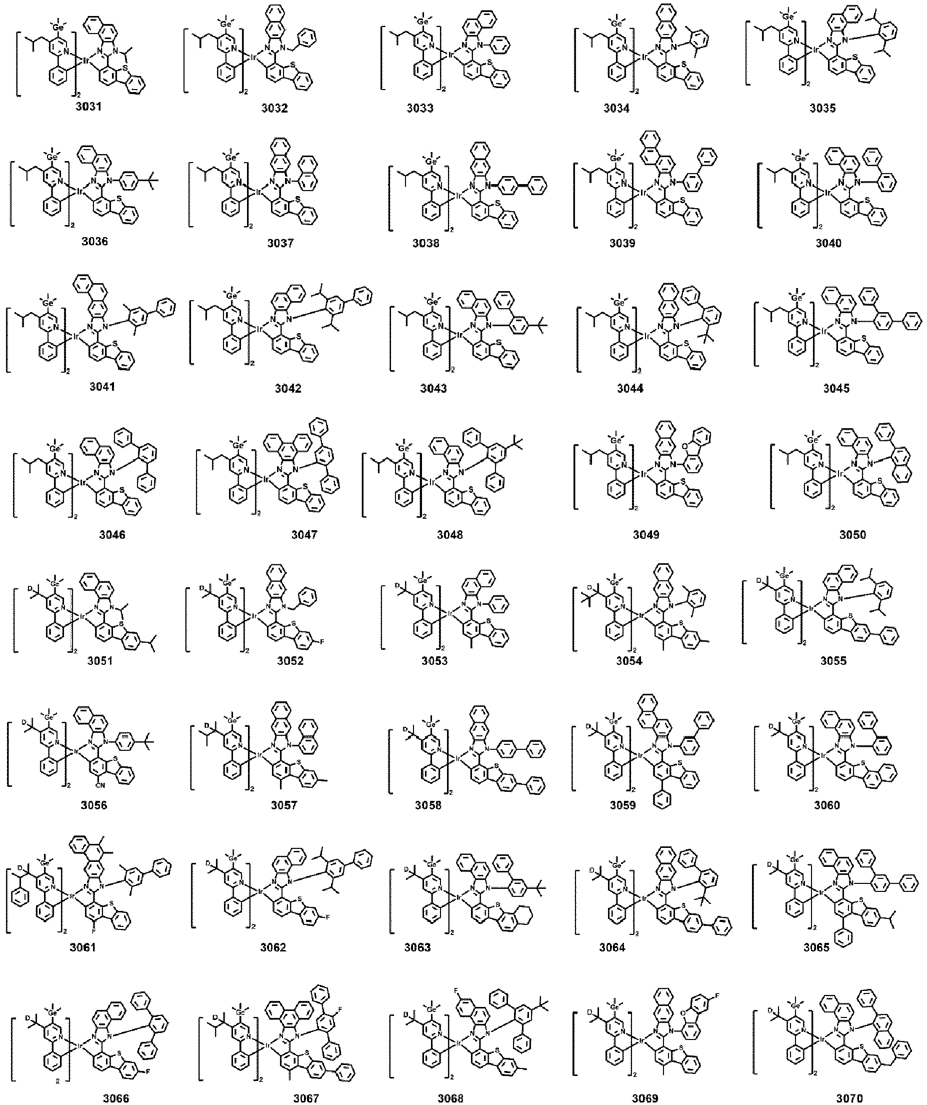

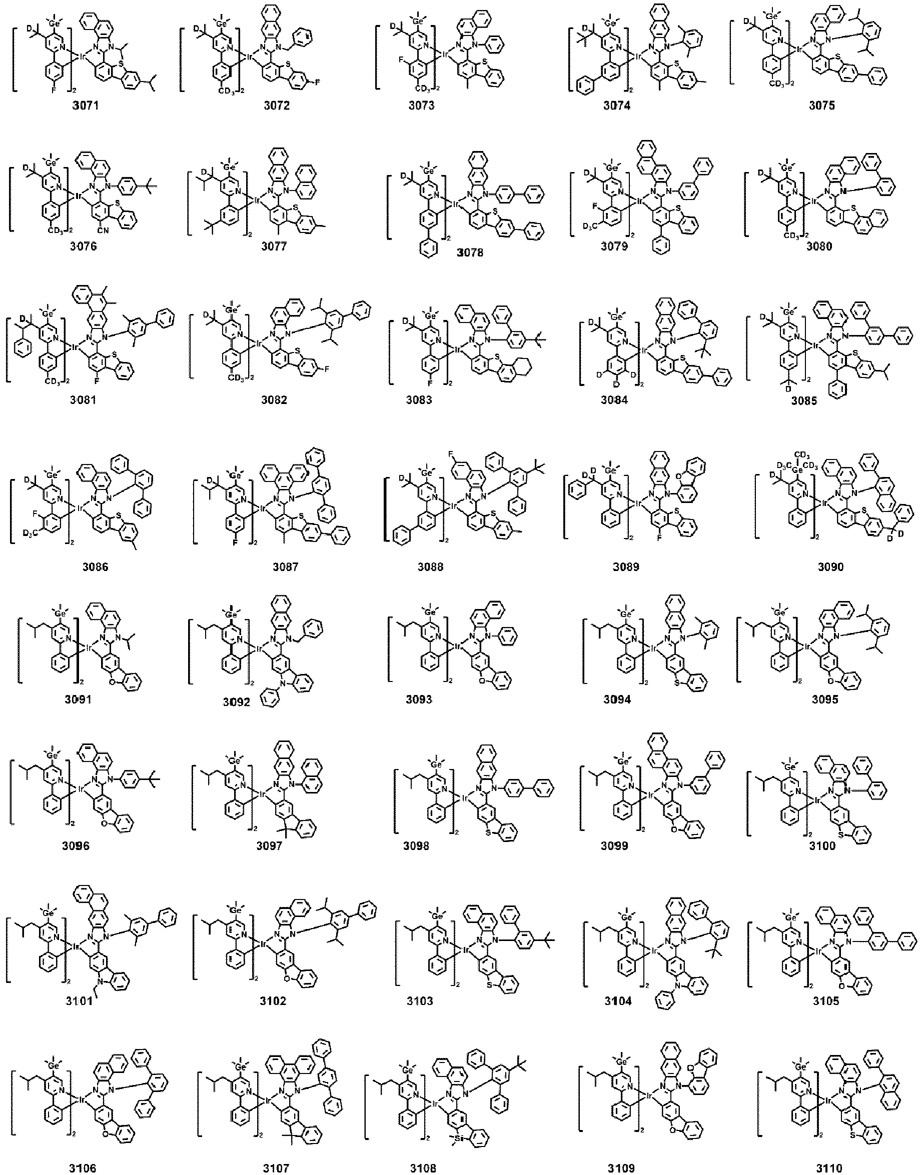

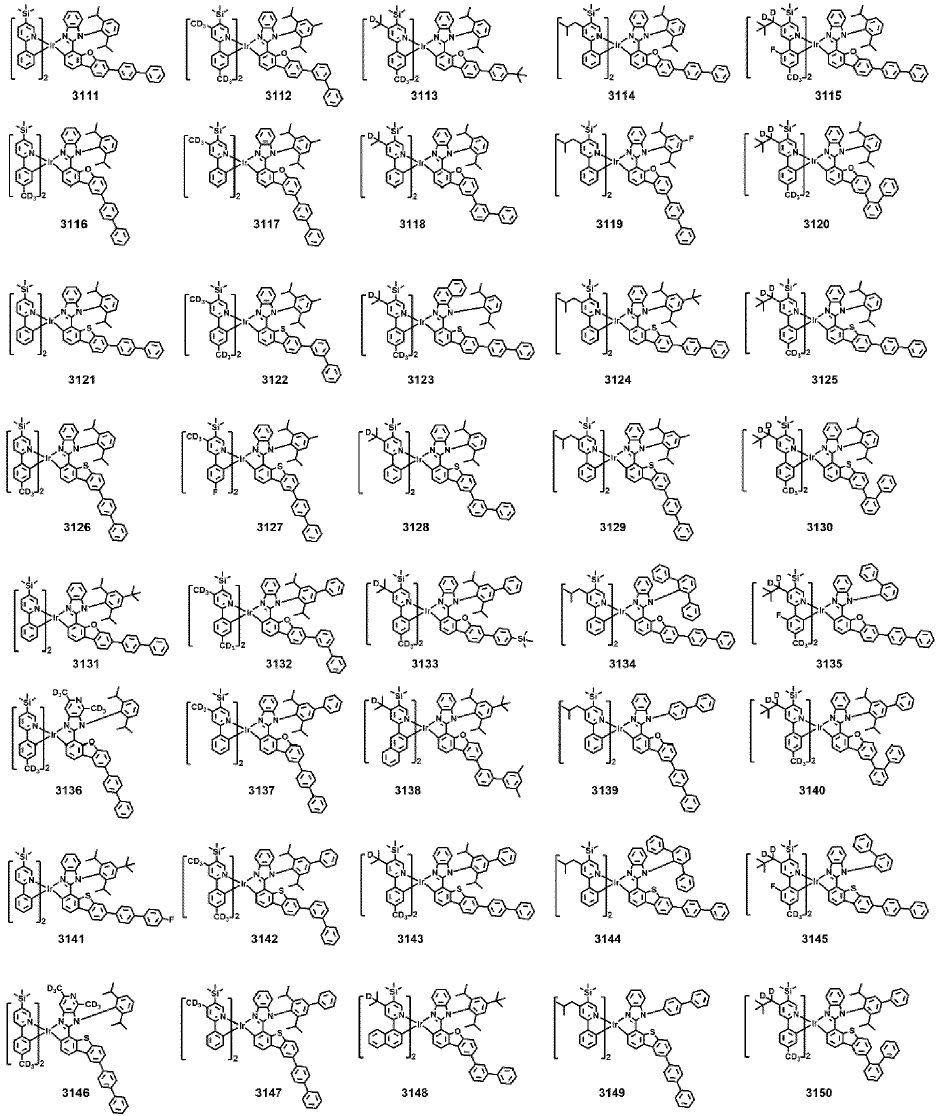

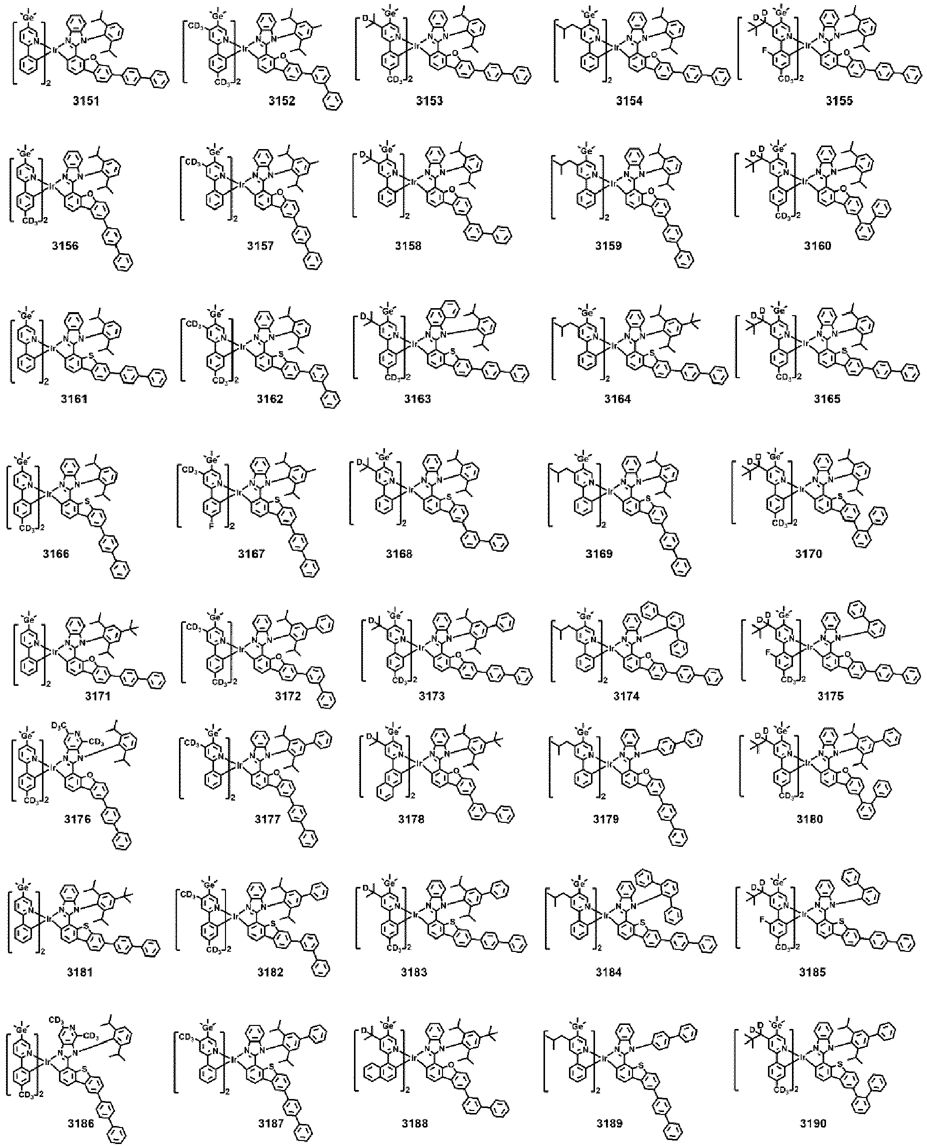

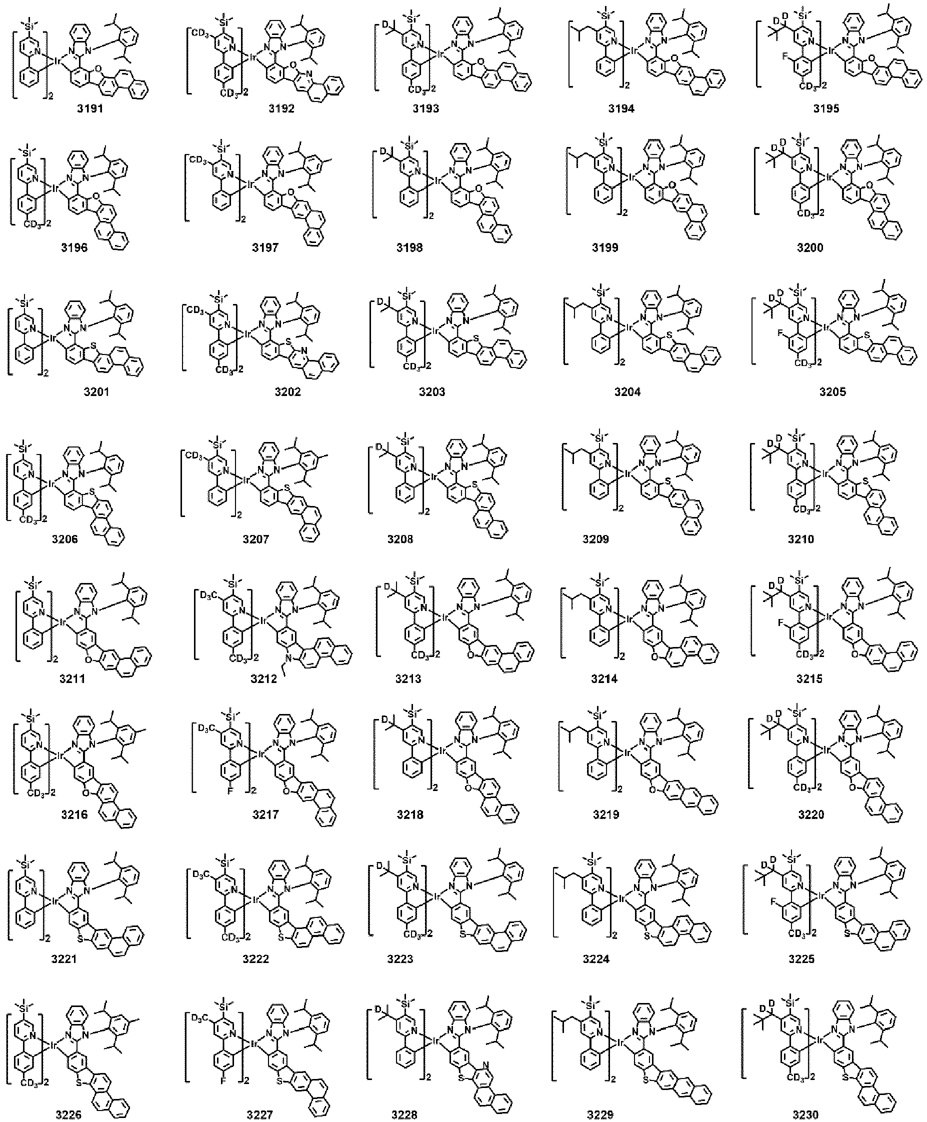

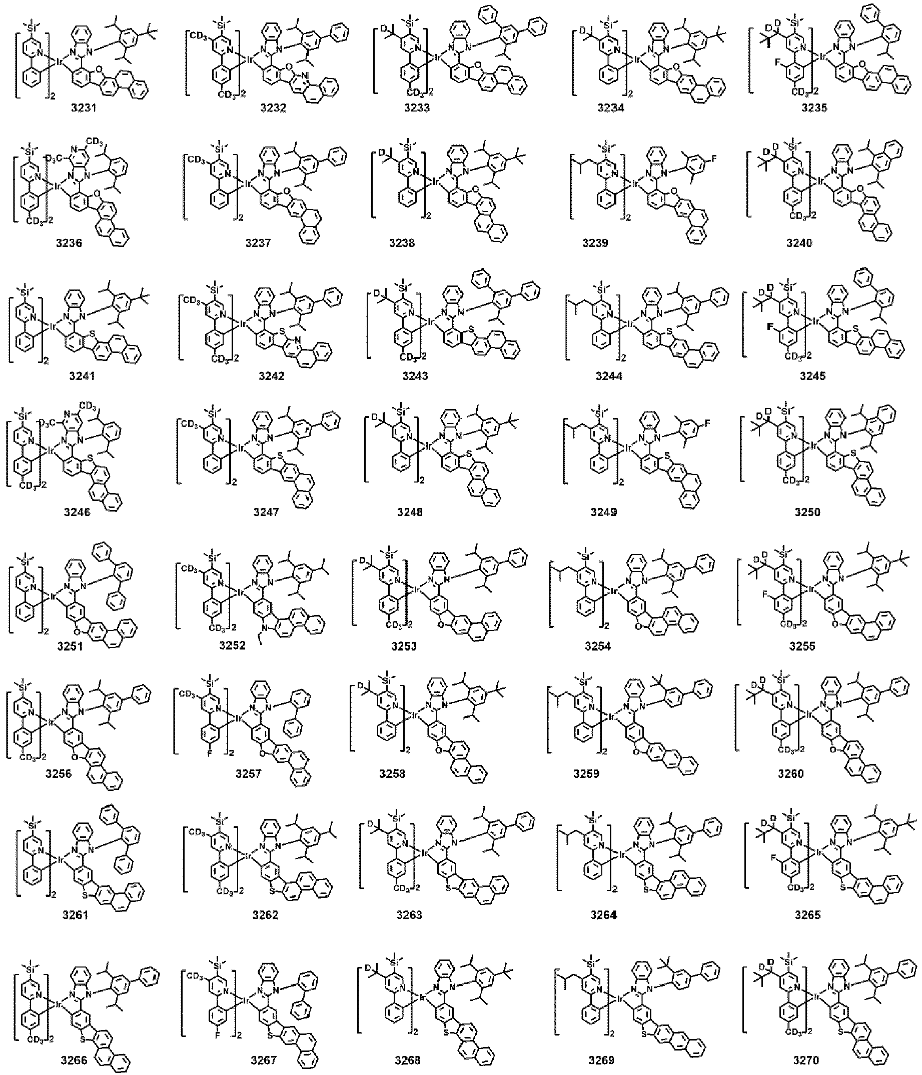

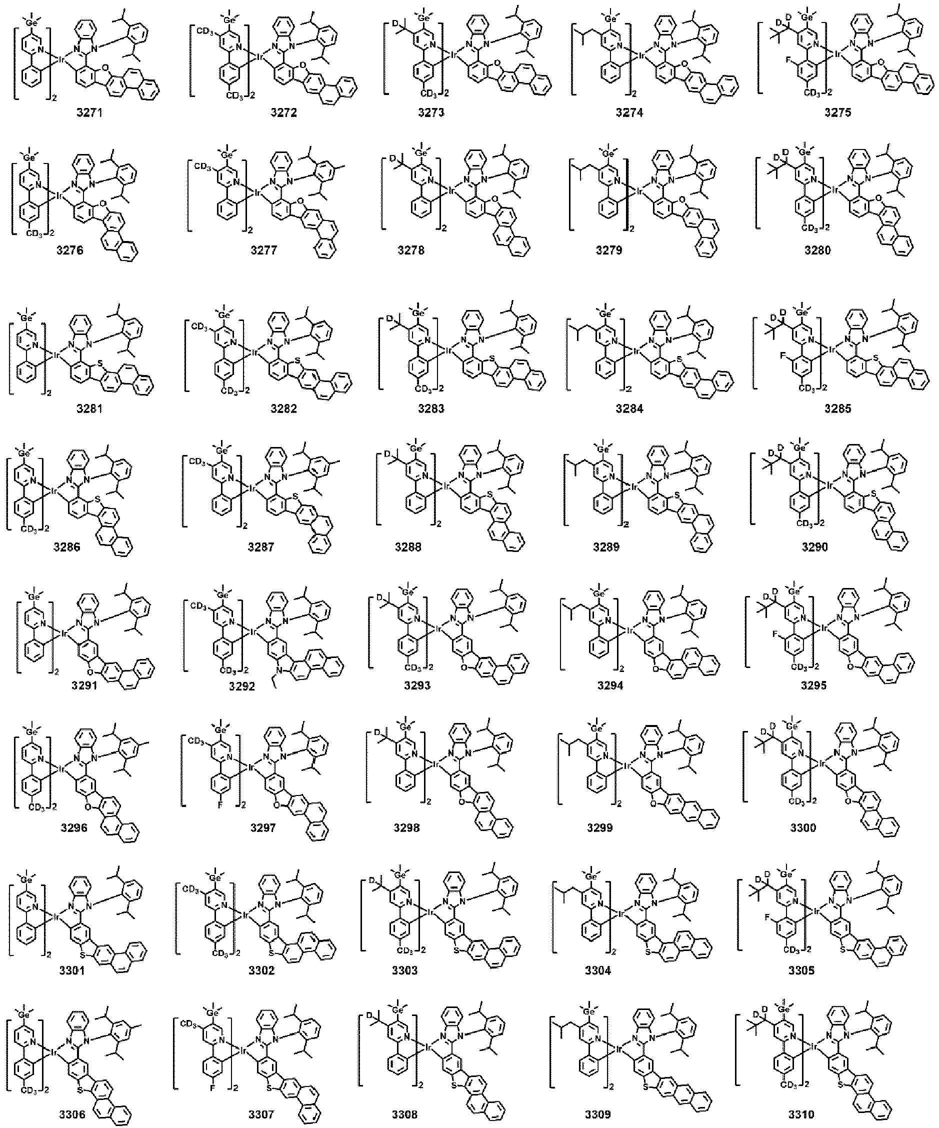

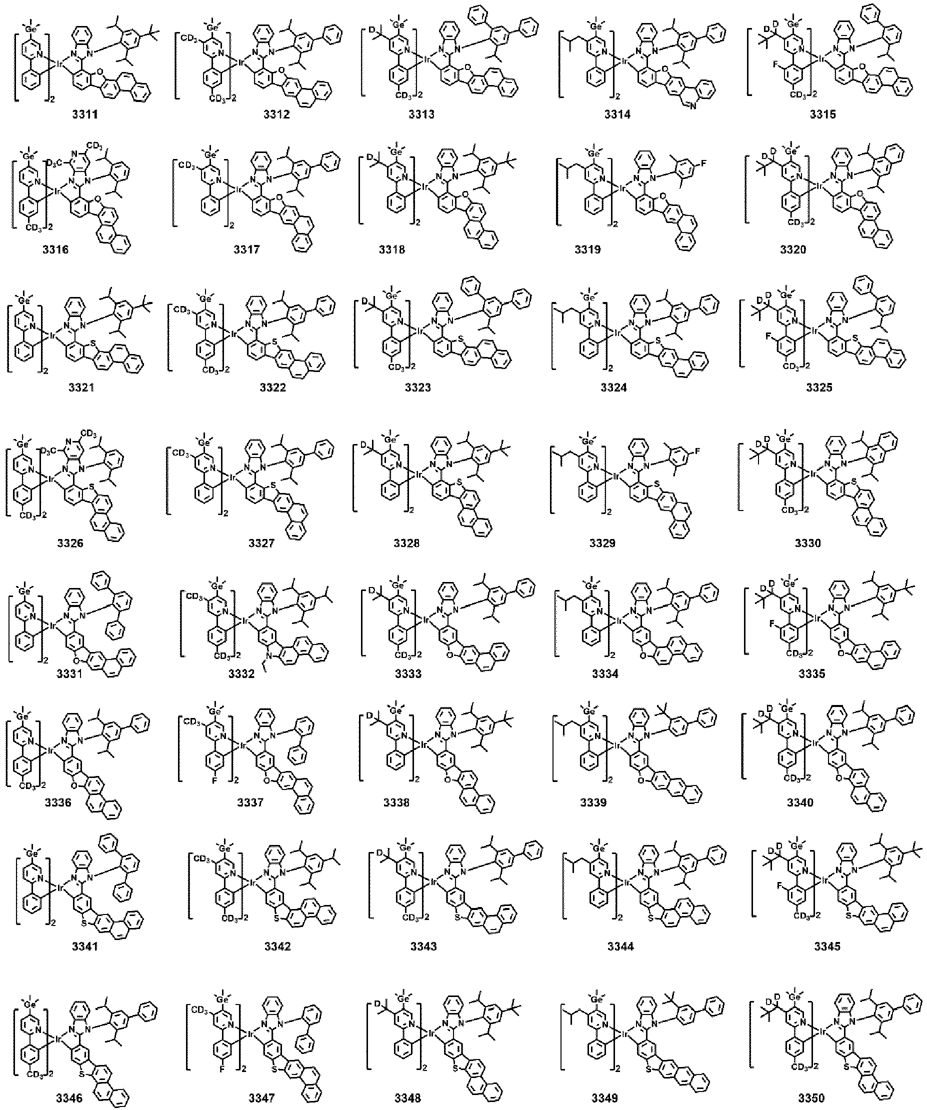

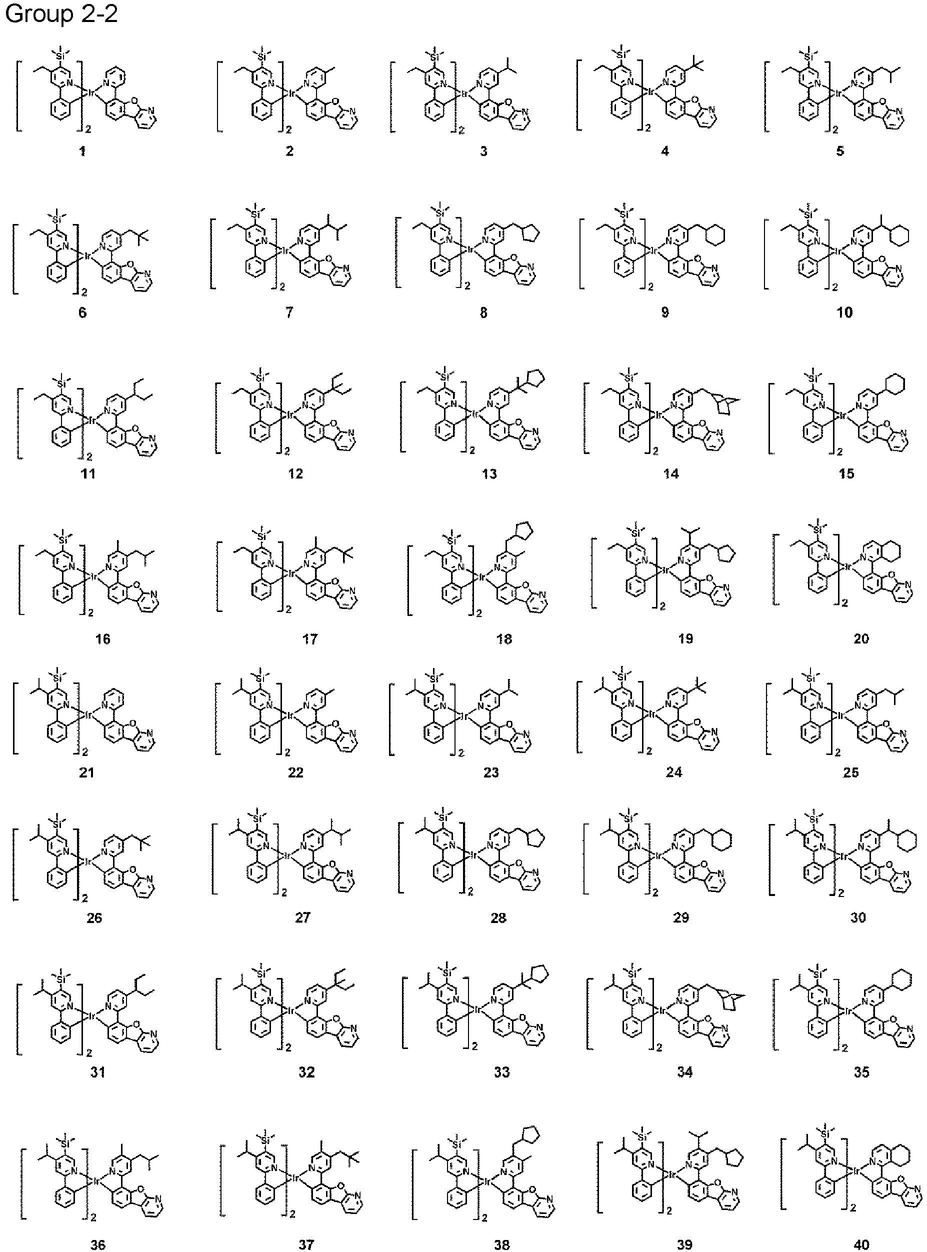

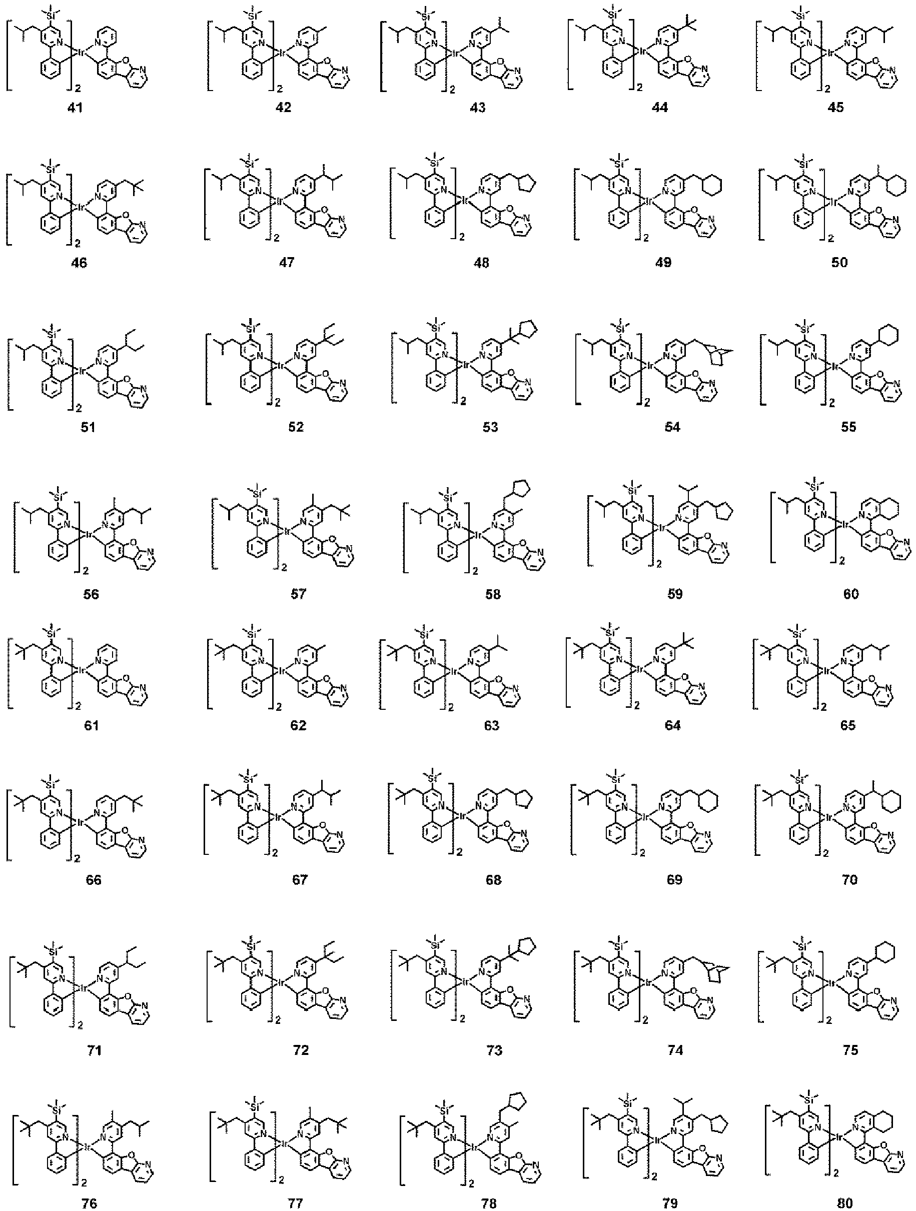

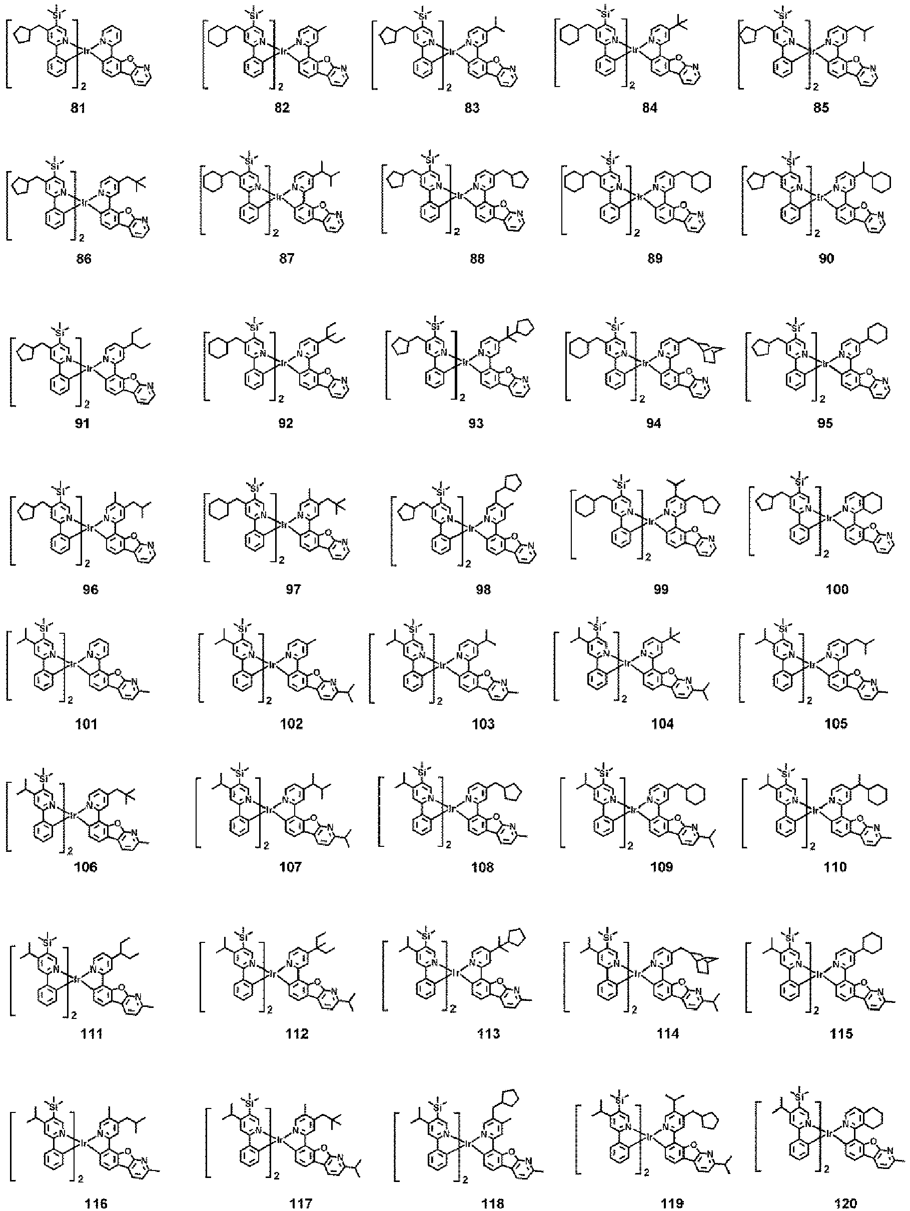

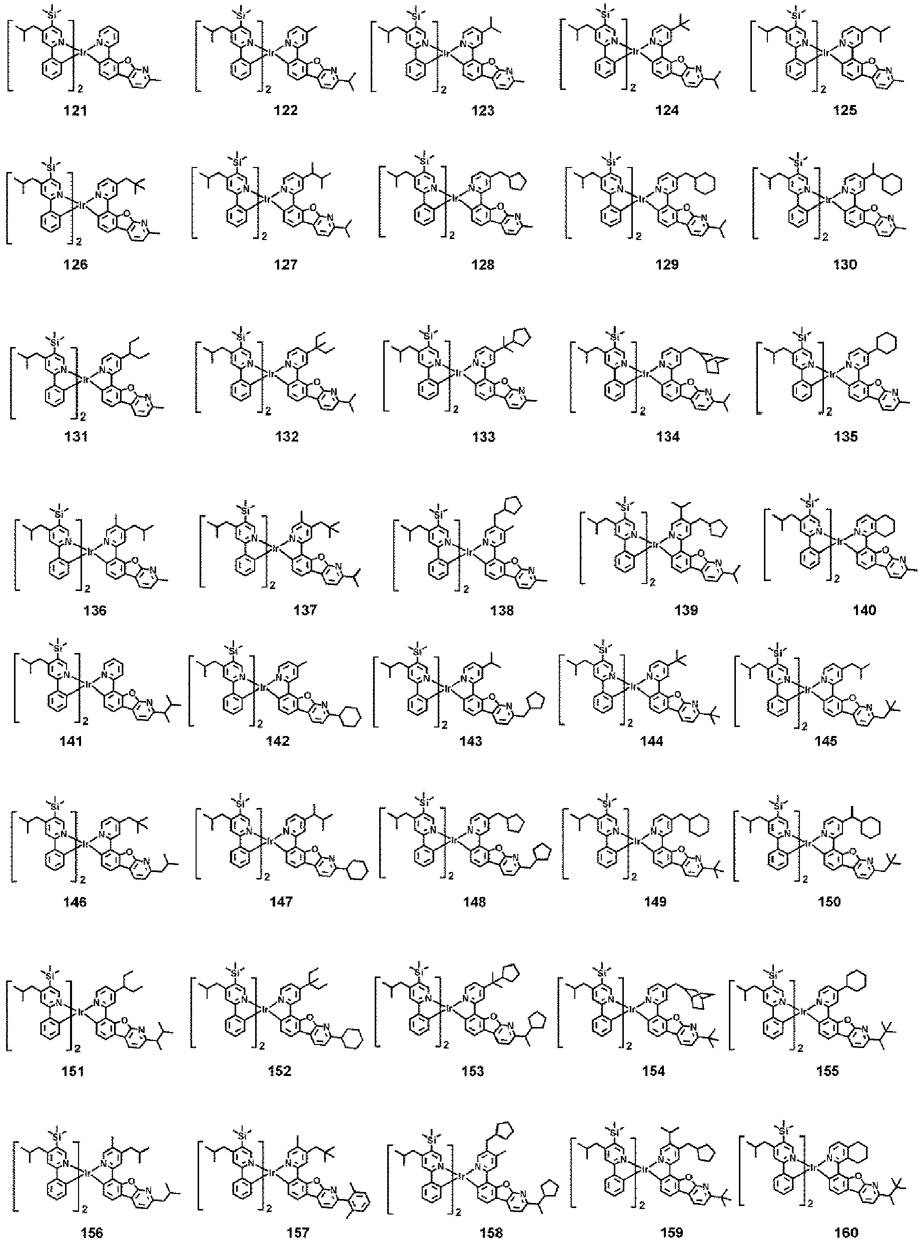

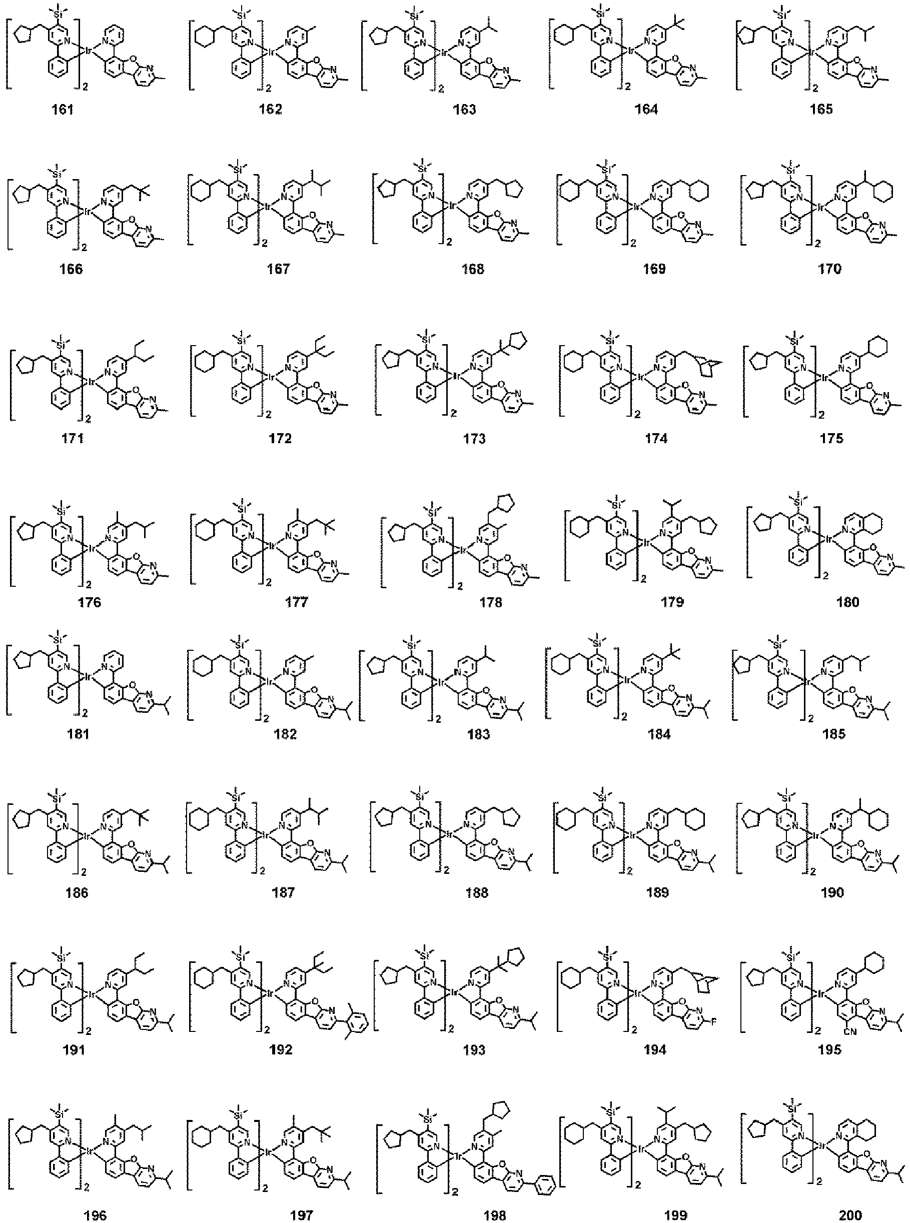

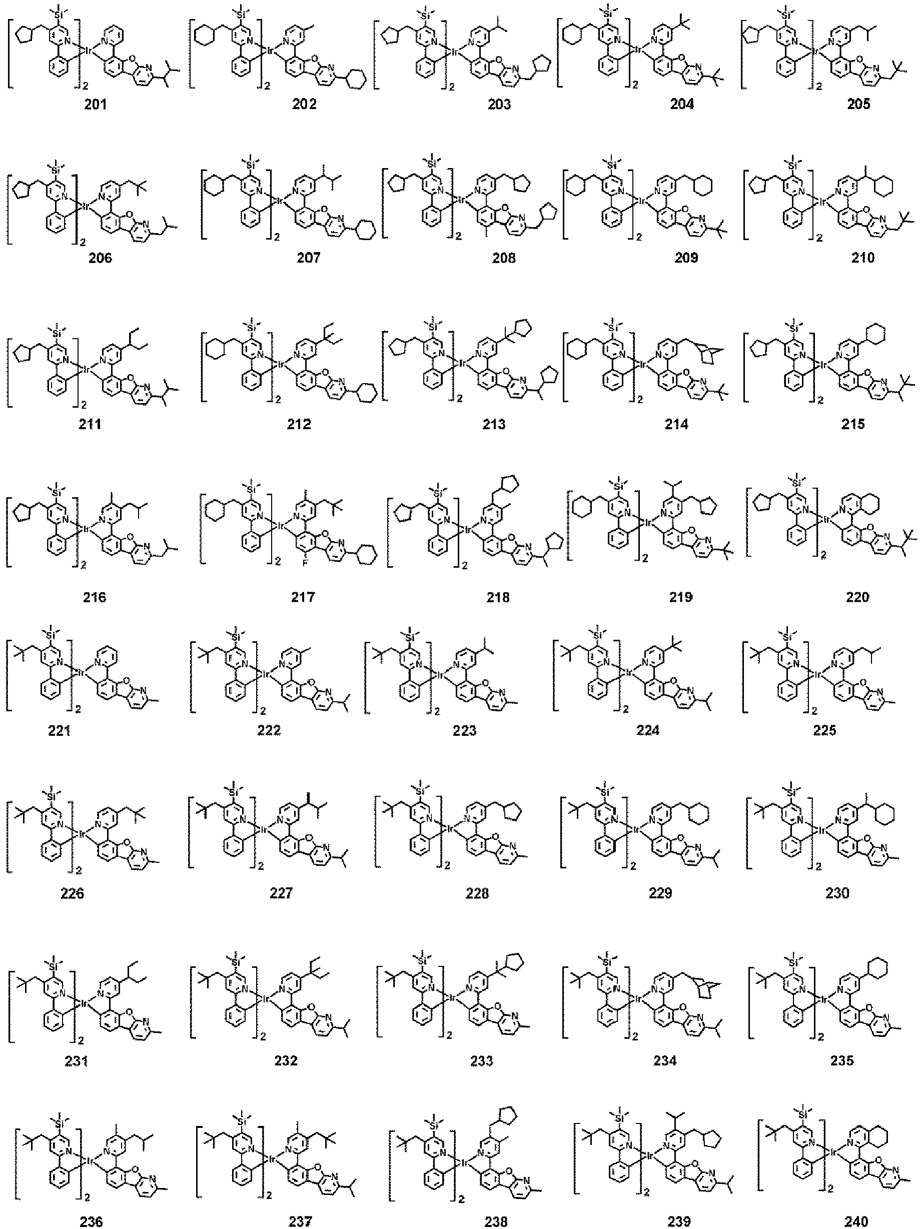

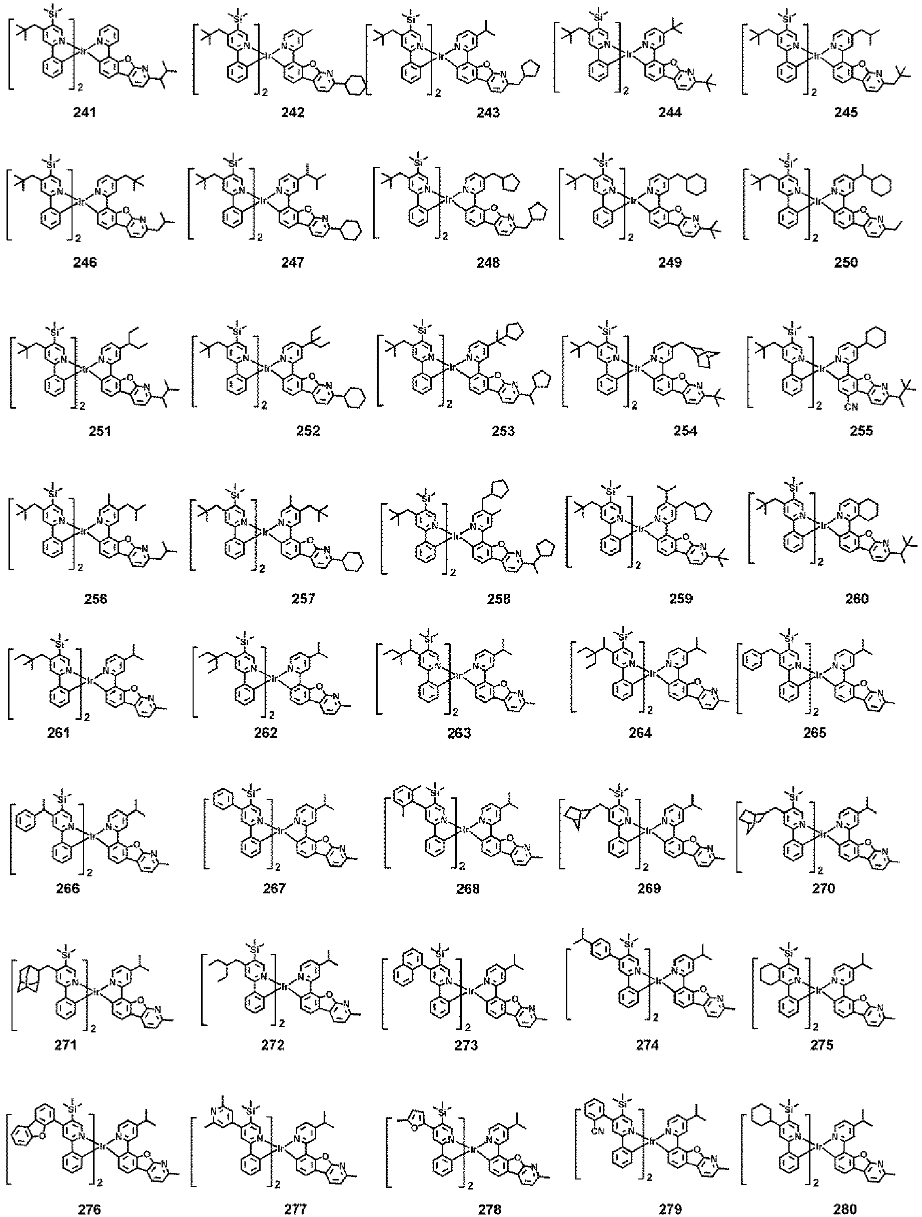

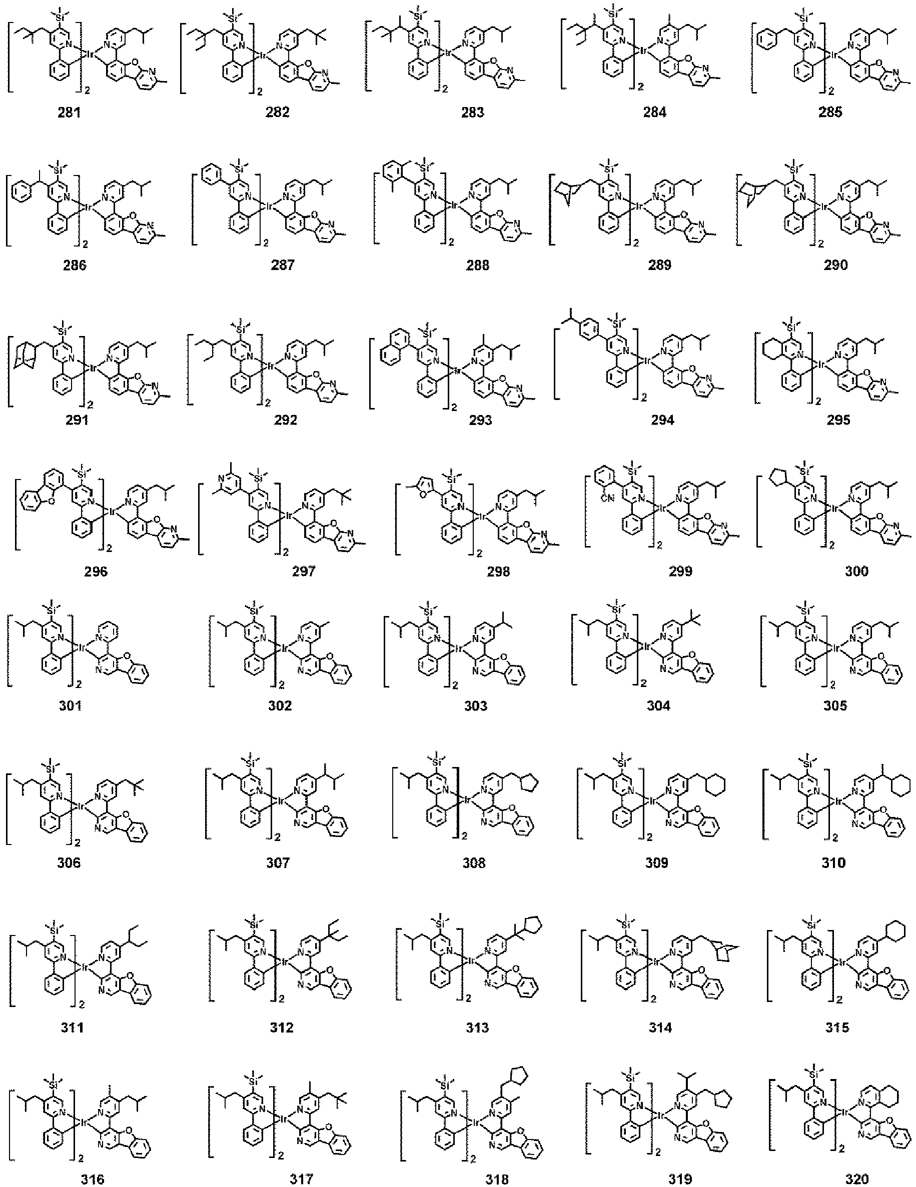

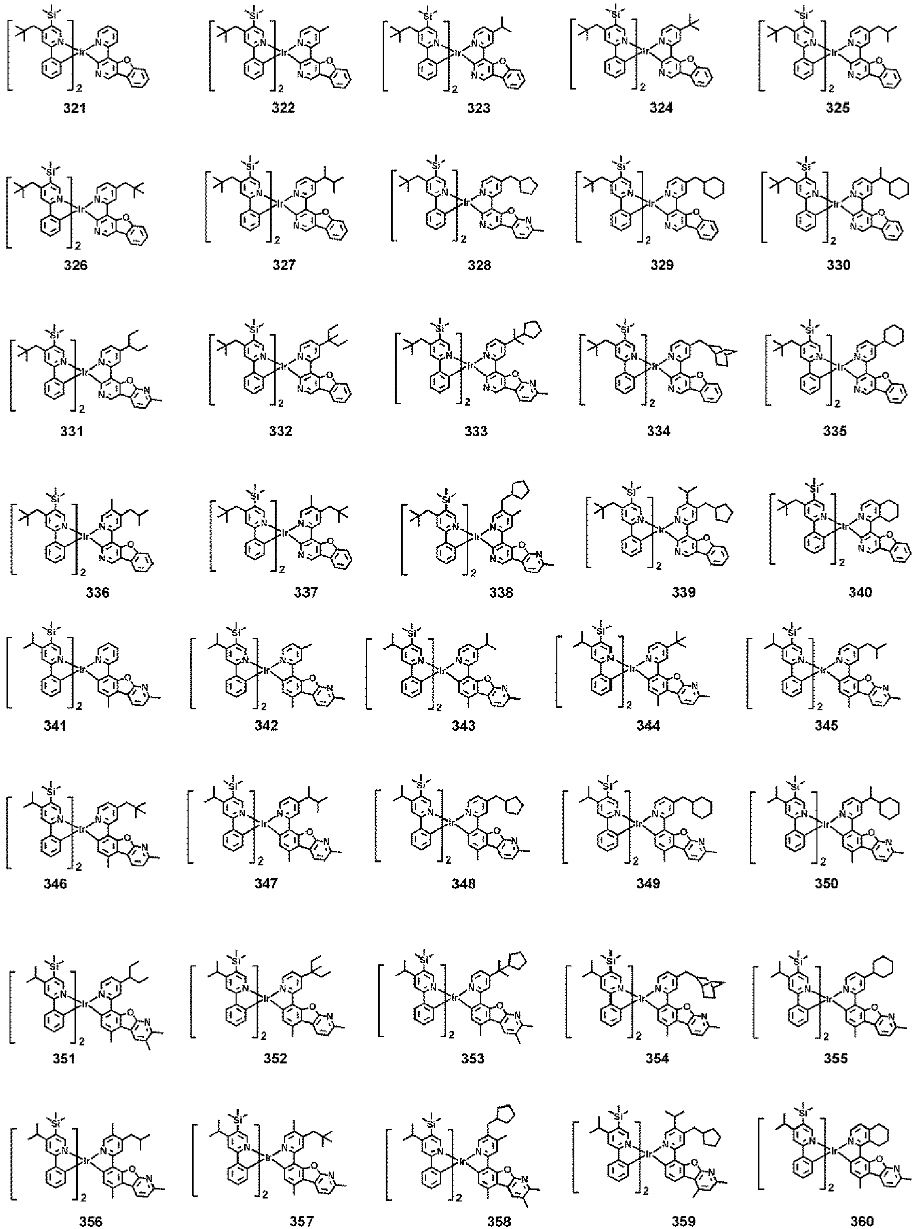

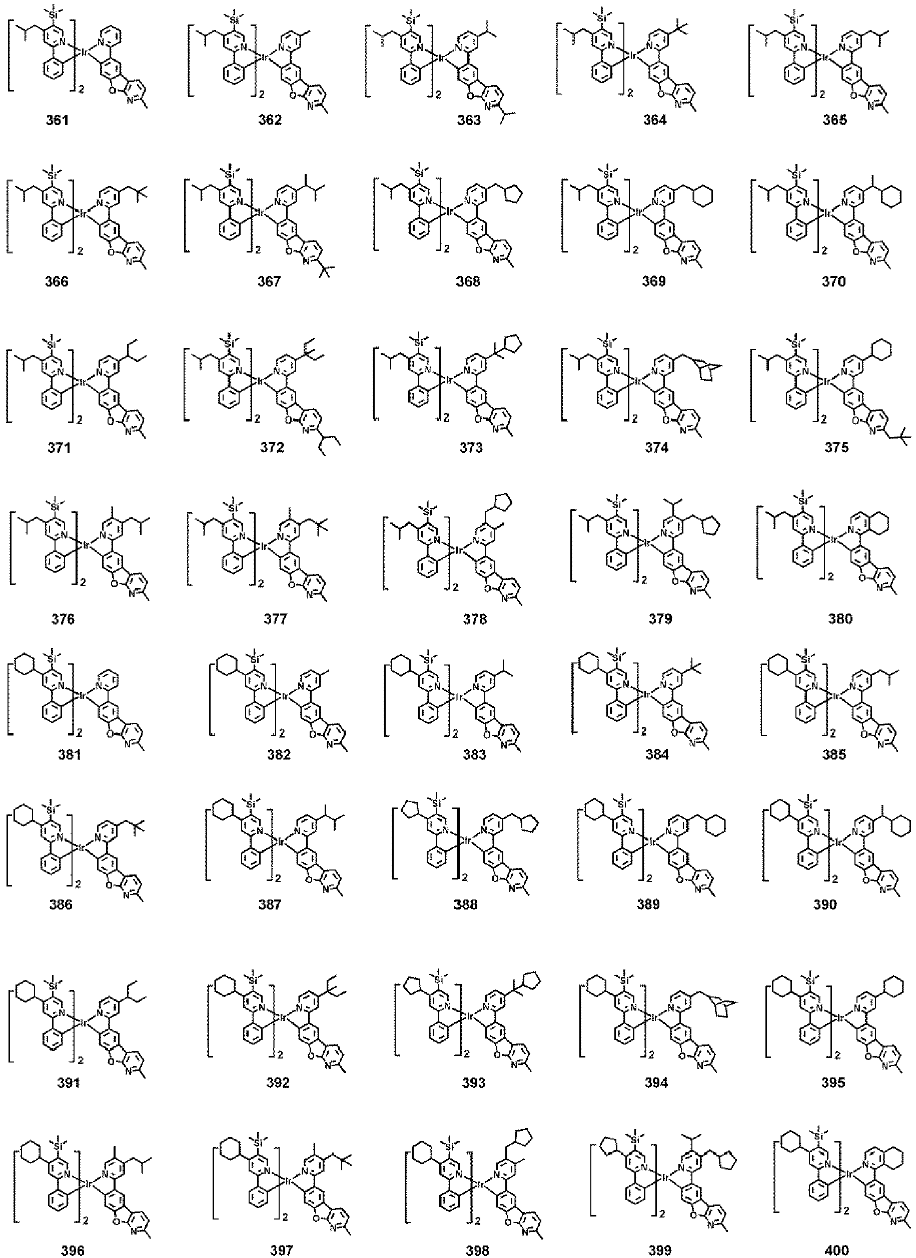

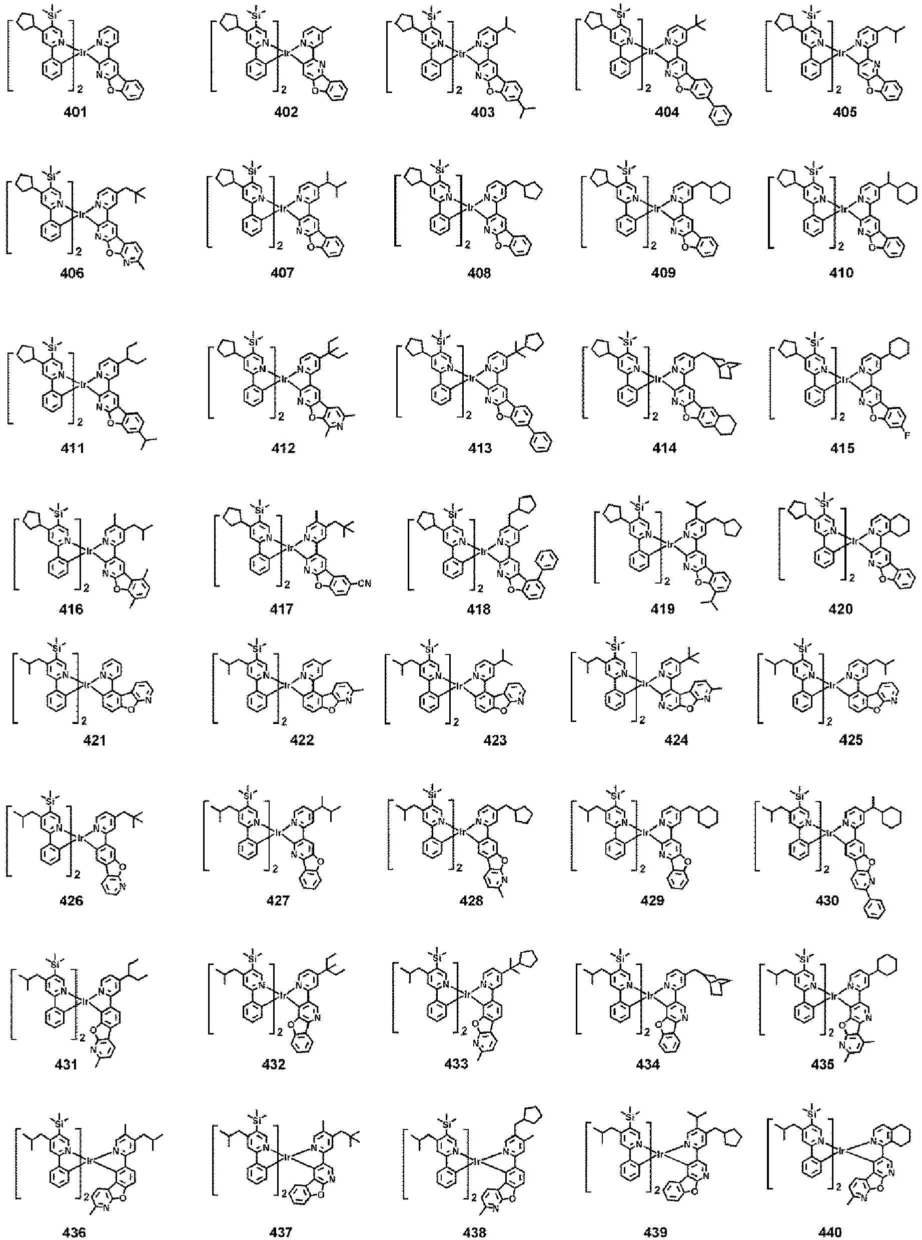

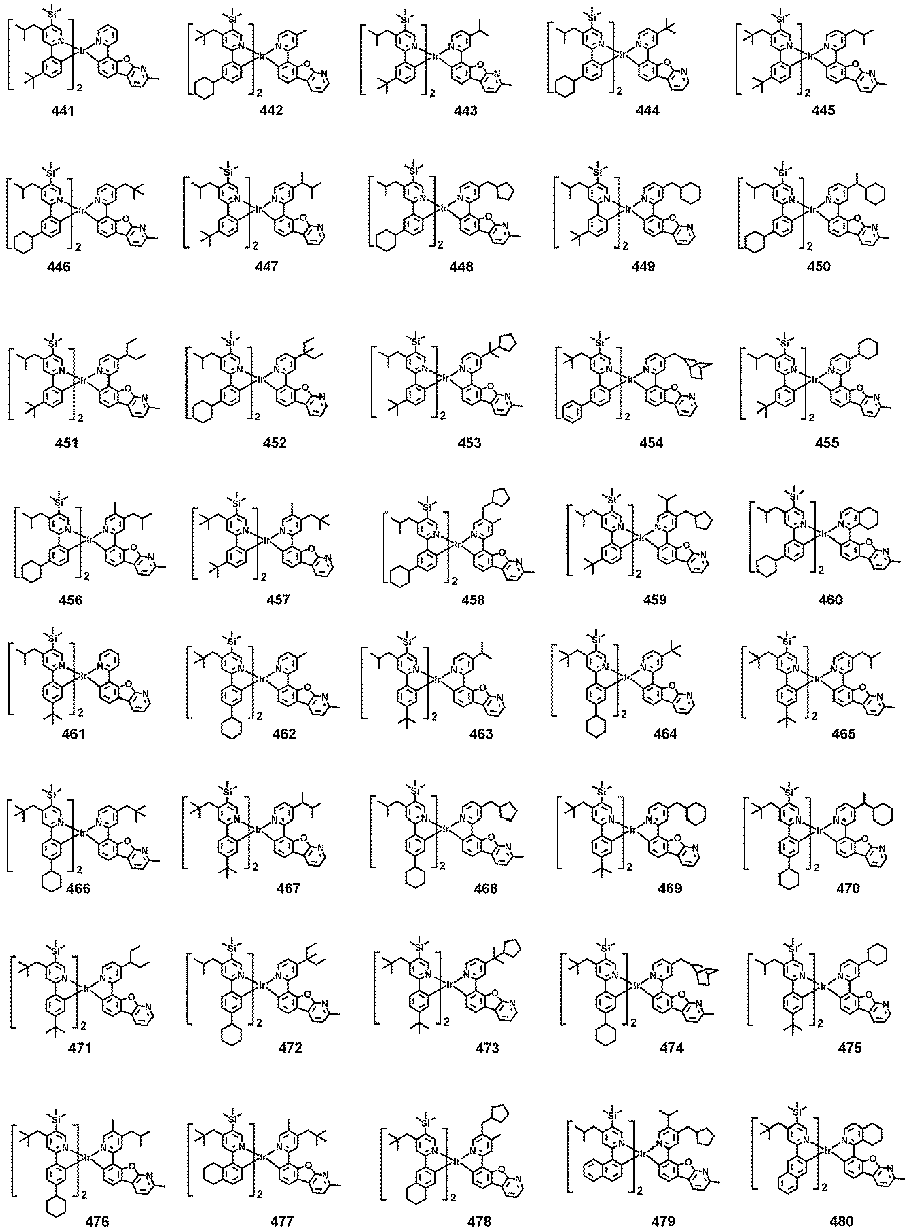

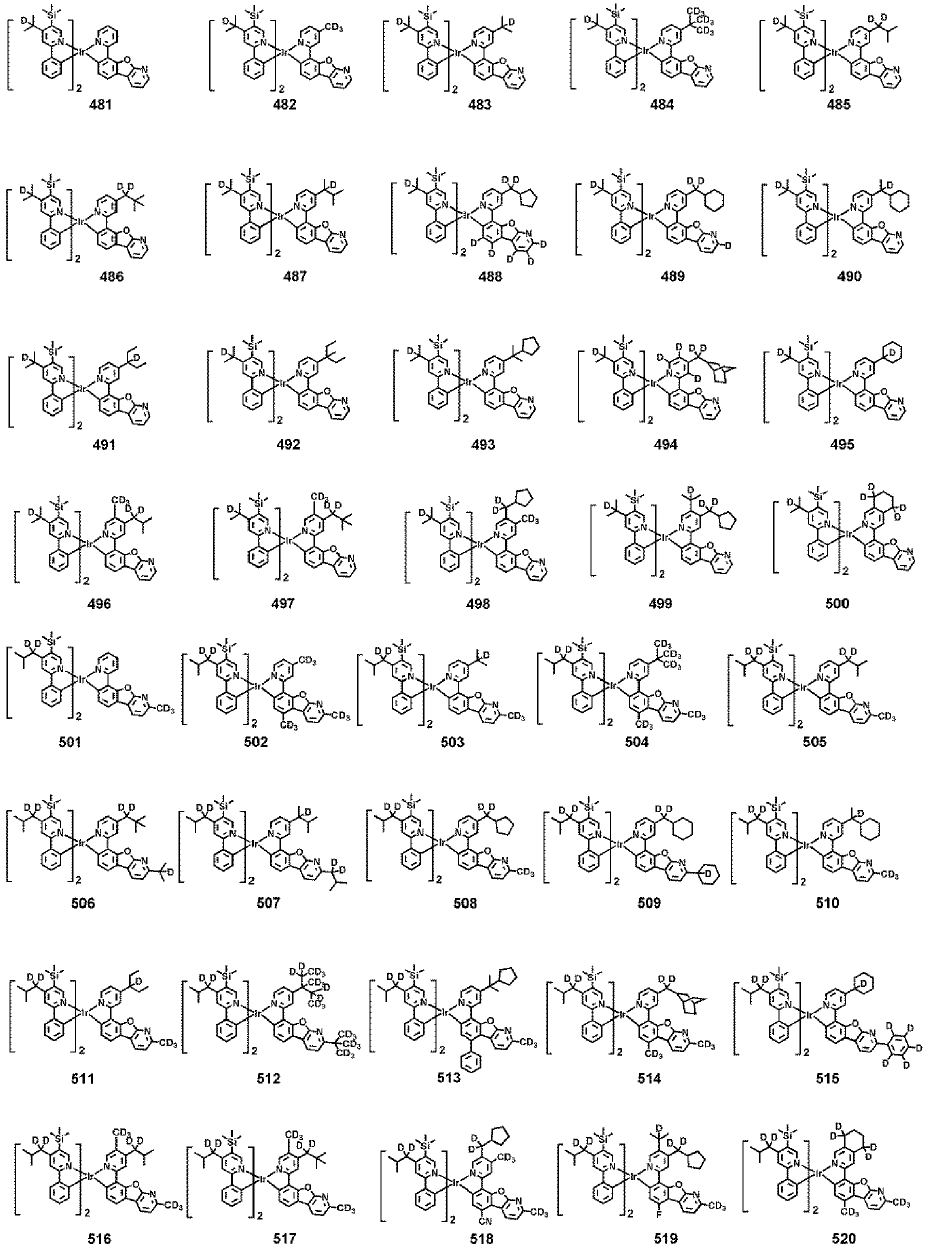

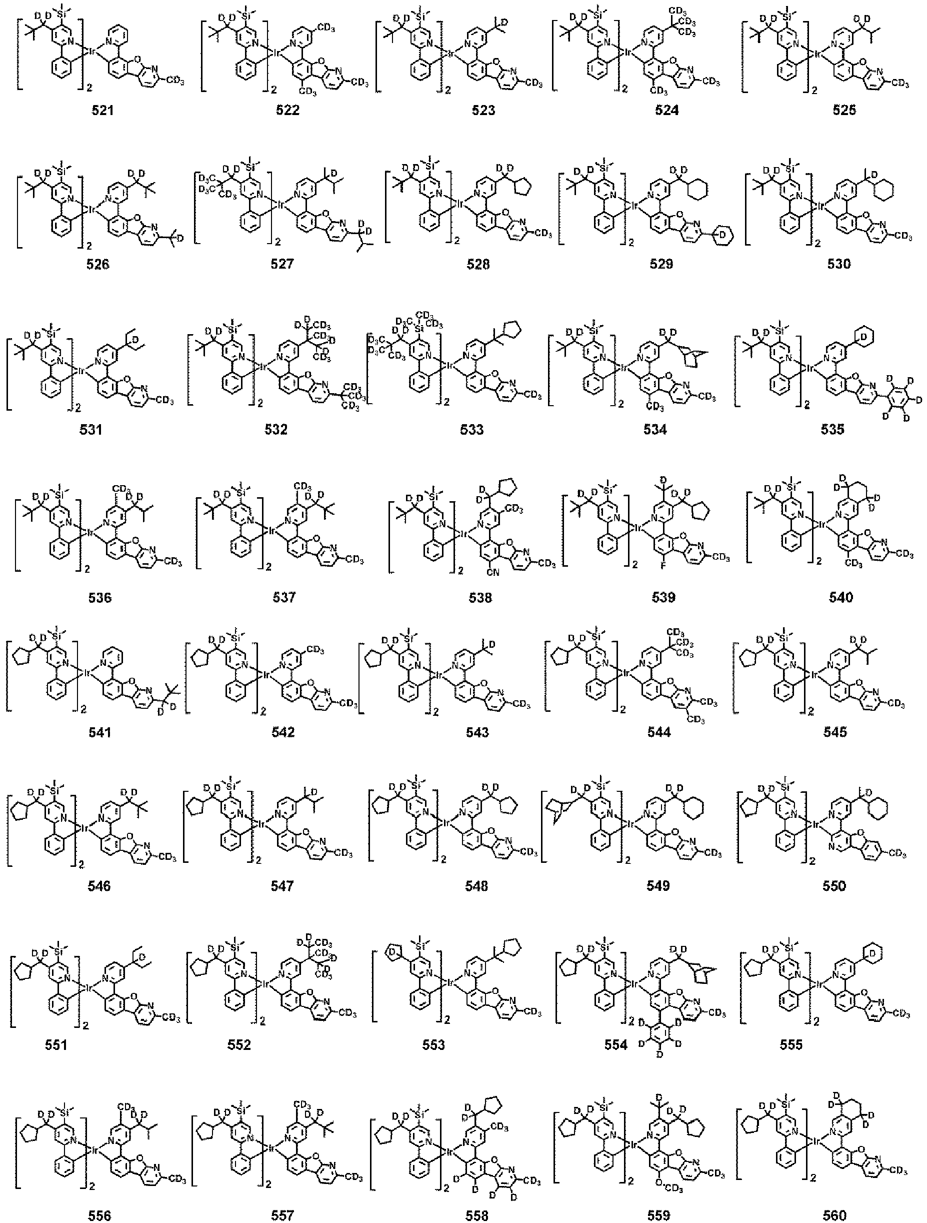

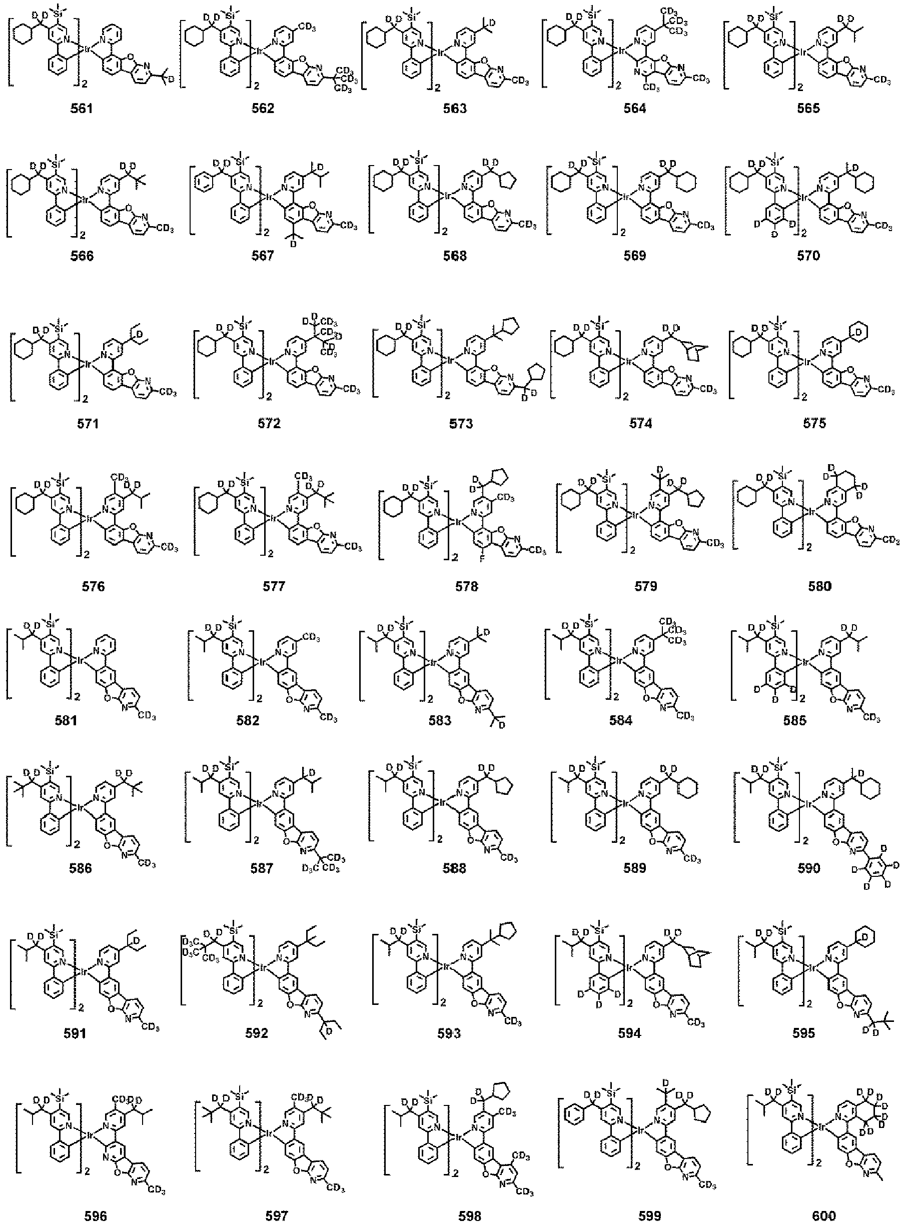

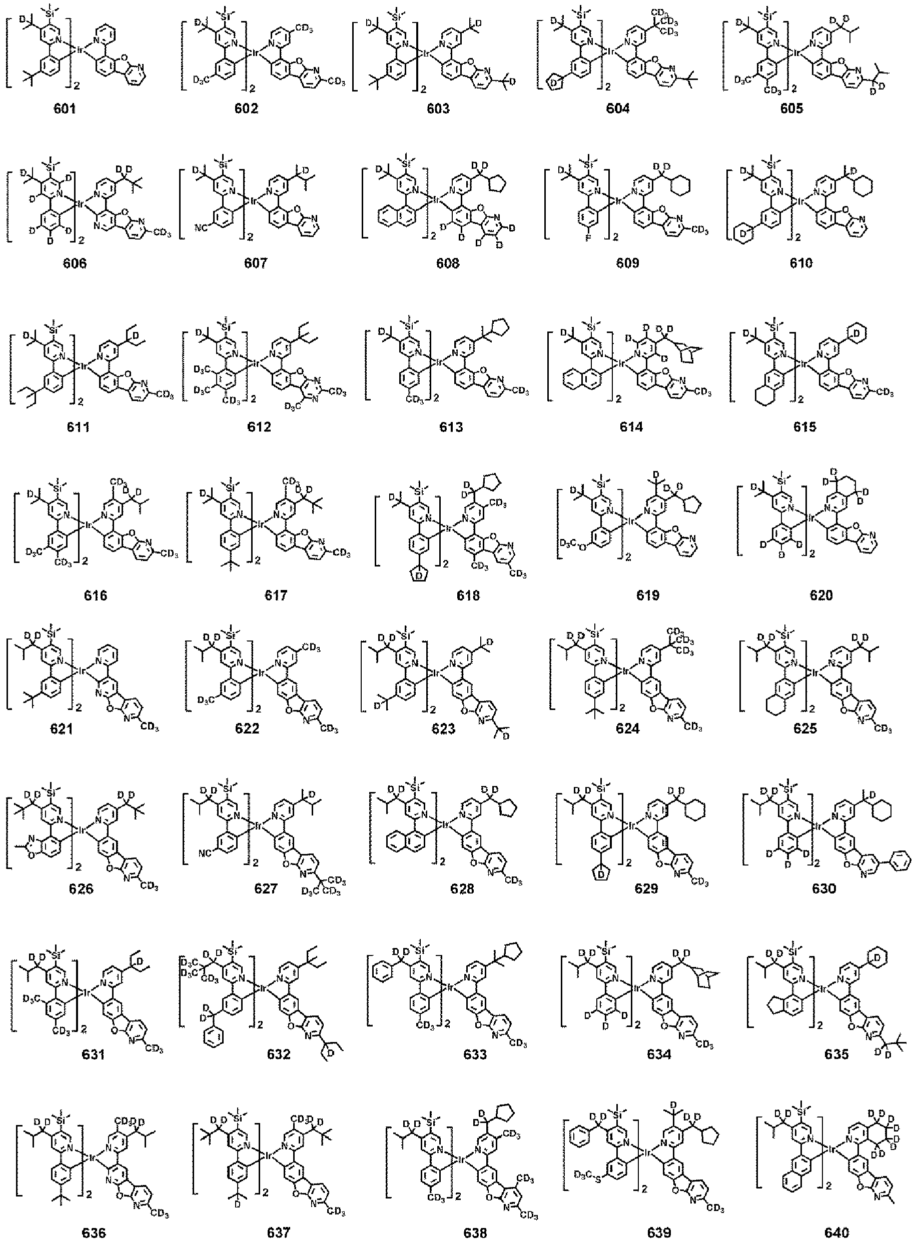

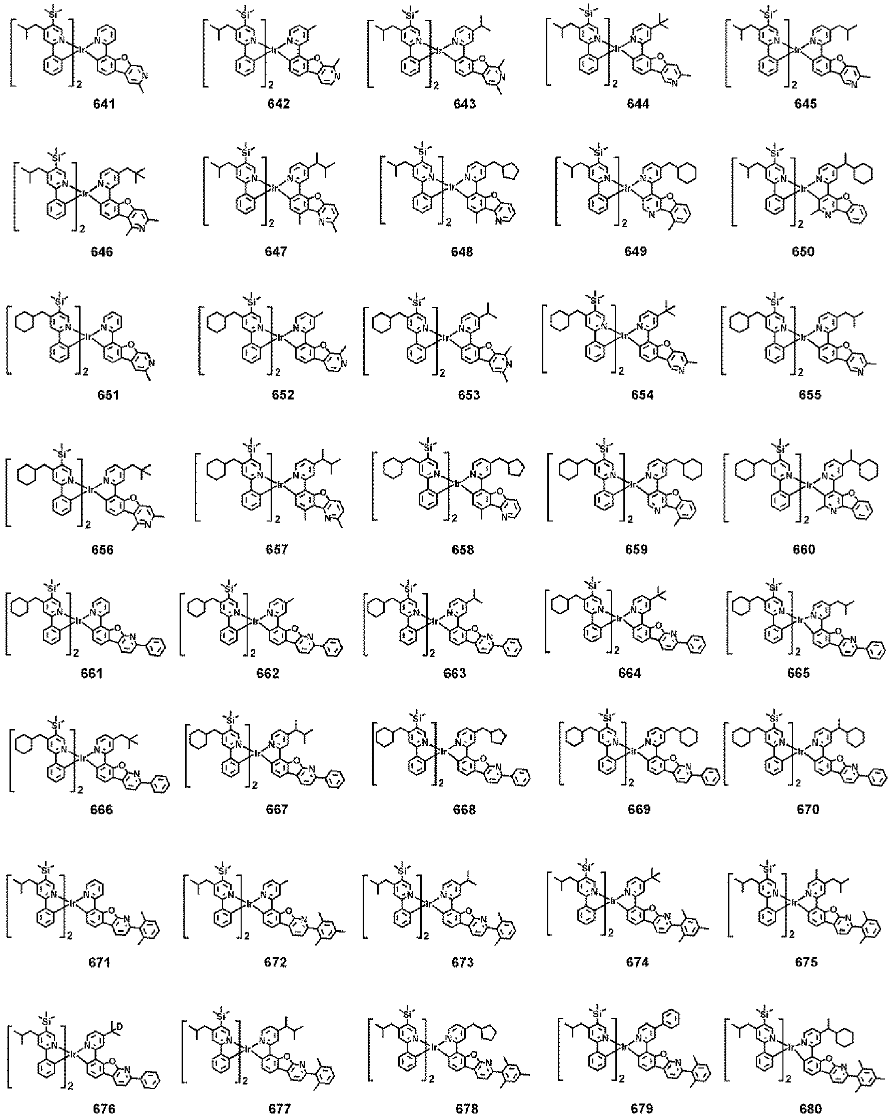

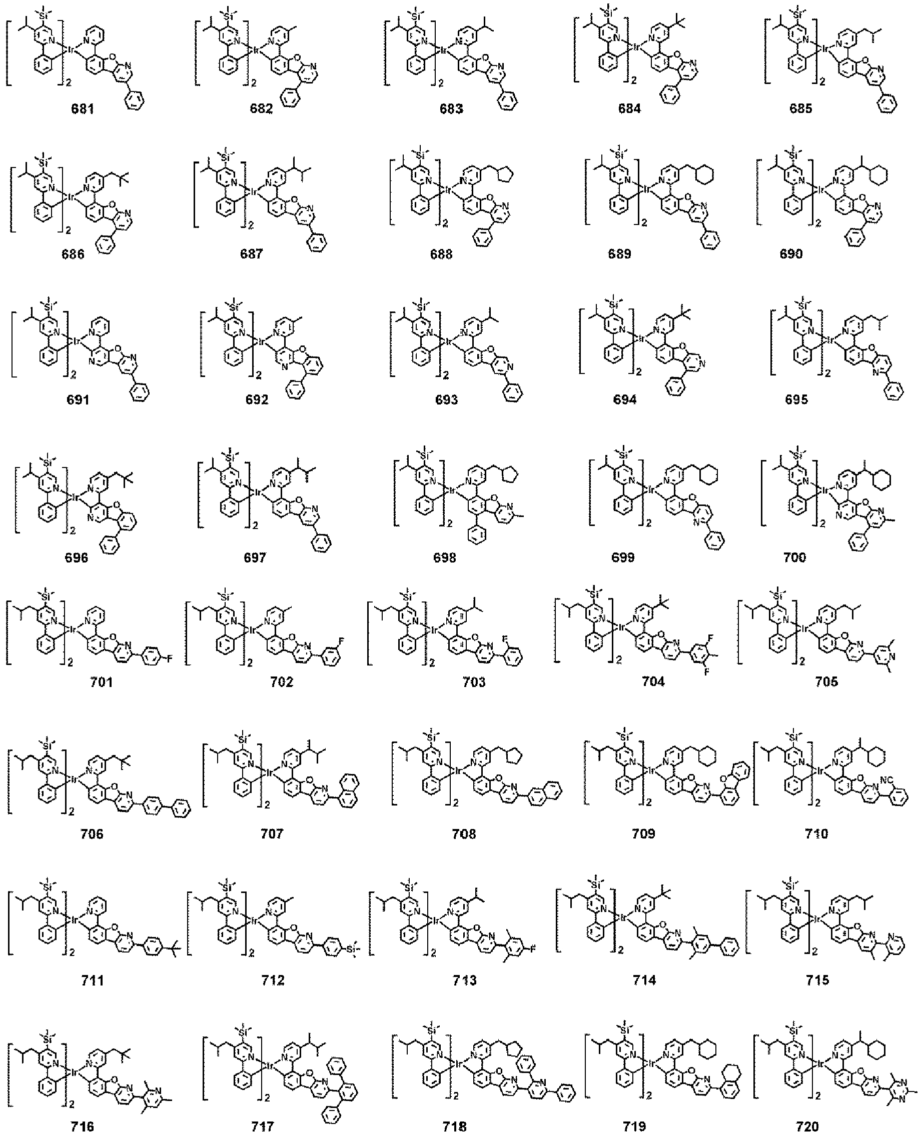

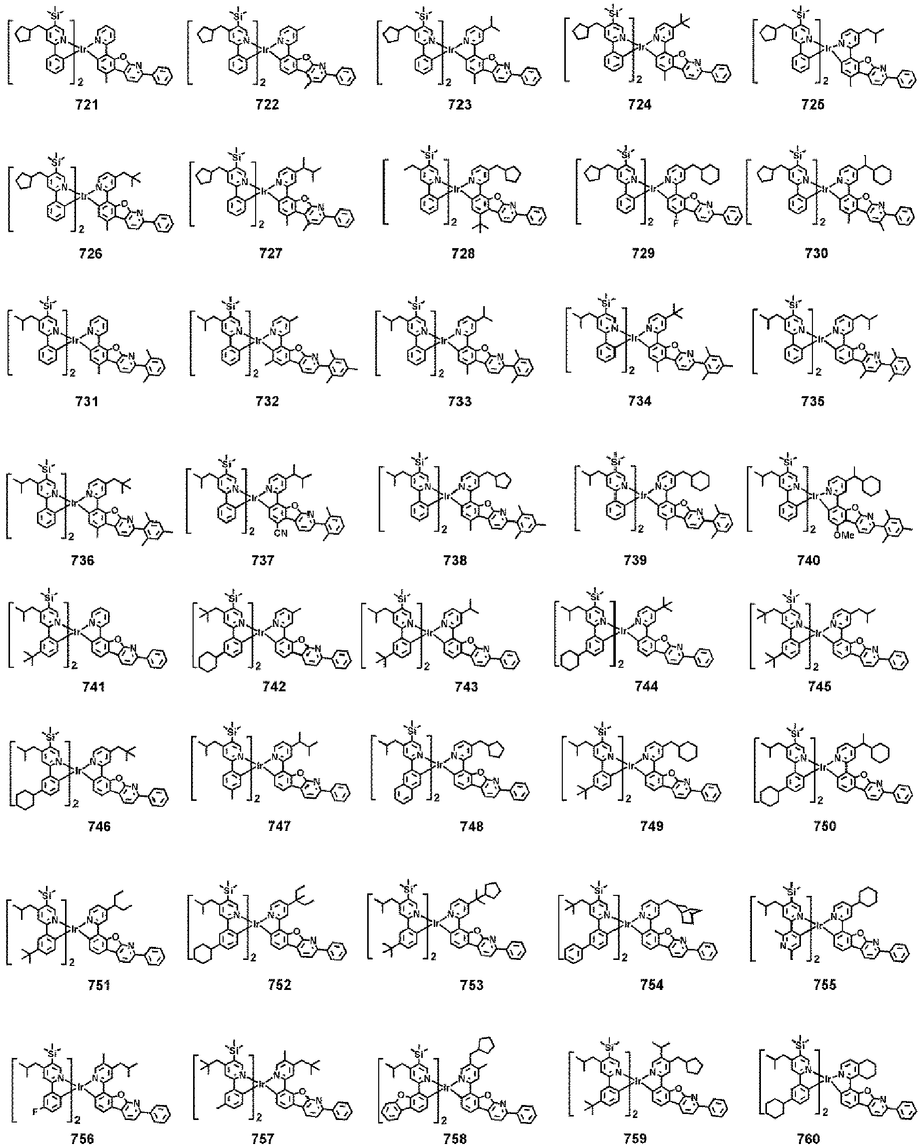

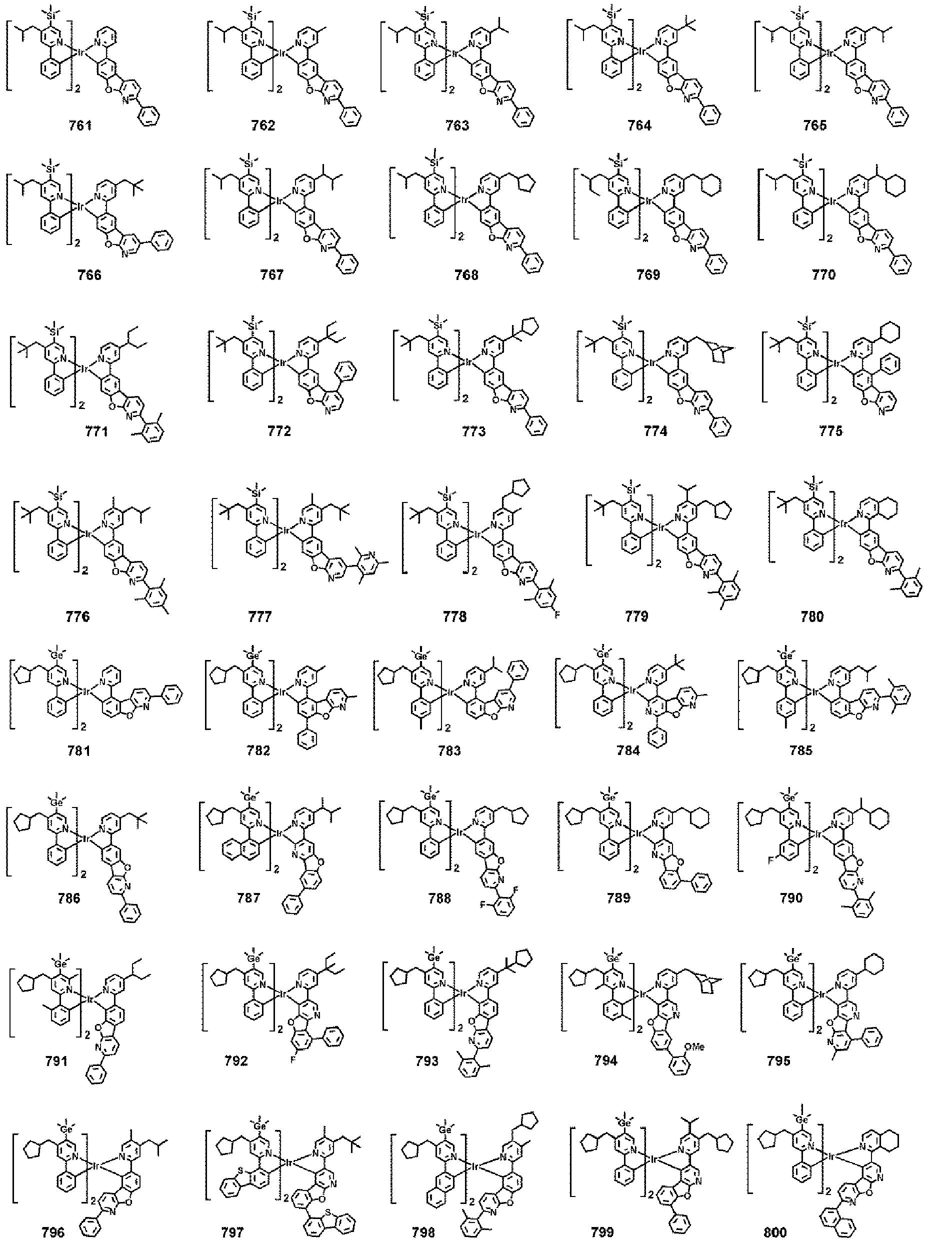

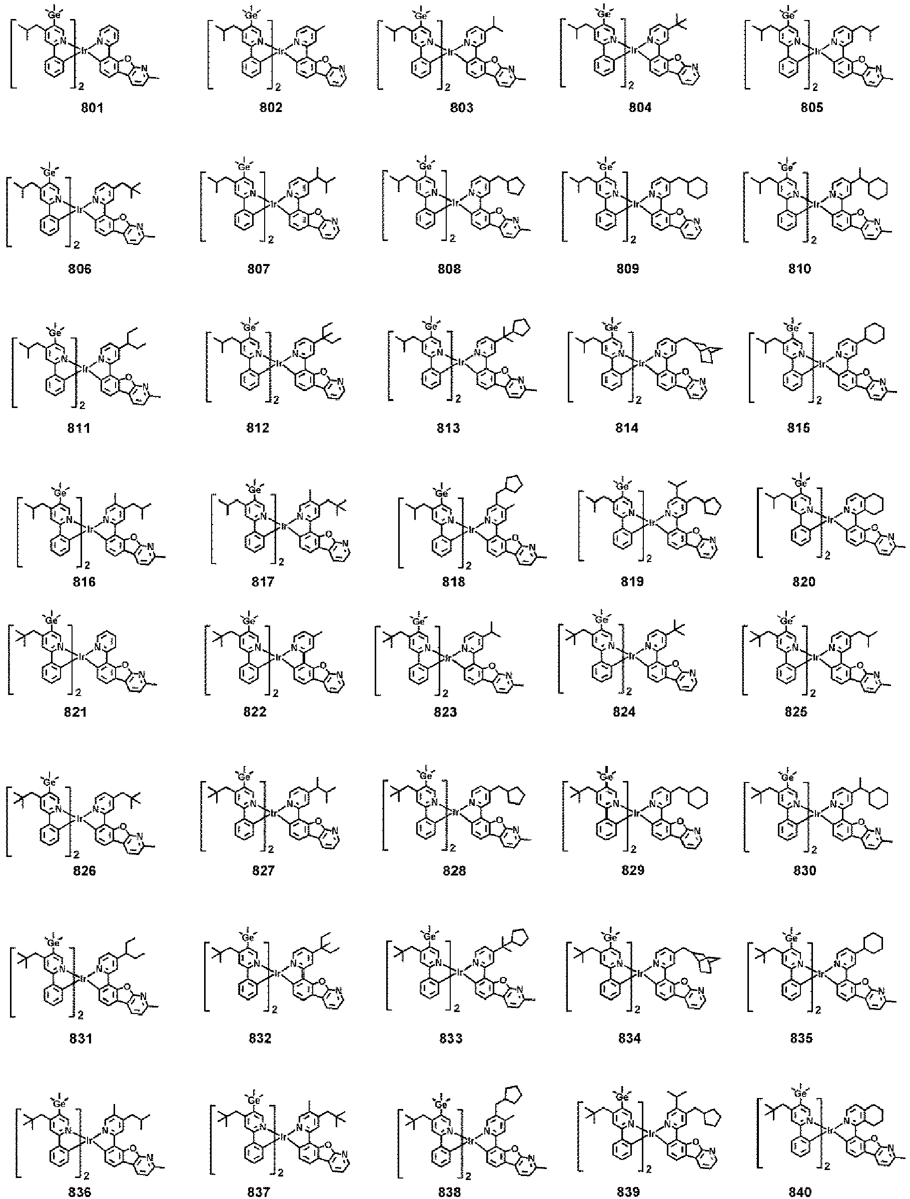

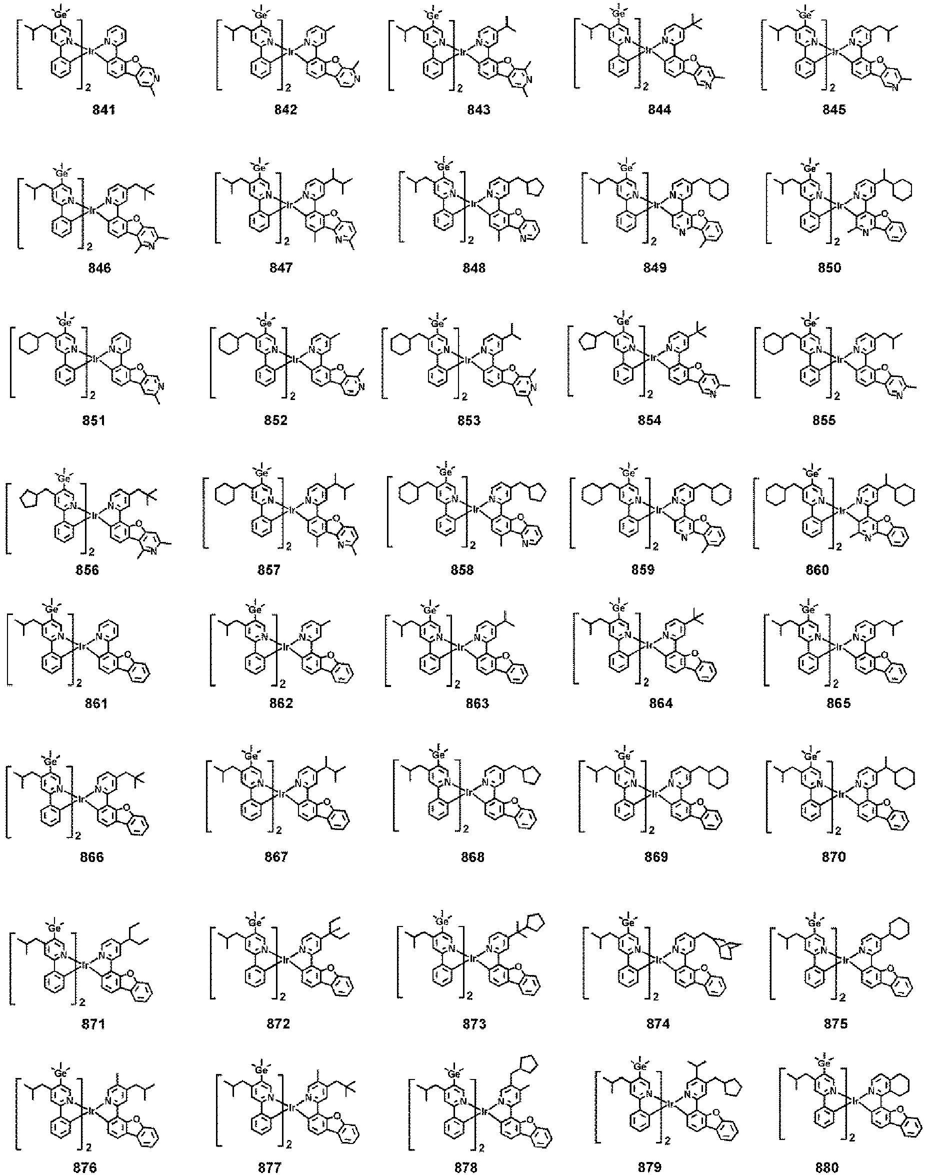

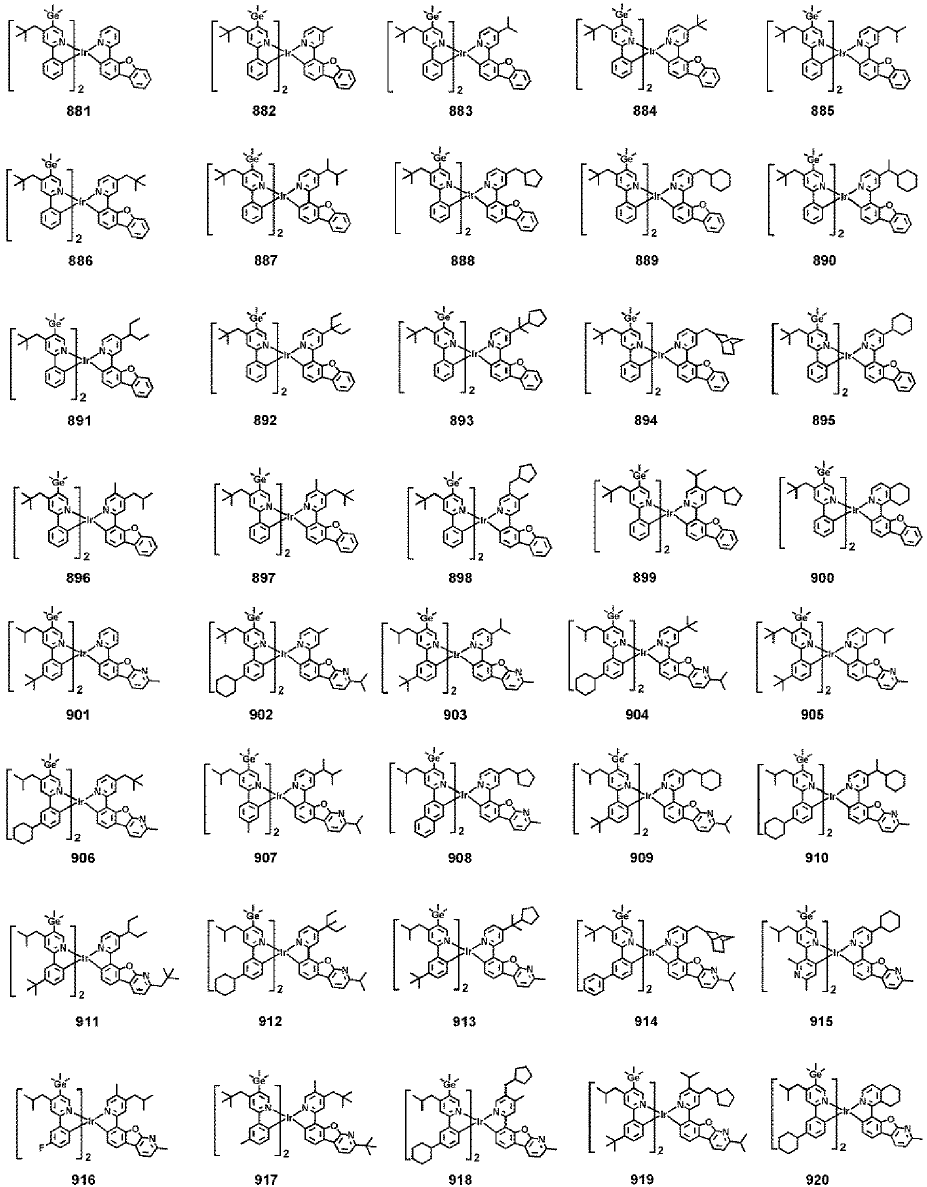

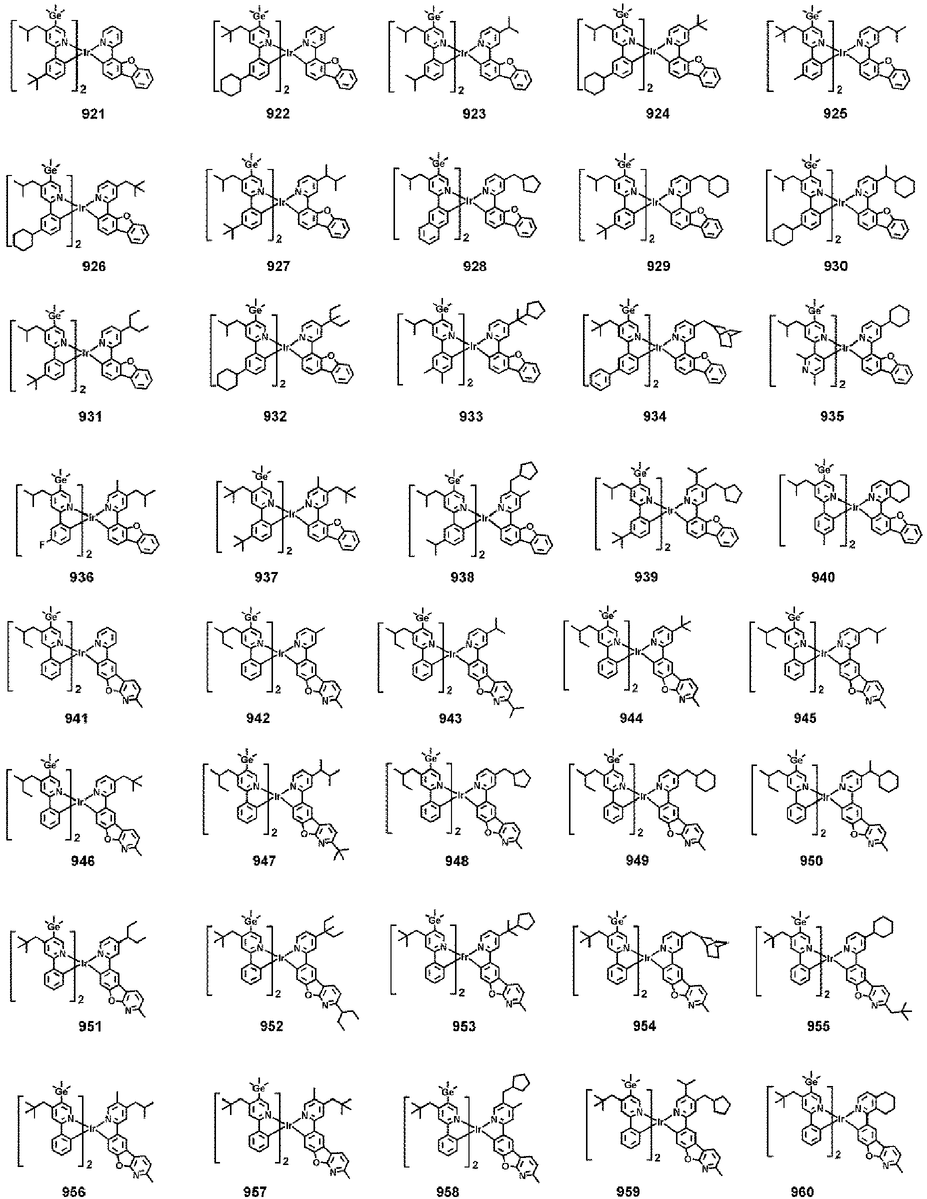

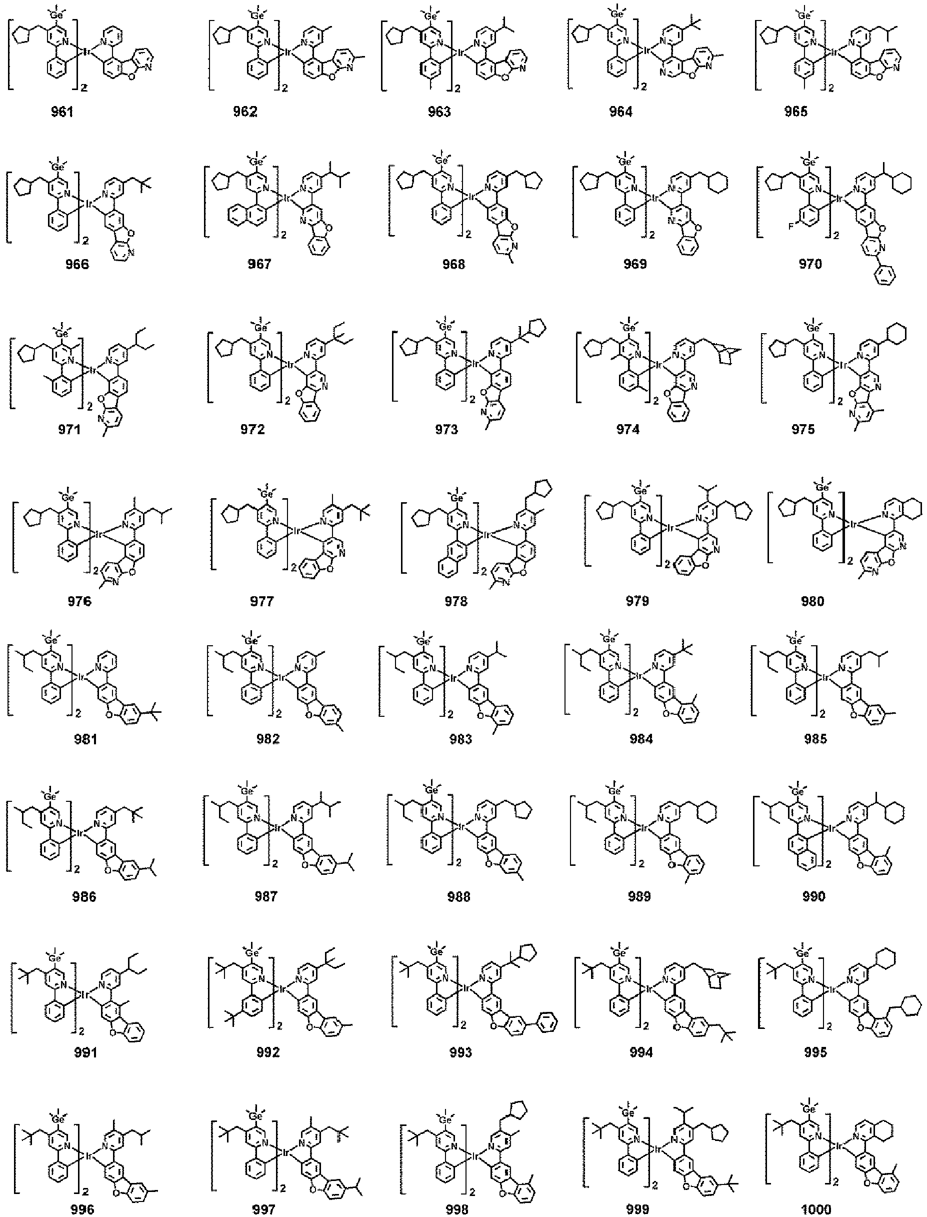

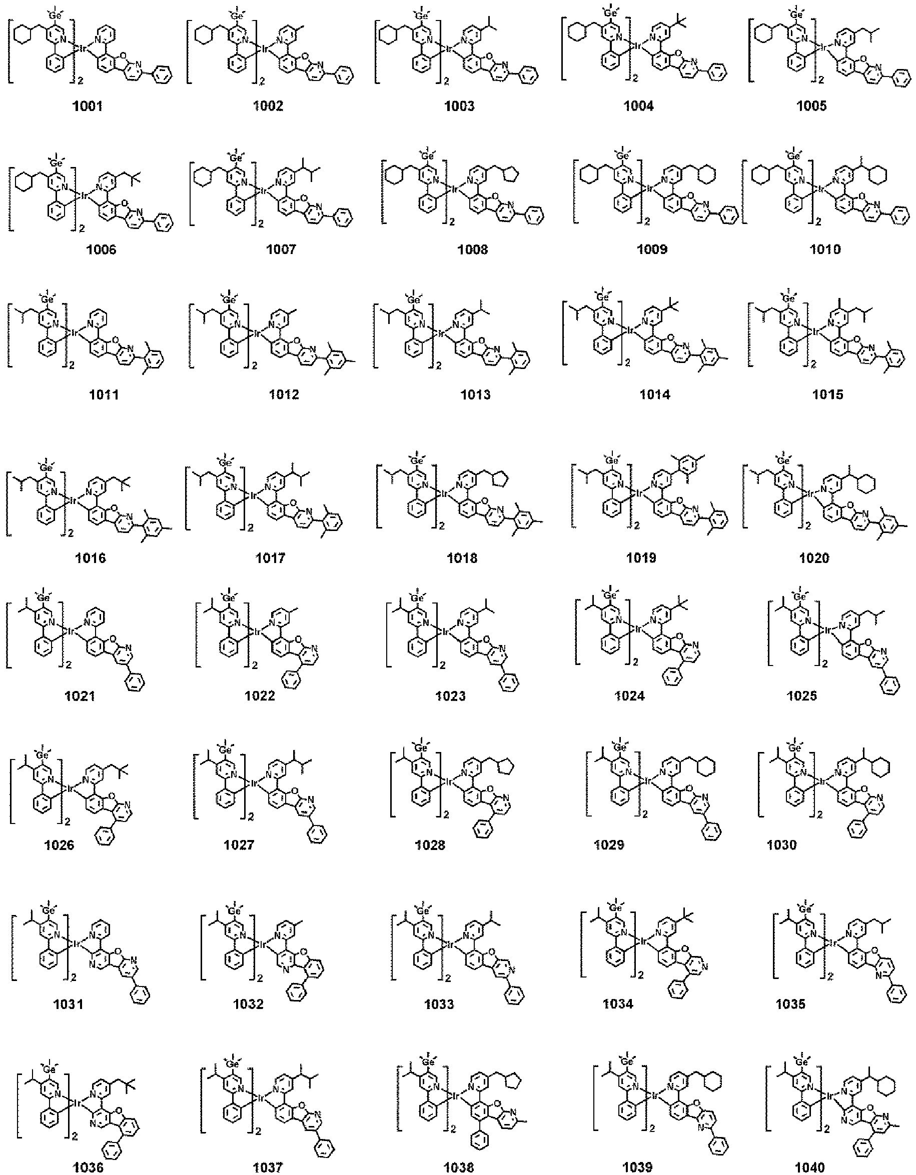

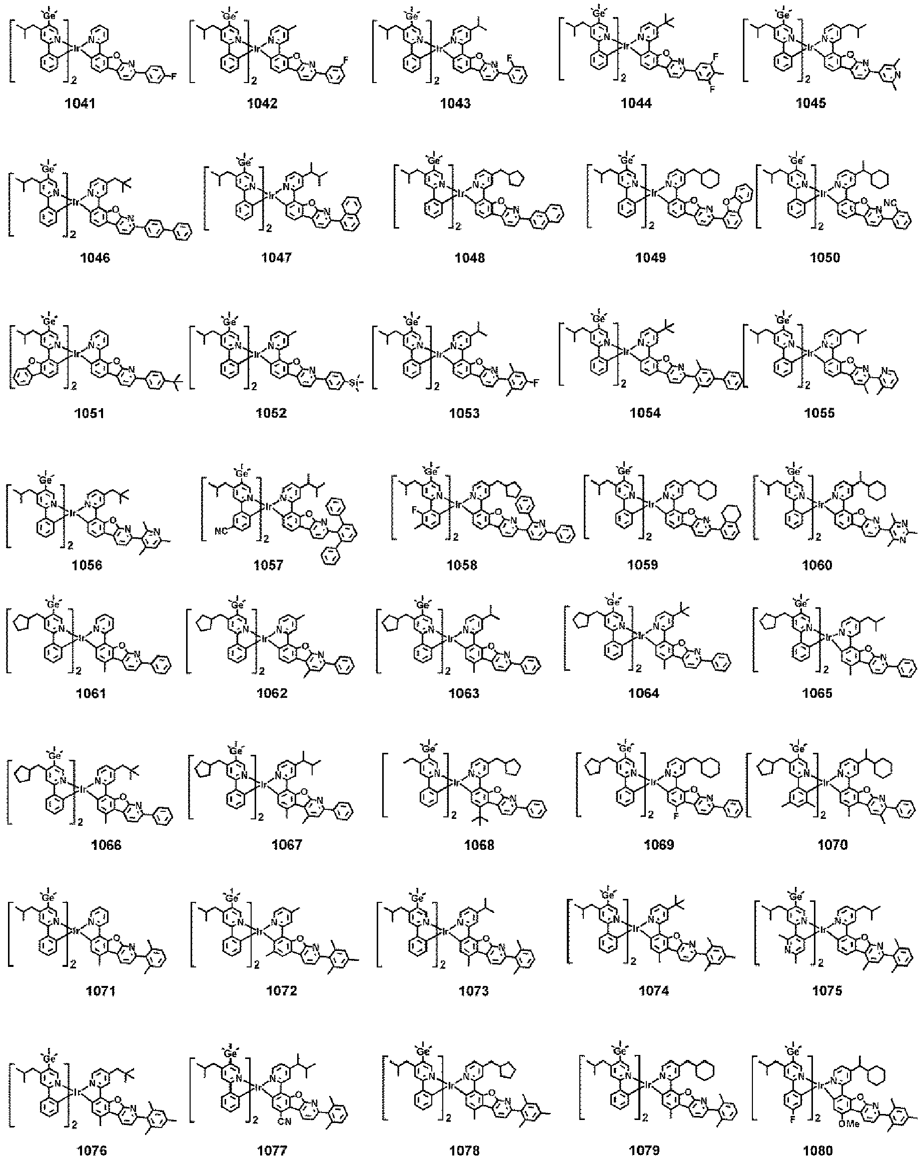

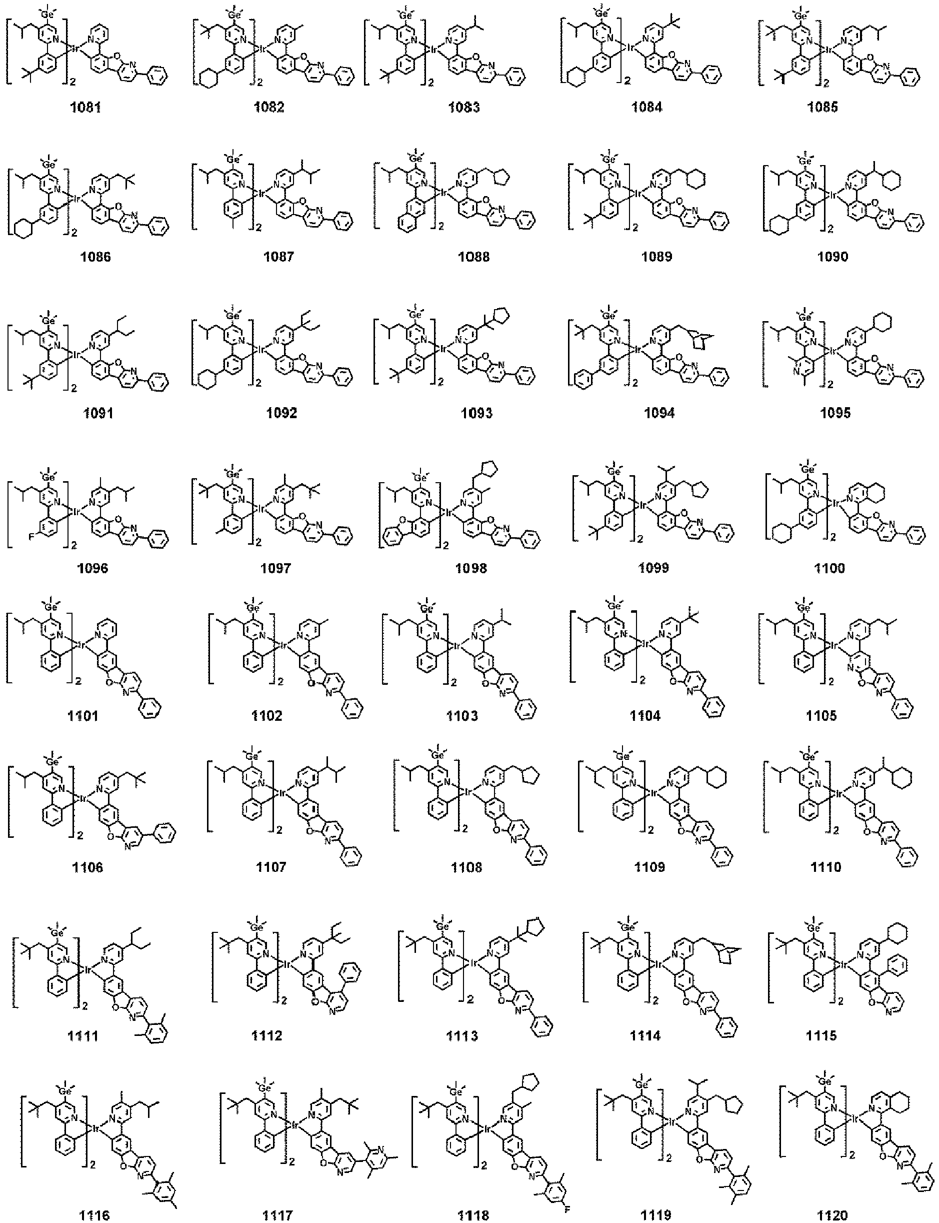

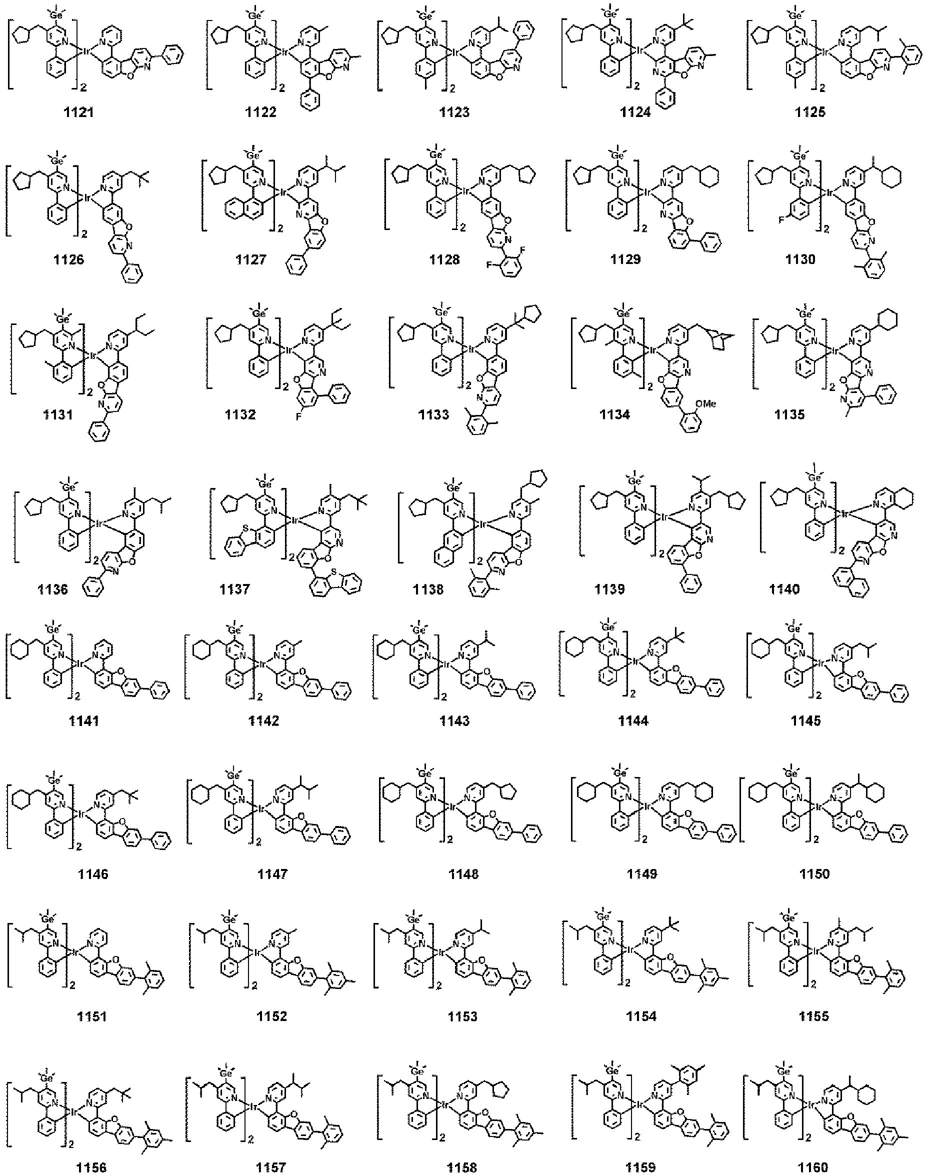

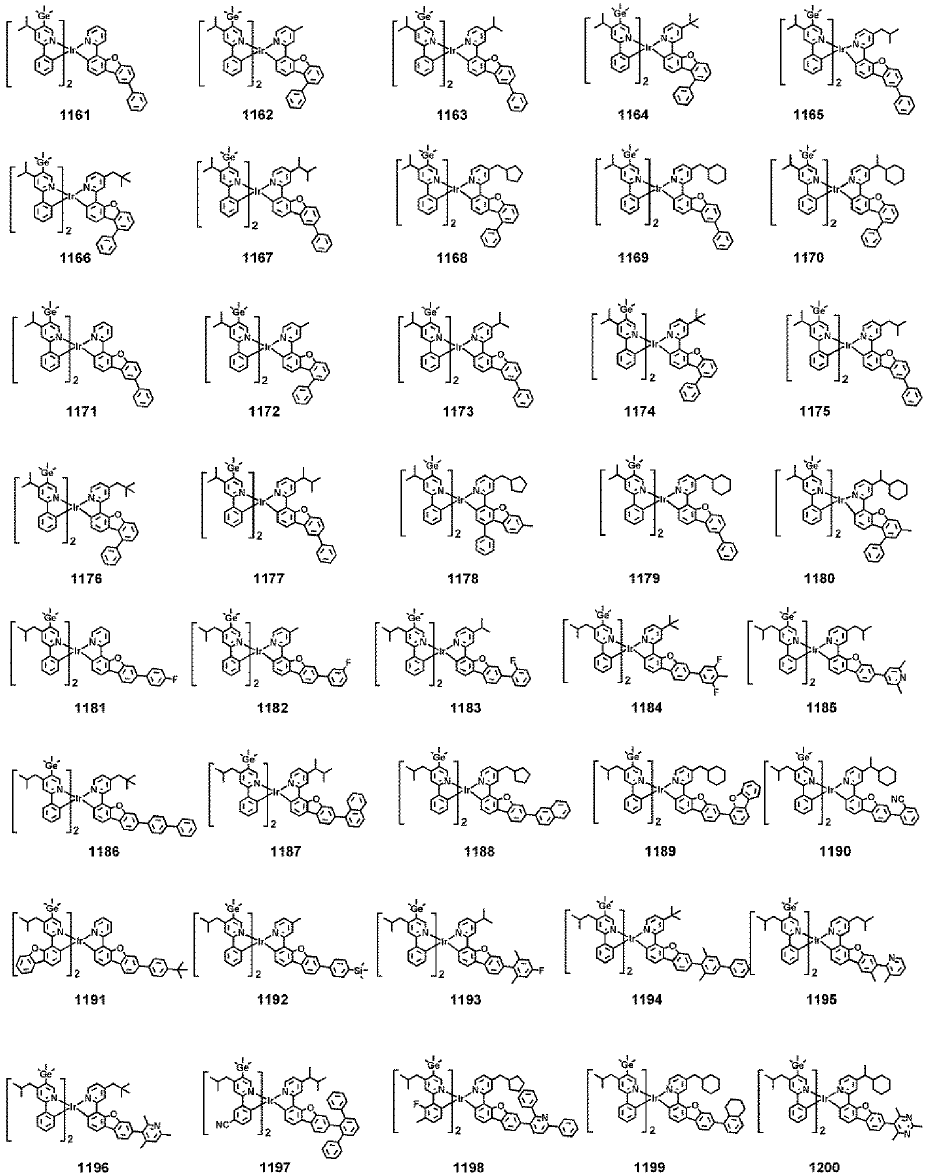

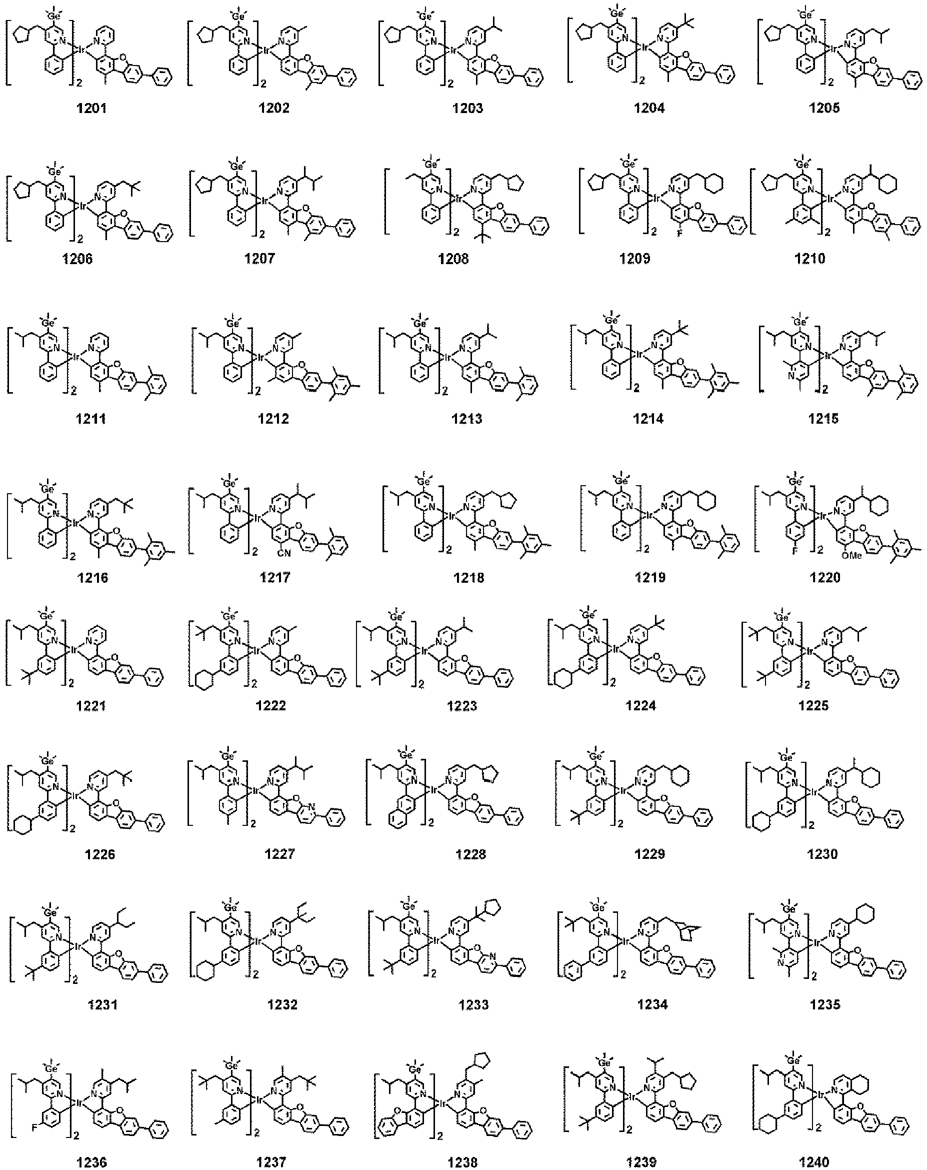

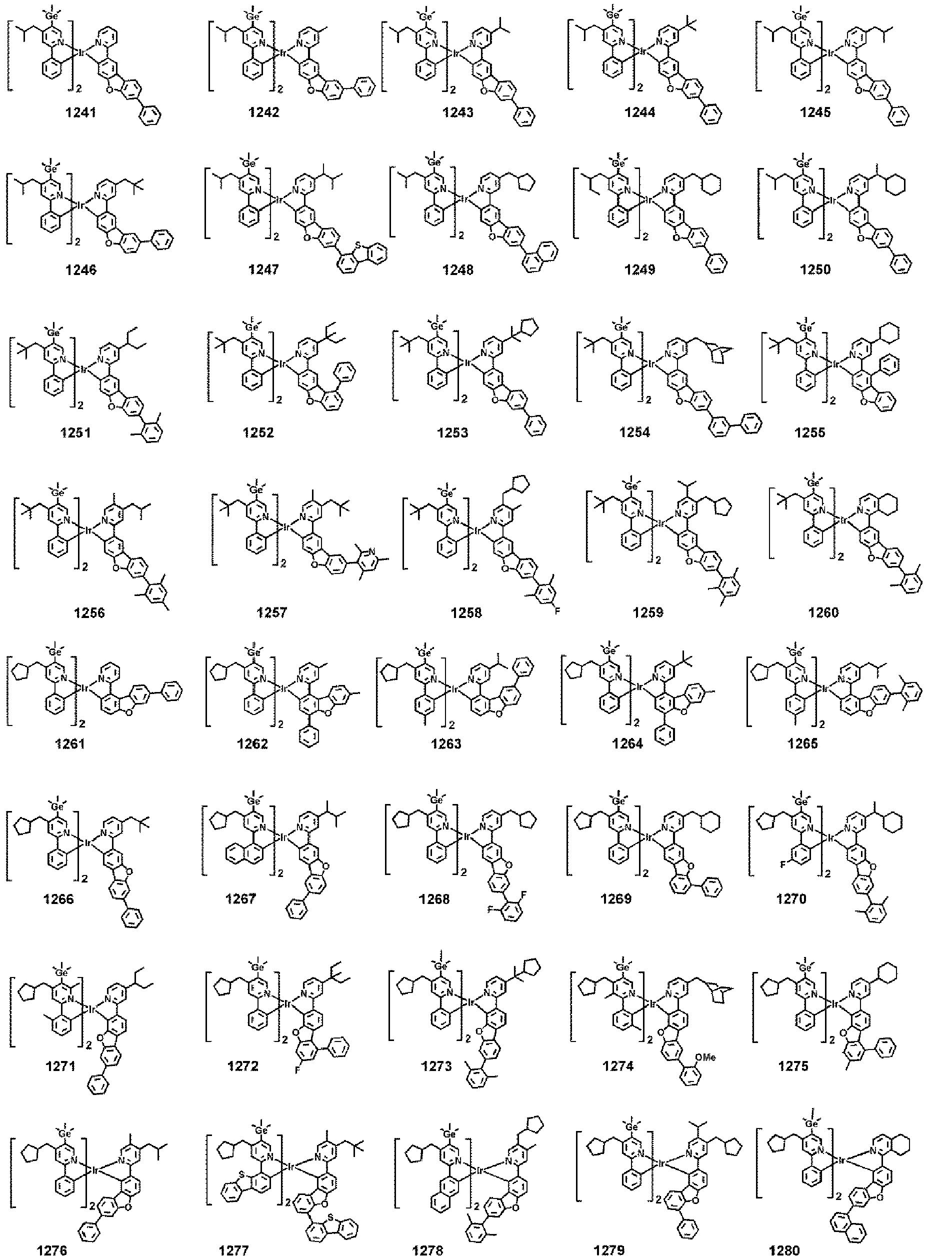

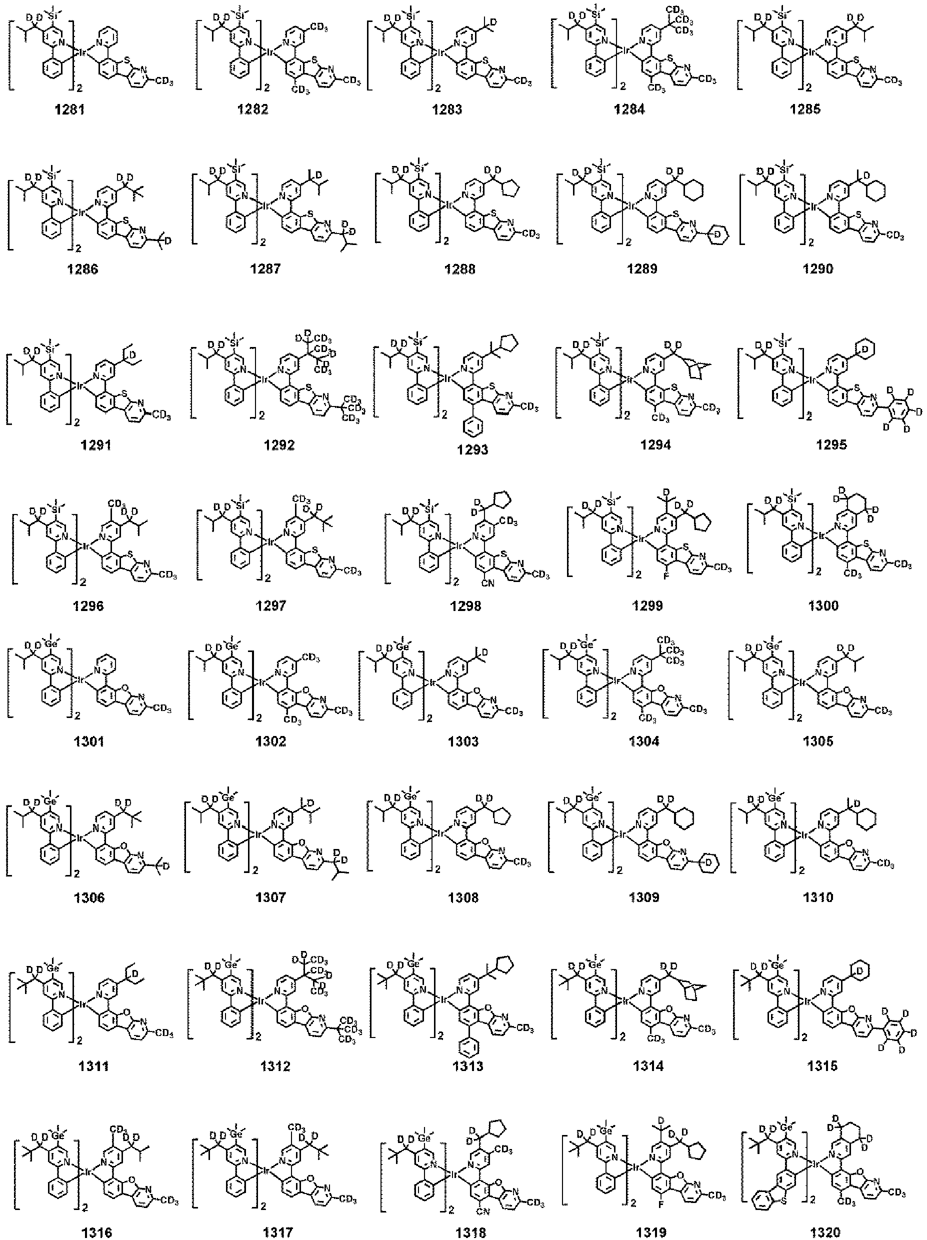

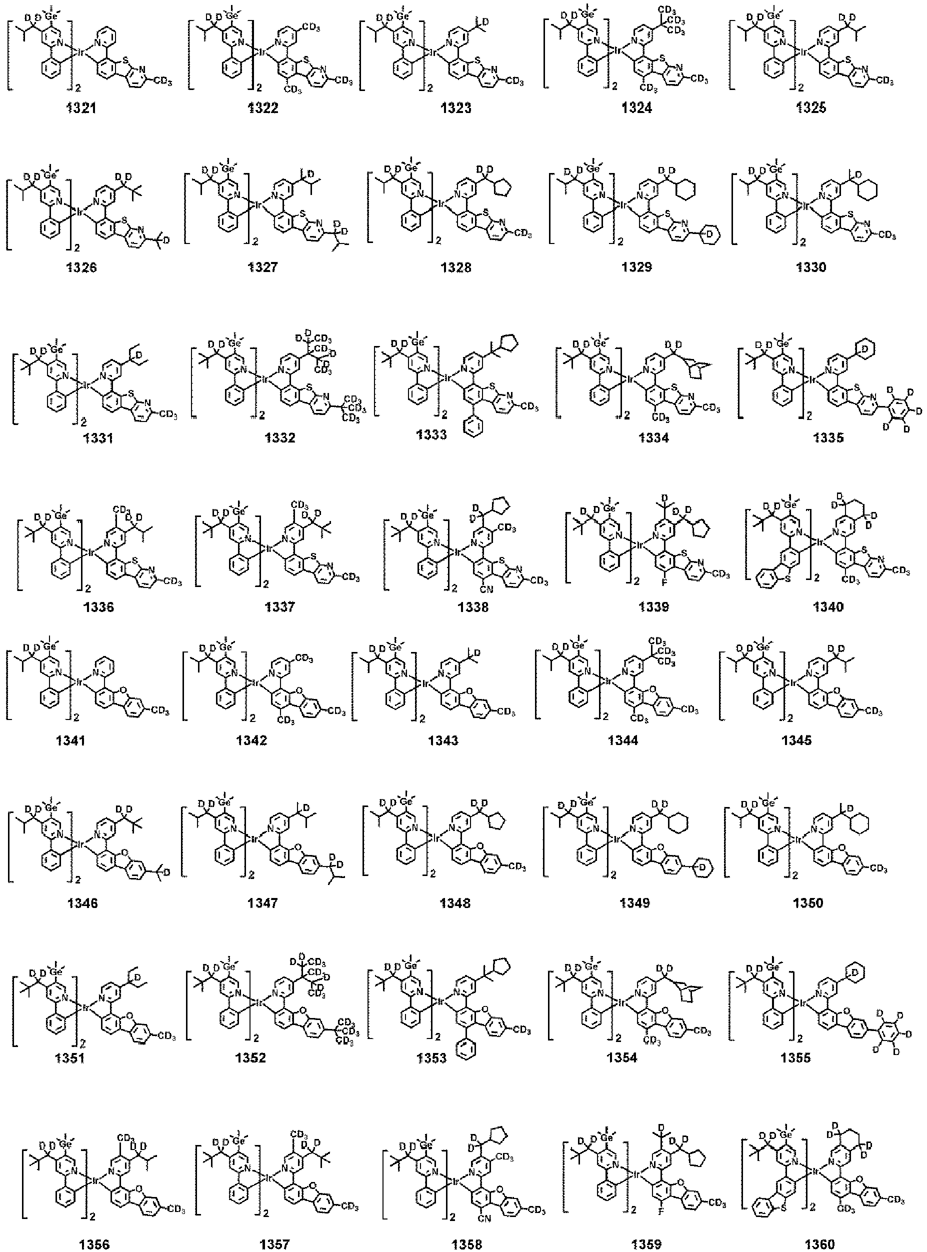

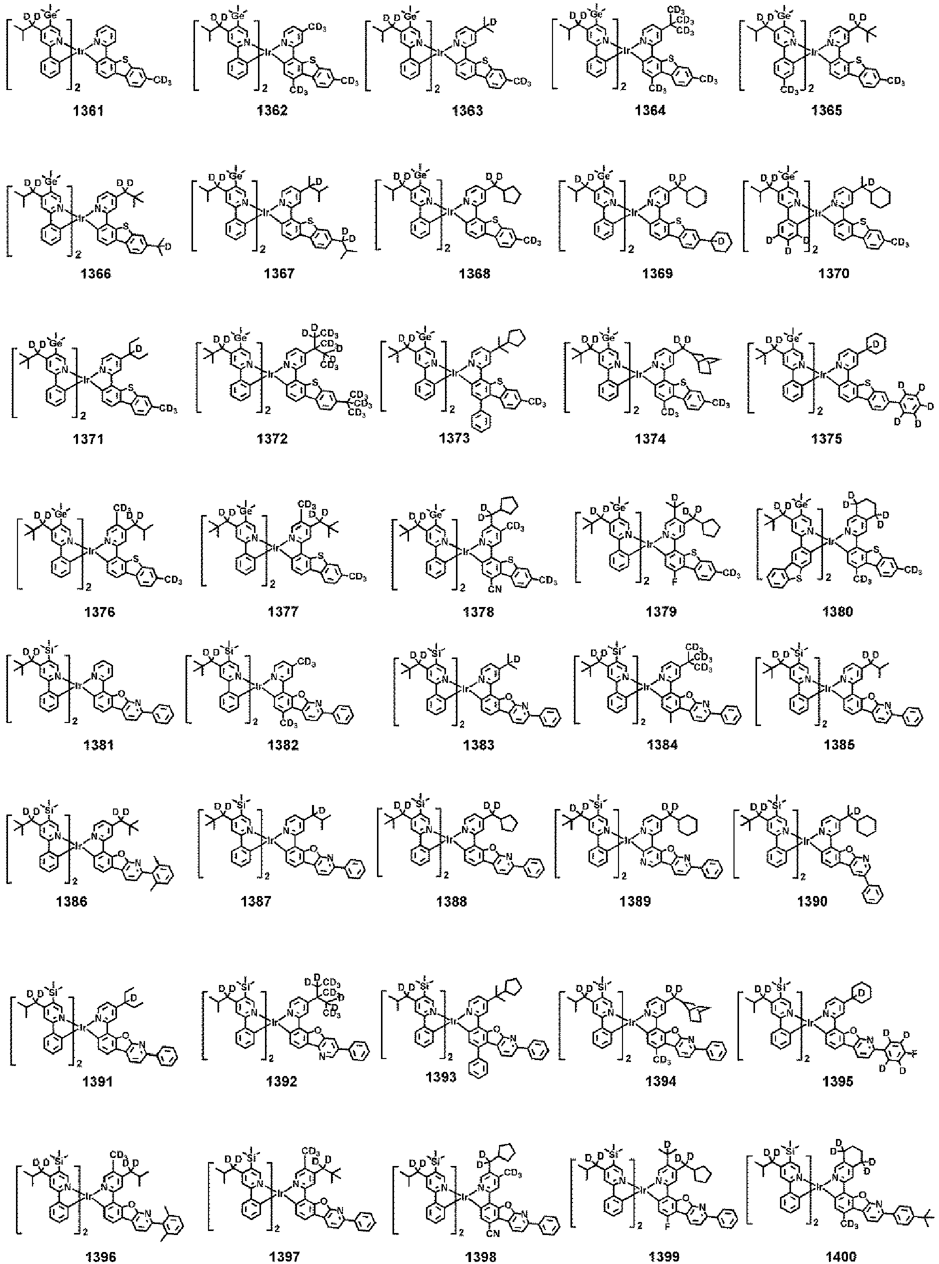

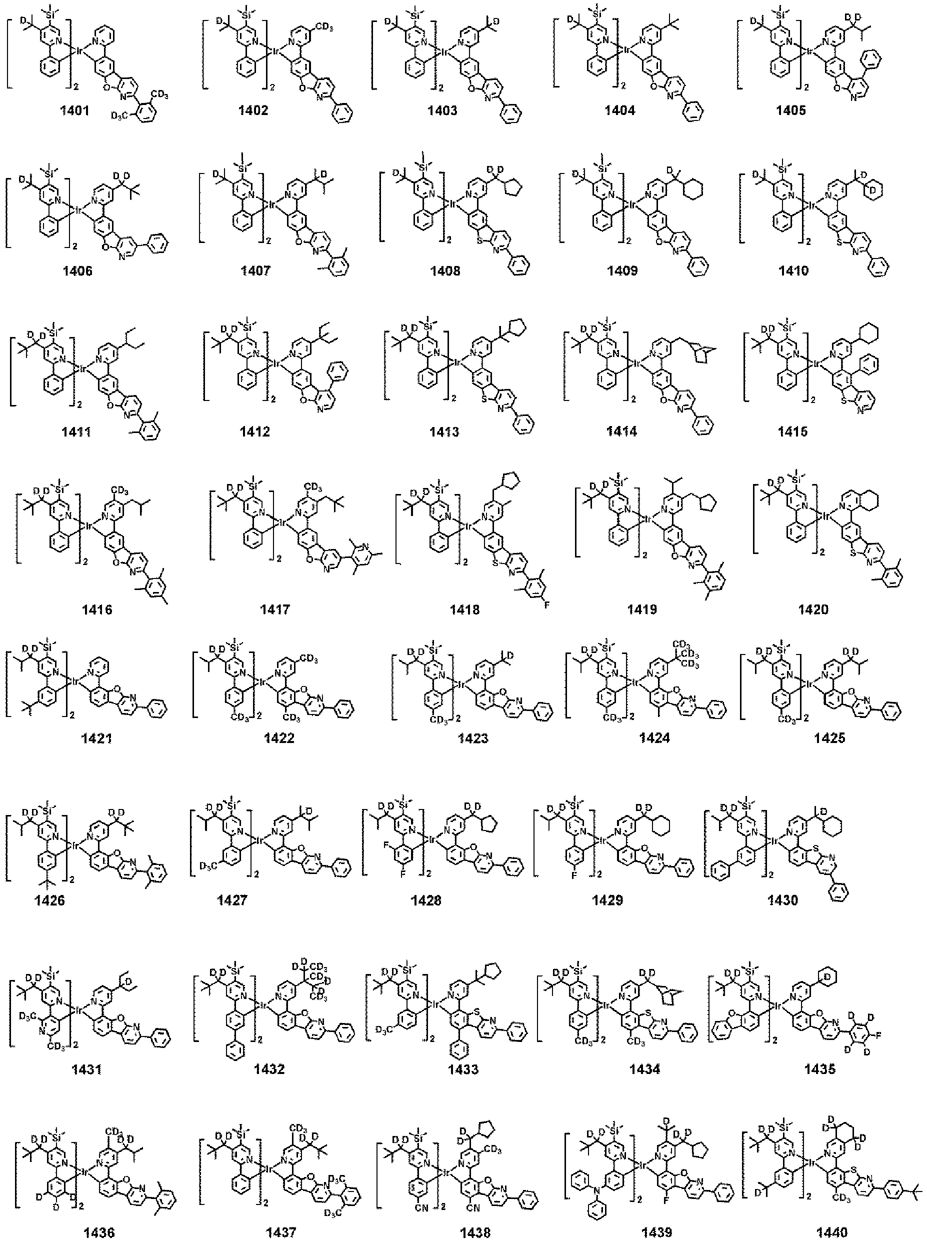

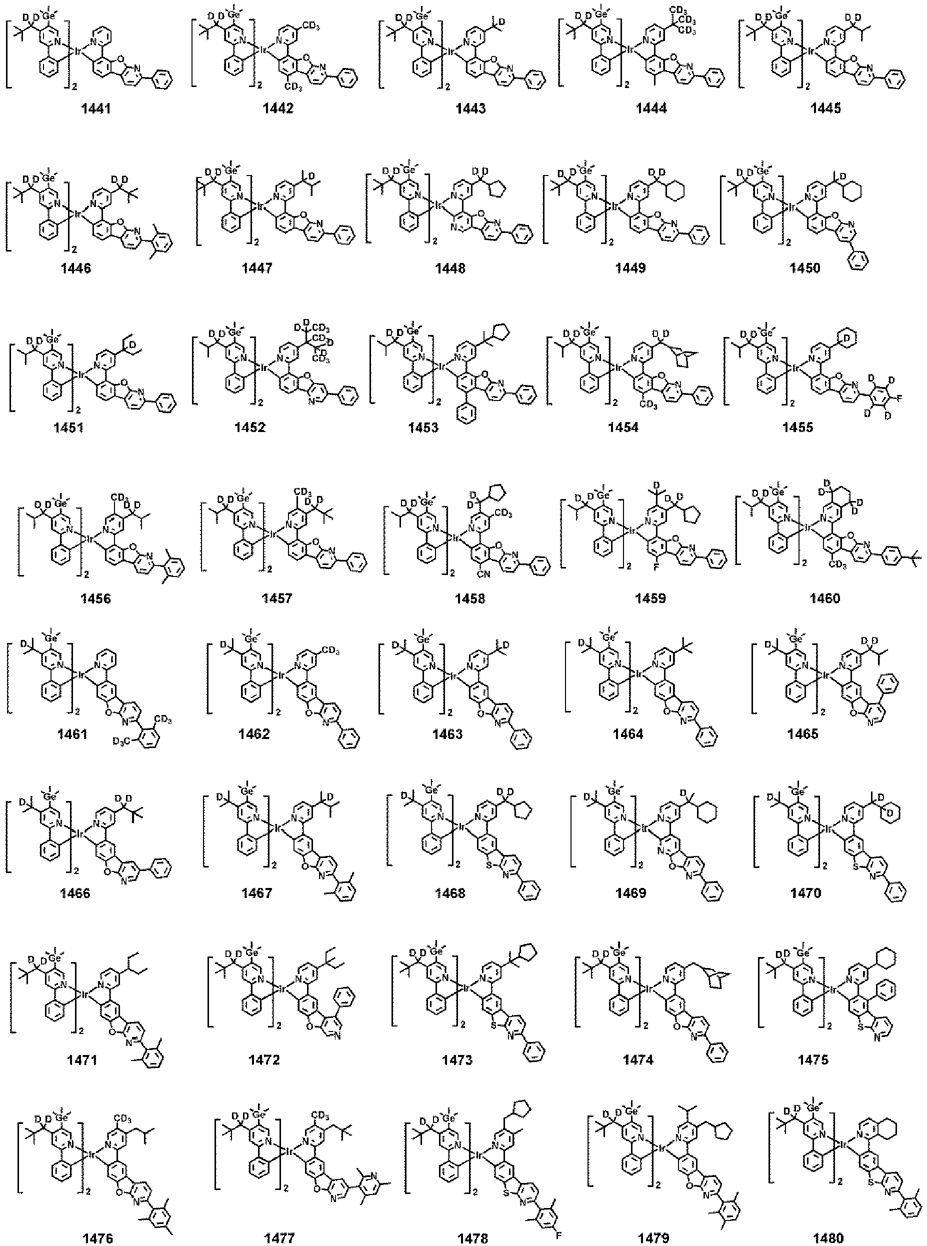

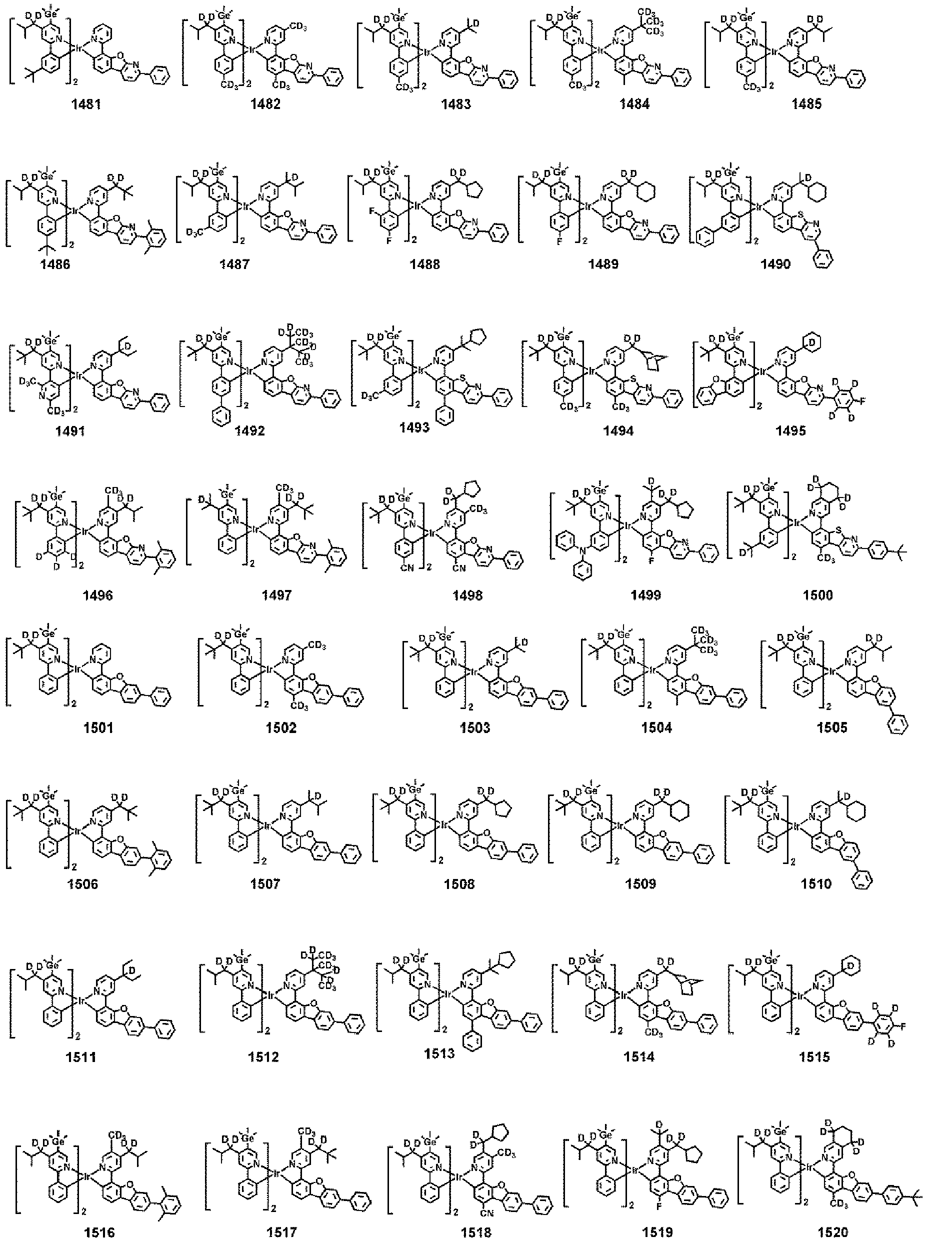

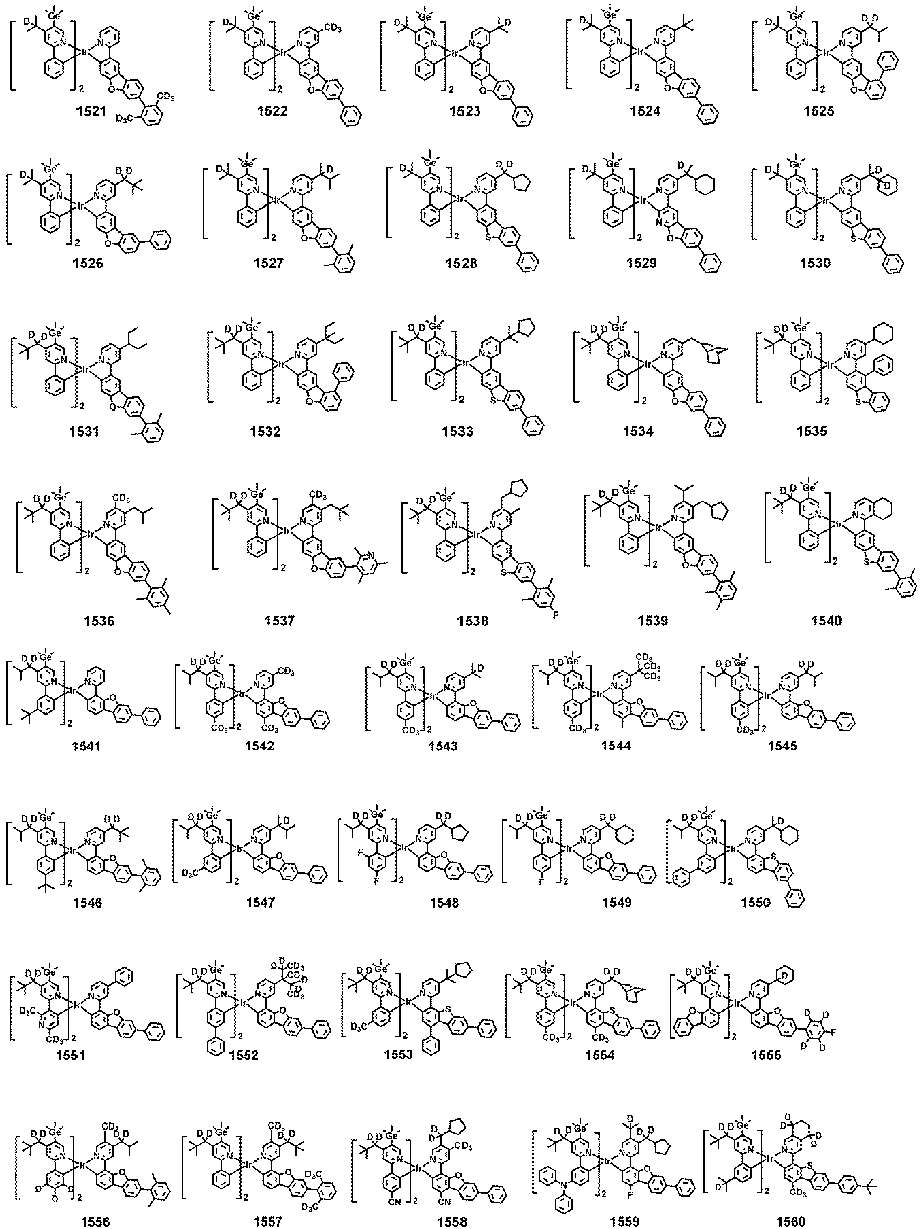

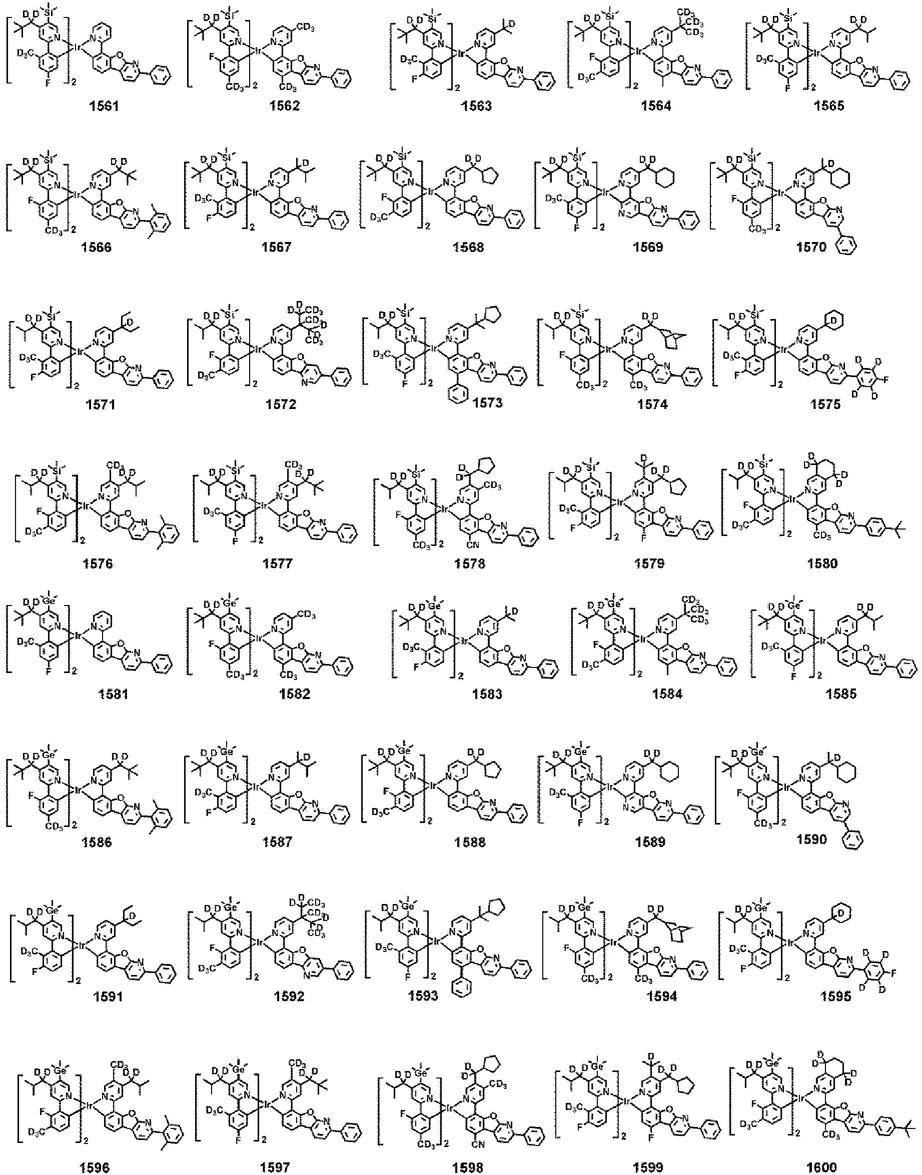

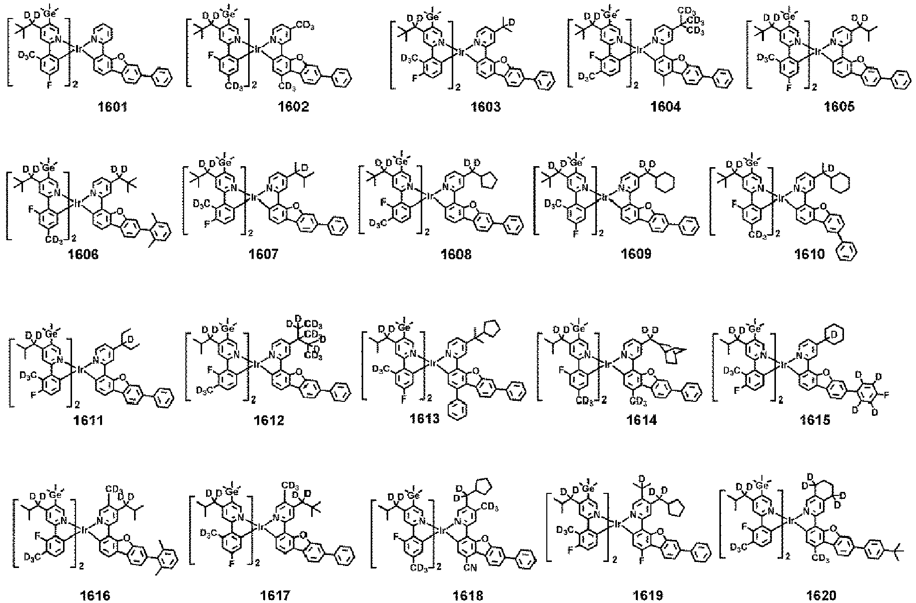

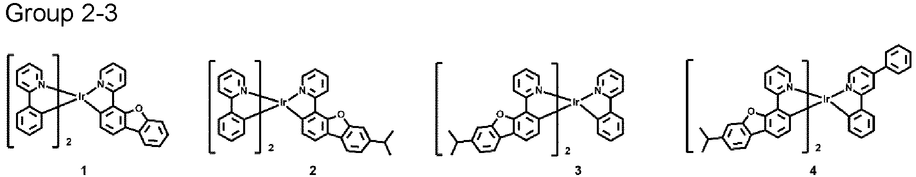

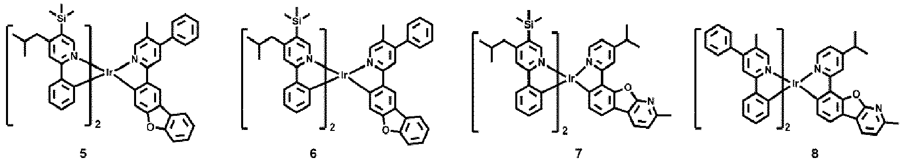

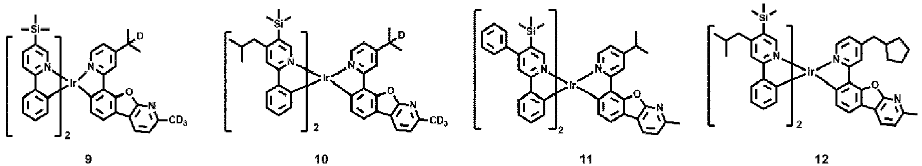

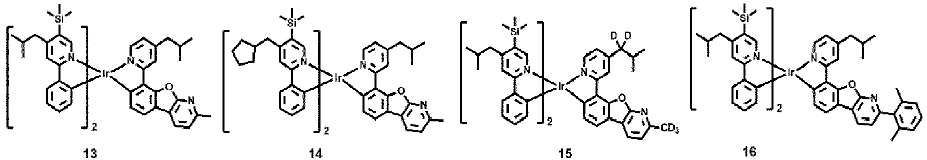

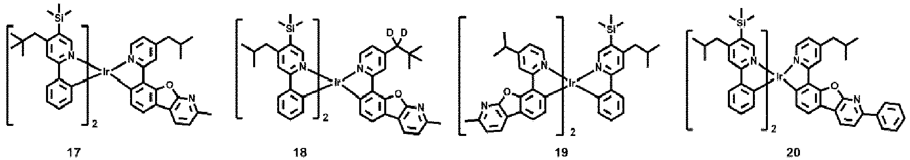

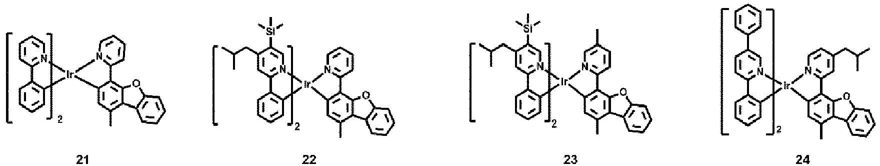

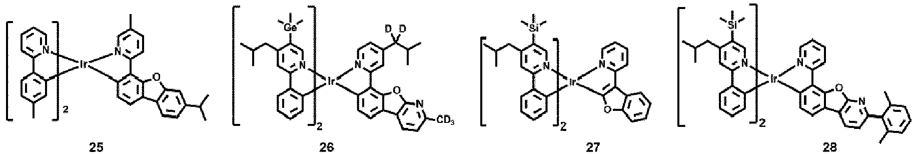

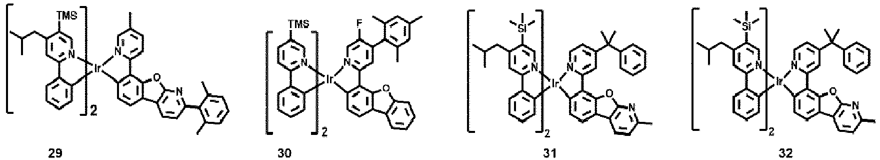

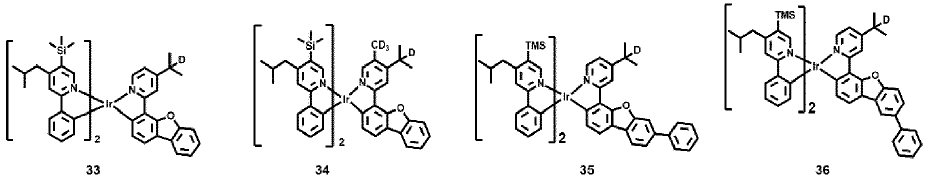

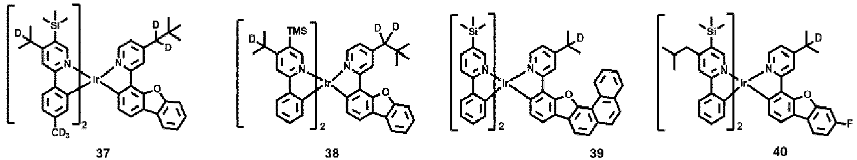

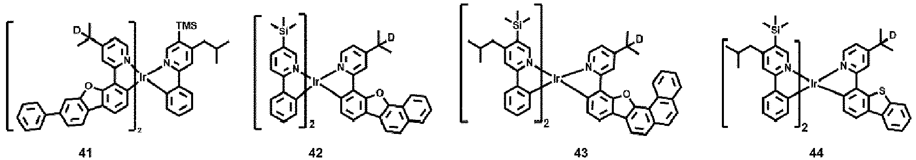

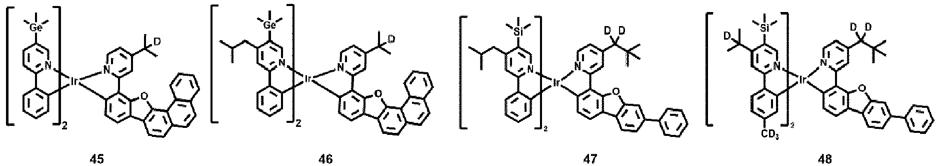

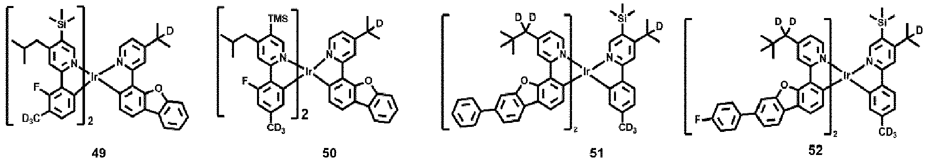

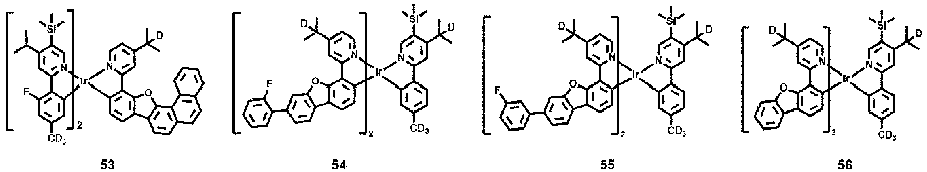

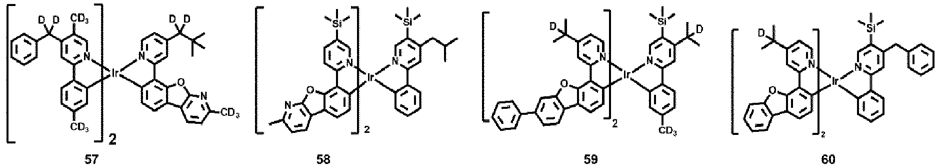

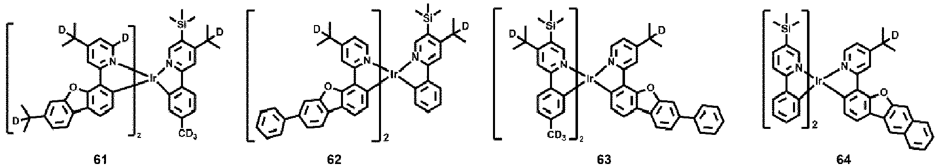

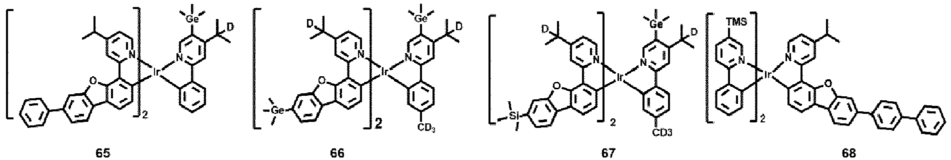

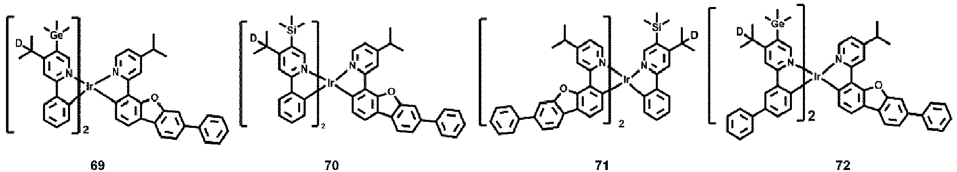

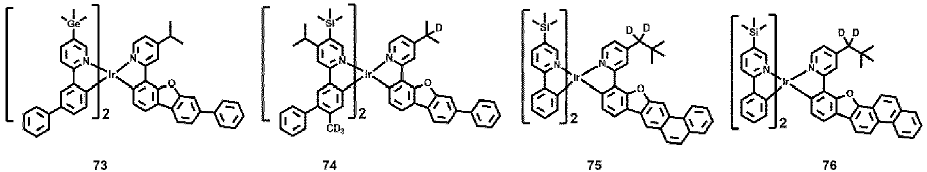

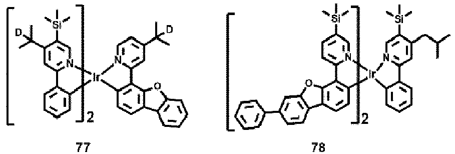

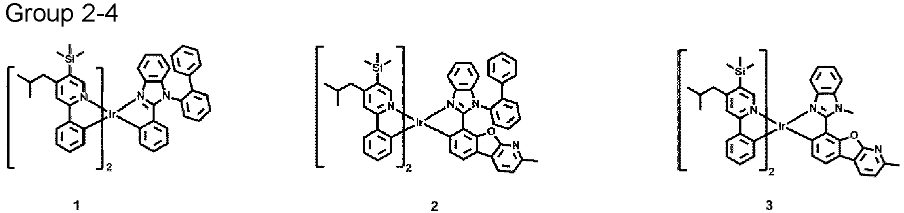

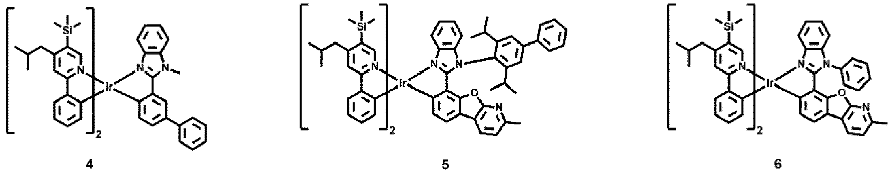

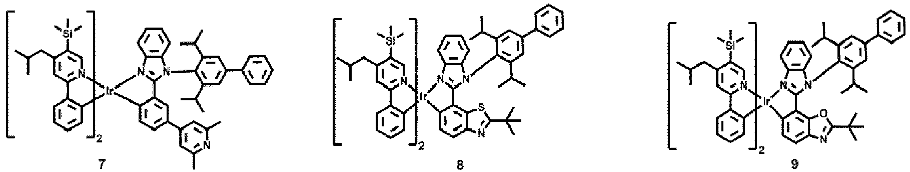

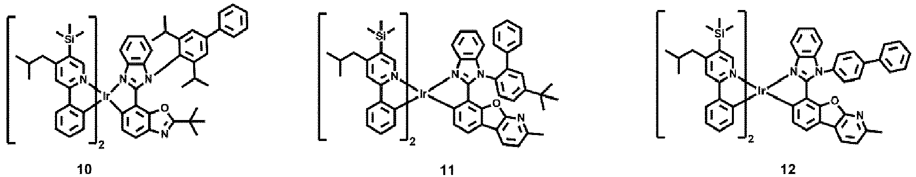

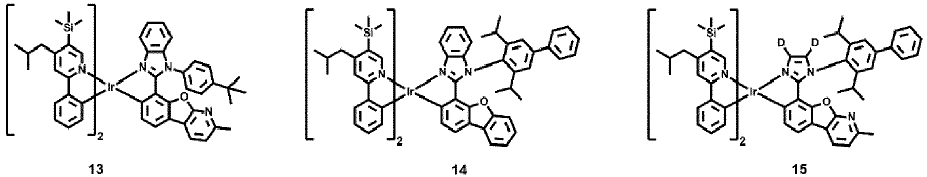

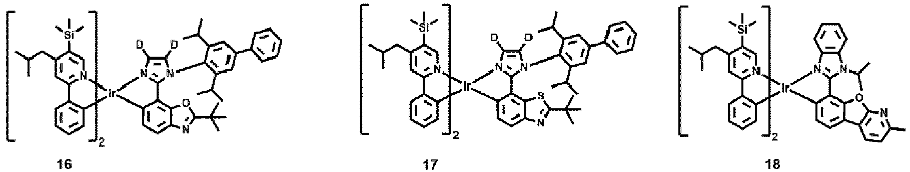

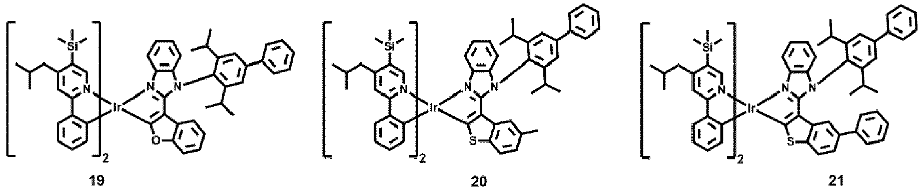

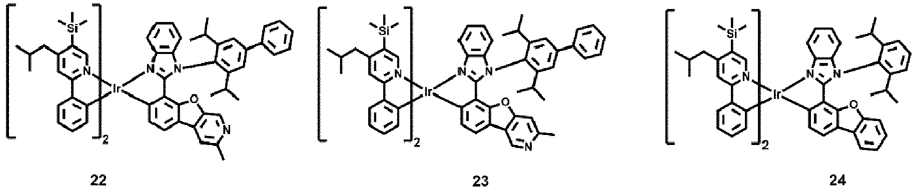

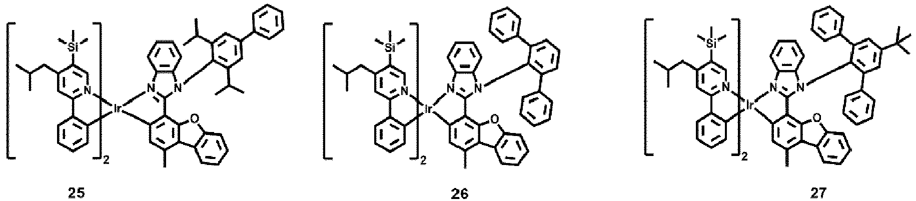

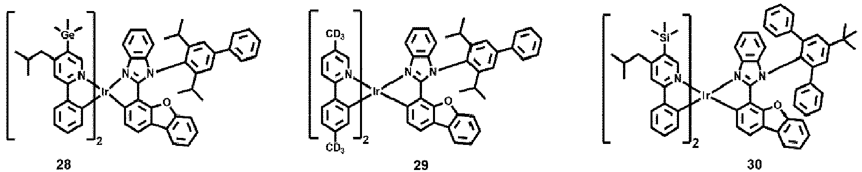

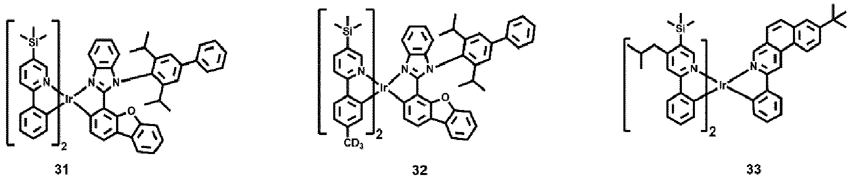

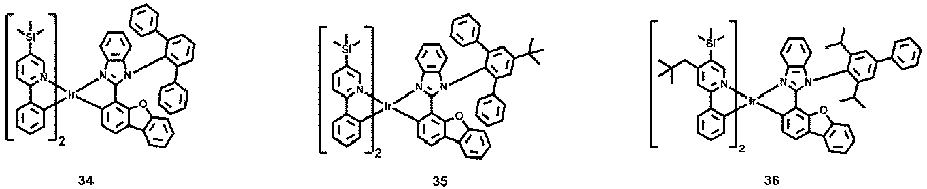

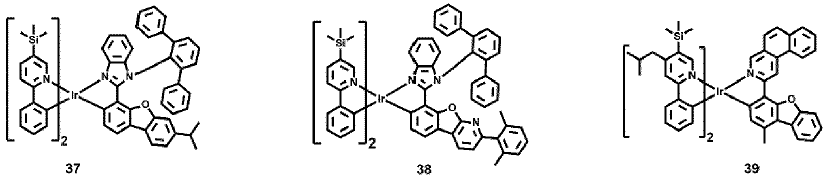

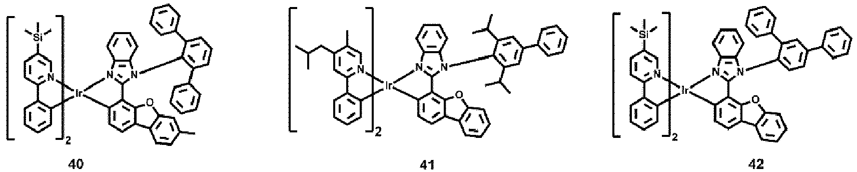

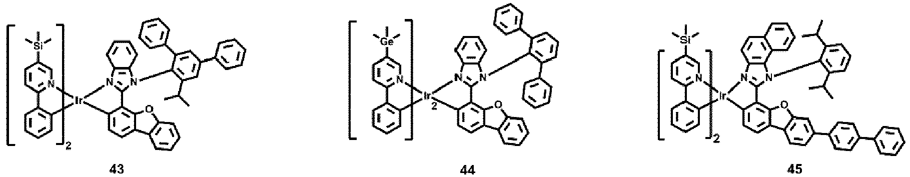

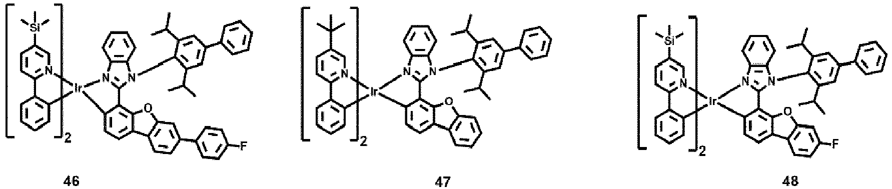

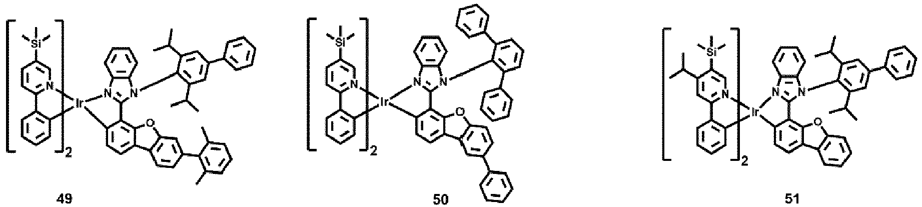

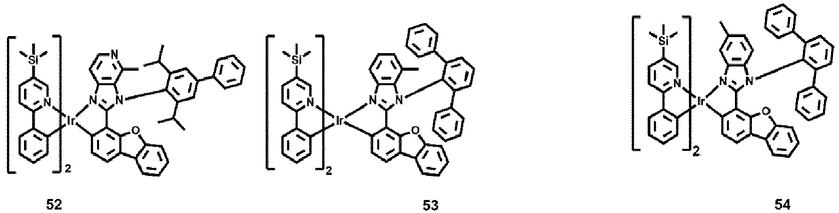

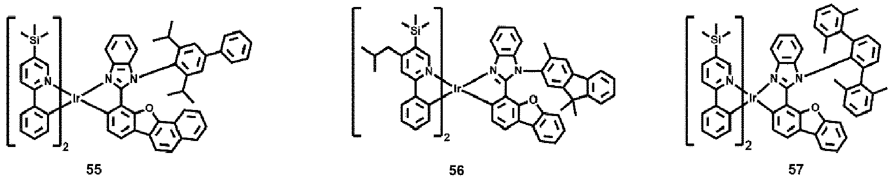

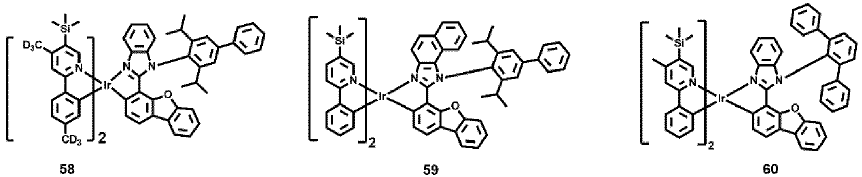

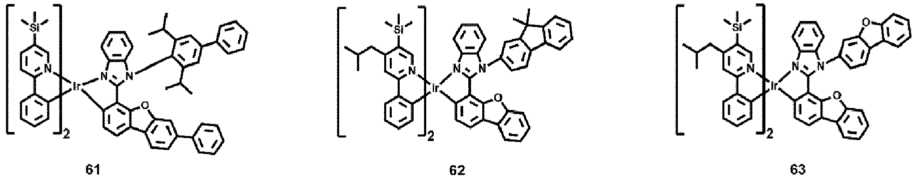

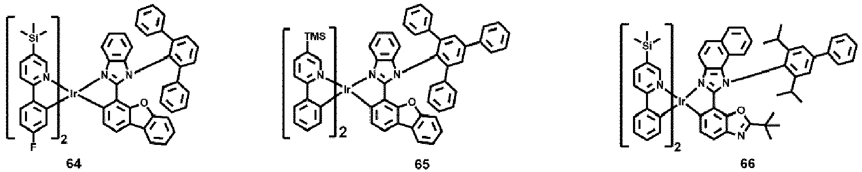

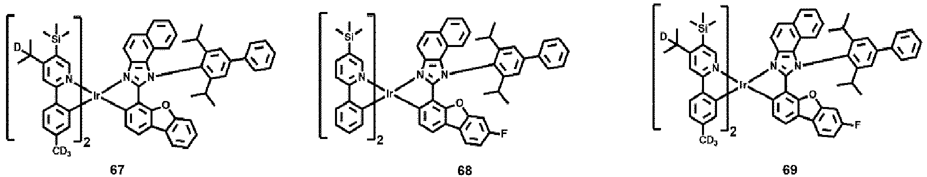

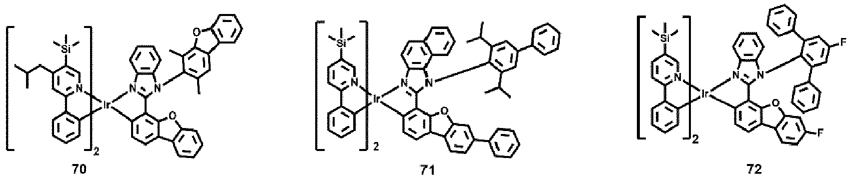

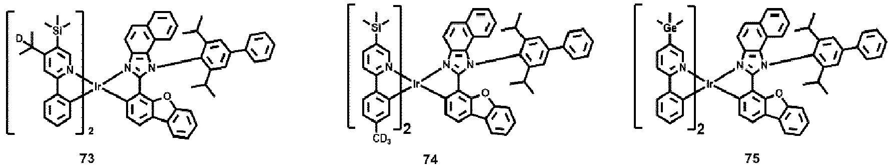

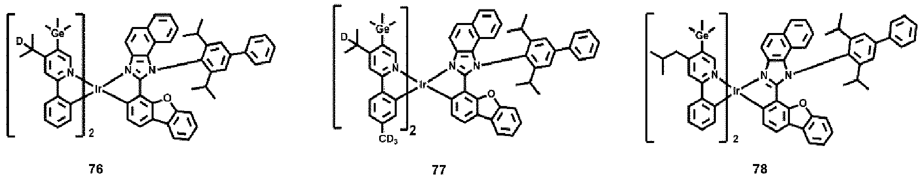

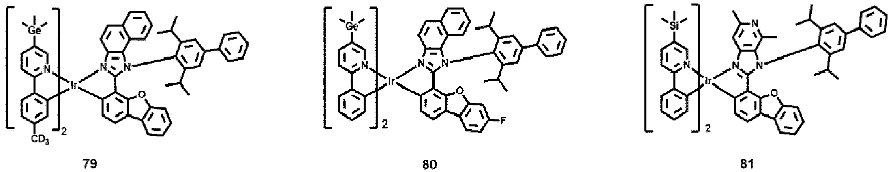

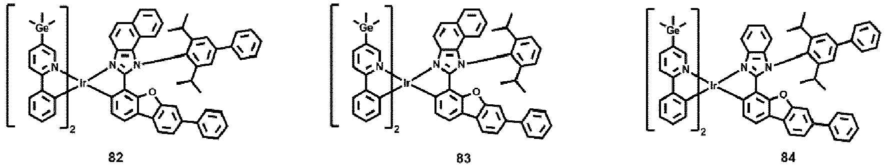

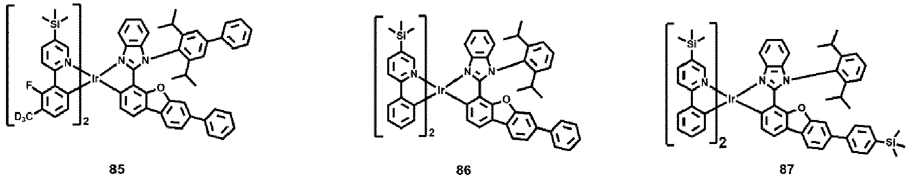

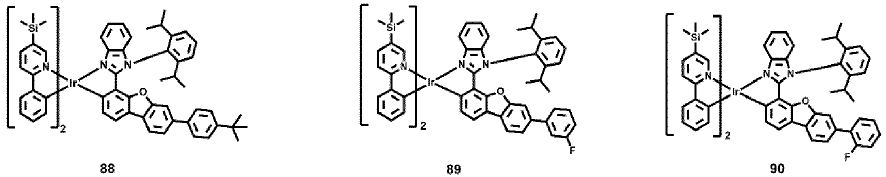

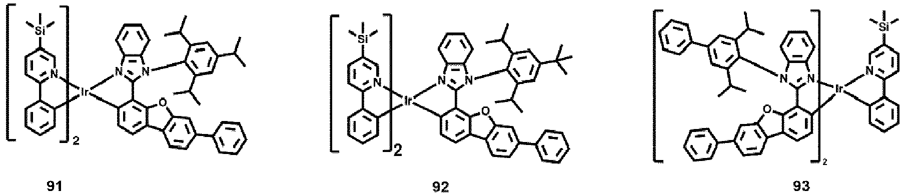

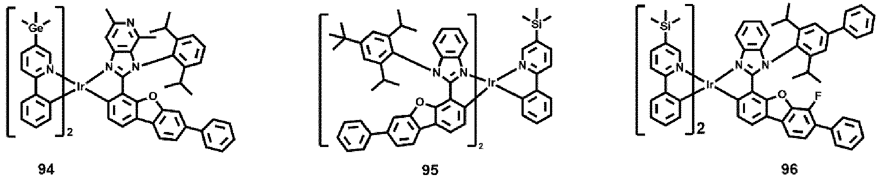

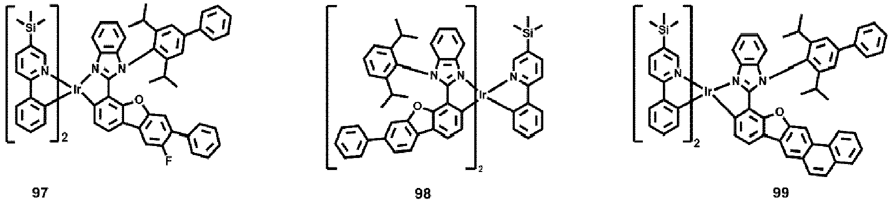

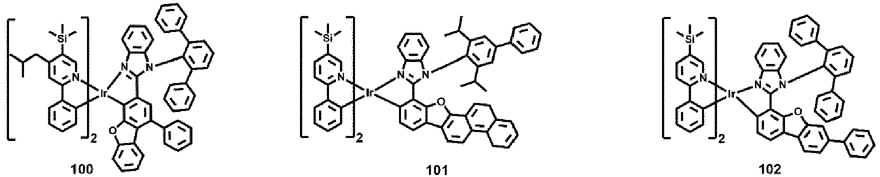

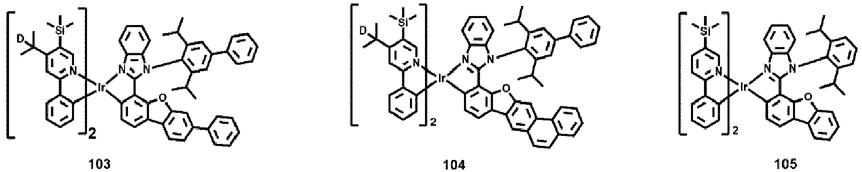

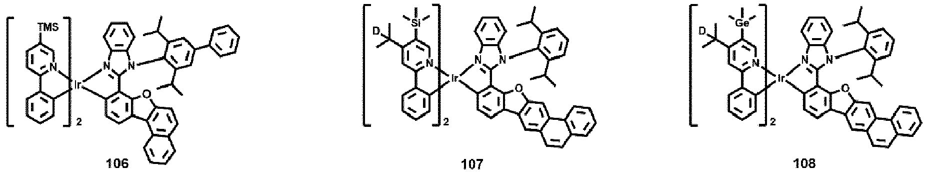

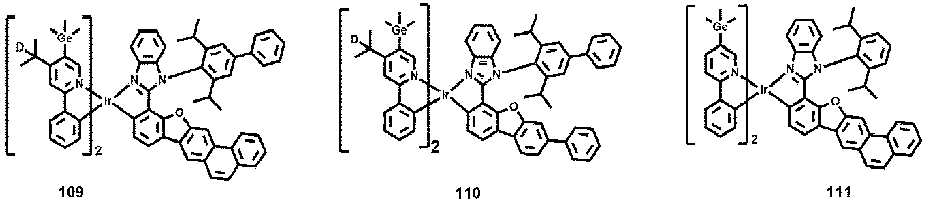

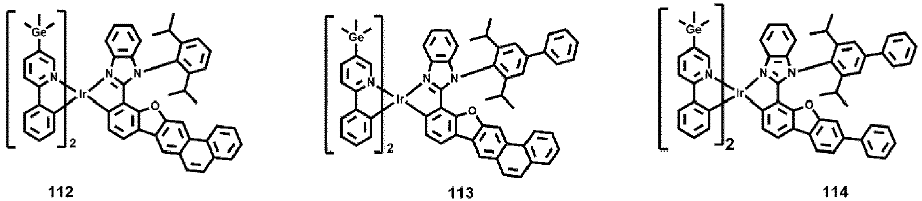

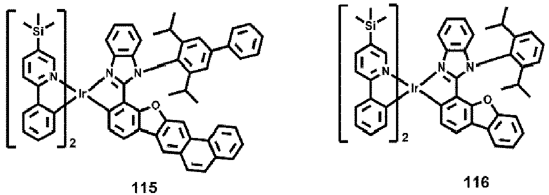

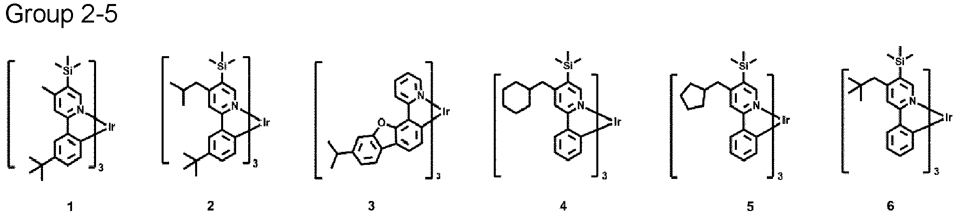

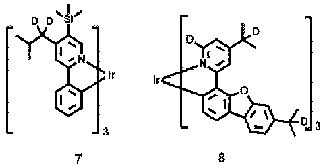

As used in the formulae and structures herein, and unless otherwise specified to the contrary, "OMe" is a methoxy group, "TMS" is a trimethylsilyl group, and "TMG" is a trimethylgermyl group.

The composition including the first compound represented by Formula 1 and the second compound represented by Formula 2 as defined above may emit light having excellent luminescence efficiency and lifespan (for example, light such as green light, yellowish green light, or yellow light, each having an emission peak wavelength in a range of about 480 nm to about 580 nm or about 510 nm to about 570 nm). Accordingly, a layer including the composition, a light-emitting device including the composition, and an electronic device including the light-emitting device may be provided.

Another aspect of the present disclosure provides a layer including the composition including the first compound and the second compound.

In one or more embodiments, the layer may emit light having an emission peak wavelength in a range of about 480 nm to about 580 nm, for example, about 510 nm to about 570 nm.

In one or more embodiments, the layer may emit green light, yellowish green light, or yellow light.

In one or more embodiments, the layer may emit light having an emission peak wavelength in a range of about 510 nm to about 540 nm.

In one or more embodiments, the layer may emit light having an emission peak wavelength in a range of about 540 nm to about 570 nm.

In one or more embodiments, a weight ratio of the first compound and the second compound included in the layer may be in a range of about 90:10 to about 10:90, about 80:20 to about 20:80, about 70:30 to about 30:70, or about 60:40 to about 40:60.

In one or more embodiments, the weight ratio of the first compound and the second compound included in the layer may be about 50:50, that is, about 1:1.

In one or more embodiments, the layer may be formed by i) co-depositing the first compound and the second compound, or ii) using a first mixture including the first compound and the second compound.

In one or more embodiments, the layer may include a host and a dopant, wherein the host does not include a transition metal, and the dopant may include the composition including the first compound and the second compound. In one or more embodiments, the layer may be formed by i) co-depositing the host and the dopant, or ii) using a second mixture including the host and the dopant.

In the layer, an amount (for example, a weight) of the host may be greater than that of the dopant.

For example, a weight ratio of the host and the dopant in the layer may be in a range of about 99:1 to about 55:45, about 97:3 to about 60:40, or about 95:5 to about 70:30.

The host in the layer may include a hole-transporting compound, an electron-transport compound, a bipolar compound, or a combination thereof.

Another aspect of the present disclosure provides a light-emitting device including: a first electrode; a second electrode; and an organic layer arranged between the first electrode and the second electrode and including an emission layer, wherein the organic layer includes the composition including the first compound and the second compound.

The light-emitting device may have excellent driving voltage, excellent external quantum efficiency, and excellent lifetime characteristics by including the composition including the first compound and the second compound as defined above.

In one or more embodiments, the emission layer included in the organic layer of the light-emitting device may include the composition including the first compound and the second compound.

In one or more embodiments, the emission layer may include a host and a dopant, wherein the host may not include a transition metal, and the dopant may include the composition.

The host included in the emission layer may include a hole-transporting compound, an electron-transporting compound, a bipolar compound, or a combination thereof.

For example, the host may include a hole-transporting compound and an electron-transporting compound, wherein the hole-transporting compound and the electron-transporting compound may be different from each other.

The emission layer may be formed by i) co-depositing the host and the dopant, or ii) using a second mixture including the host and the dopant.

The emission layer may emit third light having a third spectrum, and λP(EML) indicates an emission peak wavelength (nm) in the third spectrum. For example, the λP(EML) may be evaluated from an electroluminescence (EL) spectrum of the light-emitting device.

The light-emitting device may emit fourth light having a fourth spectrum and extracted to the outside of the light-emitting device through the first electrode and/or the second electrode of the light-emitting device, and λP(OLED) indicates an emission peak wavelength (nm) in the fourth spectrum. For example, the λP(OLED) may be evaluated from an electroluminescence spectrum of the light-emitting device.

For example, the λP(EML) and the λP(OLED) may each independently be in a range of about 480 nm to about 580 nm, for example, about 510 nm to about 570 nm.

In one or more embodiments, the λP(EML) and the λP(OLED) may each independently be in a range of about 510 nm to about 540 nm.

In one or more embodiments, the λP(EML) and the λP(OLED) may each independently be in a range of about 540 nm to about 570 nm.

In one or more embodiments, each of the third light and the fourth light may be green light, yellowish green light or yellow light.

In one or more embodiments, each of the third light and the fourth light may not be white light.

In one or more embodiments, regarding the third spectrum, i) a main emission peak having the λP(EML) may be included; but ii) an additional emission peak having an emission peak wavelength of (λP(EML) + 50 nm) or more or (λP(EML) - 50 nm) or less may not be included.

In one or more embodiments, regarding the third spectrum, i) a main emission peak having the λP(EML) may be included; but ii) an additional emission peak having an emission peak wavelength in a red light region and/or a blue light region may not be included.

In one or more embodiments, regarding the fourth spectrum, i) a main emission peak having the λP(OLED) may be included; but ii) an additional emission peak having an emission peak wavelength of λP(OLED) + 50 nm or more or λP(OLED) - 50 nm or less may not be included.

In one or more embodiments, regarding the fourth spectrum, i) a main emission peak having the λP(EML) may be included; but ii) an additional emission peak having an emission peak wavelength in a red light region and/or a blue light region may not be included.

The first electrode may be an anode, which is a hole injection electrode, and the second electrode may be a cathode, which is an electron injection electrode; or the first electrode may be a cathode, which is an electron injection electrode, and the second electrode may be an anode, which is a hole injection electrode.

For example, in the light-emitting device, the first electrode may be an anode, and the second electrode may be a cathode, and the organic layer may further include a hole transport region arranged between the first electrode and the emission layer, and an electron transport region arranged between the emission layer and the second electrode, wherein the hole transport region may include a hole injection layer, a hole transport layer, an electron blocking layer, a buffer layer, or a combination thereof, and the electron transport region may include a hole blocking layer, an electron transport layer, an electron injection layer, or a combination thereof.

The term "organic layer" as used herein refers to a single layer and/or a plurality of layers arranged between the first electrode and the second electrode of the light-emitting device. The "organic layer" may include, in addition to an organic compound, an organometallic complex including a metal.

The FIGURE is a schematic cross-sectional view of a light-emitting device 10 according to one or more embodiments. Hereinafter, a structure and a manufacturing method of a light-emitting device according to one or more embodiments of the present disclosure will be described in connection with the FIGURE. The light-emitting device 10 includes a first electrode 11, an organic layer 15, and a second electrode 19, which are sequentially stacked in this stated order.

A substrate may be additionally arranged under the first electrode 11 or above the second electrode 19. For use as the substrate, any substrate that is used in light-emitting devices of the related art may be used, and the substrate may be a glass substrate or a transparent plastic substrate, each having excellent mechanical strength, thermal stability, transparency, surface smoothness, ease of handling, and/or water resistance.

The first electrode 11 may be, for example, formed by depositing or sputtering a material for forming the first electrode 11 on the substrate. The first electrode 11 may be an anode. The material for forming the first electrode 11 may include materials with a high work function to facilitate hole injection. The first electrode 11 may be a reflective electrode, a semi-transmissive electrode, or a transmissive electrode. In one or more embodiments, the material for forming the first electrode 11 may be indium tin oxide (ITO), indium zinc oxide (IZO), tin oxide (SnO₂), or zinc oxide (ZnO). In one or more embodiments, the material for forming the first electrode 11 may be metal, such as magnesium (Mg), aluminum (Al), silver (Ag), aluminum-lithium (Al-Li), calcium (Ca), magnesium-indium (Mg-In), or magnesium-silver (Mg-Ag).

The first electrode 11 may have a single-layered structure or a multi-layered structure including two or more layers. For example, the first electrode 11 may have a three-layered structure of ITO/Ag/ITO.

The organic layer 15 is arranged on the first electrode 11.

The organic layer 15 may include a hole transport region, an emission layer, and an electron transport region.

The hole transport region may be arranged between the first electrode 11 and the emission layer.

The hole transport region may include a hole injection layer, a hole transport layer, an electron blocking layer, a buffer layer, or a combination thereof.

The hole transport region may include only either a hole injection layer or a hole transport layer. The hole transport region may have a hole injection layer/hole transport layer structure or a hole injection layer/hole transport layer/electron blocking layer structure, wherein, for each structure, constituting layers are sequentially stacked in this stated order from the first electrode 11.

When the hole transport region includes a hole injection layer, the hole injection layer may be formed on the first electrode 11 by using one or more suitable methods, for example, vacuum deposition, spin coating, casting, and/or Langmuir-Blodgett (L-B) deposition.

When the hole injection layer is formed by vacuum deposition, the deposition conditions may vary depending on a material for forming the hole injection layer, and the structure and thermal characteristics of the hole injection layer. For example, the deposition conditions may include a deposition temperature in a range of about 100°C to about 500°C , a vacuum pressure in a range of about 10⁻⁸ torr to about 10⁻³ torr, and a deposition rate in a range of about 0.01 angstroms per second (Å/sec) to about 100 Å/sec.

When the hole injection layer is formed by spin coating, the coating conditions may vary depending on a material for forming the hole injection layer, and the structure and thermal characteristics of the hole injection layer. For example, the coating conditions may include a coating speed in a range of about 2,000 revolutions per minute (rpm) to about 5,000 rpm and a heat treatment temperature in a range of about 80°C to about 200°C for removing a solvent after coating.

Conditions for forming the hole transport layer and the electron blocking layer may be the same as the conditions for forming the hole injection layer.

The hole transport region may include 4,4',4"-tris(3-methylphenylphenylamino)triphenylamine (m-MTDATA), 4,4',4"-tris(N,N-diphenylamino)triphenylamine (TDATA), 4,4',4"-tris{N-(2-naphthyl)-N-phenylamino}-triphenylamine (2-TNATA), N,N'-di(naphthalene-1-yl)-N,N'-diphenyl-benzidine (NPB), β-NPB, N,N'-bis(3-methylphenyl)-N,N'-diphenyl-[1,1-biphenyl]-4,4'-diamine (TPD), spiro-TPD, spiro-NPB, methylated NPB, 4,4'-cyclohexylidene bis[N,N-bis(4-methylphenyl)benzenamine] (TAPC), 4,4'-bis[N,N'-(3-tolyl)amino]-3,3'-dimethylbiphenyl (HMTPD), 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), a compound represented by Formula 201, a compound represented by Formula 202, or a combination thereof:

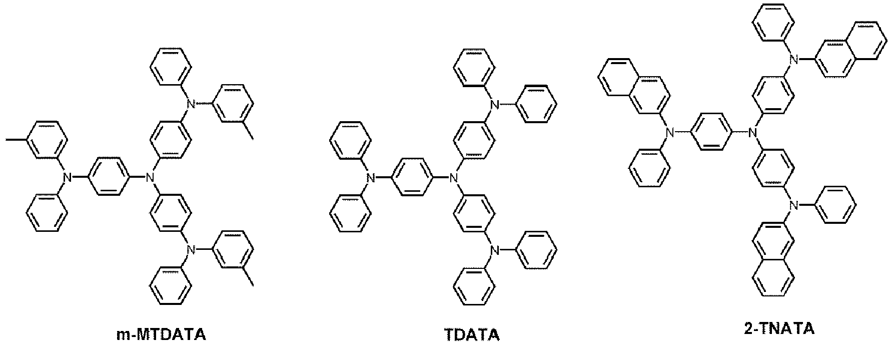

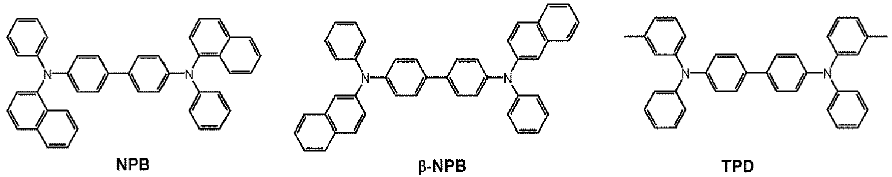

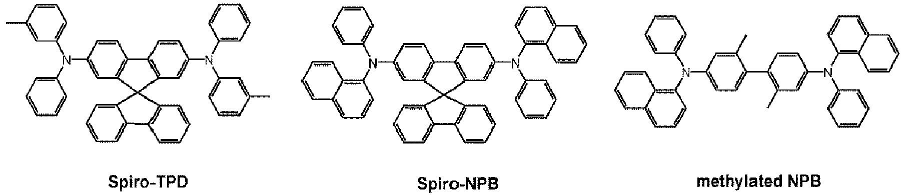

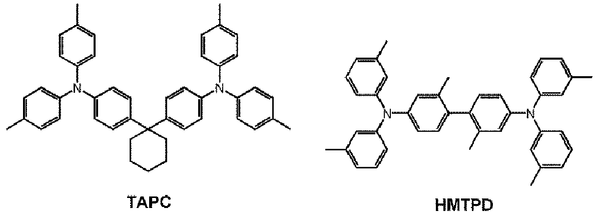

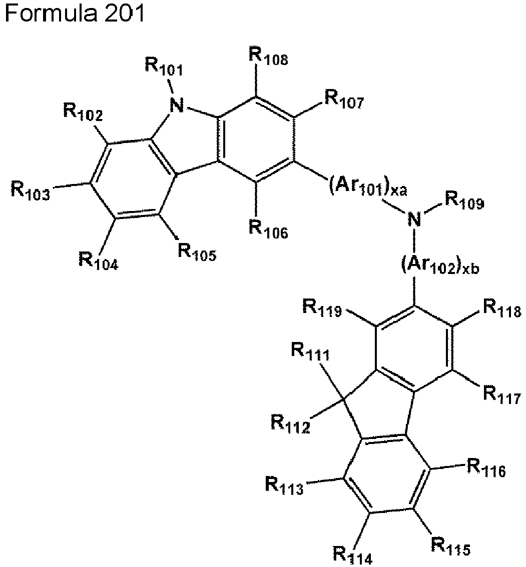

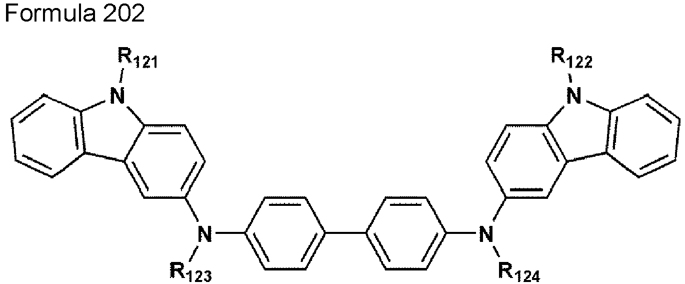

In Formula 201, Ar₁₀₁ and Ar₁₀₂ may each independently be a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group, each unsubstituted or substituted with at least one of deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₃-C₁₀ cycloalkenyl group, a C₁-C₁₀ heterocycloalkyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, or a combination thereof.

In Formula 201, xa and xb may each independently be an integer from 0 to 5, or may be 0, 1, or 2. For example, in Formula 201, xa may be 1, and xb may be 0.

In Formulae 201 and 202, R₁₀₁ to R₁₀₈, R₁₁₁ to R₁₁₉, and R₁₂₁ to R₁₂₄ may each independently be:
hydrogen, deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group (for example, a methyl group, an ethyl group, a propyl group, a butyl group, a pentyl group, a hexyl group, or the like), a C₁-C₁₀ alkoxy group (for example, a methoxy group, an ethoxy group, a propoxy group, a butoxy group, a pentoxy group, or the like), or a C₁-C₁₀ alkylthio group;
a C₁-C₁₀ alkyl group, a C₁-C₁₀ alkoxy group, or a C₁-C₁₀ alkylthio group, each unsubstituted or substituted with deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, or a combination thereof; or
a phenyl group, a naphthyl group, an anthracenyl group, a fluorenyl group, or a pyrenyl group, each unsubstituted or substituted with deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a C₁-C₁₀ alkoxy group, a C₁-C₁₀ alkylthio group, or a combination thereof.

In Formula 201, R₁₀₉ may be a phenyl group, a naphthyl group, an anthracenyl group, or a pyridinyl group, each unsubstituted or substituted with deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁-C₂₀ alkylthio group, a phenyl group, a naphthyl group, an anthracenyl group, a pyridinyl group, or a combination thereof.

In one or more embodiments, the compound represented by Formula 201 may be represented by Formula 201A: 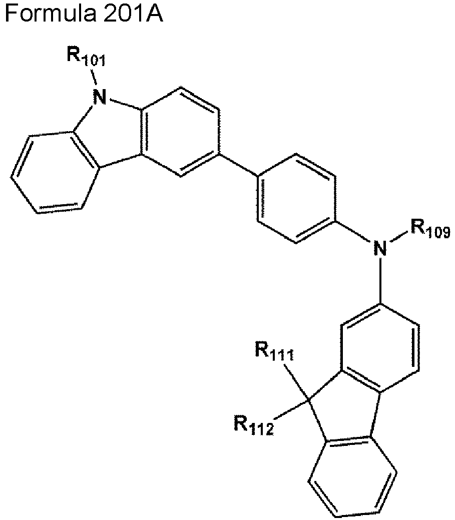 wherein, in Formula 201A, R₁₀₁, R₁₁₁, R₁₁₂, and R₁₀₉ may each be as defined herein.

For example, the hole transport region may include one or more of Compounds HT1 to HT20 or a combination thereof:

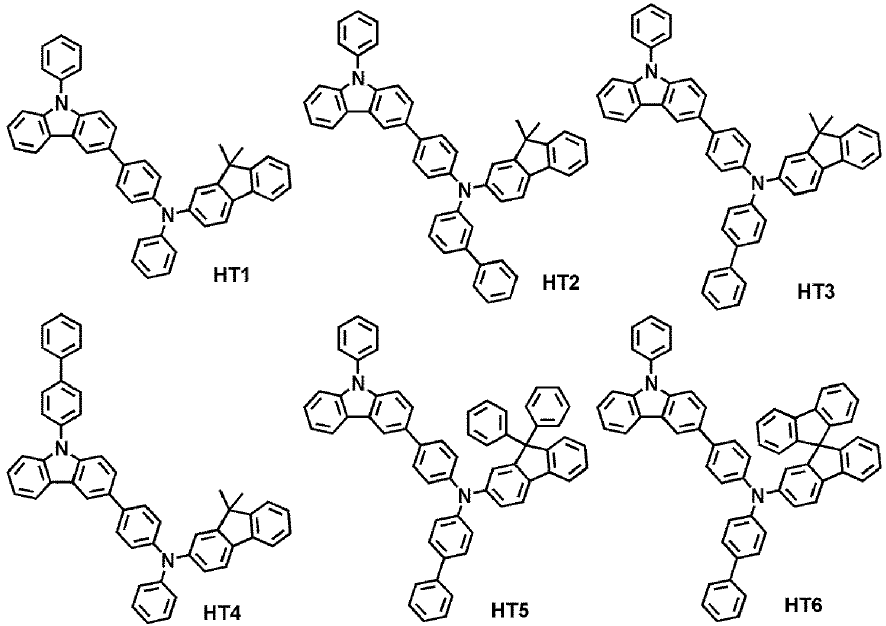

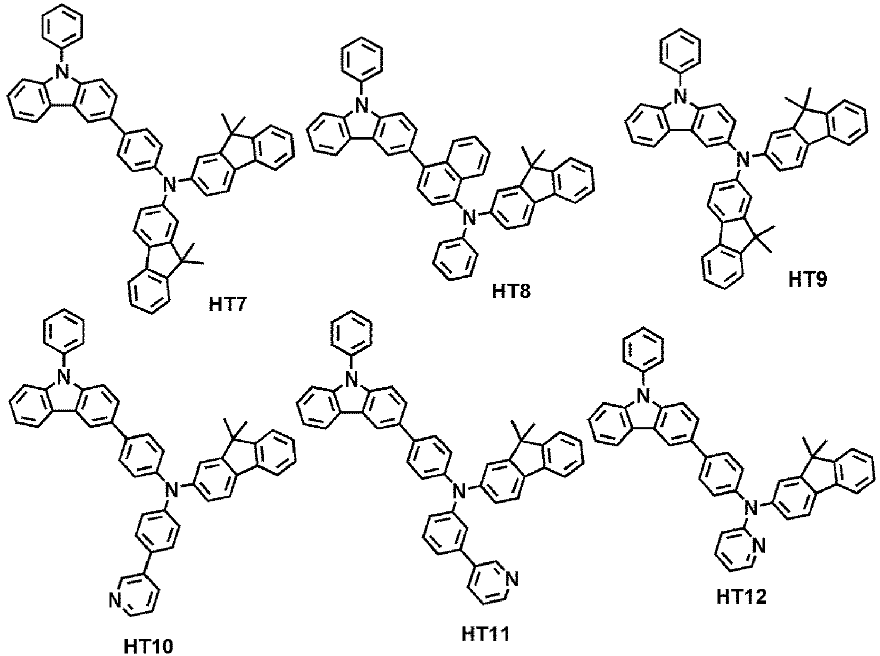

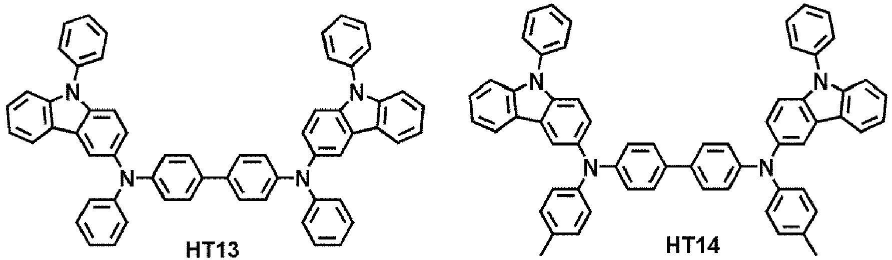

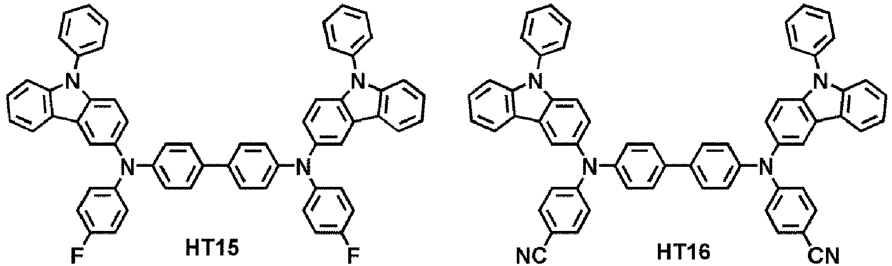

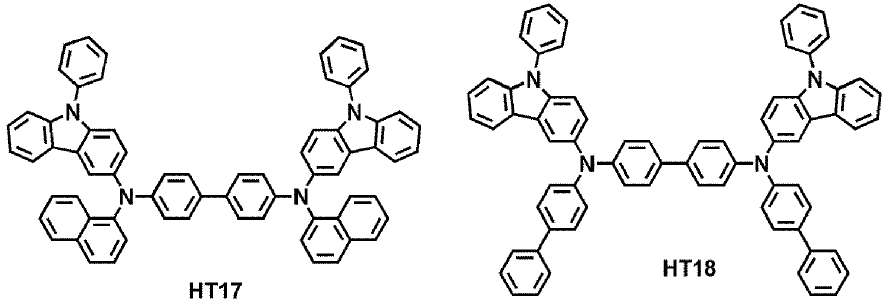

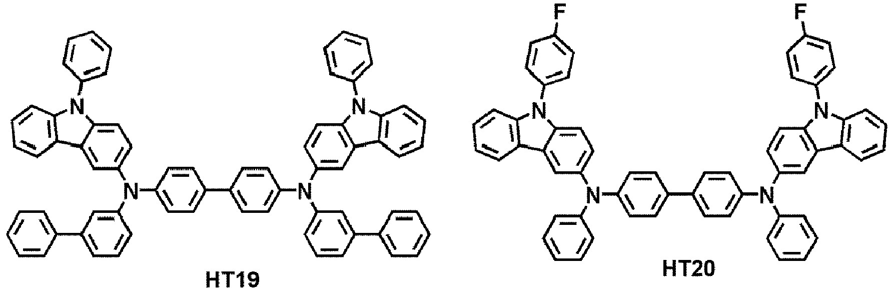

A thickness of the hole transport region may be in a range of about 100 Å to about 10,000 Å, for example, about 100 Å to about 1,000 Å. When the hole transport region includes a hole injection layer, a hole transport layer, an electron blocking layer, or a combination thereof, a thickness of the hole injection layer may be in a range of about 100 Å to about 10,000 Å, for example, about 100 Å to about 1,000 Å, and a thickness of the hole transport layer may be in a range of about 50 Å to about 2,000 Å, for example, about 100 Å to about 1,500 Å. When the thicknesses of the hole transport region, the hole injection layer, and the hole transport layer are within these ranges, satisfactory hole transporting characteristics may be obtained without a substantial increase in driving voltage.

The hole transport region may further include, in addition to these materials, a charge-generation material for the improvement of conductive properties. The charge-generation material may be homogeneously or non-homogeneously dispersed in the hole transport region.

The charge-generation material may be, for example, a p-dopant. The p-dopant may be a quinone derivative, a metal oxide, a cyano group-containing compound, or a combination thereof. For example, the p-dopant may be: a quinone derivative, such as tetracyanoquinodimethane (TCNQ), 2,3,5,6-tetrafluoro-tetracyano-1,4-benzoquinonedimethane (F4-TCNQ), F6-TCNNQ, or the like; metal oxide, such as tungsten oxide, molybdenum oxide, or the like; a cyano group-containing compound, such as Compound HT-D1 or the like; or a combination thereof: 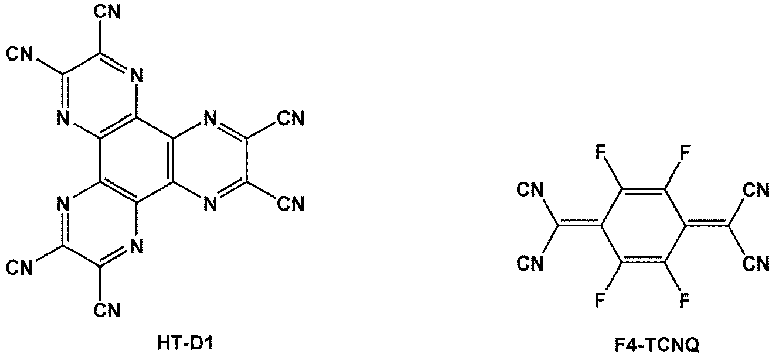 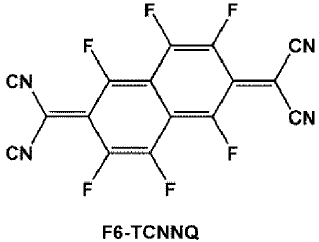 The hole transport region may further include a buffer layer.

The buffer layer may compensate for an optical resonance distance according to a wavelength of light emitted from the emission layer, and thus, efficiency of a formed light-emitting device may be improved.

Meanwhile, when the hole transport region includes an electron blocking layer, a material for forming the electron blocking layer may include a material that is used in the hole transport region as defined above, a host material defined below, or a combination thereof. For example, when the hole transport region includes an electron blocking layer, the material for forming the electron blocking layer may include mCP defined below, Compound H-H1 defined below, or a combination thereof.

Then, the emission layer 15 may be formed on the hole transport region by using methods, such as vacuum deposition, spin coating, casting, LB deposition, or the like. When the emission layer is formed by vacuum deposition or spin coating, the deposition or coating conditions may be similar to those applied in forming the hole injection layer although the deposition or coating conditions may vary depending on a material that is used to form the emission layer.

In one or more embodiments, the emission layer may include the composition including the first compound represented by Formula 1 and the second compound represented by Formula 2 as defined herein. In one or more embodiments, the emission layer may include the layer including the composition including the first compound represented by Formula 1 and the second compound represented by Formula 2 as defined herein.

In one or more embodiments, the emission layer may include a host and a dopant, wherein the host does not include a transition metal, and the dopant includes the composition including the first compound represented by Formula 1 and the second compound represented by Formula 2 as defined herein.

The host may include 1,3,5-tri(1-phenyl-1H-benzo[d]imidazol-2-yl)benzene (TPBi), 3-tert-butyl-9,10-di(naphth-2-yl)anthracene (TBADN), 9,10-di(naphthalene-2-yl)anthracene (ADN, also referred to as "DNA"), 4,4'-bis(N-carbazolyl)-1,1'-biphenyl (CBP), 4,4'-bis(9-carbazolyl)-2,2'-dimethyl-biphenyl (CDBP), TCP, mCP, Compound H50, Compound H51, Compound H52, Compound H-H1, Compound H-H2, or a combination thereof:

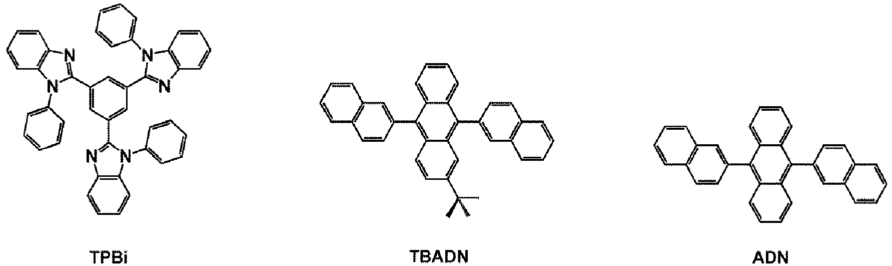

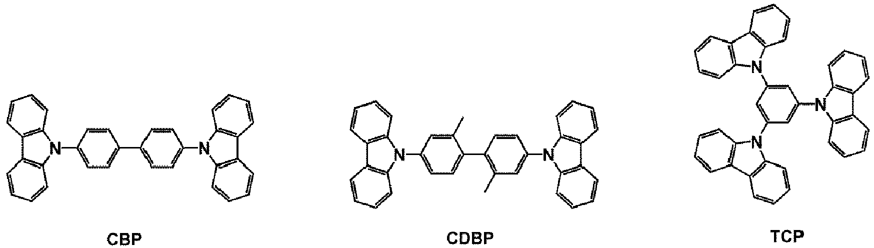

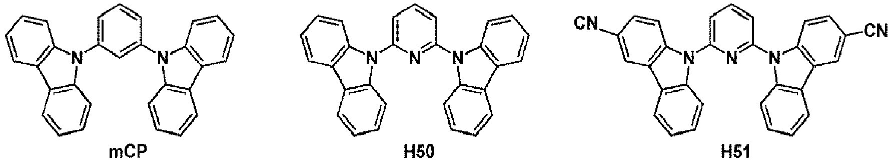

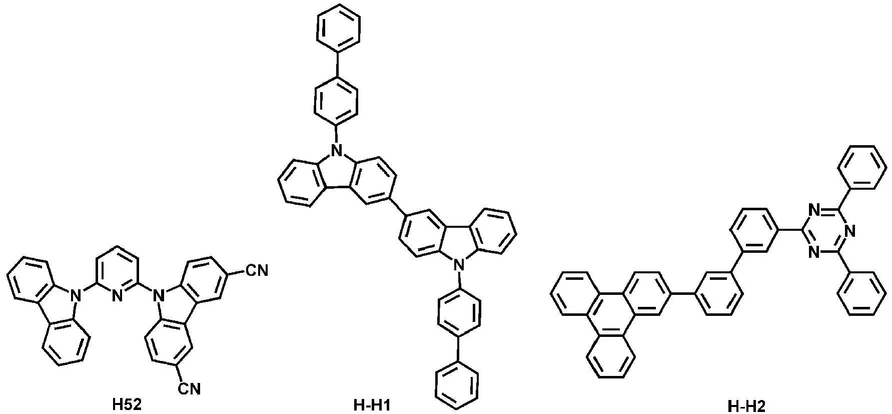

When the light-emitting device is a full-color light-emitting device, the emission layer may be patterned into a red emission layer, a green emission layer, and/or a blue emission layer.

A thickness of the emission layer may be in a range of about 100 Å to about 1,000 Å, for example, about 200 Å to about 600 Å. When the thickness of the emission layer is within these ranges, excellent light-emission characteristics may be obtained without a substantial increase in driving voltage.

Next, the electron transport region may be arranged on the emission layer.

The electron transport region may include a hole blocking layer, an electron transport layer, an electron injection layer, or a combination thereof.

For example, the electron transport region may have a hole blocking layer/electron transport layer/electron injection layer structure or an electron transport layer/electron injection layer structure. The electron transport layer may have a single-layered structure or a multi-layered structure including two or more different materials.

Conditions for forming a hole blocking layer, an electron transport layer, and an electron injection layer which constitute the electron transport region may be understood by referring to the conditions for forming the hole injection layer.

When the electron transport region includes a hole blocking layer, the hole blocking layer may include, for example, 2,9-dimethyl-4,7-diphenyl-1,10-phenanthroline (BCP), 4,7-diphenyl-1,10-phenanthroline (Bphen), bis(2-methyl-8-quinolinolato-N1,O8)-(1,1'-biphenyl-4-olato)aluminum (Balq, or a combination thereof:

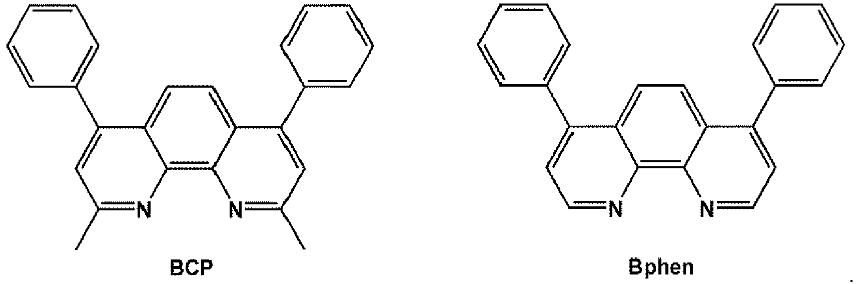

A thickness of the hole blocking layer may be in a range of about 20 Å to about 1,000 Å, for example, about 30 Å to about 600 Å. When the thickness of the hole blocking layer is within these ranges, excellent hole blocking characteristics may be obtained without a substantial increase in driving voltage.

In one or more embodiments, the electron transport layer may include 2,9-dimethyl-4,7-diphenyl-1,10-phenanthroline (BCP), Bphen, TPBi, tris(8-hydroxyquinolinato)aluminum (Alq₃), Balq, 3-(4-biphenylyl)-4-phenyl-5-tert-butylphenyl-1,2,4-triazole (TAZ), 4-(naphthalen-1-yl)-3,5-diphenyl-4H-1,2,4-triazole (NTAZ), or a combination thereof:

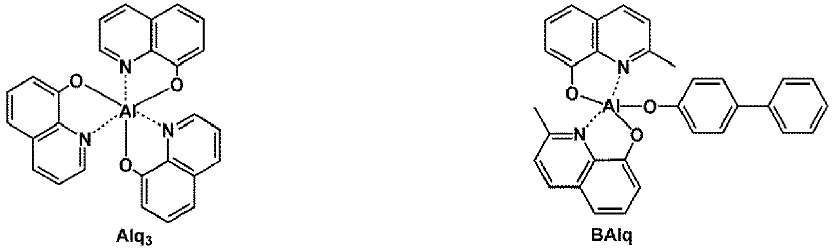

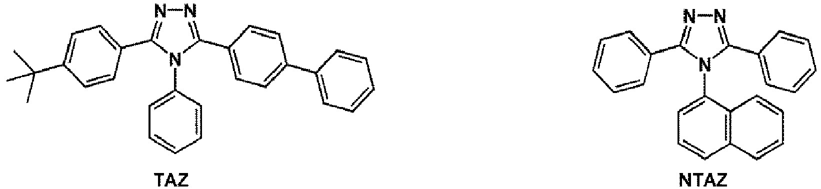

In one or more embodiments, the electron transport layer may include one or more of Compounds ET1 to ET25:

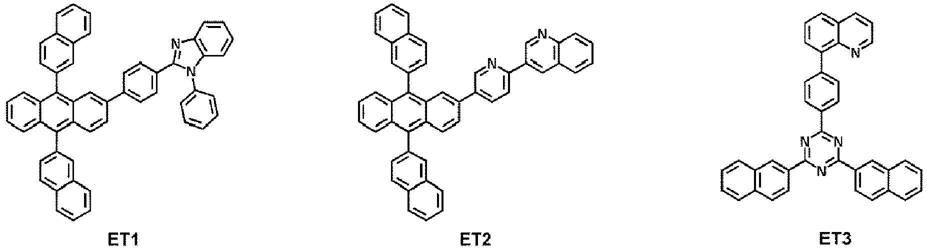

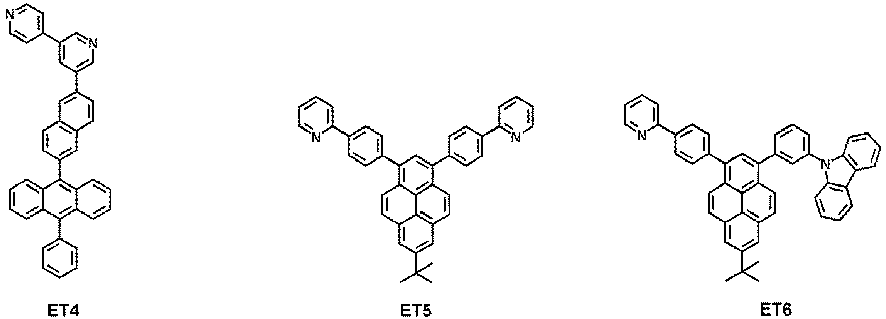

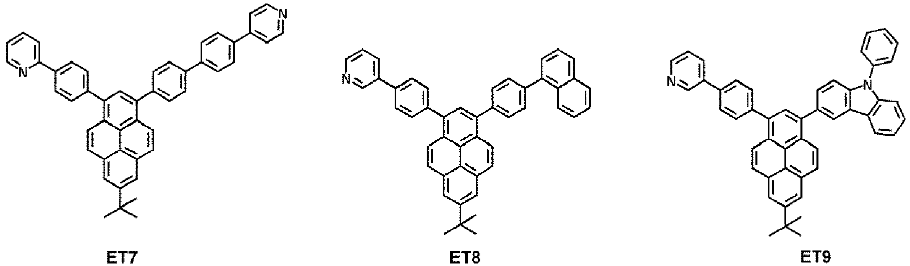

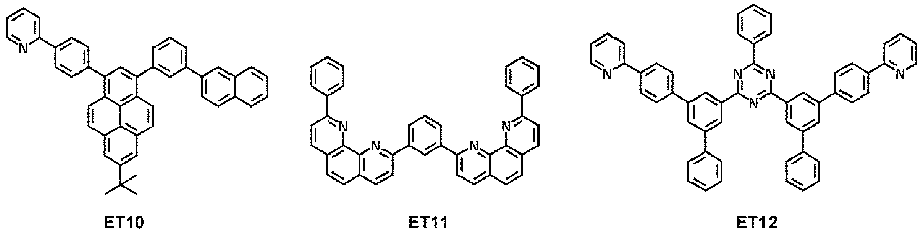

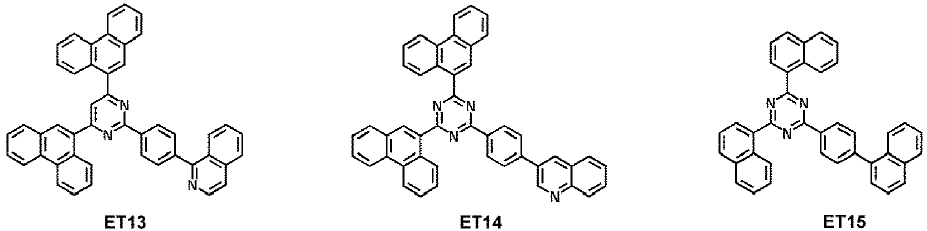

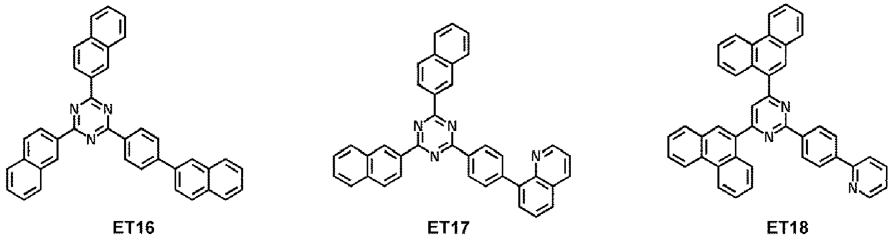

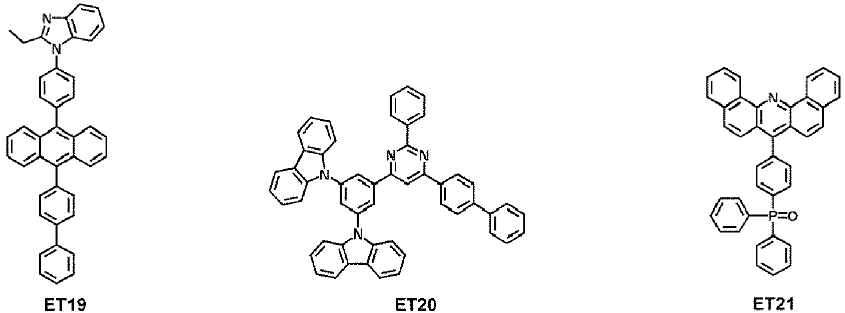

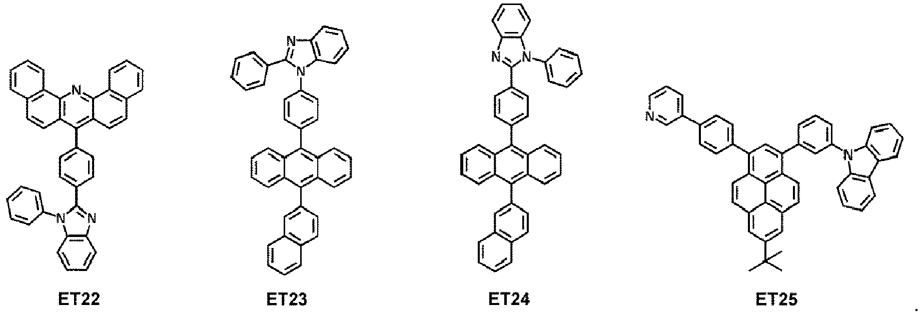

A thickness of the electron transport layer may be in a range of about 100 Å to about 1,000 Å, for example, about 150 Å to about 500 Å. When the thickness of the electron transport layer is within these ranges, satisfactory electron transporting characteristics may be obtained without a substantial increase in driving voltage.

The electron transport layer may include a metal-containing material in addition to the material as defined above.

The metal-containing material may include a Li complex. The Li complex may include, for example, Compound ET-D1 or ET-D2:

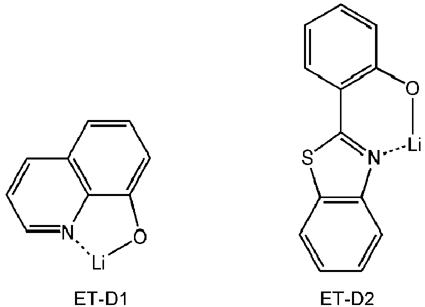

The electron transport region may also include an electron injection layer that promotes the flow of electrons from the second electrode 19 thereinto.

The electron injection layer may include LiF, NaCl, CsF, Li₂O, BaO, Compound ET-D1, Compound ET-D2, or a combination thereof.

A thickness of the electron injection layer may be in a range of about 1 Å to about 100 Å, and, for example, about 3 Å to about 90 Å. When the thickness of the electron injection layer is within these ranges, satisfactory electron injection characteristics may be obtained without a substantial increase in driving voltage.

The second electrode 19 may be arranged on the organic layer 15. The second electrode 19 may be a cathode. A material for forming the second electrode 19 may be metal, an alloy, an electrically conductive compound, or a combination thereof, which have a relatively low work function. For example, the material for forming the second electrode 19 may be Li, Mg, Al, Ag, Al-Li, Ca, Mg-ln, Mg-Ag, or the like. To manufacture a top-emission type light-emitting device, various modifications are possible, and for example, a transmissive electrode formed using ITO or IZO may be used as the second electrode 19.

Hereinbefore, the light-emitting device 10 according to one or more embodiments has been described in connection with the FIGURE, but the one or more embodiments of the present disclosure are not limited thereto.

For example, the light-emitting device may be included in an electronic apparatus. Thus, another aspect of the present disclosure provides an electronic apparatus including the light-emitting device. The electronic apparatus may include, for example, a display, an illumination, a sensor, and the like.

The term "C₁-C₆₀ alkyl group" as used herein refers to a linear or branched saturated aliphatic hydrocarbons monovalent group having 1 to 60 carbon atoms, and the term "C₁-C₆₀ alkylene group" as used herein refers to a divalent group having the same structure as the C₁-C₆₀ alkyl group.

Examples of the C₁-C₆₀ alkyl group, the C₁-C₂₀ alkyl group, and/or the C₁-C₁₀ alkyl group are a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, or a tert-decyl group, each unsubstituted or substituted with a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, or a combination thereof. For example, Formula 9-33 is a branched C₆ alkyl group, and an example thereof is a tert-butyl group that is substituted with two methyl groups.

The term "C₁-C₆₀ alkoxy group" as used herein refers to a monovalent group represented by -OA₁₀₁ (wherein A₁₀₁ is the C₁-C₆₀ alkyl group), and examples thereof are a methoxy group, an ethoxy group, a propoxy group, a butoxy group, and a pentoxy group.

The term "C₁-C₆₀ alkylthio group" as used herein refers to a monovalent group represented by -OA₁₀₁ (wherein A₁₀₁ is the C₁-C₆₀ alkyl group).

The term "C₂-C₆₀ alkenyl group" as used herein refers to a hydrocarbon group formed by substituting at least one carbon-carbon double bond in the middle or at the terminus of the C₂-C₆₀ alkyl group, and examples thereof are an ethenyl group, a propenyl group, and a butenyl group. The term "C₂-C₆₀ alkenylene group" as used herein refers to a divalent group having the same structure as the C₂-C₆₀ alkenyl group.

The term "C₂-C₆₀ alkynyl group" as used herein refers to a hydrocarbon group formed by substituting at least one carbon-carbon triple bond in the middle or at the terminus of the C₂-C₆₀ alkyl group, and examples thereof are an ethynyl group and a propynyl group. The term "C₂-C₆₀ alkynylene group" as used herein refers to a divalent group having the same structure as the C₂-C₆₀ alkynyl group.

The term "C₃-C₁₀ cycloalkyl group" as used herein refers to a monovalent saturated hydrocarbon cyclic group having 3 to 10 carbon atoms, and the term "C₃-C₁₀ cycloalkylene group" as used herein refers to a divalent group having the same structure as the C₃-C₁₀ cycloalkyl group.

Examples of the C₃-C₁₀ cycloalkyl group are a cyclopropyl group, a cyclobutyl group, a cyclopentyl, cyclohexyl group, a cycloheptyl group, a cyclooctyl group, an adamantanyl group, a norbornanyl group (or a bicyclo[2.2.1]heptyl group), a bicyclo[1.1.1]pentyl group, a bicyclo[2.1.1]hexyl group, and a bicyclo[2.2.2]octyl group.

The term "C₁-C₁₀ heterocycloalkyl group" as used herein refers to a saturated monovalent cyclic group that includes at least one heteroatom selected from N, O, P, Si, S, Se, Ge, B, or a combination thereof as one or more ring-forming atom(s) and 1 to 10 carbon atoms as ring-forming atom(s), and the term "C₁-C₁₀ heterocycloalkylene group" as used herein refers to a divalent group having the same structure as the C₁-C₁₀ heterocycloalkyl group.

Examples of the C₁-C₁₀ heterocycloalkyl group are a silolanyl group, a silinanyl group, a tetrahydrofuranyl group, a tetrahydro-2H-pyranyl group, and a tetrahydrothiophenyl group.

The term "C₃-C₁₀ cycloalkenyl group" as used herein refers to a monovalent monocyclic group that includes 3 to 10 carbon atoms and at least one carbon-carbon double bond in the ring thereof and has no aromaticity, and examples thereof are a cyclopentenyl group, a cyclohexenyl group, and a cycloheptenyl group. The term "C₃-C₁₀ cycloalkenylene group" as used herein refers to a divalent group having the same structure as the C₃-C₁₀ cycloalkenyl group.

The term "C₁-C₁₀ heterocycloalkenyl group" as used herein refers to a monovalent monocyclic group that includes at least one heteroatom selected from N, O, P, Si, S, Se, Ge, B, or a combination as one or more ring-forming atom(s), 1 to 10 carbon atoms as ring forming atom(s), and at least one carbon-carbon double bond in the ring thereof. Examples of the C₁-C₁₀ heterocycloalkenyl group are a 2,3-dihydrofuranyl group and a 2,3-dihydrothiophenyl group. The term "C₁-C₁₀ heterocycloalkenylene group" as used herein refers to a divalent group having the same structure as the C₁-C₁₀ heterocycloalkenyl group.

The term "C₆-C₆₀ aryl group" as used herein refers to a monovalent group having a carbocyclic aromatic system having 6 to 60 carbon atoms, and the term "C₆-C₆₀ arylene group" as used herein refers to a divalent group having a carbocyclic aromatic system having 6 to 60 carbon atoms. Examples of the C₆-C₆₀ aryl group are a phenyl group, a naphthyl group, an anthracenyl group, a phenanthrenyl group, a pyrenyl group, and a chrysenyl group. When the C₆-C₆₀ aryl group and the C₆-C₆₀ arylene group each include two or more rings, the rings may be fused to each other.

The term "C₇-C₆₀ alkyl aryl group" as used herein refers to a C₆-C₆₀ aryl group substituted with at least one C₁-C₆₀ alkyl group, and the term "C₇-C₆₀ aryl alkyl group" as used herein refers to a C₁-C₆₀ alkyl group substituted with at least one C₆-C₆₀ aryl group.

The term "C₁-C₆₀ heteroaryl group" as used herein refers to a monovalent group that includes at least one heteroatom selected from N, O, P, Si, S, Se, Ge, B, or a combination thereof as one or more ring-forming atom(s) in a cyclic aromatic system having 1 to 60 carbon atoms, and the term "C₁-C₆₀ heteroarylene group" as used herein refers to a divalent group that includes at least one heteroatom selected from N, O, P, Si, S, Se, Ge, B, or a combination thereof as ring-forming atom(s) and a carbocyclic aromatic system having 1 to 60 carbon atoms. Examples of the C₁-C₆₀ heteroaryl group are a pyridinyl group, a pyrimidinyl group, a pyrazinyl group, a pyridazinyl group, a triazinyl group, a quinolinyl group, and an isoquinolinyl group. When the C₆-C₆₀ heteroaryl group and the C₆-C₆₀ heteroarylene group each include two or more rings, the rings may be fused to each other.

The term "C₂-C₆₀ alkyl heteroaryl group" as used herein refers to a C₁-C₆₀ heteroaryl group substituted with at least one C₁-C₆₀ alkyl group. The term "C₂-C₆₀ heteroaryl alkyl group" as used herein refers to a C₁-C₆₀ alkyl group substituted with at least one C₁-C₆₀ heteroaryl group.

The term "C₆-C₆₀ aryloxy group" as used herein indicates -OA₁₀₂ (wherein A₁₀₂ is the C₆-C₆₀ aryl group), the term "C₆-C₆₀ arylthio group" as used herein indicates -SA₁₀₃ (wherein A₁₀₃ is the C₆-C₆₀ aryl group), and the term "C₁-C₆₀ alkylthio group" as used herein indicates -SA₁₀₄ (wherein A₁₀₄ is the C₁-C₆₀ alkyl group).

The term "C-C₆₀ heteroaryloxy group" as used herein indicates -OA_{102'} (wherein A_{102'} is the C₁-C₆₀ heteroaryl group), and the term "C₁-C₆₀ heteroarylthio group" as used herein indicates -SA_{103'} (wherein A_{103'} is the C₁-C₆₀ heteroaryl group).

The term "monovalent non-aromatic condensed polycyclic group" as used herein refers to a monovalent group (for example, having 8 to 60 carbon atoms) having two or more rings condensed to each other, only carbon atoms as ring-forming atoms, and no aromaticity in its entire molecular structure. An example of the monovalent non-aromatic condensed polycyclic group is a fluorenyl group. The term "divalent non-aromatic condensed polycyclic group" as used herein refers to a divalent group having the same structure as a monovalent non-aromatic condensed polycyclic group.

The term "monovalent non-aromatic condensed heteropolycyclic group" as used herein refers to a monovalent group (for example, having 1 to 60 carbon atoms) having two or more rings condensed to each other, at least one hetero atom selected from N, O, P, Si, S, Se, Ge, B, or a combination thereof other than carbon atoms, as a ring-forming atom, and no aromaticity in its entire molecular structure. An example of the monovalent non-aromatic condensed heteropolycyclic group is a carbazolyl group. The term "divalent non-aromatic condensed heteropolycyclic group" as used herein refers to a divalent group having the same structure as a monovalent non-aromatic condensed heteropolycyclic group.

The term "C₅-C₃₀ carbocyclic group" as used herein refers to a saturated or unsaturated cyclic group having, as ring-forming atoms, 5 to 30 carbon atoms only. The C₅-C₃₀ carbocyclic group may be a monocyclic group or a polycyclic group. Examples of the "C₅-C₃₀ carbocyclic group (unsubstituted or substituted with at least one R₁₀ₐ)" as used herein are an adamantane group, a norbornene group, a bicyclo[1.1.1]pentane group, a bicyclo[2.1.1]hexane group, a bicyclo[2.2.1]heptane(norbornane) group, a bicyclo[2.2.2]octane group, a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, and a fluorene group (each unsubstituted or substituted with at least one R₁₀ₐ).

The term "C₁-C₃₀ heterocyclic group" as used herein refers to a saturated or unsaturated cyclic group having, as ring-forming atom(s), at least one heteroatom selected from N, O, P, Si, S, Se, Ge, B, or a combination thereof in a ring system having 1 to 30 carbon atoms. The C₁-C₃₀ heterocyclic group may be a monocyclic group or a polycyclic group. Examples of the "C₁-C₃₀ heterocyclic group (unsubstituted or substituted with at least one R₁₀ₐ)" as used herein are a thiophene group, a furan group, a pyrrole group, a silole group, borole group, a phosphole group, a selenophene group, a germole group, a benzothiophene group, a benzofuran group, an indole group, a benzosilole group, a benzoborole group, a benzophosphole group, a benzoselenophene group, a benzogermole group, a dibenzothiophene group, a dibenzofuran group, a carbazole group, a dibenzosilole group, a dibenzoborole group, a dibenzophosphole group, a dibenzoselenophene group, a dibenzogermole group, a dibenzothiophene 5-oxide group, a 9H-fluoren-9-one group, a dibenzothiophene 5,5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group (each unsubstituted or substituted with at least one R₁₀ₐ).

Examples of the "C₅-C₃₀ carbocyclic group" and "C₁-C₃₀ heterocyclic group" as used herein are i) a first ring, ii) a second ring, iii) a condensed ring in which two or more first rings are condensed with each other, iv) a condensed ring in which two or more second rings are condensed with each other, or v) a condensed ring in which at least one first ring is condensed with at least one second ring,
wherein the first ring is a cyclopentane group, a cyclopentene group, a furan group, a thiophene group, a pyrrole group, a silole group, a borole group, a phosphole group, a germole group, a selenophene group, an oxazole group, an oxadiazole group, an oxatriazole group, a thiazole group, a thiadiazole group, a thiatriazole group, a pyrazole group, an imidazole group, a triazole group, a tetrazole group, or an azasilole group, and
the second ring is an adamantane group, a norbornane group, a norbornene group, a cyclohexane group, a cyclohexene group, a benzene group, a pyridine group, a pyrimidine group, a pyrazine group, a pyridazine group, or a triazine group.

The terms "fluorinated C₁-C₆₀ alkyl group (or fluorinated C₁-C₂₀ alkyl group or the like)", "fluorinated C₃-C₁₀ cycloalkyl group", "fluorinated C₁-C₁₀ heterocycloalkyl group," and "fluorinated phenyl group" respectively indicate a C₁-C₆₀ alkyl group (or a C₁-C₂₀ alkyl group or the like), a C₃-C₁₀ cycloalkyl group, a C₁-C₁₀ heterocycloalkyl group, and a phenyl group, each substituted with at least one fluoro group. For example, the term "fluorinated C₁ alkyl group (that is, a fluorinated methyl group)" includes -CF₃, -CF₂H, and -CFH₂. The "fluorinated C₁-C₆₀ alkyl group (or fluorinated C₁-C₂₀ alkyl group or the like)", "the fluorinated C₃-C₁₀ cycloalkyl group", "the fluorinated C₁-C₁₀ heterocycloalkyl group", or "the fluorinated phenyl group" may be i) a fully fluorinated C₁-C₆₀ alkyl group (or a fully fluorinated C₁-C₂₀ alkyl group or the like), a fully fluorinated C₃-C₁₀ cycloalkyl group, a fully fluorinated C₁-C₁₀ heterocycloalkyl group, or a fully fluorinated phenyl group, wherein, in each group, all hydrogen included therein are substituted with a fluoro group, or ii) a partially fluorinated C₁-C₆₀ alkyl group (or, a partially fluorinated C₁-C₂₀ alkyl group, or the like), a partially fluorinated C₃-C₁₀ cycloalkyl group, a partially fluorinated C₁-C₁₀ heterocycloalkyl group, or partially fluorinated phenyl group, wherein, in each group, all hydrogen included therein are not substituted with a fluoro group.

The terms "deuterated C₁-C₆₀ alkyl group (or deuterated C₁-C₂₀ alkyl group or the like)", "deuterated C₃-C₁₀ cycloalkyl group", "deuterated C₁-C₁₀ heterocycloalkyl group," and "deuterated phenyl group" respectively indicate a C₁-C₆₀ alkyl group (or a C₁-C₂₀ alkyl group or the like), a C₃-C₁₀ cycloalkyl group, a C₁-C₁₀ heterocycloalkyl group, and a phenyl group, each substituted with at least one deuterium. For example, the "deuterated C₁ alkyl group (that is, deuterated methyl group)" may include -CD₃, -CD₂H, and -CDH₂, and examples of the "deuterated C₃-C₁₀ cycloalkyl group" are Formula 10-501 or the like. The "deuterated C₁-C₆₀ alkyl group (or deuterated C₁-C₂₀ alkyl group or the like)", "the deuterated C₃-C₁₀ cycloalkyl group", "the deuterated C₁-C₁₀ heterocycloalkyl group", or "the deuterated phenyl group" may be i) a fully deuterated C₁-C₆₀ alkyl group (or, a fully deuterated C₁-C₂₀ alkyl group or the like), a fully deuterated C₃-C₁₀ cycloalkyl group, a fully deuterated C₁-C₁₀ heterocycloalkyl group, or a fully deuterated phenyl group, in which, in each group, all hydrogen included therein are substituted with deuterium, or ii) a partially deuterated C₁-C₆₀ alkyl group (or, a partially deuterated C₁-C₂₀ alkyl group or the like), a partially deuterated C₃-C₁₀ cycloalkyl group, a partially deuterated C₁-C₁₀ heterocycloalkyl group, or a partially deuterated phenyl group, in which, in each group, all hydrogen included therein are not substituted with deuterium.

The term "(C₁-C₂₀ alkyl) 'X' group" as used herein refers to a 'X' group that is substituted with at least one C₁-C₂₀ alkyl group. For example, the term "(C₁-C₂₀ alkyl)C₃-C₁₀ cycloalkyl group" as used herein refers to a C₃-C₁₀ cycloalkyl group substituted with at least one C₁-C₂₀ alkyl group, and the term "(C₁-C₂₀ alkyl)phenyl group" as used herein refers to a phenyl group substituted with at least one C₁-C₂₀ alkyl group. An example of the term (C₁ alkyl) phenyl group is a toluyl group.

The terms "an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, and an azadibenzothiophene 5,5-dioxide group" respectively refer to heterocyclic groups having the same backbones as "an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluoren-9-one group, and a dibenzothiophene 5,5-dioxide group," in which, in each group, at least one ring-forming carbon atom is substituted with nitrogen.

At least one substituent of the substituted C₅-C₃₀ carbocyclic group, the substituted C₂-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, and the substituted monovalent non-aromatic condensed heteropolycyclic group may be:
deuterium, -F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C1-C60 alkyl group, a C₂-C₆₀ alkenyl group, a C₂-C₆₀ alkynyl group, a C₁-C₆₀ alkoxy group, or a C₁-C₆₀ alkylthio group;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with at least one of deuterium, -F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₁₁)(O₁₂), -Si(Q₁₃)(Q₁₄)(Q₁₅), -Ge(Q₁₃)(Q₁₄)(Q₁₅), - B(Q₁₆)(Q₁₇), -P(=O)(Q₁₈)(Q₁₉), -P(Q₁₈)(Q₁₉), or a combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each unsubstituted or substituted with at least one of deuterium, -F, -CI, -Br, -I, -CD₃, - CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅), -Ge(Q₂₃)(Q₂₄)(Q₂₅), - B(Q₂₆)(Q₂₇), -P(=O)(Q₂₈)(Q₂₉), -P(Q₂₈)(Q₂₉), or a combination thereof;
-N(Q₃₁)(Q₃₂), -Si(Q₃₃)(Q₃₄)(Q₃₅), -Ge(Q₃₃)(Q₃₄)(Q₃₅), -B(Q36)(Q37), - P(=O)(Q₃₈)(Q₃₉), or -P(Q₃₈)(Q₃₉); or
a combination thereof.

In the present specification, Q₁ to Q₉, Q₁₁ to Q₁₉, Q₂₁ to Q₂₉, and Q₃₁ to Q₃₉ may each independently be: hydrogen, deuterium, -F, -CI, -Br, -I, a hydroxyl group; a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each unsubstituted or substituted with at least one of deuterium, a C₁-C₆₀ alkyl group, a C₆-C₆₀ aryl group, or a combination thereof.

For example, Q₁ to Q₉, Q₁₁ to Q₁₉, Q₂₁ to Q₂₉, and Q₃₁ to Q₃₉ may each independently be:
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, or -CD₂CDH₂; or
an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with deuterium, a C₁-C₁₀ alkyl group, a phenyl group, or a combination thereof.

Hereinafter, a composition and a light-emitting device according to one or more embodiments are described in further detail with reference to Synthesis Examples and Examples. However, the present disclosure is not limited thereto. The wording "B was used instead of A" used in describing Synthesis Examples means that an amount of A used was identical to an amount of B used, in terms of a molar equivalent.

### Examples

Synthesis Example 1 (Compound Pt-1 or Compound 3-302 of Group 1-1)

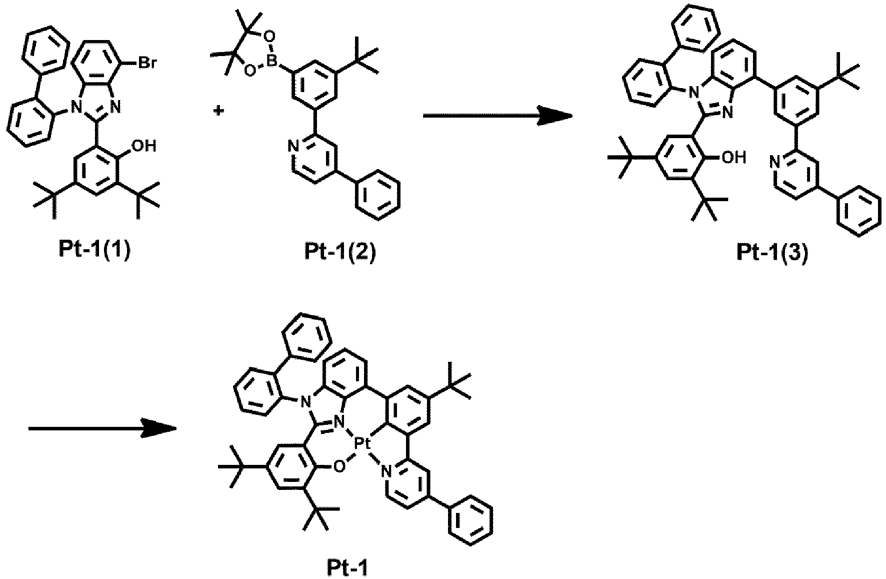

### Synthesis of Compound Pt-1(3)

2.6 grams (g) (0.006 moles (mol), 1.2 equivalents (equiv.)) of Compound Pt-1(2), 3.0 g (0.005 mol, 1 equiv.) of Compound Pt-1(1), 0.43 g (0.00037 mol, 0.07 equiv.) of tetrakis(triphenylphosphine)palladium(0), and 2.3 g (0.016 mol, 3 equiv.) of potassium carbonate were mixed with 20 mL of a mixture including tetrahydrofuran (THF) and deionized (DI) water at a volume ratio of 3:1, and the mixed solution was heated at reflux for 12 hours. The reaction mixture then was allowed to cool to room temperature, and the precipitate was removed therefrom by filtration. The filtrate was then washed with ethyl acetate (EA)/H₂O, the solvents were removed under reduced pressure, and column chromatography (EA/hexanes (Hex) with an elution gradient of 8 % to 12 % (by volume, the same below) of EA) was performed on the residue, to obtain 3.7 g (yield of 90 %) of Compound Pt-1(3). The obtained compound was identified by high resolution mass spectrometry (HRMS) using matrix assisted laser desorption ionization (MALDI) and high-performance liquid chromatography (HPLC) analysis.

HRMS (MALDI) calcd for C₅₄H₅₃N₃O: m/z 759.4189, Found: 759.4187.

### Synthesis of Compound Pt-1

3.7 g (4.9 mmol, 1 equiv.) of Compound Pt-1(3) and 2.4 g (5.8 mmol, 1.2 equiv.) of K₂PtCl₄ were mixed with 70 mL of a mixture including 60 mL of AcOH and 10 mL of DI water, and the mixed solution was heated at reflux for 16 hours. The reaction mixture then was allowed to cool to room temperature, and the precipitate was removed therefrom by filtration. The filtrate was then dissolved in methylene chloride (MC) and washed with DI water. Subsequently, the solvents were removed under reduced pressure, and column chromatography (MC 30 % to 35 %/Hex 65 % to 70 %) was performed on the residue, so as to obtain 1.72 g (yield of 37 %, purity of 99.9 % or greater) of Compound Pt-1. The obtained compound was identified by HRMS and HPLC analysis.

HRMS (MALDI) calcd for C₅₄H₅₁N₃OPt: m/z 952.3680, Found: 952.3682.

Synthesis Example 2 (Compound Pt-2 or Compound 30 of Group 1-3)

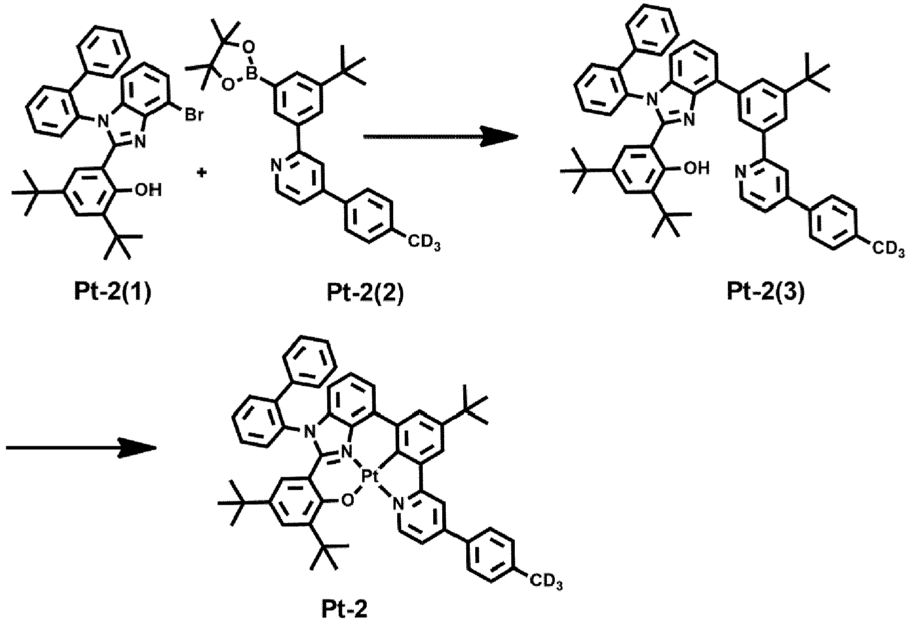

### Synthesis of Compound Pt-2(3)

2.7 g (0.006 mol, 1.2 equiv.) of Compound Pt-2(2), 3.0 g (0.005 mol, 1 equiv.) of Compound Pt-2(1), 0.44 g (0.00038 mol, 0.07 equiv.) of tetrakis(triphenylphosphine)palladium(0), and 2.2 g (0.016 mmol, 3 equiv.) of potassium carbonate were mixed with 20 mL of a mixture including tetrahydrofuran (THF) and deionized (DI) water at a volume ratio of 3:1, and the mixed solution was heated at reflux for 12 hours. The reaction mixture then was allowed to cool to room temperature, and the precipitate was removed therefrom by filtration. The filtrate was then washed with EA/H₂O, the solvents were removed under reduced pressure, and column chromatography (EA/Hex with an elution gradient of 8 % to 12 % of EA) was performed thereon, so as to obtain 3.6 g (yield of 85 %) of Compound Pt-2(3). The obtained compound was identified by HRMS and HPLC analysis.

HRMS (MALDI) calcd for C₅₅H₅₂D₃N₃O: m/z 776.4533 , Found: 776.4535.

### Synthesis of Compound Pt-2

3.6 g (4.6 mmol, 1 equiv.) of Compound Pt-2(3) and 2.3 g (5.6 mmol, 1.2 equiv.) of K₂PtCl₄ were mixed with 70 mL of a mixture including 60 mL of AcOH and 10 mL of DI water, and the mixed solution was heated at reflux for 16 hours. The reaction mixture then was allowed to cool to room temperature, and the precipitate was removed therefrom by filtration. The filtrate was then dissolved in MC and then washed with DI water. Subsequently, the solvents were removed under reduced pressure, and column chromatography (MC 30 % to 35 %/Hex 65 % to 70 %) was performed on the residue, so as to obtain 1.75 g (yield of 39 %, purity of 99.9 % or greater) of Compound Pt-2. The obtained compound was identified by HRMS and HPLC analysis.

HRMS (MALDI) calcd for C₅₅H₅₀D₃N₃OPt: m/z 969.4025, Found: 969.4027.

Synthesis Example 3 (Compound Ir-1 or Compound 16 of Group 2-1

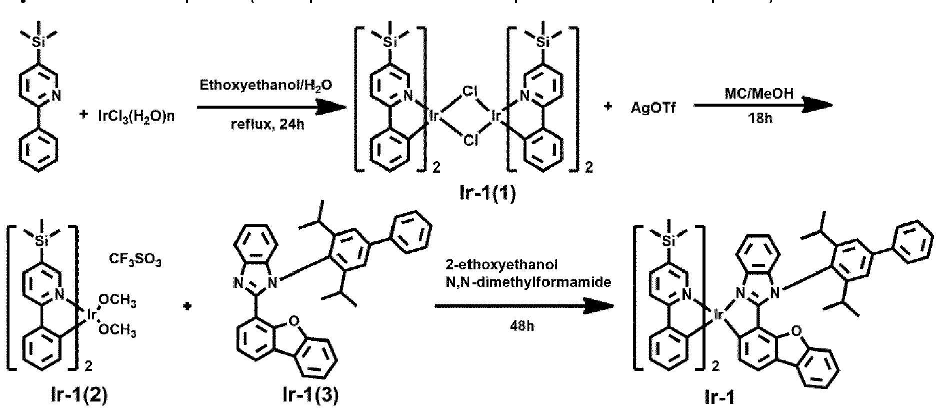

### Synthesis of Compound Ir-1(1)

2-phenyl-5-(trimethylsilyl)pyridine (7.5 g, 33.1 mmol) and iridium chloride hydrate (IrCl₃·(H₂O)ₙ, n=3) (5.2 g, 14.7 mmol) were mixed with 120 mL of ethoxyethanol and 40 mL of DI water, and the mixed solution was stirred while heating at reflux for 24 hours. Then, the reaction mixture was allowed to cool to room temperature. The resultant solid was separated therefrom by filtration, washed sufficiently with water, methanol, and hexanes, in this stated order, and then dried in a vacuum oven, so as to obtain 8.2 g (yield of 82 %) of Compound Ir-1(1).

### Synthesis of Compound Ir-1(2)

Compound Ir-1(1) (1.6 g, 1.2 mmol) and 45 mL of methylene chloride were mixed, and a mixture of silver trifluoromethanesulfonate (AgOTf, 0.6 g, 2.3 mmol) and 15 mL of methanol (MeOH) was added thereto. Afterwards, the resultant mixture was stirred for 18 hours at room temperature while light was blocked with aluminum foil, and then filtered through diatomaceous earth to remove the resultant solid, and the filtrate was subjected to a reduced pressure to obtain a solid (Compound Ir1-2). Compound Ir1-2 was used in the next reaction without an additional purification process.

### Synthesis of Compound Ir-1

Compound Ir-1 (2) (1.8 g, 2.15 mmol) and Compound Ir-1 (3) (2-(dibenzo[b,d]furan-4-yl)-1-(3,5-diisopropyl-[1,1'-biphenyl]-4-yl)-1H-benzo[d]imidazole, 1.0 g, 2.04 mmol) were mixed with 10 mL of 2-ethoxyethanol and 10 mL of N,N-dimethylformamide, and the mixed solution was stirred while heating at reflux for 48 hours. Then, the reaction mixture was allowed to cool to room temperature. The product thus obtained was decompressed, and the resultant solid was subjected to column chromatography (eluent: MC and Hex), so as to obtain 1.10 g of Compound Ir-1 (yield of 44 %). The obtained compound was identified by HRMS and HPLC analysis.

HRMS (MALDI) calcd for C₆₆H₆₃IrN₄OSi₂): m/z 1164.4170, Found: 1164.4171.

Synthesis Example 4 (Compound Ir-2 or Compound 115 of Group 2-4)

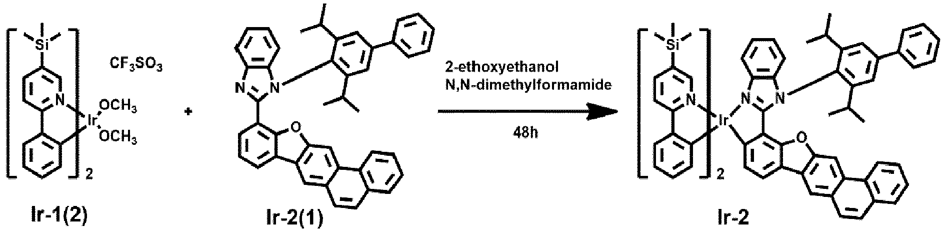

### Synthesis of Compound Ir-2

Compound Ir-1(2)(1.9 g, 2.2 mmol) and Compound Ir-2(1) (1-(3,5-diisopropyl-[1,1'-biphenyl]-4-yl)-2-(phenanthro[3,2-b]benzofuran-11-yl)-1H-benzo[d]imidazole, 1.3 g, 2.1 mmol) were mixed with 10 mL of 2-ethoxyethanol and 10 mL of N,N-dimethylformamide, and the mixed solution was stirred while heating at reflux for 48 hours. Then, the temperature was lowered to room temperature. The product thus obtained was decompressed, and the resultant solid was subjected to column chromatography (eluent: MC and Hex), so as to obtain 1.10 g of Compound Ir-2 (yield of 39 %). The obtained compound was identified by HRMS and HPLC analysis.

HRMS (MALDI) calcd for C₇₃H₆₇IrN₄OSi₂: m/z 1264.4483, Found: 1264.4486.

Synthesis Example 5 (Compound Ir-3 or Compound 116 of Group 2-4)

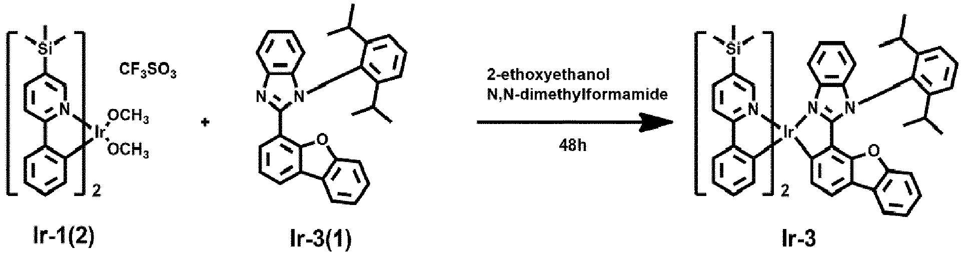

### Synthesis of Compound Ir-3

Compound Ir-1(2)(2.0 g, 2.3 mmol) and Compound Ir-3(1) (2-(dibenzo[b,d]furan-4-yl)-1-(2,6-diisopropylphenyl)-1H-benzo[d]imidazole, 1.0 g, 2.2 mmol) were mixed with 10 mL of 2-ethoxyethanol and 10 mL of N,N-dimethylformamide, and the mixed solution was stirred while heating at reflux for 48 hours. Then, the reaction mixture then was allowed to cool to room temperature. The product thus obtained was decompressed, and the resultant solid was subjected to column chromatography (eluent: MC and Hex), so as to obtain 1.20 g of Compound Ir-3 (yield of 48 %). The obtained compound was identified by HRMS and HPLC analysis.

HRMS (MALDI) calcd for C₅₉H₅₉IrN₄OSi₂: m/z 1088.3857, Found: 1088.3858.

### Manufacture of OLED 1

An ITO(as an anode)-patterned glass substrate was cut to a size of 50 millimeters (mm) x 50 mm x 0.5 mm, sonicated with isopropyl alcohol and DI water, each for 5 minutes, and then cleaned by exposure to ultraviolet rays and ozone for 30 minutes. The resultant glass substrate was loaded onto a vacuum deposition apparatus.

HT3 and F6-TCNNQ were vacuum-deposited on the anode at a weight ratio of 98:2 to form a hole injection layer having a thickness of 100 Å, and HT3 was vacuum-deposited on the hole injection layer to form a hole transport layer having a thickness of 1,350 Å. H-H1 was vacuum-deposited on the hole transport layer to form an electron blocking layer having a thickness of 300 Å.

Subsequently, a host and a dopant were co-deposited at a weight ratio of 88:12 on the electron blocking layer to form an emission layer having a thickness of 400 Å. As the host, H-H1 and H-H2 were used at a weight ratio of 5:5, and as the dopant, the first compound and the second compound shown in Table 1 were used at a weight ratio of 1:1.

Then, ET3 and ET-D1 were co-deposited at a volume ratio of 50:50 on the emission layer to form an electron transport layer having a thickness of 350 Å, ET-D1 was vacuum-deposited on the electron transport layer to form an electron injection layer having a thickness of 10 Å, and Al was vacuum-deposited on the electron injection layer to form a cathode having a thickness of 1,000 Å, thereby completing the manufacture of an organic light-emitting device.

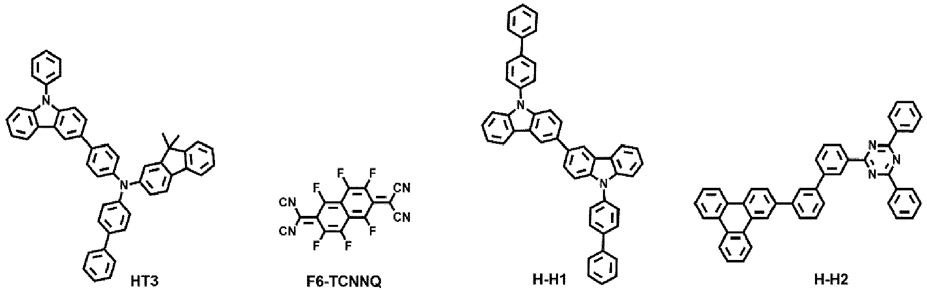

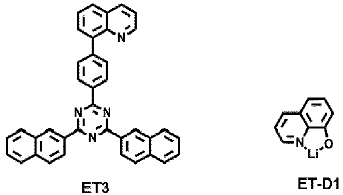

### Manufacture of OLEDs 2 to 4 and A to E

Organic Light-emitting devices were manufactured in the same manner as in the manufacture of OLED 1, except that, in forming an emission layer, for use as a dopant, corresponding compounds shown in Table 1 were used.

### Evaluation Example 1

For the OLEDs 1 to 4 and A to E, the driving voltage (V), maximum emission peak wavelength (λₘₐₓ, nm), maximum value of external quantum efficiency (Max EQE, %), and lifespan (LT₉₇, relative value, % based on OLED-A) were evaluated, and the results are shown in Table 1. A current-voltage meter (Keithley 2400) and a luminance meter (Topcon SR3) were used as apparatuses for evaluation, and the lifespan (T₉₇) (at 18,000 candela per square meter (cd/m²), or nit) was obtained by measuring the amount of time that elapsed until luminance was reduced to 97 % of the initial luminance of 100 %, and the results are expressed as relative values based on OLED-A.

**Table 1**

| | Dopant in emission layer | | Driving voltage (V) | λₘₐₓ (nm) | Max EQE (%) | LT97 (Relative value, %) |
|---|---|---|---|---|---|---|
| | First compound | Second compound | | | | |
| OLED 1 | Pt-1 | Ir-1 | 4.2 | 531 | 26.5 | 144 |
| OLED 2 | Pt-2 | Ir-1 | 4.2 | 531 | 26.3 | 140 |
| OLED 3 | Pt-2 | Ir-2 | 4.2 | 529 | 26.4 | 160 |
| OLED 4 | Pt-2 | Ir-3 | 4.25 | 530 | 25.9 | 130 |
| OLED A | Ir-1 | | 4.6 | 531 | 25 | 100 |
| OLED B | Pt-1 | | 4.2 | 523 | 25.2 | 20 |
| OLED C | Pt-C | Ir-C | 5.5 | 584 | 5 | <1 |
| OLED D | Pt-D | Ir-C | 5.9 | 650 | 4 | <1 |
| OLED E | Pt-E | Ir-C | 5.2 | 515 | 10 | <1 |
| OLED F | Pt-F | Ir-D | 5.5 | 614 | 15.4 | <10 |

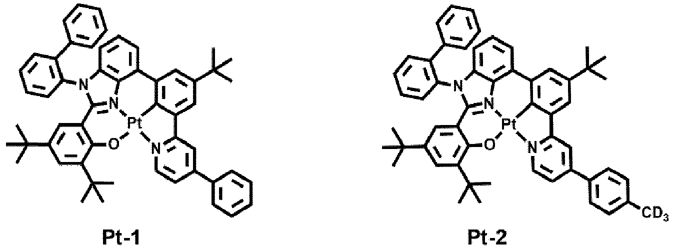

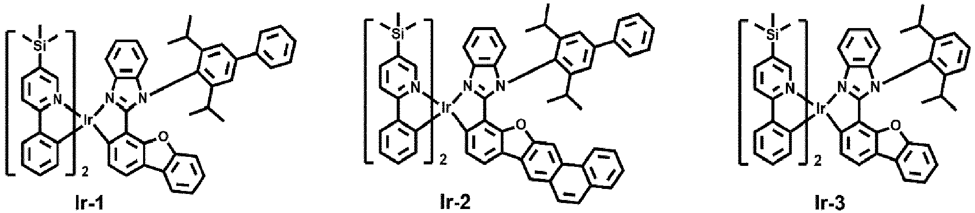

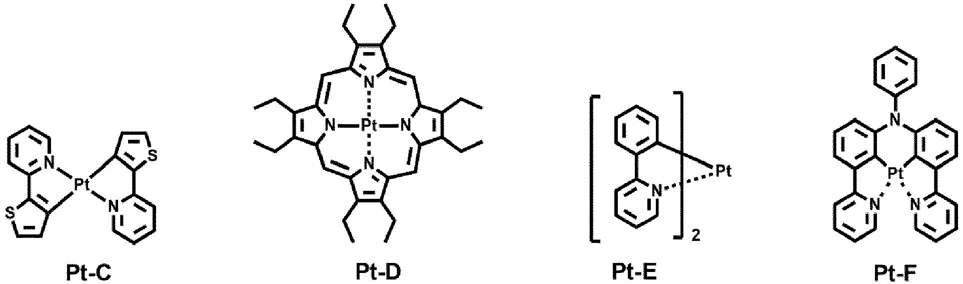

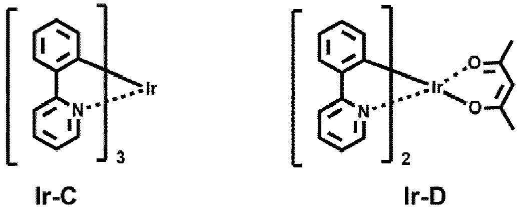

Referring to Table 1, it was confirmed that each of OLEDs 1 to 4 emitted green light, and as compared to OLEDs A to E, had improved properties in terms of driving voltage, EQE, and lifespan.

According to the one or more embodiments, an electronic device, for example, a light-emitting device, employing the composition may have improved driving voltage, improved external quantum efficiency, and improved lifetime characteristics.

It should be understood that the one or more exemplary embodiments described herein should be considered in a descriptive sense only and not for purposes of limitation. Descriptions of certain features or aspects within each exemplary embodiment should typically be considered as available for other similar features or aspects in other exemplary embodiments. While one or more exemplary embodiments have been described with reference to the figure, it will be understood by those of ordinary skill in the art that various changes in form and details may be made therein without departing from the scope as defined by the following claims.

## Claims

1. A composition, comprising:
a first compound represented by Formula 1; and
a second compound represented by Formula 2: 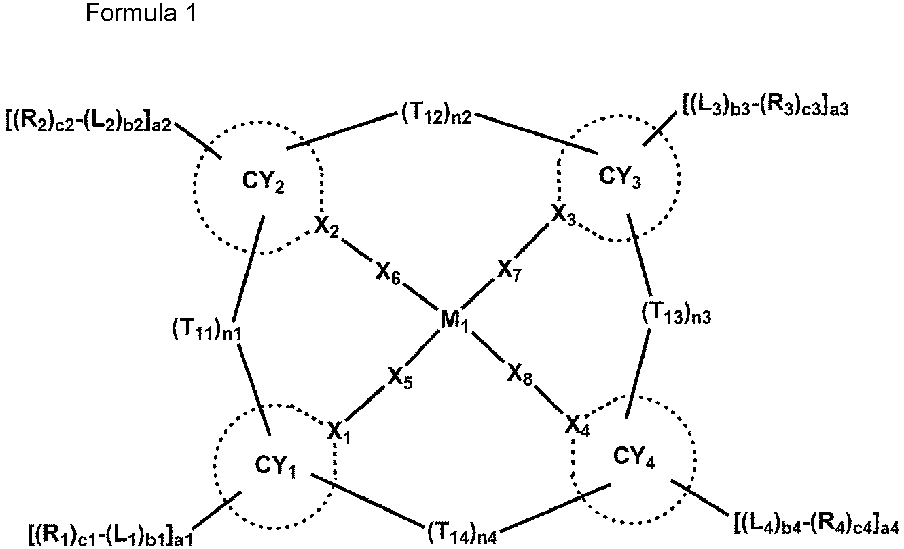
Formula 2 M₂(L₁₁)ₙ₁₁(L₁₂)ₙ₁₂(L₁₃)ₙ₁₃ 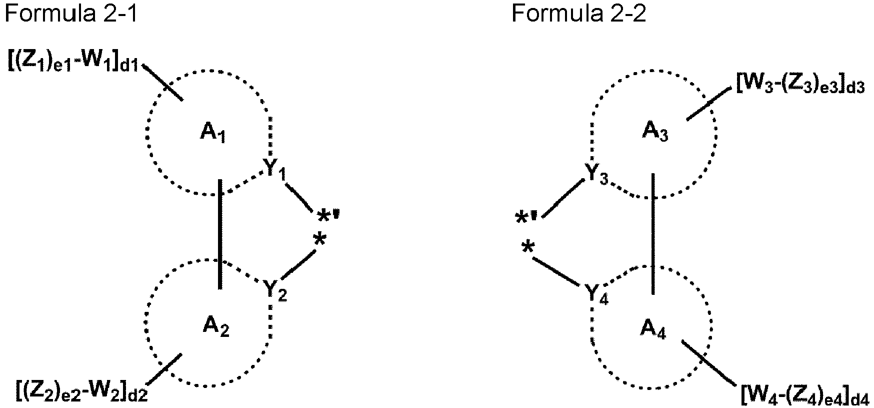
wherein, in Formula 1, M₁ is platinum (Pt), palladium (Pd), or gold (Au),
in Formula 2, M₂ is iridium (Ir),
in Formula 2, L₁₁ is a ligand represented by Formula 2-1,
in Formula 2, L₁₂ is a ligand represented by Formula 2-2,
in Formula 2, L₁₃ is a ligand represented by Formula 2-1 or 2-2,
in Formula 2, L₁₁ and L₁₂ are different from each other,
in Formula 2, n11, n12, and n13 are each independently 0, 1, 2, or 3, and a sum of n11 + n12 + n13 is equal to 3,
in Formulae 1, 2-1, and 2-2, X₁ to X₄ and Y₁ to Y₄ are each independently C or N,
in Formula 1, X₅ to X₈ are each independently a chemical bond, O, S, N(R'), C(R')(R"), or C(=O), and at least one of X₅ to X₈ is O, S, N(R'), C(R')(R"), or C(=O),
in Formula 1, two bonds of a bond between X₅ or X₁ and M₁, a bond between X₆ or X₂ and M₁, a bond between X₇ or X₃ and M₁, and a bond between X₈ or X₄ and M₁ are each a coordinate bond, and the other two bonds of the bond between X₅ or X₁ and M₁, the bond between X₆ or X₂ and M₁, the bond between X₇ or X₃ and M₁, and the bond between X₈ or X₄ and M₁ are each a covalent bond,
in Formulae 1, 2-1, and 2-2, ring CY₁ to ring CY₄ and ring A₁ to ring A₄ are each independently a C₅-C₃₀ carbocyclic group or a C₁-C₃₀ heterocyclic group,
in Formula 1, T₁₁ to T₁₄ are each independently a single bond, a double bond, *-N(R₅ₐ)-*', *-B(R₅ₐ)-*', *-P(R₅ₐ)-*', *-C(R₅ₐ)(R_{5b})-*', *-Si(R₅ₐ)(R_{5b})-*', *-Ge(R₅ₐ)(R_{5b})-*', *-S-*', *-Se-*', *-O-*', *-C(=O)-*', *-S(=O)-*', *-S(=O)2-*' *-C(R₅ₐ)=*', *=C(R₅ₐ)-*', *-C(R₅ₐ)=C(R_{5b})-*', *-C(=S)-*', *-C≡C-*', a C₅-C₃₀ carbocyclic group that is unsubstituted or substituted with at least one R₁₀ₐ, or a C₁-C₃₀ heterocyclic group that is unsubstituted or substituted with at least one R₁₀ₐ, wherein * and *' each indicate a binding site to a neighboring atom,
in Formula 1, n1 to n4 are each independently 0 or 1, wherein three or more of n1 to n4 are each 1,
in Formula 1, T₁₁ is not present when n1 is 0, T₁₂ is not present when n2 is 0, T₁₃ is not present when n3 is 0, and T₁₄ is not present when n4 is 0,
in Formulae 1, 2-1, and 2-2, L₁ to L₄ and W₁ to W₄ are each independently a single bond, a C₁-C₂₀ alkylene group that is unsubstituted or substituted with at least one R₁₀ₐ, a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
in Formula 1, b1 to b4 are each independently an integer of 1 to 10,
in Formulae 1, 2-1, and 2-2, R₁ to R₄, R₅ₐ, R_{5b}, R', R", and Z₁ to Z₄ are each independently hydrogen, deuterium, -F, -CI, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -Ge(Q₃)(Q₄)(Q₅), -B(Q₆)(Q₇), -P(=O)(Q₈)(Q₉), or -P(Q₈)(Q₉),
in Formulae 1, 2-1, and 2-2, c1 to c4, a1 to a4, e1 to e4, and d1 to d4 are each independently an integer of 0 to 20,
the second compound is not tris[2-phenylpyridine]iridium,
in Formulae 1, 2-1, and 2-2, at least two substituents from: i) two or more of a plurality of R₁(s); ii) two or more of a plurality of R₂(s); iii) two or more of a plurality of R₃(s); iv) two or more of a plurality of R₄(s); v) R₅ₐ and R_{5b}; vi) two or more of a plurality of Z₁(s); vii) two or more of a plurality of Z₂(s); viii) two or more of a plurality of Z₃(s); ix) two or more of a plurality of Z₄(s), x) two or more of R₁ to R₄, R₅ₐ, and R_{5b}; and xi) two or more of Z₁ to Z₄ are each independently optionally linked to each other to form a C₅-C₃₀ carbocyclic group that is unsubstituted or substituted with at least one R₁₀ₐ or a C₁-C₃₀ heterocyclic group that is unsubstituted or substituted with at least one R₁₀ₐ,
R₁₀ₐ is as defined in connection with R₁,
in Formulae 2-1 and 2-2, * and *' each indicate a binding site to M₂, and
at least one substituent of the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, and the substituted monovalent non-aromatic condensed heteropolycyclic group is:
deuterium, -F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with at least one of deuterium, -F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₁₁)(Q₁₂), - Si(Q₁₃)(Q₁₄)(Q₁₆), -Ge(Q₁₃)(Q₁₄)(Q₁₅), -B(Q₁₆)(Q₁₇), -P(=O)(Q₁₈)(Q₁₉), -P(Q₁₈)(Q₁₉), or a combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each unsubstituted or substituted with at least one of deuterium, -F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅), -Ge(Q₂₃)(Q₂₄)(Q₂₅), -B(Q26)(Q27), - P(=O)(Q₂₈)(Q₂₉), -P(Q₂₈)(Q₂₉), or a combination thereof;
-N(Q₃₁)(Q₃₂), -Si(Q₃₃)(Q₃₄)(Q₃₅), -Ge(Q₃₃)(Q₃₄)(Q₃₅), -B(Q36)(Q37), - P(=O)(Q₃₈)(Q₃₉), or -P(Q₃₈)(Q₃₉); or
a combination thereof,
wherein Q₁ to Q₉, Q₁₁ to Q₁₉, Q₂₁ to Q₂₉, and Q₃₁ to Q₃₉ are each independently: hydrogen, deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each unsubstituted or substituted with at least one of deuterium, a C₁-C₆₀ alkyl group, a C₆-C₆₀ aryl group, or a combination thereof.

2. The composition of claim 1, wherein, in Formula 1, X₁ and X₃ are each C, and X₂ and X₄ are each N, or X₁ and X₄ are each C, and X₂ and X₃ are each N; and/or
wherein, in Formulae 2-1 and 2-2, Y₁ and Y₃ are each N, and Y₂ and Y₄ are each C; and/or
wherein, in Formula 1, X₅ is O or S, and X₆ to X₈ are each a chemical bond.

3. The composition of claims 1 or 2, wherein, in Formula 1, each of ring CY₁, ring CY₃, and ring CY₄ is not a benzimidazole group; and/or
wherein, in Formulae 2-1 and 2-2, ring A₁ and ring A₃ are different from each other; and/or
wherein, in Formulae 2-1 and 2-2, in ring A₁, a Y₁-containing monocyclic group is a 6-membered ring, and in ring A₃, a Y₃-containing monocyclic group is a 5-membered ring.

4. The composition of any of claims 1-3, wherein, in Formulae 2-1 and 2-2, ring A₁ is:
a pyridine group, a pyrimidine group, a pyridazine group, or a pyrazine group; or
a pyridine group, a pyrimidine group, a pyridazine group, or a pyrazine group, each condensed with a cyclohexane group, a norbornane group, a benzene group, or a combination thereof, and
ring A₃ is:
a pyridine group, a pyrimidine group, a pyridazine group, or a pyrazine group;
a pyridine group, a pyrimidine group, a pyridazine group, or a pyrazine group, each condensed with a cyclohexane group, a norbornane group, a benzene group, or a combination thereof; or
an imidazole group, a benzimidazole group, a naphthoimidazole group, a phenanthrenoimidazole group, a pyridoimidazole group, an oxazole group, a benzoxazole group, a naphthoxazole group, a phenanthrenoxazole group, a pyridooxazole group, a thiazole group, a benzothiazole group, a naphthothiazole group, a phenanthrenothiazole group, or a pyridothiazole group.

5. The composition of any of claims 1-4, wherein, in Formulae 2-1 and 2-2, ring A₂ and ring A₄ are different from each other.

6. The composition of any of claims 1-5, wherein, in Formulae 2-1 and 2-2, ring A₂ is:
a benzene group, a naphthalene group, a phenanthrene group, a dibenzofuran group, a dibenzothiophene group, a dibenzoselenophene group, a carbazole group, a fluorene group, or a dibenzosilole group; or
a benzene group, a naphthalene group, phenanthrene group, a dibenzofuran group, a dibenzothiophene group, dibenzoselenophene group, a carbazole group, a fluorene group, or dibenzosilole group, each condensed with a cyclohexane group, norbornane group, a benzene group, or a combination thereof, and
ring A₄ is:
a benzene group, a naphthalene group, a phenanthrene group, a phenanthrobenzofuran group, a dibenzofuran group, a dibenzothiophene group, a dibenzoselenophene group, a carbazole group, a fluorene group, a dibenzosilole group, an azadibenzofuran group, an azadibenzothiophene group, an azadibenzoselenophene group, an azacarbazole group, an azafluorene group, or a dibenzosilole group; or
a benzene group, a naphthalene group, a phenanthrene group, a dibenzofuran group, a dibenzothiophene group, a dibenzoselenophene group, a carbazole group, a fluorene group, a dibenzosilole group, an azadibenzofuran group, an azadibenzothiophene group, an azadibenzoselenophene group, an azacarbazole group, an azafluorene group, or a dibenzosilole group, each condensed with a benzene group, a pyridine group, a pyrimidine group, a pyridazine group, a pyrazine group, a cyclohexane group, a norbornane group, a furan group, a thiophene group, a selenophene group, a pyrrole group, a cyclopentadiene group, a silole group, a pyrazole group, an imidazole group, an oxazole group, a thiazole group, an isoxazole group, an isothiazole group, or a combination thereof.

7. The composition of any of claims 1-6, wherein, in Formula 2-1,
each of e1 and d1 is not 0, and
at least one Z₁ is a deuterated C₁-C₂₀ alkyl group, -Si(Q₃)(Q₄)(Q₅), or - Ge(Q₃)(Q₄)(Q₅).

8. The composition of any of claims 1-7, wherein, in Formula 1,
each of n1 and n2 is not 0, and
a group represented by 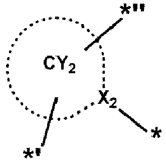 is represented by one of Formulae CY2(1) to CY2(21): 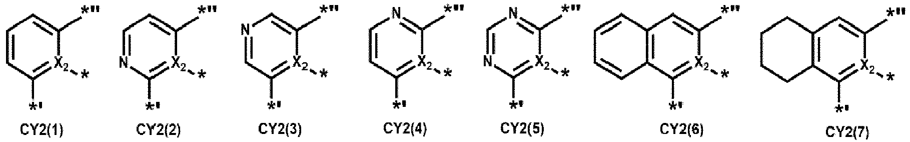 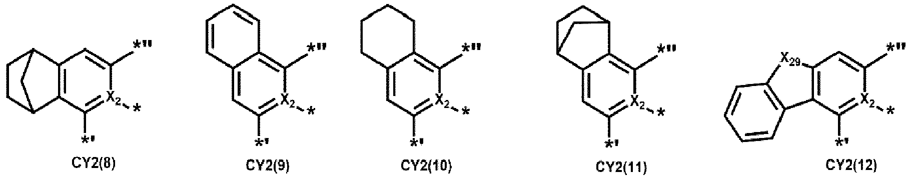 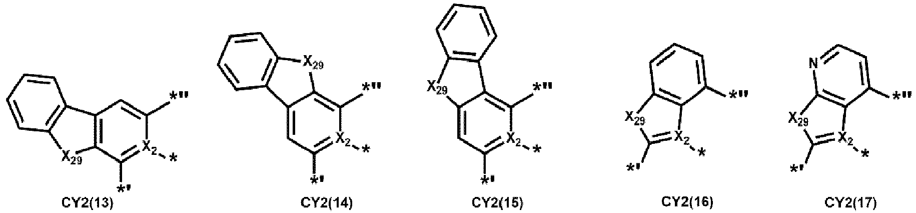 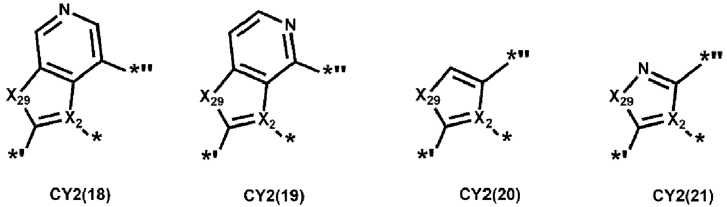 wherein, in Formulae CY2(1) to CY2(21),
X₂ is as defined in claim 1,
X29 is O, S, N-[(L2)b2-(R2)c2], C(R29a)(R29b), or Si(R29a)(R29b),
L₂, b2, R₂, and c2 are respectively as defined in claim 1,
R₂₉ₐ and R_{29b} are each as defined in connection with R₂ in claim 1,
*' indicates a binding site to T₁₁ in Formula 1,
* indicates a binding site to X₆ or M₁ in Formula 1, and
*" indicates a binding site to T₁₂ in Formula 1.

9. The composition of any of claims 1-8, wherein the first compound is represented by one or more of Formulae 1-1 to 1-3: 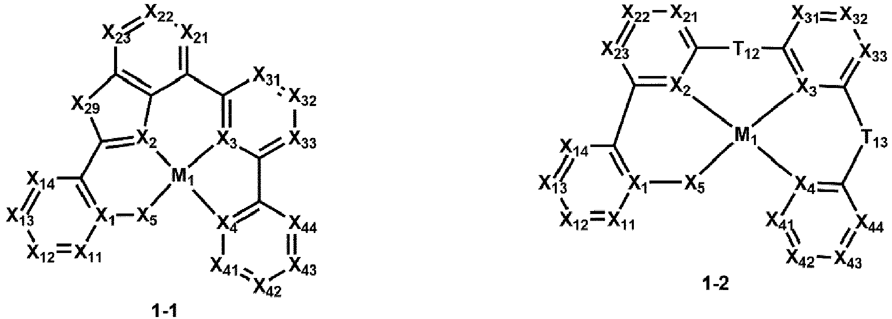 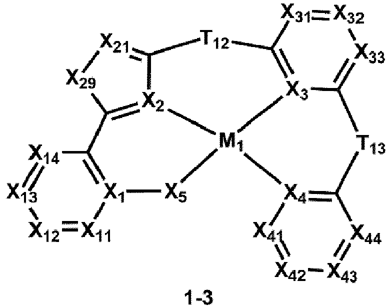 wherein, in Formulae 1-1 to 1-3,
M₁, X₁ to X₅, T₁₂, and T₁₃ are respectively as defined in claim 1,
X11 is N or C(R₁₁), X₁₂ is N or C(R₁₂), X₁₃ is N or C(R₁₃), and X₁₄ is N or C(R₁₄),
R₁₁ to R₁₄ are each as defined in connection with R₁ in claim 1,
two or more of R₁₁ to R₁₄ are optionally linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
X₂₁ is N or C(R₂₁), X₂₂ is N or C(R22), and X₂₃ is N or C(R23),
X29 is O, S, N-[(L2)b2-(R2)c2], C(R29a)(R29b), or Si(R29a)(R29b),
L₂, b2, R₂, and c2 are respectively as defined in claim 1,
R₂₁ to R₂₃, R₂₉ₐ, and R_{29b} are each as defined in connection with R₂ in claim 1,
two or more of R₂₁ to R₂₃ are optionally linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
X₃₁ is N or C(R₃₁), X₃₂ is N or C(R32), and X₃₃ is N or C(R33),
R₃₁ to R₃₃ are each as defined in connection with R₃ in claim 1,
two or more of R₃₁ to R₃₃ are optionally linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
X41 is N or C(R₄₁), X₄₂ is N or C(R42), X₄₃ is N or C(R43), and X₄₄ is N or C(R44), R₄₁ to R₄₄ are each as defined in connection with R₄ in claim 1,
two or more of R₄₁ to R₄₄ are optionally linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ, and
R₁₀ₐ is as defined in claim 1.

10. The composition of any of claims 1-9, wherein, in Formula 2-2,
Y₃ is N, and
a group represented by: 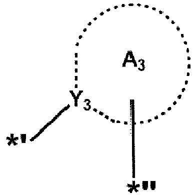
is represented by one of Formulae NR1 to NR48: 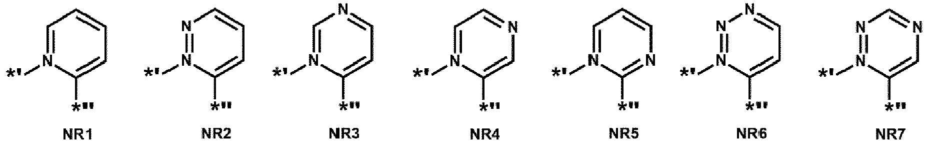 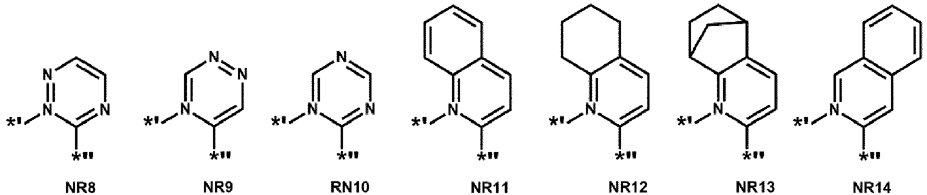 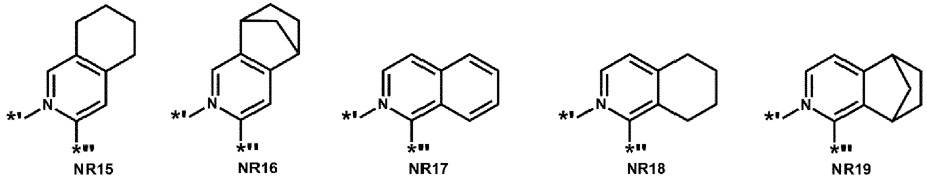 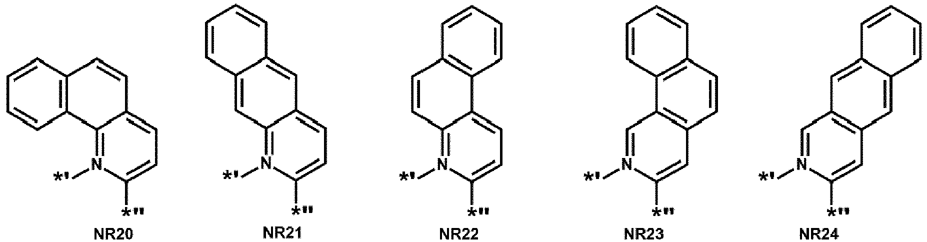 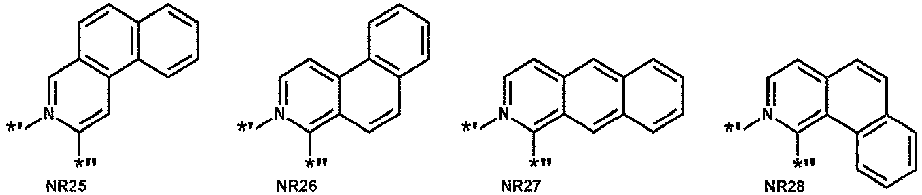 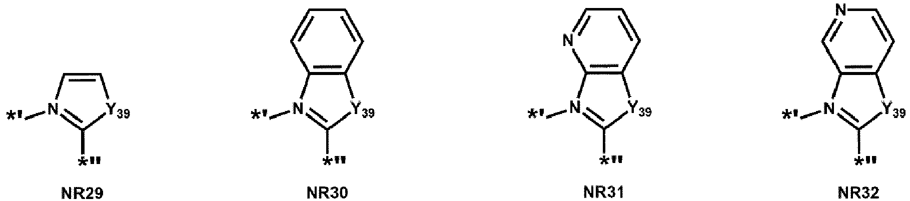 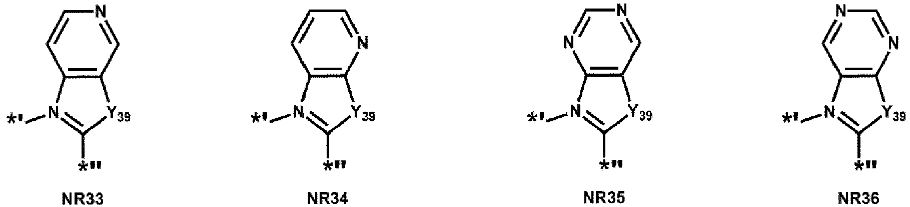 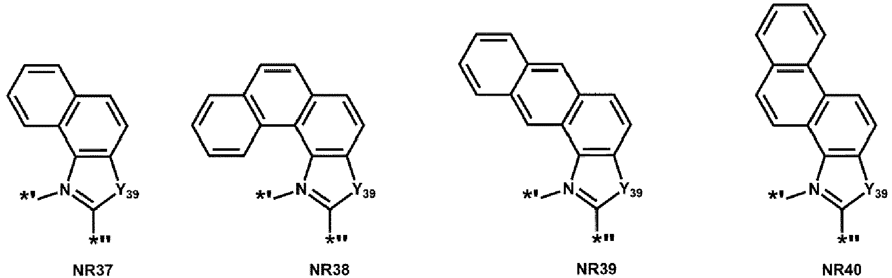 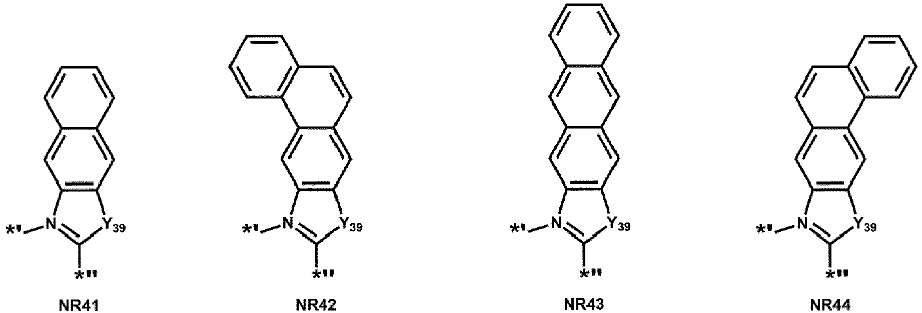 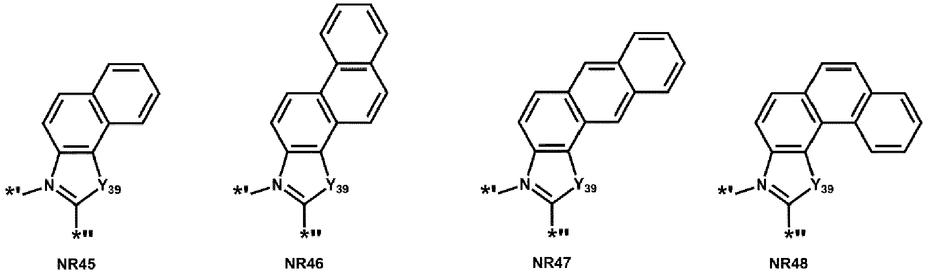 wherein, in Formulae NR1 to NR48,
Y39 is O, S, Se, N-[W3-(Z3)e3], C(Z39a)(Z39b), or Si(Z39a)(Z39b),
W₃, Z₃, and e3 are respectively as defined in claim 1, and Z₃₉ₐ and Z_{39b} are each as defined in connection with Z₃ in claim 1,
*' indicates a binding site to M₂ in Formula 2, and
*" indicates a binding site to ring A₄.

11. The composition of any of claims 1-10, wherein, in Formulae 2-1 and 2-2,
Y₂ and Y₄ are each C, and
a group represented by: 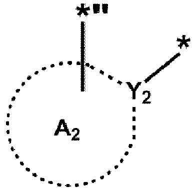 in Formula 2-1, and a group represented by: 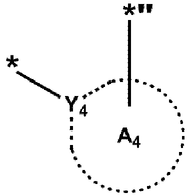 in Formula 2-2 are each independently represented by one of Formulae CR1 to CR29: 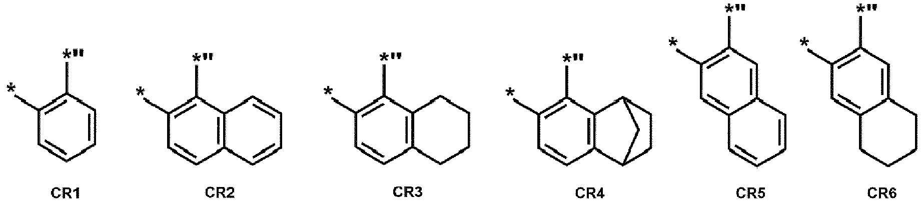 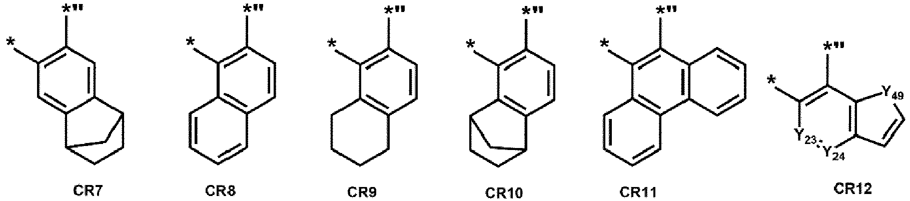 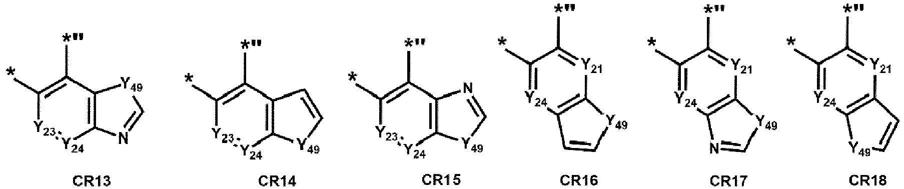 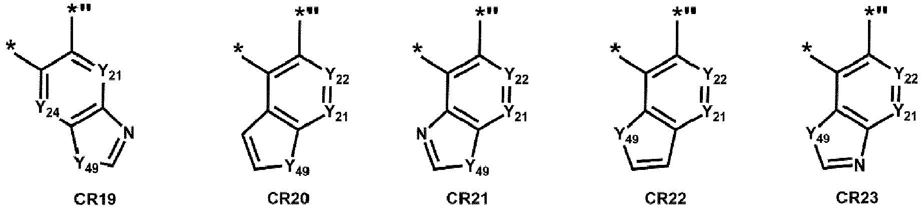 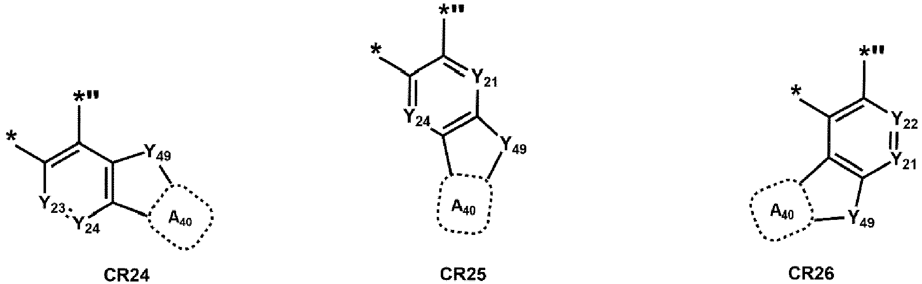 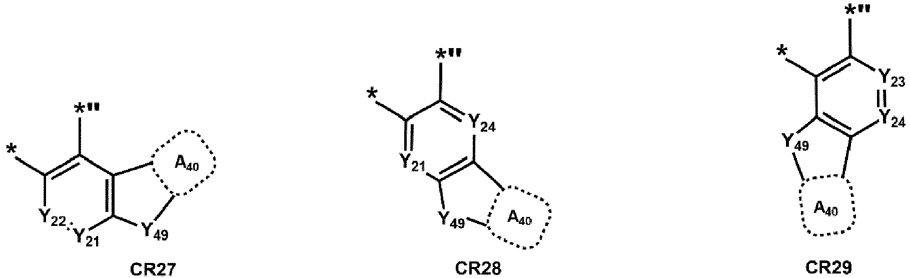 wherein, in CR1 to CR29,
Y49 is O, S, Se, N-[W2-(Z2)e2], N-[W4-(Z4)e4], C(Z29a)(Z29b), C(Z49a)(Z49b), Si(Z29a)(Z29b), or Si(Z49a)(Z49b),
W₂, W₄, Z₂, Z4, e2, and e4 are respectively as defined in claim 1, Z₂₉ₐ and Z_{29b} are each as defined in connection with Z₂ in claim 1, and Z₄₉ₐ and Z_{49b} are each as defined in connection with Z₄ in claim 1,
Y₂₁ to Y₂₄ are each independently N or C, ring A₄₀ is a C₅-C₃₀ carbocyclic group or a C₁-C₃₀ heterocyclic group,
* indicates a binding site to M₂ in Formula 2, and
*" indicates a binding site to ring A₁ in Formula 2-1 or ring A₃ in Formula 2-2.

12. The composition of any of claims 1-11, wherein
the first compound emits first light having a first spectrum, and λP1 indicates an emission peak wavelength in nanometers (nm) in the first spectrum,
the second compound emits second light having a second spectrum, and λP2 indicates an emission peak wavelength in nm in the second spectrum, and
λP1 and λP2 are each in a range of 480 nm to 580 nm.

13. A layer, comprising the composition of any of claims 1-12.

14. A light-emitting device, comprising:
a first electrode;
a second electrode, and
an organic layer arranged between the first electrode and the second electrode,
wherein the organic layer comprises an emission layer, and
wherein the organic layer comprises at least one composition of any of claims 1-12;
preferably wherein the emission layer comprises the at least one composition.

15. An electronic apparatus, comprising the light-emitting device of claim 14.
